(19) Europäisches Patentamt
European Patent Office
Office européen des brevets

(11) **EP 4 214 779 B1**

(12) **EUROPEAN PATENT SPECIFICATION**

(45) Date of publication and mention of the grant of the patent:
**18.02.2026 Bulletin 2026/08**

(21) Application number: **21785787.9**

(22) Date of filing: **17.09.2021**

(51) International Patent Classification (IPC):
***H10K 50/11*** *(2023.01)*

(52) Cooperative Patent Classification (CPC):
**H10K 50/11; H10K 85/658;** H10K 2101/10; H10K 2101/20; H10K 2101/27

(86) International application number:
**PCT/EP2021/075658**

(87) International publication number:
**WO 2022/058525 (24.03.2022 Gazette 2022/12)**

# (54) ORGANIC ELECTROLUMINESCENT DEVICE

ORGANISCHE ELEKTROLUMINESZENTE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:
**18.09.2020 EP 20197076**
**18.09.2020 EP 20197075**
**18.09.2020 EP 20197074**
**18.09.2020 EP 20197073**
**18.09.2020 EP 20197072**
**18.09.2020 EP 20197071**
**22.09.2020 EP 20197589**
**22.09.2020 EP 20197588**
**23.12.2020 EP 20217041**
**27.04.2021 EP 21170779**
**27.04.2021 EP 21170783**
**27.04.2021 EP 21170775**
**27.04.2021 EP 21170776**
**08.07.2021 EP 21184616**
**08.07.2021 EP 21184619**
**13.07.2021 EP 21185402**
**20.07.2021 EP 21186615**

(43) Date of publication of application:
**26.07.2023 Bulletin 2023/30**

(73) Proprietor: **Samsung Display Co., Ltd.**
**Yongin-si, Gyeonggi-do 17113 (KR)**

(72) Inventors:
- **SHARIFIDEHSARI, Hamed**
  **73614 Schorndorf (DE)**
- **LIAPTSIS, Georgios**
  **68161 Mannheim (DE)**
- **DE SA PEREIRA, Daniel Alfredo**
  **60314 Frankfurt am Main (DE)**
- **CARBALLO, Jaime Leganés**
  **73430 Aalen (DE)**
- **JOLY, Damien**
  **76646 Bruchsal (DE)**

(74) Representative: **Jacobi, Markus Alexander**
**Patentanwälte**
**Isenbruck Bösl Hörschler PartG mbB**
**Eastsite One**
**Seckenheimer Landstraße 4**
**68163 Mannheim (DE)**

(56) References cited:
**US-A1- 2019 207 112** **US-A1- 2020 136 059**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 214 779 B1

- **ZHANG YUEWEI ET AL: "Multi‐Resonance Induced Thermally Activated Delayed Fluorophores for Narrowband Green OLEDs", ANGEWANDTE CHEMIE INTERNATIONAL EDITION, vol. 58, no. 47, 18 November 2019 (2019-11-18), pages 16912 - 16917, XP055793335, ISSN: 1433-7851, Retrieved from the Internet <URL:https://onlinelibrary.wiley.com/doi/full-xml/10.1002/anie.201911266> DOI: 10.1002/anie.201911266**
- **XIAO LIANG ET AL: "Peripheral Amplification of Multi-Resonance Induced Thermally Activated Delayed Fluorescence for Highly Efficient OLEDs", ANGEWANDTE CHEMIE INTERNATIONAL EDITION, vol. 57, no. 35, 30 July 2018 (2018-07-30), pages 11316 - 11320, XP055537488, ISSN: 1433-7851, DOI: 10.1002/anie.201806323**

## Description

The present invention relates to organic electroluminescent devices comprising one or more light-emitting layers B, each of which is composed of one or more sublayers, wherein the one or more sublayers of each light-emitting layer B as a whole comprise one or more excitation energy transfer components EET-1, one or more hole scavengers $H_{scav}$, one or more small full width at half maximum (FWHM) emitters $S^B$ emitting light with a full width at half maximum (FWHM) of less than or equal to 0.25 eV, and optionally one or more host materials $H^B$. Furthermore, the present invention relates to a method for generating light by means of an organic electroluminescent device according to the present invention.

Organic electroluminescent devices containing one or more light-emitting layers based on organics such as, e.g. organic light-emitting diodes (OLEDs), light-emitting electrochemical cells (LECs) and light-emitting transistors gain increasing importance. In particular, OLEDs are promising devices for electronic products such as e.g. screens, displays and illumination devices. In contrast to most electroluminescent devices essentially based on inorganics, organic electroluminescent devices based on organics are often rather flexible and producible in particularly thin layers. The OLED-based screens and displays already available today bear either good efficiencies and long lifetimes or good color purity and long lifetimes, but do not combine all three properties, i.e. good efficiency, long lifetime, and good color purity.

The color purity or color point of an OLED is typically provided by CIEx and CIEy coordinates, whereas the color gamut for the next display generation is provided by so-called BT-2020 and DCPI3 values. Generally, in order to achieve these color coordinates, top emitting devices are needed to adjust the color coordinate by changing the cavity. In order to achieve high efficiency in top emitting devices while targeting these color gamut, a narrow emission spectrum in bottom emitting devices is needed.

State-of-the-art phosphorescence emitters exhibit a rather broad emission, which is reflected by a broad emission of phosphorescence-based OLEDs (PHOLEDs) with a full-width-half-maximum (FWHM) of the emission spectrum, which is typically larger than 0.25 eV. The broad emission spectrum of PHOLEDs in bottom devices, leads to high losses in out-coupling efficiency for top emitting device structure while targeting BT-2020 and DCPI3 color gamut.

Additionally, phosphorescence materials are typically based on transition metals, e.g. iridium, which are quite expensive materials within the OLED stack due to their typically low abundance. Thus, transition metal based materials have the most potential for cost reduction of OLEDs. Lowering of the content of transition metals within the OLED stack thus is a key performance indicator for pricing of OLED applications.

Recently, some fluorescence or thermally-activated-delayed-fluorescence (TADF) emitters have been developed that display a rather narrow emission spectrum, which exhibits an FWHM of the emission spectrum, which is typically smaller than or equal to 0.25 eV, and therefore more suitable to achieve BT-2020 and DCPI3 color gamut. However, such fluorescence and TADF emitters typically suffer from low efficiency due to decreasing efficiencies at higher luminance (i.e. the roll-off behaviour of an OLED) as well as low lifetimes due to for example the exciton-polaron annihilation or exciton-exciton annihilation.

The document US 2020/136059 A1 discloses an OLED device comprising multiple complementary luminescent compounds and a host material in the emission layer.

These disadvantages may be overcome to some extend by applying so-called hyper approaches. The latter rely on the use of an energy pump which transfers energy to a fluorescent emitter preferably displaying a narrow emission spectrum as stated above. The energy pump may for example be a TADF material displaying reversed-intersystem crossing (RISC) or a transition metal complex displaying efficient intersystem crossing (ISC). However, these approaches still do not provide organic electroluminescent devices combining all of the aforementioned desirable features, namely: good efficiency, long lifetime, and good color purity.

A central element of an organic electroluminescent device for generating light typically is the at least one light-emitting layer placed between an anode and a cathode. When a voltage (and electrical current) is applied to an organic electroluminescent device, holes and electrons are injected from an anode and a cathode, respectively. Typically, a hole transport layer is located between a light-emitting layer and an anode, and an electron transport layer is typically located between a light-emitting layer and a cathode. The different layers are sequentially disposed. Excitons of high energy are then generated by recombination of the holes and the electrons in a light-emitting layer. The decay of such excited states (e.g., singlet states such as S1 and/or triplet states such as T1 to the ground state (S0) desirably leads to the emission of light.

Surprisingly, it has been found that an organic electroluminescent device's light-emitting layer consisting of one or more (sub)layer(s) and as a whole comprising one or more excitation energy transfer components EET-1, one or more hole scavengers $H_{scav}$, one or more small full width at half maximum (FWHM) emitters $S^B$ emitting light with a full width at half maximum (FWHM) of less than or equal to 0.25 eV, and optionally one or more host materials $H^B$ provides an organic electroluminescent device having a long lifetime, a high quantum yield and exhibiting narrow emission, ideally suitable to achieve the BT-2020 and DCPI3 color gamut.

Herein, EET-1 and in some embodiments also $H_{scav}$ may transfer excitation energy to one or more small full width at half maximum (FWHM) emitters $S^B$ which emit light.

The present invention relates to an organic electroluminescent device comprising one or more light-emitting layers B , each being composed of one or more sublayers, wherein the one or more sublayers are adjacent to each other and as a whole comprise:

(i) one or more excitation energy transfer components EET-1, each having a highest occupied molecular orbital HOMO(EET-1) with an energy $E^{HOMO}$(EET-1) and a lowest unoccupied molecular orbital LUMO(EET-1) with an energy $E^{LUMO}$(EET-1); and
(ii) one or more hole scavengers $H_{scav}$, each having a highest occupied molecular orbital HOMO($H_{scav}$) with an energy $E^{HOMO}$($H_{scav}$) and a lowest unoccupied molecular orbital LUMO($H_{scav}$) with an energy $E^{LUMO}$($H_{scav}$); and
(iii) one or more small full width at half maximum (FWHM) emitters $S^B$, each having a highest occupied molecular orbital HOMO($S^B$) with an energy $E^{HOMO}$($S^B$), and a lowest unoccupied molecular orbital LUMO($S^B$) with an energy $E^{LUMO}$($S^B$), wherein each $S^B$ emits light with an FWHM) of less than or equal to 0.25 eV; and optionally
(iv) one or more host materials $H^B$, each having a highest occupied molecular orbital HOMO($H^B$) with an energy $E^{HOMO}$($H^B$), and a lowest unoccupied molecular orbital LUMO($H^B$) with an energy $E^{LUMO}$($H^B$),

wherein the one or more sublayers which are located at the outer surface of each light-emitting layer B contain at least one material selected from the group consisting of EET-1, $H_{scav}$, and small FWHM emitter $S^B$, and
wherein the relations expressed by the following formulas (1) to (6), as far as the respective components are comprised in the same light-emitting layer B, apply:

$$E^{LUMO}(EET\text{-}1) < E^{LUMO}(H^B) \qquad (1)$$

$$E^{LUMO}(EET\text{-}1) < E^{LUMO}(H_{scav}) \qquad (2)$$

$$E^{LUMO}(EET\text{-}1) < E^{LUMO}(S^B) \qquad (3)$$

$$E^{HOMO}(H_{scav}) \geq E^{HOMO}(H^B) \qquad (4)$$

$$E^{HOMO}(H_{scav}) \geq E^{HOMO}(EET\text{-}1) \qquad (5)$$

$$E^{HOMO}(H_{scav}) \geq E^{HOMO}(S^B) \qquad (6).$$

In other words, the relations expressed by the following formulas (2), (3), (5), and (6) apply to materials comprised in the same light-emitting layer B; and the relations expressed by the following formulas (1) to (6) apply to materials comprised in the same light-emitting layer B, if said light-emitting layer B comprises one or more host materials $H^B$.
It is to be noted that throughout this text, reference will be made to relations between energies of excited states, orbitals, emission maxima and the like of components within the one or more light-emitting layers B of the organic electroluminescent device according to the present invention. It is understood that a relation comprising energies of two specific components will only apply to light-emitting layers B that comprise both of these specific components. Additionally, the fact that a relation applies to the devices according to the present invention does not mean that all devices of the invention have to comprise all components that are referred to in said relation. In particular, a light-emitting layer B comprises the one or more host materials $H^B$ only optionally, but still reference is made to formulas expressing relations referring to $H^B$'s excited state (S1, T1) or orbital (HOMO, LUMO) energies. It will be understood that such formulas (and the relations they express) will only apply to light-emitting layers B that comprise at least one host material $H^B$. On the other hand, the fact that a relation such as This general note is applicable to all embodiments of the present invention.
Formulas (1) to (6) may have the following meaning:

Formula (1): Preferably, in each light-emitting layer B comprising one or more host materials $H^B$, the energy $E^{LUMO}$ (EET-1) of the lowest unoccupied molecular orbital LUMO(EET-1) of at least one, preferably each, excitation energy transfer component EET-1 is lower than the energy $E^{LUMO}$($H^B$) of the lowest unoccupied molecular orbital LUMO($H^B$) of at least one, preferably each host material $H^B$.

Formula (2): Preferably, in each light-emitting layer B, the energy $E^{LUMO}$(EET-1) of the lowest unoccupied molecular orbital LUMO(EET-1) of at least one, preferably each, excitation energy transfer component EET-1 is lower than the

energy $E^{LUMO}(H_{scav})$ of the lowest unoccupied molecular orbital LUMO($H_{scav}$) of at least one, preferably each, hole scavenger $H_{scav}$.

Formula (3): Preferably, in each light-emitting layer B, the energy $E^{LUMO}$(EET-1) of the lowest unoccupied molecular orbital LUMO(EET-1) of at least one, preferably each, excitation energy transfer component EET-1 is lower than the energy $E^{LUMO}(S^B)$ of the lowest unoccupied molecular orbital LUMO($S^B$) of at least one, preferably each small FWHM emitter $S^B$.

Formula (4): Preferably, in each light-emitting layer B comprising one or more host materials $H^B$, the energy $E^{HOMO}(H_{scav})$ of the highest occupied molecular orbital HOMO($H_{scav}$) of at least one, preferably each, hole scavenger $H_{scav}$ is equal to or higher than the energy $E^{HOMO}(H^B)$ of the highest occupied molecular orbital HOMO($H^B$) of at least one, preferably each, host material $H^B$.

Formula (5): Preferably, in each light-emitting layer B, the energy $E^{HOMO}(H_{scav})$ of the highest occupied molecular orbital HOMO($H_{scav}$) of at least one, preferably each, hole scavenger $H_{scav}$ is equal to or higher than the energy $E^{HOMO}$(EET-1) of the highest occupied molecular orbital HOMO(EET-1) of at least one, preferably each, excitation energy transfer component EET-1.

Formula (6): Preferably, in each light-emitting layer B, the energy $E^{HOMO}(H_{scav})$ of the highest occupied molecular orbital HOMO($H_{scav}$) of at least one, preferably each, hole scavenger $H_{scav}$ is equal to or higher than the energy $E^{HOMO}(S^B)$ of the highest occupied molecular orbital HOMO($S^B$) of at least one, preferably each, small FWHM emitter $S^B$.

The inventors have found that the aforementioned surprising beneficial effect on the device performance may particularly be achieved if the materials within each of the one or more light-emitting layers B are preferably selected so that the requirements given by the above-mentioned formulas (1) to (6) (as far as the respective components are comprised in the same light-emitting layer B) are fulfilled. It is assumed that the requirements regarding the HOMO- and LUMO-energies of the one or more excitation energy transfer components EET-1, the one or more hole scavengers $H_{scav}$, the one or more small FWHM emitters $S^B$ and, optionally, the one or more host materials $H^B$ comprised in a light-emitting layer B according to the present invention may provide the beneficial effect on the device performance partly due to their impact on the recombination zone (i.e. the region in which excitons are generated by electron-hole-recombination), which is described in more detail in a later subchapter of this text.

Furthermore, the materials within each of the one or more light-emitting layers B of the organic electroluminescent device according to the present invention are preferably selected so that at least one, preferably each, excitation energy transfer component EET-1 and in certain embodiments also at least one, preferably each, hole scavenger $H_{scav}$ transfer excitation energy to at least one, preferably each, small FWHM emitter $S^B$, which then emits light with a full width at half maximum (FWHM) of less than or equal to 0.25 eV. This is also laid out in more detail in a later subchapter of this text.

Fulfilling the aforementioned (preferred) requirements may result in an organic electroluminescent device having a long lifetime, a high quantum yield and exhibiting narrow emission, ideally suitable to achieve the BT-2020 and DCPI3 color gamut.

In a preferred embodiment, at least one, preferably each, light-emitting layer B comprises one or more host materials $H^B$.

In one embodiment of the invention, the organic electroluminescent device comprises a light-emitting layer B composed of exactly one (sub)layer comprising:

(i) one or more excitation energy transfer components EET-1; and
(ii) one or more hole scavengers $H_{scav}$; and
(iii) one or more small FWHM emitters $S^B$; and
(iv) one or more host materials $H^B$.

In one embodiment of the invention, the organic electroluminescent device comprises exactly one light-emitting layer B and this light-emitting layer B is composed of exactly one (sub)layer comprising:

(i) one or more excitation energy transfer components EET-1; and
(ii) one or more hole scavengers $H_{scav}$; and
(iii) one or more small FWHM emitters $S^B$; and
(iv) one or more host materials $H^B$.

*Combination of sublayers*

In a preferred embodiment of the invention, the electroluminescent device according to the invention comprises at least one light-emitting layer B consisting of exactly one (sub)layer. In an even more preferred embodiment of the invention, each light-emitting layer B comprised in the electroluminescent device according to the invention consists of exactly one (sub)layer. In a still even more preferred embodiment of the invention, the electroluminescent device according to the invention comprises exactly one light-emitting layer B and this light-emitting layer B consists of exactly one (sub)layer.

In another embodiment of the invention, the electroluminescent device according to the invention comprises at least one light-emitting layer B composed of more than one sublayer. In another embodiment of the invention, each light-emitting layer B comprised in the electroluminescent device according to the invention comprises more than one sublayer. In another embodiment of the invention, the electroluminescent device according to the invention comprises exactly one light-emitting layer B and this light-emitting layer B is composed of more than one sublayer.

In another embodiment of the invention, the electroluminescent device according to the invention comprises at least one light-emitting layer B composed of exactly two sublayers. In another embodiment of the invention, each light-emitting layer B comprised in the electroluminescent device according to the invention is composed of exactly two sublayers. In another embodiment of the invention, the electroluminescent device according to the invention comprises exactly one light-emitting layer B and this light-emitting layer B is composed of exactly two sublayers.

In another embodiment of the invention, the electroluminescent device according to the invention comprises at least one light-emitting layer B composed of more than two sublayers. In another embodiment of the invention, each light-emitting layer B comprised in the electroluminescent device according to the invention is composed of more than two sublayers. In another embodiment of the invention, the electroluminescent device according to the invention comprises exactly one light-emitting layer B and this light-emitting layer B is composed of more than two sublayers.

In one embodiment of the invention, each light-emitting layer B of the organic electroluminescent device according to the invention comprises exactly one, exactly two, or exactly three sublayers.

It is understood that different sublayers of a light-emitting layer B do not necessarily all comprise the same materials or even the same materials in the same ratios.

It is understood that different sublayers of a light-emitting layer B are adjacent to each other.

In one embodiment of the invention, at least one sublayer comprises exactly one excitation energy transfer component EET-1 and exactly one hole scavenger $H_{scav}$.

In one embodiment of the invention, the electroluminescent device according to the invention comprises at least one light-emitting layer B composed of more than one sublayers, wherein at least one sublayer does not comprise an excitation energy transfer component EET-1.

In one embodiment, the electroluminescent device according to the invention comprises at least one light-emitting layer B composed of more than one sublayers, wherein at least one sublayer does not comprise a hole scavenger $H_{scav}$.

In one embodiment, the electroluminescent device according to the invention comprises at least one light-emitting layer B composed of more than one sublayers, wherein at least one sublayer does not comprise a small FWHM emitter $S^B$.

In one embodiment, the electroluminescent device according to the invention comprises at least one light-emitting layer B composed of more than one sublayers, wherein at least one sublayer comprises a small FWHM emitter $S^B$ and an excitation energy transfer component EET-1.

In one embodiment, the electroluminescent device according to the invention comprises at least one light-emitting layer B composed of more than one sublayers, wherein at least one sublayer comprises a small FWHM emitter $S^B$ and a hole scavenger $H_{scav}$.

In one embodiment, the electroluminescent device according to the invention comprises at least one light-emitting layer B composed of more than one sublayers, wherein at least one sublayer comprises an excitation energy transfer component EET-1 and a hole scavenger $H_{scav}$.

In one embodiment, the electroluminescent device according to the invention comprises at least one light-emitting layer B composed of more than one sublayers, wherein:

(i) at least one sublayer comprises a small FWHM emitter $S^B$ and an excitation energy transfer component EET-1; and
(ii) at least one sublayer comprises a small FWHM emitter $S^B$ and a hole scavenger $H_{scav}$.

In one embodiment, the electroluminescent device according to the invention comprises at least one light-emitting layer B composed of more than one sublayers, wherein:

(i) at least one sublayer comprises an excitation energy transfer component EET-1;

(ii) at least one sublayer comprises a small FWHM emitter $S^B$; and
(iii) at least one sublayer comprises a hole scavenger $H_{scav}$,

wherein preferably a sublayer comprising a small FWHM emitter $S^B$ is located between a sublayer comprising EET-1 and a sublayer comprising $H_{scav}$.

In one embodiment, the electroluminescent device according to the invention comprises at least one light-emitting layer B comprising at least one sublayer comprising at least one excitation energy transfer component EET-1, at least one hole scavenger $H_{scav}$, and at least one small FWHM emitter $S^B$, and optionally at least one host $H^B$.

In one embodiment, the electroluminescent device according to the invention comprises at least one light-emitting layer B composed of more than one sublayers, wherein:

(i) at least two sublayers comprises an excitation energy transfer component EET-1 and a hole scavenger $H_{scav}$; and
(ii) at least one sublayer comprises a small FWHM emitter $S^B$,

wherein preferably a sublayer comprising a small FWHM emitter $S^B$ is located between the two sublayers comprising EET-1 and $H_{scav}$.

Optionally, a higher number (e.g., 3, 4, 5, 6, 7, 8, 9, 10, 11, 12 or more than 12) of sublayers may be comprised (i.e., stacked) in a light-emitting layer B. Preferably, the spatial distance between EET-1 and $S^B$ and in certain embodiments also $H_{scav}$ is kept short to enable sufficient energy transfer.

In one embodiment, the electroluminescent device according to the invention comprises at least one light-emitting layer B composed of more than one sublayers, wherein

(i) at least one sublayer comprises one or more host materials $H^B$, one or more excitation energy transfer components EET-1, and one or more small FWHM emitters $S^B$; and
(ii) at least one sublayer comprises one or more host materials $H^B$, one or more hole scavengers $H_{scav}$, and one or more small FWHM emitters $S^B$.

In one embodiment, the electroluminescent device according to the invention comprises at least one light-emitting layer B composed of more than one sublayers, wherein

(i) at least one sublayer comprises one or more host materials $H^B$, exactly one excitation energy transfer component EET-1, and exactly one small FWHM emitter $S^B$; and
(ii) at least one sublayer comprises at least one host material $H^B$, exactly one hole scavenger $H_{scav}$, and exactly one small FWHM emitter $S^B$.

In one embodiment, the electroluminescent device according to the invention comprises at least one light-emitting layer B composed of more than one sublayers, wherein

(i) at least one sublayer comprises one or more host materials $H^B$, one or more excitation energy transfer components EET-1, and one or more small FWHM emitters $S^B$, but does not comprise a hole scavenger $H_{scav}$; and
(ii) at least one sublayer comprises one or more host material $H^B$, one or more hole scavengers $H_{scav}$, and one or more small FWHM emitters $S^B$, but does not comprise an excitation energy transfer component EET-1.

In one embodiment, the electroluminescent device according to the invention comprises at least one light-emitting layer B composed of more than one sublayers, wherein

(i) at least one sublayer comprises one or more host materials $H^B$, exactly one excitation energy transfer component EET-1, and exactly one small FWHM emitter $S^B$, but does not comprise a hole scavenger $H_{scav}$ ; and
(ii) at least one sublayer comprises one or more host materials $H^B$, exactly one hole scavenger $H_{scav}$, and exactly one small FWHM emitter $S^B$, but does not comprise an excitation energy transfer component EET-1.

In one embodiment, the electroluminescent device according to the invention comprises at least one light-emitting layer B composed of more than one sublayers, wherein

(i) at least one sublayer comprises one or more host materials $H^B$ and one or more excitation energy transfer components EET-1; and
(ii) at least one sublayer comprises one or more host materials $H^B$ and one or more small FWHM emitters $S^B$; and
(iii) at least one sublayer comprises one or more host materials $H^B$ and one or more hole scavengers $H_{scav}$.

In one embodiment, the electroluminescent device according to the invention comprises at least one light-emitting layer B composed of more than one sublayers, wherein

(i) at least one sublayer comprises one or more host materials $H^B$ and exactly one excitation energy transfer component EET-1; and
(ii) at least one sublayer comprises one or more host materials $H^B$ and exactly one small FWHM emitter $S^B$; and
(iii) at least one sublayer comprises one or more host materials $H^B$ and exactly one hole scavenger $H_{scav}$.

In one embodiment, the electroluminescent device according to the invention comprises at least one light-emitting layer B composed of more than one sublayers, wherein

(i) at least one sublayer comprises one or more host materials $H^B$ and one or more excitation energy transfer components EET-1, but does not comprise a hole scavenger $H_{scav}$ and does not comprise a small FWHM emitter $S^B$; and
(ii) at least one sublayer comprises one or more host materials $H^B$ and one or more small FWHM emitters $S^B$, but does not comprise an excitation energy transfer component EET-1 and does not comprise a hole scavenger $H_{scav}$; and
(iii) at least one sublayer comprises one or more host materials $H^B$ and one or more hole scavengers $H_{scav}$, but does not comprise an excitation energy transfer component EET-1 and does not comprise a small FWHM emitter $S^B$.

In one embodiment, the electroluminescent device according to the invention comprises at least one light-emitting layer B composed of more than one sublayers, wherein

(i) at least one sublayer comprises one or more host materials $H^B$ and exactly one excitation energy transfer component EET-1, but does not comprise a hole scavenger $H_{scav}$ and does not comprise a small FWHM emitter $S^B$; and
(ii) at least one sublayer comprises one or more host materials $H^B$ and exactly one small FWHM emitter $S^B$, but does not comprise an excitation energy transfer component EET-1 and does not comprise a hole scavenger $H_{scav}$; and
(iii) at least one sublayer comprises one or more host materials $H^B$ and exactly one hole scavenger $H_{scav}$, but does not comprise an excitation energy transfer component EET-1 and does not comprise a small FWHM emitter $S^B$.

In one embodiment, the electroluminescent device according to the invention comprises at least one light-emitting layer B composed of more than one sublayers, wherein

(i) at least one sublayer comprises one or more host materials $H^B$, one or more excitation energy transfer components EET-1, and one or more hole scavengers $H_{scav}$; and
(ii) at least one sublayer comprises one or more host materials $H^B$ and one or more small FWHM emitters $S^B$.

In one embodiment, the electroluminescent device according to the invention comprises at least one light-emitting layer B composed of more than one sublayers, wherein

(i) at least one sublayer comprises one or more host materials $H^B$, exactly one excitation energy transfer component EET-1, and exactly one hole scavenger $H_{scav}$; and
(ii) at least one sublayer comprises one or more host materials $H^B$ and exactly one small FWHM emitter $S^B$.

In one embodiment, the electroluminescent device according to the invention comprises at least one light-emitting layer B composed of more than one sublayers, wherein

(i) at least one sublayer comprises one or more host materials $H^B$, one or more excitation energy transfer components EET-1, and one or more hole scavengers $H_{scav}$ but does not comprise a small FWHM emitter $S^B$; and
(ii) at least one sublayer comprises one or more host materials $H^B$ and one or more small FWHM emitters $S^B$, but does not comprise an excitation energy transfer component EET-1 and does not comprise a hole scavenger $H_{scav}$.

In one embodiment, the electroluminescent device according to the invention comprises at least one light-emitting layer B composed of more than one sublayers, wherein

(i) at least one sublayer comprises one or more host materials $H^B$, exactly one excitation energy transfer component EET-1, and exactly one hole scavenger $H_{scav}$, but does not comprise a small FWHM emitter $S^B$; and
(ii) at least one sublayer comprises one or more host materials $H^B$ and exactly one small FWHM emitter $S^B$, but does

not comprise an excitation energy transfer component EET-1 and does not comprise a hole scavenger $H_{scav}$.

In one embodiment of the invention, the electroluminescent device according to the invention comprises at least one light-emitting layer B composed of one or more than one sublayers, wherein at least one sublayer comprises at least one host material $H^B$, exactly one excitation energy transfer component EET-1, exactly one hole scavenger $H_{scav}$, and exactly one small FWHM emitter $S^B$.

In one embodiment of the invention, the electroluminescent device according to the invention comprises at least one light-emitting layer B composed of one or more than one sublayers, wherein at least one sublayer comprises exactly one host material $H^B$, exactly one excitation energy transfer component EET-1, exactly one hole scavenger $H_{scav}$, and exactly one small FWHM emitter $S^B$.

In one embodiment of the invention, the electroluminescent device according to the invention comprises at least one light-emitting layer B composed of one or more than one sublayers, wherein at least one sublayer comprises exactly one host material $H^B$, exactly one hole scavenger $H_{scav}$, and exactly one small FWHM emitter $S^B$.

In one embodiment of the invention, the electroluminescent device according to the invention comprises at least one light-emitting layer B composed of one or more than one sublayers, wherein at least one sublayer comprises exactly one host material $H^B$.

In one embodiment of the invention, the electroluminescent device according to the invention comprises at least one light-emitting layer B composed of one or more than one sublayers, wherein at least one sublayer comprises exactly one excitation energy transfer component EET-1.

In one embodiment of the invention, the electroluminescent device according to the invention comprises at least one light-emitting layer B composed of one or more than one sublayers, wherein at least one sublayer comprises exactly one hole scavenger $H_{scav}$.

In one embodiment of the invention, the electroluminescent device according to the invention comprises at least one light-emitting layer B composed of one or more than one sublayers, wherein at least one sublayer comprises exactly one small FWHM emitter $S^B$.

In one embodiment of the invention, the electroluminescent device according to the invention comprises at least one light-emitting layer B composed of one or more than one sublayers, wherein at least one sublayer comprises exactly one host material $H^B$ and exactly one excitation energy transfer component EET-1.

In one embodiment of the invention, the electroluminescent device according to the invention comprises at least one light-emitting layer B composed of one or more than one sublayers, wherein at least one sublayer comprises exactly one host material $H^B$ and exactly one hole scavenger $H_{scav}$.

In one embodiment of the invention, the electroluminescent device according to the invention comprises at least one light-emitting layer B composed of one or more than one sublayers, wherein at least one sublayer comprises exactly one host material $H^B$ and exactly one small FWHM emitter $S^B$.

In one embodiment of the invention, the electroluminescent device according to the invention comprises at least one light-emitting layer B composed of one or more than one sublayers, wherein at least one sublayer comprises exactly one excitation energy transfer component EET-1 and exactly one small FWHM emitter $S^B$.

In one embodiment of the invention, the electroluminescent device according to the invention comprises at least one light-emitting layer B composed of one or more than one sublayers, wherein at least one sublayer comprises exactly one excitation energy transfer component EET-1 and exactly one hole scavenger $H_{scav}$.

In one embodiment of the invention, the electroluminescent device according to the invention comprises at least one light-emitting layer B composed of one or more than one sublayers, wherein at least one sublayer comprises exactly one hole scavenger $H_{scav}$ and exactly one small FWHM emitter $S^B$.

In one embodiment of the invention, the electroluminescent device according to the invention comprises at least one light-emitting layer B composed of one or more than one sublayers, wherein at least one sublayer comprises exactly one host material $H^B$, exactly one excitation energy transfer component EET-1, and exactly one small FWHM emitter $S^B$.

In one embodiment of the invention, the electroluminescent device according to the invention comprises at least one light-emitting layer B composed of one or more than one sublayers, wherein at least one sublayer comprises exactly one host material $H^B$, exactly one excitation energy transfer component EET-1, and exactly one hole scavenger $H_{scav}$.

In one embodiment of the invention, the electroluminescent device according to the invention comprises at least one light-emitting layer B composed of one or more than one sublayers, wherein at least one sublayer comprises exactly one host material $H^B$, exactly one hole scavenger $H_{scav}$, and exactly one small FWHM emitter $S^B$.

In one embodiment of the invention, the organic electroluminescent device according to the invention comprises at least one light-emitting layer B composed of one or more than one sublayers, wherein at least one sublayer comprises exactly one hole scavenger $H_{scav}$, exactly one excitation energy transfer component EET-1, and exactly one small FWHM emitter $S^B$.

In a preferred embodiment of the invention, the organic electroluminescent device according to the invention comprises at least one light-emitting layer B composed of one or more than one sublayers, wherein at least one sublayer

comprises exactly one host material $H^B$, exactly one excitation energy transfer component EET-1, exactly one hole scavenger $H_{scav}$, and exactly one small FWHM emitter $S^B$.

In one embodiment of the invention, a sublayer comprises exactly one excitation energy transfer component EET-1 and another sublayer comprises exactly one hole scavenger $H_{scav}$ and exactly one small FWHM emitter $S^B$. In one embodiment of the invention, an electroluminescent device according to the invention comprises at least one light-emitting layer B comprising (or consisting of) three or more than three sublayers (B1, B2, B3, ...), wherein the first sublayer B1 comprises exactly one excitation energy transfer component EET-1, the second sublayer B2 comprises exactly one hole scavenger $H_{scav}$, and the third sublayer B3 comprises exactly one small FWHM emitter $S^B$. It is understood that the sublayers of a light-emitting layer B can be fabricated in different orders, e.g., B1 - B2 - B3, B1 - B3 - B2, B2 - B1 - B3, B2 - B3 - B1, B3 - B2 - B1, B3 - B1 - B2, and with one or more different sublayers in between. It is preferred that sublayers B1, B2, and B3 are (directly) adjacent to each other, in other words, are in (direct) contact with each other.

In one embodiment of the invention, an electroluminescent device according to the invention comprises at least one light-emitting layer B comprising (or consisting of) two or more than two sublayers (B1, B2, ...), wherein the first sublayer B1 comprises exactly one excitation energy transfer component EET-1 and exactly one hole scavenger $H_{scav}$, and the second sublayer B2 comprises exactly one small FWHM emitter $S^B$. It is understood that the sublayers of a light-emitting layer B can be fabricated in different orders, e.g. B2 - B1 or B1 - B2, and with one or more different sublayers in between. It is preferred that sublayers B1 and B2 are (directly) adjacent to each other, in other words, are in (direct) contact with each other.

In one embodiment of the invention, an electroluminescent device according to the invention comprises at least one light-emitting layer B comprising (or consisting of) two or more than two sublayers (B1, B2, ...), wherein the first sublayer B1 comprises exactly one excitation energy transfer component EET-1 and the second sublayer B2 comprises exactly one excitation energy transfer component EET-1 and exactly one small FWHM emitter $S^B$. It is understood that the sublayers of a light-emitting layer B can be fabricated in different orders, e.g. B2 - B1 or B1 - B2, and with one or more different sublayers in between. It is preferred that sublayers B1 and B2 are (directly) adjacent to each other, in other words, are in (direct) contact with each other.

In one embodiment of the invention, an electroluminescent device according to the invention comprises at least one light-emitting layer B comprising (or consisting of) two or more than two sublayers (B1, B2, ...), wherein the first sublayer B1 comprises exactly one hole scavenger $H_{scav}$ and the second sublayer B2 comprises exactly one excitation energy transfer component EET-1 and exactly one small FWHM emitter $S^B$. It is understood that the sublayers of a light-emitting layer B can be fabricated in different orders, e.g. B2 - B1 or B1 - B2, and with one or more different sublayers in between. It is understood that the sublayers of a light-emitting layer B can be fabricated in different orders, e.g. B2 - B1 or B1 - B2, and with one or more different sublayers in between. It is preferred that sublayers B1 and B2 are (directly) adjacent to each other, in other words, are in (direct) contact with each other.

In one embodiment of the invention, an electroluminescent device according to the invention comprises at least one light-emitting layer B comprising (or consisting of) two or more than two sublayers (B1, B2, ...), wherein the first sublayer B1 comprises exactly one small FWHM emitter $S^B$, and the second sublayer B2 comprises exactly one excitation energy transfer component EET-1 and exactly one hole scavenger $H_{scav}$. It is understood that the sublayers of a light-emitting layer B can be fabricated in different orders, e.g. B2 - B1 or B1 - B2, and with one or more different sublayers in between. It is preferred that sublayers B1 and B2 are (directly) adjacent to each other, in other words, are in (direct) contact with each other.

In a preferred embodiment of the invention, when a light a light-emitting layer B comprises more than one sublayer, the sublayer closest to the anode comprises at least one excitation energy transfer component EET-1 and the sublayer closest to the cathode comprises at least one hole scavenger $H_{scav}$.

It is understood that an organic electroluminescent device according to the invention may optionally also comprise one or more light-emitting layers which do not fulfill the requirements given for a light-emitting layer B in the context of the present invention. In other words: An organic electroluminescent device according to the present invention comprises at least one light-emitting layer B as defined herein and may optionally comprise one or more additional light-emitting layers for which the requirements given herein for a light-emitting layer B do not necessarily apply. In one embodiment of the invention, at least one, but not all light-emitting layers comprised in the organic electroluminescent device according to the invention are light-emitting layers B as defined within the specific embodiments of the invention.

In a preferred embodiment of the invention, each light-emitting layer comprised in the organic electroluminescent device according to the invention is a light-emitting layer B as defined within the specific embodiments of the present invention.

*Composition of the light emitting layer(s) (EML) B*

In the following, when describing the composition of the one or more light-emitting layers B of the organic electroluminescent device according to the present invention in more detail, reference is in some cases made to the

content of certain materials in form of percentages. It is to be noted that, unless stated otherwise for specific embodiments, all percentages refer to weight percentages, which has the same meaning as percent by weight or % by weight ((weight/weight), (w/w), wt.%). It is understood that, when for example stating that the content of one or more small FWHM emitters $S^B$ in a specific composition is exemplarily 1%, this is to mean that the total weight of the one or more small FWHM emitters $S^B$ (i.e. of all $S^B$-molecules combined) is 1% by weight, i.e. accounts for 1% of the total weight of the respective light-emitting layer B. It is understood that, whenever the composition of a light-emitting layer B is specified by providing the preferred content of its components in % by weight, the total content of all components adds up to 100% by weight (i.e. the total weight of the respective light-emitting layer B).

The (optionally comprised) one or more host materials $H^B$, the one or more excitation energy transfer components EET-1, the one or more hole scavengers $H_{scav}$, and the one or more small FWHM emitters $S^B$ may be comprised in the organic electroluminescent device according to the present invention in any amount and any ratio.

In a preferred embodiment of the invention, the electroluminescent device according to the invention comprises at least one light-emitting layer B composed of one or more than one sublayer, wherein each of the at least one sublayers comprises more of the one or more host materials $H^B$ (more specific: $H^P$ and/or $H^N$ and/or $H^{BP}$), than of the one or more small FWHM emitters $S^B$, according to the weight.

In a preferred embodiment of the invention, the electroluminescent device according to the invention comprises at least one light-emitting layer B composed of one or more than one sublayer, wherein each of the at least one sublayers comprises more of the one or more host materials $H^B$ (more specific: $H^P$ and/or $H^N$ and/or $H^{BP}$), than of the one or more hole scavengers $H_{scav}$, according to the weight.

In a preferred embodiment of the invention, the electroluminescent device according to the invention comprises at least one light-emitting layer B composed of one or more than one sublayer, wherein each of the at least one sublayers comprises more of the one or more host materials $H^B$ (more specific: $H^P$ and/or $H^N$ and/or $H^{BP}$), than of the one or more excitation energy transfer components EET-1, according to the weight.

In a preferred embodiment of the invention, each of the at least one light-emitting layers B of the organic electroluminescent device according to the present invention comprises more of the one or more excitation energy transfer components EET-1 than of the one or more small FWHM emitters $S^B$, according to the weight.

In a preferred embodiment of the invention, each of the at least one light-emitting layers B of an organic electroluminescent device according to the present invention comprises more of the one or more excitation energy transfer components EET-1 than of the one or more hole scavengers $H_{scav}$, according to the weight.

In one embodiment, in the organic electroluminescent device according to the present invention, at least one, preferably each, light-emitting layer B as a whole (consisting of one (sub)layer or comprising more than one sublayers) comprises or consists of:

(i) 12-60% by weight of one or more excitation energy transfer components EET-1; and
(ii) 0.1-30% by weight of one or more hole scavengers $H_{scav}$; and
(iii) 0.1-10% by weight of one or more small FWHM emitters $S^B$; and
(iv) 30-87.8% by weight of one or more host materials $H^B$; and optionally
(v) 0-57.8% by weight of one or more solvents.

In one embodiment, in the organic electroluminescent device according to the present invention, at least one, preferably each, light-emitting layer B as a whole (consisting of one (sub)layer or comprising more than one sublayers) comprises or consists of:

(i) 12-60% by weight of one or more excitation energy transfer components EET-1; and
(ii) 0.1-30% by weight of one or more hole scavengers $H_{scav}$; and
(iii) 0.1-10% by weight of one or more small FWHM emitters $S^B$; and
(iv) 30-87.8% by weight of one or more host materials $H^B$; and optionally
(v) 0-3% by weight of one or more solvents.

In a preferred embodiment, in the organic electroluminescent device according to the present invention, at least one, preferably each, light-emitting layer B as a whole (consisting of one (sub)layer or comprising more than one sublayers) comprises or consists of:

(i) 15-50% by weight of one or more excitation energy transfer components EET-1; and
(ii) 0.1-15% by weight of one or more hole scavengers $H_{scav}$; and
(iii) 0.1-5% by weight of one or more small FWHM emitters $S^B$; and
(iv) 30-84.8% by weight of one or more host materials $H^B$; and optionally
(v) 0-54.8% by weight of one or more solvents.

In a preferred embodiment, in the organic electroluminescent device according to the present invention, at least one, preferably each, light-emitting layer B as a whole (consisting of one (sub)layer or comprising more than one sublayers) comprises or consists of:

(i) 15-50% by weight of one or more excitation energy transfer components EET-1; and
(ii) 0.1-15% by weight of one or more hole scavengers $H_{scav}$; and
(iii) 0.1-5% by weight of one or more small FWHM emitters $S^B$; and
(iv) 30-84.8% by weight of one or more host materials $H^B$; and optionally
(v) 0-3% by weight of one or more solvents.

In an even more preferred embodiment, in the organic electroluminescent device according to the present invention, at least one, preferably each, light-emitting layer B as a whole (consisting of one (sub)layer or comprising more than one sublayers) comprises or consists of:

(i) 20-50% by weight of one or more excitation energy transfer components EET-1; and
(ii) 0.1-10% by weight of one or more hole scavengers $H_{scav}$; and
(iii) 0.1-3% by weight of one or more small FWHM emitters $S^B$; and
(iv) 40-79.8% by weight of one or more host materials $H^B$; and optionally
(v) 0-39.8% by weight of one or more solvents.

In an even more preferred embodiment, in the organic electroluminescent device according to the present invention, at least one, preferably each, light-emitting layer B as a whole (consisting of one (sub)layer or comprising more than one sublayers) comprises or consists of:

(i) 20-50% by weight of one or more excitation energy transfer components EET-1; and
(ii) 0.1-10% by weight of one or more hole scavengers $H_{scav}$; and
(iii) 0.1-3% by weight of one or more small FWHM emitters $S^B$; and
(iv) 40-79.8% by weight of one or more host materials $H^B$; and optionally
(v) 0-3% by weight of one or more solvents.

In a still even more preferred embodiment, in the organic electroluminescent device according to the present invention, tat least one, preferably each, light-emitting layer B as a whole (consisting of one (sub)layer or comprising more than one sublayers) comprises or consists of:

(i) 20-45% by weight of one or more excitation energy transfer components EET-1; and
(ii) 0.1-5% by weight of one or more hole scavengers $H_{scav}$; and
(iii) 0.1-3% by weight of one or more small FWHM emitters $S^B$; and
(iv) 40-79.8% by weight of one or more host materials $H^B$; and optionally
(v) 0-39.8% by weight of one or more solvents.

In a still even more preferred embodiment, in the organic electroluminescent device according to the present invention, tat least one, preferably each, light-emitting layer B as a whole (consisting of one (sub)layer or comprising more than one sublayers) comprises or consists of:

(i) 20-45% by weight of one or more excitation energy transfer components EET-1; and
(ii) 0.1-5% by weight of one or more hole scavengers $H_{scav}$; and
(iii) 0.1-3% by weight of one or more small FWHM emitters $S^B$; and
(iv) 40-79.8% by weight of one or more host materials $H^B$; and optionally
(v) 0-3% by weight of one or more solvents.

In a particularly preferred embodiment, in the organic electroluminescent device according to the present invention, the at least one, preferably each, light-emitting layer B as a whole (consisting of one (sub)layer or comprising more than one sublayers) comprises or consists of:

(i) 20-45% by weight of one or more excitation energy transfer components EET-1; and
(ii) 0.1-3% by weight of one or more hole scavengers $H_{scav}$; and
(iii) 0.1-3% by weight of one or more small FWHM emitters $S^B$; and
(iv) 40-79.8% by weight of one or more host materials $H^B$; and optionally

(v) 0-39.8% by weight of one or more solvents.

In a particularly preferred embodiment, in the organic electroluminescent device according to the present invention, the at least one, preferably each, light-emitting layer B as a whole (consisting of one (sub)layer or comprising more than one sublayers) comprises or consists of:

(i) 20-45% by weight of one or more excitation energy transfer components EET-1; and
(ii) 0.1-3% by weight of one or more hole scavengers $H_{scav}$; and
(iii) 0.1-3% by weight of one or more small FWHM emitters $S^B$; and
(iv) 40-79.8% by weight of one or more host materials $H^B$; and optionally
(v) 0-3% by weight of one or more solvents.

In a preferred embodiment of the invention, at least one, preferably each, light-emitting layer B comprises less than or equal to 5% by weight, referred to the total weight of the light-emitting layer B, of one or more hole scavengers $H_{scav}$ (meaning the total content of $H_{scav}$ in the respective light-emitting layer B is equal to or less than 5% by weight).

In an even more preferred embodiment of the invention, at least one, preferably each, light-emitting layer B comprises less than or equal to 3% by weight, referred to the total weight of the light-emitting layer B, of one or more hole scavengers $H_{scav}$ (meaning the total content of $H_{scav}$ in the respective light-emitting layer B is equal to or less than 3% by weight).

In one embodiment of the invention, at least one, preferably each, light-emitting layer B comprises less than or equal to 1% by weight, referred to the total weight of the light-emitting layer B, of one or more hole scavengers $H_{scav}$ (meaning the total content of $H_{scav}$ in the respective light-emitting layer B is equal to or less than 1% by weight).

In a preferred embodiment of the invention, at least one, preferably each, light-emitting layer B comprises less than or equal to 5% by weight, referred to the total weight of the light-emitting layer B, of one or more small FWHM emitters $S^B$ (meaning the total content of $S^B$ in the respective light-emitting layer B is equal to or less than 5% by weight).

In an even more preferred embodiment of the invention, at least one, preferably each, light-emitting layer B comprises less than or equal to 3% by weight, referred to the total weight of the light-emitting layer B, of one or more small FWHM emitters $S^B$ (meaning the total content of $S^B$ in the respective light-emitting layer B is equal to or less than 3% by weight).

In one embodiment of the invention, at least one, preferably each, light-emitting layer B comprises less than or equal to 1% by weight, referred to the total weight of the light-emitting layer B, of one or more small FWHM emitters $S^B$ (meaning the total content of $S^B$ in the respective light-emitting layer B is equal to or less than 1% by weight).

In a preferred embodiment of the invention, at least one, preferably each, light-emitting layer B comprises 15-50% by weight, referred to the total weight of the light-emitting layer B, of one or more excitation energy transfer components EET-1 (meaning the total content of EET-1 in the respective light-emitting layer B is in the range of 15-50% by weight).

In a preferred embodiment of the invention, at least one, preferably each, light-emitting layer B comprises 20-50% by weight, referred to the total weight of the light-emitting layer B, of one or more excitation energy transfer components EET-1 (meaning the total content of EET-1 in the respective light-emitting layer B is in the range of 20-50% by weight).

In a preferred embodiment of the invention, at least one, preferably each, light-emitting layer B comprises 20-45% by weight, referred to the total weight of the light-emitting layer B, of one or more excitation energy transfer components EET-1 (meaning the total content of EET-1 in the respective light-emitting layer B is in the range of 20-45% by weight).

As stated previously, it is understood that different sublayers of a light-emitting layer B do not necessarily all comprise the same materials or even the same materials in the same ratios. It is also understood that different light-emitting layers B optionally comprised in the organic electroluminescent device according to the present invention do not necessarily all comprise the same materials or even the same materials in the same ratios.

*Hole scavenger(s) $H_{scav}$*

A hole scavenger $H_{scav}$ in the context of the present invention may have any chemical structure as long as it fulfills the basic requirements expressed by the aforementioned formulas (4), (5), and (6). This is to say that none of the species EET-1, $S^B$, and $H^B$ comprised in the same light-emitting layer B as the respective hole scavenger $H_{scav}$ has a HOMO energy that is higher than the HOMO-energy $E^{HOMO}(H_{scav})$ of the respective hole scavenger $H_{scav}$. In consequence, the so called hole scavenger $H_{scav}$ may function as what may be referred to as a hole trap and attract positive charges within the light-emitting layer(s) B.

The skilled artisan knows that the recombination zone (RZ, i.e. the region in which excitons are generated by

electron-hole-recombination, vide infra) is typically correlated to the charge balance between electrons and holes within the light-emitting layer(s) of an organic electroluminescent device. As also known to those skilled in the art and as will be laid out in more detail in a later subchapter, a broadened and/or more evenly distributed recombination zone may result in a prolonged device lifetime through the reduction of exciton stress per molecule. Without being bound to this theory, it is assumed that the presence of one or more hole scavengers $H_{scav}$ in each of the one or more light-emitting layers B, in particular alongside one or more excitation energy transfer components EET-1 having a low-energy LUMO, may contribute to the observed beneficial effect on the device performance by impacting the recombination zone. This will be explained in more detail in a later subchapter of this text.

In the organic electroluminescent device according to the present invention, each hole scavenger $H_{scav}$ may for example be independently of the optional one or more further hole scavengers $H_{scav}$ selected from the group consisting of:

- an excitation energy transfer component EET-2,
- a fluorescence emitter F,
- a host material $host^{scav}$,

wherein these species are defined as described herein (vide infra) and wherein this does not imply that only the mentioned species may serve as hole scavengers $H_{scav}$ in the device of the present invention.

Thus, in one embodiment, within at least one, preferably each, light-emitting layer B, at least one, preferably each, hole scavenger $H_{scav}$ is independently selected from the group consisting of:

- an excitation energy transfer component EET-2,
- a fluorescence emitter F,
- a host material $host^{scav}$,

wherein these species are defined as described herein (vide infra).

It is understood that the expression "these species are defined as described herein" is to say that all definitions and embodiments related to the mentioned species (in this case EET-2, F, and $host^{scav}$) may also relate to the respective hole scavenger $H_{scav}$, provided that said $H_{scav}$ constitutes such a species. It is also understood that along the same lines, each embodiment related to hole scavengers $H_{scav}$ in general is also applicable to the species EET-2, F, and $host^{scav}$ provided that they are used as hole scvanenger $H^{scav}$.

In one embodiment, within at least one, preferably each, light-emitting layer B, at least one, preferably each, hole scavenger $H_{scav}$ is independently selected from the group consisting of:

- an excitation energy transfer component EET-2,
- a fluorescence emitter F,

wherein these species are defined as described herein (vide infra).

In one embodiment, within at least one, preferably each, light-emitting layer B, at least one, preferably each, hole scavenger $H_{scav}$ is independently selected from the group consisting of:

- an excitation energy transfer component EET-2,
- a host material $host^{scav}$,

wherein these species are defined as described herein (vide infra).

In one embodiment, within at least one, preferably each, light-emitting layer B, at least one, preferably each, hole scavenger $H_{scav}$ is independently selected from the group consisting of:

- a fluorescence emitter F,
- a host material $host^{scav}$,

wherein these species are defined as described herein (vide infra).

In a preferred embodiment, within at least one, preferably each, light-emitting layer B, at least one, preferably each, hole scavenger $H_{scav}$ is an excitation energy transfer component EET-2 as defined herein (vide infra).

In one embodiment, within at least one, preferably each, light-emitting layer B, at least one, preferably each, hole scavenger $H_{scav}$ is a fluorescence emitter F as defined herein (vide infra).

In one embodiment, within at least one, preferably each, light-emitting layer B, at least one, preferably each, hole scavenger $H_{scav}$ is a host material $host^{scav}$ as defined herein (vide infra).

In a preferred embodiment within each light-emitting layer B, all of the one or more hole scavengers $H_{scav}$ are

either all excitation energy transfer components EET-2 as defined herein or all fluorescence emitters F as defined herein or all host materials $H_{scav}$ as defined herein.

In a preferred embodiment, each light-emitting layer B comprises exactly one hole scavenger $H_{scav}$ which is for each of the one or more light-emitting layers B independently selected from the group consisting of:

- excitation energy transfer component EET-2,
- a fluorescence emitter F,
- a host material $host^{scav}$,

wherein these species are defined as described herein (vide infra).

In a preferred embodiment, each light-emitting layer B comprises exactly one hole scavenger $H_{scav}$ which is for each of the one or more light-emitting layers B independently selected from the group consisting of:

- excitation energy transfer component EET-2,
- a fluorescence emitter F,

wherein these species are defined as described herein (vide infra).

In a preferred embodiment, each light-emitting layer B comprises exactly one hole scavenger $H_{scav}$ which is for each of the one or more light-emitting layers B independently selected from the group consisting of:

- excitation energy transfer component EET-2,
- a host material $host^{scav}$,

wherein these species are defined as described herein (vide infra).

In a preferred embodiment, each light-emitting layer B comprises exactly one hole scavenger $H_{scav}$ which is for each of the one or more light-emitting layers B independently selected from the group consisting of:

- a fluorescence emitter F,
- a host material $host^{scav}$,

wherein these species are defined as described herein (vide infra).

In a preferred embodiment of the invention, each light-emitting layer B comprises exactly one hole scavenger $H_{scav}$ and this $H_{scav}$ is excitation energy transfer component EET-2 as defined herein.

In a preferred embodiment of the invention, each light-emitting layer B comprises exactly one hole scavenger $H_{scav}$ and this $H_{scav}$ is a fluorescence emitter F as defined herein.

In a preferred embodiment of the invention, each light-emitting layer B comprises exactly one hole scavenger $H_{scav}$ and this $H_{scav}$ is a host material $host^{scav}$ as defined herein.

The excitation energy transfer component(s) EET-2 will be described in detail in the following subchapter *"Excitation energy transfer components EET-1 and EET-2"*.

A fluorescence emitter F in the context of the present invention is any material that is capable of emitting light at room temperature (i.e. (approximately) 20 °C) upon electronic excitation (for example in an organic electroluminescent device), wherein the emissive excited state is a singlet state (typically the lowermost excited singlet state S1). Fluorescence spectra may typically be recorded at room temperature (i.e. (approximately) 20 °C) from a spin-coated film of the respective emitter (the assumed fluorescence emitter F) in poly(methyl methacrylate), PMMA, with a concentration of 1 to 5% by weight, in particular with 2% by weight of the respective emitter.

Fluorescence emitters usually display prompt (i.e. direct) fluorescence on a timescale of nanoseconds, when the initial electronic excitation (for example by electron hole recombination) affords an excited singlet state of the emitter. As will be laid out in a later subchapter of this text, fluorescence emitters (for example fluorescence emitters F) may or may not additionally exhibit thermally activated delayed fluorescence (TADF).

Selecting materials that are fluorescence emitters F in the context of the present invention is easily achieved based on the common knowledge of those skilled in the arte and without an inventive step. The following subchapter "Small FWHM emitter(s) $S^B$" provides detailed guiding rail towards the design of fluorescent materials that may be used as fluorescence emitters F and that may have a favorably narrow emission, expressed by a full width at half maximum (FWHM) of less than or equal to 0.25 eV ($\leq$ 0.25 eV). This is to say that in fact, any material that may be used as small FWHM emitter $S^B$ in the context of the present invention (vide infra) may also be used as fluorescence emitter F and thus, as hole scavenger $H_{scav}$ in the context of the present invention, provided of course that it fulfills the basic requirements given by the relations of the aforementioned formulas (4), (5), and (6).

Thus, in a preferred embodiment, at least one, preferably each, fluorescence emitter F comprised in a light-emitting layer B is a small FWHM emitter $S^B$ as defined herein (vide infra).

In one embodiment of the invention, wherein at least one light-emitting layer B comprises a fluorescence emitter F, at least one, preferably each, fluorescence emitter F emits light with an emission maximum in the wavelength range of from 400 nm to 470 nm, measured (with 1 to 5% by weight, in particular with 2% by weight of the emitter F) in PMMA at room temperature.

In one embodiment of the invention, wherein at least one light-emitting layer B comprises a fluorescence emitter F, at least one, preferably each, fluorescence emitter F emits light with an emission maximum in the wavelength range of from 500 nm to 560 nm, measured (with 1 to 5% by weight, in particular with 2% by weight of the emitter F) in PMMA at room temperature.

In one embodiment of the invention, wherein at least one light-emitting layer B comprises a fluorescence emitter F, at least one, preferably each, fluorescence emitter F emits light with an emission maximum in the wavelength range of from 610 nm to 665 nm, measured (with 1 to 5% by weight, in particular with 2% by weight of the emitter F) in PMMA at room temperature.

In one embodiment of the invention, wherein at least one light-emitting layer B comprises a fluorescence emitter F, at least one, preferably each, fluorescence emitter F emits light with an emission maximum in the wavelength range of from 400 nm to 470 nm, measured with 0.001-0.2 mg/mL of the emitter F in dichloromethane or toluene at room temperature (i.e., (approximately) 20°C).

In one embodiment of the invention, wherein at least one light-emitting layer B comprises a fluorescence emitter F, at least one, preferably each, fluorescence emitter F emits light with an emission maximum in the wavelength range of from 500 nm to 560 nm, measured with 0.001-0.2 mg/mL of the emitter F in dichloromethane or toluene at room temperature (i.e., (approximately) 20°C).

In one embodiment of the invention, wherein at least one light-emitting layer B comprises a fluorescence emitter F, at least one, preferably each, fluorescence emitter F emits light with an emission maximum in the wavelength range of from 610 nm to 665 nm, measured with 0.001-0.2 mg/mL of the emitter F in dichloromethane or toluene at room temperature (i.e., (approximately) 20°C).

In one embodiment of the invention, wherein at least one light-emitting layer B comprises a fluorescence emitter F, at least one, preferably each, fluorescence emitter F exhibits a photoluminescence quantum yield (PLQY) equal to or higher than 50%, measured (with 1 to 5% by weight, in particular with 2% by weight of the emitter F) in PMMA at room temperature.

In a preferred embodiment of the invention, wherein at least one light-emitting layer B comprises a fluorescence emitter F, at least one, preferably each, fluorescence emitter F exhibits a photoluminescence quantum yield (PLQY) equal to or higher than 60%, measured (with 1 to 5% by weight, in particular with 2% by weight of the emitter F) in PMMA at room temperature.

In an even more preferred embodiment of the invention, wherein at least one light-emitting layer B comprises a fluorescence emitter F, at least one, preferably each, fluorescence emitter F exhibits a photoluminescence quantum yield (PLQY) equal to or higher than 70%, measured (with 1 to 5% by weight, in particular with 2% by weight of the emitter F) in PMMA at room temperature.

In a still even more preferred embodiment of the invention, wherein at least one light-emitting layer B comprises a fluorescence emitter F, at least one, preferably each, fluorescence emitter F exhibits a photoluminescence quantum yield (PLQY) equal to or higher than 80%, measured (with 1 to 5% by weight, in particular with 2% by weight of the emitter F) in PMMA at room temperature.

In a particularly preferred embodiment of the invention, wherein at least one light-emitting layer B comprises a fluorescence emitter F, at least one, preferably each, fluorescence emitter F exhibits a photoluminescence quantum yield (PLQY) equal to or higher than 90%, measured (with 1 to 5% by weight, in particular with 2% by weight of the emitter F) in PMMA at room temperature.

In one embodiment of the invention, wherein at least one light-emitting layer B comprises a fluorescence emitter F, at least one, preferably each, fluorescence emitter F exhibits a photoluminescence quantum yield (PLQY) equal to or higher than 50%, measured with 0.001-0.2 mg/mL of the emitter F in dichloromethane or toluene at room temperature (i.e., (approximately) 20°C).

In a preferred embodiment of the invention, wherein at least one light-emitting layer B comprises a fluorescence emitter F, at least one, preferably each, fluorescence emitter F exhibits a photoluminescence quantum yield (PLQY) equal to or higher than 60%, measured with 0.001-0.2 mg/mL of the emitter F in dichloromethane or toluene at room temperature (i.e., (approximately) 20°C).

In an even more preferred embodiment of the invention, wherein at least one light-emitting layer B comprises a fluorescence emitter F, at least one, preferably each, fluorescence emitter F exhibits a photoluminescence quantum yield (PLQY) equal to or higher than 70%, measured with 0.001-0.2 mg/mL of the emitter F in dichloromethane or toluene at room temperature (i.e., (approximately) 20°C).

In a still even more preferred embodiment of the invention, wherein at least one light-emitting layer B comprises a

fluorescence emitter F, at least one, preferably each, fluorescence emitter F exhibits a photoluminescence quantum yield (PLQY) equal to or higher than 80%, measured with 0.001-0.2 mg/mL of the emitter F in dichloromethane or toluene at room temperature (i.e., (approximately) 20°C).

In a particularly preferred embodiment of the invention, wherein at least one light-emitting layer B comprises a fluorescence emitter F, at least one, preferably each, fluorescence emitter F exhibits a photoluminescence quantum yield (PLQY) equal to or higher than 90%, measured with 0.001-0.2 mg/mL of the emitter F in dichloromethane or toluene at room temperature (i.e., (approximately) 20°C).

In a preferred embodiment, wherein at least one light-emitting layer B comprises a fluorescence emitter F, at least one, preferably each, fluorescence emitter F is an organic emitter, which, in the context of the invention, means that it does not contain any transition metals. Preferably, each fluorescence emitter F according to the invention predominantly consists of the elements hydrogen (H), carbon (C), nitrogen (N), and boron (B), but may for example also comprise oxygen (O), silicon (Si), fluorine (F), and bromine (Br).

In one embodiment of the invention, wherein at least one light-emitting layer B comprises a fluorescence emitter F, at least one, preferably each, fluorescence emitter F is a boron (B)-containing emitter, which means that at least one atom within each fluorescence emitter F is boron (B).

In one embodiment of the invention, wherein at least one light-emitting layer B comprises a fluorescence emitter F, at least one, preferably each, fluorescence emitter F comprises a polycyclic aromatic or heteroaromatic core structure, wherein at least two aromatic rings are fused together (e.g. anthracene, pyrene or aza-derivatives thereof).

In one embodiment of the invention, wherein at least one light-emitting layer B comprises a fluorescence emitter F, at least one, preferably each, fluorescence emitter F fulfills at least one (or both) of the following requirements:

(i) it is a boron (B)-containing emitter, which means that at least one atom within the respective fluorescence emitter F is boron (B); and/or
(ii) it comprises a polycyclic aromatic or heteroaromatic core structure, wherein at least two aromatic rings are fused together (e.g. anthracene, pyrene or aza-derivatives thereof).

In one embodiment of the invention, wherein at least one light-emitting layer B comprises a fluorescence emitter F, at least one, preferably each, fluorescence emitter F fulfills at least one (or both) of the following requirements:

(i) it is a boron (B)-containing emitter, which means that at least one atom within the respective fluorescence emitter F is boron (B); and/or
(ii) it comprises a pyrene core structure.

In one embodiment of the invention, wherein at least one light-emitting layer B comprises a fluorescence emitter F, at least one, preferably each, fluorescence emitter F comprises a pyrene core structure.

In a preferred embodiment of the invention, wherein at least one light-emitting layer B comprises a fluorescence emitter F, at least one, preferably each, fluorescence emitter F is a boron (B)- and nitrogen (N)-containing emitter, which means that at least one atom within the respective fluorescence emitter F is boron (B) and at least one atom within the respective fluorescence emitter F is nitrogen (N).

In a preferred embodiment of the invention, wherein at least one light-emitting layer B comprises a fluorescence emitter F, at least one, preferably each, fluorescence emitter F comprises at least one boron atom (B)- that is (directly) covalently bonded to at least one nitrogen atom (N).

In a preferred embodiment of the invention, wherein at least one light-emitting layer B comprises a fluorescence emitter F, at least one, preferably each, fluorescence emitter F comprises a boron atom (B) that is trivalent, i.e. bonded via three single bonds.

In one embodiment of the invention, wherein at least one light-emitting layer B comprises a fluorescence emitter F, at least one, preferably each, fluorescence emitter F comprises the BODIPY core structure depicted below:

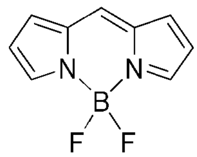

, wherein the core structure may be optionally substituted and wherein one or both of the fluorine substituents may independently be replaced by alkoxy or aryloxy groups which are attached via the oxygen atom and may optionally be substituted, preferably with electron-withdrawing substituents such as fluorine (F) or trifluoromethyl ($CF_3$).

In one embodiment of the invention, wherein at least one light-emitting layer B comprises a fluorescence emitter

F, at least one, preferably each, fluorescence emitter F comprises a structure according to formula DABNA-I (vide infra).

In one embodiment of the invention, wherein at least one light-emitting layer B comprises a fluorescence emitter F, at least one, preferably each, fluorescence emitter F consists of a structure according to formula DABNA-I (vide infra).

In a preferred embodiment of the invention, wherein at least one light-emitting layer B comprises a fluorescence emitter F, at least one, preferably each, fluorescence emitter F comprises or consists of a structure according to formula DABNA-I, A', B', and C' are all aromatic rings with 6 ring atoms each (i.e. they are all benzene rings) (vide infra).

In one embodiment of the invention, wherein at least one light-emitting layer B comprises a fluorescence emitter F, at least one, preferably each, fluorescence emitter F is a dimer of formula DABNA-I as described above, which means that the emitter comprises two subunits, each having a structure according to formula DABNA-I (vide infra).

In one embodiment of the invention, wherein at least one light-emitting layer B comprises a fluorescence emitter F, at least one, preferably each, fluorescence emitter F comprises a structure according to formula BNE-1 (vide infra).

In one embodiment of the invention, in at least one, wherein at least one light-emitting layer B comprises a fluorescence emitter F, at least one, preferably each, fluorescence emitter F consists of a structure according to formula BNE-1 (vide infra).

In one embodiment of the invention, wherein at least one light-emitting layer B comprises a fluorescence emitter F, at least one, preferably each, fluorescence emitter F is a dimer of formula BNE-1 as described above, which means that the emitter comprises two subunits, each having a structure according to formula BNE-1.

The person skilled in the art understands that a host material $host^{scav}$ that is optionally employed as hole scavenger $H_{scav}$ may be any host material known from the state of the art as long as it fulfills the basic requirements expressed by the aforementioned formulas (4), (5), and (6). In particular the materials herein referred to as p-hosts $H^P$ may be used as hole scavenger(s) $H_{scav}$ in the context of the present invention, provided that the basic requirements expressed by the aforementioned formulas (4), (5), and (6) are fulfilled.

In a preferred embodiment of the invention, a $host^{scav}$, optionally comprised in any of the one or more light-emitting layers B as a whole (consisting of one (sub)layer or comprising more than one sublayers), comprises or consists of:

- one first chemical moiety, comprising or consisting of a structure according to any of the formulas $H^P$-I, $H^P$-II, $H^P$-III, $H^P$-IV, $H^P$-V, $H^P$-VI, $H^P$-VII, $H^P$-VIII, $H^P$-IX, and $H^P$-X:

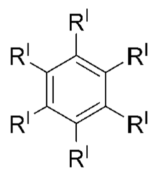

Formula $H^P$-I

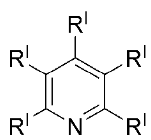

Formula $H^P$-II

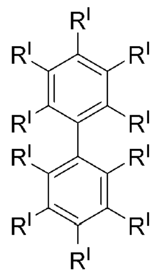

Formula $H^P$-III

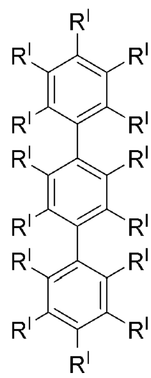

Formula $H^P$-IV

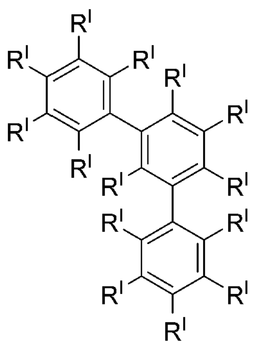

Formula $H^P$-V

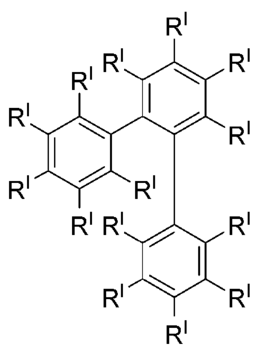

Formula $H^P$-VI

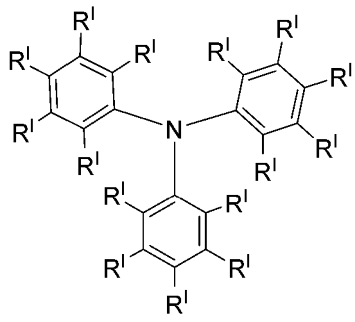

Formula $H^P$-VII

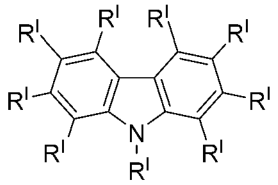

Formula $H^P$-VIII

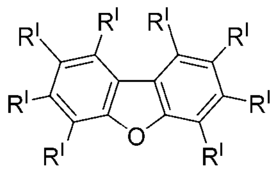

Formula $H^P$-IX

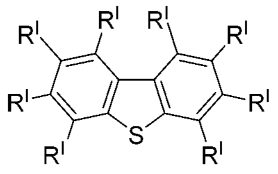

Formula $H^P$-X

and

- one or more second chemical moieties, each comprising or consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX:

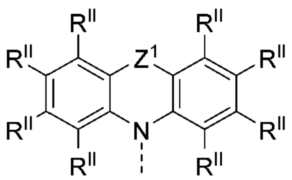

Formula $H^P$-XI

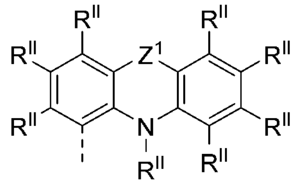

Formula $H^P$-XII

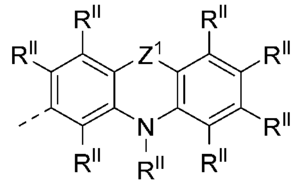

Formula $H^P$-XIII

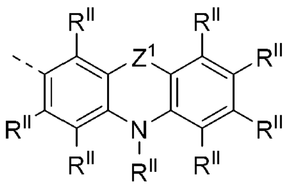

Formula $H^P$-XIV

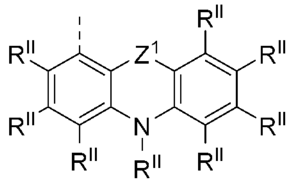

Formula $H^P$-XV

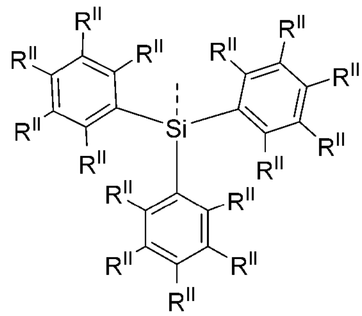

Formula $H^P$-XVI

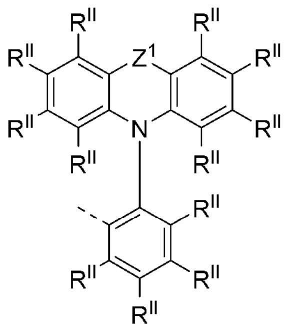

Formula $H^P$-XVII

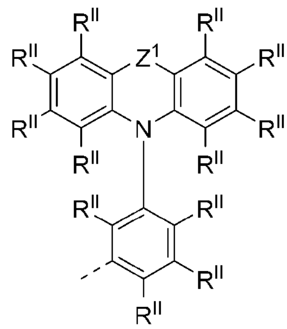

Formula $H^P$-XVIII

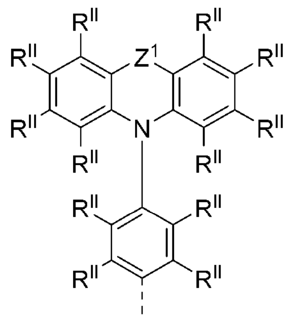

Formula $H^P$-XIX,

wherein each of the one or more second chemical moieties which is present in the p-host material $H^P$ is linked to the first chemical moiety via a single bond which is represented in the formulas above by a dashed line;
wherein
$Z^1$ is at each occurrence independently of each other selected from the group consisting of a direct bond, $C(R^{II})_2$, $C=C(R^{II})2$, C=O, $C=NR^{II}$, $NR^{II}$, O, $Si(R^{II})_2$, S, S(O) and $S(O)_2$;
$R^I$ is at each occurrence independently of each other a binding site of a single bond linking the first chemical moiety to a second chemical moiety or is selected from the group consisting of: hydrogen, deuterium, Me, $^i$Pr, and $^t$Bu, and Ph, which is optionally substituted with one or more substituents independently of each other selected from the group consisting of: Me, $^i$Pr, $^t$Bu, and Ph;
wherein at least one $R^I$ is a binding site of a single bond linking the first chemical moiety to a second chemical moiety;
$R^{II}$ is at each occurrence independently of each other selected from the group consisting of: hydrogen, deuterium, Me,

$^{i}Pr$, $^{t}Bu$, and

Ph, which is optionally substituted with one or more substituents independently of each other selected from the group consisting of: Me, $^{i}Pr$, $^{t}Bu$, and Ph;

wherein two or more adjacent substituents $R^{II}$ may optionally form a mono- or polycyclic, aliphatic or aromatic or heteroaromatic, carbo- or heterocyclic ring system so that the fused ring system consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX as well as the additional rings optionally formed by adjacent substituents $R^{II}$ comprises in total 8-60 carbon atoms preferably 12-40 carbon atoms, more preferably 14-32 carbon atoms.

In an even more preferred embodiment of the invention, $Z^1$ is at each occurrence a direct bond and adjacent substituents $R^{II}$ do not combine to form an additional ring system.

*Excitation energy transfer components EET-1 and EET-2*

For each light-emitting layer B, the one or more excitation energy transfer components EET-1 and the optionally comprised one or more excitation energy transfer components EET-2 are preferably selected so that they are able to transfer excitation energy to at least one, preferably to each, of the one or more small FWHM emitters $S^B$ comprised in the same light-emitting layer B of the organic electroluminescent device according to the present invention.

In a preferred embodiment of the invention, within at least one, preferably each, light-emitting layer B, at least one, preferably each, excitation energy transfer component EET-1 transfers excitation energy to at least one, preferably to each, small FWHM emitter $S^B$.

To enable this energy transfer, there preferably is spectral overlap between the emission spectrum at room temperature (i.e. (approximately) 20 °C) (e.g. fluorescence spectrum if EET-1 is a TADF material $E^B$ and phosphorescence spectrum if EET-1 is a phosphorescence material $P^B$, vide infra) of at least one, preferably each, excitation energy transfer component EET-1 and the absorption spectrum at room temperature (i.e. (approximately) 20 °C) of at least one, preferably each, small FWHM emitter $S^B$ to which EET-1 is supposed to transfer energy. Thus, in a preferred embodiment, within at least one, preferably each, light-emitting layer B, there is spectral overlap between the emission spectrum at room temperature (i.e. (approximately) 20 °C) of at least one, preferably each, excitation energy transfer component EET-1 and the absorption spectrum at room temperature (i.e. (approximately) 20 °C) of at least one, preferably each, small FWHM emitter $S^B$. The absorption and emission spectra are recorded as described in a later subchapter of this text.

In a preferred embodiment of the invention, within at least one, preferably each, light-emitting layer B that comprises an excitation energy transfer component EET-2, at least one, preferably each, EET-2 transfers excitation energy to at least one, preferably to each, small FWHM emitter $S^B$.

To enable this energy transfer, there preferably is spectral overlap between the emission spectrum at room temperature (i.e. (approximately) 20 °C) (e.g. fluorescence spectrum if EET-2 is a TADF material $E^B$ and phosphorescence spectrum if EET-2 is a phosphorescence material $P^B$, vide infra) of at least one, preferably each, optionally comprised excitation energy transfer component EET-2 and the absorption spectrum at room temperature (i.e. (approximately) 20 °C) of at least one, preferably each, small FWHM emitter $S^B$ to which EET-2 is supposed to transfer energy. Thus, in a preferred embodiment, within at least one, preferably each, light-emitting layer B that comprises an excitation energy transfer component EET-2there is spectral overlap between the emission spectrum at room temperature (i.e. (approximately) 20 °C) of at least one, preferably each, EET-2 and the absorption spectrum at room temperature (i.e. (approximately) 20 °C) of at least one, preferably each, small FWHM emitter $S^B$. The absorption and emission spectra are recorded as described in a later subchapter of this text.

In an even more preferred embodiment of the invention, within at least one, preferably each, light-emitting layer B, at least one, preferably each, excitation energy transfer component EET-1 as well as at least one, preferably each, optionally comprised excitation energy transfer component EET-2 transfer energy to at least one, preferably to each, small FWHM emitter $S^B$.

To enable this energy transfer, there preferably is spectral overlap between the emission spectrum at room temperature (i.e. (approximately) 20 °C) (e.g. fluorescence spectrum if the respective EET-1 or EET-2 is a TADF material $E^B$ or and phosphorescence spectrum if the respective EET-1 or EET-2 is a phosphorescence material $P^B$, vide infra) of at least one, preferably each, excitation energy transfer component EET-1 as well as of at least one, preferably each, excitation energy transfer component EET-2, if an EET-2 is comprised in the respective light-emitting layer B, and the absorption spectrum at room temperature (i.e. (approximately) 20 °C) of at least one, preferably each, small FWHM emitter $S^B$ to which EET-1 and EET-2 are supposed to transfer energy.

Thus, in a preferred embodiment of the invention, within at least one, preferably each, light-emitting layer B that comprises an excitation energy transfer component EET-2, both of the following two conditions are fulfilled:

(i) there is spectral overlap between the emission spectrum at room temperature (i.e. (approximately) 20 °C) of at least

one, preferably each, excitation energy transfer component EET-1 and the absorption spectrum at room temperature (i.e. (approximately) 20 °C) of at least one, preferably each, small FWHM emitter $S^B$; and

(ii) there is spectral overlap between the emission spectrum at room temperature (i.e. (approximately) 20 °C) of at least one, preferably each, excitation energy transfer component EET-2 and the absorption spectrum (i.e. (approximately) 20 °C) of at least one, preferably each, small FWHM emitter $S^B$;

wherein the absorption and emission spectra are recorded as described in a later subchapter of this text..

Additionally, the specific embodiments of the present invention that are related to the aforementioned formulas (10), (11), (14), (15), and (16) provide guidelines on how to select EET-1 and EET-2 so that they may transfer excitation energy to at least one, preferably to each, small FWHM emitter $S^B$ (comprised in the same light-emitting layer B). Thus, in a preferred embodiment of the invention, the relations expressed by formulas (10), (11), (14), (15), and (16) apply to materials comprised in the same light-emitting layer B of an organic electroluminescent device according to the present invention, in particular if within the respective light-emitting layer B, at least one, preferably each, hole scavenger $H_{scav}$ is an excitation energy transfer component EET-2.

It is preferred that the excitation energy transfer components EET-1 and EET-2 are capable of harvesting triplet excitons for light emission from singlet states. The person skilled in the art understands this to mean that an excitation energy transfer component EET-1 and EET-2 may for example display strong spin-orbit coupling to allow for efficient transfer of excitation energy from excited triplet states to excited singlet states. Alternatively triplet harvesting by the excitation energy transfer components EET-1 and EET-2 may for example be achieved by means of reverse intersystem crossing (RISC) to convert excited triplet states into excited singlet states (vide infra). In both cases, excitation energy may be transferred to at least one small FWHM emitter $S^B$ which then emits light from an excited singlet state (preferably from $S1^3$).

In a preferred embodiment, within at least one, preferably each, light-emitting layer B, the lowest unoccupied molecular orbital LUMO(EET-1) of at least one, preferably each, excitation energy transfer component EET-1 has an energy $E^{LUMO}$(EET-1) of less than -2.3 eV: $E^{LUMO}$(EET-1) < -2.3 eV.

In another preferred embodiment, within at least one, preferably each, light-emitting layer B, the lowest unoccupied molecular orbital LUMO(EET-1) of at least one, preferably each, excitation energy transfer component EET-1 has an energy $E^{LUMO}$(EET-1) of less than -2.6 eV: $E^{LUMO}$(EET-1) < -2.6 eV.

In a preferred embodiment, within at least one, preferably each, light-emitting layer B, the highest occupied molecular orbital HOMO(EET-1) of at least one, preferably each, excitation energy transfer component EET-1 has an energy $E^{HOMO}$(EET-1) higher than -6.3 eV: $E^{HOMO}$(EET-1) > -6.3 eV.

In a preferred embodiment, within at least one, preferably each, light-emitting layer B, the following two conditions are fulfilled:

(i) the lowest unoccupied molecular orbital LUMO(EET-1) of at least one, preferably each, excitation energy transfer component EET-1 has an energy $E^{LUMO}$(EET-1) of less than -2.6 eV: $E^{LUMO}$(EET-1) < 2.6 eV; and

(ii) the highest occupied molecular orbital HOMO(EET-1) of at least one, preferably each, excitation energy transfer component EET-1 has an energy $E^{HOMO}$(EET-1) higher than -6.3 eV: $E^{HOMO}$(EET-1) > 6.3 eV.

In one embodiment of the invention, within each light-emitting layer B, at least one, preferably each, excitation energy transfer component EET-1 fulfills at least one, preferably exactly one, of the following two conditions:

(i) it exhibits a $\Delta E_{ST}$ value, which corresponds to the energy difference between $E(S1^{EET-1})$ and $E(T1^{EET-1})$, of less than 0.4 eV, preferably of less than 0.3 eV, more preferably of less than 0.2 eV, even more preferably of less than 0.1 eV, or even of less than 0.05 eV; and/or

(ii) it comprises at least one, preferably exactly one, transition metal with a standard atomic weight of more than 40 (meaning that at least one atom within the respective EET-1 is a metal, preferably transition metal, with an atomic weight of more than 40, wherein the transition metal may be in any oxidation state).

In one embodiment of the invention, within each light-emitting layer B, at least one, preferably each, hole scavenger $H_{scav}$ is an excitation energy transfer component EET-2 that fulfills at least one, preferably exactly one, of the following two conditions:

(i) it exhibits a $\Delta E_{ST}$ value, which corresponds to the energy difference between $E(S1^{EET-2})$ and $E(T1^{EET-2})$, of less than 0.4 eV, preferably of less than 0.3 eV, more preferably of less than 0.2 eV, even more preferably of less than 0.1 eV, or even of less than 0.05 eV; and/or

(ii) it comprises at least one, preferably exactly one, transition metal with a standard atomic weight of more than 40 (meaning that at least one atom within the respective EET-2 is a metal, preferably transition metal, with an atomic

weight of more than 40, wherein the transition metal may be in any oxidation state).

In one embodiment of the invention, within each light-emitting layer B, at least one, preferably each, excitation energy transfer component EET-1 and, if comprised in the respective light-emitting layer(s) B, at least one, preferably each, excitation energy transfer component EET-2 fulfill at least one, preferably exactly one, of the following two conditions:

(i) it exhibits a $\Delta E_{ST}$ value, which corresponds to the energy difference between $E(S1^{EET-1})$ and $E(T1^{EET-1})$ and/or to the energy difference between $E(S1^{EET-2})$ and $E(T1^{EET-2})$ of less than 0.4 eV, preferably of less than 0.3 eV, more preferably of less than 0.2 eV, even more preferably of less than 0.1 eV, or even of less than 0.05 eV; and/or
(ii) it comprises at least one, preferably exactly one, transition metal with a standard atomic weight of more than 40. (meaning that at least one atom within the respective EET-1 and/or EET-2 is a metal, preferably transition metal, with an atomic weight of more than 40, wherein the transition metal may be in any oxidation state).

In a preferred embodiment, within at least one, preferably each, light-emitting layer B at least one, preferably each excitation energy transfer component EET-1 exhibits a $\Delta E_{ST}$ value, which corresponds to the energy difference between the lowermost excited singlet state energy level $E(S1^{EET-1})$ and the lowermost excited triplet state energy level $E(T1^{EET-1})$ of less than 0.4 eV, preferably of less than 0.3 eV, more preferably of less than 0.2 eV, even more preferably of less than 0.1 eV, or even of less than 0.05 eV.

In a preferred embodiment, within at least one, preferably each, light-emitting layer B that comprises an excitation energy transfer component EET-2, at least one, preferably each, EET-2 comprises at least one, preferably exactly one, transition metal with a standard atomic weight of more than 40 (meaning that at least one atom within the respective EET-2 is a metal, preferably transition metal, with an atomic weight of more than 40, wherein the transition metal may be in any oxidation state).

In a preferred embodiment, within at least one, preferably each, light-emitting layer B, at least one, preferably each, hole scavenger $H_{scav}$ is an excitation energy transfer component EET-2 comprising at least one, preferably exactly one, metal, preferably transition metal, with a standard atomic weight of more than 40 (meaning that at least one atom within the respective EET-2 is a metal, preferably transition metal, with an atomic weight of more than 40, wherein the transition metal may be in any oxidation state).

In a preferred embodiment of the invention, within each light-emitting layer B both of the following two conditions:

(i) at least one, preferably each, excitation energy transfer component EET-1 exhibits a $\Delta E_{ST}$ value, which corresponds to the energy difference between the lowermost excited singlet state energy level $E(S1^{EET-1})$ and the lowermost excited triplet state energy level $E(T1^{EET-1})$ of less than 0.4 eV, preferably of less than 0.3 eV, more preferably of less than 0.2 eV, even more preferably of less than 0.1 eV, or even of less than 0.05 eV; and
(ii) if comprised in the respective light-emitting layer(s) B, at least one, preferably each, excitation energy transfer component EET-2 comprises at least one, preferably exactly one, transition metal with a standard atomic weight of more than 40 (meaning that at least one atom within the respective EET-2 is a metal, preferably transition metal, with an atomic weight of more than 40, wherein the transition metal may be in any oxidation state).

In one embodiment of the invention, within each light-emitting layer B, at least one, preferably each, excitation energy transfer component EET-1 fulfills at least one, preferably exactly one, of the following two conditions:

(i) it exhibits a $\Delta E_{ST}$ value, which corresponds to the energy difference between $E(S1^{EET-1})$ and $E(T1^{EET-1})$, of less than 0.4 eV, preferably of less than 0.3 eV, more preferably of less than 0.2 eV, even more preferably of less than 0.1 eV, or even of less than 0.05 eV; and/or
(ii) it comprises iridium (Ir) or platinum (Pt) (meaning that at least one atom within the respective EET-1 is iridium(Ir) or platinum (Pt), wherein Ir and Pt may be in any oxidation state, vide infra).

In one embodiment of the invention, within each light-emitting layer B, at least one, preferably each, hole scavenger $H_{scav}$ is an excitation energy transfer component EET-2 that fulfills at least one, preferably exactly one, of the following two conditions:

(i) it exhibits a $\Delta E_{ST}$ value, which corresponds to the energy difference between $E(S1^{EET-2})$ and $E(T1^{EET-2})$, of less than 0.4 eV, preferably of less than 0.3 eV, more preferably of less than 0.2 eV, even more preferably of less than 0.1 eV, or even of less than 0.05 eV; and/or
(ii) it comprises iridium (Ir) or platinum (Pt) (meaning that at least one atom within the respective EET-2 is iridium(Ir) or platinum (Pt), wherein Ir and Pt may be in any oxidation state, vide infra).

In a preferred embodiment of the invention, in each light-emitting layer B, at least one, preferably each, excitation energy transfer component EET-1 and, if comprised in the respective light-emitting layer(s) B, at least one, preferably each, excitation energy transfer component EET-2 fulfill at least one, preferably exactly one, of the following two conditions:

(i) it exhibits an $\Delta E_{ST}$ value, which corresponds to the energy difference between the lowermost excited singlet state energy level $E(S1^{E})$ (equals $E(S1^{EET-1})$ or $E(S1^{EET2})$, respectively) and the respective lowermost excited triplet state energy level $E(T1^{E})$ (equals $E(T1^{EET-1})$ or $E(T1^{EET-2})$, respectively), of less than 0.4 eV, preferably of less than 0.3 eV, more preferably of less than 0.2 eV, even more preferably of less than 0.1 eV, or even of less than 0.05 eV (vide infra); and/or
(ii) it comprises iridium (Ir) or platinum (Pt) (meaning that at least one atom within the respective EET-1 or EET-2 is iridium(Ir) or platinum (Pt), wherein Ir and Pt may be in any oxidation state, vide infra).

In a preferred embodiment, within at least one, preferably each, light-emitting layer B that comprises an excitation energy transfer component EET-2, at least one, preferably each excitation energy transfer component EET-2 comprises iridium (Ir) or platinum (Pt) (meaning that at least one atom within the respective EET-2 is iridium(Ir) or platinum (Pt), wherein Ir and Pt may be in any oxidation state, vide infra).
In a particularly preferred embodiment, within at least one, preferably each, light-emitting layer B, at least one, preferably each, hole scavenger $H_{scav}$ is an excitation energy transfer component EET-2, wherein within at least one, preferably each, light-emitting layer B that comprises an excitation energy transfer component EET-2, at least one, preferably each excitation energy transfer component EET-2 comprises iridium (Ir) or platinum (Pt).
In a preferred embodiment of the invention, within each light-emitting layer B both of the following two conditions:

(i) at least one, preferably each, excitation energy transfer component EET-1 exhibits a $\Delta E_{ST}$ value, which corresponds to the energy difference between the lowermost excited singlet state energy level $E(S1^{EET-1})$ and the lowermost excited triplet state energy level $E(T1^{EET-1})$ of less than 0.4 eV, preferably of less than 0.3 eV, more preferably of less than 0.2 eV, even more preferably of less than 0.1 eV, or even of less than 0.05 eV; and
(ii) if comprised in the respective light-emitting layer(s) B, at least one, preferably each, excitation energy transfer component EET-2 comprises iridium (Ir) or platinum (Pt) (meaning that at least one atom within the respective EET-2 is iridium(Ir) or platinum (Pt), wherein Ir and Pt may be in any oxidation state, vide infra).

Preferably, the one or more excitation energy transfer components EET-1 as well as the one or more optional excitation energy transfer components EET-2 are independently of each other selected from the group consisting of TADF materials $E^B$, phosphorescence materials $P^B$, and exciplexes (vide infra).
More preferably, the one or more excitation energy transfer components EET-1 as well as the one or more optional excitation energy transfer components EET-2 are independently of each other selected from the group consisting of TADF materials $E^B$ and phosphorescence materials $P^B$ (vide infra).
As stated previously, a light-emitting layer B in the context of the present invention comprises one or more excitation energy transfer components EET-1 and optionally one or more excitation energy transfer components EET-2, wherein these two species are not structurally identical (i.e. they do not have the same chemical formulas). This means that, within each light-emitting layer B of the organic electroluminescent device according to the present invention, the one or more excitation energy transfer components EET-1 and the one or more optionally comprised excitation energy transfer components EET-2 may for example be independently of each other selected from the group consisting of TADF-materials $E^B$, phosphorescence materials $P^B$ and exciplexes, but in any case, their chemical structures may not be identical. This is to say that within a light-emitting layer B no EET-1 has the same chemical formula (or structure) as an EET-2.
In a preferred embodiment of the invention, in each light-emitting layer B, at least one, preferably each, excitation energy transfer component EET-1 as well as at least one, preferably each, optionally comprised excitation energy transfer component EET-2 are independently of each other selected from:

(i) a thermally activated delayed fluorescence (TADF) material $E^B$ as defined herein; and
(ii) a phosphorescence material $P^B$ as defined herein; and
(iii) an exciplex as defined herein.

In a preferred embodiment of the organic electroluminescent device according to the present invention, each excitation energy transfer component EET-1 as well as each optionally comprised excitation energy transfer component EET-2 are independently of each other selected from:

(i) a thermally activated delayed fluorescence (TADF) material $E^B$ as defined herein; and

(ii) a phosphorescence material $P^B$ as defined herein; and
(iii) an exciplex as defined herein.

In an even more preferred embodiment of the organic electroluminescent device according to the present invention, in each light-emitting layer B, at least one, preferably each, excitation energy transfer component EET-1 as well as at least one, preferably each, optionally comprised excitation energy transfer component EET-2 are independently of each other selected from:

(i) a thermally activated delayed fluorescence (TADF) material $E^B$ as defined herein; and
(ii) a phosphorescence material $P^B$ as defined herein.

In a preferred embodiment of the organic electroluminescent device according to the present invention, each excitation energy transfer component EET-1 as well as each optionally comprised excitation energy transfer component EET-2 are independently of each other selected from:

(i) a thermally activated delayed fluorescence (TADF) material $E^B$ as defined herein; and
(ii) a phosphorescence material $P^B$ as defined herein.

In a particularly preferred embodiment, each excitation energy transfer component EET-1 comprised in the organic electroluminescent device according to the present invention is a TADF material $E^B$ as defined herein.
In a particularly preferred embodiment, each excitation energy transfer component EET-2 optionally comprised in the organic electroluminescent device according to the present invention is a phosphorescence material $P^B$ as defined herein.
In a particularly preferred embodiment, in at least one, preferably each, light-emitting layer B, at least one, preferably each, hole scavenger $H_{scav}$ is an excitation energy transfer component EET-2 and at least one, preferably each, excitation energy transfer component EET-2 is a phosphorescence material $P^B$ as defined herein.
In one embodiment, each excitation energy transfer component EET-1 comprised in the organic electroluminescent device according to the present invention is a phosphorescence material $P^B$ as defined herein.
In one embodiment, each excitation energy transfer component EET-2 optionally comprised in the organic electroluminescent device according to the present invention is a TADF material $E^B$ as defined herein.
In one embodiment, in at least one, preferably each, light-emitting layer B, at least one, preferably each, hole scavenger $H_{scav}$ is an excitation energy transfer component EET-2 and at least one, preferably each, excitation energy transfer component EET-2 is a phosphorescence material $P^B$ as defined herein.
In one embodiment, each excitation energy transfer component EET-1 comprised in the organic electroluminescent device according to the present invention is a TADF material $E^B$ as defined herein.
In one embodiment, each excitation energy transfer component EET-2 optionally comprised in the organic electroluminescent device according to the present invention is an exciplex as defined herein.
In a one embodiment, in at least one, preferably each, light-emitting layer B, at least one, preferably each, hole scavenger $H_{scav}$ is an excitation energy transfer component EET-2 and at least one, preferably each, excitation energy transfer component EET-2 is an exciplex as defined herein.
In a particularly preferred embodiment of the invention, in at least one, preferably in each light-emitting layer B, both of the following conditions are fulfilled:

(i) at least one, preferably each, excitation energy transfer component EET-1 is a TADF material $E^B$ as defined herein; and
(ii) if comprised in the respective light-emitting layer(s) B, at least one, preferably each, excitation energy transfer component EET-2 is phosphorescence material $P^B$ as defined herein.

In a particularly preferred embodiment, each excitation energy transfer component EET-1 comprised in the organic electroluminescent device according to the present invention is a TADF material $E^B$ as defined herein and each excitation energy transfer component EET-2 optionally comprised in the organic electroluminescent device according to the present invention is a phosphorescence material $P^B$ as defined herein.
In a particularly preferred embodiment, each excitation energy transfer component EET-1 comprised in the organic electroluminescent device according to the present invention is a TADF material $E^B$ as defined herein and each hole scavenger $H_{scav}$ comprised in the organic electroluminescent device according to the present invention is an excitation energy transfer component EET-2 that is a phosphorescence material $P^B$ as defined herein.
In an alternative embodiment of the invention, in at least one, preferably in each light-emitting layer B, both of the following conditions are fulfilled:

(i) at least one, preferably each, excitation energy transfer component EET-1 is a TADF material $E^B$ as defined herein; and
(ii) if comprised in the respective light-emitting layer(s) B, at least one, preferably each, excitation energy transfer component EET-2 is a TADF material $E^B$ as defined herein.

In an alternative embodiment of the invention, in at least one, preferably in each light-emitting layer B, both of the following conditions are fulfilled:

(i) at least one, preferably each, excitation energy transfer component EET-1 is a phosphorescence material $P^B$ as defined herein; and
(ii) if comprised in the respective light-emitting layer(s) B, at least one, preferably each, excitation energy transfer component EET-2 is phosphorescence material $P^B$ as defined herein.

In the following, TADF materials $E^B$, phosphorescence materials $P^B$ and exciplexes in the context of the present invention will be disclosed in more detail.
It is understood that any preferred features, properties, and embodiments described in the following for a TADF material $E^B$ may also apply to any excitation energy transfer component EET-1 or EET-2, if the respective excitation energy transfer component is selected to be a TADF material $E^B$, without this being indicated for every specific embodiment referring to TADF materials $E^B$.
It is also understood that any preferred features, properties, and embodiments described in the following for a phosphorescence material $P^B$ may also apply to any excitation energy transfer component EET-1 or EET-2, if the respective excitation energy transfer component is selected to be a phosphorescence material $P^B$, without this being indicated for every specific embodiment referring to phosphorescence materials $P^B$.
It is understood that any preferred features, properties, and embodiments described in the following for an exciplex may also apply to any excitation energy transfer component EET-1 or EET-2, if the respective excitation energy transfer component is selected to be an exciplex, without this being indicated for every specific embodiment referring to exciplexes.

*TADF material(s) $E^B$*

As known to the person skilled in the art, light emission from emitter materials (i.e. emissive dopants), for example in organic light-emitting diodes (OLEDs), may comprise fluorescence from excited singlet states (typically the lowermost excited singlet state S1) and phosphorescence from excited triplet states (typically the lowermost excited triplet state T1).
In the context of the present invention, a fluorescence emitter is capable of emitting light at room temperature (i.e. (approximately) 20 °C) upon electronic excitation (for example in an organic electroluminescent device), wherein the emissive excited state is a singlet state (typically the lowermost excited singlet state S1). Fluorescence emitters usually display prompt (i.e. direct) fluorescence on a timescale of nanoseconds, when the initial electronic excitation (for example by electron hole recombination) affords an excited singlet state of the emitter.
In the context of the present invention, a delayed fluorescence material is a material that is capable of reaching an excited singlet state (typically the lowermost excited singlet state S1) by means of reverse intersystem crossing (RISC; in other words: up intersystem crossing or inverse intersystem crossing) from an excited triplet state (typically from the lowermost excited triplet state T1) and that is furthermore capable of emitting light when returning from the so-reached excited singlet state (typically S1) to its electronic ground state. The fluorescence emission observed after RISC from an excited triplet state (typically T1) to the emissive excited singlet state (typically S1) occurs on a timescale (typically in the range of microseconds) that is slower than the timescale on which direct (i.e. prompt) fluorescence occurs (typically in the range of nanoseconds) and is thus referred to as delayed fluorescence (DF). When RISC from an excited triplet state (typically from T1) to an excited singlet state (typically to S1), occurs through thermal activation, and if the so populated excited singlet state emits light (delayed fluorescence emission), the process is referred to as thermally activated delayed fluorescence (TADF). Accordingly, a TADF material is a material that is capable of emitting thermally activated delayed fluorescence (TADF) as explained above. It is known to the person skilled in the art that, when the energy difference $\Delta E_{ST}$ between the lowermost excited singlet state energy level E(S1) and the lowermost excited triplet state energy level E(T1) of a fluorescence emitter is reduced, population of the lowermost excited singlet state from the lowermost excited triplet state by means of RISC may occur with high efficiency. Thus, it forms part of the common knowledge of those skilled in the art that a TADF material will typically have a small $\Delta E_{ST}$ value (vide infra).
The occurrence of (thermally activated) delayed fluorescence may for example be analyzed based on the decay curve obtained from time-resolved (i.e. transient) photoluminescence (PL) measurements. PL emission from a TADF material is divided into an emission component from excited singlet states (typically S1) generated by the initial excitation and an emission component from excited states singlet (typically S1) generated via excited triplet states (typically T1) by

means of RISC. There is typically a significant difference in time between emission from the singlet excited states (typically S1) formed by the initial excitation and from the singlet excited states (typically S1) reached via RISC from excited triplet states (typically T1).

TADF materials preferably fulfill the following two conditions regarding the full decay dynamics:

(i) the decay dynamics exhibit two time regimes, one typically in the nanosecond (ns) range and the other typically in the microsecond (μs) range; and
(ii) the shapes of the emission spectra in both time regimes coincide;

wherein, the fraction of light emitted in the first decay regime is taken as prompt fluorescence and the fraction emitted in the second decay regime is taken as delayed fluorescence. The PL measurements may be performed using a spin-coated film of the respective emitter (i.e. the assumed TADF material) in poly(methyl methacrylate) (PMMA) with 1-10% by weight, in particular 10% by weight of the respective emitter.

In order to evaluate whether the preferred criterion (i) is fulfilled (i.e. the decay dynamics exhibit two time regimes, one typically in the nanosecond (ns) range and the other typically in the microsecond (μs) range), *TCSPC (Time-correlated single-photon counting)* may typically be used (vide infra) and the *full decay dynamics may* typically be analyzed as stated below. Alternatively, *transient photoluminescence measurements with spectral resolution* may be performed (vide infra).

In order to evaluate whether the preferred criterion (ii) is fulfilled (i.e. the shapes of the emission spectra in both time regimes coincide), *transient photoluminescence measurements with spectral resolution* may typically be performed (vide infra).

Experimental detail on these measurements is provided in a later subchapter of this text.

The ratio of delayed and prompt fluorescence (n- value) may be calculated by the integration of respective photoluminescence decays in time as laid out in a later subchapter of this text.

In the context of the present invention, a TADF material preferably exhibits an n-value (ratio of delayed to prompt fluorescence) larger than 0.05 ($n > 0.05$), more preferably larger than 0.15 ($n > 0.15$), more preferably larger than 0.25 ($n > 0.25$), more preferably larger than 0.35 ($n > 0.35$), more preferably larger than 0.45 ($n > 0.45$), more preferably larger than 0.55 ($n > 0.55$), more preferably larger than 0.65 ($n > 0.65$), more preferably larger than 0.75 ($n > 0.75$), more preferably larger than 0.85 ($n > 0.85$), or even larger than 0.95 ($n > 0.95$).

According to the invention, a thermally activated delayed fluorescence (TADF) material $E^B$ is characterized by exhibiting a $\Delta E_{ST}$ value, which corresponds to the energy difference between the lowermost excited singlet state energy level $E(S1^E)$ and the lowermost excited triplet state energy level $E(T1^E)$, of less than 0.4 eV, preferably of less than 0.3 eV, more preferably of less than 0.2 eV, even more preferably of less than 0.1 eV, or even of less than 0.05 eV. Thus, $\Delta E_{ST}$ of a TADF material $E^B$ according to the invention may be sufficiently small to allow for thermal repopulation of the lowermost excited singlet state $S1^E$ from the lowermost excited triplet state $T1^E$ (also referred to as up-intersystem crossing or reverse intersystem crossing, RISC) at room temperature (RT, i.e., (approximately) 20°C).

Preferably, in the context of the present invention, TADF materials $E^B$ display both, prompt fluorescence and delayed fluorescence (when the emissive $S1^E$ state is reached via thermally activated RISC from the $T1^E$ state).

It is understood that a small FWHM emitter $S^B$ comprised in a light-emitting layer B of an organic electroluminescent device according to the invention may optionally also have a $\Delta E_{ST}$ value of less than 0.4 eV and exhibit thermally activated delayed fluorescence (TADF). However, for any small FWHM emitter $S^B$ in the context of the invention, this is only an optional feature.

In a preferred embodiment of the invention, there is spectral overlap between the emission spectrum of at least one TADF material $E^B$ and the absorption spectrum of at least one small FWHM emitter $S^B$ (when both spectra are measured under comparable conditions). In this case, the at least one TADF material $E^B$ may transfer energy to the at least one small FWHM emitter $S^B$.

According to the invention, a TADF material $E^B$ has an emission maximum in the visible wavelength range of from 380 nm to 800 nm, typically measured from a spin-coated film with 10% by weight of the respective TADF material $E^B$ in poly(methyl methacrylate) PMMA at room temperature (i.e., (approximately) 20°C).

In one embodiment of the invention, each TADF material $E^B$ has an emission maximum in the deep blue wavelength range of from 380 nm to 470 nm, preferably 400 nm to 470 nm, typically measured from a spin-coated film with 10% by weight of the TADF material $E^B$ in poly(methyl methacrylate) PMMA at room temperature (i.e., (approximately) 20°C).

In one embodiment of the invention, each TADF material $E^B$ has an emission maximum in the green wavelength range of from 480 nm to 560 nm, preferably 500 nm to 560 nm, typically measured from a spin-coated film with 10% by weight of the TADF material $E^B$ in poly(methyl methacrylate) PMMA at room temperature (i.e., (approximately) 20°C).

In one embodiment of the invention, each TADF material $E^B$ has an emission maximum in the red wavelength range of from 600 nm to 665 nm, preferably 610 nm to 665 nm, typically measured from a spin-coated film with 10% by weight of the TADF material $E^B$ in poly(methyl methacrylate) PMMA at room temperature (i.e., (approximately) 20°C).

In a preferred embodiment of the invention, the emission maximum (peak emission) of a TADF material $E^B$ is at a shorter wavelength than the emission maximum (peak emission) of a small FWHM emitter $S^B$ in the context of the present invention.

In a preferred embodiment of the invention, each TADF material $E^B$ is an organic TADF material, which, in the context of the invention, means that it does not contain any transition metals. Preferably, each TADF material $E^B$ according to the invention predominantly consists of the elements hydrogen (H), carbon (C), and nitrogen (N), but may for example also comprise oxygen (O), boron (B), silicon (Si), fluorine (F), and bromine (Br).

In a preferred embodiment of the invention, each TADF material $E^B$ has a molecular weight equal to or smaller than 800 g/mol.

In one embodiment of the invention, a TADF emitter $E^B$ exhibits a photoluminescence quantum yield (PLQY) equal to or higher than 30%, typically measured from a spin-coated film with 10% by weight of the TADF material $E^B$ in poly(methyl methacrylate) PMMA at room temperature (i.e., (approximately) 20°C).

In a preferred embodiment of the invention, a TADF emitter $E^B$ exhibits a photoluminescence quantum yield (PLQY) equal to or higher than 50%, typically measured from a spin-coated film with 10% by weight of the TADF material $E^B$ in poly(methyl methacrylate) PMMA at room temperature (i.e., (approximately) 20°C).

In an even more preferred embodiment of the invention, a TADF emitter $E^B$ exhibits a photoluminescence quantum yield (PLQY) equal to or higher than 70%, typically measured from a spin-coated film with 10% by weight of the TADF material $E^B$ in poly(methyl methacrylate) PMMA at room temperature (i.e., (approximately) 20°C).

In one embodiment of the invention, a TADF material $E^B$

(i) is characterized by exhibiting a $\Delta E_{ST}$ value, which corresponds to the energy difference between the lowermost excited singlet state energy level $E(S1^E)$ and the lowermost excited triplet state energy level $E(T1^E)$, of less than 0.4 eV; and

(ii) displays a photoluminescence quantum yield (PLQY) of more than 30%.

In one embodiment of the invention, the energy $E^{LUMO}(E^B)$ of the lowest unoccupied molecular orbital $LUMO(E^B)$ of each TADF material $E^B$ is smaller than -2.6 eV.

It is to be noted that, although being typically capable of emitting fluorescence and (thermally activated) delayed fluorescence, a TADF material $E^B$ optionally comprised in the organic electroluminescent device of the invention as excitation energy transfer component EET-1 and/or EET-2 preferably mainly functions as "energy pump" and not as emitter material. This is to say that a phosphorescence material $P^B$ comprised in a light-emitting layer B preferably mainly transfers excitation energy to one or more small FWHM emitters $S^B$ that in turn serve as the main emitter material(s). The main function of a phosphorescence material $P^B$ in a light-emitting layer B is preferably not the emission of light. However, it may emit light to some extent.

The person skilled in the art knows how to design TADF materials (molecules) $E^B$ according to the invention and the structural features that such molecules typically display. Briefly, to facilitate the reverse intersystem crossing (RISC), $\Delta E_{ST}$ is usually decreased and, in the context of the present invention, $\Delta E_{ST}$ is smaller than 0.4 eV, as stated above. This is oftentimes achieved by designing TADF molecules $E^B$ so that the HOMO and LUMO are spatially largely separated on (electron-) donor and (electron-) acceptor groups, respectively. These groups are usually bulky or connected via spiro-junctions so that they are twisted and the spatial overlap of the HOMO and the LUMO is reduced. However, minimizing the spatial overlap of the HOMO and the LUMO also results in a reduction of the photoluminescence quantum yield (PLQY) of the TADF material, which is unfavorable. Therefore, in practice, these two effects are both taken into account to achieve a reduction of $\Delta E_{ST}$ as well as a high PLQY.

One common approach for the design of TADF materials is to covalently attach one or more (electron-) donor moieties on which the HOMO is distributed and one or more (electron-) acceptor moieties on which the LUMO is distributed to the same bridge, herein referred to as linker group. A TADF material $E^B$ may for example also comprise two or three linker groups which are bonded to the same acceptor moiety and additional donor and acceptor moieties may be bonded to each of these two or three linker groups.

One or more donor moieties and one or more acceptor moieties may also be bonded directly to each other (without the presence of a linker group).

Typical donor moieties are derivatives of diphenyl amine, carbazole, acridine, phenoxazine, and related structures.

Benzene-, biphenyl-, and to some extend also terphenyl-derivatives are common linker groups.

Nitrile groups are very common acceptor moieties in TADF molecules and known examples thereof include:

(i) carbazolyl dicyanobenzene compounds
such as 2CzPN (4,5-di(9*H*-carbazol-9-yl)phthalonitrile), DCzIPN (4,6-di(9H-carbazol-9-yl)isophthalonitrile), 4CzPN (3,4,5,6-tetra(9H-carbazol-9-yl)phthalonitrile), 4CzIPN (2,4,5,6-Tetra(9*H*-carbazol-9-yl)isophthalonitrile), 4CzTPN

(2,4,5,6-tetra(9*H*-carbazol-9-yl)terephthalonitrile), and derivatives thereof;

(ii) carbazolyl cyanopyridine compounds
such as 4CzCNPy (2,3,5,6-tetra(9H-carbazol-9-yl)-4-cyanopyridine) and derivatives thereof;

(iii) carbazolyl cyanobiphenyl compounds
such as CNBPCz (4,4',5,5'-tetra(9H-carbazol-9-yl)-[1,1'-biphenyl]-2,2'-dicarbonitrile), CzBPCN (4,4',6,6'-tetra(9H-carbazol-9-yl)-[1,1'-biphenyl]-3,3'-dicarbonitrile), DDCzIPN (3,3',5,5'-tetra(9H-carbazol-9-yl)-[1,1'-biphenyl]-2,2',6,6'-tetracarbonitrile) and derivatives thereof;

wherein in these materials, one or more of the nitrile groups may be replaced my fluorine (F) or trifluoromethyl ($CF_3$) as acceptor moieties.

Nitrogen-heterocycles such as triazine-, pyrimidine-, triazole-, oxadiazole-, thiadiazole-, heptazine-, 1,4-diazatriphenylene-, benzothiazole-, benzoxazole-, quinoxaline-, and diazafluorene-derivatives are also well-known acceptor moieties used for the construction of TADF molecules. Known examples of TADF molecules comprising for example a triazine acceptor include PIC-TRZ (7,7'-(6-([1,1'-biphenyl]-4-yl)-1,3,5-triazine-2,4-diyl)bis(5-phenyl-5,7-dihydroindolo[2,3-b]carbazole)), mBFCzTrz (5-(3-(4,6-diphenyl-1,3,5-triazin-2-yl)phenyl)-5H-benzofuro[3,2-c]carbazole), and DCzTrz (9,9'-(5-(4,6-diphenyl-1,3,5-triazin-2-yl)-1,3-phenylene)bis(9H-carbazole)).

Another group of TADF materials comprises diaryl ketones such as benzophenone or (heteroaryl)aryl ketones such as 4-benzoylpyridine, 9,10-anthraquinone, 9H-xanthen-9-one, and derivatives thereof as acceptor moieties to which the donor moieties (usually carbazolyl substituents) are bonded. Examples of such TADF molecules include BPBCz (bis(4-(9'-phenyl-9*H*,9'*H*-[3,3'-bicarbazol]-9-yl)phenyl)methanone), mDCBP ((3,5-di(9H-carbazol-9-yl)phenyl)(pyridin-4-yl)methanone), AQ-DTBu-Cz (2,6-bis(4-(3,6-di-*tert*-butyl-9*H*-carbazol-9-yl)phenyl)anthracene-9,10-dione), and MCz-XT (3-(1,3,6,8-tetramethyl-9H-carbazol-9-yl)-9H-xanthen-9-one), respectively.

Sulfoxides, in particular diphenyl sulfoxides, are also commonly used as acceptor moieties for the construction of TADF materials and known examples include 4-PC-DPS (9-phenyl-3-(4-(phenylsulfonyl)phenyl)-9H-carbazole), DitBu-DPS (9,9'-(sulfonylbis(4,1-phenylene))bis(9H-carbazole)), and TXO-PhCz (2-(9-phenyl-9H-carbazol-3-yl)-9H-thioxanthen-9-one 10,10-dioxide).

Exemplarily, all groups of TADF molecules mentioned above may provide suitable TADF materials $E^B$ for use according to the present invention, given that the specific materials fulfills the aforementioned basic requirement, namely the $\Delta E_{ST}$ value being smaller than 0.4 eV.

The person skilled in the art knows that not only the structures named above, but many more materials may be suitable TADF materials $E^B$ in the context of the present invention. The skilled artisan is familiar with the design principles of such molecules and also knows how to design such molecules with a certain emission color (e.g. blue, green or red emission).

See for example: H. Tanaka, K. Shizu, H. Nakanotani, C. Adachi, Chemistry of Materials 2013, 25(18), 3766, DOI: 10.1021/cm402428a; J. Li, T. Nakagawa, J. MacDonald, Q. Zhang, H. Nomura, H. Miyazaki, C. Adachi, Advanced Materials 2013, 25(24), 3319, DOI: 10.1002/adma.201300575; K. Nasu, T. Nakagawa, H. Nomura, C.-J. Lin, C.-H. Cheng, M.-R. Tseng, T. Yasudaad, C. Adachi, Chemical Communications 2013, 49(88), 10385, DOI: 10.1039/c3cc44179b; Q. Zhang, B. Li1, S. Huang, H. Nomura, H. Tanaka, C. Adachi, Nature Photonics 2014, 8(4), 326, DOI: 10.1038/nphoton.2014.12; B. Wex, B.R. Kaafarani, Journal of Materials Chemistry C 2017, 5, 8622, DOI: 10.1039/c7tc02156a; Y. Im, M. Kim, Y.J. Cho, J.-A. Seo, K.S. Yook, J.Y. Lee, Chemistry of Materials 2017, 29(5), 1946, DOI: 10.1021/acs.chemmater.6b05324; T.-T. Bui, F. Goubard, M. Ibrahim-Ouali, D. Gigmes, F. Dumur, Beilstein Journal of Organic Chemistry 2018, 14, 282, DOI: 10.3762/bjoc.14.18; X. Liang, Z.-L. Tu, Y.-X. Zheng, Chemistry - A European Journal 2019, 25(22), 5623, DOI: 10.1002/chem.201805952.

Furthermore, for example, US2015105564 (A1), US2015048338 (A1), US2015141642 (A1), US2014336379 (A1), US2014138670 (A1), US2012241732 (A1), EP3315581 (A1), EP3483156 (A1), and US2018053901 (A1) disclose TADF materials $E^B$ that may be used in organic electroluminescent devices according to the present invention. It is understood that this does not imply that the present invention is limited to organic electroluminescent devices comprising TADF materials disclosed in the cited references. It is also understood that any TADF materials used in the state of the art may also be suitable TADF materials $E^B$ in the context of the present invention.

In one embodiment of the invention, each TADF material $E^B$ comprises one or more chemical moieties independently of each other selected from the group consisting of CN, $CF_3$, and an optionally substituted 1,3,5-triazinyl group.

In one embodiment of the invention, each TADF material $E^B$ comprises one or more chemical moieties independently of each other selected from the group consisting of CN and an optionally substituted 1,3,5-triazinyl group.

In one embodiment of the invention, each TADF material $E^B$ comprises one or more optionally substituted 1,3,5-triazinyl group.

In one embodiment of the invention, each TADF material $E^B$ comprises one or more chemical moieties independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic or heteroaromatic, carbo- or heterocyclic ring systems.

In a preferred embodiment of the invention, the at least one, preferably each TADF material $E^B$ comprises

- one or more first chemical moieties, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic or heteroaromatic, carbo- or heterocyclic ring systems;
- one or more second chemical moieties, independently of each other selected from the group consisting of CN, $CF_3$, and an optionally substituted 1,3,5-triazinyl group.

In an even more preferred embodiment of the invention, the at least one, preferably each TADF material $E^B$ comprises

- one or more first chemical moieties, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic or heteroaromatic, carbo- or heterocyclic ring systems;
- one or more second chemical moieties, independently of each other selected from the group consisting of CN and an optionally substituted 1,3,5-triazinyl group.

In a still even more preferred embodiment of the invention, the at least one, preferably each TADF material $E^B$ comprises

- one or more first chemical moieties, independently of each other selected from an amino group, indolyl, carbazolyl, and derivatives thereof, all of which may be optionally substituted, wherein these groups may be bonded to the core structure of the respective TADF molecule via a nitrogen (N) or via a carbon (C) atom, and wherein substituents bonded to these groups may form mono- or polycyclic, aliphatic or aromatic or heteroaromatic, carbo- or heterocyclic ring systems;
- one or more optionally substituted 1,3,5-triazinyl group.

The person skilled in the art knows that the expression "derivatives thereof" means that the respective parent structure may be optionally substituted or any atom within the respective parent structure may be replaced by an atom of another element for example.

In one embodiment of the invention, each TADF material $E^B$ comprises

- one or more first chemical moieties, each comprising or consisting of a structure according to formula D-I:

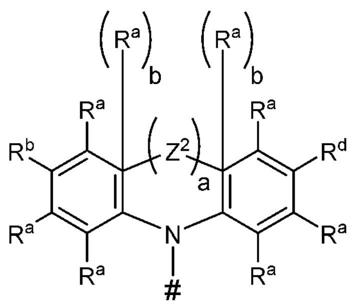

Formula D-I

and

- optionally, one or more second chemical moieties, each independently of each other selected from CN, $CF_3$, and a structure according to any of formulas A-I, A-II, A-III, and A-IV:

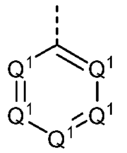
Formula A-I

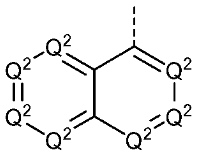
Formula A-II

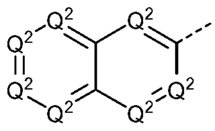
Formula A-III

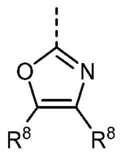
Formula A-IV

and

- one third chemical moiety comprising or consisting of a structure according to any of formulas L-I, L-II, L-III, L-IV, L-V, L-VI, L-VII, and L-VIII:

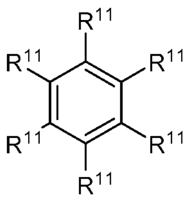
Formula L-I

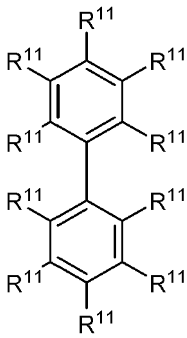
Formula L-II

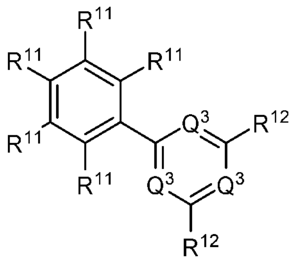
Formula L-III

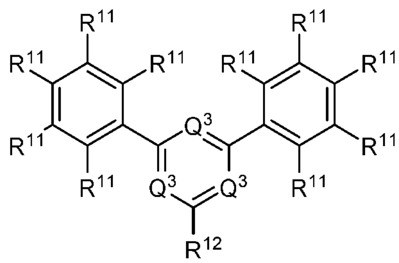
Formula L-IV

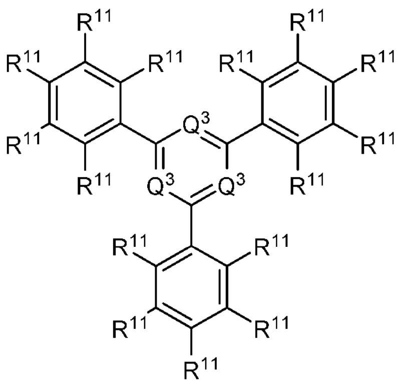
Formula L-V

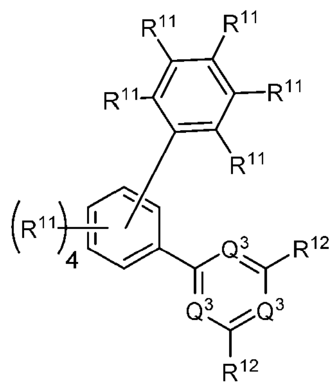
Formula L-VI

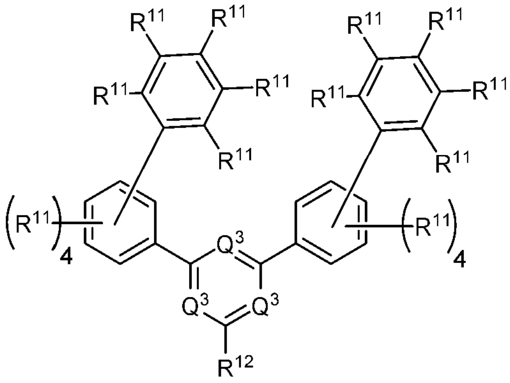

Formula L-VII

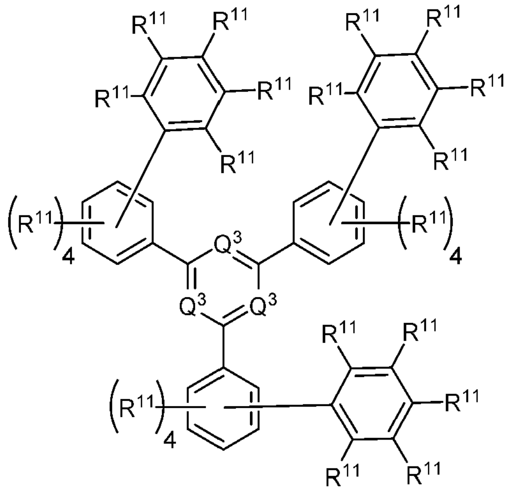

Formula L-VIII,

wherein

the one or more first chemical moieties and the optional one or more second chemical moieties are covalently bonded via a single bond to the third chemical moiety;

wherein in formula D-I:

# represents the binding site of a single bond linking the respective first chemical moiety according to formula D-I to the third chemical moiety;

$Z^2$ is at each occurrence independently of each other selected from the group consisting of a direct bond, $CR^1R^2$, $C=CR^1R^2$, C=O, $C=NR^1$, $NR^1$, O, $SiR^1R^2$, S, S(O) and $S(O)_2$;

$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $B(OR^3)_2$, $OSO_2R^3$, $CF_3$, CN, F, Cl, Br, I,

$C_1$-$C_{40}$-alkyl,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_1$-$C_{40}$-alkoxy,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_1$-$C_{40}$-thioalkoxy,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_2$-$C_{40}$-alkenyl,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_2$-$C_{40}$-alkynyl,
which is optionally substituted with one or more substituents $R^3$ and wherein one or more non-adjacent $CH_2$-groups are optionally substituted by $R^3C=CR^3$, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$;
$C_6$-$C_{60}$-aryl,
which is optionally substituted with one or more substituents $R^3$; and
$C_3$-$C_{60}$-heteroaryl,
which is optionally substituted with one or more substituents $R^3$;

$R^3$ is at each occurrence independently of each other selected from the group consisting of: hydrogen, deuterium, $N(R^4)_2$, $OR^4$, $Si(R^4)_3$, $B(OR^4)_2$, $OSO_2R^4$, $CF_3$, CN, F, Br, I,

$C_1$-$C_{40}$-alkyl,
which is optionally substituted with one or more substituents $R^4$ and wherein one or more non-adjacent $CH_2$-groups are optionally substituted by $R^4C$=$CR^4$, C=C, $Si(R^4)_2$, $Ge(R^4)_2$, $Sn(R^4)_2$, C=O, C=S, C=Se, C=$NR^4$, P(=O)($R^4$), SO, $SO_2$, $NR^4$, O, S or $CONR^4$;
$C_1$-$C_{40}$-alkoxy,
which is optionally substituted with one or more substituents $R^4$ and wherein one or more non-adjacent $CH_2$-groups are optionally substituted by $R^4C$=$CR^4$, C=C, $Si(R^4)_2$, $Ge(R^4)_2$, $Sn(R^4)_2$, C=O, C=S, C=Se, C=$NR^4$, P(=O)($R^4$), SO, $SO_2$, $NR^4$, O, S or $CONR^4$;
$C_1$-$C_{40}$-thioalkoxy,
which is optionally substituted with one or more substituents $R^4$ and wherein one or more non-adjacent $CH_2$-groups are optionally substituted by $R^4C$=$CR^4$, C=C, $Si(R^4)_2$, $Ge(R^4)_2$, $Sn(R^4)_2$, C=O, C=S, C=Se, C=$NR^4$, P(=O)($R^4$), SO, $SO_2$, $NR^4$, O, S or $CONR^4$;
$C_2$-$C_{40}$-alkenyl,
which is optionally substituted with one or more substituents $R^4$ and wherein one or more non-adjacent $CH_2$-groups are optionally substituted by $R^4C$=$CR^4$, C=C, $Si(R^4)_2$, $Ge(R^4)_2$, $Sn(R^4)_2$, C=O, C=S, C=Se, C=$NR^4$, P(=O)($R^4$), SO, $SO_2$, $NR^4$, O, S or $CONR^4$;
$C_2$-$C_{40}$-alkynyl,
which is optionally substituted with one or more substituents $R^4$ and wherein one or more non-adjacent $CH_2$-groups are optionally substituted by $R^4C$=$CR^4$, $Si(R^4)_2$, $Ge(R^4)_2$, $Sn(R^4)_2$, C=O, C=S, C=Se, C=$NR^4$, P(=O)($R^4$), SO, $SO_2$, $NR^4$, O, S or $CONR^4$;
$C_6$-$C_{60}$-aryl,
which is optionally substituted with one or more substituents $R^4$; and
$C_3$-$C_{57}$-heteroaryl,
which is optionally substituted with one or more substituents $R^4$;

wherein, optionally, any substituents $R^a$, $R^b$, $R^d$, $R^1$, $R^2$, $R^3$, and $R^4$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, $R^2$, $R^3$, and $R^4$;

$R^4$ is at each occurrence selected from the group consisting of: hydrogen, deuterium, OPh, $CF_3$, CN, F,

$C_1$-$C_5$-alkyl,
wherein one or more hydrogen atoms are optionally, independently of each other substituted by deuterium, CN, $CF_3$, or F;
$C_1$-$C_5$-alkoxy,
wherein one or more hydrogen atoms are optionally, independently of each other substituted by deuterium, CN, $CF_3$, or F;
$C_1$-$C_5$-thioalkoxy,
wherein one or more hydrogen atoms are optionally, independently of each other substituted by deuterium, CN, $CF_3$, or F;
$C_2$-$C_5$-alkenyl,
wherein one or more hydrogen atoms are optionally, independently of each other substituted by deuterium, CN, $CF_3$, or F;
$C_2$-$C_5$-alkynyl,
wherein one or more hydrogen atoms are optionally, independently of each other substituted by deuterium, CN, $CF_3$, or F;
$C_6$-$C_{18}$-aryl,
wherein one or more hydrogen atoms are optionally, independently of each other substituted by deuterium, $C_1$-$C_5$-alkyl, Ph or CN;
$C_3$-$C_{17}$-heteroaryl,
wherein one or more hydrogen atoms are optionally, independently of each other substituted by deuterium, Ph or $C_1$-$C_5$-alkyl;

$N(C_6$-$C_{18}$-aryl$)_2$;

$N(C_3\text{-}C_{17}\text{-heteroaryl})_2$, and

$N(C_3\text{-}C_{17}\text{-heteroaryl})(C_6\text{-}C_{18}\text{-aryl})$;

a is an integer and is 0 or 1;

b is an integer and is at each occurrence 0 or 1, wherein both b are always identical;

wherein both integers b are 0 when integer a is 1 and integer a is 0 when both integers b are 1;

wherein in formulas A-I, A-II, A-III, A-IV:

the dashed line indicates a single bond linking the respective second chemical moiety according to formula A-I, A-II, A-III or A-IV to the third chemical moiety;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provisions that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, $N(R^9)_2$, $OR^9$, $Si(R^9)_3$, $B(OR^9)_2$, $OSO_2R^9$, $CF_3$, CN, F, Cl, Br, I,

$C_1\text{-}C_{40}$-alkyl,
which is optionally substituted with one or more substituents $R^9$ and wherein one or more non-adjacent $CH_2$-groups are optionally substituted by $R^9C{=}CR^9$, $C{\equiv}C$, $Si(R^9)_2$, $Ge(R^9)_2$, $Sn(R^9)_2$, C=O, C=S, C=Se, $C{=}NR^9$, $P(=O)(R^9)$, SO, $SO_2$, $NR^9$, O, S or $CONR^9$;
$C_1\text{-}C_{40}$-alkoxy,
which is optionally substituted with one or more substituents $R^9$ and wherein one or more non-adjacent $CH_2$-groups are optionally substituted by $R^9C{=}CR^9$, $C{\equiv}C$, $Si(R^9)_2$, $Ge(R^9)_2$, $Sn(R^9)_2$, C=O, C=S, C=Se, $C{=}NR^9$, $P(=O)(R^9)$, SO, $SO_2$, $NR^9$, O, S or $CONR^9$;
$C_1\text{-}C_{40}$-thioalkoxy,
which is optionally substituted with one or more substituents $R^9$ and wherein one or more non-adjacent $CH_2$-groups are optionally substituted by $R^9C{=}CR^9$, $C{\equiv}C$, $Si(R^9)_2$, $Ge(R^9)_2$, $Sn(R^9)_2$, C=O, C=S, C=Se, $C{=}NR^9$, $P(=O)(R^9)$, SO, $SO_2$, $NR^9$, O, S or $CONR^9$;
$C_2\text{-}C_{40}$-alkenyl,
which is optionally substituted with one or more substituents $R^9$ and wherein one or more non-adjacent $CH_2$-groups are optionally substituted by $R^9C{=}CR^9$, C=C, $Si(R^9)_2$, $Ge(R^9)_2$, $Sn(R^9)_2$, C=O, C=S, C=Se, $C{=}NR^9$, $P(=O)(R^9)$, SO, $SO_2$, $NR^9$, O, S or $CONR^9$;
$C_2\text{-}C_{40}$-alkynyl,
which is optionally substituted with one or more substituents $R^9$ and wherein one or more non-adjacent $CH_2$-groups are optionally substituted by $R^9C{=}CR^9$, $Si(R^9)_2$, $Ge(R^9)_2$, $Sn(R^9)_2$, C=O, C=S, C=Se, $C{=}NR^9$, $P(=O)(R^9)$, SO, $SO_2$, $NR^9$, O, S or $CONR^9$;
$C_6\text{-}C_{60}$-aryl,
which is optionally substituted with one or more substituents $R^9$; and
$C_3\text{-}C_{60}$-heteroaryl,
which is optionally substituted with one or more substituents $R^9$;

$R^9$ is at each occurrence independently of each other selected from the group consisting of: hydrogen, deuterium, $N(R^{10})_2$, $OR^{10}$, $Si(R^{10})_3$, $B(OR^{10})_2$, $OSO_2R^{10}$, $CF_3$, CN, F, Cl, Br, I,

$C_1\text{-}C_{40}$-alkyl,
which is optionally substituted with one or more substituents $R^{10}$ and wherein one or more non-adjacent $CH_2$-groups are optionally substituted by $R^{10}C{=}CR^{10}$, C=C, $Si(R^{10})_2$, $Ge(R^{10})_2$, $Sn(R^{10})_2$, C=O, C=S, C=Se, $C{=}NR^{10}$, $P(=O)(R^{10})$, SO, $SO_2$, $NR^{10}$, O, S or $CONR^{10}$;

$C_1$-$C_{40}$-alkoxy, which is optionally substituted with one or more substituents $R^{10}$ and wherein one or more non-adjacent $CH_2$-groups are optionally substituted by $R^{10}C=CR^{10}$, C=C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;
$C_1$-$C_{40}$-thioalkoxy,
which is optionally substituted with one or more substituents $R^{10}$ and wherein one or more non-adjacent $CH_2$-groups are optionally substituted by $R^{10}C=CR^{10}$, C=C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;
$C_2$-$C_{40}$-alkenyl,
which is optionally substituted with one or more substituents $R^{10}$ and wherein one or more non-adjacent $CH_2$-groups are optionally substituted by $R^{10}C=CR^{10}$, C=C, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;
$C_2$-$C_{40}$-alkynyl,
which is optionally substituted with one or more substituents $R^{10}$ and wherein one or more non-adjacent $CH_2$-groups are optionally substituted by $R^{10}C=CR^{10}$, $Si(R^{10})_2$, $Ge(R^{10})_2$, $Sn(R^{10})_2$, C=O, C=S, C=Se, $C=NR^{10}$, $P(=O)(R^{10})$, SO, $SO_2$, $NR^{10}$, O, S or $CONR^{10}$;
$C_6$-$C_{60}$-aryl,
which is optionally substituted with one or more substituents $R^{10}$; and
$C_3$-$C_{60}$-heteroaryl,
which is optionally substituted with one or more substituents $R^{10}$;

$R^{10}$ is at each occurrence independently of each other selected from the group consisting of: hydrogen, deuterium, OPh, $CF_3$, CN, F,

$C_1$-$C_5$-alkyl,
wherein one or more hydrogen atoms are optionally, independently of each other substituted by deuterium, CN, $CF_3$, or F;
$C_1$-$C_5$-alkoxy,
wherein one or more hydrogen atoms are optionally, independently of each other substituted by deuterium, CN, $CF_3$, or F;
$C_1$-$C_5$-thioalkoxy,
wherein one or more hydrogen atoms are optionally, independently of each other substituted by deuterium, CN, $CF_3$, or F;
$C_2$-$C_5$-alkenyl,
wherein one or more hydrogen atoms are optionally, independently of each other substituted by deuterium, CN, $CF_3$, or F;
$C_2$-$C_5$-alkynyl,
wherein one or more hydrogen atoms are optionally, independently of each other substituted by deuterium, CN, $CF_3$, or F;
$C_6$-$C_{18}$-aryl,
wherein one or more hydrogen atoms are optionally, independently of each other substituted by deuterium, $C_1$-$C_5$-alkyl, Ph or CN;
$C_3$-$C_{17}$-heteroaryl,
wherein one or more hydrogen atoms are optionally, independently of each other substituted by deuterium, Ph or $C_1$-$C_5$-alkyl;

$N(C_6$-$C_{18}$-aryl$)_2$;

$N(C_3$-$C_{17}$-heteroaryl$)_2$, and

$N(C_3$-$C_{17}$-heteroaryl$)(C_6$-$C_{18}$-aryl);

$R^7$ is at each occurrence independently of each other selected from the group consisting of CN, $CF_3$ and a structure according to formula EWG-I:

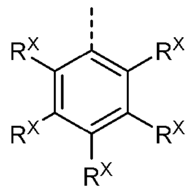

Formula EWG-I,

wherein $R^X$ is defined as $R^6$, with the provision that at least one group $R^X$ in formula EWG-I is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

wherein in formulas L-I, L-II, L-III, L-IV, L-V, L-VI, L-VII, and L-VIII:

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, F, Cl, Br, I,

$C_1$-$C_5$-alkyl,
wherein one or more hydrogen atoms are optionally substituted by deuterium;
$C_6$-$C_{18}$-aryl,
wherein one or more hydrogen atoms are optionally, independently of each other substituted by deuterium, $C_1$-$C_5$-alkyl groups, $C_6$-$C_{18}$-aryl groups, F, Cl, Br, and I;

$R^{12}$ is defined as $R^6$.

In a preferred embodiment of the invention,

$Z^2$ is at each occurrence independently of each other selected from the group consisting of a direct bond, $CR^1R^2$, $C=CR^1R^2$, C=O, $C=NR^1$, $NR^1$, O, $SiR^1R^2$, S, S(O) and $S(O)_2$;

$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $CF_3$, CN, F, Cl, Br, I,

$C_1$-$C_{40}$-alkyl,
which is optionally substituted with one or more substituents $R^3$ and wherein one or more non-adjacent $CH_2$-groups are optionally substituted by $R^3C=CR^3$, C=C, $Si(R^3)_2$, $Ge(R^3)_2$, $Sn(R^3)_2$, C=O, C=S, C=Se, $C=NR^3$, P(=O)($R^3$), SO, $SO_2$, $NR^3$, O, S or $CONR^3$;
$C_6$-$C_{60}$-aryl,
which is optionally substituted with one or more substituents $R^3$; and
$C_3$-$C_{60}$-heteroaryl,
which is optionally substituted with one or more substituents $R^3$;

$R^3$ is at each occurrence independently of each other selected from the group consisting of: hydrogen, deuterium, $N(R^4)_2$, $OR^4$, $Si(R^4)_3$, $CF_3$, CN, F, Br, I,

$C_1$-$C_{40}$-alkyl,
which is optionally substituted with one or more substituents $R^4$ and wherein one or more non-adjacent $CH_2$-groups are optionally substituted by $R^4C=CR^4$, C=C, $Si(R^4)_2$, $Ge(R^4)_2$, $Sn(R^4)_2$, C=O, C=S, C=Se, $C=NR^4$, P(=O)($R^4$), SO, $SO_2$, $NR^4$, O, S or $CONR^4$;
$C_6$-$C_{60}$-aryl,
which is optionally substituted with one or more substituents $R^4$; and

$C_3$-$C_{57}$-heteroaryl,
which is optionally substituted with one or more substituents $R^4$;

wherein, optionally, any of the substituents $R^a$, $R^b$, $R^d$, $R^1$, $R^2$, $R^3$, and $R^4$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, $R^2$, $R^3$, and $R^4$;

$R^4$ is at each occurrence independently of each other selected from the group consisting of: hydrogen, deuterium, $CF_3$, CN, F,

$C_1$-$C_5$-alkyl,
wherein one or more hydrogen atoms are optionally, independently of each other substituted by deuterium, CN, $CF_3$, or F;
$C_6$-$C_{18}$-aryl,
wherein one or more hydrogen atoms are optionally, independently of each other substituted by deuterium, $C_1$-$C_5$-alkyl, Ph or CN;
$C_3$-$C_{17}$-heteroaryl,
wherein one or more hydrogen atoms are optionally, independently of each other substituted by deuterium, $C_1$-$C_5$-alkyl or Ph;

$N(C_6$-$C_{18}$-aryl$)_2$;

$N(C_3$-$C_{17}$-heteroaryl$)_2$, and

$N(C_3$-$C_{17}$-heteroaryl)($C_6$-$C_{18}$-aryl);

a is an integer and is 0 or 1;

b is an integer and is at each occurrence 0 or 1, wherein both b are always identical;

wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, $N(R^9)_2$, $OR^9$, $Si(R^9)_3$, $CF_3$, CN, F, Cl, Br, I,

$C_1$-$C_{40}$-alkyl,
which is optionally substituted with one or more substituents $R^9$ and wherein one or more non-adjacent $CH_2$-groups are optionally substituted by $R^9C$=$CR^9$, C=C, $Si(R^9)_2$, $Ge(R^9)_2$, $Sn(R^9)_2$, C=O, C=S, C=Se, C=$NR^9$, P(=O)($R^9$), SO, $SO_2$, $NR^9$, O, S or $CONR^9$;
$C_6$-$C_{60}$-aryl,
which is optionally substituted with one or more substituents $R^9$; and
$C_3$-$C_{60}$-heteroaryl,
which is optionally substituted with one or more substituents $R^9$;

$R^9$ is at each occurrence independently of each other selected from the group consisting of: hydrogen, deuterium, $N(R^{10})_2$, $OR^{10}$, $Si(R^{10})_3$, $CF_3$, CN, F, Cl, Br, I,

$C_1$-$C_{40}$-alkyl,
which is optionally substituted with one or more substituents $R^{10}$ and wherein one or more non-adjacent $CH_2$-groups are optionally substituted by $R^{10}C$=$CR^{10}$, C=C, $Si(R^{10})_2$, $Ge(R^{10})_2$, $Sn(R^{10})_2$, C=O, C=S, C=Se, C=$NR^{10}$,

$P(=O)(R^{10})$, SO, $SO_2$, $NR^{10}$, O, S or $CONR^{10}$;
$C_6$-$C_{60}$-aryl,
which is optionally substituted with one or more substituents $R^{10}$; and
$C_3$-$C_{60}$-heteroaryl,
which is optionally substituted with one or more substituents $R^{10}$;

$R^{10}$ is at each occurrence independently of each other selected from the group consisting of: hydrogen, deuterium, OPh, $CF_3$, CN, F,

$C_1$-$C_5$-alkyl,
wherein one or more hydrogen atoms are optionally, independently of each other substituted by deuterium, CN, $CF_3$, or F;
$C_6$-$C_{18}$-aryl,
wherein one or more hydrogen atoms are optionally, independently of each other substituted by deuterium, $C_1$-$C_5$-alkyl, Ph or CN;
$C_3$-$C_{17}$-heteroaryl,
wherein one or more hydrogen atoms are optionally, independently of each other substituted by deuterium, $C_1$-$C_5$-alkyl or Ph;

$N(C_6$-$C_{18}$-aryl$)_2$;

$N(C_3$-$C_{17}$-heteroaryl$)_2$, and

$N(C_3$-$C_{17}$-heteroaryl$)(C_6$-$C_{18}$-aryl$)$;

$R^7$ is at each occurrence independently of each other selected from the group consisting of CN, $CF_3$ and a structure according to formula EWG-I:

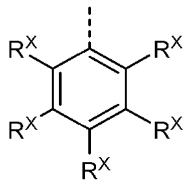

Formula EWG-I,

wherein $R^X$ is defined as $R^6$, with the provision, that at least one group $R^X$ is CN or $CF_3$;

wherein the two adjacent groups $R^8$ in formula A-IV optionally form an aromatic ring, which is fused to the structure of formula A-IV and optionally substituted with one or more substituents $R^{10}$; wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium,

$C_1$-$C_5$-alkyl,
wherein one or more hydrogen atoms are optionally substituted by deuterium;
$C_6$-$C_{18}$-aryl,
wherein one or more hydrogen atoms are optionally, independently of each other substituted by deuterium, $C_1$-$C_5$-alkyl groups, and $C_6$-$C_{18}$-aryl groups;

$R^{12}$ is defined as $R^6$;

wherein the maximum number of first and second chemical moieties attached to the third chemical moiety is only defined by the number of available binding sites on the third chemical moiety (in other words: the number of substituents $R^{11}$), with the aforementioned provision, that each TADF material $E^B$ comprises at least one first chemical moiety, at least one second chemical moiety, and exactly one third chemical moiety.

In an even more preferred embodiment of the invention,

$Z^2$ is at each occurrence independently of each other selected from the group consisting of a direct bond, $CR^1R^2$, $C=CR^1R^2$, C=O, $C=NR^1$, $NR^1$, O, $SiR^1R^2$, S, S(O) and $S(O)_2$;

$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $CF_3$, CN, F, Cl, Br, I,

$C_1$-$C_5$-alkyl,
which is optionally substituted with one or more substituents $R^3$
$C_6$-$C_{18}$-aryl,
which is optionally substituted with one or more substituents $R^3$; and
$C_3$-$C_{17}$-heteroaryl,
which is optionally substituted with one or more substituents $R^3$;

$R^3$ is at each occurrence independently of each other selected from the group consisting of: hydrogen, deuterium, $N(R^4)_2$, $Si(R^4)_3$, $CF_3$, CN, F,

$C_1$-$C_5$-alkyl,
which is optionally substituted with one or more substituents $R^4$ and
$C_6$-$C_{18}$-aryl,
which is optionally substituted with one or more substituents $R^4$; and
$C_3$-$C_{17}$-heteroaryl,
which is optionally substituted with one or more substituents $R^4$;

wherein, optionally, any of the substituents $R^a$, $R^b$, $R^d$, $R^1$, $R^2$ and $R^3$ independently of each other form a mono- or polycyclic, aliphatic or aromatic, carbo- or heterocyclic ring system with one or more adjacent substituents selected from $R^a$, $R^b$, $R^d$, $R^1$, $R^2$, and $R^3$; wherein the optionally so formed ring system may optionally be substituted with one or more substituents $R^5$;

$R^4$ and $R^5$ are at each occurrence independently of each other selected from the group consisting of: hydrogen, deuterium, $CF_3$, CN, F, Me, $^i$Pr, $^t$Bu, $N(Ph)_2$, and Ph, wherein one or more hydrogen atoms are optionally, independently of each other substituted by deuterium, Me, $^i$Pr, $^t$Bu, and Ph;

a is an integer and is 0 or 1;

b is an integer and is at each occurrence 0 or 1, wherein both b are always identical;

wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, $N(R^9)_2$, $OR^9$, $Si(R^9)_3$, $CF_3$, CN, F,

$C_1$-$C_5$-alkyl,
which is optionally substituted with one or more substituents $R^9$;

$C_6$-$C_{18}$-aryl,
which is optionally substituted with one or more substituents $R^9$; and
$C_3$-$C_{17}$-heteroaryl,
which is optionally substituted with one or more substituents $R^9$;

$R^9$ is at each occurrence independently of each other selected from the group consisting of: hydrogen, deuterium, $N(R^{10})_2$, $OR^{10}$, $Si(R^{10})_3$, $CF_3$, CN, F,

$C_1$-$C_5$-alkyl,
which is optionally substituted with one or more substituents $R^{10}$
$C_6$-$C_{18}$-aryl,
which is optionally substituted with one or more substituents $R^{10}$; and
$C_3$-$C_{17}$-heteroaryl,
which is optionally substituted with one or more substituents $R^{10}$;

$R^{10}$ is at each occurrence independently of each other selected from the group consisting of: hydrogen, deuterium, Me, $^i$Pr, $^t$Bu, $CF_3$, CN, F, $N(Ph)_2$, and

Ph, wherein one or more hydrogen atoms are optionally, independently of each other substituted by deuterium, Me, $^i$Pr, $^t$Bu, Ph, CN, $CF_3$, or F;

$R^7$ is at each occurrence independently of each other selected from the group consisting of CN, $CF_3$ and a structure according to formula EWG-I:

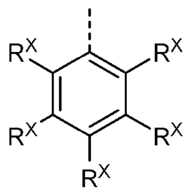

Formula EWG-I,

wherein $R^X$ is defined as $R^6$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium,

$C_1$-$C_5$-alkyl,
wherein one or more hydrogen atoms are optionally substituted by deuterium;
$C_6$-$C_{18}$-aryl,
which is optionally substituted with one or more substituents independently of each other selected from the group consisting of: deuterium, Me, $^i$Pr, $^t$Bu, and Ph;

$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;

$R^a$, $R^b$, $R^d$, $R^1$, and $R^2$ are at each occurrence independently of each other selected from the group consisting of: hydrogen, deuterium, $N(R^3)_2$, $OR^3$, $Si(R^3)_3$, $CF_3$, CN,

$C_1$-$C_5$-alkyl,
which is optionally substituted with one or more substituents $R^3$
$C_6$-$C_{18}$-aryl,
which is optionally substituted with one or more substituents $R^3$; and
$C_3$-$C_{17}$-heteroaryl,
which is optionally substituted with one or more substituents $R^3$;

$R^3$ is at each occurrence independently of each other selected from the group consisting of: hydrogen, deuterium, $CF_3$, CN, F, Me, $^i$Pr, $^t$Bu, $N(Ph)_2$,

Ph, wherein one or more hydrogen atoms are optionally, independently of each other substituted by deuterium, Me, $^i$Pr, $^t$Bu, and Ph;

wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, and $R^2$, wherein an optionally so formed fused ring system constructed from the structure according to formula D-1 and the attached rings formed by adjacent substituents comprises in total 13 to 40 ring atoms, preferably 13 to 30 ring atoms, more preferably 16 to 30 ring atoms;

a is an integer and is 0 or 1;

b is an integer and is at each occurrence 0 or 1, wherein both b are always identical;

wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, $N(R^9)_2$, $OR^9$, $Si(R^9)_3$, $CF_3$, CN, F,

$C_1$-$C_5$-alkyl,
which is optionally substituted with one or more substituents $R^9$;
$C_6$-$C_{18}$-aryl,
which is optionally substituted with one or more substituents $R^9$; and
$C_3$-$C_{17}$-heteroaryl,
which is optionally substituted with one or more substituents $R^9$;

$R^9$ is at each occurrence independently of each other selected from the group consisting of: hydrogen, deuterium, Me, $^i$Pr, $^t$Bu, $CF_3$, CN, F, $N(Ph)_2$, and

Ph, wherein one or more hydrogen atoms are optionally, independently of each other substituted by deuterium, Me, $^i$Pr, $^t$Bu, Ph, CN, $CF_3$, or F.

$R^7$ is at each occurrence independently of each other selected from the group consisting of CN, $CF_3$ and a structure according to formula EWG-I:

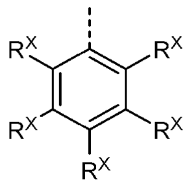

Formula EWG-I,

wherein $R^X$ is defined as $R^6$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^i$Pr, $^t$Bu, and

Ph, which is optionally substituted with one or more substituents independently of each other selected from the group consisting of: deuterium, Me, $^i$Pr, $^t$Bu, and Ph;

$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;

$R^a$, $R^b$, and $R^d$ are at each occurrence independently of each other selected from the group consisting of: hydrogen, deuterium, $N(R^3)_2$, $OR^3$, $Si(R^3)_3$, $CF_3$, CN, Me, $^i$Pr, $^t$Bu,

Ph, wherein one or more hydrogen atoms are optionally, independently of each other substituted by deuterium, Me, $^i$Pr, $^t$Bu, and Ph;

carbazolyl, wherein one or more hydrogen atoms are optionally, independently of each other substituted by deuterium, Me, $^i$Pr, $^t$Bu, and Ph;

triazinyl, wherein one or more hydrogen atoms are optionally, independently of each other substituted by deuterium, Me, $^i$Pr, $^t$Bu, and Ph;

pyrimidinyl, wherein one or more hydrogen atoms are optionally, independently of each other substituted by deuterium, Me, $^i$Pr, $^t$Bu, and Ph;

pyridinyl, wherein one or more hydrogen atoms are optionally, independently of each other substituted by deuterium, Me, $^i$Pr, $^t$Bu, and Ph;

$R^1$ and $R^2$ are at each occurrence independently of each other selected from the group consisting of: hydrogen, deuterium, $N(R^3)_2$, $OR^3$, $Si(R^3)_3$, $CF_3$, CN,

$C_1$-$C_5$-alkyl, which is optionally substituted with one or more substituents $R^3$
$C_6$-$C_{18}$-aryl, which is optionally substituted with one or more substituents $R^3$; and
$C_3$-$C_{17}$-heteroaryl, which is optionally substituted with one or more substituents $R^3$;

$R^3$ is at each occurrence independently of each other selected from the group consisting of: hydrogen, deuterium, $CF_3$, CN, F, Me, $^i$Pr, $^t$Bu, and

Ph, wherein one or more hydrogen atoms are optionally, independently of each other substituted by deuterium, Me, ${}^{i}Pr$, ${}^{t}Bu$, and Ph;

wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more adjacent substituents selected from $R^a$, $R^b$, $R^d$, $R^1$, and $R^2$, wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;

a is an integer and is 0 or 1;

b is an integer and is at each occurrence 0 or 1, wherein both b are always identical;

wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, $N(R^9)_2$, $OR^9$, $Si(R^9)_3$, $CF_3$, CN, F,

$C_1$-$C_5$-alkyl,
which is optionally substituted with one or more substituents $R^9$;
$C_6$-$C_{18}$-aryl,
which is optionally substituted with one or more substituents $R^9$; and
$C_3$-$C_{17}$-heteroaryl,
which is optionally substituted with one or more substituents $R^9$;

$R^9$ is at each occurrence independently of each other selected from the group consisting of: hydrogen, deuterium, Me, ${}^{i}Pr$, ${}^{t}Bu$, $CF_3$, CN, F, $N(Ph)_2$, and

Ph, wherein one or more hydrogen atoms are optionally, independently of each other substituted by deuterium, Me, ${}^{i}Pr$, ${}^{t}Bu$, Ph, CN, $CF_3$, or F;

$R^7$ is at each occurrence independently of each other selected from the group consisting of CN, $CF_3$ and a structure according to formula EWG-I:

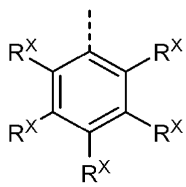

Formula EWG-I,

wherein $R^X$ is defined as $R^6$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^{i}$Pr, $^{t}$Bu, and

Ph, which is optionally substituted with one or more substituents independently of each other selected from the group consisting of: deuterium, Me, $^{i}$Pr, $^{t}$Bu, and Ph;

$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;

$R^a$, $R^b$, and $R^d$ are at each occurrence independently of each other selected from the group consisting of: hydrogen, deuterium, $N(R^3)_2$, $OR^3$, $Si(R^3)_3$, $CF_3$, CN, Me, $^{i}$Pr, $^{t}$Bu,

Ph, wherein one or more hydrogen atoms are optionally, independently of each other substituted by deuterium, Me, $^{i}$Pr, $^{t}$Bu, and Ph; and

carbazolyl, wherein one or more hydrogen atoms are optionally, independently of each other substituted by deuterium, Me, $^{i}$Pr, $^{t}$Bu, and Ph;

$R^1$ and $R^2$ are at each occurrence independently of each other selected from the group consisting of: hydrogen, deuterium, $OR^3$, $Si(R^3)_3$,

$C_1$-$C_5$-alkyl,
which is optionally substituted with one or more substituents $R^3$
$C_6$-$C_{18}$-aryl,
which is optionally substituted with one or more substituents $R^3$; and

$R^3$ is at each occurrence independently of each other selected from the group consisting of: hydrogen, deuterium, $CF_3$, CN, F, Me, $^{i}$Pr, $^{t}$Bu, and

Ph, wherein one or more hydrogen atoms are optionally, independently of each other substituted by deuterium, Me, $^{i}$Pr, $^{t}$Bu, and Ph;

wherein, optionally, any of the substituents $R^a$, $R^b$, $R^d$, $R^1$, and $R^2$ independently of each other form a mono- or polycyclic, aliphatic or aromatic, carbo- or heterocyclic ring system with one or more substituents selected from $R^a$, $R^b$, $R^d$, $R^1$, and $R^2$, wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;

a is an integer and is 0 or 1;

b is an integer and is at each occurrence 0 or 1, wherein both b are always identical;

wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen,

deuterium, OPh, $N(Ph)_2$, $Si(Me)_3$, $Si(Ph)_3$, $CF_3$, CN, F, Me, $^iPr$, $^tBu$,

Ph, wherein one or more hydrogen atoms are optionally, independently of each other substituted by deuterium, Me, $^iPr$, $^tBu$, and Ph;

carbazolyl, wherein one or more hydrogen atoms are optionally, independently of each other substituted by deuterium, Me, $^iPr$, $^tBu$, and Ph;

$R^7$ is at each occurrence independently of each other selected from the group consisting of CN, $CF_3$ and a structure according to formula EWG-I:

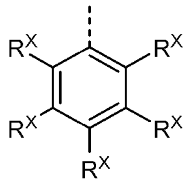

Formula EWG-I,

wherein $R^X$ is defined as $R^6$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^iPr$, $^tBu$, and

Ph, which is optionally substituted with one or more substituents independently of each other selected from the group consisting of: deuterium, Me, $^iPr$, $^tBu$, and Ph;

$R^{12}$ is defined as $R^6$.

In a still even more preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;

$R^a$, $R^b$, and $R^d$ are at each occurrence independently of each other selected from the group consisting of: hydrogen, deuterium, $N(Ph)_2$, $Si(Me)_3$, $Si(Ph)_3$, $CF_3$, CN, Me, $^iPr$, $^tBu$,

Ph, wherein one or more hydrogen atoms are optionally, independently of each other substituted by deuterium, Me, $^iPr$, $^tBu$, and Ph; and

carbazolyl, wherein one or more hydrogen atoms are optionally, independently of each other substituted by deuterium, Me, $^iPr$, $^tBu$, and Ph;

$R^1$ and $R^2$ are at each occurrence independently of each other selected from the group consisting of: hydrogen, deuterium, Me, $^iPr$, $^tBu$,

Ph, wherein one or more hydrogen atoms are optionally, independently of each other substituted by deuterium, Me, $^iPr$, $^tBu$, and Ph;

wherein, optionally, any of the substituents $R^a$, $R^b$, $R^d$, $R^1$, and $R^2$ independently of each other form a mono- or

polycyclic, aliphatic or aromatic or heteroaromatic, carbo- or heterocyclic ring system with one or more substituents selected from $R^a$, $R^b$, $R^d$, $R^1$, and $R^2$; wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;

a is an integer and is 0 or 1;

b is an integer and is at each occurrence 0 or 1, wherein both b are always identical;

wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, $N(Ph)_2$, $Si(Me)_3$, $Si(Ph)_3$, Me, $^i$Pr, $^t$Bu,

Ph, wherein one or more hydrogen atoms are optionally, independently of each other substituted by deuterium, Me, $^i$Pr, $^t$Bu, and Ph;

carbazolyl, wherein one or more hydrogen atoms are optionally, independently of each other substituted by deuterium, Me, $^i$Pr, $^t$Bu, and Ph;

$R^7$ is at each occurrence independently of each other selected from the group consisting of CN, $CF_3$ and a structure according to formula EWG-I:

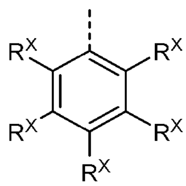

Formula EWG-I,

wherein $R^X$ is defined as $R^6$, but may also be CN or $CF_3$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^i$Pr, $^t$Bu, and

Ph, which is optionally substituted with one or more substituents independently of each other selected from the group consisting of: deuterium, Me, $^i$Pr, $^t$Bu, and Ph;

$R^{12}$ is defined as $R^6$.

In a particularly preferred embodiment of the invention,

$Z^2$ is at each occurrence independently of each other selected from the group consisting of a direct bond, $CR^1R^2$, C=O, $NR^1$, O, $SiR^1R^2$, S, S(O) and $S(O)_2$;

$R^a$, $R^b$, and $R^d$ are at each occurrence independently of each other selected from the group consisting of: hydrogen, deuterium, $CF_3$, CN, Me, $^i$Pr, $^t$Bu, and

Ph, wherein one or more hydrogen atoms are optionally, independently of each other substituted by deuterium, Me, $^i$Pr, $^t$Bu, and Ph;

$R^1$ and $R^2$ are at each occurrence independently of each other selected from the group consisting of: hydrogen, deuterium, Me, $^i$Pr, $^t$Bu, and

Ph, wherein one or more hydrogen atoms are optionally, independently of each other substituted by deuterium, Me, $^i$Pr, $^t$Bu, and Ph;

wherein, optionally, any of the substituents $R^a$, $R^b$, $R^d$, $R^1$, and $R^2$ independently of each other form a mono- or polycyclic, aliphatic or aromatic or heteroaromatic, carbo- or heterocyclic ring system with one or more substituents selected from $R^a$, $R^b$, $R^d$, $R^1$, and $R^2$, wherein an optionally so formed fused ring system constructed from the structure according to formula D1 and the attached rings formed by adjacent substituents comprises in total 13 to 40 ring atoms, preferably 13 to 30 ring atoms, more preferably 16 to 30 ring atoms;

a is an integer and is 0 or 1;

b is an integer and is at each occurrence 0 or 1, wherein both b are always identical;

wherein both integers b are 0 when integer a is 1 and integer a is 0 when both integers b are 1;

$Q^1$ is at each occurrence independently of each other selected from nitrogen (N), $CR^6$, and $CR^7$, with the provision that in formula A-I, two adjacent groups $Q^1$ cannot both be nitrogen (N); wherein, if none of the groups $Q^1$ in formula A-I is nitrogen (N), at least one of the groups $Q^1$ is $CR^7$;

$Q^2$ is at each occurrence independently of each other selected from nitrogen (N), and $CR^6$, with the provision that in formulas A-II and A-III, at least one group $Q^2$ is nitrogen (N) and that two adjacent groups $Q^2$ cannot both be nitrogen (N);

$R^6$ and $R^8$ are at each occurrence independently of each other selected from the group consisting of: hydrogen, deuterium, $N(Ph)_2$, Me, $^i$Pr, $^t$Bu,

Ph, wherein one or more hydrogen atoms are optionally, independently of each other substituted by deuterium, Me, $^i$Pr, $^t$Bu, and Ph; and

carbazolyl, wherein one or more hydrogen atoms are optionally, independently of each other substituted by deuterium, Me, $^i$Pr, $^t$Bu, and Ph;

$R^7$ is at each occurrence independently of each other selected from the group consisting of CN, $CF_3$ and a structure according to formula EWG-I:

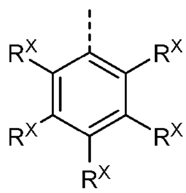

Formula EWG-I,

wherein $R^X$ is defined as $R^6$, but may also be CN or $CF_3$, with the provision, that at least one group $R^X$ is CN or $CF_3$;

wherein the two adjacent groups $R^8$ in formula A-IV optionally form an aromatic ring, which is fused to the structure of formula A-IV, wherein the optionally so formed fused ring system comprises in total 9 to 18 ring atoms;

$Q^3$ is at each occurrence independently of each other selected from nitrogen (N) and $CR^{12}$, with the provision that at least one $Q^3$ is nitrogen (N);

$R^{11}$ is at each occurrence independently of each other either the binding site of a single bond connecting a first or a second chemical moiety to the third chemical moiety or is independently of each other selected from the group consisting of: hydrogen, deuterium, Me, $^i$Pr, $^t$Bu, and

Ph, which is optionally substituted with one or more substituents independently of each other selected from the group consisting of: deuterium, Me, $^i$Pr, $^t$Bu, and Ph;

$R^{12}$ is defined as $R^6$.

In a preferred embodiment of the invention, a is always 1 and b is always 0.
In a preferred embodiment of the invention, $Z^2$ is at each occurrence a direct bond.
In a preferred embodiment of the invention, $R^a$ is at each occurrence hydrogen.
In a preferred embodiment of the invention, $R^a$ and $R^d$ are at each occurrence hydrogen.
In a preferred embodiment of the invention, $Q^3$ is at each occurrence nitrogen (N).
In one embodiment of the invention, at least one group $R^X$ in formula EWG-I is CN.
In a preferred embodiment of the invention, exactly one group $R^X$ in formula EWG-I is CN.
In a preferred embodiment of the invention, exactly one group $R^X$ in formula EWG-I is CN and no group $R^X$ in formula EWG-I is $CF_3$.
Examples of first chemical moieties according to the present invention are shown below, which does of course not imply that the present invention is limited to these examples:

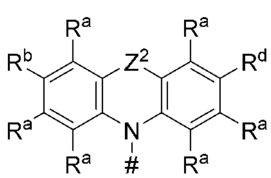
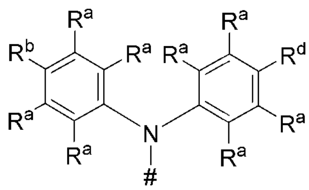
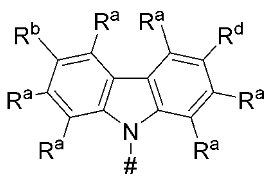

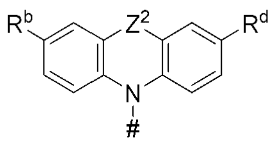
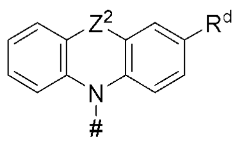
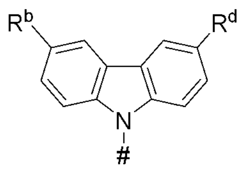
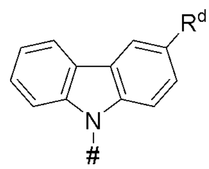

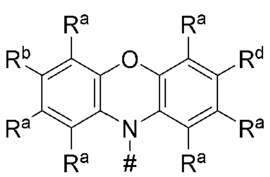
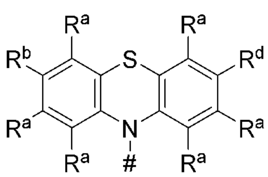
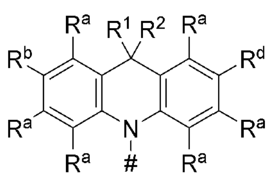
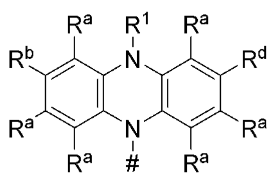

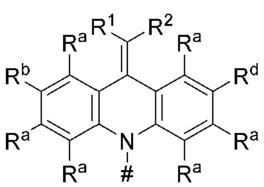
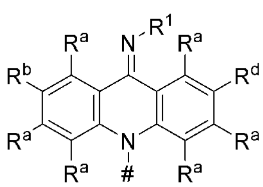
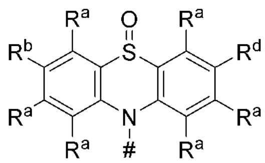
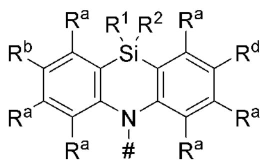

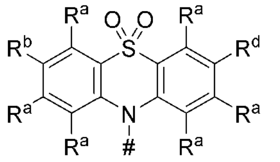 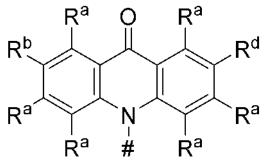 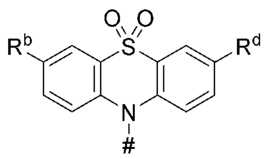 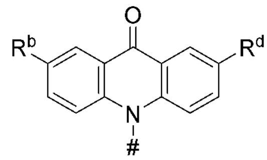

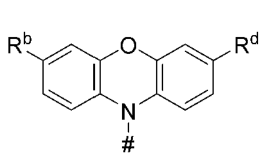 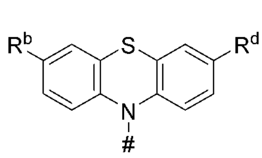 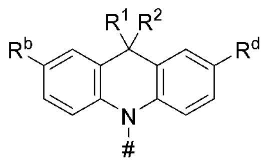 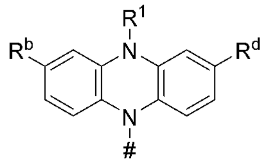

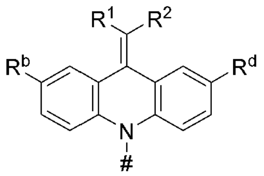 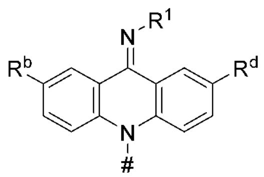 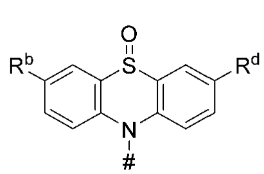 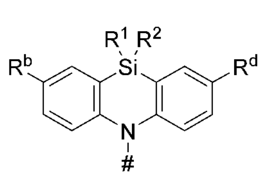

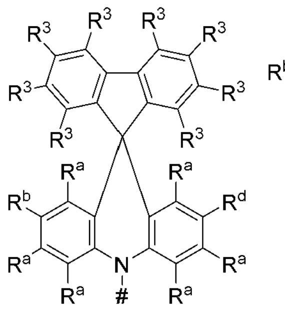 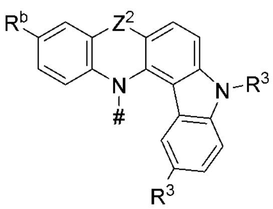 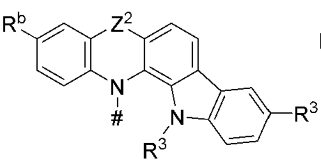 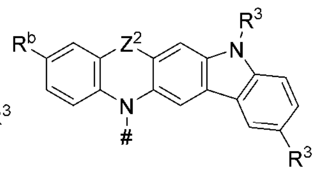

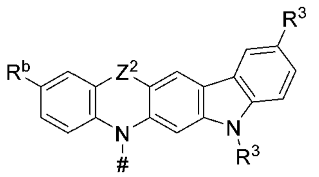 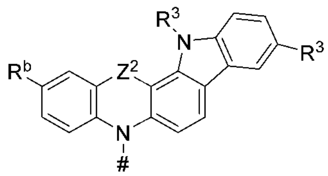 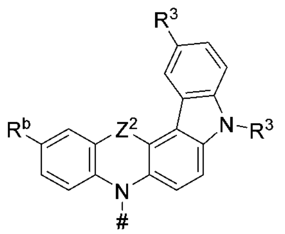

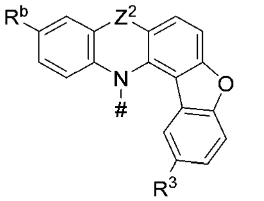 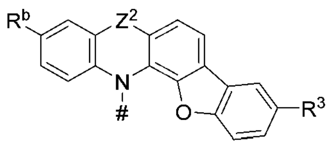 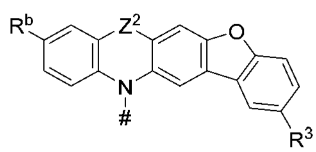

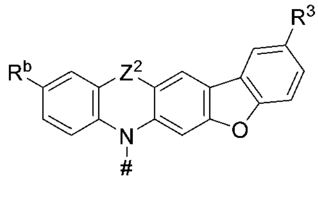 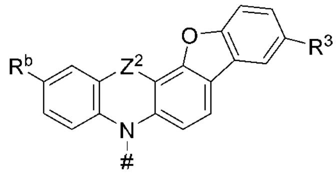 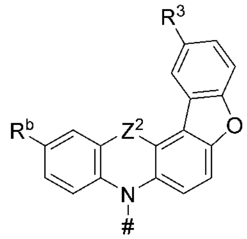

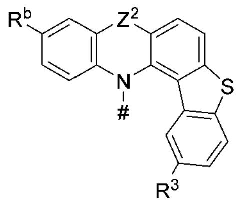
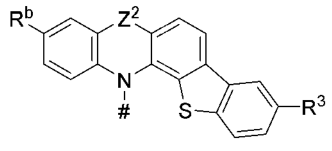
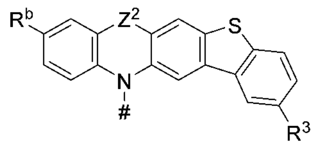
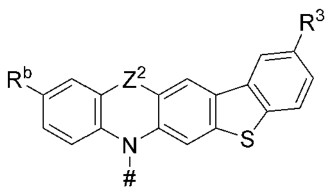
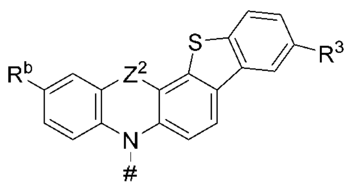
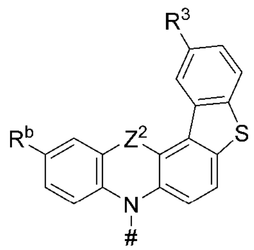
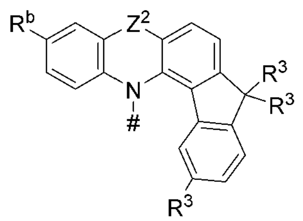
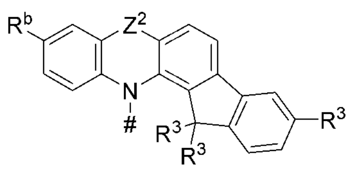
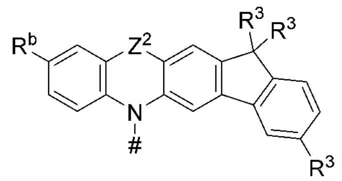
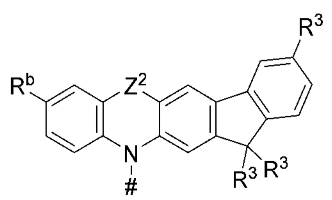
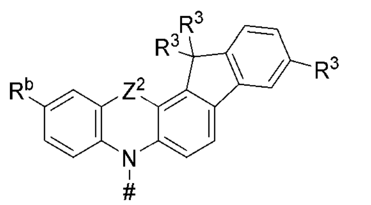
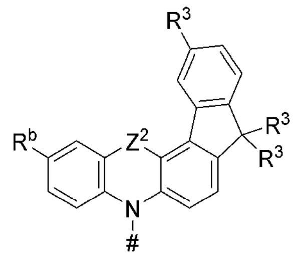
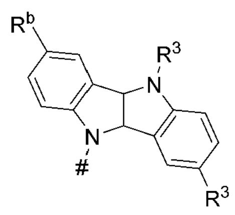
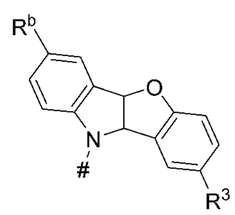
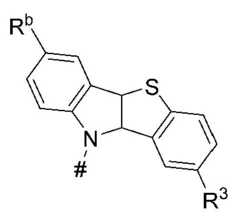
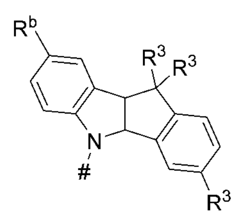
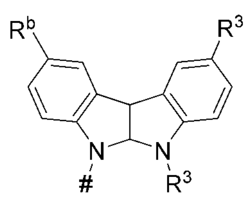
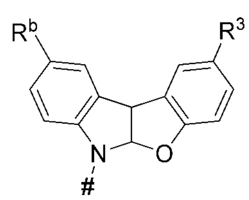
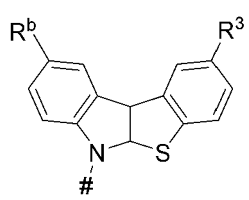
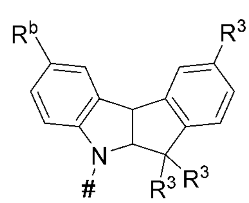
,

wherein the aforementioned definitions apply.

Examples of second chemical moieties according to the present invention are shown below, which does of course not imply that the present invention is limited to these examples:

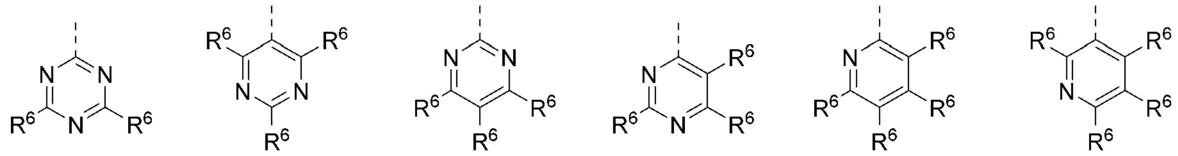

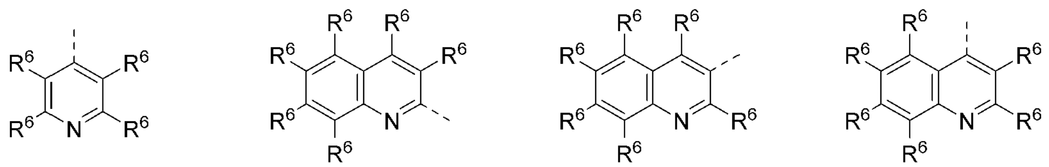

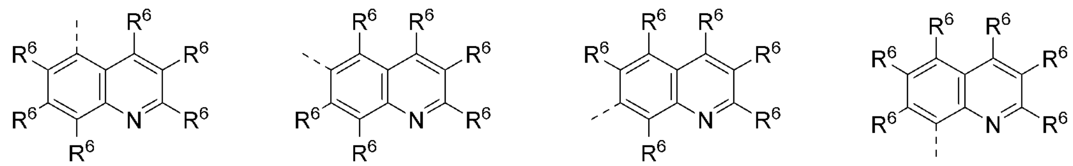

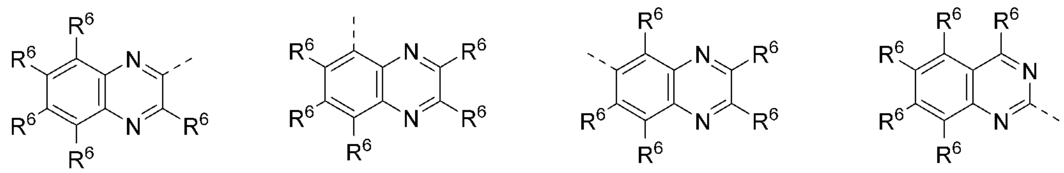

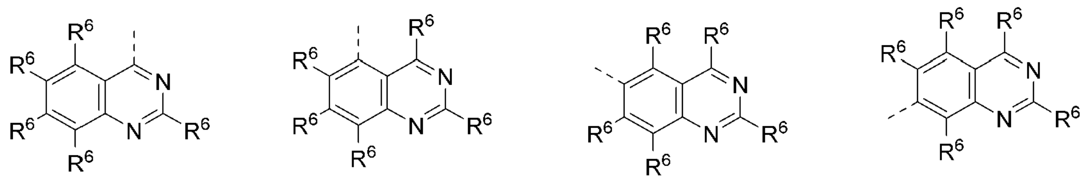

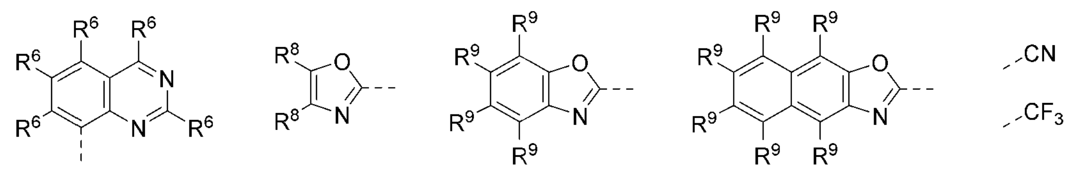

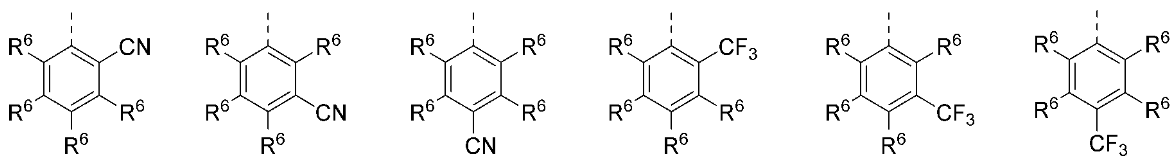

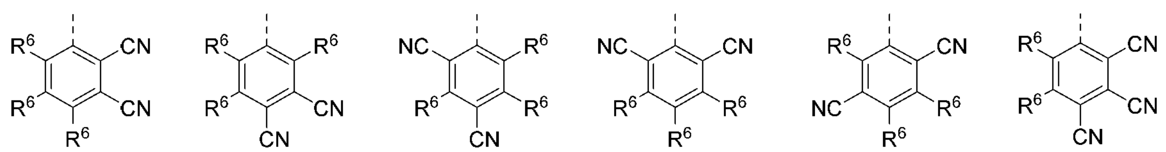

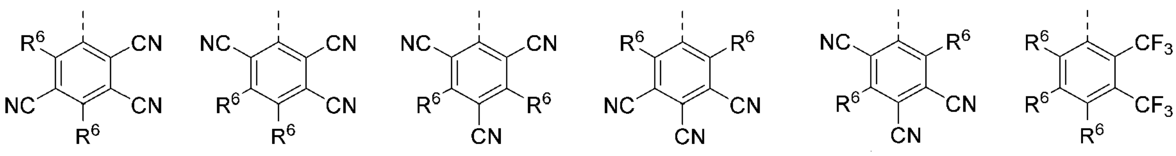

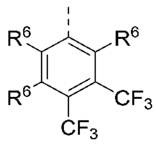 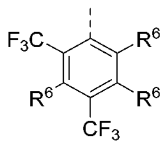 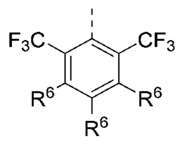 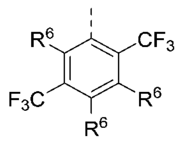 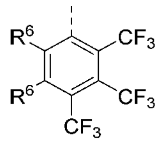 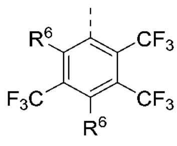

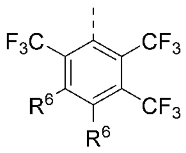 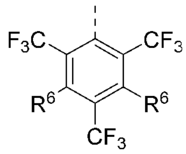 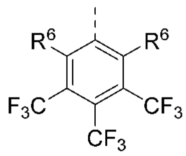 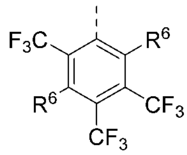 ,

wherein the aforementioned definitions apply.

In a preferred embodiment of the invention, each TADF material $E^B$ has a structure represented by any of formulas $E^B$-I, $E^B$-II, $E^B$-III, $E^B$-IV, $E^B$-V, $E^B$-VI, $E^B$-VII, $E^B$-VIII, and $E^B$-IX, $E^B$-X, and $E^B$-XI:

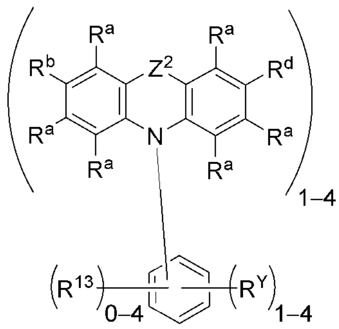

Formula $E^B$-I

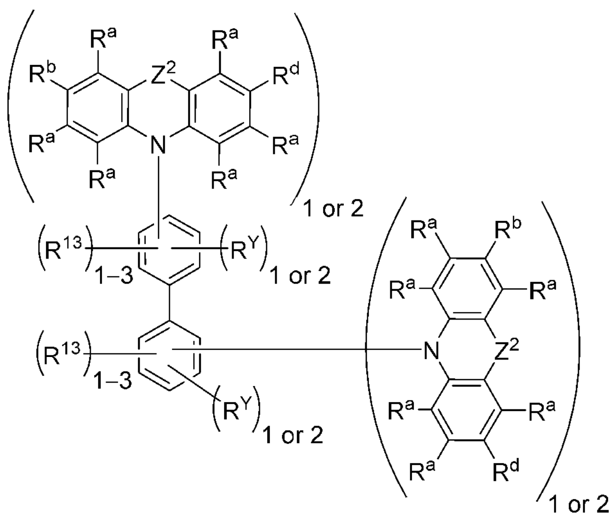

Formula $E^B$-II

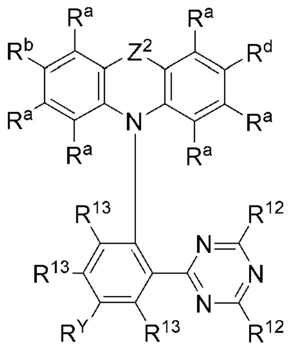

Formula $E^B$-III

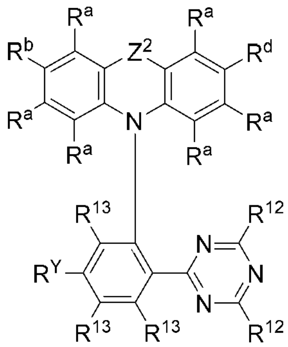

Formula $E^B$-IV

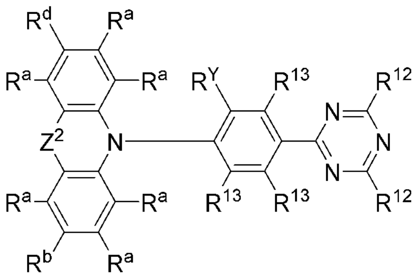

Formula $E^B$-V

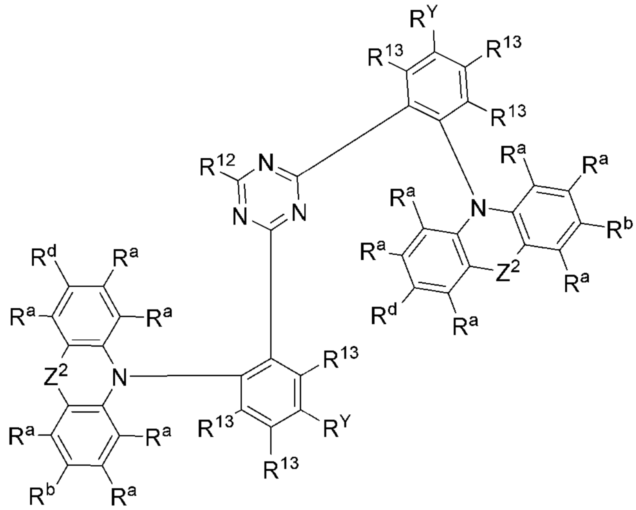

Formula $E^B$-VI

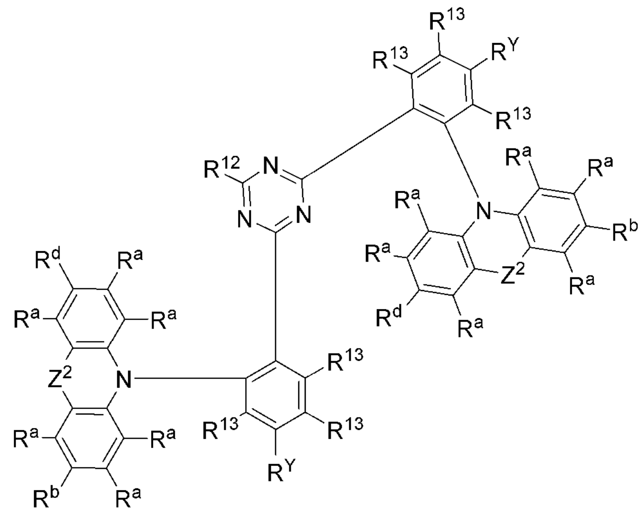

Formula $E^B$-VII

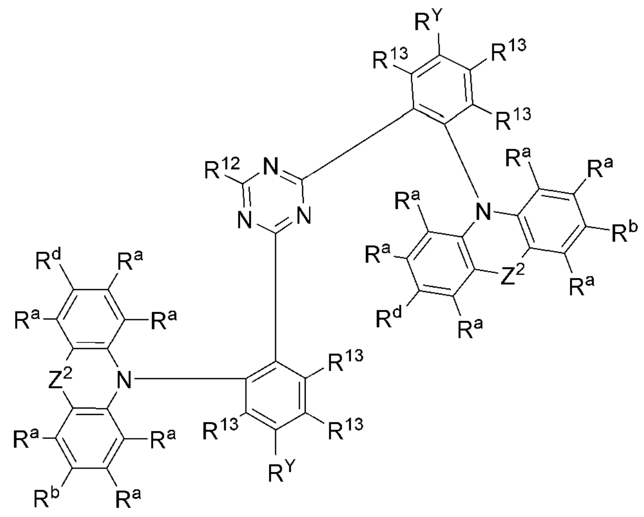

Formula $E^B$-VIII

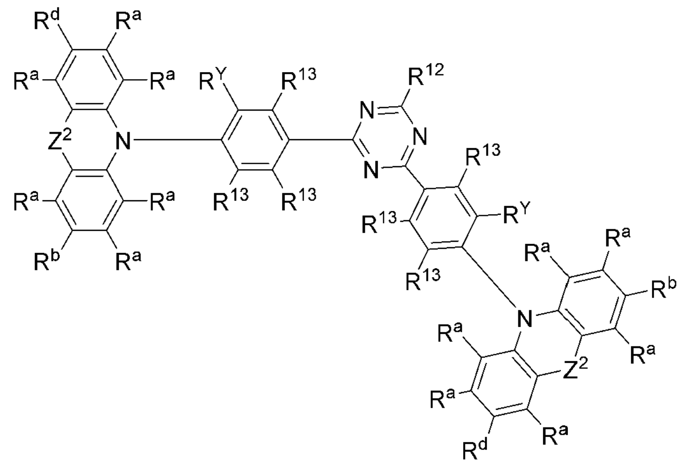

Formula $E^B$-IX,

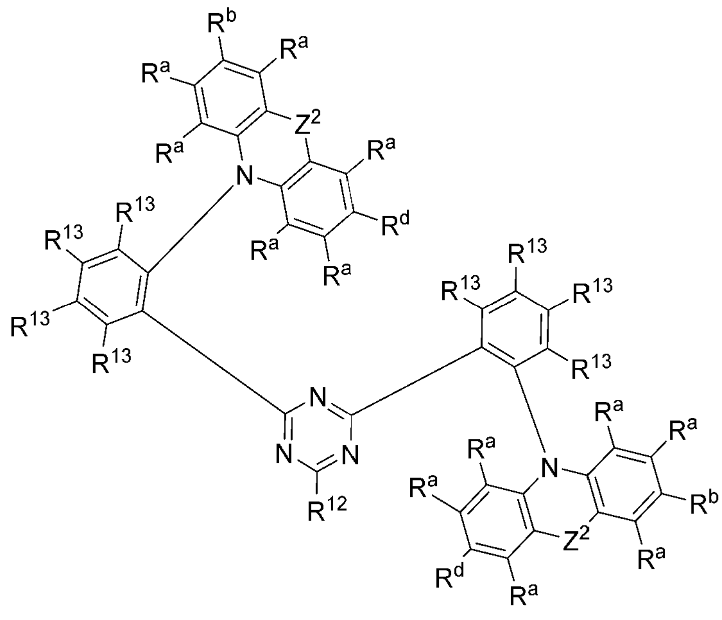

Formula $E^B$-X

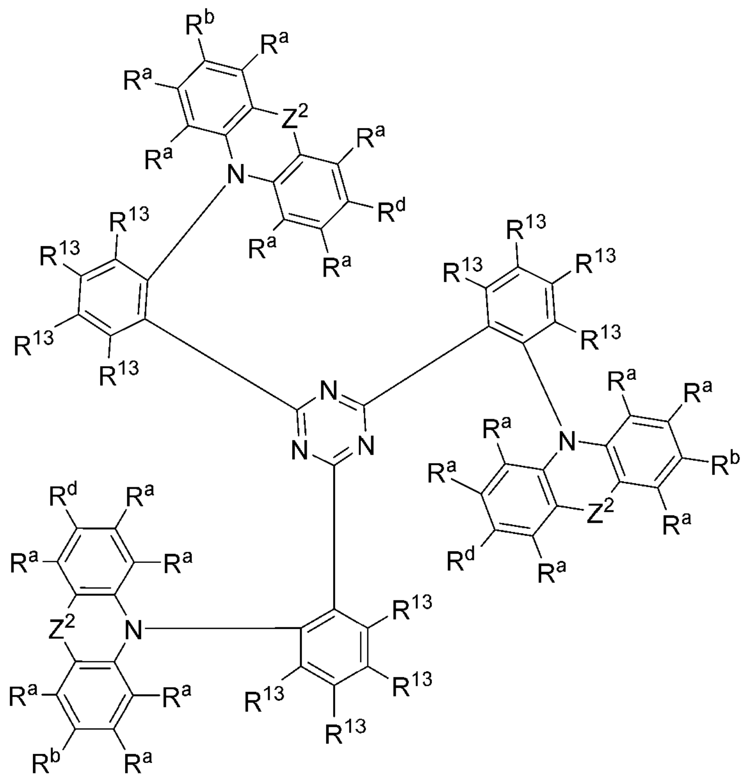

Formula $E^B$-XI

wherein

$R^{13}$ is defined as $R^{11}$ with the provision that $R^{13}$ cannot be a binding site of a single bond connecting a first or a second chemical moiety to the third chemical moiety;

$R^Y$ is selected from CN and $CF_3$ or $R^Y$ comprises or consists of a structure according to formula BN-I:

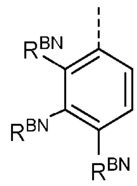

Formula BN-I,

which is bonded to the structure of formula $E^B$-I, $E^B$-II, $E^B$-III, $E^B$-IV, $E^B$-V, $E^B$-VI, $E^B$-VII, $E^B$-VIII or $E^B$-IX via a single bond indicated by the dashed line and wherein exactly one $R^{BN}$ group is CN while the other two $R^{BN}$ groups are both hydrogen (H);

and wherein apart from that the above-mentioned definitions apply.

In a preferred embodiment of the invention, $R^{13}$ is at each occurrence hydrogen.

In one embodiment of the invention, $R^Y$ is at each occurrence CN.

In one embodiment of the invention, $R^Y$ is at each occurrence $CF_3$.

In one embodiment of the invention, $R^Y$ is at each occurrence a structure represented by formula BN-I.

In a preferred embodiment of the invention, $R^Y$ is at each occurrence independently of each other selected from CN and a structure represented by formula BN-I.

In a preferred embodiment of the invention, each TADF material $E^B$ has a structure represented by any of formulas $E^B$-I, $E^B$-II, $E^B$-III, $E^B$-IV, $E^B$-V, $E^B$-VI, $E^B$-VII, and $E^B$-X, wherein the aforementioned definitions apply.

In a preferred embodiment of the invention, each TADF material $E^B$ has a structure represented by any of formulas $E^B$-I, $E^B$-II, $E^B$-III, $E^B$-V, and $E^B$-X, wherein the aforementioned definitions apply.

Examples of TADF materials $E^B$ for use in organic electroluminescent devices according to the invention are listed in the following, whereat this does not imply that only the shown examples are suitable TADF materials $E^B$ in the context of the present invention.

Non-limiting examples of TADF materials $E^B$ according formula $E^B$-1 are shown below:

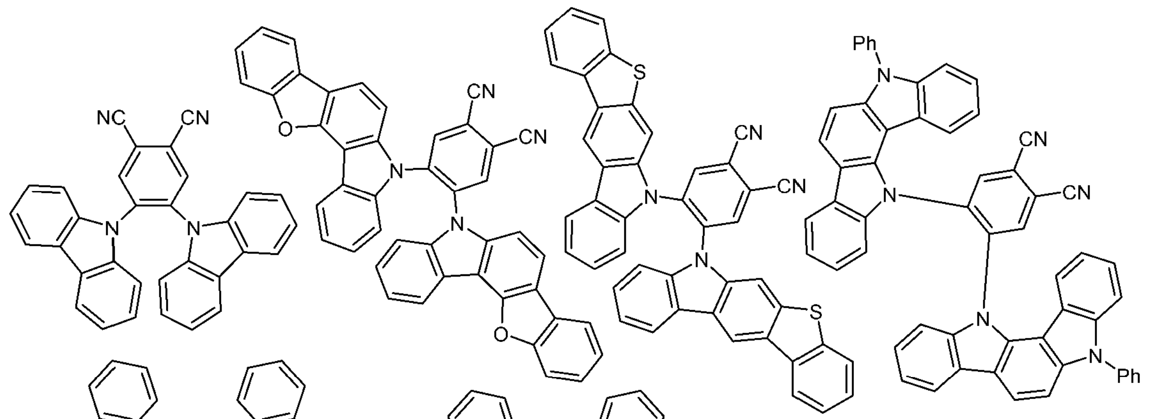

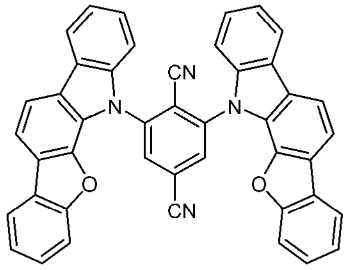

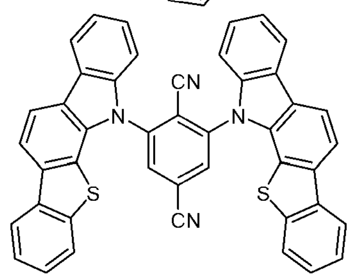

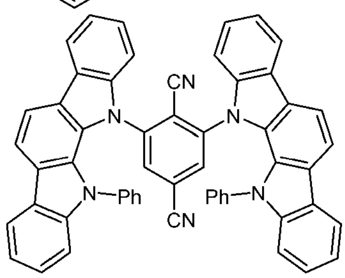

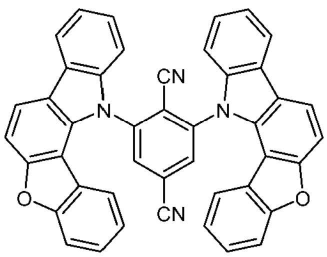

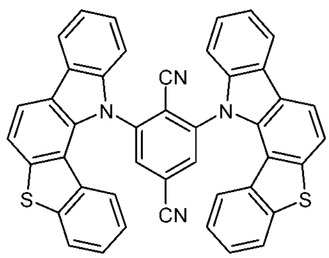

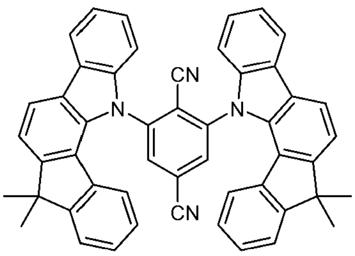

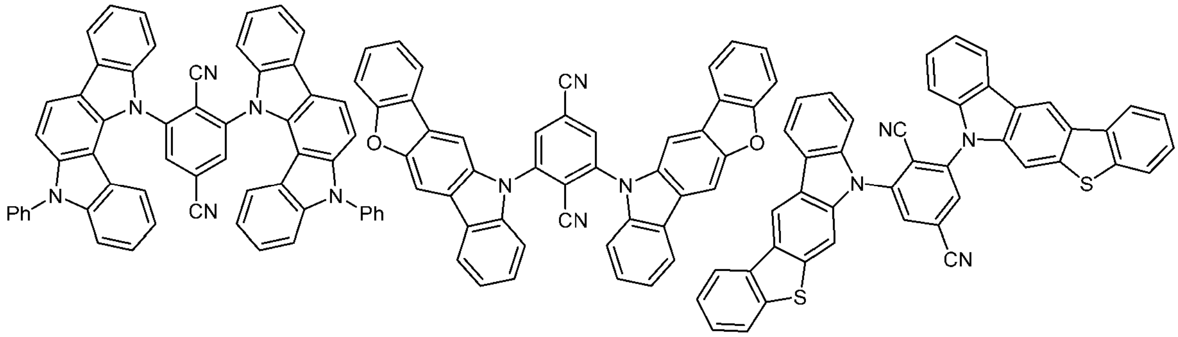

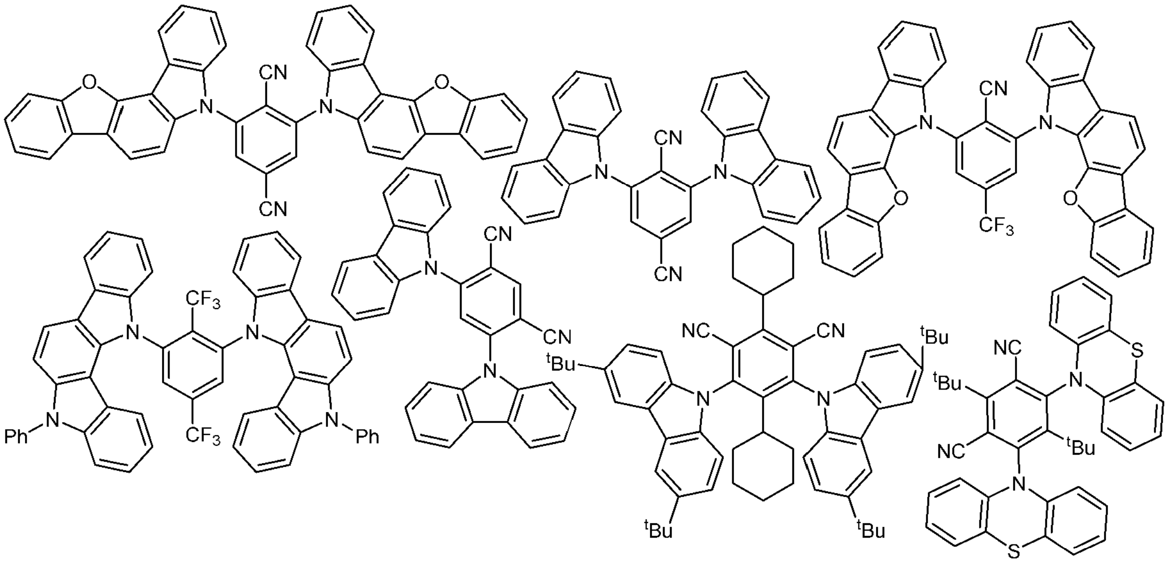

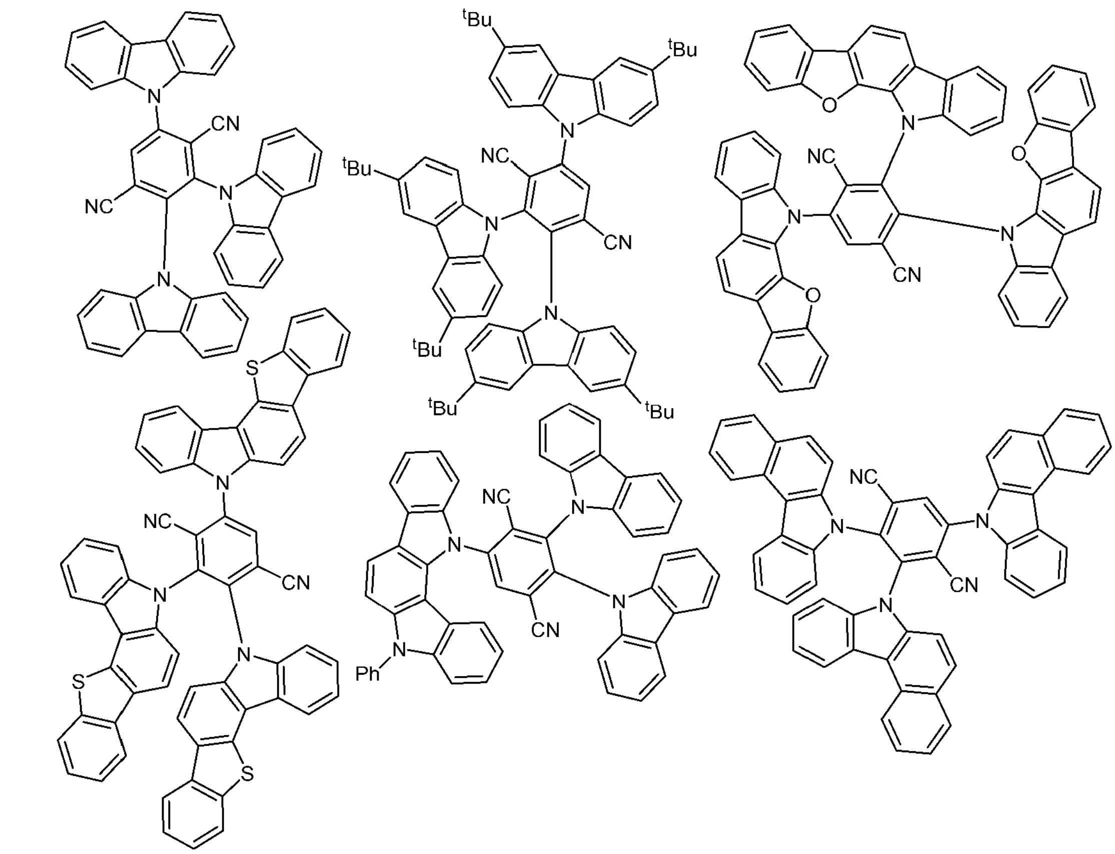

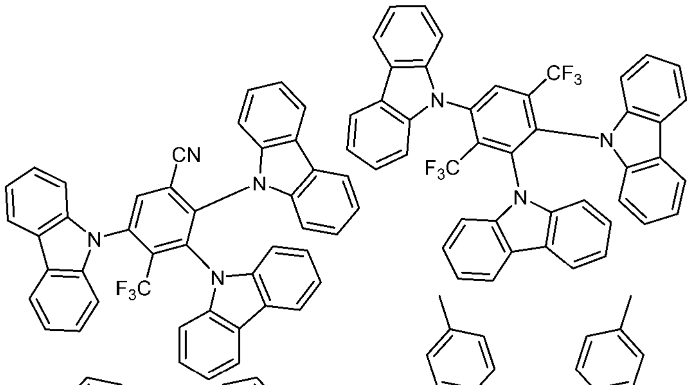

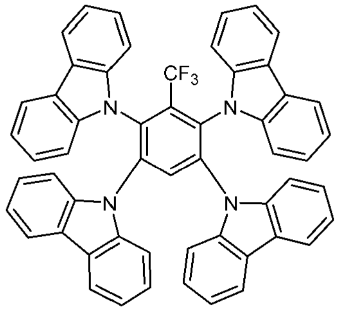

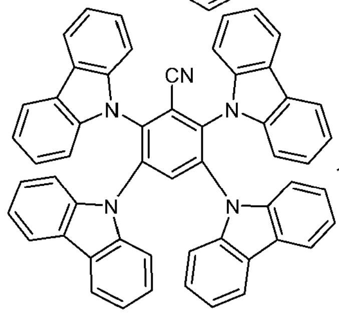

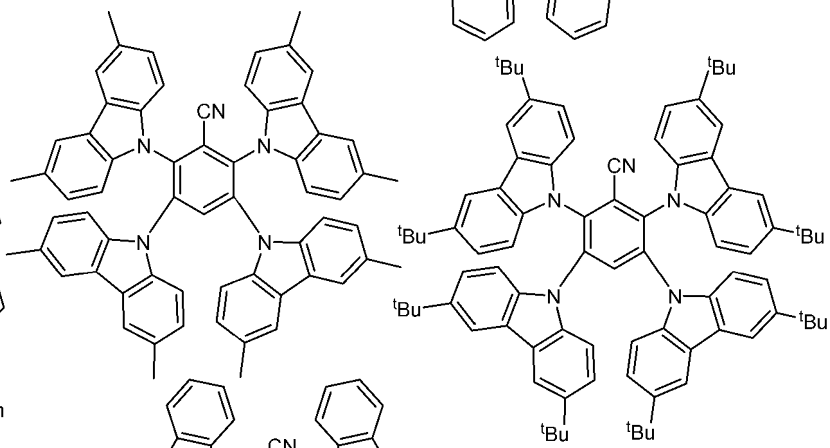

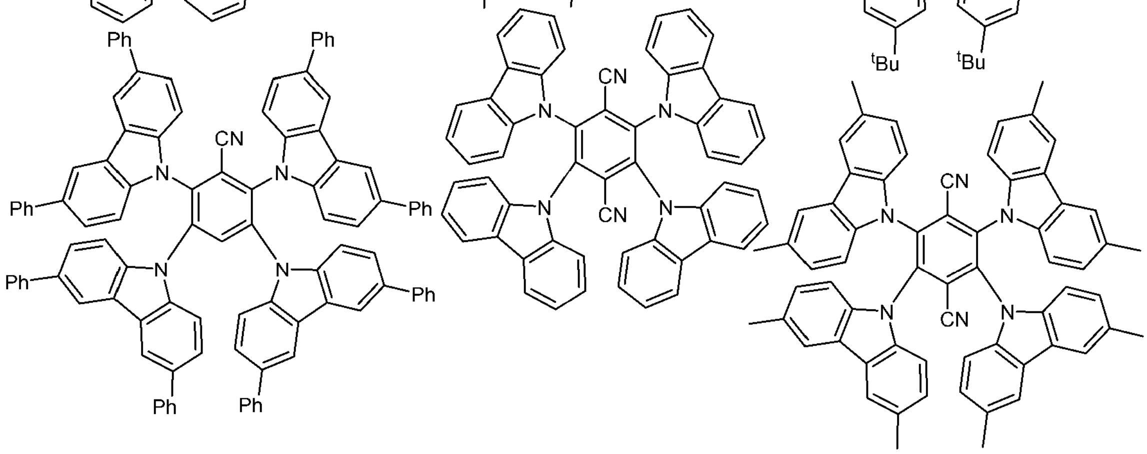

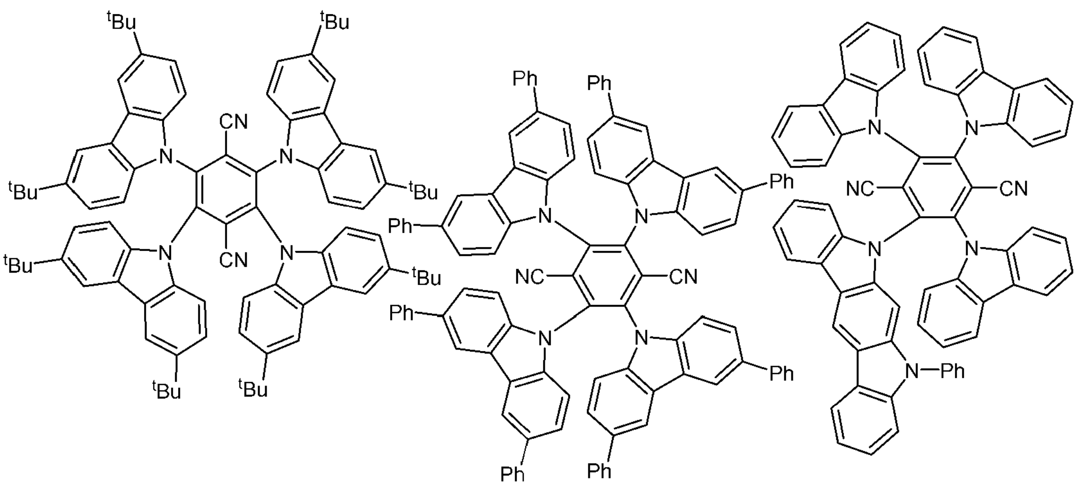

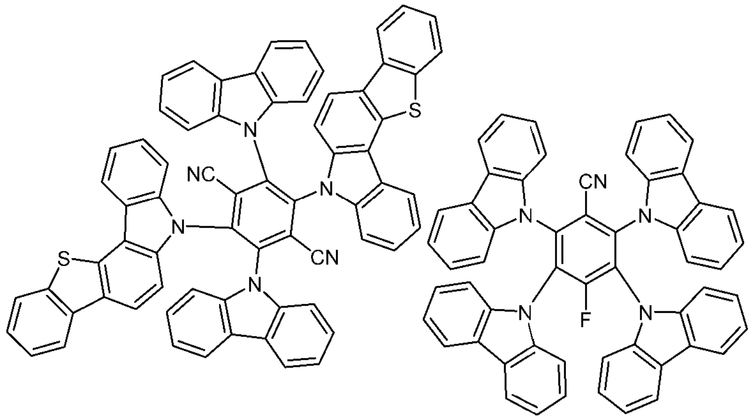

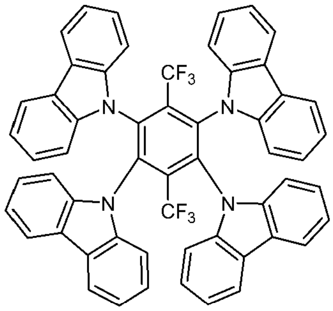

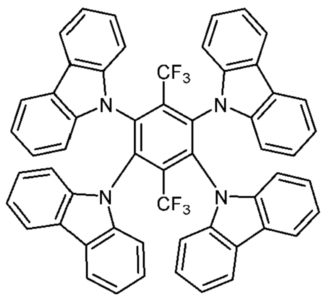

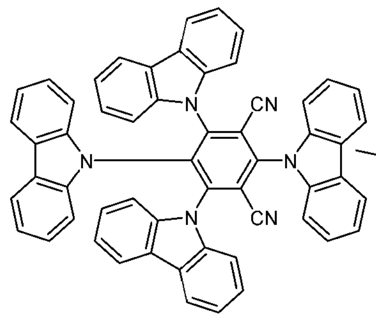

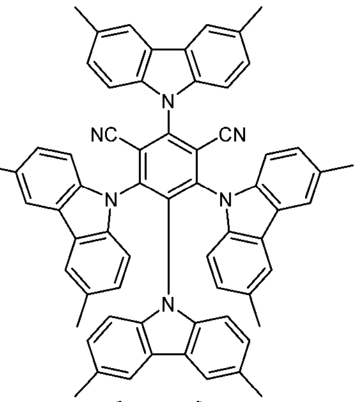

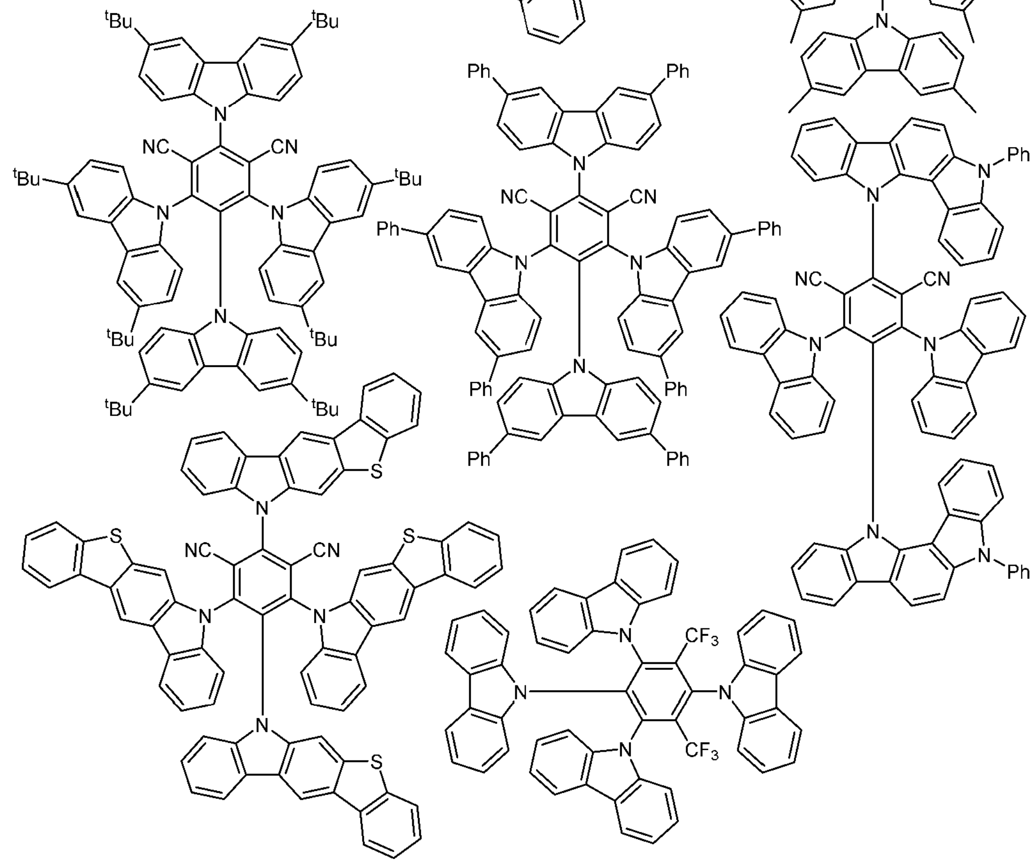

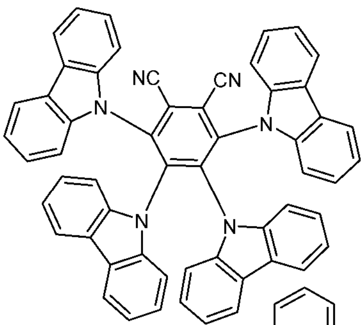

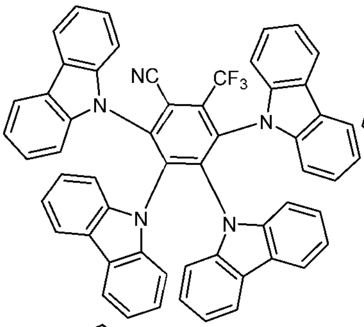

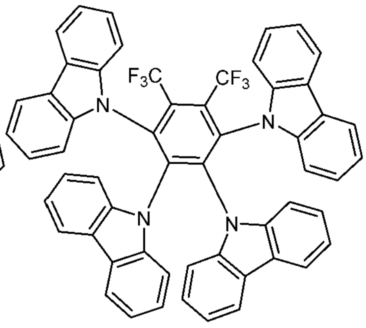

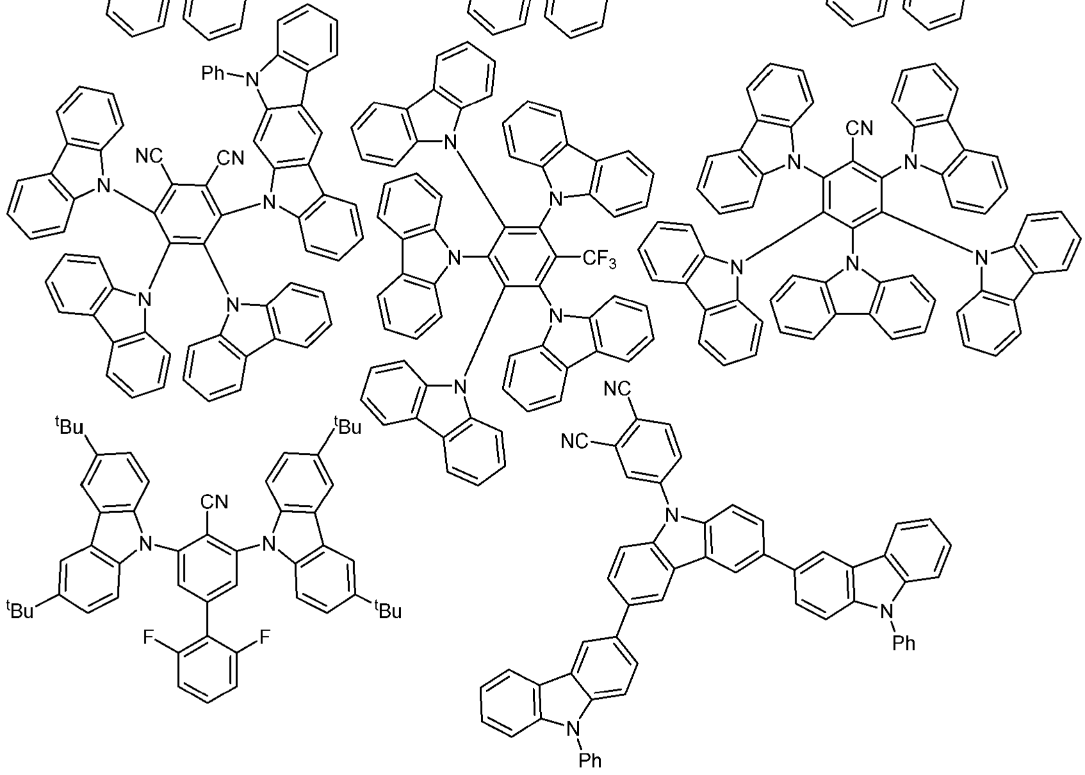

Non-limiting examples of TADF materials $E^B$ according formula $E^B$-II are shown below:

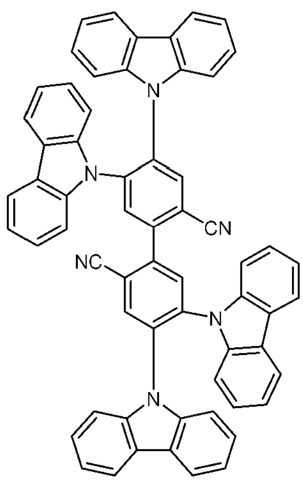

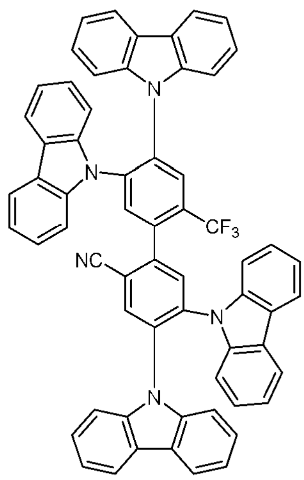

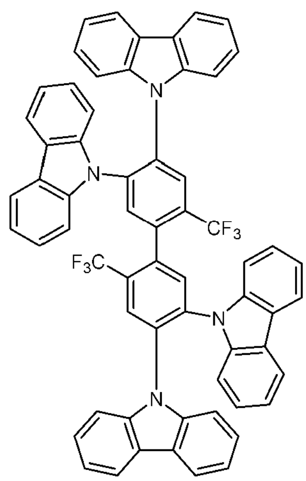

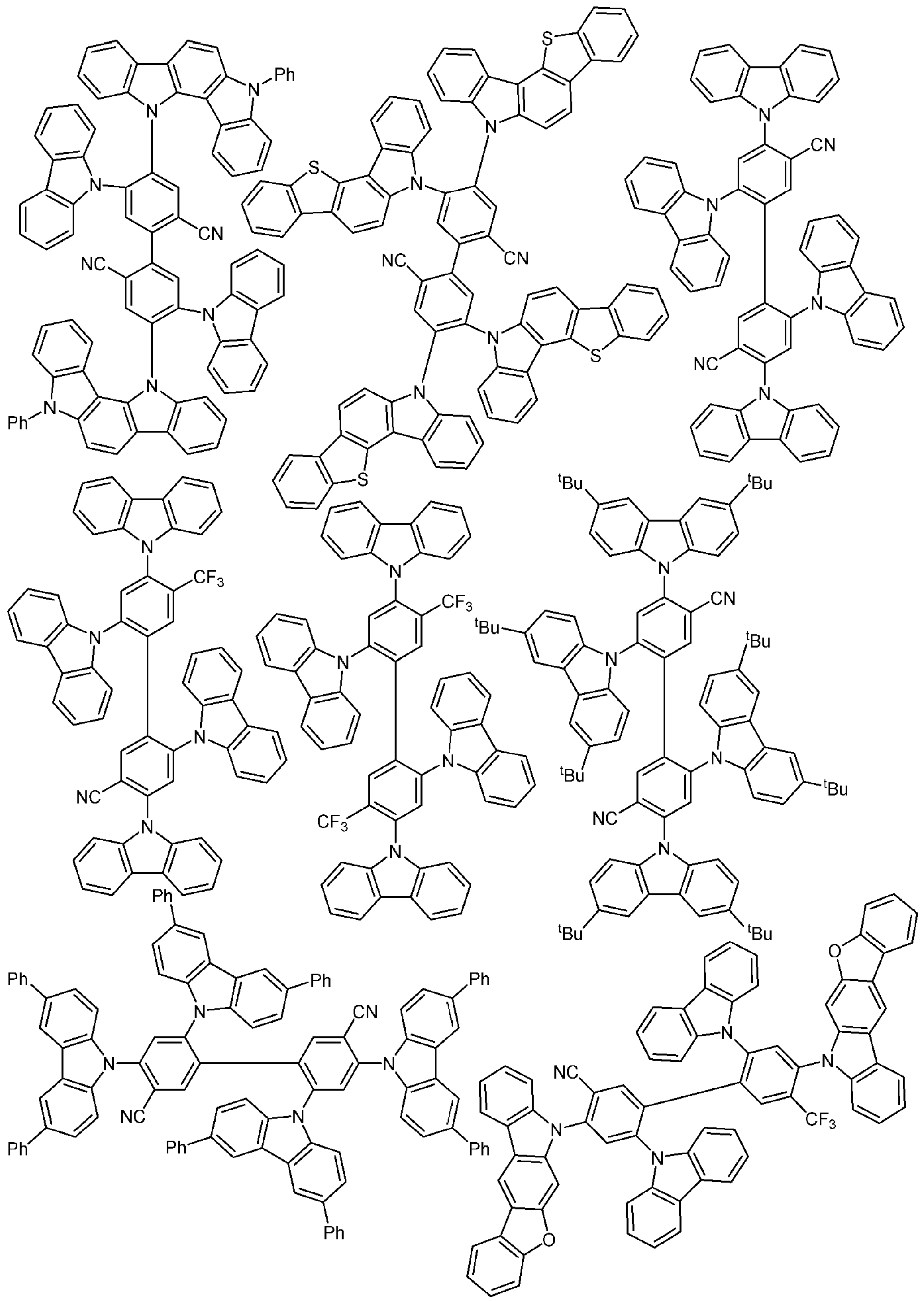

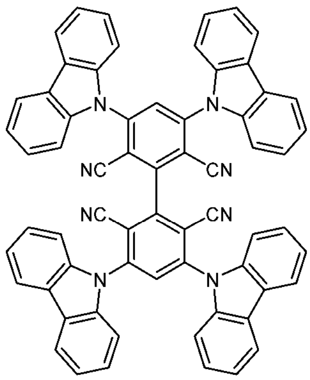 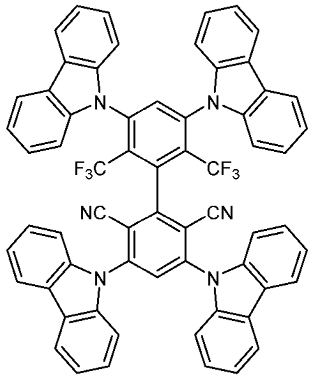 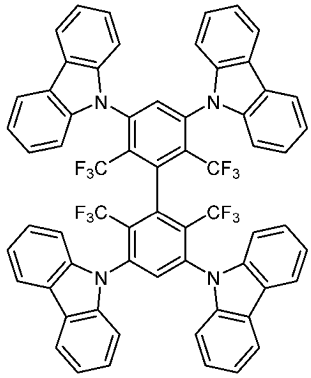

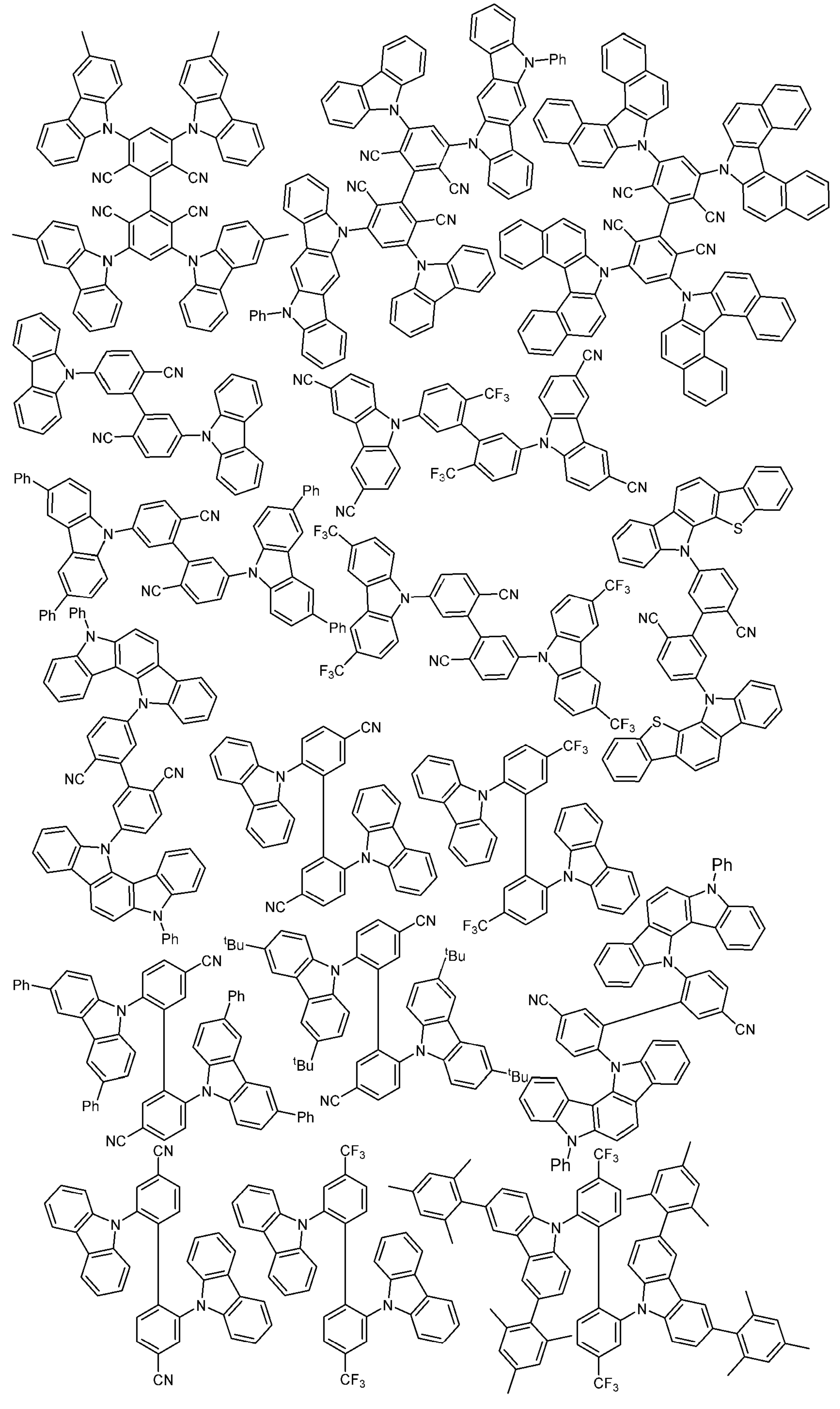

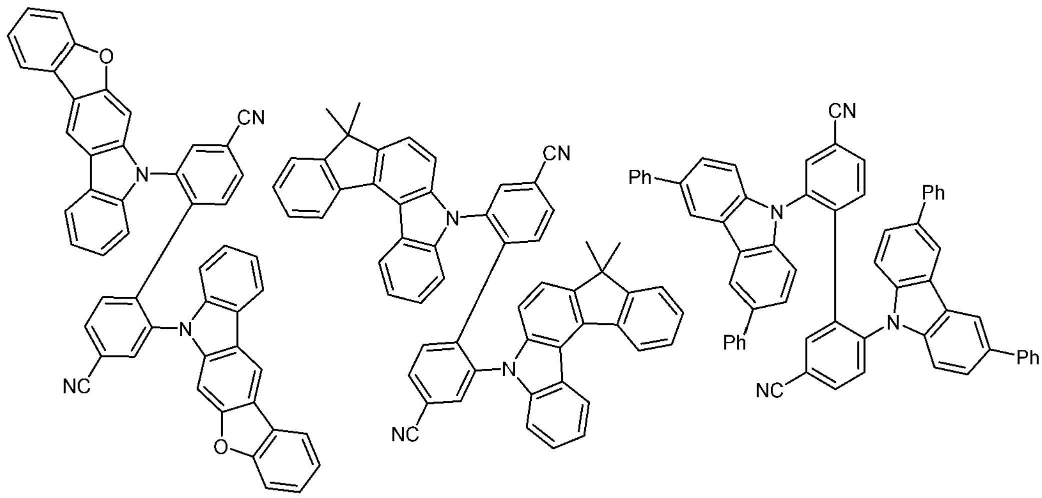

Non-limiting examples of TADF materials $E^B$ according formula $E^B$-III are shown below:

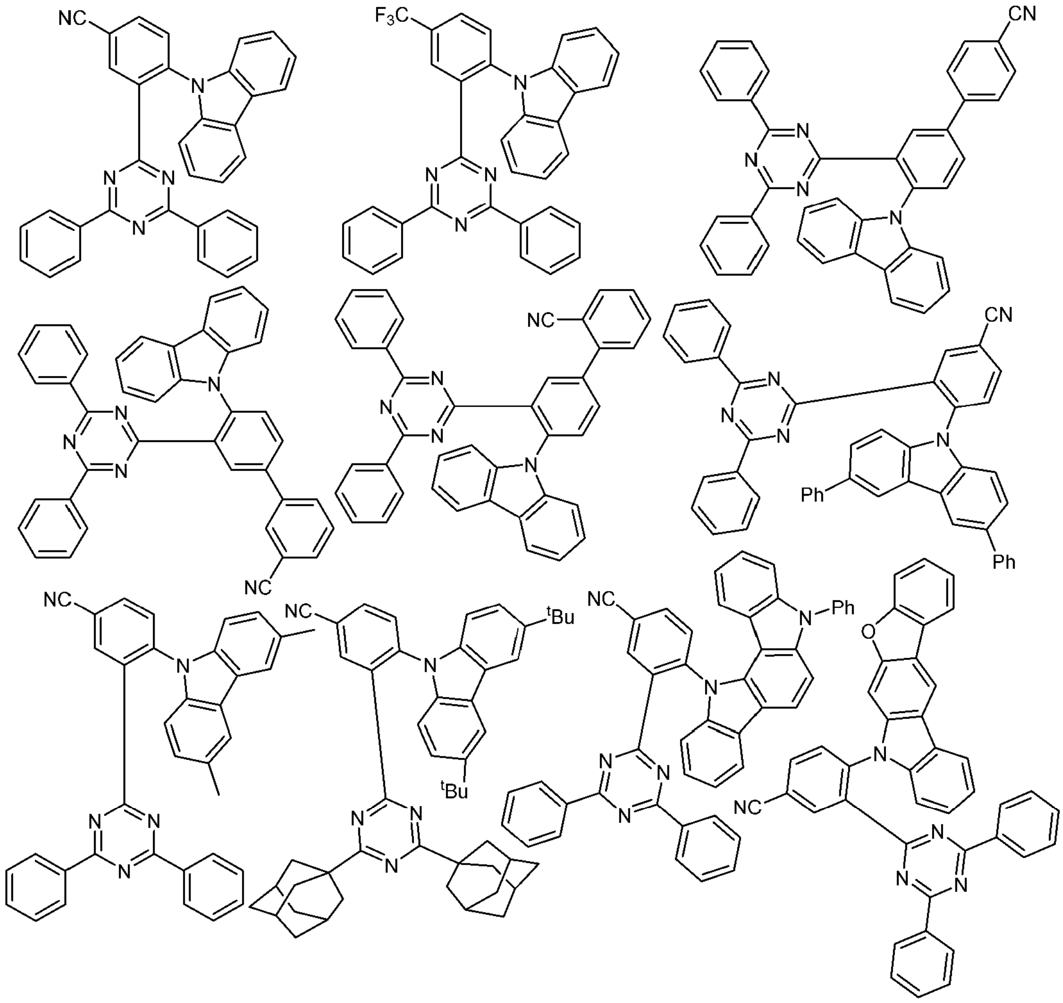

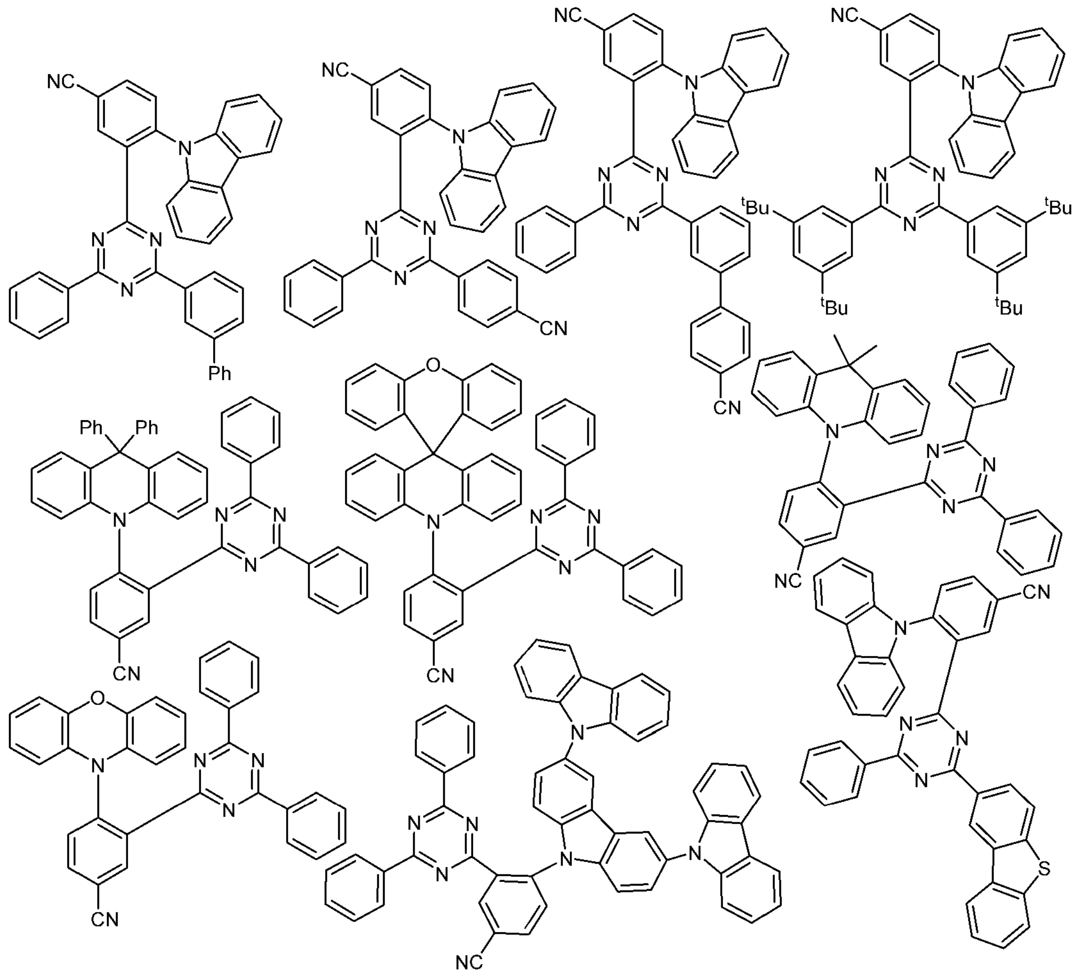

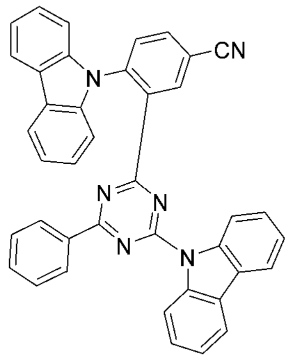

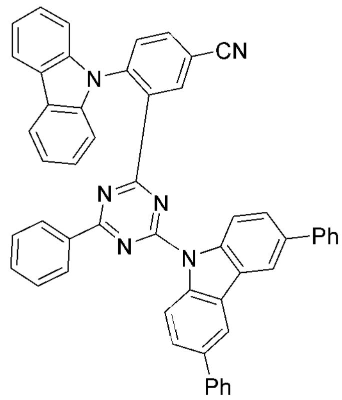

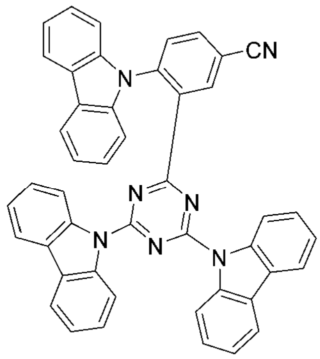

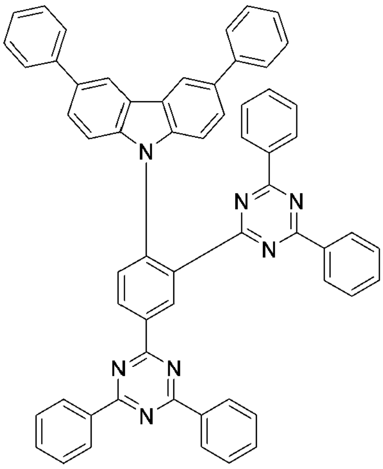

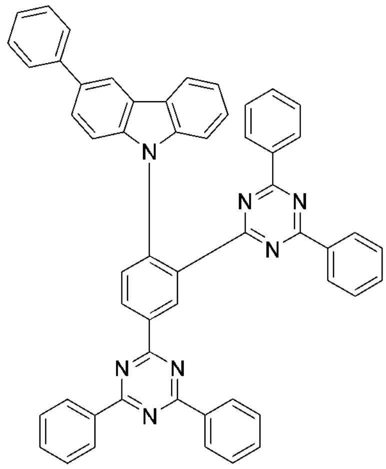

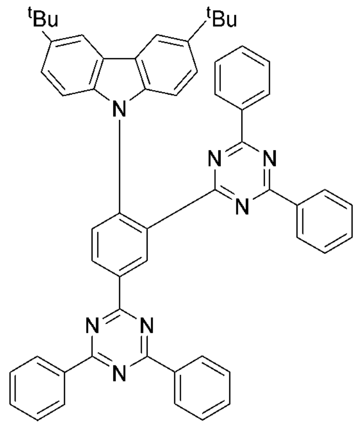

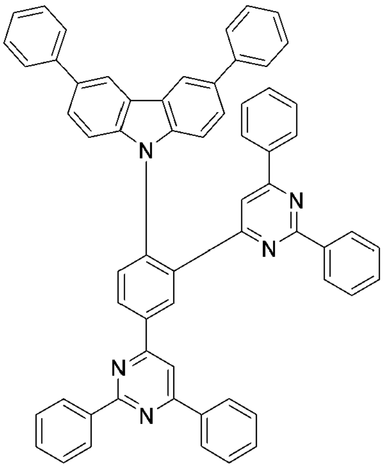

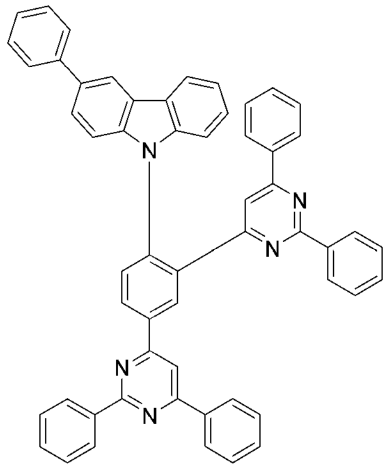

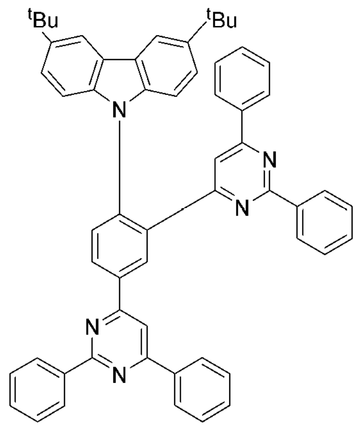

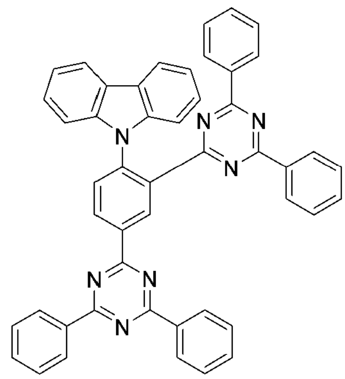

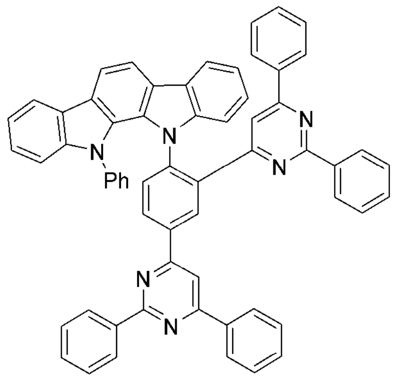

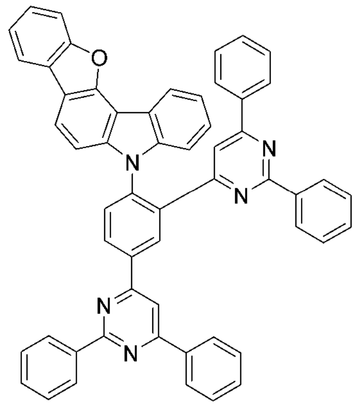

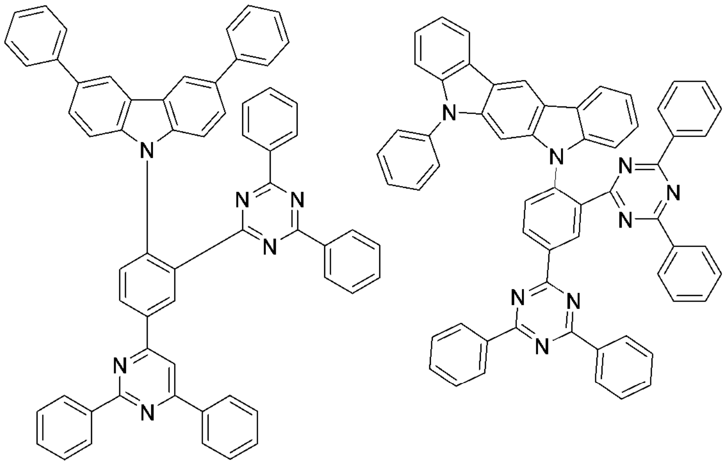

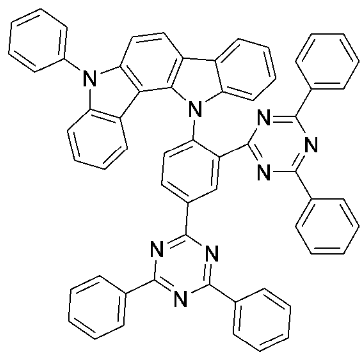

Non-limiting examples of TADF materials $E^B$ according formula $E^B$-IV are shown below:

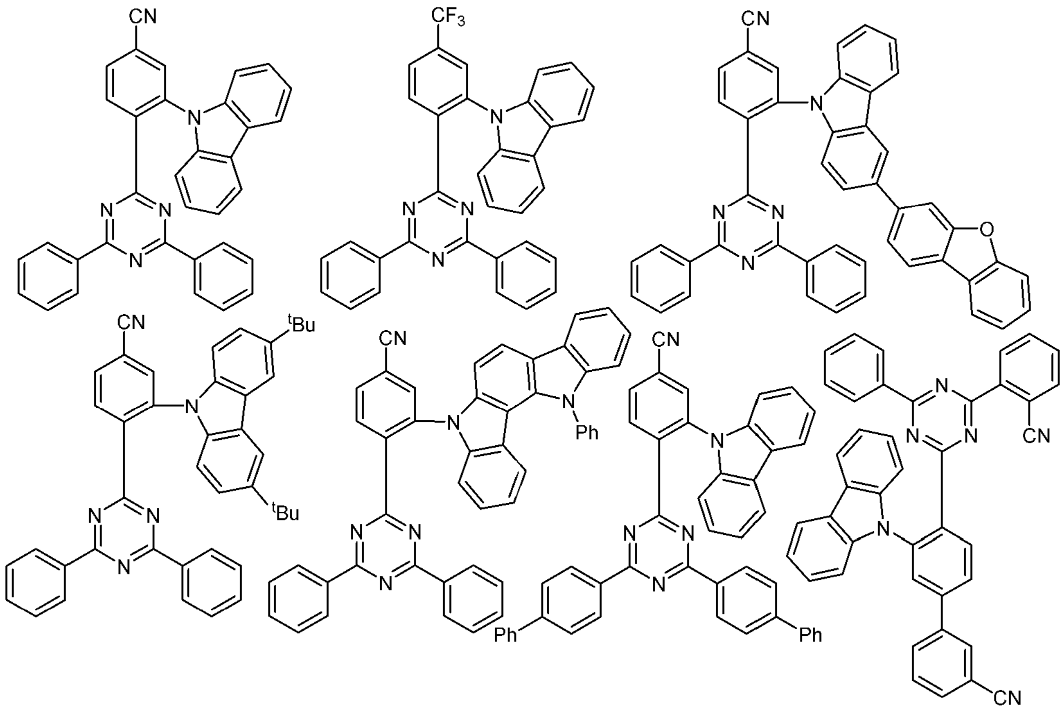

Non-limiting examples of TADF materials $E^B$ according formula $E^B$-V are shown below:

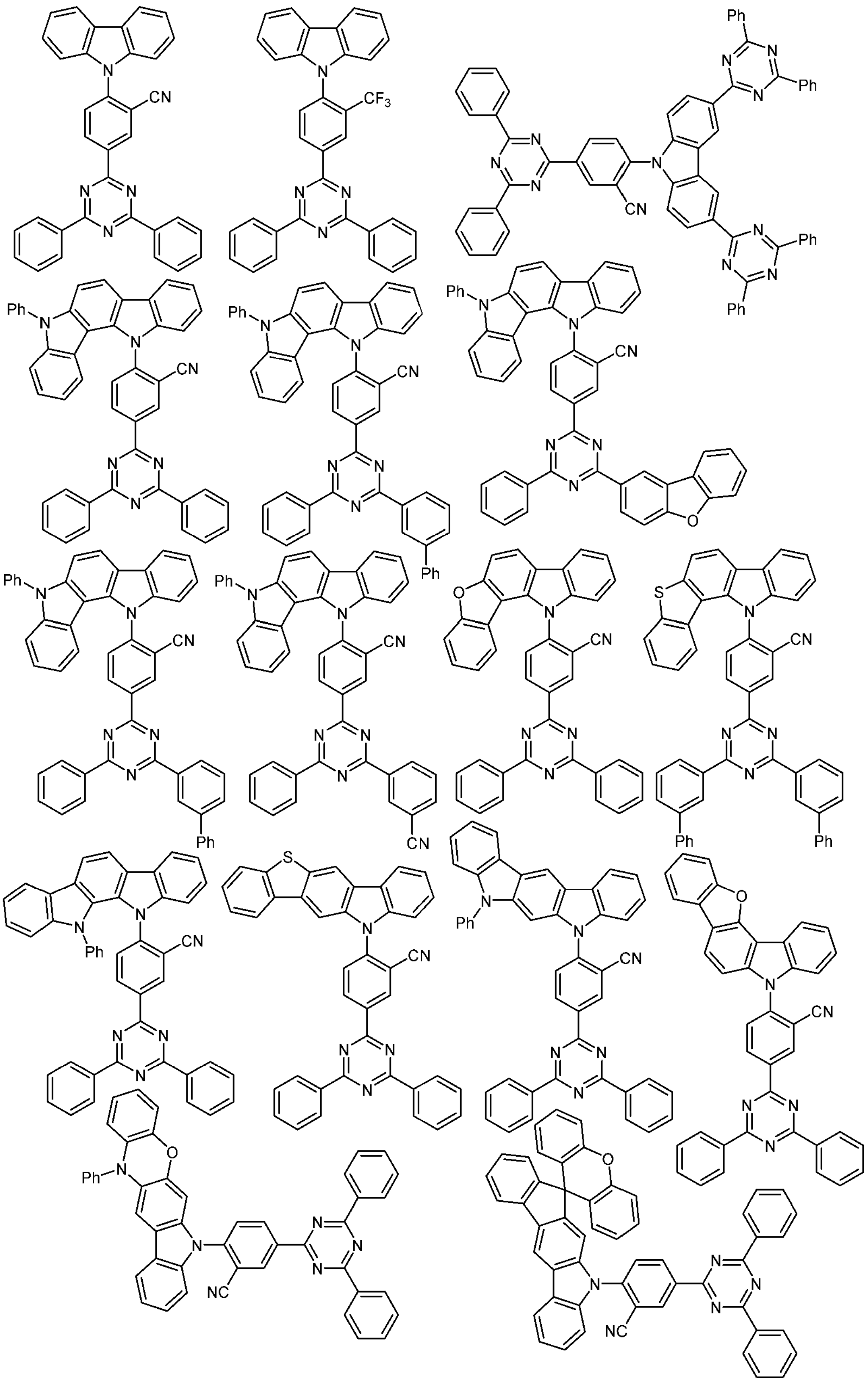

Non-limiting examples of TADF materials $E^B$ according formula $E^B$-VI are shown below:

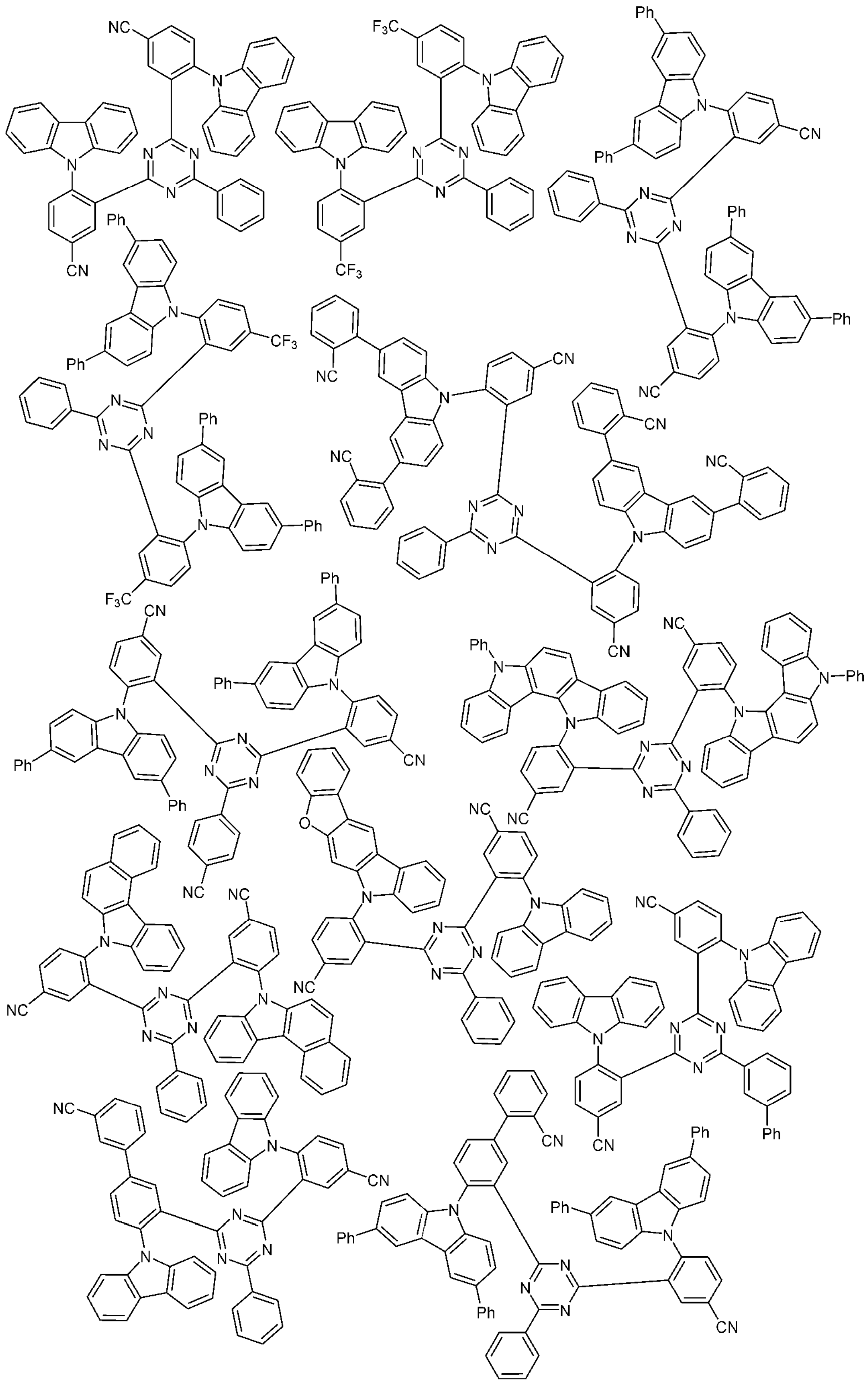

Non-limiting examples of TADF materials $E^B$ according formula $E^B$-VII are shown below:

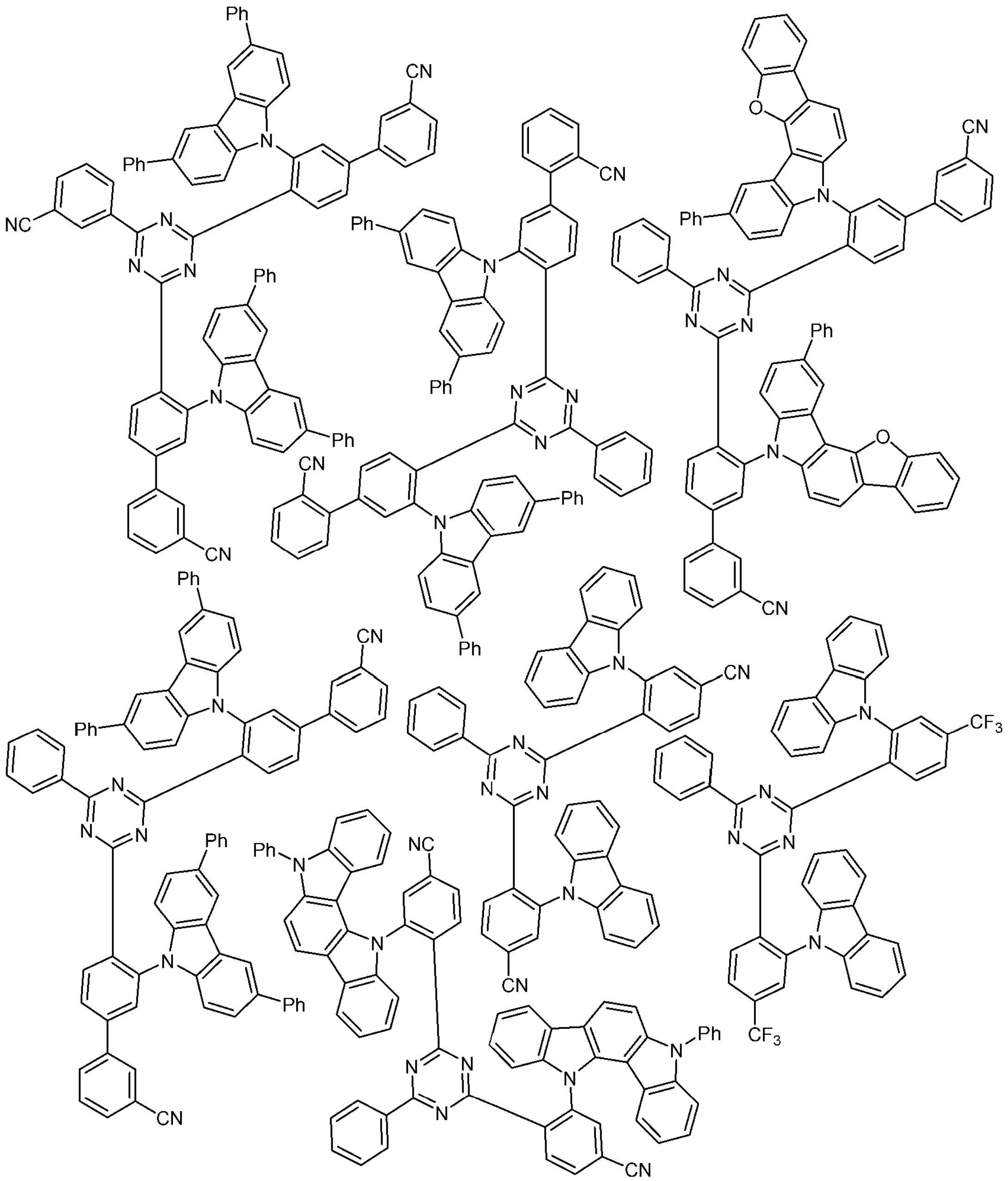

Non-limiting examples of TADF materials $E^B$ according formula $E^B$-VIII are shown below:

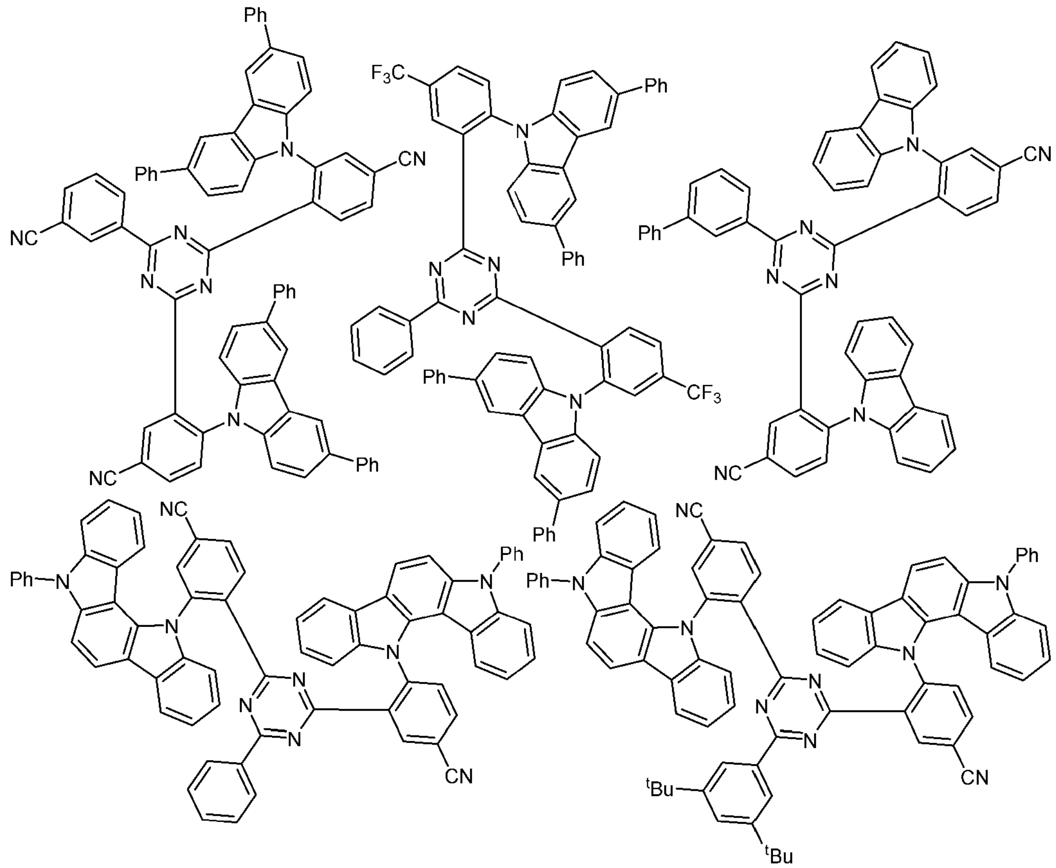

Non-limiting examples of TADF materials $E^B$ according formula $E^B$-IX are shown below:

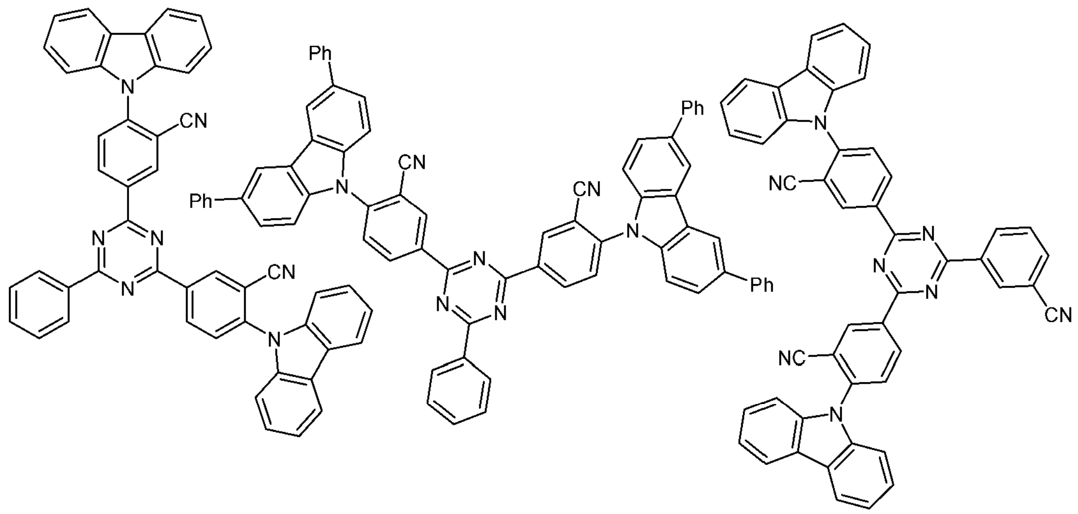

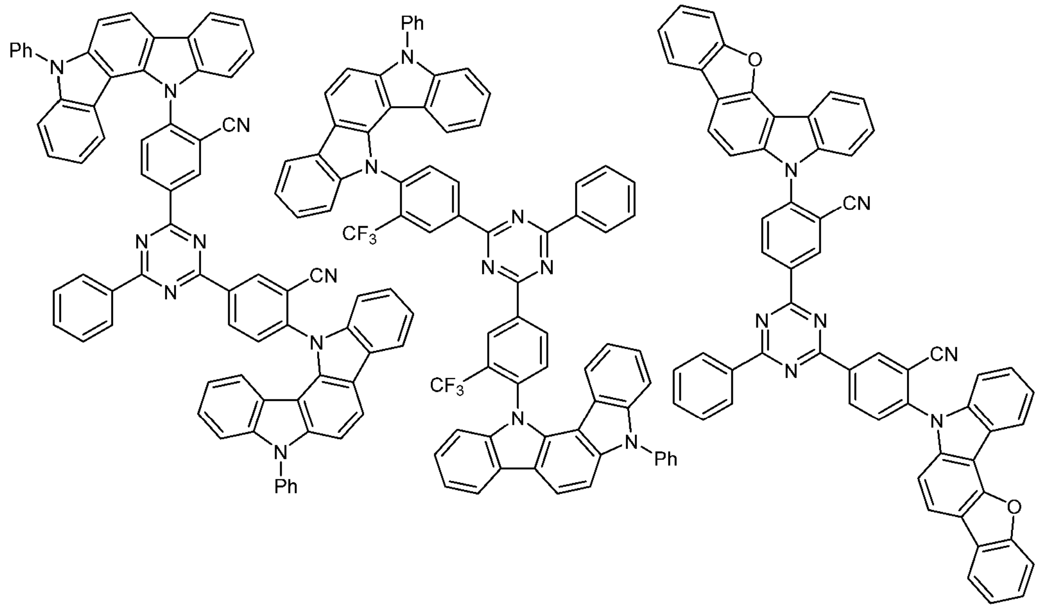

Non-limiting examples of TADF materials $E^B$ according formula $E^B$-X are shown below:

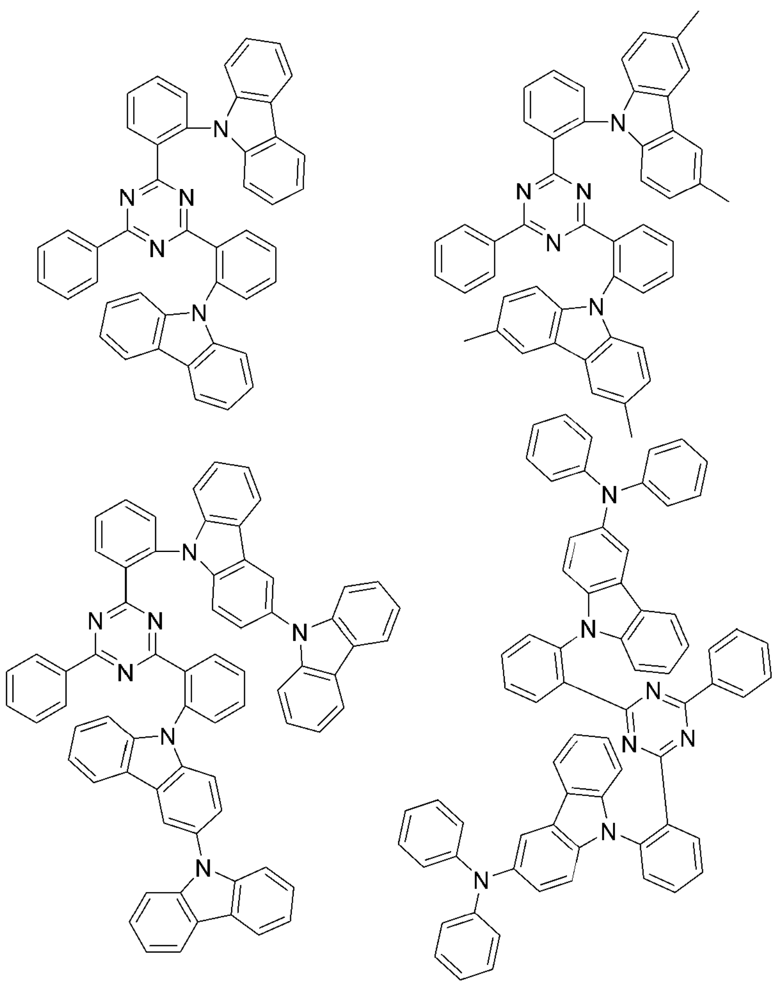

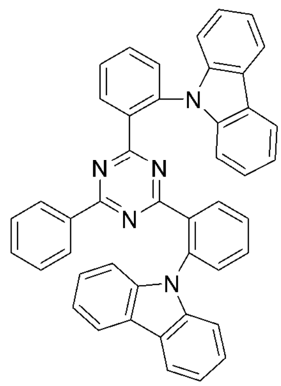

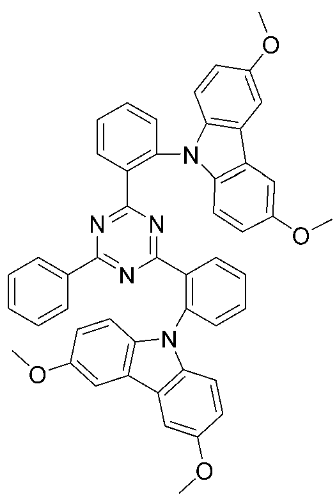

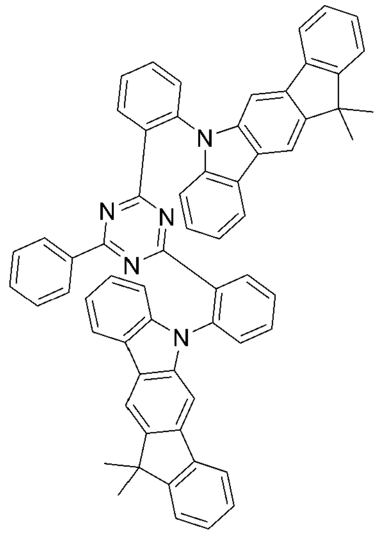

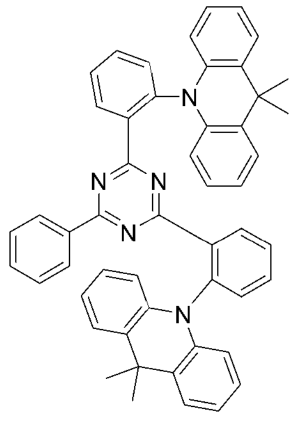

Non-limiting examples of TADF materials $E^B$ according formula $E^B$-XI are shown below:

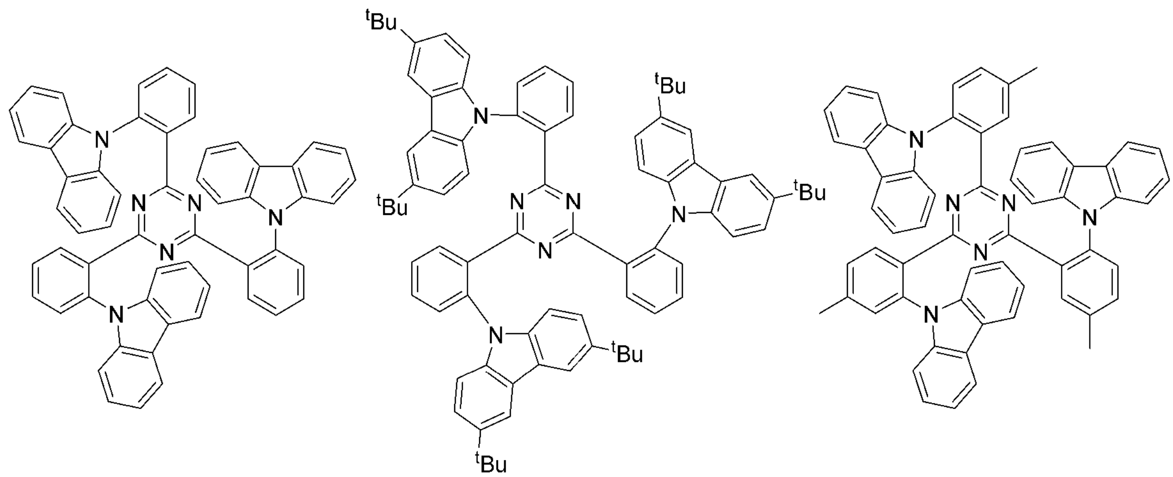

The synthesis of TADF materials $E^B$ can be accomplished via standard reactions and reaction conditions known to the skilled artisan. Typically, in a first step, a coupling reaction, preferably a palladium-catalyzed coupling reaction, may be performed, which is exemplarily shown below for the synthesis of TADF materials $E^B$ according to any of formulas $E^B$-III, $E^B$-IV, and $E^B$-V:

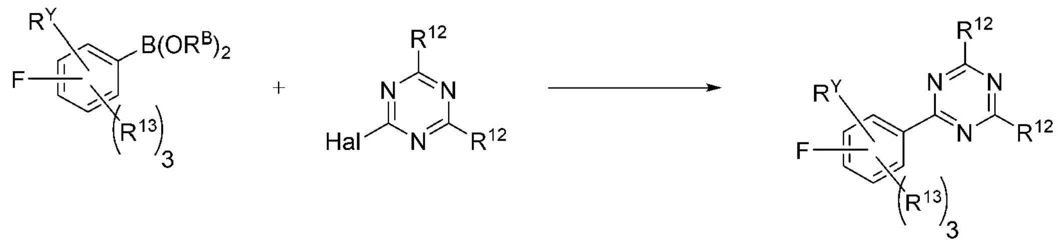

**E1** **E2** **E3**

**E1** can be any boronic acid ($R^B$=H) or an equivalent boronic acid ester ($R^B$ = alkyl or aryl), in particular two $R^B$ may form a ring to give e.g. boronic acid pinacol esters. As second reactant **E2** is used, wherein Hal refers to halogen and may be I, Br or Cl, but preferably is Br. Reaction conditions of such palladium-catalyzed coupling reactions are known the person skilled in the art, e.g. from WO 2017/005699, and it is known that the reacting groups of **E1** and **E2** can be interchanged as shown below to optimize the reaction yields:

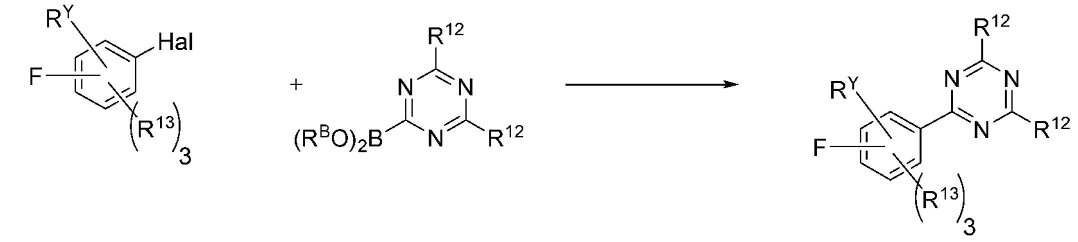

E1 E2 E3

In a second step, the TADF molecules are obtained via the reaction of a nitrogen heterocycle in a nucleophilic aromatic substitution with the aryl halide, preferably aryl fluoride **E3**. Typical conditions include the use of a base, such as tribasic potassium phosphate or sodium hydride, for example, in an aprotic polar solvent, such as dimethyl sulfoxide (DMSO) or N,N-dimethylformamide (DMF), for example.

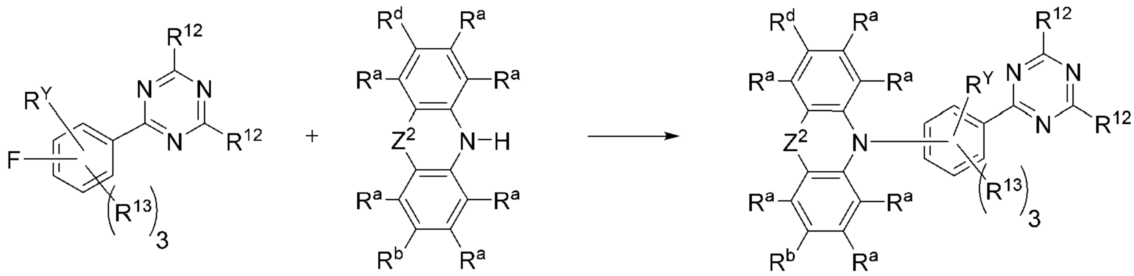

E3 E4

In particular, the donor molecule **E4** may be a 3,6-substituted carbazole (e.g., 3,6-dimethylcarbazole, 3,6-diphenylcarbazole, 3,6-di-*tert*-butylcarbazole), a 2,7-substituted carbazole (e.g., 2,7-dimethylcarbazole, 2,7-diphenylcarbazole, 2,7-di-*tert*-butylcarbazole), a 1,8-substituted carbazole (e.g., 1,8-dimethylcarbazole, 1,8-diphenylcarbazole, 1,8-di-*tert*-butylcarbazole), a 1-substituted carbazole (e.g., 1-methylcarbazole, 1-phenylcarbazole, 1-*tert*-butylcarbazole), a 2-substituted carbazole (e.g., 2-methylcarbazole, 2-phenylcarbazole, 2-*tert*-butylcarbazole), or a 3-substituted carbazole (e.g., 3-methylcarbazole, 3-phenylcarbazole, 3-*tert*-butylcarbazole).
Alternatively, a halogen-substituted carbazole, particularly 3-bromocarbazole, can be used as **E4**.
In a subsequent reaction, a boronic acid ester functional group or boronic acid functional group may be exemplarily introduced at the position of the one or more halogen substituents, which was introduced via **E4**, to yield for example the corresponding carbazolyl-boronic acid or ester such as a carbazol-3-yl-boronic acid ester or carbazol-3-yl-boronic acid, e.g., via the reaction with bis(pinacolato)diboron (CAS No. 73183-34-3). Subsequently, one or more substituents $R^a$, $R^b$ or $R^d$ may be introduced in place of the boronic acid ester group or the boronic acid group via a coupling reaction with the corresponding halogenated reactant, e.g. $R^a$-Hal, preferably $R^2$-Cl and $R^a$-Br.
Alternatively, one or more substituents $R^a$, $R^b$ or $R^d$ may be introduced at the position of the one or more halogen substituents, which was introduced via D-H, via the reaction with a boronic acid of the substituent $R^a$ [$R^a$-$B(OH)_2$], $R^b$ [$R^b$-$B(OH)_2$] or $R^d$ [$R^d$-$B(OH)_2$] or a corresponding boronic acid ester.
Further TADF materials $E^B$ may be obtained analogously. A TADF material $E^B$ may also be obtained by any alternative synthesis route suitable for this purpose.
An alternative synthesis route may comprise the introduction of a nitrogen heterocycle via copper- or palladium-catalyzed coupling to an aryl halide or aryl pseudohalide, preferably an aryl bromide, an aryl iodide, aryl triflate or an aryl tosylate.

*Phosphorescence material(s) $P^B$*

The phosphorescence materials $P^B$ in the context of the present invention utilize the intramolecular spin-orbit interaction (heavy atom effect) caused by metal atoms to obtain light emission from triplets (i.e. excited triplet states, typically the lowermost excited triplet state T1). This is to say that a phosphorescence material $P^B$ is capable of emitting phosphorescence at room temperature (i.e. (approximately 20 °C), which is typically measured from a spin-coated film of the respective $P^B$ in poly(methyl methacrylate) (PMMA) with a concentration of 10% by weight of $P^B$.
It is to be noted that, although being per definition capable of emitting phosphorescence, a phosphorescence

material $P^B$ optionally comprised in the organic electroluminescent device of the invention as excitation energy transfer component EET-1 or EET-2 preferably mainly functions as "energy pump" and not as emitter material. This is to say that a phosphorescence material $P^B$ comprised in a light-emitting layer B preferably mainly transfers excitation energy to one or more small FWHM emitters $S^B$ that in turn serve as the main emitter material(s). The main function of a phosphorescence material $P^B$ in a light-emitting layer B is preferably not the emission of light. However, it may emit light to some extent.

Generally, it is understood, that all phosphorescent complexes that are used in organic electroluminescent devices in the state of the art may also be used in an organic electroluminescent device according to the present invention.

It is common knowledge to those skilled in the art that phosphorescence materials $P^B$ used in organic electroluminescent devices are oftentimes complexes of Ir, Pt, Au, Os, Eu, Ru, Re, Ag and Cu, in the context of this invention preferably of Ir, Pt, and Pd, more preferably of Ir and Pt. The skilled artisan knows which materials are suitable as phosphorescence materials in organic electroluminescent devices and how to synthesize them. Furthermore, the skilled artisan is familiar with the design principles of phosphorescent complexes for use in organic electroluminescent devices and knows how to tune the emission of the complexes by means of structural variations.

See for example: C.-L. Ho, H. Li, W.-Y. Wong, Journal of Organometallic Chemistry 2014, 751, 261, DOI: 10.1016/j.jorganchem.2013.09.035; T. Fleetham, G. Li, J. Li, Advanced Science News 2017, 29, 1601861, DOI: 10.1002/adma.201601861; A.R.B.M. Yusoff, A.J. Huckaba, M.K. Nazeeruddin, Topics in Current Chemistry (Z) 2017, 375:39, 1, DOI: 10.1007/s41061-017-0126-7; T.-Y. Li, J. Wuc, Z.-G. Wua, Y.-X. Zheng, J.-L. Zuo, Y. Pan, Coordination Chemistry Reviews 2018, 374, 55, DOI: 10.1016/j.ccr.2018.06.014.

For example, US2020274081 (A1), US20010019782 (A1), US20020034656 (A1), US20030138657 (A1), US2005123791 (A1), US20060065890 (A1), US20060134462 (A1), US20070034863 (A1), US20070111026 (A1), US2007034863 (A1), US2007138437 (A1), US20080020237 (A1), US20080297033 (A1), US2008210930 (A1), US20090115322 (A1), US2009104472 (A1), US20100244004 (A1), US2010105902 (A1), US20110057559 (A1), US2011215710 (A1), US2012292601 (A1), US2013165653 (A1), US20140246656 (A1), US20030068526 (A1), US20050123788 (A1), US2005260449 (A1), US20060127696 (A1), US20060202194 (A1), US20070087321 (A1), US20070190359 (A1), US2007104979 (A1), US2007224450 (A1), US20080233410 (A1), US200805851 (A1), US20090039776 (A1), US20090179555 (A1), US20100090591 (A1), US20100295032 (A1), US20030072964 (A1), US20050244673 (A1), US20060008670 (A1), US20060134459 (A1), US20060251923 (A1), US20070103060 (A1), US20070231600 (A1), US2007104980 (A1), US2007278936 (A1), US20080261076 (A1), US2008161567 (A1), US20090108737 (A1), US2009085476 (A1), US20100148663 (A1), US2010102716 (A1), US2010270916 (A1), US20110204333 (A1), US2011285275 (A1), US2013033172 (A1), US2013334521 (A1), US2014103305 (A1), US2003068536 (A1), US2003085646 (A1), US2006228581 (A1), US2006197077 (A1), US2011114922 (A1), US2011114922 (A1), US2003054198 (A1), and EP2730583 (A1) disclose phosphorescence materials that may be used as phosphorescence materials $P^B$ in the context of the present invention. It is understood that this does not imply that the present invention is limited to organic electroluminescent devices comprising a phosphorescence materials described in one of the named references.

As laid out in US2020274081 (A1), examples of phosphorescent complexes for use in organic electroluminescent devices such as those of the present invention include the complexes shown below. Again, it is understood that the present invention is not limited to these examples.

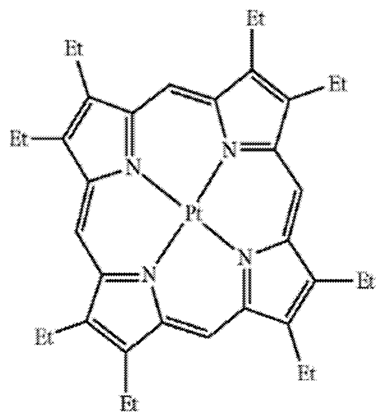

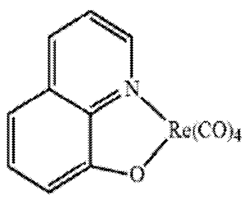

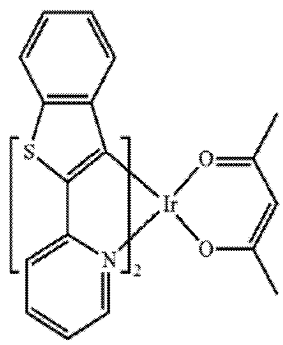

,

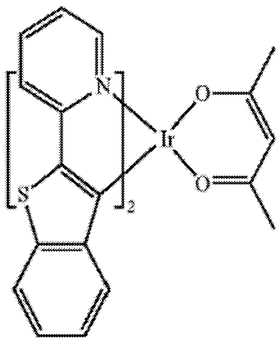

,

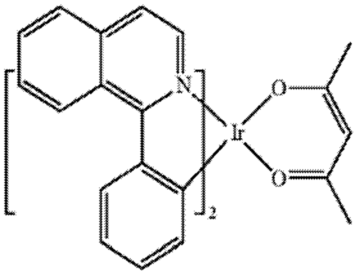

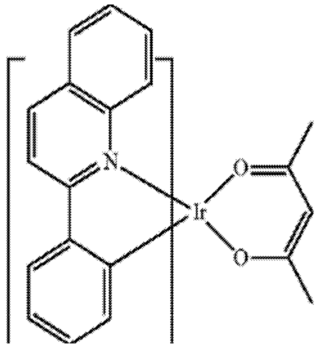

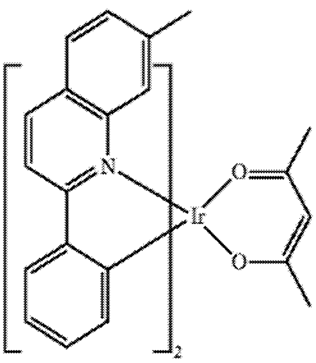

,

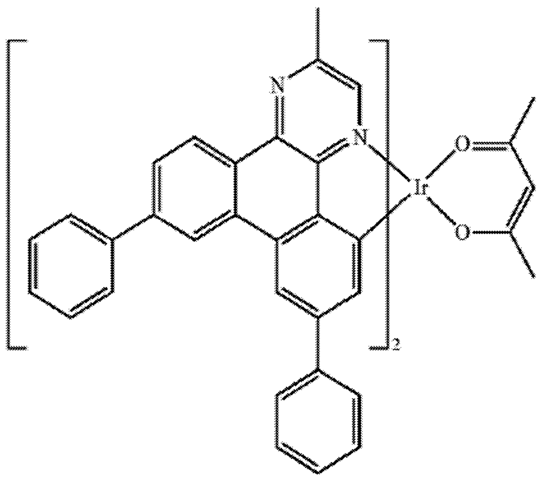

,

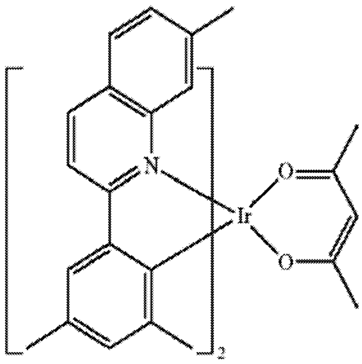

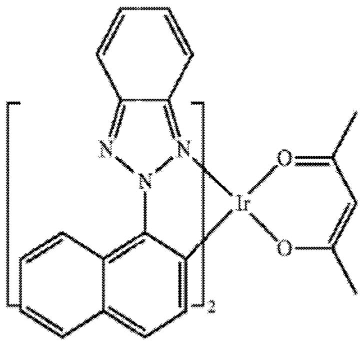

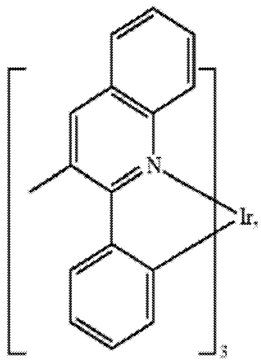

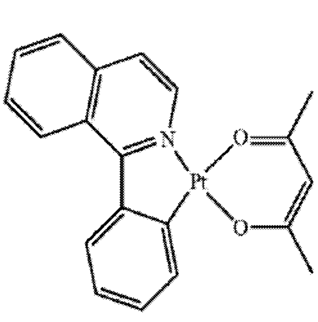

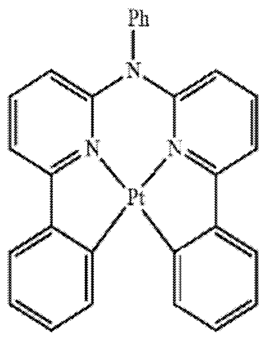

,

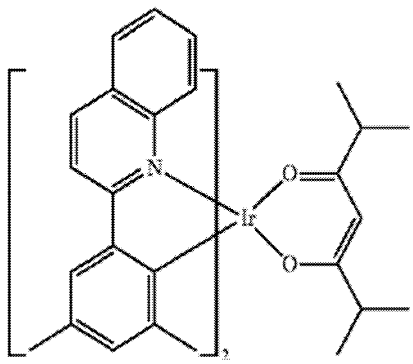

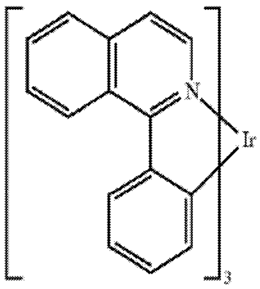

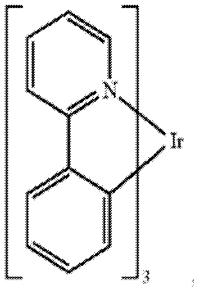

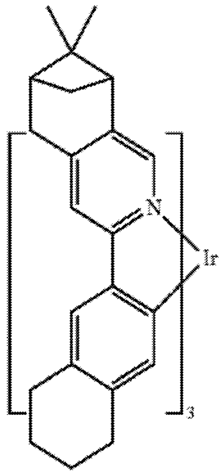

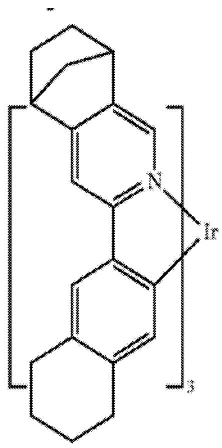

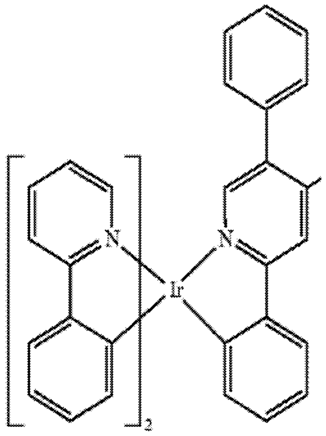

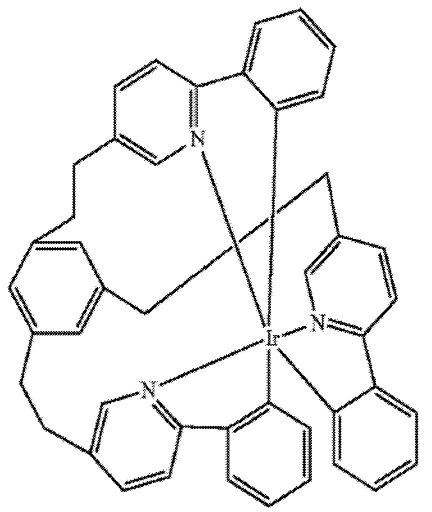

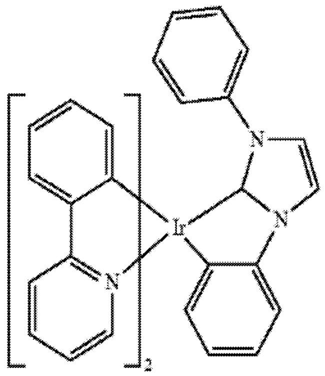

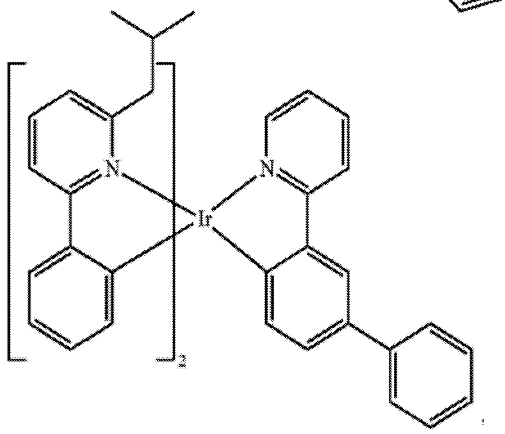

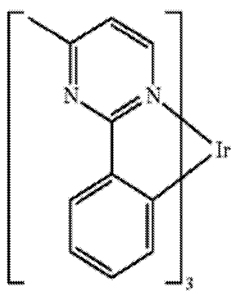

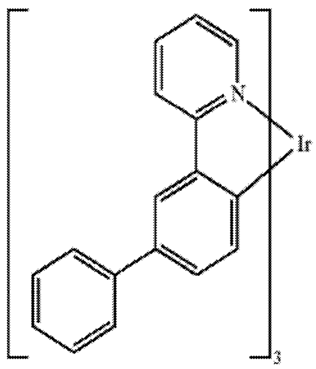

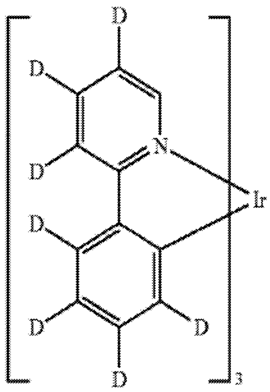
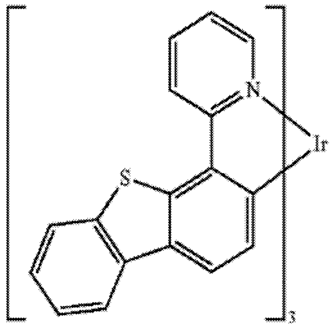
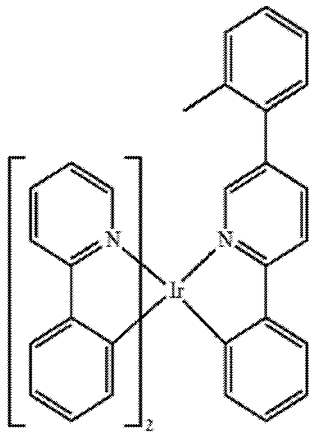
,

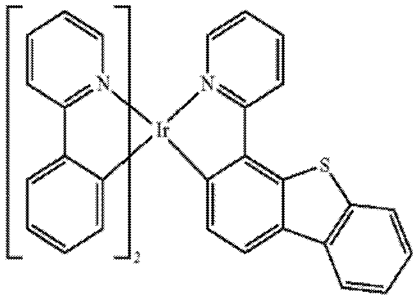
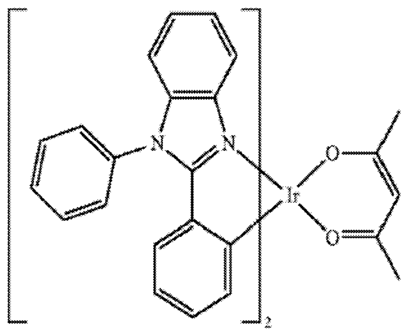
,
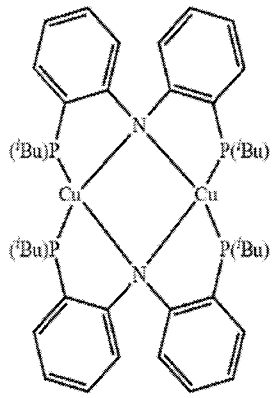
,

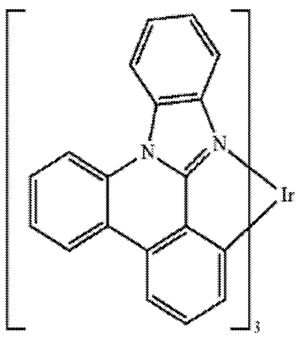
,
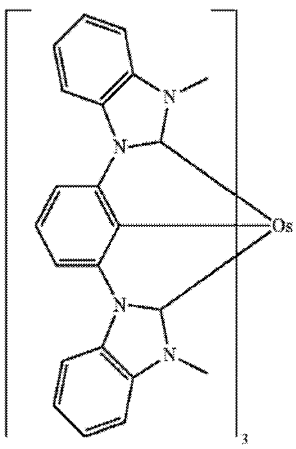
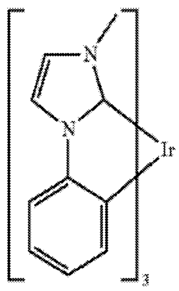
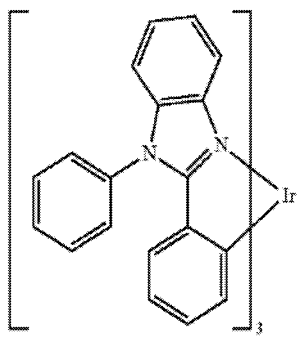

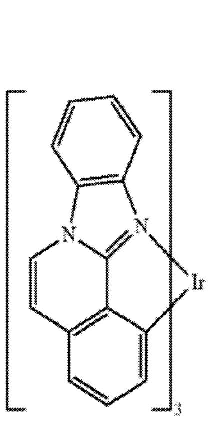
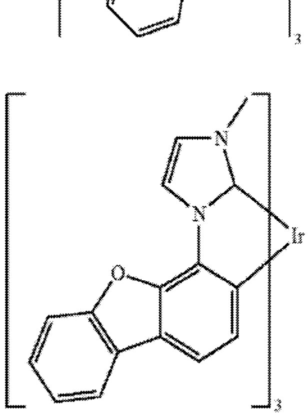
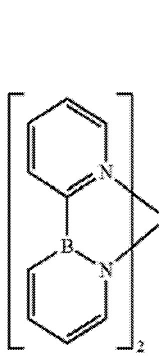
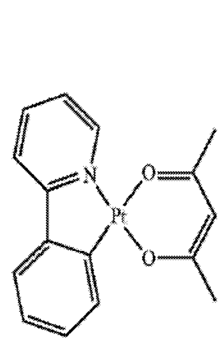
,

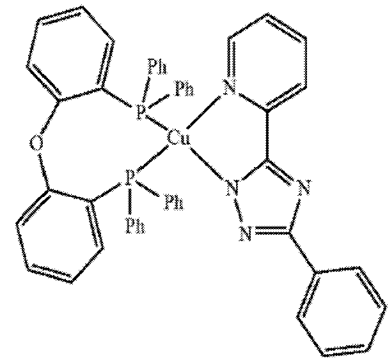

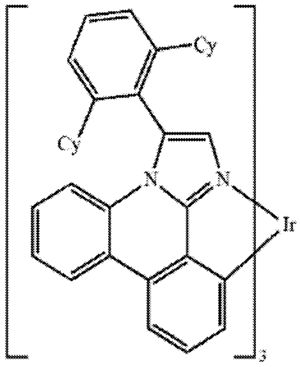

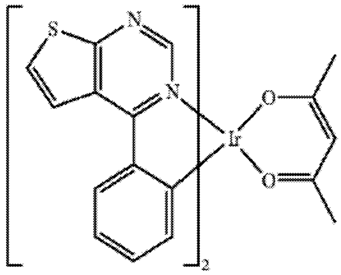

,

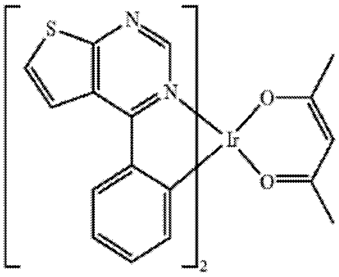

,

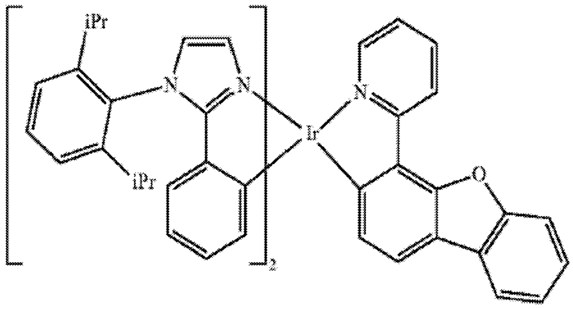

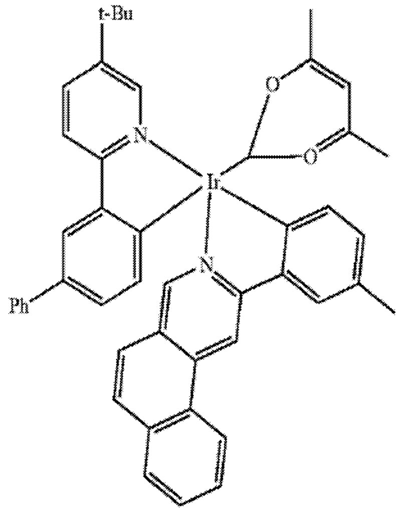

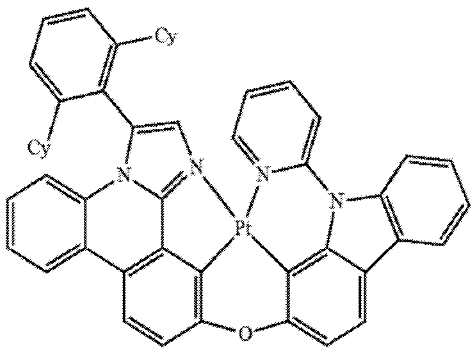

,

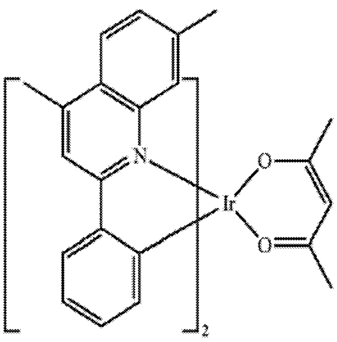

,

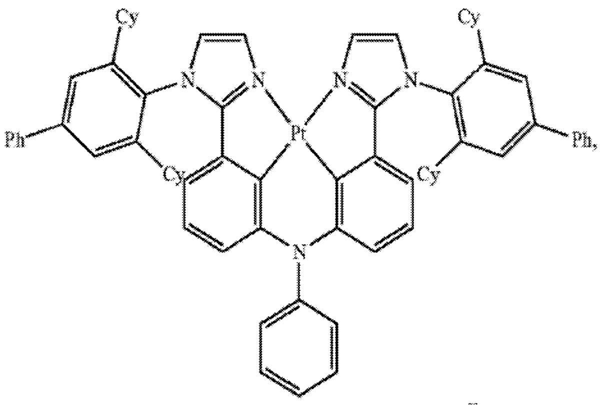

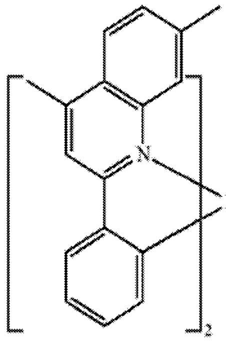,

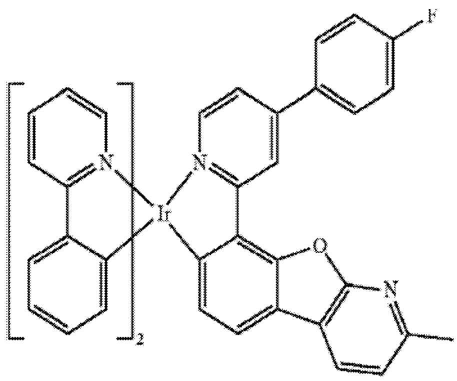,

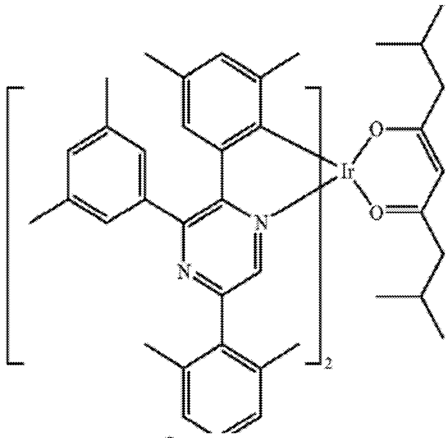,

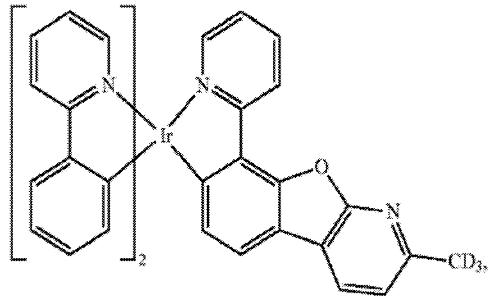,

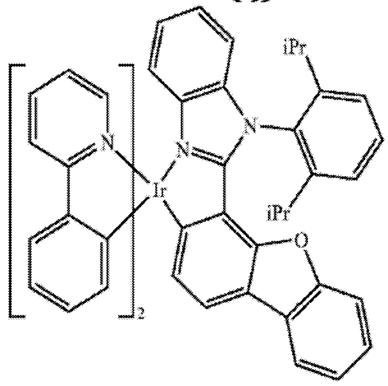

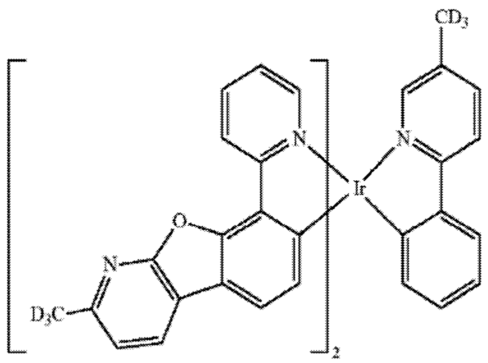

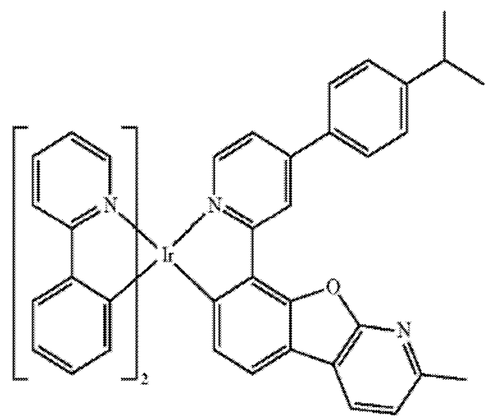,

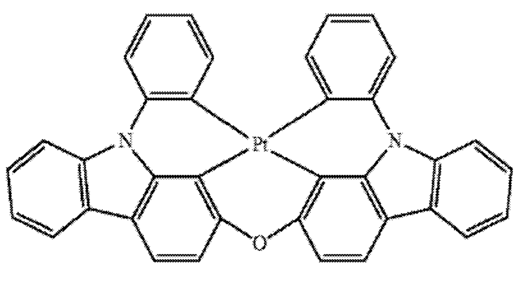,

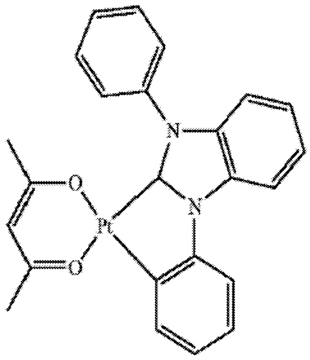

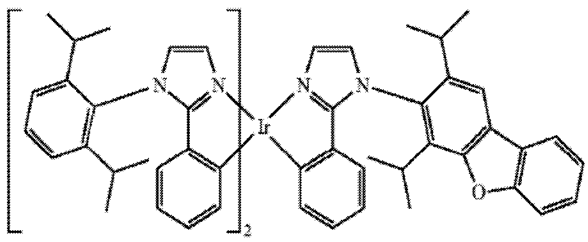

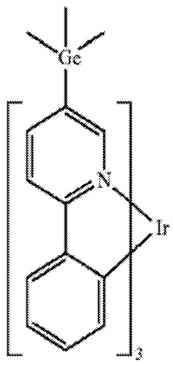 ,

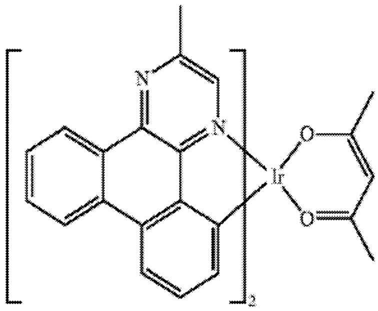 ,

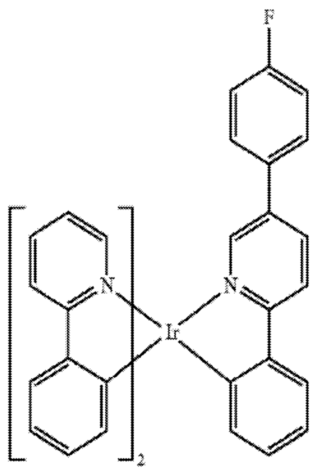 ,

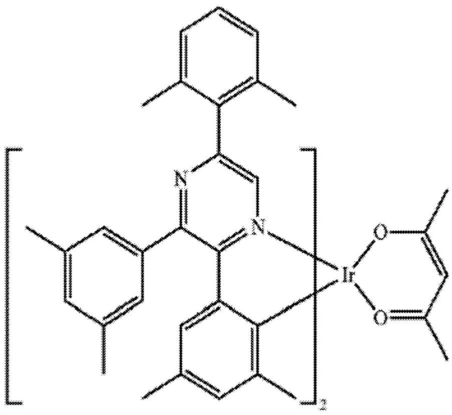 ,

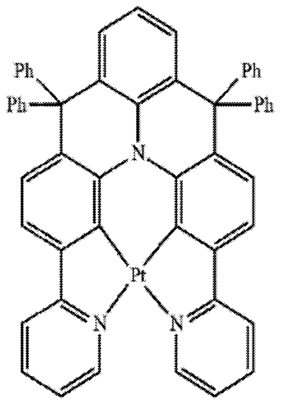 ,

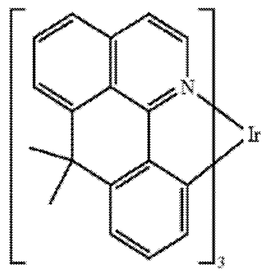

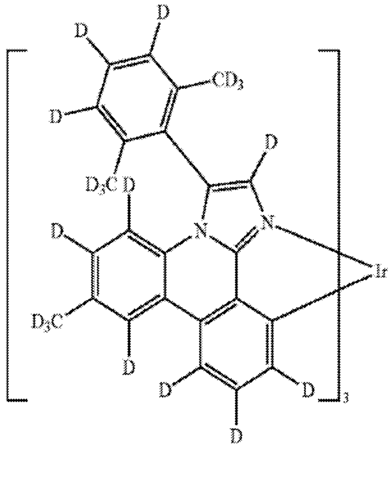

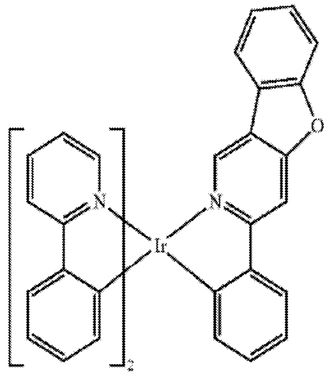 ,

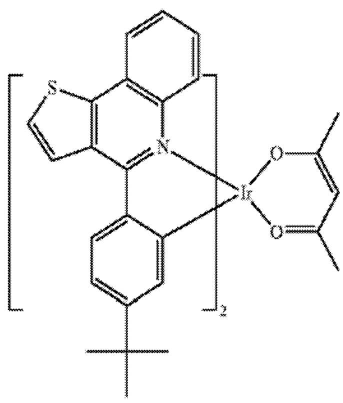 ,

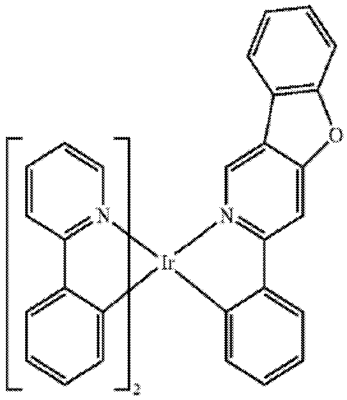
,
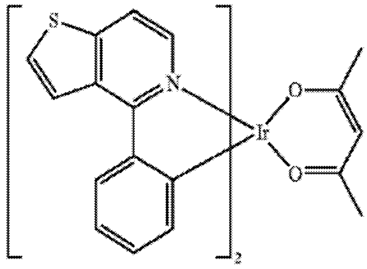
,
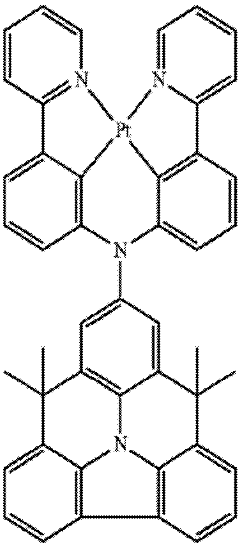
,
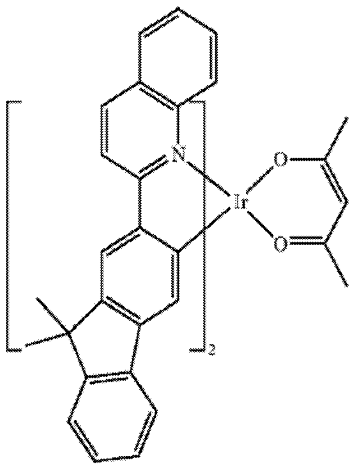
,
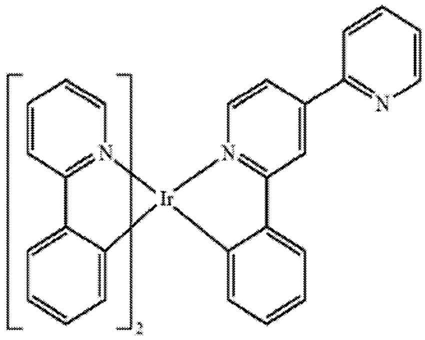
,
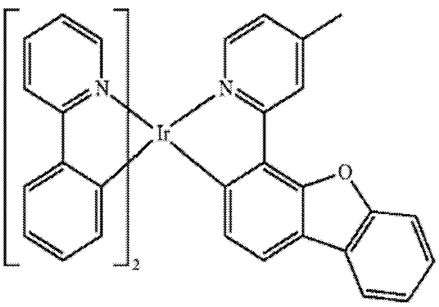
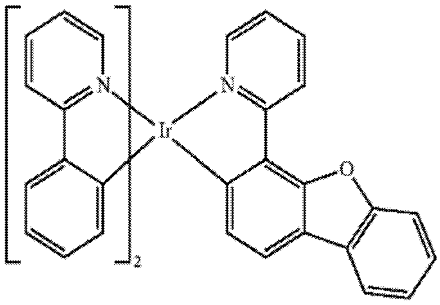

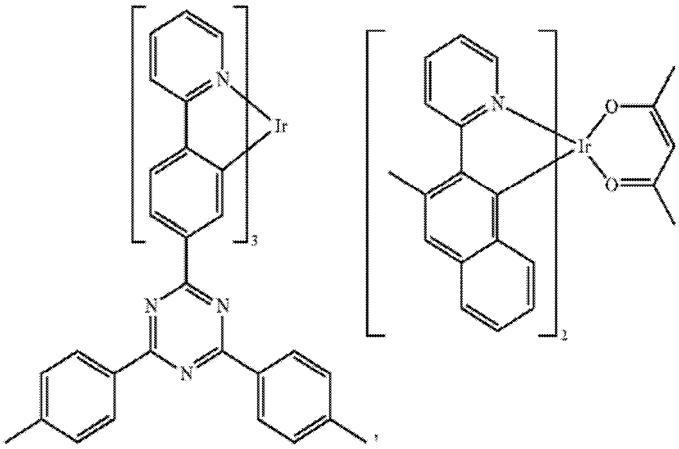
,
,
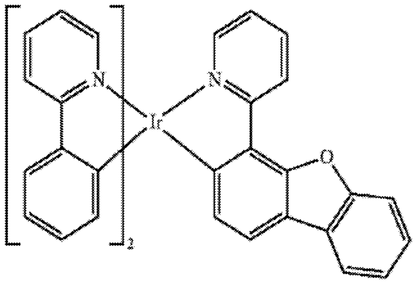

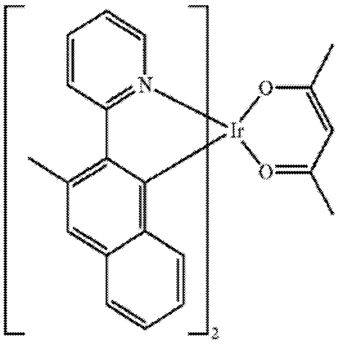
,
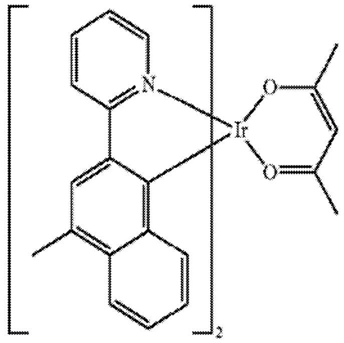
,
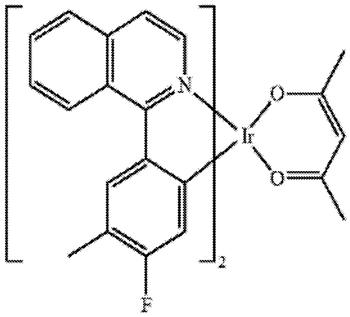
,

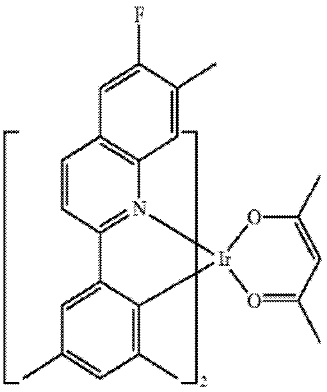
,
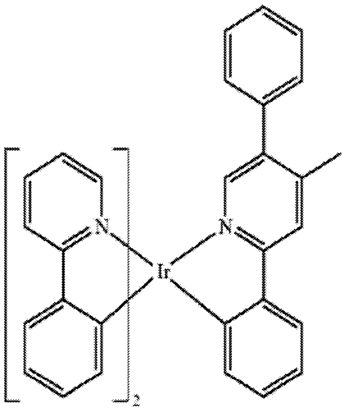

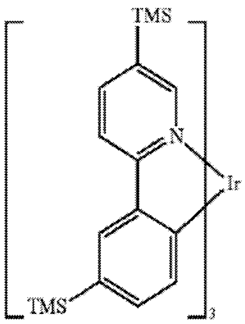
,

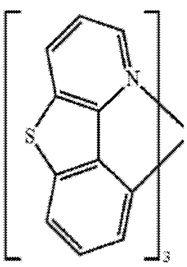
,
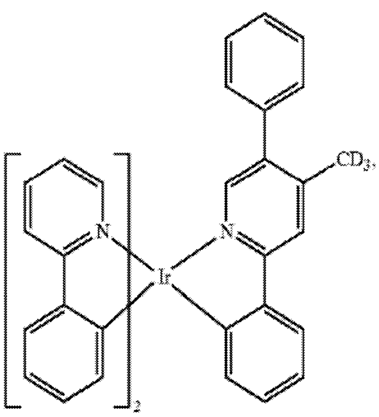
,
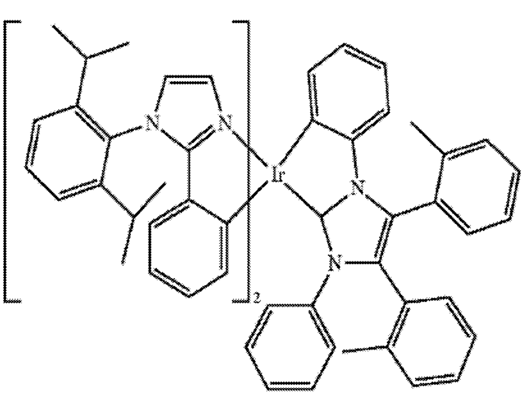

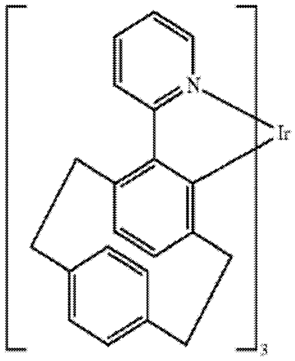

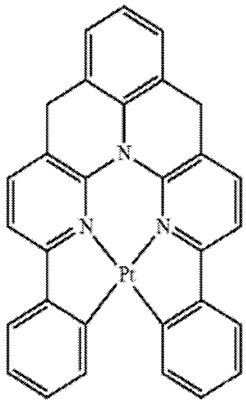
,

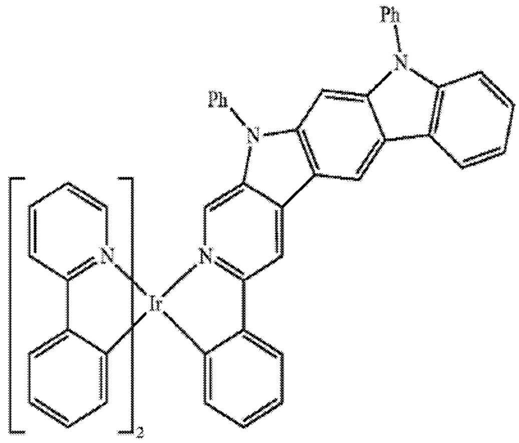

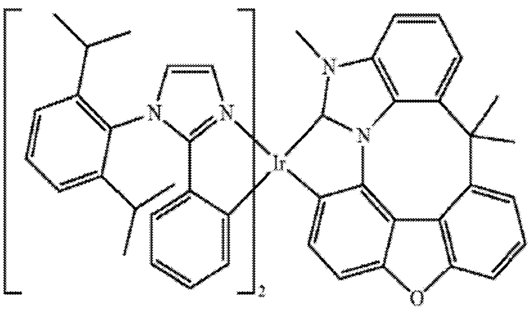

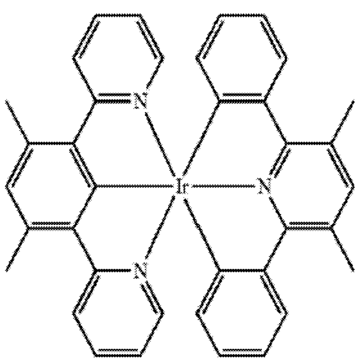
,

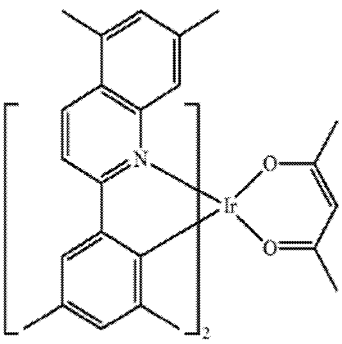
,

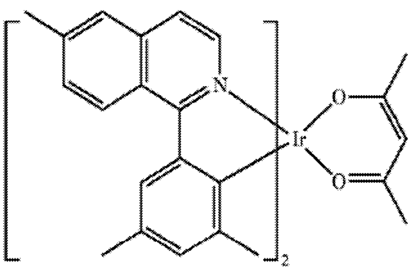

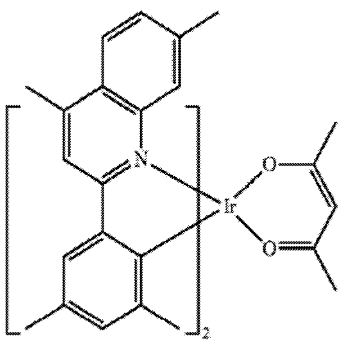
,

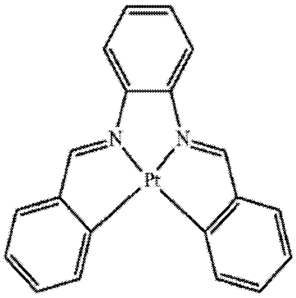,
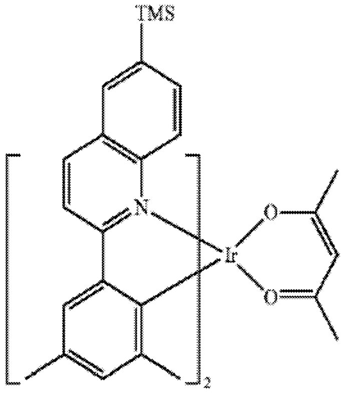
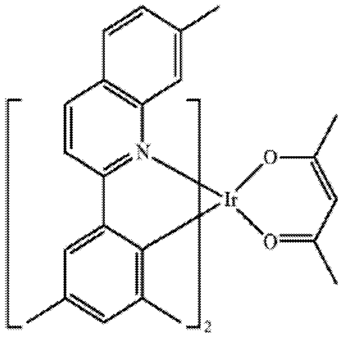
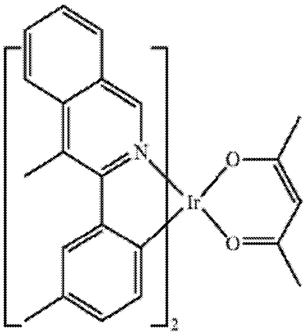,
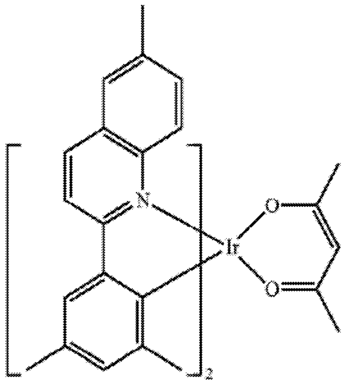,
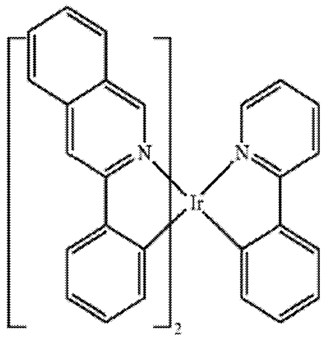,
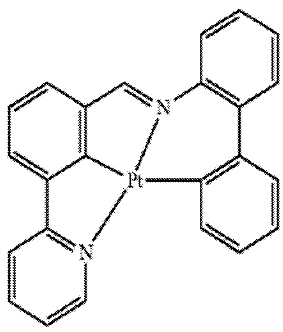,
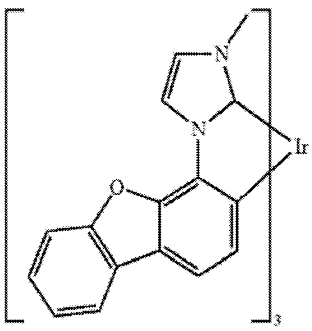
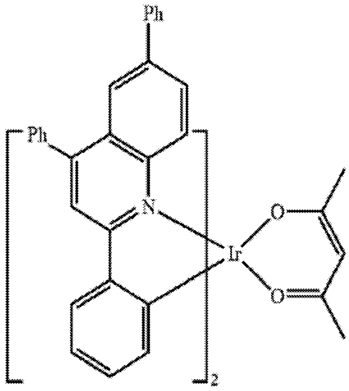,
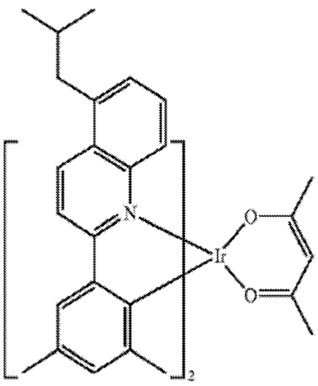,
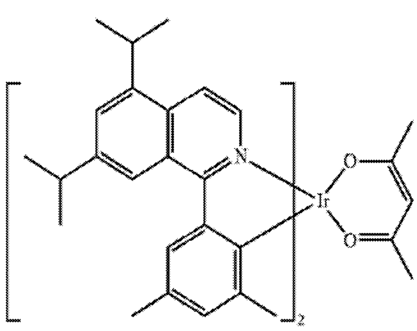,
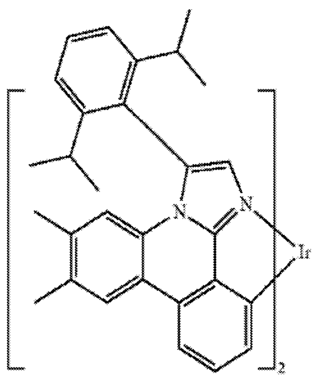

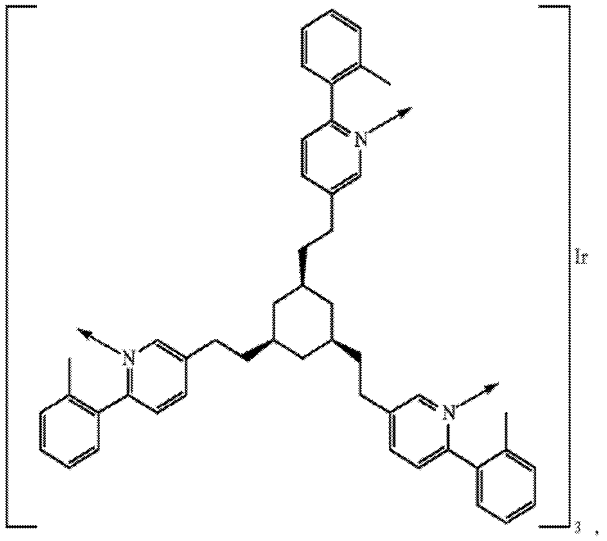

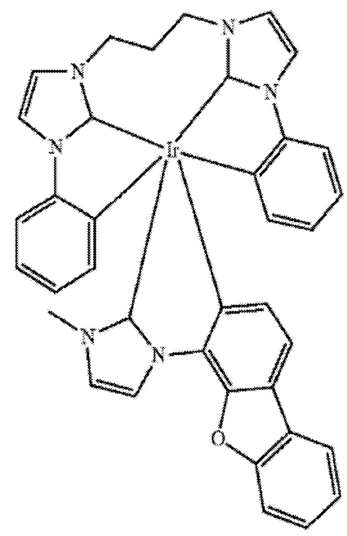

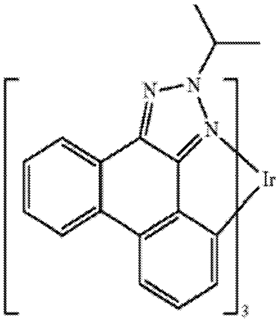

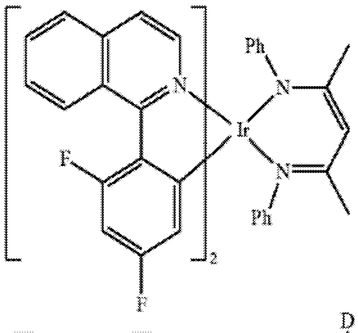

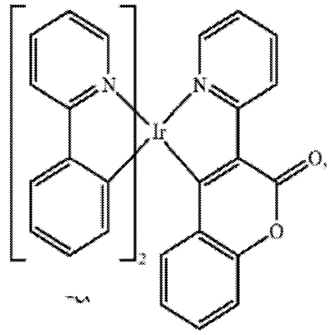

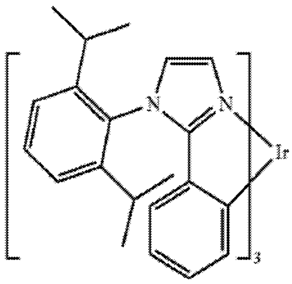

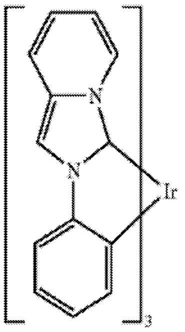

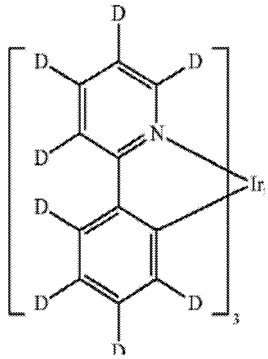

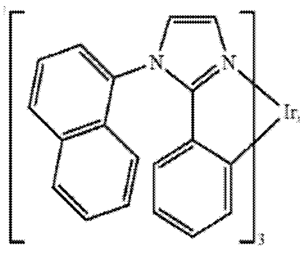

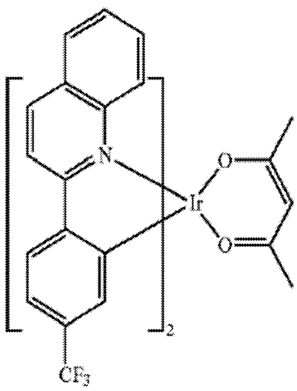

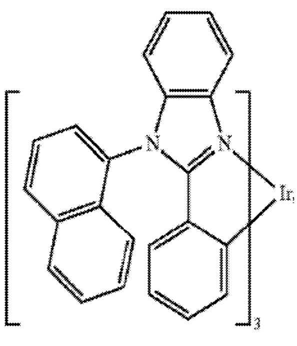

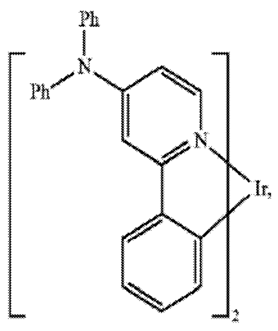

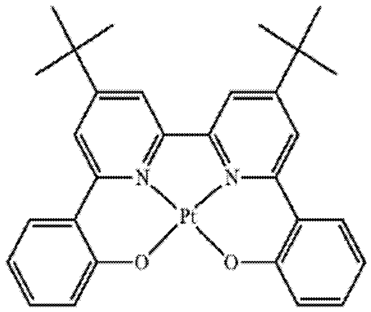

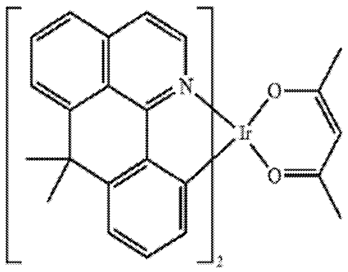

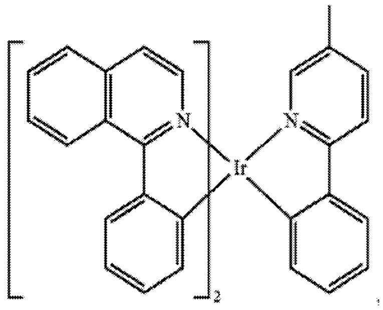

As stated above, the skilled artisan will realize that any phosphorescent complexes used in the state of the art may be suitable as phosphorescence materials $P^B$ in the context of the present invention.

In one embodiment of the invention, each phosphorescence material $P^B$ comprised in a light-emitting layer B comprises Iridium (Ir).

In one embodiment of the invention, at least one phosphorescence material $P^B$, preferably each phosphorescence material $P^B$ comprised in a light-emitting layer B, is an organometallic complex comprising either iridium (Ir) or platinum (Pt).

In one embodiment of the invention, the at least one phosphorescence material $P^B$, preferably each phosphorescence material $P^B$, comprised in a light-emitting layer B is an organometallic complex comprising iridium (Ir).

In one embodiment of the invention, the at least one phosphorescence material $P^B$, preferably each phosphorescence material $P^B$, comprised in a light-emitting layer B is an organometallic complex comprising platinum (Pt).

Non-limiting examples of phosphorescence materials $P^B$ also include compounds represented by the following general formula $P^B$-I,

Formula $P^B$-I.

In formula $P^B$-I, M is selected from the group consisting of Ir, Pt, Au, Eu, Ru, Re, Ag and Cu;

n is an integer of 1 to 3; and
$X^2$ and $Y^1$ together form at each occurrence independently from each other a bidentate monoanionic ligand.

In one embodiment of the invention, each phosphorescence materials $P^B$ comprised in a light-emitting layer B comprises or consists of a structure according to formula $P^B$,

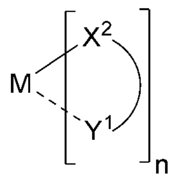

Formula $P^B$-I,

wherein, M is selected from the group consisting of Ir, Pt, Au, Eu, Ru, Re, Ag and Cu;
n is an integer of 1 to 3; and
$X^2$ and $Y^1$ together form at each occurrence independently from each other a bidentate monoanionic ligand.

Examples of the compounds represented by the formula $P^B$-I include compounds represented by the following general formula $P^B$-II or general formula $P^B$-III:

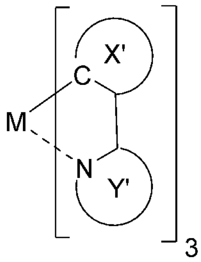

Formula $P^B$-II

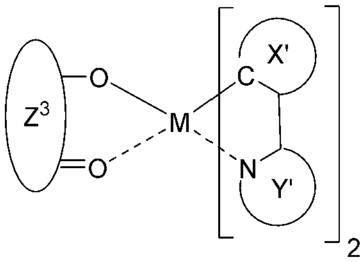

Formula $P^B$-III.

In formulas $P^B$-II and $P^B$-III, X' is an aromatic ring which is carbon(C)-bonded to M and Y' is a ring, which is nitrogen(N)-coordinated to M to form a ring.

X' and Y' are bonded, and X' and Y' may form a new ring. In formula $P^B$-III, $Z^3$ is a bidentate ligand having two oxygens(O). In the formulas $P^B$-II and $P^B$-III, M is preferably Ir from the viewpoint of high efficiency and long lifetime.

In the formulas $P^B$-II and $P^B$-III, the aromatic ring X' is for example a $C_6$-$C_{30}$-aryl, preferably a $C_6$-$C_{16}$-aryl, even more preferably a $C_6$-$C_{12}$-aryl, and particularly preferably a $C_6$-$C_{10}$-aryl, wherein X' at each occurrence is optionally substituted with one or more substituents $R^E$.

In the formulas $P^B$-II and $P^B$-III, Y' is for example a $C_2$-$C_{30}$-heteroaryl, preferably a $C_2$-$C_{25}$-heteroaryl, more preferably a $C_2$-$C_{20}$-heteroaryl, even more preferably a $C_2$-$C_{15}$-heteroaryl, and particularly preferably a $C_2$-$C_{10}$-heteroaryl, wherein Y' at each occurrence is optionally substituted with one or more substituents $R^E$. Furthermore, Y' may be, for example, a $C_1$-$C_5$-heteroaryl, which is optionally substituted with one or more substituents $R^E$.

In the formulas $P^B$-II and $P^B$-III, the bidentate ligand having two oxygens(O) $Z^3$ is for example a $C_2$-$C_{30}$-bidentate ligand having two oxygens, a $C_2$-$C_{25}$-bidentate ligand having two oxygens, more preferably a $C_2$-$C_{20}$-bidentate ligand having two oxygens, even more preferably a $C_2$-$C_{15}$-bidentate ligand having two oxygens, and particularly preferably a $C_2$-$C_{10}$-bidentate ligand having two oxygens, wherein $Z^3$ at each occurrence is optionally substituted with one or more substituents $R^E$. Furthermore, $Z^3$ may be, for example, a $C_2$-$C_5$- bidentate ligand having two oxygens, which is optionally substituted with one or more substituents $R^E$.

$R^E$ is at each occurrence independently from another selected from the group consisting of hydrogen, deuterium, $N(R^{5E})_2$, $OR^{5E}$,

$SR^{5E}$, $Si(R^{5E})_3$, $CF_3$, CN, halogen,

$C_1$-$C_{40}$-alkyl, which is optionally substituted with one or more substituents $R^{5E}$ and wherein one or more non-adjacent $CH_2$-groups are optionally substituted by $R^{5E}C$=$CR^{5E}$, C=C, $Si(R^{5E})_2$, $Ge(R^{5E})_2$, $Sn(R^{5E})_2$, C=O, C=S, C=Se, C=$NR^{5E}$, P(=O)($R^{5E}$), SO, $SO_2$, $NR^{5E}$, O, S or $CONR^{5E}$;

$C_1$-$C_{40}$-thioalkoxy, which is optionally substituted with one or more substituents $R^{5E}$ and wherein one or more non-adjacent $CH_2$-groups are optionally substituted by $R^{5E}C$=$CR^{5E}$, C=C, $Si(R^{5E})_2$, $Ge(R^{5E})_2$, $Sn(R^{5E})_2$, C=O, C=S, C=Se, C=$NR^{5E}$, P(=O)($R^{5E}$), SO, $SO_2$, $NR^{5E}$, O, S or $CONR^{5E}$;

$C_6$-$C_{60}$-aryl, which is optionally substituted with one or more substituents $R^{5E}$; and

$C_3$-$C_{57}$-heteroaryl, which is optionally substituted with one or more substituents $R^{5E}$.

$R^{5E}$ is at each occurrence independently from another selected from the group consisting of hydrogen, deuterium, $N(R^{6E})_2$, $OR^{6E}$, $SR^{6E}$, $Si(R^{6E})_3$, $CF_3$, CN, F,

$C_1$-$C_{40}$-alkyl, which is optionally substituted with one or more substituents $R^{6E}$ and wherein one or more non-adjacent $CH_2$-groups are optionally substituted by $R^{6E}C$=$CR^{6E}$, C=C, $Si(R^{6E})_2$, $Ge(R^{6E})_2$, $Sn(R^{6E})_2$, C=O, C=S, C=Se, C=$NR^{6E}$, P(=O)($R^{6E}$), SO, $SO_2$, $NR^{6E}$, O, S or $CONR^{6E}$;

$C_6$-$C_{60}$-aryl, which is optionally substituted with one or more substituents $R^{6E}$; and

$C_3$-$C_{57}$-heteroaryl, which is optionally substituted with one or more substituents $R^{6E}$.

$R^{6E}$ is at each occurrence independently from another selected from the group consisting of hydrogen, deuterium, OPh, $CF_3$, CN, F,

$C_1$-$C_5$-alkyl, wherein one or more hydrogen atoms are optionally, independently from each other substituted by deuterium, CN, $CF_3$, or F;

$C_1$-$C_5$-alkoxy,

wherein one or more hydrogen atoms are optionally, independently from each other substituted by deuterium, CN, $CF_3$, or F;

$C_1$-$C_5$-thioalkoxy,

wherein one or more hydrogen atoms are optionally, independently from each other substituted by deuterium, CN, $CF_3$, or F;

$C_6$-$C_{18}$-aryl, which is optionally substituted with one or more $C_1$-$C_5$-alkyl substituents;

$C_3$-$C_{17}$-heteroaryl,
which is optionally substituted with one or more $C_1$-$C_5$-alkyl substituents;
$N(C_6$-$C_{18}$-aryl$)_2$;
$N(C_3$-$C_{17}$-heteroaryl$)_2$, and
$N(C_3$-$C_{17}$-heteroaryl$)(C_6$-$C_{18}$-aryl$)$.

The substituents $R^E$, $R^{5E}$, or $R^{6E}$ independently from each other optionally may form a mono- or polycyclic, aliphatic, aromatic, heteroaromatic ring system with one or more substituents $R^E$, $R^{5E}$, $R^{6E}$, and/or with X', Y' and $Z^3$.

Non-limiting examples of the compound represented by formula $P^B$-II include $Ir(ppy)_3$, $Ir(ppy)_2(acac)$, $Ir(mppy)_3$, $Ir(PPy)_2$(m-bppy), and BtpIr(acac), $Ir(btp)_2(acac)$, Ir(2-phq)$_3$, Hex-Ir(phq)$_3$, $Ir(fbi)_2(acac)$, fac-Tris(2-(3-p-xylyl)phenyl) pyridine iridium(III), Eu(dbm)$_3$(Phen), $Ir(piq)_3$, $Ir(piq)_2(acac)$, $Ir(Fiq)_2(acac)$, $Ir(Flq)_2(acac)$, Ru(dtb-bpy)$_3$.2(PF6), Ir(2-phq)$_3$, $Ir(BT)_2(acac)$, $Ir(DMP)_3$, $Ir(Mpq)_3$, $Ir(phq)_2$tpy, fac-Ir(ppy)$_2$Pc, Ir(dp)PQ$_2$, Ir(Dpm)(Piq)$_2$, Hex-Ir(piq)$_2$(acac), Hex-Ir(piq)$_3$, $Ir(dmpq)_3$, $Ir(dmpq)_2(acac)$, FPQIrpic and the like.

Other non-limiting examples of the compound represented by formula $P^B$-II include compounds represented by the following formulas $P^B$-II-1 to $P^B$-II-11. In the structural formula, "Me" represents a methyl group.

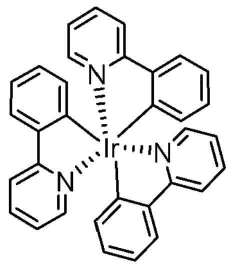

$P^B$-II-1

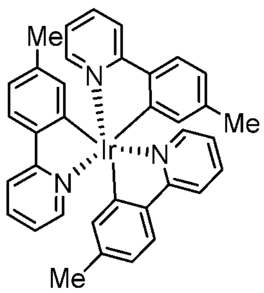

$P^B$-II-2

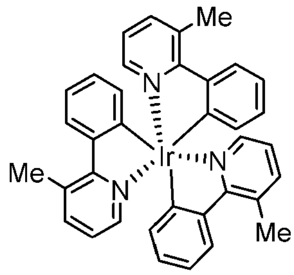

$P^B$-II-3

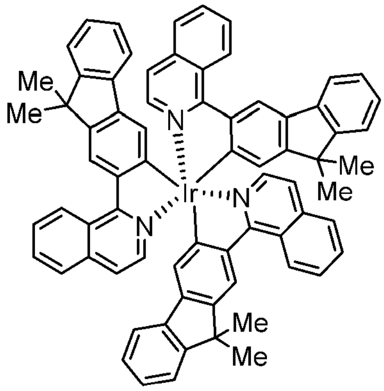

$P^B$-II-4

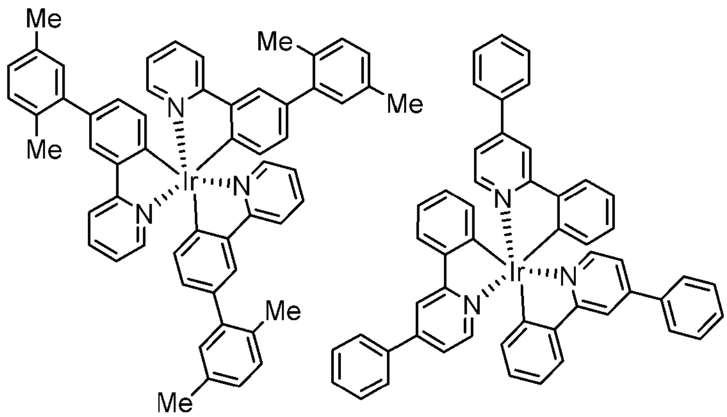

$P^B$-II-5

$P^B$-II-6

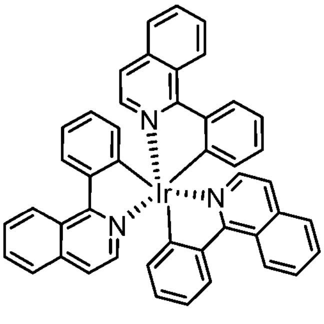

$P^B$-II-7

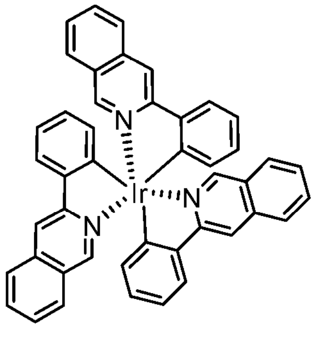

$P^B$-II-8

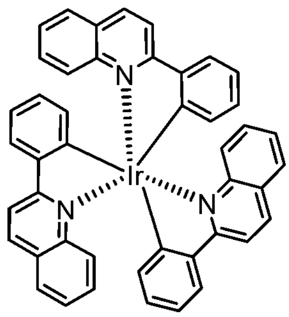

$P^B$-II-9

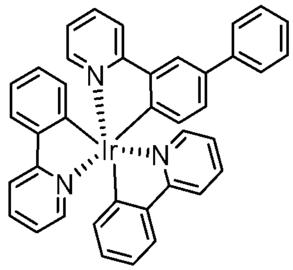

$P^B$-II-10

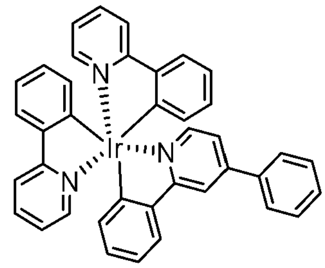

$P^B$-II-11

Other non-limiting examples of the compound represented by the formula $P^B$-III include compounds represented by the following formulas $P^B$-III-1 to $P^B$-III-6. In the structural formula, "Me" represents a methyl group.

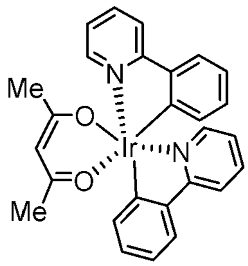

$P^B$-III-1

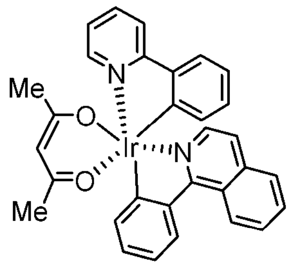

$P^B$-III-2

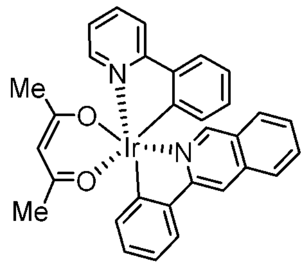

$P^B$-III-3

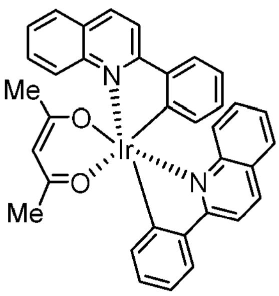

$P^B$-III-4

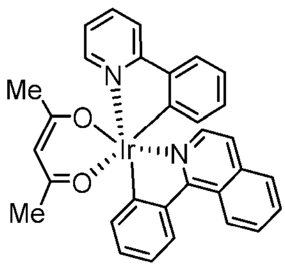

$P^B$-III-5

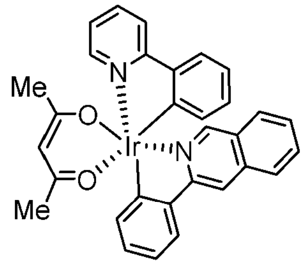

$P^B$-III-6

Furthermore, the iridium complexes described in US2003017361 (A1), US2004262576 (A1), WO2010027583 (A1), US2019245153 (A1), US2013119354 (A1), US2019233451 (A1), may be used. From the viewpoint of high efficiency in phosphorescence materials, $Ir(ppy)_3$ and Hex-$Ir(ppy)_3$ are often used for green light emission.

*Exciplexes*

It has been stated that TADF materials are capable of converting excited triplet states (preferably T1) to excited singlet states (preferably S1) by means of reverse intersystem crossing (RISC). It has also been stated that this typically requires a small $\Delta E_{ST}$ value, which is smaller than 0.4 eV for TADF materials $E^B$ by definition. As also stated, this is oftentimes achieved by designing TADF molecules $E^B$ so that the HOMO and LUMO are spatially largely separated on (electron-) donor and (electron-) acceptor groups, respectively. However, another strategy to arrive at species that have small $\Delta E_{ST}$ values is the formation of exciplexes. As known to the skilled artisan an exciplex is an excited state charge transfer complex formed between a donor molecule and an acceptor molecule (i.e. an excited state donor-acceptor complexes). The person skilled in the art further understands that the spatial separation between the HOMO (on the donor molecule) and the LUMO (on the acceptor molecule) in exciplexes typically results in them having rather small $\Delta E_{ST}$ values and being oftentimes capable of converting excited triplet states (preferably T1) to excited singlet states (preferably S1) by means of reverse intersystem crossing (RISC).

Indeed, as known to the person skilled in the art, a TADF material may not just be a material that is on its own capable of RISC from an excited triplet state to an excited singlet state with subsequent emission of TADF as laid out

above. It is known to those skilled in the art that a TADF material may in fact also be an exciplex that is formed from two kinds of materials, preferably from two host materials $H^B$, more preferably from a p-host material $H^P$ and an n-host material $H^N$ (vide infra), whereat it is understood that the host materials $H^B$ (typically $H^P$ and $H^N$) may themselves be TADF materials.

The person skilled in the art understands that any materials that are comprised in the same layer, in particular in the same EML, but also materials that are in adjacent layers and get in close proximity at the interface between these adjacent layers, may together form an exciplex. The person skilled in the art knows how to choose pairs of materials, in particular pairs of a p-host $H^P$ and an n-host $H^N$, which form an exciplex and the selection criteria for the two components of said pair of materials, including HOMO- and/or LUMO-energy level requirements. This is to say that, in case exciplex formation may be aspired, the highest occupied molecular orbital (HOMO) of the one component, e.g. the p-host material $H^P$, may be at least 0.20 eV higher in energy than the HOMO of the other component, e.g. the n-host material $H^N$, and the lowest unoccupied molecular orbital (LUMO) of the one component, e.g. the p-host material $H^P$, may be at least 0.20 eV higher in energy than the LUMO of the other component, e.g. the n-host material $H^N$.

It belongs to the common knowledge of those skilled in the art that, if present in an EML of an organic electroluminescent device, in particular an OLED, an exciplex may have the function of an emitter material and emit light when a voltage and electrical current are applied to said device. As also commonly known from the state of the art, an exciplex may also be non-emissive and may for example transfer excitation energy to an emitter material, if comprised in an EML of an organic electroluminescent device. Thus, exciplexes that are capable of converting excited triplet states to excited singlet states by means of RISC may also be used as excitation energy transfer component EET-1 and/or EET-2.

Non-limiting examples of host materials $H^B$ that may together form an exciplex are listed below, wherein the donor molecule (i.e. the p-host $H^P$) may be selected from the following structures:

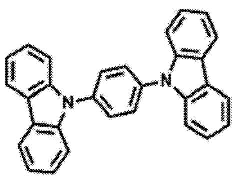
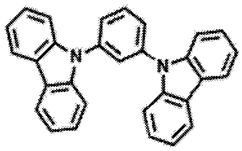
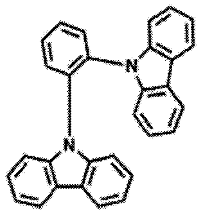
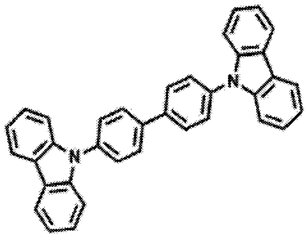
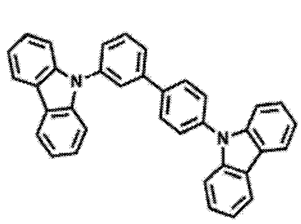
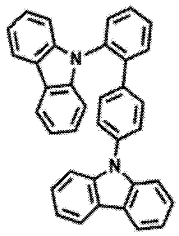
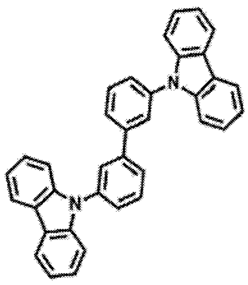
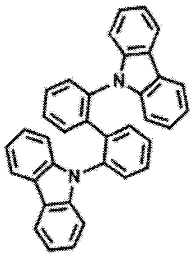
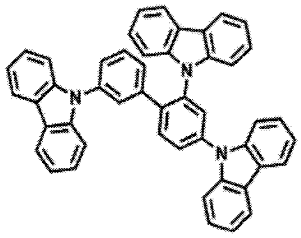

and wherein the acceptor molecule (i.e. the n-host $H^N$) may be selected from the following structures:

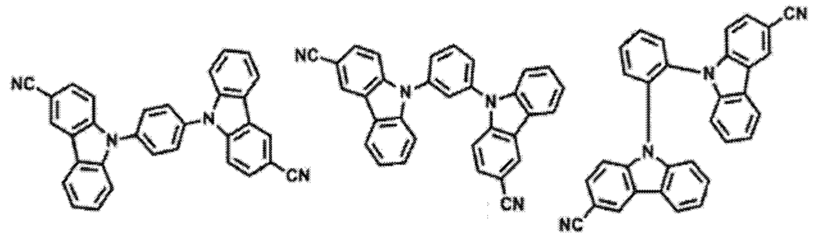

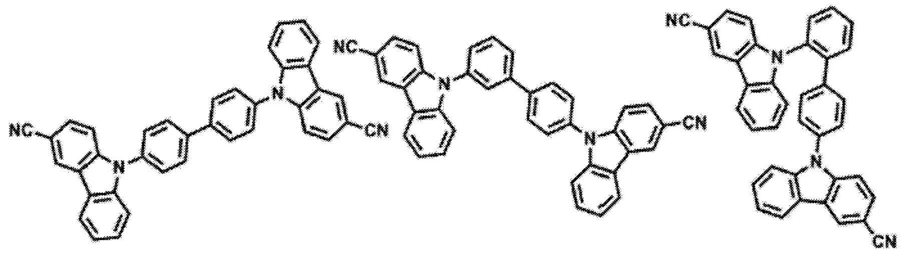

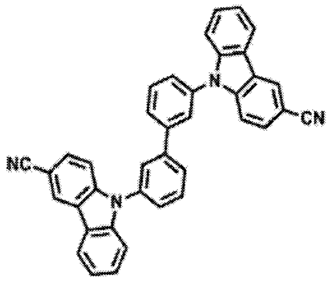

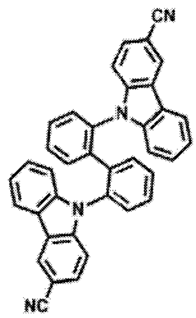

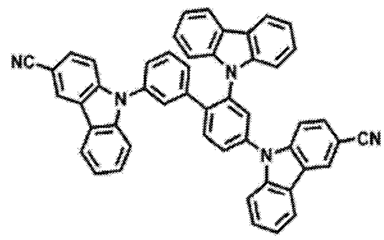

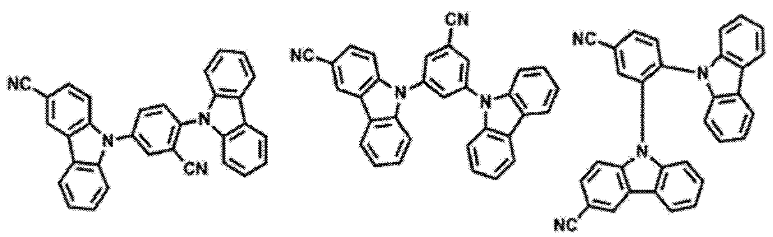

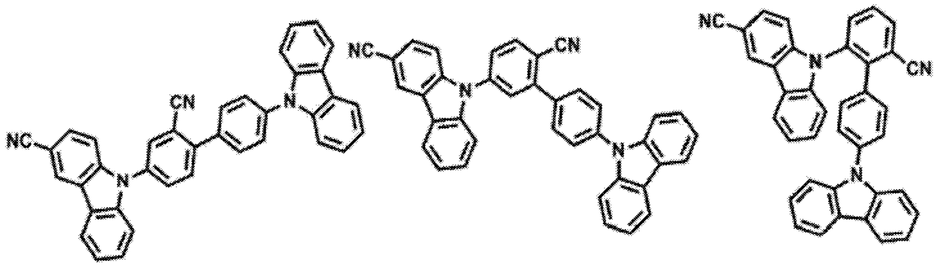

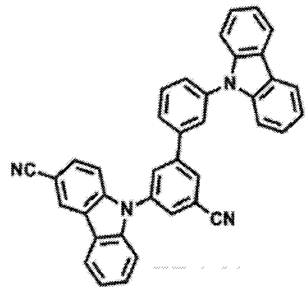

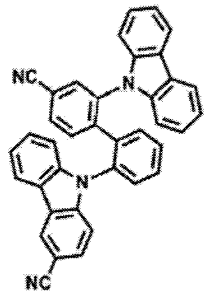

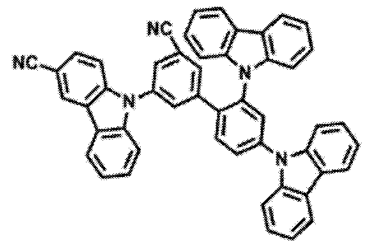

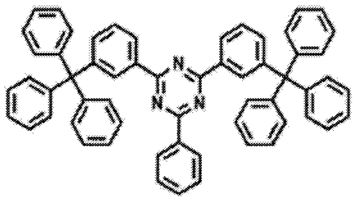

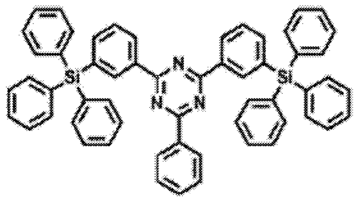

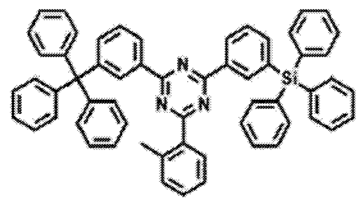

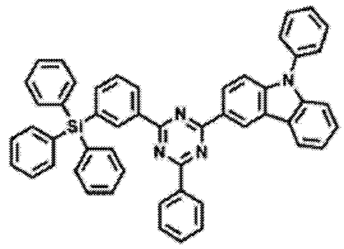

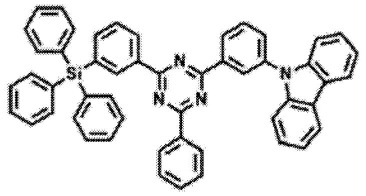

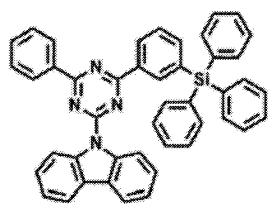

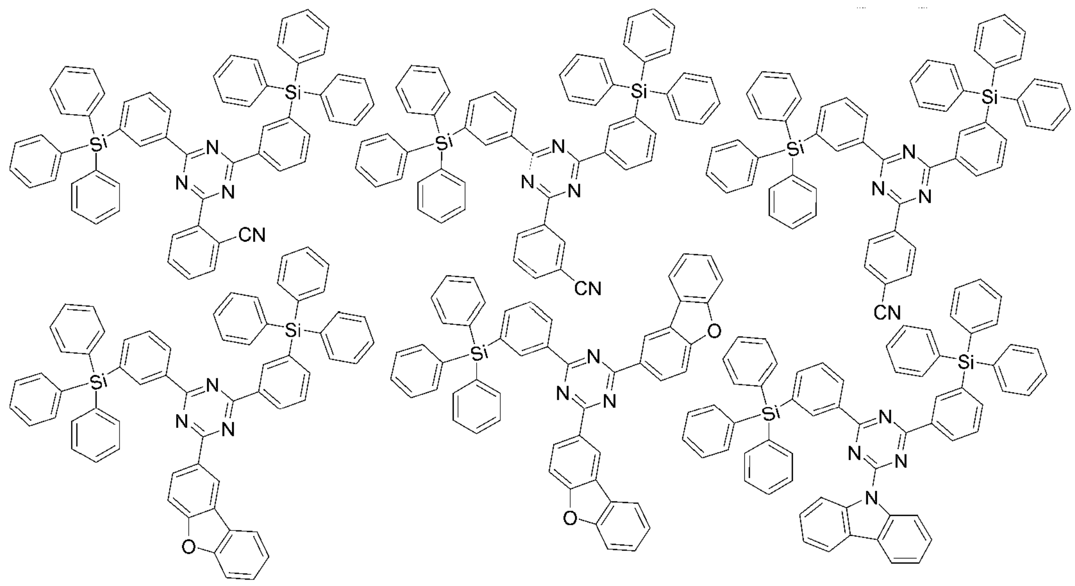

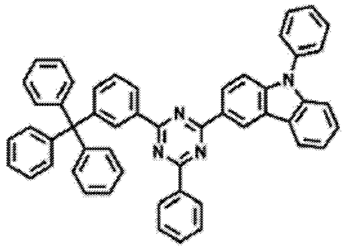

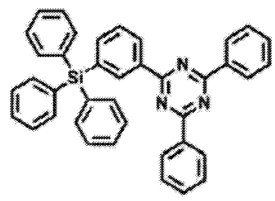

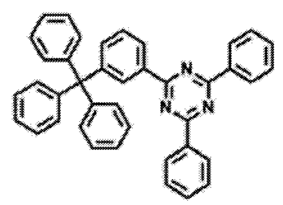

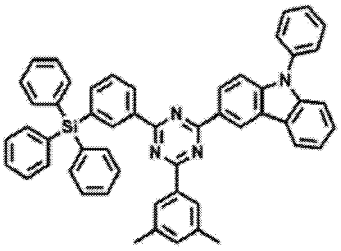
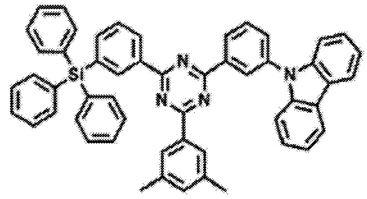
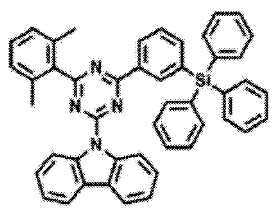

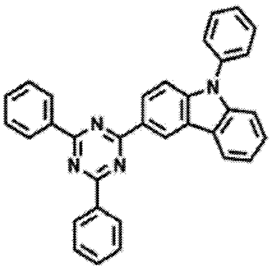
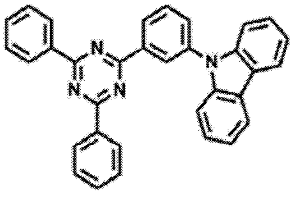
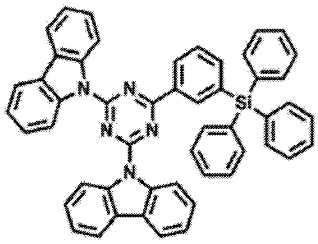

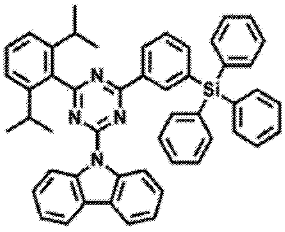
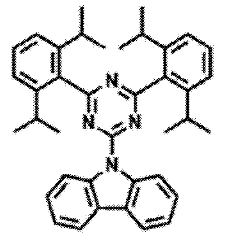
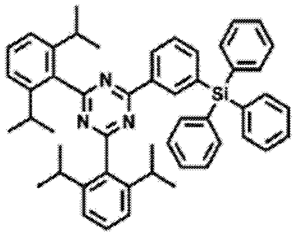

It is understood that exciplexes may be formed from any materials comprised in a light-emitting layer B in the context of the present invention, for example from different excitation energy transfer components (EET-1 and/or EET-2) as well as from an excitation energy transfer component (EET-1 and/or EET-2) and a small FWHM emitter $S^B$ or from a host material $H^B$ and an excitation energy transfer component EET-1 or EET-2 or a small FWHM emitter $S^B$. Preferably however, they are formed from different host materials $H^B$ as stated above. It is also understood that an exciplex may also be formed and not serve as excitation energy transfer component (EET-1 and/or EET-2) itself.

*Small FWHM emitter(s) $S^B$*

A small full width at half maximum (FWHM) emitter $S^B$ in the context of the present invention is any emitter that has an emission spectrum, which exhibits an FWHM of less than or equal to 0.25 eV (≤ 0.25 eV), typically measured from a spin-coated film with 1 to 5% by weight, in particular with 2% by weight of emitter in poly(methyl methacrylate) PMMA at room temperature (i.e., (approximately) 20°C). Alternatively, emission spectra of small FWHM emitters $S^B$ may be measured in a solution, typically with 0.001-0.2 mg/mL of the emitter $S^B$ in dichloromethane or toluene at room temperature (i.e., (approximately) 20°C).

In a preferred embodiment of the invention, a small FWHM emitter $S^B$ is any emitter that has an emission spectrum, which exhibits an FWHM of ≤ 0.24 eV, more preferably of ≤ 0.23 eV, even more preferably of ≤ 0.22 eV, of ≤ 0.21 eV or of ≤ 0.20 eV, measured from a spin-coated film with 1 to 5% by weight, in particular with 2% by weight of emitter $S^B$ in PMMA at room temperature (i.e., (approximately) 20°C). Alternatively, emission spectra of small FWHM emitters $S^B$ may be measured in a solution, typically with 0.001-0.2 mg/mL of the emitter $S^B$ in dichloromethane or toluene at room temperature (i.e., (approximately) 20°C). In other embodiments of the present invention, each small FWHM emitter $S^B$ exhibits an FWHM of ≤ 0.19 eV, of ≤ 0.18 eV, of ≤ 0.17 eV, of ≤ 0.16 eV, of ≤ 0.15 eV, of ≤ 0.14 eV, of ≤ 0.13 eV, of ≤ 0.12 eV, or of ≤ 0.11 eV.

In one embodiment of the invention, each small FWHM emitter $S^B$ emits light with an emission maximum in the wavelength range of from 400 nm to 470 nm, measured (with 1 to 5% by weight, in particular with 2% by weight of the emitter $S^B$) in PMMA at room temperature.

In one embodiment of the invention, each small FWHM emitter $S^B$ emits light with an emission maximum in the wavelength range of from 500 nm to 560 nm, measured (with 1 to 5% by weight, in particular with 2% by weight of the emitter $S^B$) in PMMA at room temperature.

In one embodiment of the invention, each small FWHM emitter $S^B$ emits light with an emission maximum in the wavelength range of from 610 nm to 665 nm, measured (with 1 to 5% by weight, in particular with 2% by weight of the emitter $S^B$) in PMMA at room temperature.

In one embodiment of the invention, each small FWHM emitter $S^B$ emits light with an emission maximum in the wavelength range of from 400 nm to 470 nm, measured with 0.001-0.2 mg/mL of the emitter $S^B$ in dichloromethane or toluene at room temperature (i.e., (approximately) 20°C).

In one embodiment of the invention, each small FWHM emitter $S^B$ emits light with an emission maximum in the wavelength range of from 500 nm to 560 nm, measured with 0.001-0.2 mg/mL of the emitter $S^B$ in dichloromethane or toluene at room temperature (i.e., (approximately) 20°C).

In one embodiment of the invention, each small FWHM emitter $S^B$ emits light with an emission maximum in the wavelength range of from 610 nm to 665 nm, measured with 0.001-0.2 mg/mL of the emitter $S^B$ in dichloromethane or toluene at room temperature (i.e., (approximately) 20°C).

It is understood that a TADF material $E^B$ comprised in a light-emitting layer B of an organic electroluminescent device according to the invention may optionally also be an emitter with an emission spectrum which exhibits an FWHM of less than or equal to 0.25 eV (≤ 0.25 eV). Optionally, a TADF material $E^B$ comprised in a light-emitting layer B of an organic electroluminescent device according to the invention may also exhibit an emission maximum within the wavelength ranges specified above (namely: 400 nm to 470 nm, 500 nm to 560 nm, 610 nm to 665 nm).

In one embodiment of the invention, one of the relations expressed by the following formulas (23) to (25) applies:

$$440\ nm < \lambda_{max}(S^B) < 470\ nm \qquad (29)$$

$$510\ nm < \lambda_{max}(S^B) < 550\ nm \qquad (30)$$

$$610\ nm < \lambda_{max}(S^B) < 665\ nm \qquad (31),$$

wherein $\lambda_{max}(S^B)$ refers to the emission maximum of a small FWHM emitter $S^B$ in the context of the present invention.

In one embodiment, the aforementioned relations expressed by formulas (29) to (31) apply to materials comprised in any of the one or more light-emitting layers B of the organic electroluminescent device according to the invention. In one embodiment, the aforementioned relations expressed by formulas (23) to (25) apply to materials comprised in the same light-emitting layer B of the organic electroluminescent device according to the invention.

In a preferred embodiment of the invention, each small FWHM emitter $S^B$ is an organic emitter, which, in the context of the invention, means that it does not contain any transition metals. Preferably, each small FWHM emitter $S^B$ according to the invention predominantly consists of the elements hydrogen (H), carbon (C), nitrogen (N), and boron (B), but may for example also comprise oxygen (O), silicon (Si), fluorine (F), and bromine (Br).

In a preferred embodiment of the invention, each small FWHM emitter $S^B$ is a fluorescent emitter, which in the context of the present invention means that, upon electronic excitation (for example in an optoelectronic device according to the invention), the emitter is capable of emitting light at room temperature, wherein the emissive excited state is a singlet state.

In one embodiment of the invention, a small FWHM emitter $S^B$ exhibits a photoluminescence quantum yield (PLQY) equal to or higher than 50%, measured (with 1 to 5% by weight, in particular with 2% by weight of the emitter $S^B$) in PMMA at room temperature.

In a preferred embodiment of the invention, a small FWHM emitter $S^B$ exhibits a photoluminescence quantum yield (PLQY) equal to or higher than 60%, measured (with 1 to 5% by weight, in particular with 2% by weight of the emitter $S^B$) in PMMA at room temperature.

In an even more preferred embodiment of the invention, a small FWHM emitter $S^B$ exhibits a photoluminescence quantum yield (PLQY) equal to or higher than 70%, measured (with 1 to 5% by weight, in particular with 2% by weight of the emitter $S^B$) in PMMA at room temperature.

In a still even more preferred embodiment of the invention, a small FWHM emitter $S^B$ exhibits a photoluminescence quantum yield (PLQY) equal to or higher than 80%, measured (with 1 to 5% by weight, in particular with 2% by weight of the emitter $S^B$) in PMMA at room temperature.

In a particularly preferred embodiment of the invention, a small FWHM emitter $S^B$ exhibits a photoluminescence quantum yield (PLQY) equal to or higher than 90%, measured (with 1 to 5% by weight, in particular with 2% by weight of the emitter $S^B$) in PMMA at room temperature.

In one embodiment of the invention, a small FWHM emitter $S^B$ exhibits a photoluminescence quantum yield (PLQY) equal to or higher than 50%, measured with 0.001-0.2 mg/mL of the emitter $S^B$ in dichloromethane or toluene at room temperature (i.e., (approximately) 20°C).

In a preferred embodiment of the invention, a small FWHM emitter $S^B$ exhibits a photoluminescence quantum yield (PLQY) equal to or higher than 60%, measured with 0.001-0.2 mg/mL of the emitter $S^B$ in dichloromethane or toluene at room temperature (i.e., (approximately) 20°C).

In an even more preferred embodiment of the invention, a small FWHM emitter $S^B$ exhibits a photoluminescence quantum yield (PLQY) equal to or higher than 70%, measured with 0.001-0.2 mg/mL of the emitter $S^B$ in dichloromethane or toluene at room temperature (i.e., (approximately) 20°C).

In a still even more preferred embodiment of the invention, a small FWHM emitter $S^B$ exhibits a photoluminescence quantum yield (PLQY) equal to or higher than 80%, measured with 0.001-0.2 mg/mL of the emitter $S^B$ in dichloromethane or toluene at room temperature (i.e., (approximately) 20°C).

In a particularly preferred embodiment of the invention, a small FWHM emitter $S^B$ exhibits a photoluminescence quantum yield (PLQY) equal to or higher than 90%, measured with 0.001-0.2 mg/mL of the emitter $S^B$ in dichloromethane or toluene at room temperature (i.e., (approximately) 20°C).

The person skilled in the art knows how to design small FWHM emitters $S^B$ which fulfill the above-mentioned requirements or preferred features.

A class of molecules suitable to provide small FWHM emitters $S^B$ in the context of the present invention are the well-known 4,4-difluoro-4-bora-3a,4a-diaza-s-indacene (BODIPY)-based materials, whose structural features and application in organic electroluminescent devices have been reviewed in detail and are common knowledge to those skilled in the art. The state of the art also reveals how such materials may be synthesized and how to arrive at an emitter with a certain emission color.

See for example: J. Liao, Y. Wang, Y. Xu, H. Zhao, X. Xiao, X. Yang, Tetrahedron 2015, 71(31), 5078, DOI: 10.1016/j.tet.2015.05.054; B.M Squeo, M. Pasini, Supramolecular Chemistry 2020, 32(1), 56-70, DOI: 10.1080/10610278.2019.1691727; M. Poddar, R. Misra, Coordination Chemistry Reviews 2020, 421, 213462-213483; DOI: 10.1016/j.ccr.2020.213462.

The skilled artisan is also familiar with the fact that the BODIPY base structure shown below

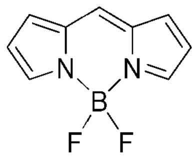

is not ideally suitable as emitter in an organic electroluminescent device, for example due to intermolecular π-π interactions and the associated self-quenching. It is common knowledge to those skilled in the art that one may arrive at more suitable emitter molecules for organic electroluminescent devices by attaching bulky groups as substituents to the BODIPY core structure shown above. These bulky groups may for example (among many others) be aryl, heteroaryl, alkyl or alkoxy substituents or condensed polycyclic aromatics, or heteroaromatics, all of which may optionally be substituted. The choice of suitable substituents at the BODIPY core is obvious for the skilled artisan and can easily be derived from the state of the art. The same holds true for the multitude of synthetic pathways which have been established for the synthesis and subsequent modification of such molecules.

See for example: B.M Squeo, M. Pasini, Supramolecular Chemistry 2020, 32(1), 56-70, DOI: 10.1080/10610278.2019.1691727; M. Poddar, R. Misra, Coordination Chemistry Reviews 2020, 421, 213462-213483; DOI: 10.1016/j.ccr.2020.213462.

Examples of BODIPY-based emitters that may be suitable as small FWHM emitters $S^B$ in the context of the present invention are shown below:

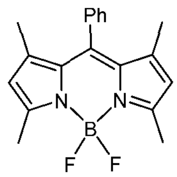

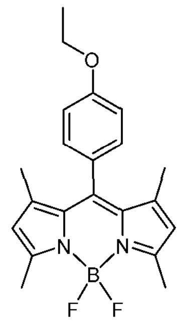

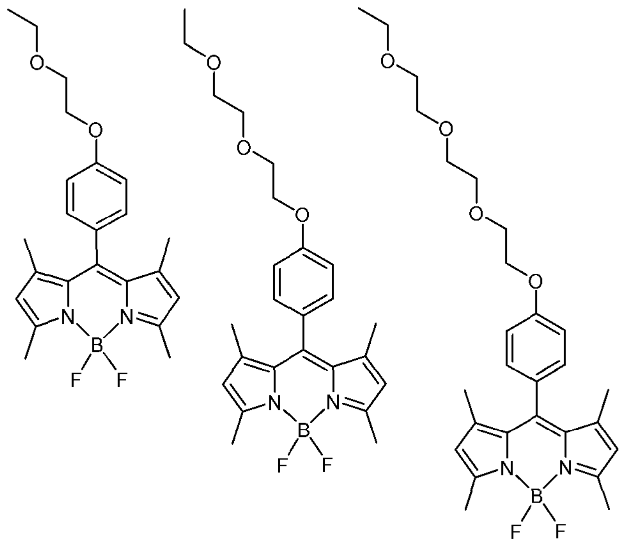

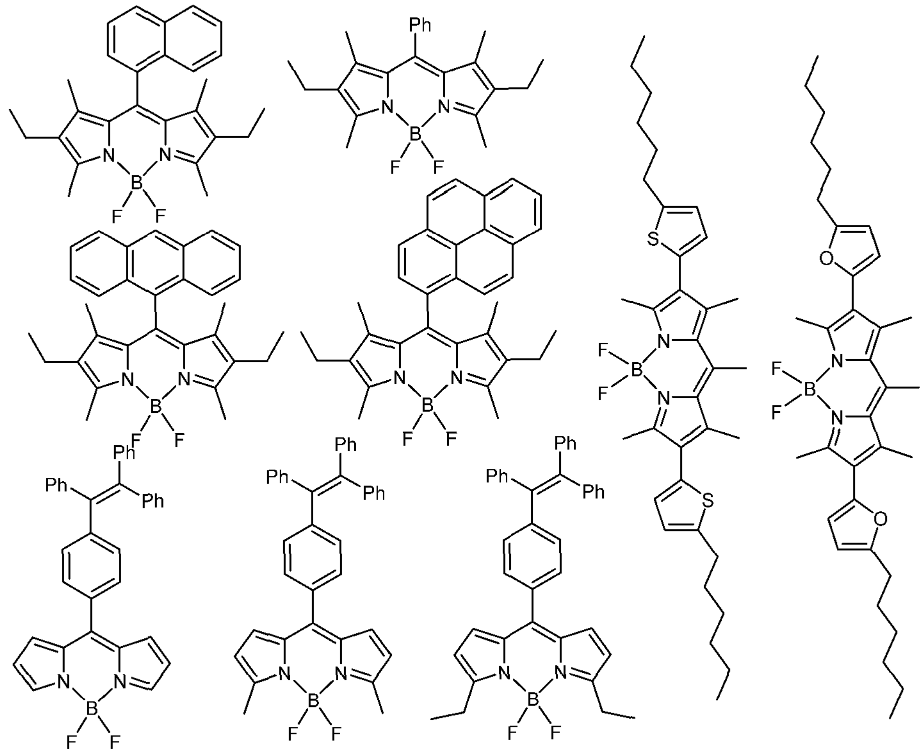

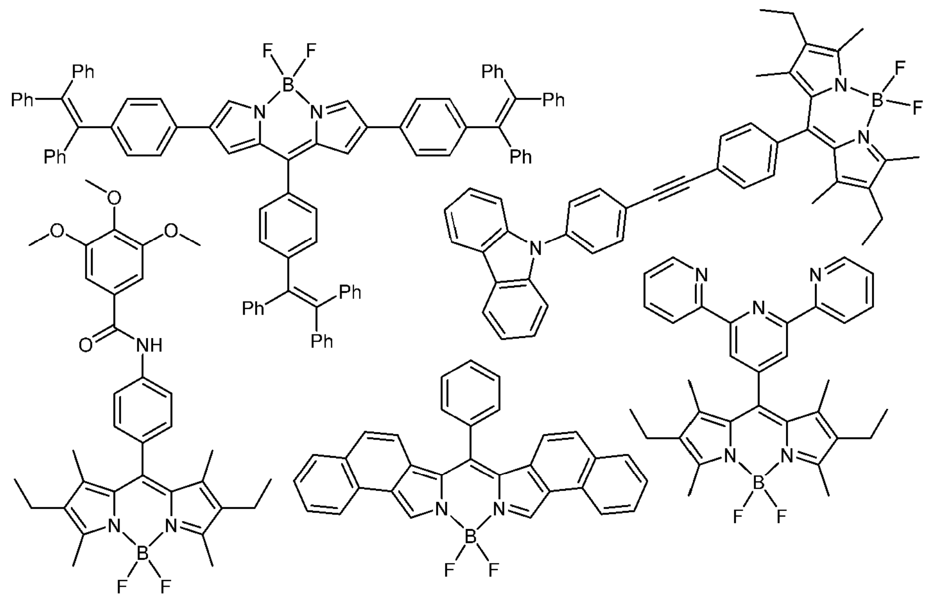

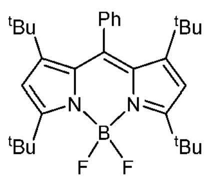
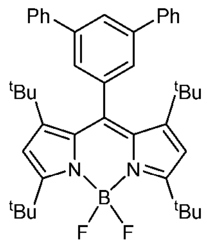
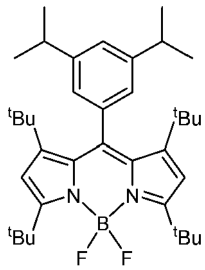
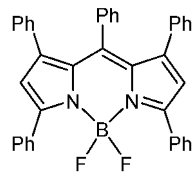

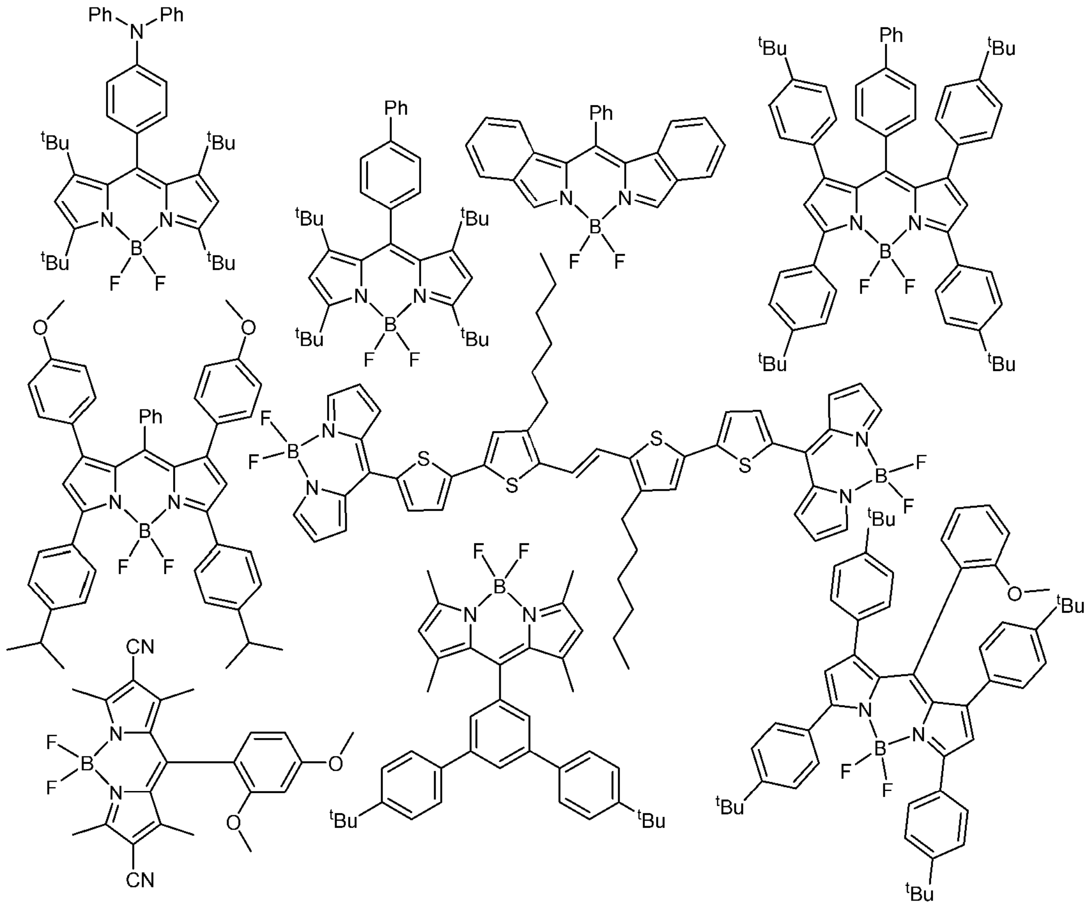

It is understood that this does not imply that BODIPY-derivatives with other structural features than those shown above are not suited as small FWHM emitters $S^B$ in the context of the present invention.

For example, the BODIPY-derived structures disclosed in US2020251663 (A1), EP3671884 (A1), US20160230960 (A1), US20150303378 (A1) or derivatives thereof may be suitable small FWHM emitters $S^B$ for use according to the present invention.

Furthermore, it is known to those skilled in the art, that one may also arrive at emitters for organic electroluminescent devices by replacing one or both of the fluorine substituents attached to the central boron atom of the BODIPY core structure by alkoxy or aryloxy groups which are attached via the oxygen atom and may optionally be substituted, preferably with electron-withdrawing substituents such as fluorine (F) or trifluoromethyl ($CF_3$). Such molecules are for example disclosed in US2012037890 (A1) and the person skilled in the art understands that these BODIPY-related compounds may also be suitable small FWHM emitters $S^B$ in the context of the present invention. Examples of such emitter molecules are shown below, which does not imply that only the shown structures may be suitable small FWHM emitters $S^B$ in the context of the present invention:

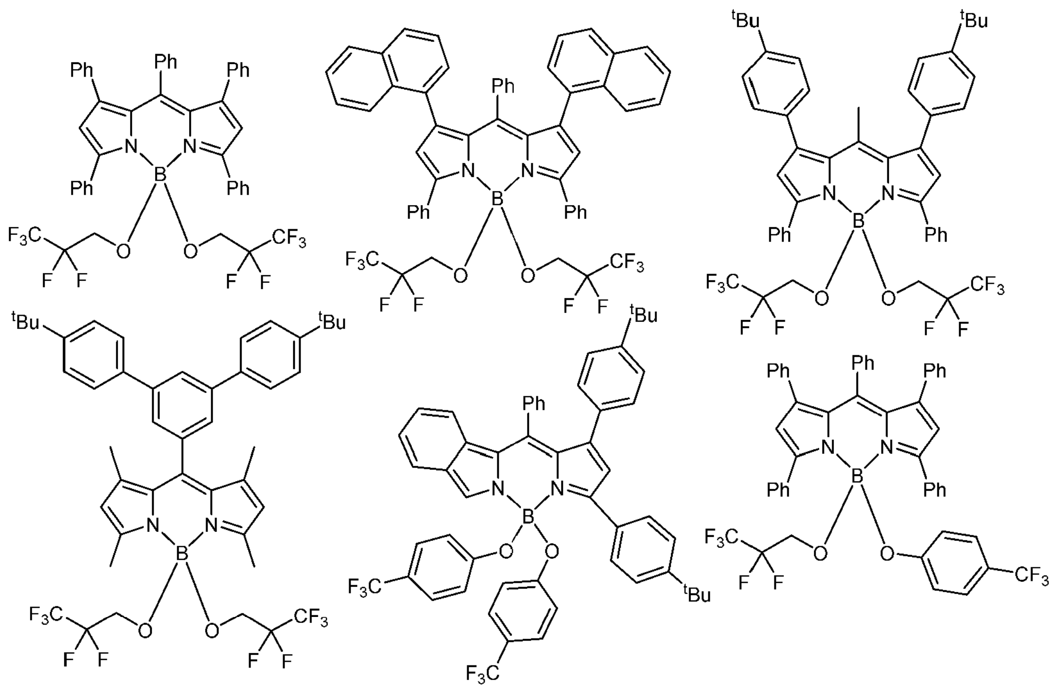

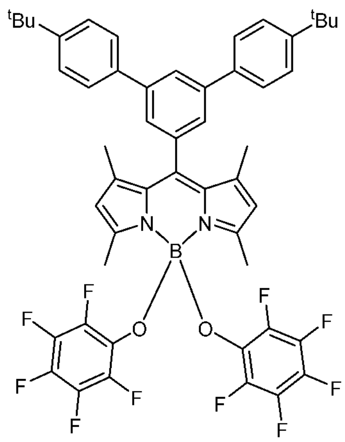

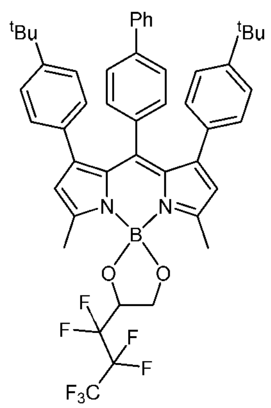

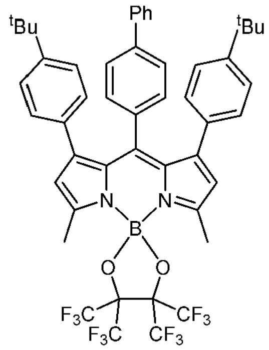

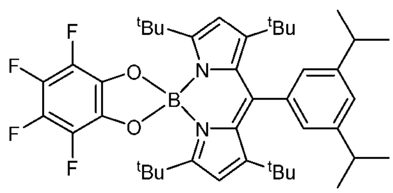

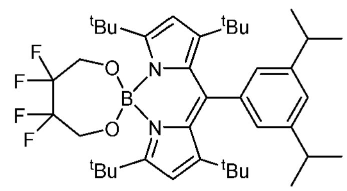

Additionally, the BODIPY-related boron-containing emitters disclosed in US20190288221 (A1) constitute a group of emitters that may provide suitable small FWHM emitters $S^B$ for use according to the present invention.

Another class of molecules suitable to provide small FWHM emitters $S^B$ in the context of the invention are *near-range-charge-transfer* (NRCT) emitters.

Typical NRCT emitters are described in the literature to show a delayed component in the time-resolved photoluminescence spectrum and exhibit a near-range HOMO-LUMO separation. See for example: T. Hatakeyama, K. Shiren, K. Nakajima, S. Nomura, S. Nakatsuka, K. Kinoshita, J. Ni, Y. Ono, and T. Ikuta, Advanced Materials 2016, 28(14), 2777, DOI: 10.1002/adma.201505491.

Typical NRCT emitters only show one emission band in the emission spectrum, wherein typical fluorescence emitters display several distinct emission bands due to vibrational progression.

The skilled artisan knows how to design and synthesize NRCT emitters that may be suitable as small FWHM emitters $S^B$ in the context of the present invention. For example, the emitters disclosed in EP3109253 (A1) may be used as small FWHM emitters $S^B$ in the context of the present invention.

Furthermore, for example, US2014058099 (A1), US2009295275 (A1), US2012319052 (A1), EP2182040 (A2),

US2018069182 (A1), US2019393419 (A1), US2020006671 (A1), US2020098991 (A1), US2020176684 (A1), US2020161552 (A1), US2020227639 (A1), US2020185635 (A1), EP3686206 (A1), EP3686206 (A1), WO2020217229 (A1), WO2020208051 (A1), and US2020328351 (A1) disclose emitter materials that may be suitable as small FWHM emitters $S^B$ for use according to the present invention.

A group of emitters that may be used as small FWHM emitters $S^B$ in the context of the present invention are the boron (B)-containing emitters comprising or consisting of a structure according to the following formula DABNA-I:

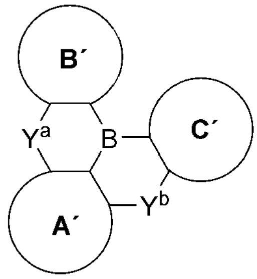

DABNA-I,

wherein

each of ring A', ring B', and ring C' independently of each other represents an aromatic or heteroaromatic ring, each comprising 5 to 24 ring atoms, out of which, in case of a heteroaromatic ring, 1 to 3 ring atoms are heteroatoms independently of each other selected from N, O, S, and Se; wherein

one or more hydrogen atoms in each of the aromatic or heteroaromatic rings A', B', and C' are optionally and independently of each other substituted by a substituent $R^{DABNA-1}$, which is at each occurrence independently of each other selected from the group consisting of: hydrogen, deuterium, $N(R^{DABNA-2})_2$, $OR^{DABNA-2}$, $SR^{DABNA-2}$, $Si(R^{DABNA-2})_3$, $B(OR^{DABNA-2})_2$, $OSO_2R^{DABNA-2}$, $CF_3$, CN, halogen (F, Cl, Br, I),

$C_1$-$C_{40}$-alkyl,

which is optionally substituted with one or more substituents $R^{DABNA-2}$ and wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;

$C_1$-$C_{40}$-alkoxy,

which is optionally substituted with one or more substituents $R^{DABNA-2}$ and wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, 0, S or $CONR^{DABNA-2}$;

$C_1$-$C_{40}$-thioalkoxy,

which is optionally substituted with one or more substituents $R^{DABNA-2}$ and wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, 0, S or $CONR^{DABNA-2}$;

$C_2$-$C_{40}$-alkenyl,

which is optionally substituted with one or more substituents $R^{DABNA-2}$ and wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, 0, S or $CONR^{DABNA-2}$;

$C_2$-$C_{40}$-alkynyl,

which is optionally substituted with one or more substituents $R^{DABNA-2}$ and wherein one or more non-adjacent $CH_2$-groups are optionally substituted by $R^{DABNA-2}C=CR^{DABNA-2}$, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;

$C_6$-$C_{60}$-aryl,

which is optionally substituted with one or more substituents $R^{DABNA-2}$;

$C_3$-$C_{57}$-heteroaryl,

which is optionally substituted with one or more substituents $R^{DABNA-2}$;

and aliphatic, cyclic amines comprising 4 to 18 carbon atoms and 1 to 3 nitrogen atoms;

$R^{DABNA-2}$ is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $B(OR^{DABNA-6})2$, $OSO_2R^{DABNA-6}$, $CF_3$, CN, halogen (F, Cl, Br, I),

$C_1$-$C_5$-alkyl,

which is optionally substituted with one or more substituents $R^{DABNA-6}$ and wherein one or more non-adjacent $CH_2$-

groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, 0, S or $CONR^{DABNA-6}$;
$C_1$-$C_5$-alkoxy,
which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;
$C_1$-$C_5$-thioalkoxy,
which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;
$C_2$-$C_5$-alkenyl,
which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;
$C_2$-$C_5$-alkynyl,
which is optionally substituted with one or more substituents $R^{DABNA-6}$ and wherein one or more non-adjacent $CH_2$-groups are optionally substituted by $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;
$C_6$-$C_{18}$-aryl,
which is optionally substituted with one or more substituents $R^{DABNA-6}$;
$C_3$-$C_{17}$-heteroaryl,
which is optionally substituted with one or more substituents $R^{DABNA-6}$;
and aliphatic, cyclic amines comprising 4 to 18 carbon atoms and 1 to 3 nitrogen atoms;
wherein two or more adjacent substituents selected from $R^{DABNA-1}$ and $R^{DABNA-2}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms;
$Y^a$ and $Y^b$ are independently of each other selected from a direct (single) bond, $NR^{DABNA-3}$, O, S, $Si(R^{DABNA-6})_2$, $Si(R^{DABNA-3})_2$, $BR^{DABNA-3}$, and Se;
$R^{DABNA-3}$ is at each occurrence independently of each other selected from the group consisting of: hydrogen, deuterium, $N(R^{DABNA-4})_2$, $OR^{DABNA-4}$, $SR^{DABNA-4}$, $Si(R^{DABNA-4})_3$, $B(OR^{DABNA-4})2$, $OSO_2R^{DABNA-4}$, $CF_3$, CN, halogen (F, Cl, Br, I),
$C_1$-$C_{40}$-alkyl,
which is optionally substituted with one or more substituents $R^{DABNA-4}$ and wherein one or more non-adjacent $CH_2$-groups are optionally substituted by $R^{DABNA-4}C=CR^{DABNA-4}$, C≡C, $Si(R^{DABNA-6})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, 0, S or $CONR^{DABNA-4}$;
$C_1$-$C_{40}$-alkoxy,
which is optionally substituted with one or more substituents $R^{DABNA-4}$ and wherein one or more non-adjacent $CH_2$-groups are optionally substituted by $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, 0, S or $CONR^{DABNA-4}$;
$C_1$-$C_{40}$-thioalkoxy,
which is optionally substituted with one or more substituents $R^{DABNA-4}$ and wherein one or more non-adjacent $CH_2$-groups are optionally substituted by $R^{DABNA-4}C=CR^{DABNA-4}$, C≡C, $Si(R^{DABNA-6})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, 0, S or $CONR^{DABNA-4}$;
$C_2$-$C_{40}$-alkenyl,
which is optionally substituted with one or more substituents $R^{DABNA-4}$ and wherein one or more non-adjacent $CH_2$-groups are optionally substituted by $R^{DABNA-4}C=CR^{DABNA-4}$, C≡C, $Si(R^{DABNA-6})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, 0, S or $CONR^{DABNA-4}$;
$C_2$-$C_{40}$-alkynyl,
which is optionally substituted with one or more substituents $R^{DABNA-4}$ and wherein one or more non-adjacent $CH_2$-groups are optionally substituted by $R^{DABNA-4}C=CR^{DABNA-4}$, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;
$C_6$-$C_{60}$-aryl,
which is optionally substituted with one or more substituents $R^{DABNA-4}$;
$C_3$-$C_{57}$-heteroaryl,
which is optionally substituted with one or more substituents $R^{DABNA-4}$;
and aliphatic, cyclic amines comprising 4 to 18 carbon atoms and 1 to 3 nitrogen atoms;
$R^{DABNA-4}$ is at each occurrence independently of each other selected from the group consisting of: hydrogen,

deuterium, $N(R^{DABNA-5})_2$, $OR^{DABNA-5}$, $SR^{DABNA-5}$, $Si(R^{DABNA-5})_3$, $B(OR^{DABNA-5})_2$, $OSO_2R^{DABNA-5}$, $CF_3$, CN, halogen (F, Cl, Br, I),

$C_1$-$C_{40}$-alkyl,

which is optionally substituted with one or more substituents $R^{DABNA-5}$ and wherein one or more non-adjacent $CH_2$-groups are optionally substituted by $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, 0, S or $CONR^{DABNA-5}$;

$C_1$-$C_{40}$-alkoxy,

which is optionally substituted with one or more substituents $R^{DABNA-5}$ and wherein one or more non-adjacent $CH_2$-groups are optionally substituted by $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, 0, S or $CONR^{DABNA-5}$;

$C_1$-$C_{40}$-thioalkoxy,

which is optionally substituted with one or more substituents $R^{DABNA-5}$ and wherein one or more non-adjacent $CH_2$-groups are optionally substituted by $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, 0, S or $CONR^{DABNA-5}$;

$C_2$-$C_{40}$-alkenyl,

which is optionally substituted with one or more substituents $R^{DABNA-5}$ and wherein one or more non-adjacent $CH_2$-groups are optionally substituted by $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, 0, S or $CONR^{DABNA-5}$;

$C_2$-$C_{40}$-alkynyl,

which is optionally substituted with one or more substituents $R^{DABNA-5}$ and wherein one or more non-adjacent $CH_2$-groups are optionally substituted by $R^{DABNA-5}C=CR^{DABNA-5}$, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S or $CONR^{DABNA-5}$;

$C_6$-$C_{60}$-aryl,

which is optionally substituted with one or more substituents $R^{DABNA-5}$;

$C_3$-$C_{57}$-heteroaryl,

which is optionally substituted with one or more substituents $R^{DABNA-5}$;

and aliphatic, cyclic amines comprising 4 to 18 carbon atoms and 1 to 3 nitrogen atoms;

$R^{DABNA-5}$; is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $B(OR^{DABNA-6})_2$, $OSO_2R^{DABNA-6}$, $CF_3$, CN, halogen (F, Cl, Br, I),

$C_1$-$C_5$-alkyl,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, 0, S or $CONR^{DABNA-6}$;

$C_1$-$C_5$-alkoxy,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, 0, S or $CONR^{DABNA-6}$;

$C_1$-$C_5$-thioalkoxy, which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkenyl,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkynyl,

which is optionally substituted with one or more substituents $R^{DABNA-6}$ and wherein one or more non-adjacent $CH_2$-groups are optionally substituted by $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_6$-$C_{18}$-aryl,

which is optionally substituted with one or more substituents $R^{DABNA-6}$;

$C_3$-$C_{17}$-heteroaryl,

which is optionally substituted with one or more substituents $R^{DABNA-6}$;

and aliphatic, cyclic amines comprising 4 to 18 carbon atoms and 1 to 3 nitrogen atoms;

wherein two or more adjacent substituents selected from $R^{DABNA-3}$, $R^{DABNA-4}$, and $R^{DABNA-5}$; optionally form a mono- or polycyclic, aliphatic or aromatic or heteroaromatic, carbocyclic or heterocyclic ring system with each other, wherein the optionally so formed ring system comprises in total 8 to 30 ring atoms;

$R^{DABNA-6}$ is at each occurrence independently of each other selected from the group consisting of: hydrogen,

deuterium, OPh (Ph = phenyl), SPh, $CF_3$, CN, F, $Si(C_1-C_5\text{-alkyl})_3$, $Si(Ph)_3$,
$C_1$-$C_5$-alkyl,
wherein optionally one or more hydrogen atoms are independently substituted by deuterium, Ph, CN, $CF_3$, or F;
$C_1$-$C_5$-alkoxy,
wherein optionally one or more hydrogen atoms are independently substituted by deuterium, CN, $CF_3$, or F;
$C_1$-$C_5$-thioalkoxy,
wherein optionally one or more hydrogen atoms are independently substituted by deuterium, CN, $CF_3$, or F;
$C_2$-$C_5$-alkenyl,
wherein optionally one or more hydrogen atoms are independently substituted by deuterium, CN, $CF_3$, or F;
$C_2$-$C_5$-alkynyl,
wherein optionally one or more hydrogen atoms are independently substituted by deuterium, CN, $CF_3$, or F;
$C_6$-$C_{18}$-aryl,
wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;
$C_3$-$C_{17}$-heteroaryl,
wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;
$N(C_6\text{-}C_{18}\text{-aryl})_2$,
$N(C_3\text{-}C_{17}\text{-heteroaryl})_2$; and
$N(C_3\text{-}C_{17}\text{-heteroaryl})(C_6\text{-}C_{18}\text{-aryl})$;
wherein in case, one of $Y^a$ and $Y^b$ is or both of $Y^a$ and $Y^b$ are $NR^{DABNA-3}$, $C(R^{DABNA-3})_2$, $Si(R^{DABNA-3})_2$, or $BR^{DABNA-3}$ the one or the two substituents $R^{DABNA-3}$ may optionally and independently of each other bond to one or both of the adjacent rings A' and B' (for $Y^a$ = $NR^{DABNA-3}$, $C(R^{DABNA-3})_2$, $Si(R^{DABNA-3})_2$, or $BR^{DABNA-3}$) or A' and C' (for $Y^b$ = $NR^{DABNA-3}$, $C(R^{DABNA-3})_2$, $Si(R^{DABNA-3})_2$, or $BR^{DABNA-3}$) via a direct (single) bond or via a connecting atom or atom group being in each case independently selected from $NR^{DABNA-1}$, O, S, $C(R^{DABNA-1})_2$, $Si(R^{DABNA-1})_2$, $BR^{DABNA-1}$, and Se;
and wherein optionally, two or more, preferably two, structures of formula DABNA-I are conjugated with each other, preferably fused to each other by sharing at least one, more preferably exactly one, bond;
wherein optionally two or more, preferably two, structures of formula DABNA-I are present in the emitter and share at least one, preferably exactly one, aromatic or heteroaromatic ring (i.e. this ring may be part of both structures of formula DABNA-I) which preferably is any of the rings A', B', and C' of formula DABNA-I, but may also be any aromatic or heteroaromatic substituent selected from $R^{DABNA-1}$, $R^{DABNA-2}$, $R^{DABNA-3}$, $R^{DABNA-4}$, $R^{DABNA-5}$, and $R^{DABNA-6}$, in particular $R^{DABNA-3}$, or any aromatic or heteroaromatic ring formed by two or more adjacent substituents as stated above, wherein the shared ring may constitute the same or different moieties of the two or more structures of formula DABNA-I that share the ring (i.e. the shared ring may for example be ring C' of both structures of formula DABNA-I optionally comprised in the emitter or the shared ring may for example be ring B' of one and ring C' of the other structure of formula DABNA-I optionally comprised in the emitter); and
wherein optionally at least one of $R^{DABNA-1}$, $R^{DABNA-2}$, $R^{DABNA-3}$, $R^{DABNA-4}$, $R^{DABNA-5}$; and $R^{DABNA-6}$ is replaced by a bond to a further chemical entity of formula DABNA-I and/or wherein optionally at least one hydrogen atom of any of $R^{DABNA-1}$, $R^{DABNA-2}$, $R^{DABNA-3}$, $R^{DABNA-4}$, $R^{DABNA-5}$, and $R^{DABNA-6}$ is replaced by a bond to a further chemical entity of formula DABNA-I.

In one embodiment of the invention, in at least one, preferably each, light-emitting layer B, at least one of the one or more small FWHM emitters $S^B$ comprises a structure according to formula DABNA-I.

In one embodiment of the invention, in at least one, preferably each, light-emitting layer B, each small FWHM emitter $S^B$ comprises a structure according to formula DABNA-I.

In one embodiment of the invention, in at least one, preferably each, light-emitting layer B, at least one of the one or more small FWHM emitters $S^B$ consists of a structure according to formula DABNA-I.

In one embodiment of the invention, in at least one, preferably each, light-emitting layer B, each small FWHM emitter $S^B$ consists of a structure according to formula DABNA-I.

In a preferred embodiment of the invention, in which in at least one, preferably each, light-emitting layer B, at least one, preferably each, of the one or more small FWHM emitters $S^B$ comprises or consists of a structure according to formula DABNA-I, A', B', and C' are all aromatic rings with 6 ring atoms each (i.e. they are all benzene rings).

In one embodiment of the invention, in which in at least one, preferably each, light-emitting layer B, at least one, preferably each, of the one or more small FWHM emitters $S^B$ comprises or consists of a structure according to formula DABNA-I, $Y^a$ and $Y^b$ are independently of each other selected from $NR^{DABNA-3}$, O, S, $C(R^{DABNA-3})_2$, and $Si(R^{DABNA-3})_2$.

In a preferred embodiment of the invention, in which in at least one, preferably each, light-emitting layer B, at least one, preferably each, of the one or more small FWHM emitters $S^B$ comprises or consists of a structure according to formula

DABNA-I, $Y^a$ and $Y^b$ are independently of each other selected from $NR^{DABNA-3}$, O, and S.

In an even more preferred embodiment of the invention, in which in at least one, preferably each, light-emitting layer B, at least one, preferably each, of the one or more small FWHM emitters $S^B$ comprises or consists of a structure according to formula DABNA-I, $Y^a$ and $Y^b$ are independently of each other selected from $NR^{DABNA-3}$, and O.

In a particularly preferred embodiment of the invention, in which in at least one, preferably each, light-emitting layer B, at least one, preferably each, of the one or more small FWHM emitters $S^B$ comprises or consists of a structure according to formula DABNA-I, $Y^a$ and $Y^b$ are both $NR^{DABNA-3}$.

In a particularly preferred embodiment of the invention, in which in at least one, preferably each, light-emitting layer B, at least one, preferably each, of the one or more small FWHM emitters $S^B$ comprises or consists of a structure according to formula DABNA-I, $Y^a$ and $Y^b$ are identical and are both $NR^{DABNA-3}$.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-1}$, is at each occurrence independently of each other selected from the group consisting of: hydrogen, deuterium, $N(R^{DABNA-2})_2$, $OR^{DABNA-2}$, $SR^{DABNA-2}$, $Si(R^{DABNA-2})_3$, $CF_3$, CN, F,
$C_1$-$C_5$-alkyl,
which is optionally substituted with one or more substituents $R^{DABNA-2}$;
$C_1$-$C_5$-alkoxy,
which is optionally substituted with one or more substituents $R^{DABNA-2}$;
$C_1$-$C_5$-thioalkoxy,
which is optionally substituted with one or more substituents $R^{DABNA-2}$;
$C_6$-$C_{18}$-aryl,
which is optionally substituted with one or more substituents $R^{DABNA-2}$;
$C_3$-$C_{17}$-heteroaryl,
which is optionally substituted with one or more substituents $R^{DABNA-2}$;
$R^{DABNA-2}$ is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $CF_3$, CN, F,
$C_1$-$C_5$-alkyl,
which is optionally substituted with one or more substituents $R^{DABNA-6}$;
$C_6$-$C_{18}$-aryl,
which is optionally substituted with one or more substituents $R^{DABNA-6}$;
$C_3$-$C_{17}$-heteroaryl,
which is optionally substituted with one or more substituents $R^{DABNA-6}$;
wherein two or more adjacent substituents selected from $R^{DABNA-1}$ and $R^{DABNA-2}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-1}$, is at each occurrence independently of each other selected from the group consisting of: hydrogen, deuterium, $N(R^{DABNA-2})_2$, $OR^{DABNA-2}$, $SR^{DABNA-2}$, $Si(R^{DABNA-2})_3$,
$C_1$-$C_5$-alkyl,
which is optionally substituted with one or more substituents $R^{DABNA-2}$;
$C_6$-$C_{18}$-aryl,
which is optionally substituted with one or more substituents $R^{DABNA-2}$;
$C_3$-$C_{17}$-heteroaryl,
which is optionally substituted with one or more substituents $R^{DABNA-2}$;
$R^{DABNA-2}$ is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $CF_3$, CN, F,
$C_1$-$C_5$-alkyl,
which is optionally substituted with one or more substituents $R^{DABNA-6}$;
$C_6$-$C_{18}$-aryl,
which is optionally substituted with one or more substituents $R^{DABNA-6}$;
$C_3$-$C_{17}$-heteroaryl,

which is optionally substituted with one or more substituents $R^{DABNA-6}$;
wherein two or more adjacent substituents selected from $R^{DABNA-1}$ and $R^{DABNA-2}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-1}$, is at each occurrence independently of each other selected from the group consisting of: hydrogen, deuterium, $N(R^{DABNA-2})_2$, $OR^{DABNA-2}$, $SR^{DABNA-2}$

$C_1$-$C_5$-alkyl,
which is optionally substituted with one or more substituents $R^{DABNA-2}$;

$C_6$-$C_{18}$-aryl,
which is optionally substituted with one or more substituents $R^{DABNA-2}$;

$C_3$-$C_{17}$-heteroaryl,
which is optionally substituted with one or more substituents $R^{DABNA-2}$;

$R^{DABNA-2}$ is at each occurrence independently of each other selected from the group consisting of: hydrogen, deuterium, $N(Ph)_2$, OPh, CN, Me, $^{i}Pr$, $^{t}Bu$, $Si(Me)_3$,

Ph,
which is optionally substituted with one or more substituents $R^{DABNA-6}$;

$C_3$-$C_{17}$-heteroaryl,
which is optionally substituted with one or more substituents $R^{DABNA-6}$;

wherein two or more adjacent $R^{DABNA-1}$ form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-1}$, is at each occurrence independently of each other selected from the group consisting of: hydrogen, deuterium, $N(Ph)_2$, OPh, Me, $^{i}Pr$, $^{t}Bu$, $Si(Me)_3$,
Ph,
wherein one or more hydrogen atoms are optionally, independently from each other substituted by deuterium, Me, $^{i}Pr$, $^{t}Bu$, Ph, or CN;
$C_3$-$C_{17}$-heteroaryl,
wherein one or more hydrogen atoms are optionally, independently from each other substituted by deuterium, Me, $^{i}Pr$, $^{t}Bu$, Ph, or CN;
wherein two or more adjacent substituents $R^{DABNA-1}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-1}$, is at each occurrence independently of each other selected from the group consisting of: hydrogen,

deuterium, $N(Ph)_2$, Me, $^iPr$, $^tBu$,

Ph,
wherein one or more hydrogen atoms are optionally, independently from each other substituted by deuterium, Me, $^iPr$, $^tBu$, Ph or CN;

carbazolyl,
wherein one or more hydrogen atoms are optionally, independently from each other substituted by deuterium, Me, $^iPr$, $^tBu$, Ph or CN;

triazinyl,
wherein one or more hydrogen atoms are optionally, independently from each other substituted by deuterium, Me, $^iPr$, $^tBu$, or Ph;

pyrimidinyl,
wherein one or more hydrogen atoms are optionally, independently from each other substituted by deuterium, Me, $^iPr$, $^tBu$, or Ph;

pyridinyl,
wherein one or more hydrogen atoms are optionally, independently from each other substituted by deuterium, Me, $^iPr$, $^tBu$, or Ph;

wherein two or more adjacent substituents $R^{DABNA-1}$ optionally form a mono- or polycyclic, aliphatic or aromatic or heteroaromatic, carbocyclic or heterocyclic ring system which is fused to the adjacent ring A', B' or C', wherein the optionally so formed fused ring system (i.e. the respective ring A', B' or C' and the additional ring(s) that are optionally fused to it) comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I, adjacent substituents selected from $R^{DABNA-1}$ and $R^{DABNA-2}$ do not form a mono- or polycyclic, aliphatic or aromatic or heteroaromatic, carbocyclic or heterocyclic ring system which is fused to the adjacent ring A', B' or C'.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-3}$ is at each occurrence independently of each other selected from the group consisting of: hydrogen, deuterium,
$C_1$-$C_4$-alkyl,
which is optionally substituted with one or more substituents $R^{DABNA-4}$;
$C_6$-$C_{18}$-aryl,
which is optionally substituted with one or more substituents $R^{DABNA-4}$;
$C_3$-$C_{17}$-heteroaryl,
which is optionally substituted with one or more substituents $R^{DABNA-4}$;
$R^{DABNA-4}$ is at each occurrence independently of each other selected from the group consisting of: hydrogen, deuterium, $N(R^{DABNA-5})_2$, $OR^{DABNA-5}$, $SR^{DABNA-5}$, $Si(C_1$-$C_5$-alkyl$)_3$, $CF_3$, CN, F,
$C_1$-$C_5$-alkyl,
which is optionally substituted with one or more substituents $R^{DABNA-5}$;
$C_6$-$C_{18}$-aryl,
which is optionally substituted with one or more substituents $R^{DABNA-5}$;
$C_3$-$C_{17}$-heteroaryl,
which is optionally substituted with one or more substituents $R^{DABNA-5}$;
$R^{DABNA-5}$; is at each occurrence independently of each other selected from the group consisting of: hydrogen, deuterium, $N(Ph)_2$, OPh, $Si(Me)_3$, $CF_3$, CN, F,
$C_1$-$C_5$-alkyl,
wherein one or more hydrogen atoms are optionally, independently from each other substituted by deuterium;
$C_6$-$C_{18}$-aryl,
wherein one or more hydrogen atoms are optionally, independently from each other substituted by deuterium, Me, $^iPr$,

$^{t}$Bu, Ph, or CN;
$C_3$-$C_{17}$-heteroaryl,
wherein one or more hydrogen atoms are optionally, independently from each other substituted by deuterium, Me, $^{i}$Pr, $^{t}$Bu, Ph, or CN;
wherein two or more adjacent substituents selected from $R^{DABNA-3}$, $R^{DABNA-4}$, and $R^{DABNA-5}$; optionally form a mono- or polycyclic, aliphatic or aromatic or heteroaromatic, carbocyclic or heterocyclic ring system with each other, wherein the optionally so formed ring system comprises in total 8 to 30 ring atoms.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-3}$ is at each occurrence independently of each other selected from the group consisting of: hydrogen, deuterium,
$C_1$-$C_4$-alkyl,
which is optionally substituted with one or more substituents $R^{DABNA-4}$;
$C_6$-$C_{18}$-aryl,
which is optionally substituted with one or more substituents $R^{DABNA-4}$;
$C_3$-$C_{17}$-heteroaryl,
which is optionally substituted with one or more substituents $R^{DABNA-4}$;
$R^{DABNA-4}$ is at each occurrence independently of each other selected from the group consisting of: hydrogen, deuterium, $N(Ph)_2$, OPh, $Si(Me)_3$, $CF_3$, CN, F,
$C_1$-$C_5$-alkyl,
wherein one or more hydrogen atoms are optionally, independently from each other substituted by deuterium;
$C_6$-$C_{18}$-aryl,
wherein one or more hydrogen atoms are optionally, independently from each other substituted by deuterium, Me, $^{i}$Pr, $^{t}$Bu, Ph, or CN;
$C_3$-$C_{17}$-heteroaryl,
wherein one or more hydrogen atoms are optionally, independently from each other substituted by deuterium, Me, $^{i}$Pr, $^{t}$Bu, Ph, or CN;
wherein two or more adjacent substituents selected from $R^{DABNA-3}$ and $R^{DABNA-4}$ do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-3}$ is at each occurrence independently of each other selected from the group consisting of: hydrogen, deuterium,
$C_1$-$C_4$-alkyl,
which is optionally substituted with one or more substituents $R^{DABNA-4}$;
$C_6$-$C_{18}$-aryl,
which is optionally substituted with one or more substituents $R^{DABNA-4}$;
$C_3$-$C_{17}$-heteroaryl,
which is optionally substituted with one or more substituents $R^{DABNA-4}$;
$R^{DABNA-4}$ is at each occurrence independently of each other selected from the group consisting of: hydrogen, deuterium, CN, F,
$C_1$-$C_5$-alkyl,
wherein one or more hydrogen atoms are optionally, independently from each other substituted by deuterium;
$C_6$-$C_{18}$-aryl,
wherein one or more hydrogen atoms are optionally, independently from each other substituted by deuterium, Me, $^{i}$Pr, $^{t}$Bu, Ph, or CN;
$C_3$-$C_{17}$-heteroaryl,
wherein one or more hydrogen atoms are optionally, independently from each other substituted by deuterium, Me, $^{i}$Pr, $^{t}$Bu, Ph, or CN;
wherein two or more adjacent substituents selected from $R^{DABNA-3}$ and $R^{DABNA-4}$ do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-3}$ is at each occurrence independently of each other selected from the group consisting of: hydrogen, deuterium, Me, $^i$Pr, $^t$Bu,
$C_6$-$C_{18}$-aryl,
wherein one or more hydrogen atoms are optionally, independently from each other substituted by deuterium, Me, $^i$Pr, $^t$Bu, Ph, or CN;
wherein two or more adjacent substituents selected from $R^{DABNA-3}$ do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-3}$ is at each occurrence independently of each other selected from the group consisting of: hydrogen, deuterium, Me, $^i$Pr, $^t$Bu, and
Ph,
wherein one or more hydrogen atoms are optionally, independently from each other substituted by deuterium, Me, $^i$Pr, $^t$Bu, Ph, or CN;
wherein two or more adjacent substituents selected from $R^{DABNA-3}$ do not form a mono- or polycyclic, aliphatic or aromatic or heteroaromatic, carbocyclic or heterocyclic ring system with each other.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-6}$ is at each occurrence independently of each other selected from the group consisting of: hydrogen, deuterium, OPh (Ph = phenyl), SPh, $CF_3$, CN, F, Si($C_1$-$C_5$-alkyl)$_3$, Si(Ph)$_3$,
$C_1$-$C_5$-alkyl,
wherein optionally one or more hydrogen atoms are independently substituted by deuterium, Ph, CN, $CF_3$, or F;
$C_6$-$C_{18}$-aryl,
wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;
$C_3$-$C_{17}$-heteroaryl,
wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;
N($C_6$-$C_{18}$-aryl)$_2$,
N($C_3$-$C_{17}$-heteroaryl)$_2$; and
N($C_3$-$C_{17}$-heteroaryl)($C_6$-$C_{18}$-aryl).

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-6}$ is at each occurrence independently of each other selected from the group consisting of: hydrogen, deuterium, N(Ph)$_2$, OPh (Ph = phenyl), SPh, $CF_3$, CN, F, Si(Me)$_3$, Si(Ph)$_3$,
$C_1$-$C_5$-alkyl,
wherein optionally one or more hydrogen atoms are independently substituted by deuterium, Ph, CN, $CF_3$, or F;
$C_6$-$C_{18}$-aryl,
wherein optionally one or more hydrogen atoms are independently substituted by deuterium, CN, $CF_3$, F, Me, $^i$Pr, $^t$Bu, $SiMe_3$, $SiPh_3$ or Ph;
$C_3$-$C_{17}$-heteroaryl,
wherein optionally one or more hydrogen atoms are independently substituted by deuterium, CN, $CF_3$, F, , Me, $^i$Pr, $^t$Bu, $SiMe_3$, $SiPh_3$ or Ph.

In one embodiment of the invention, in which in at least one, preferably each, light-emitting layer B, at least one,

preferably each, of the one or more small FWHM emitters $S^B$ comprises or consists of a structure according to formula DABNA-I,

$R^{DABNA-6}$ is at each occurrence independently of each other selected from the group consisting of: hydrogen, deuterium, $N(Ph)_2$, CN, F, Me, $^iPr$, $^tBu$,
Ph,
wherein optionally one or more hydrogen atoms are independently substituted by deuterium, CN, Me, $^iPr$, $^tBu$, or Ph;
$C_3$-$C_{17}$-heteroaryl,
wherein optionally one or more hydrogen atoms are independently substituted by deuterium, CN, Me, $^iPr$, $^tBu$, or Ph.

In one embodiment of the invention, in which in at least one, preferably each, light-emitting layer B, at least one, preferably each, of the one or more small FWHM emitters $S^B$ comprises or consists of a structure according to formula DABNA-I,

$R^{DABNA-6}$ is at each occurrence independently of each other selected from the group consisting of: hydrogen, deuterium, Me, $^iPr$, $^tBu$,
Ph,
wherein optionally one or more hydrogen atoms are independently substituted by deuterium, Me, $^iPr$, $^tBu$, or Ph.

In one embodiment of the invention, in which in at least one, preferably each, light-emitting layer B, at least one, preferably each, of the one or more small FWHM emitters $S^B$ comprises or consists of a structure according to formula DABNA-I, when $Y^a$ and/or $Y^b$ is/are $NR^{DABNA-3}$, $C(R^{DABNA-3})_2$, $Si(R^{DABNA-3})_2$, or $BR^{DABNA-3}$, the one or the two substituents $R^{DABNA-3}$ do not bond to one or both of the adjacent rings A' and B' (for $Y^a$ = $NR^{DABNA-3}$, $C(R^{DABNA-3})_2$, $Si(R^{DABNA-3})_2$, or $BR^{DABNA-3}$) or A' and C' (for $Y^b$ = $NR^{DABNA-3}$, $C(R^{DABNA-3})_2$, $Si(R^{DABNA-3})_2$, or $BR^{DABNA-3}$).

In one embodiment, small FWHM emitters $S^B$ in the context of the present invention may optionally also be multimers (e.g. dimers) of the aforementioned formula DABNA-I, which means that their structure comprises more than one subunits, each of which has a structure according to formula DABNA-I. In this case, the skilled artisan will understand that the two or more subunits according to formula DABNA-I may for example be conjugated, preferably fused to each other (i.e. sharing at least one bond, wherein the respective substituents attached to the atoms forming that bond may no longer be present). The two or more subunits may also share at least one, preferably exactly one, aromatic or heteroaromatic ring. This means that, for example, a small FWHM emitter $S^B$ may comprise two or more subunits each having a structure of formula DABNA-I, wherein these two subunits share one aromatic or heteroaromatic ring (i.e. the respective ring is part of both subunits). As a result, the respective multimeric (e.g., dimeric) emitter $S^B$ may not contain two whole subunits according to formula DABNA-I as the shared ring is only present once. Nevertheless, the skilled artisan will understand that herein, such an emitter is still considered a multimer (for example a dimer if two subunits having a structure of formula DABNA-I are comprised) of formula DABNA-I. The same holds true for multimers sharing more than one ring. It is preferred that the multimers are dimers comprising two subunits, each having a structure of formula DABNA-I.

In one embodiment of the invention, in at least one, preferably each, light-emitting layer B, at least one, preferably each small FWHM emitter $S^B$, is a dimer of formula DABNA-I as described above, which means that the emitter comprises two subunits, each having a structure according to formula DABNA-I.

In one embodiment of the invention, in at least one, preferably each, light-emitting layer B, at least one, preferably each, of the one or more small FWHM emitters $S^B$ comprises or consists of two or more, preferably of exactly two, structures according to formula DABNA-I (i.e. subunits),
wherein these subunits share at least one, preferably exactly one, aromatic or heteroaromatic ring (i.e. this ring may be part of both structures of formula DABNA-I) and wherein the shared ring(s) may be any of the rings A', B', and C' of formula DABNA-I, but may also be any aromatic or heteroaromatic substituent selected from $R^{DABNA-1}$, $R^{DABNA-2}$, $R^{DABNA-3}$, $R^{DABNA-4}$, $R^{DABNA-5}$, and $R^{DABNA-6}$, in particular $R^{DABNA-3}$, or any aromatic or heteroaromatic ring formed by two or more adjacent substituents as stated above, wherein the shared ring may constitute the same or different moieties of the two or more structures of formula DABNA-I that share the ring (i.e. the shared ring may for example be ring C' of both structures of formula DABNA-I optionally comprised in the emitter or the shared ring may for example be ring B' of one and ring C' of the other structure of formula DABNA-I optionally comprised in the emitter).

In one embodiment of the invention, in at least one, preferably each, light-emitting layer B, at least one, preferably each, of the one or more small FWHM emitters $S^B$ comprises or consists of two or more, preferably of exactly two, structures according to formula DABNA-I (i.e. subunits),
wherein at least one of $R^{DABNA-1}$, $R^{DABNA-2}$, $R^{DABNA-3}$, $R^{DABNA-4}$, $R^{DABNA-5}$, and $R^{DABNA-6}$ is replaced by a bond to a further chemical entity of formula DABNA-I and/or wherein at least one hydrogen atom of any of $R^{DABNA-1}$, $R^{DABNA-2}$, $R^{DABNA-3}$, $R^{DABNA-4}$, $R^{DABNA-5}$, and $R^{DABNA-6}$ is replaced by a bond to a further chemical entity of formula DABNA-I.

Non-limiting examples of emitters comprising or consisting of a structure according to formula DABNA-I that may

be used as small FWHM emitters $S^B$ according to the present invention are listed below.

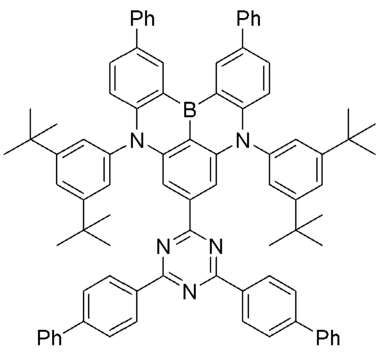
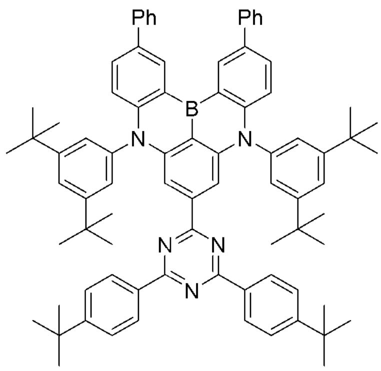
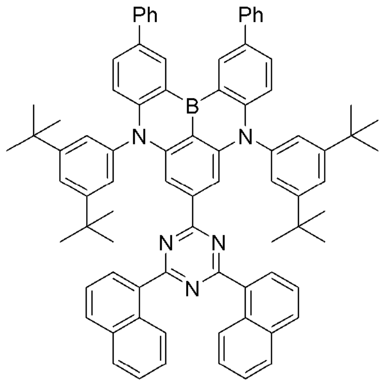
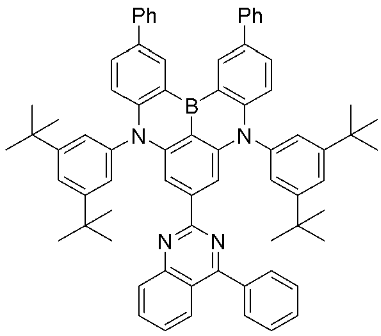
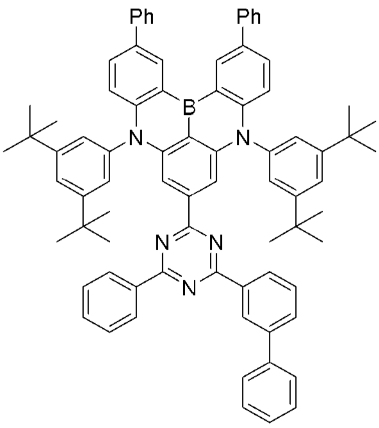
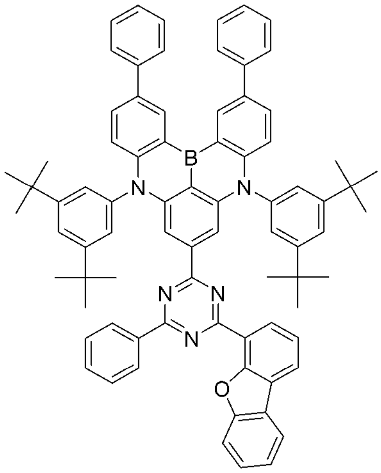
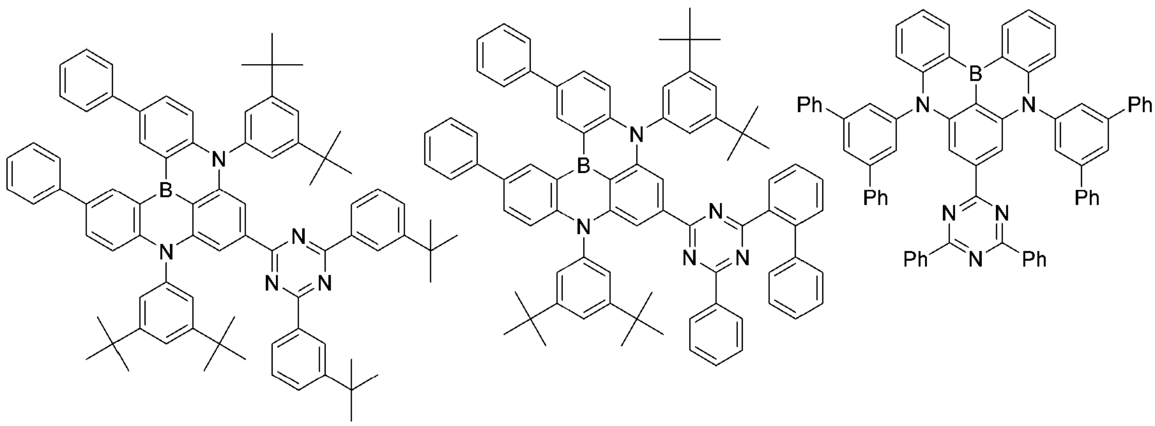

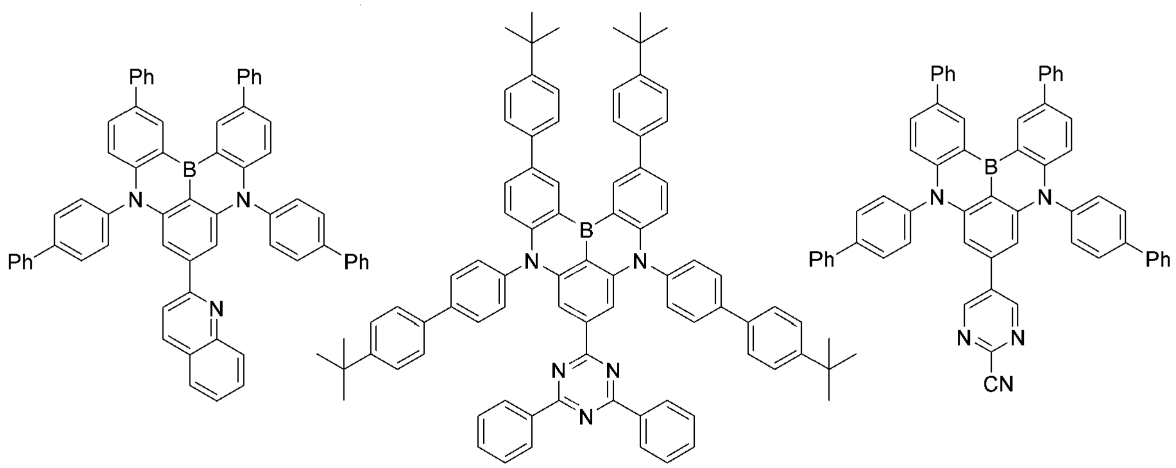

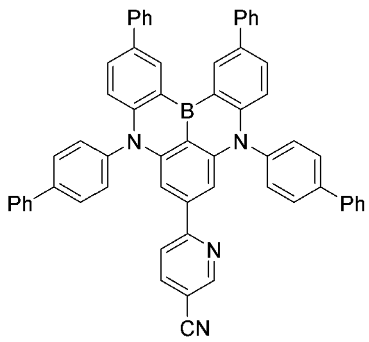

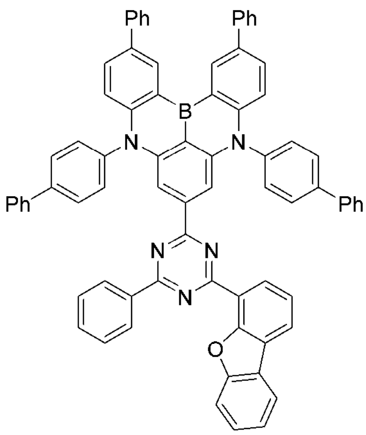

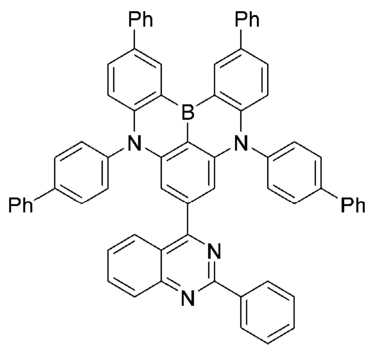

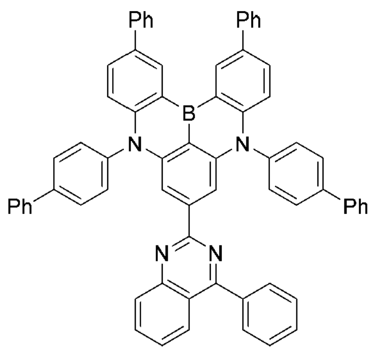

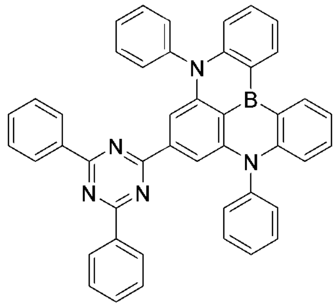

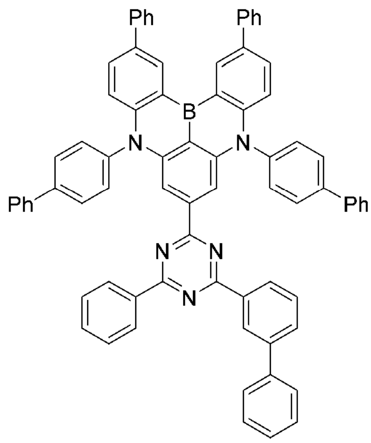

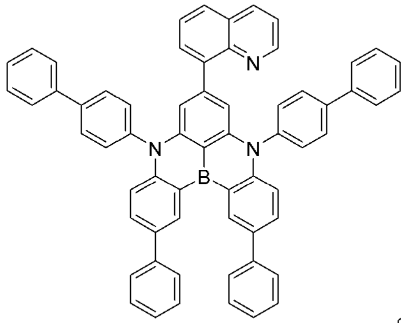
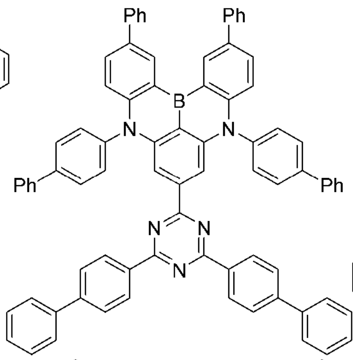
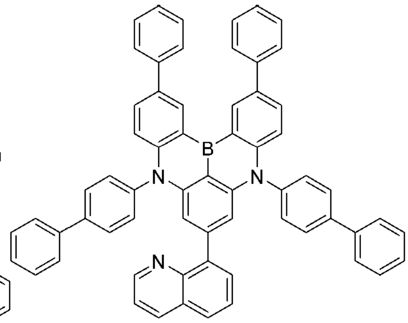
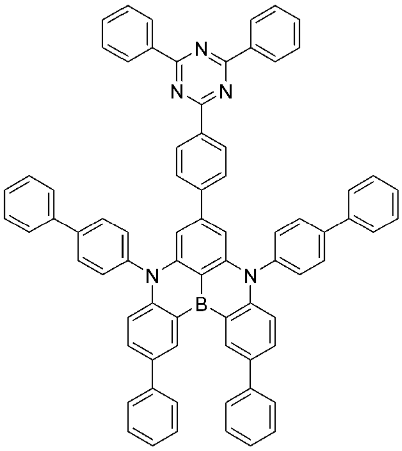
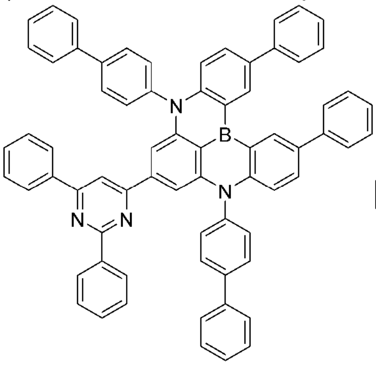
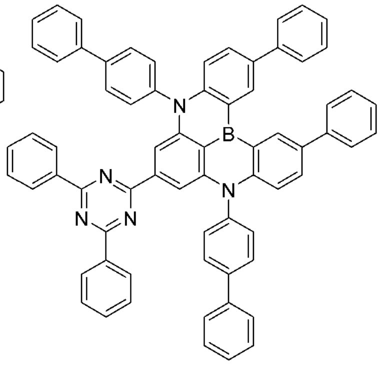
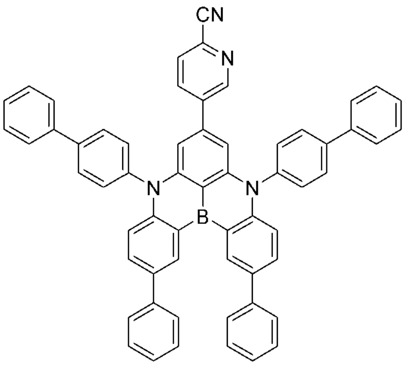
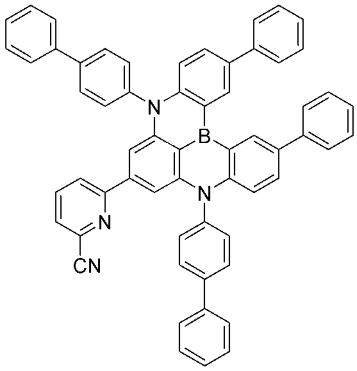
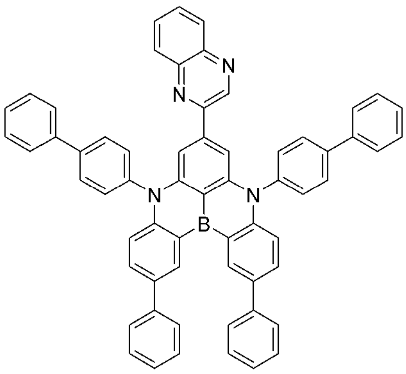
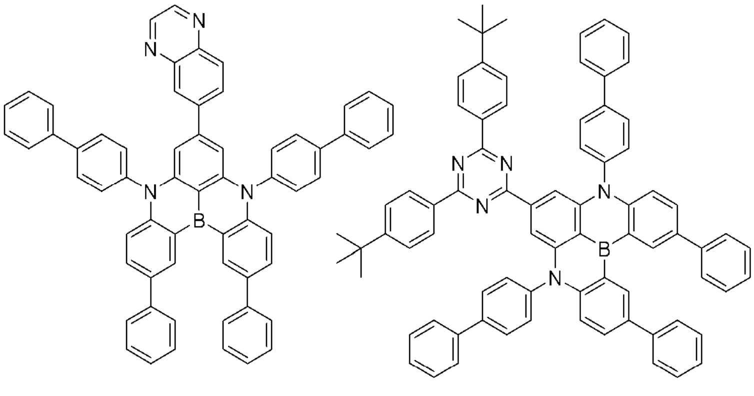
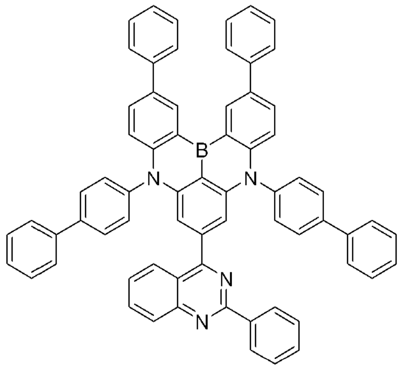

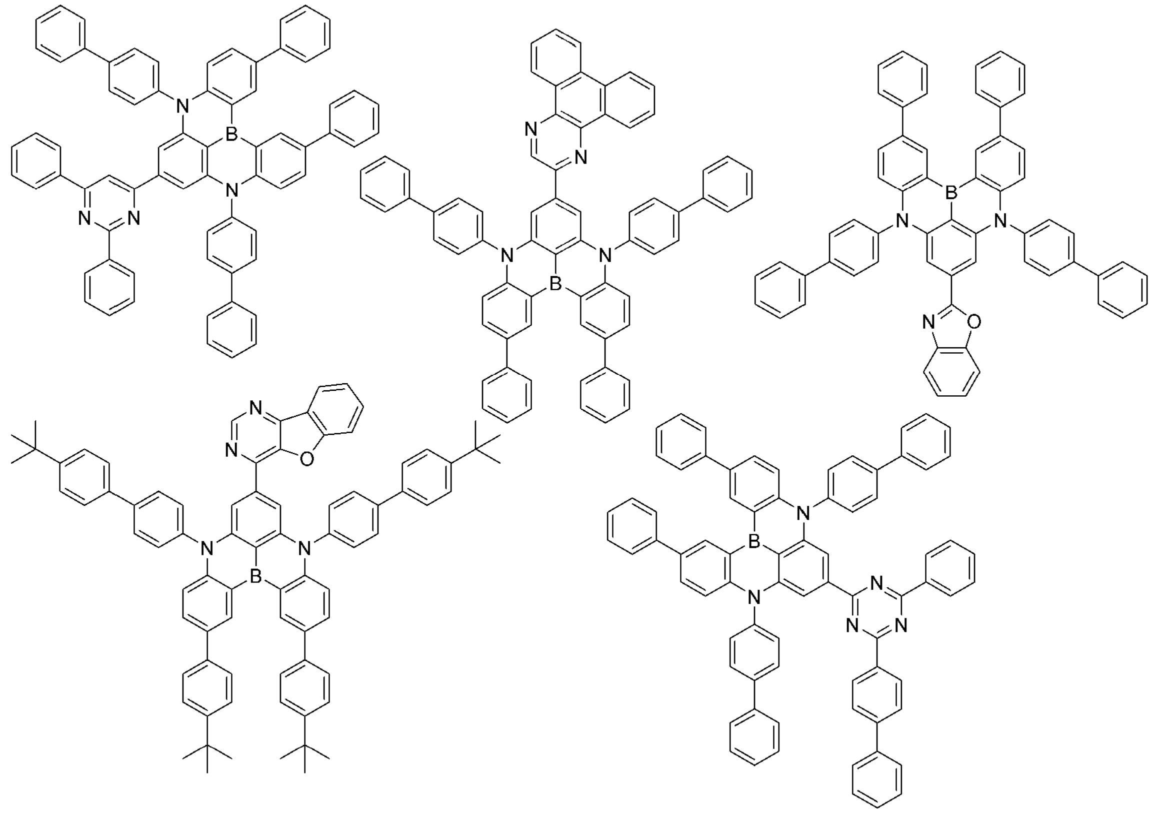

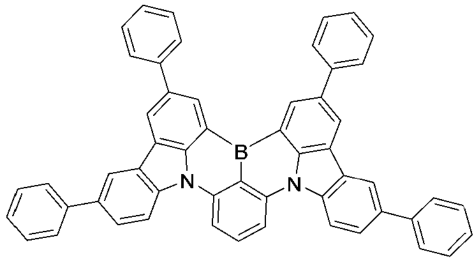

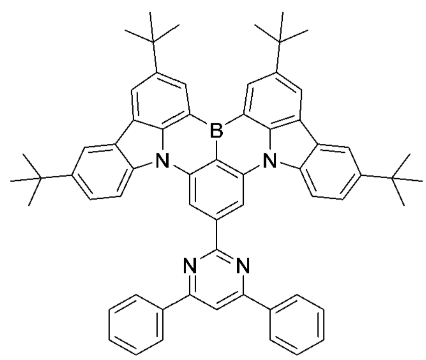

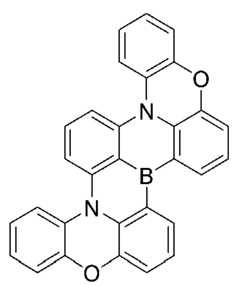

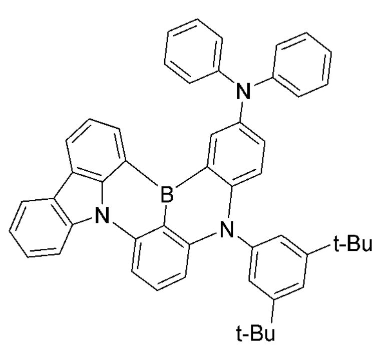

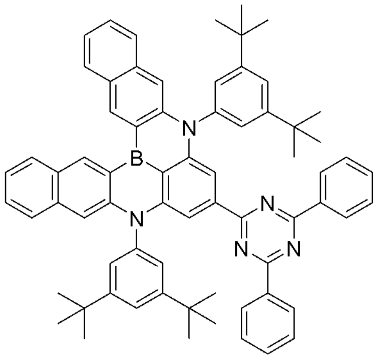

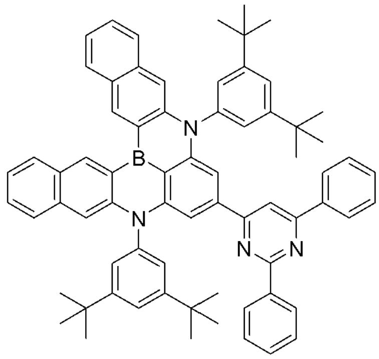

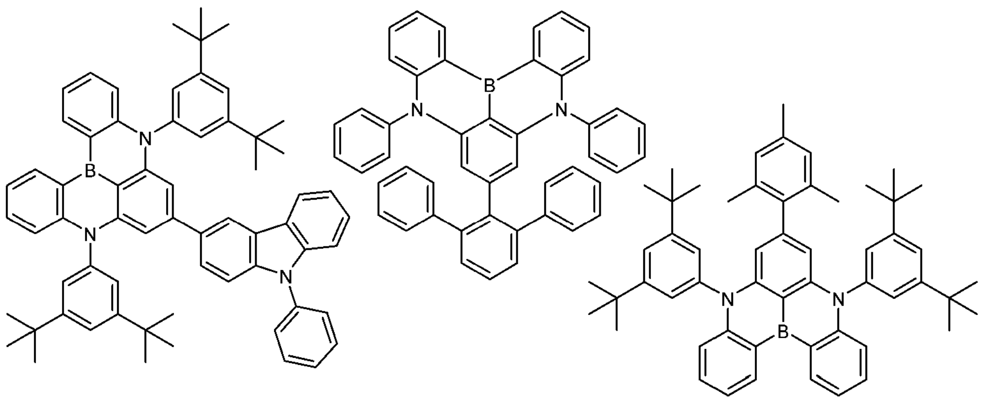

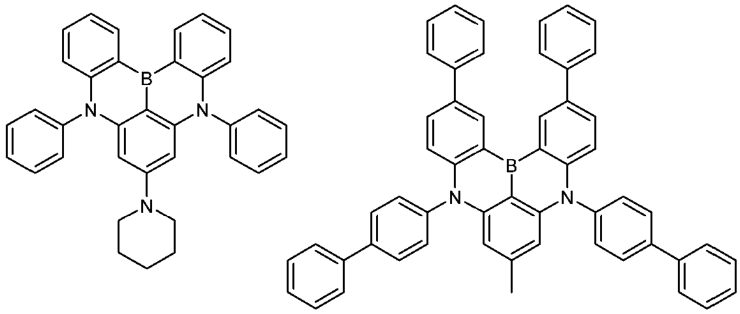

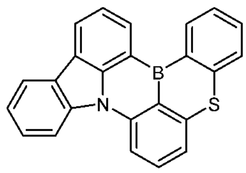

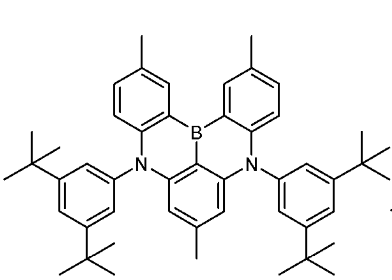

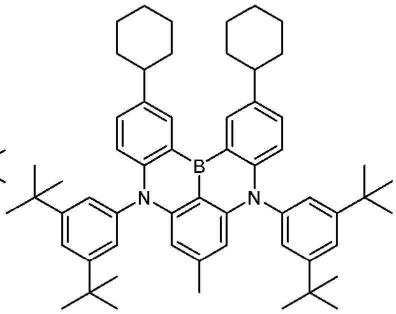

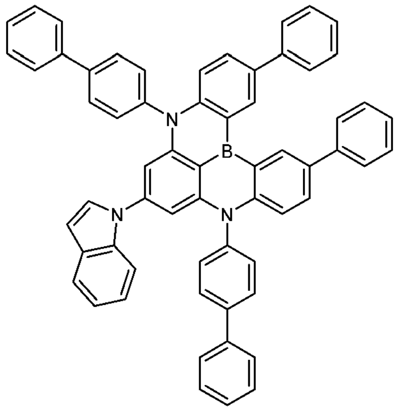

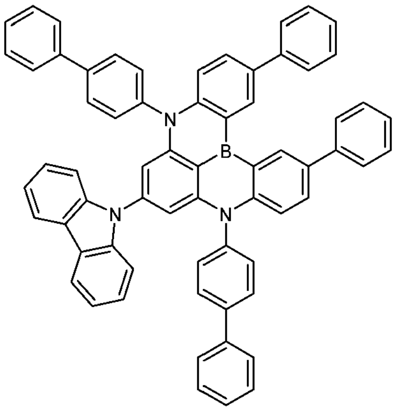

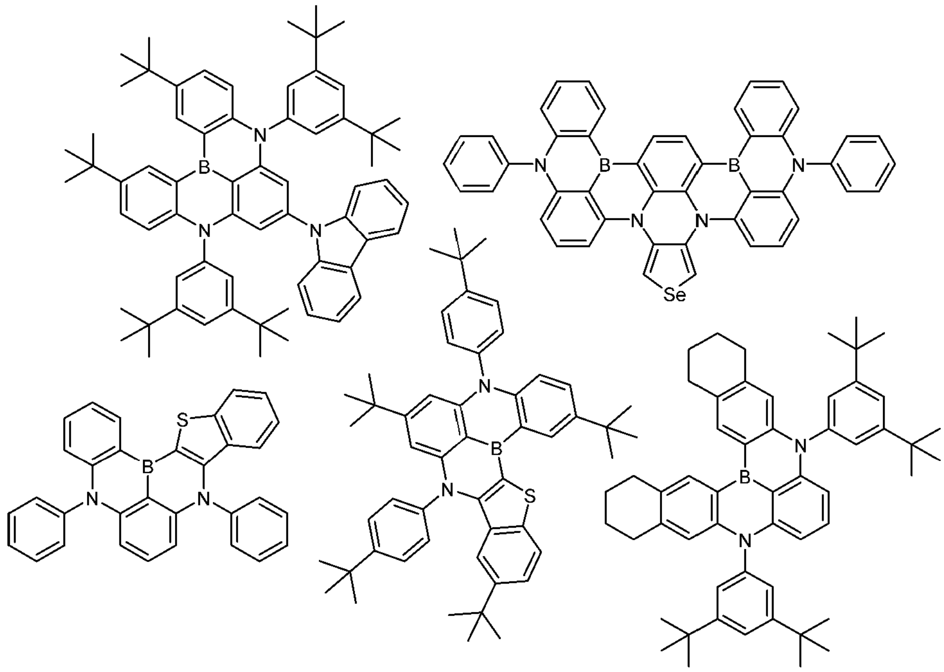

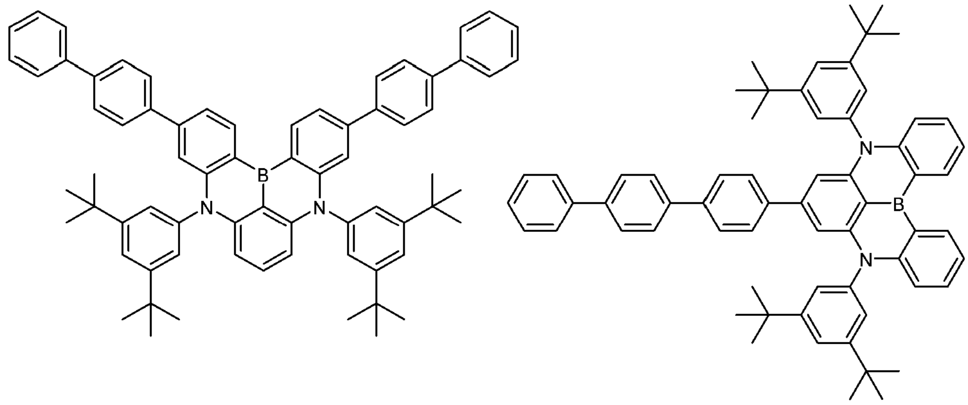

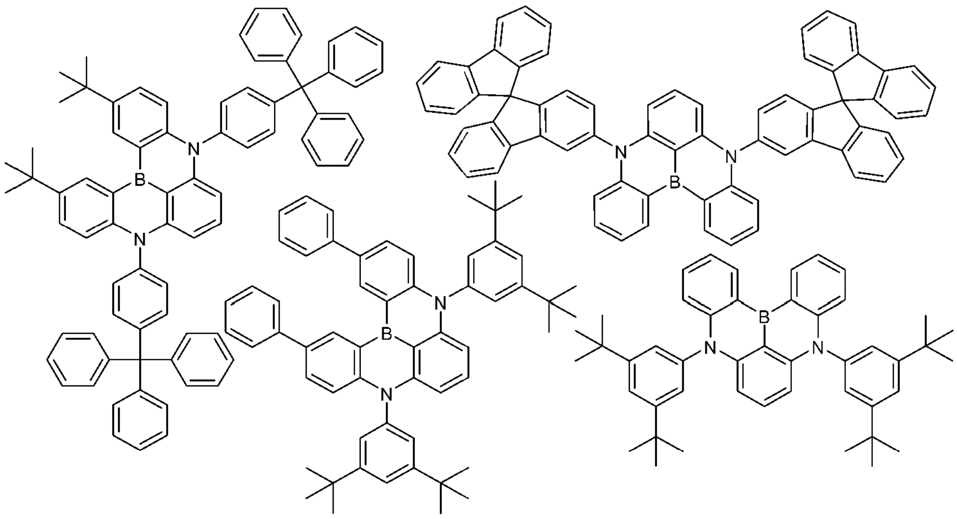

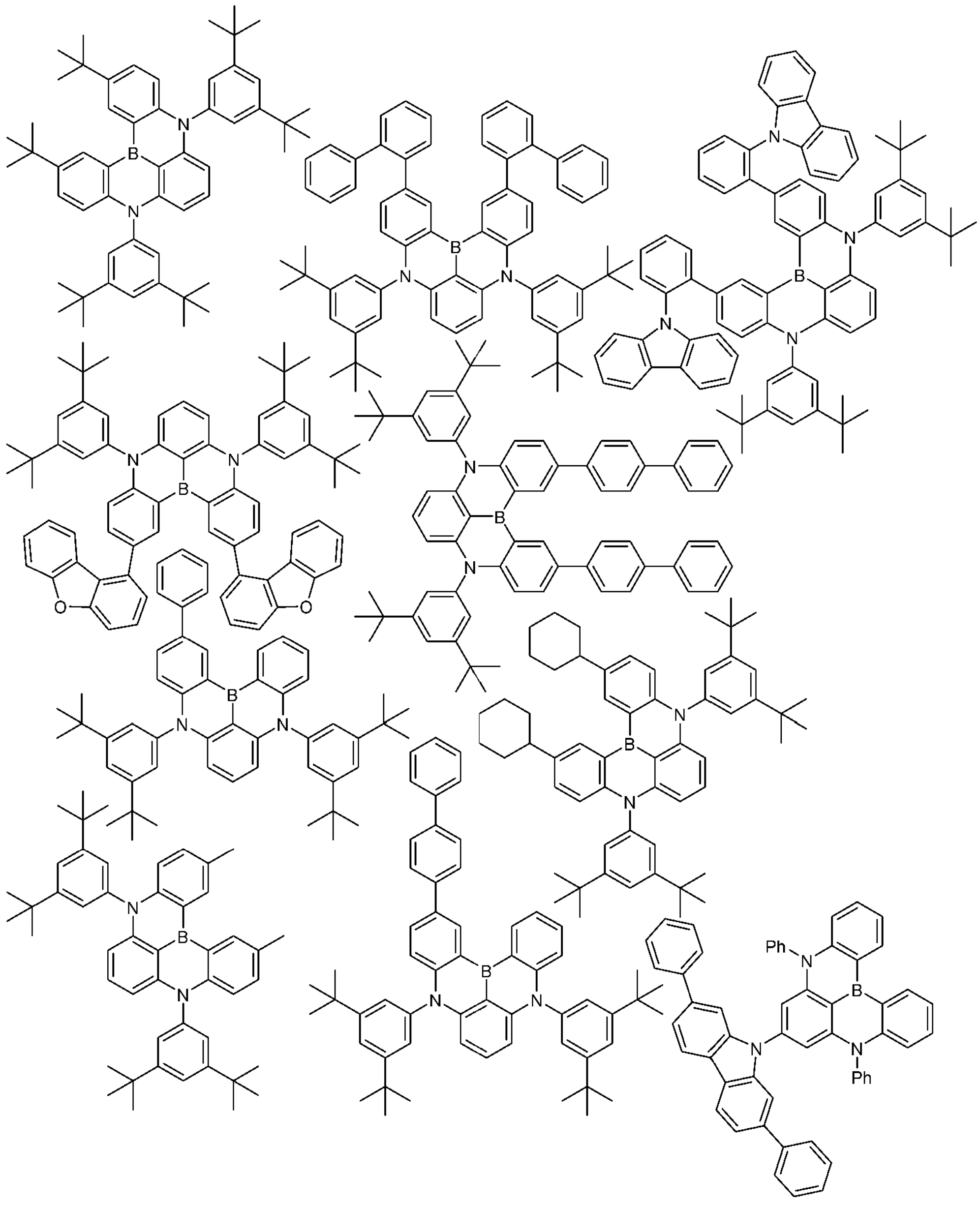

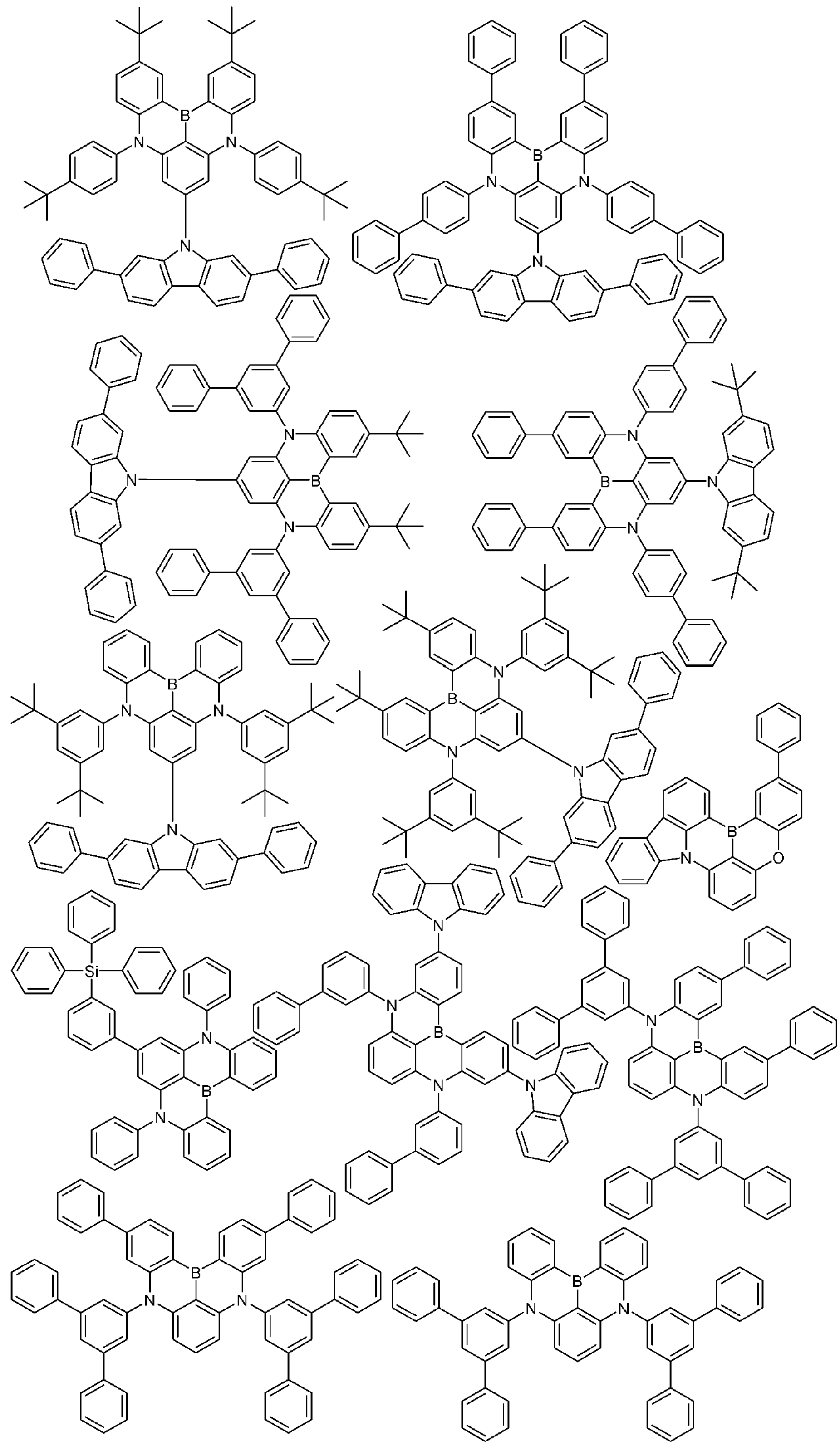

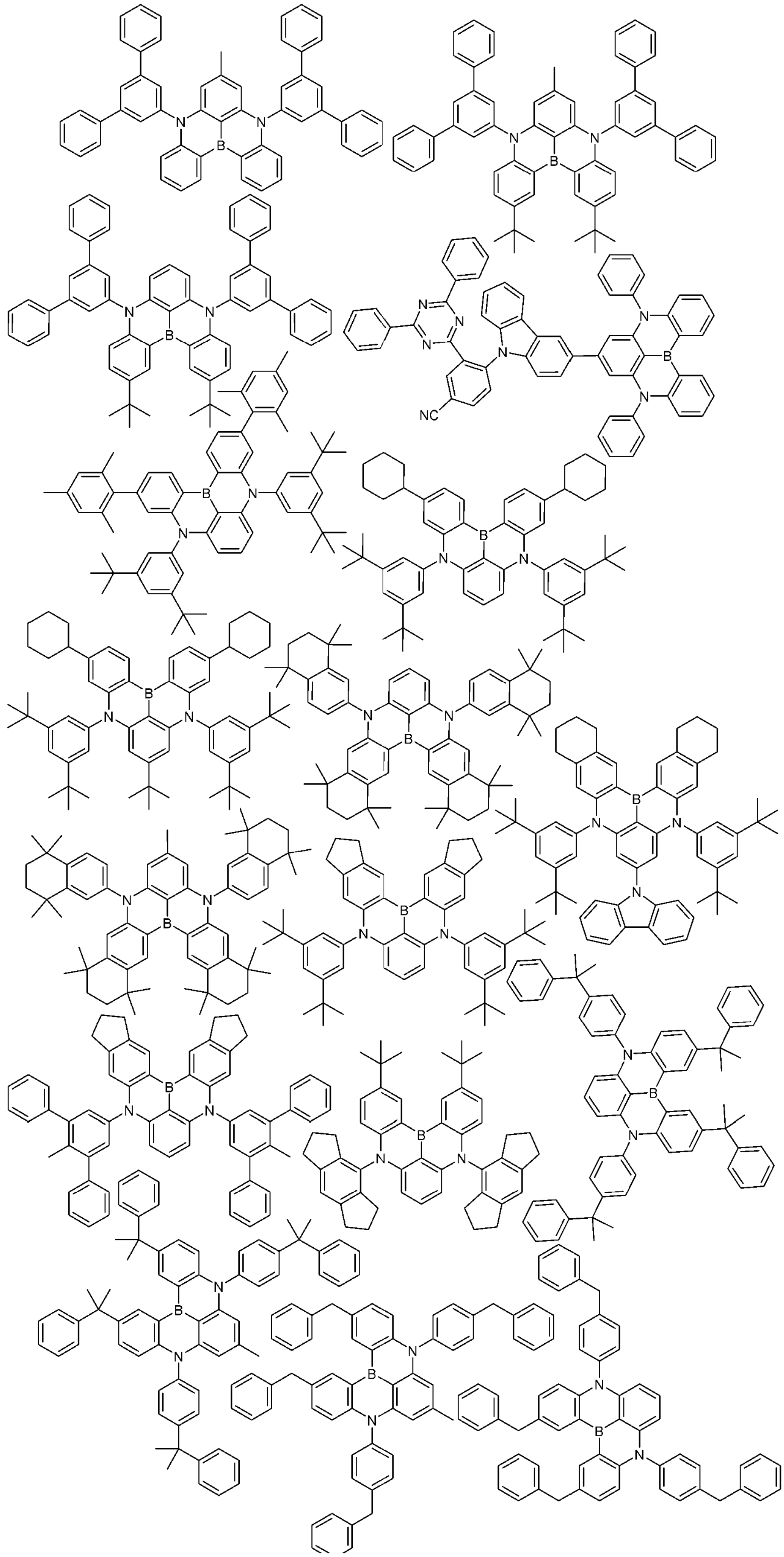

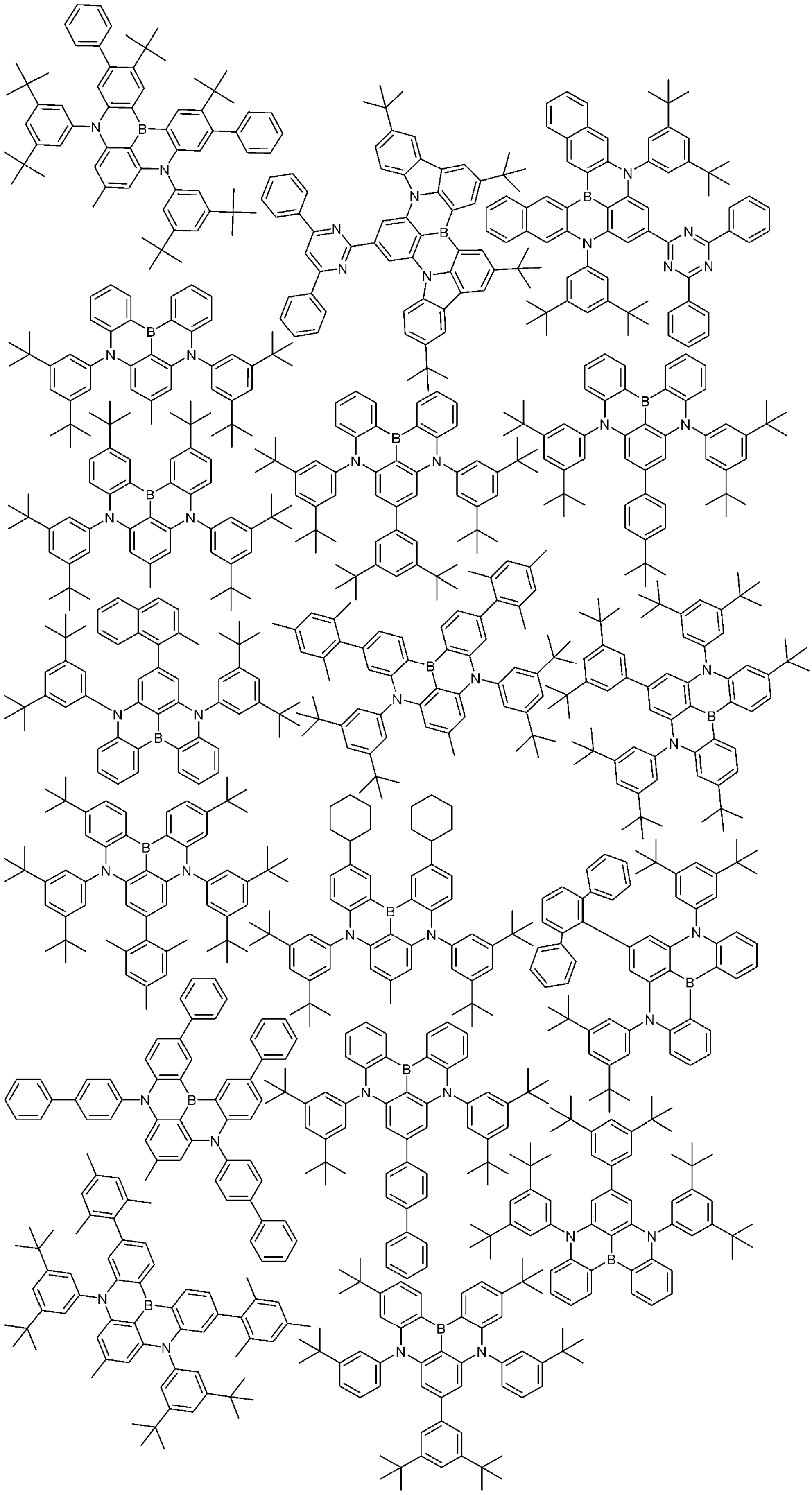

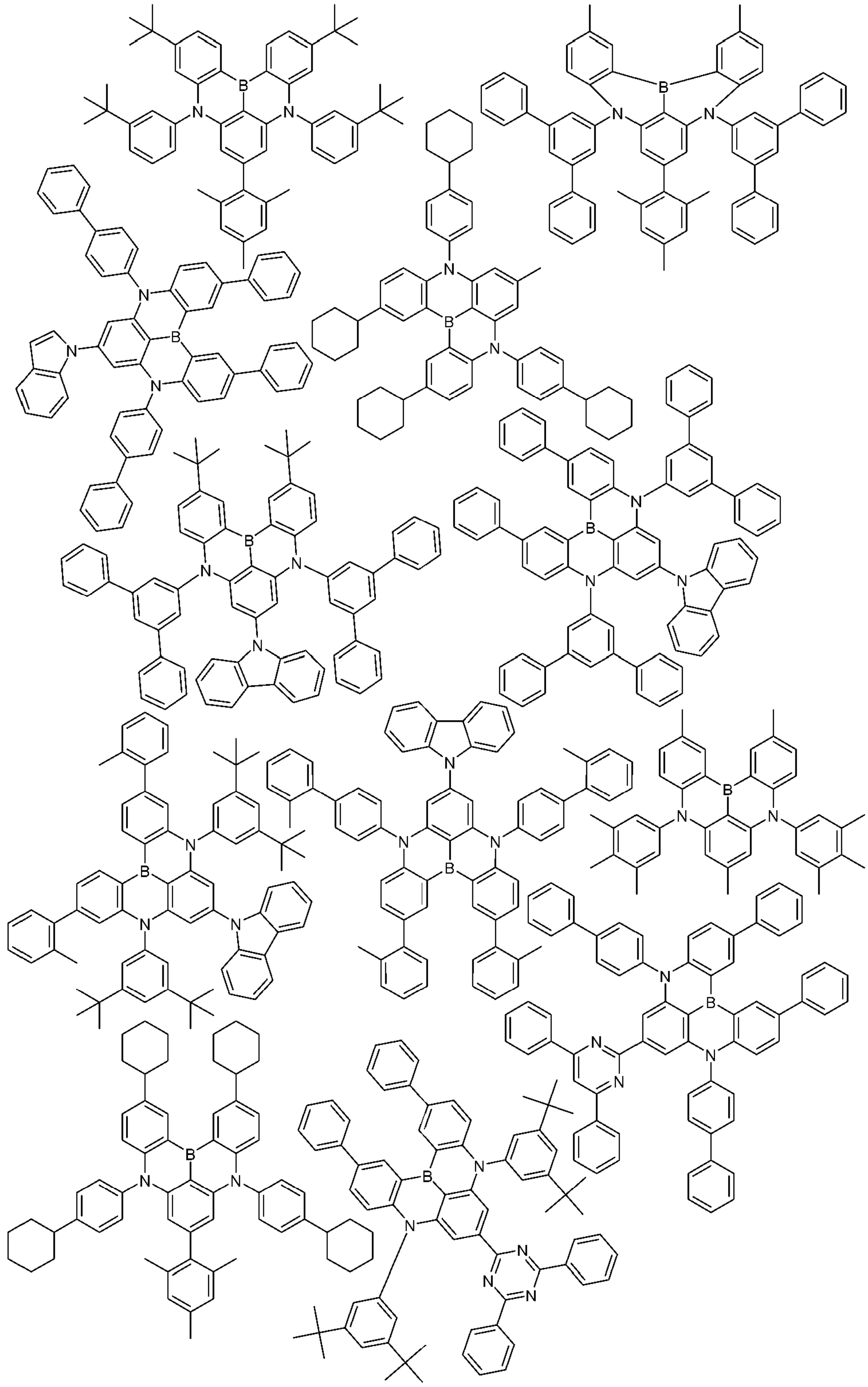

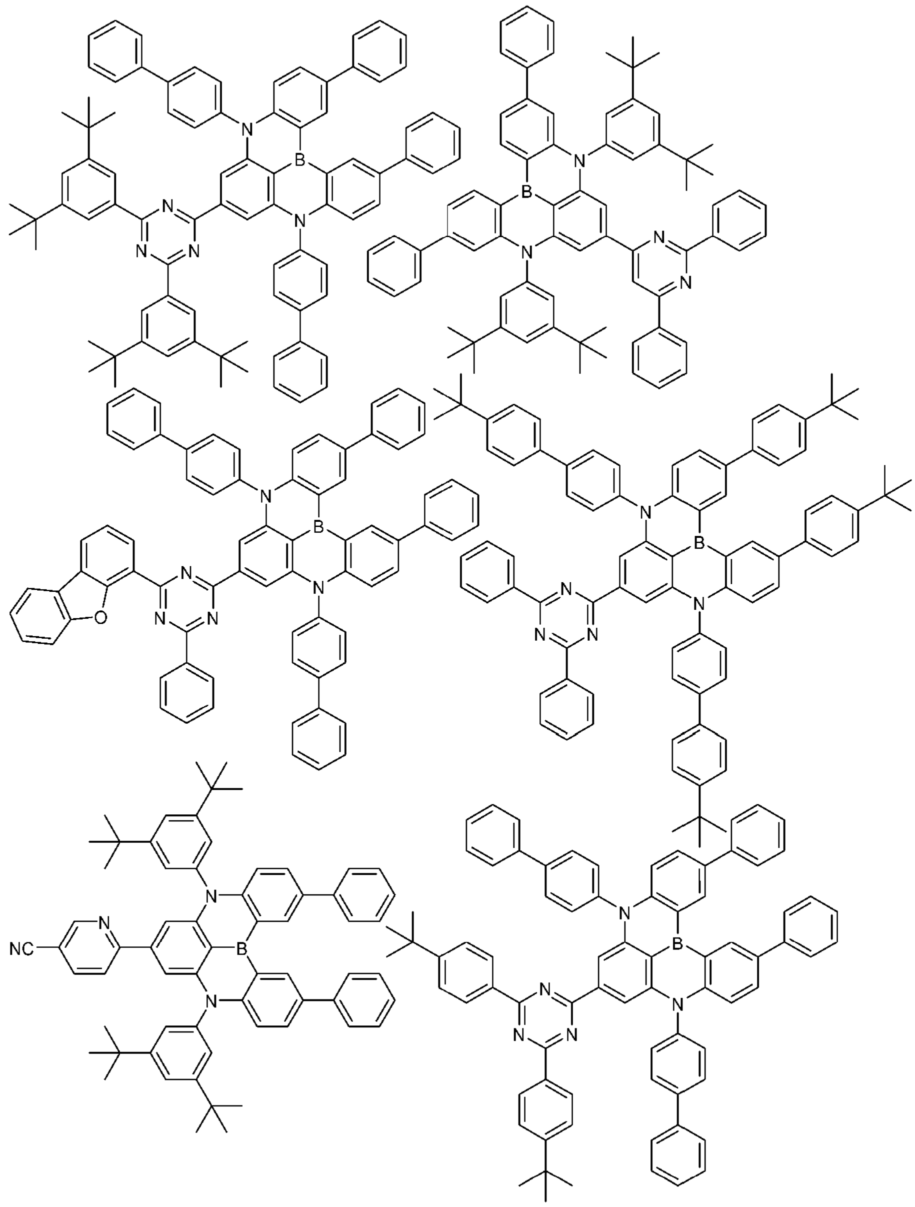

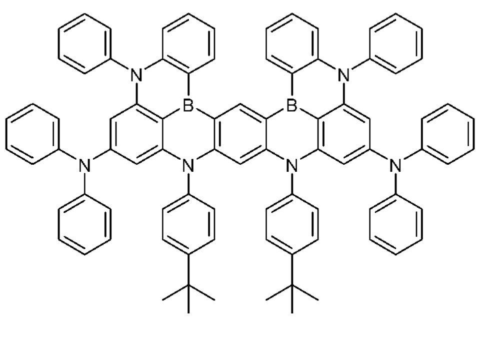

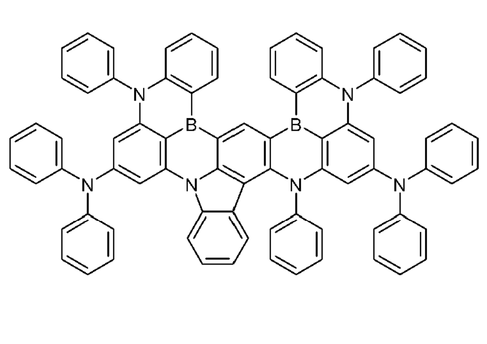

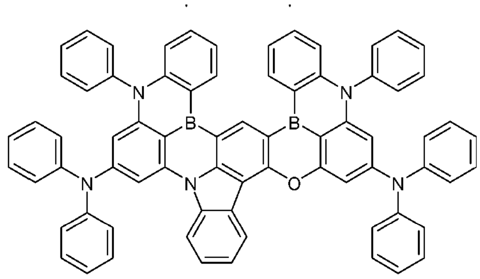

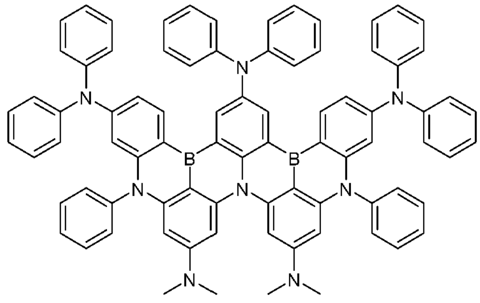

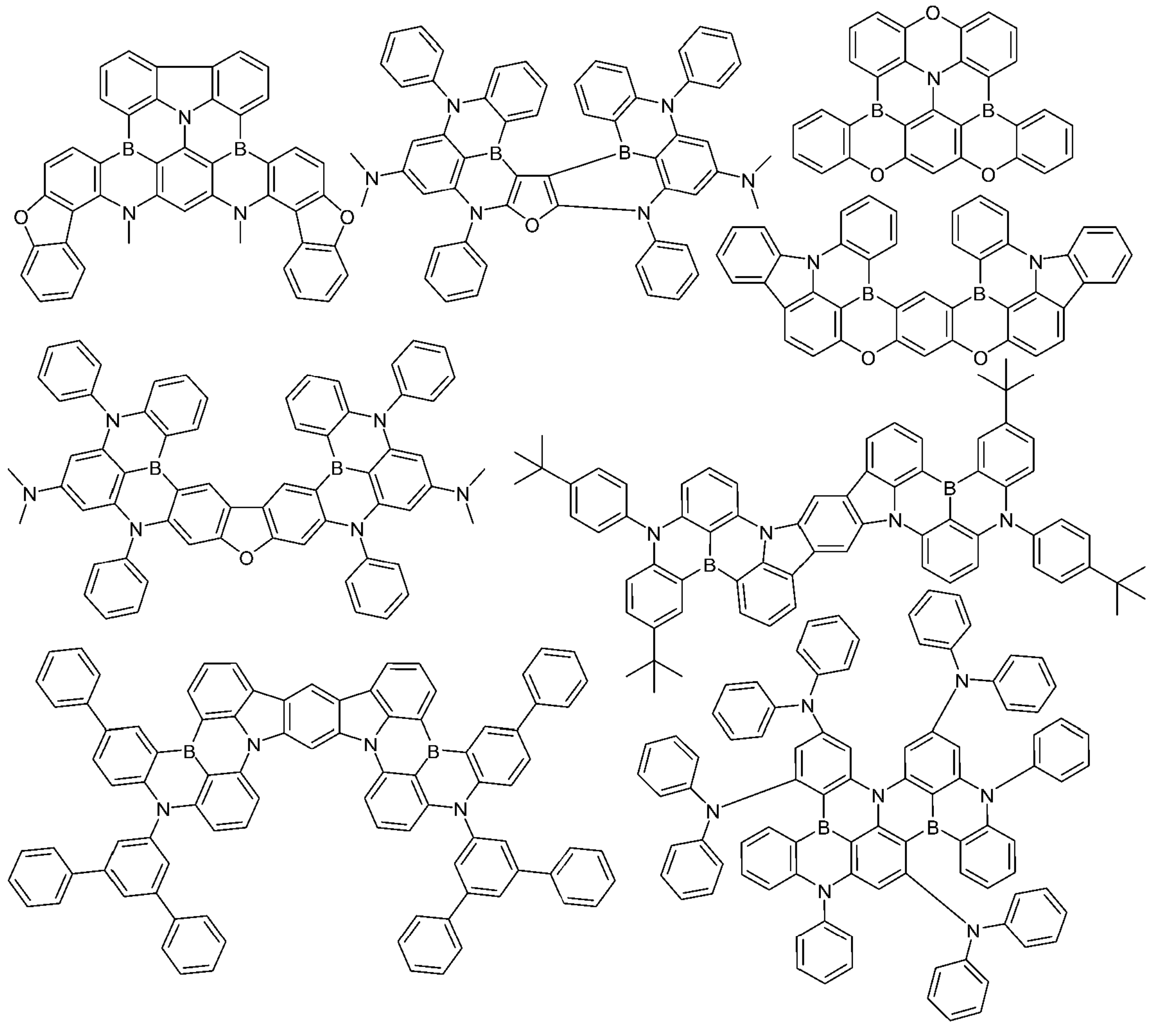

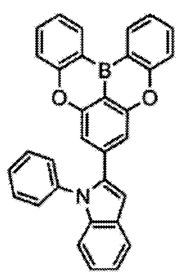

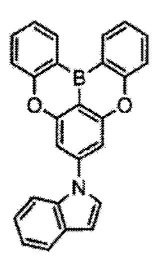

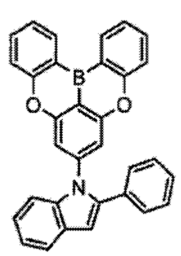

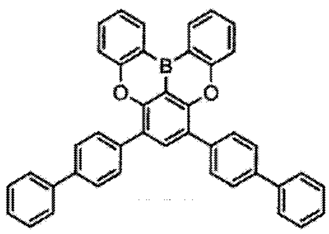
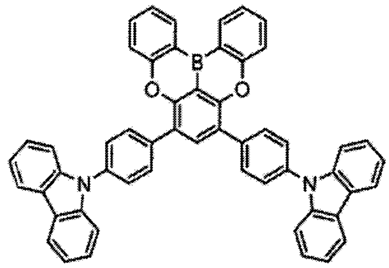

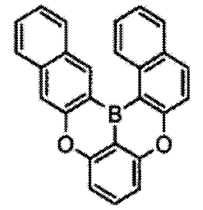
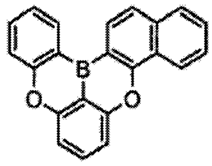
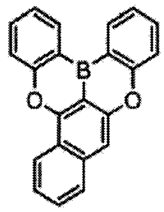
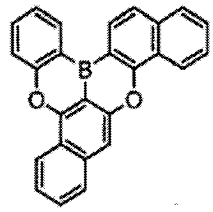

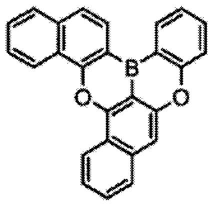
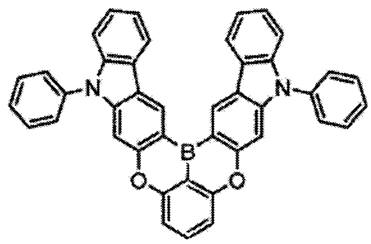
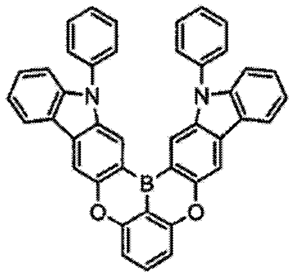

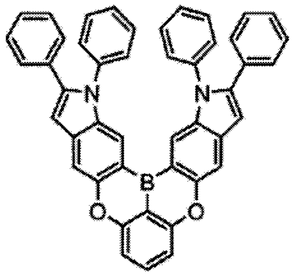
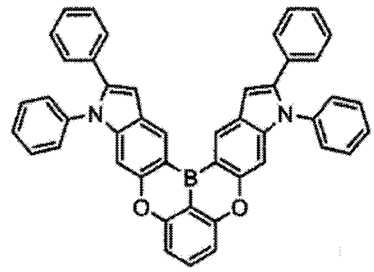
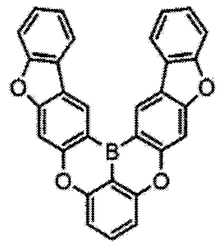

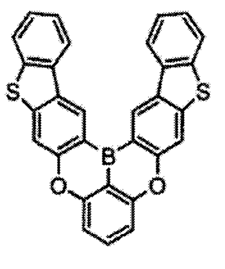
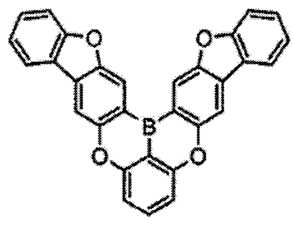
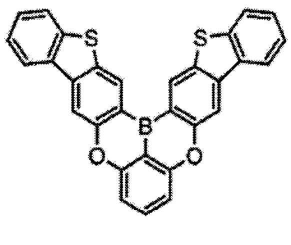

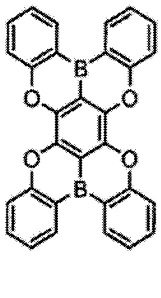
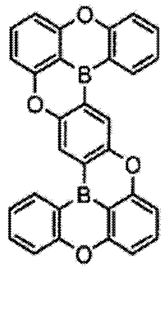
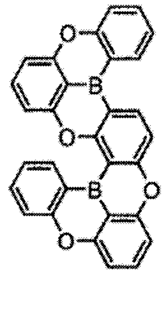
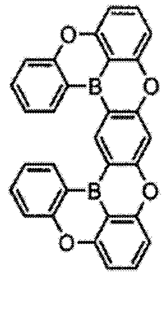

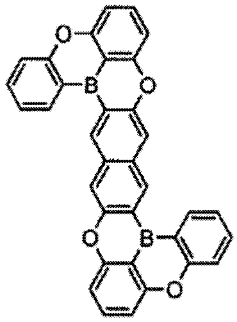
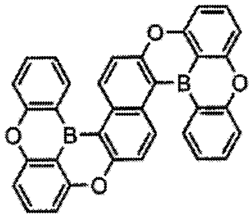
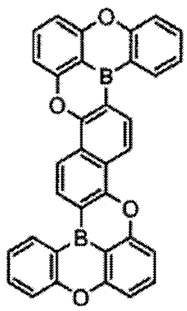
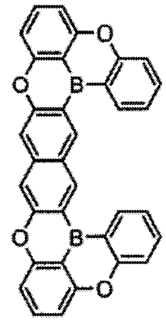

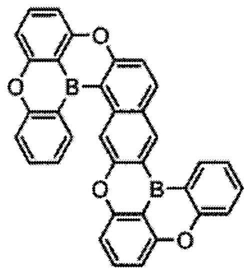
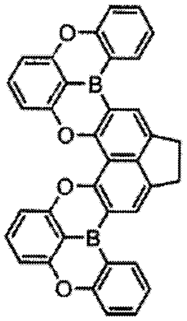
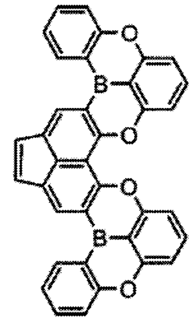

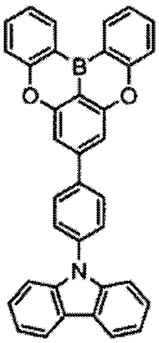
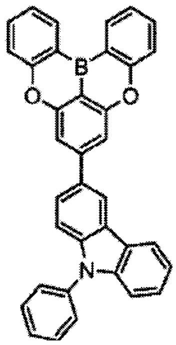
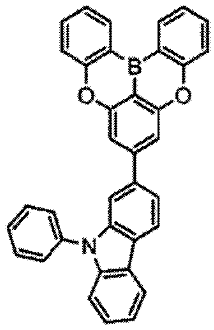

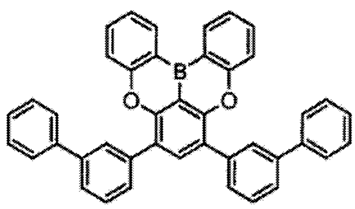
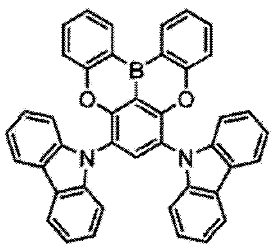
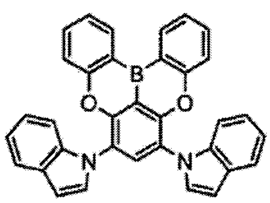

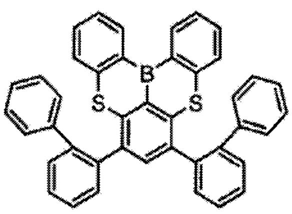
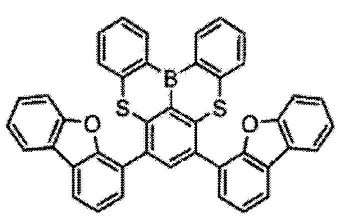
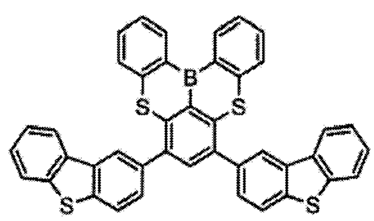

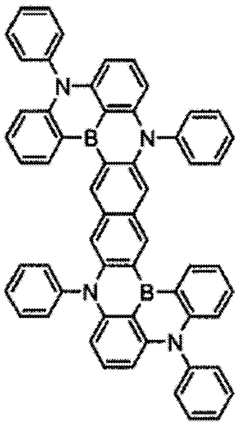

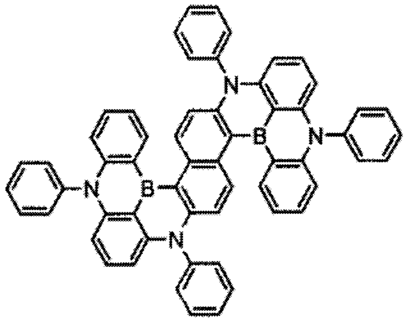

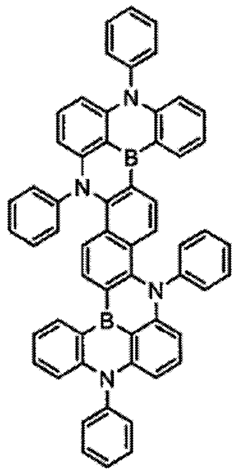

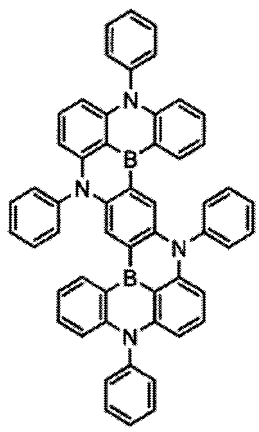

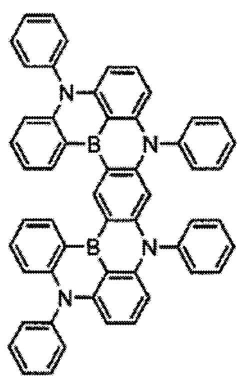

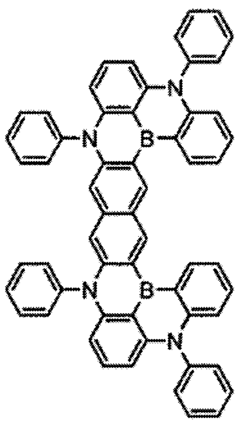

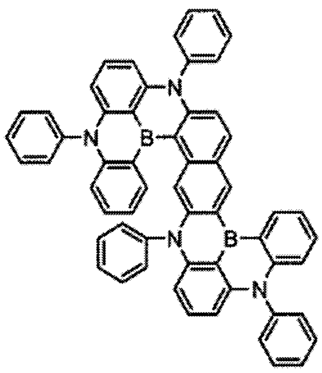

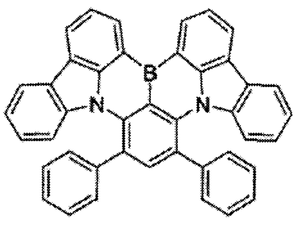

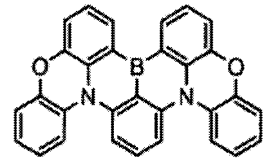
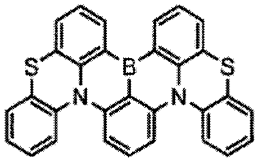
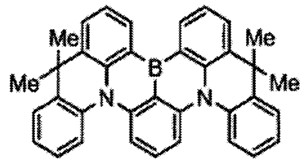
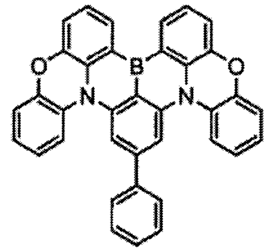
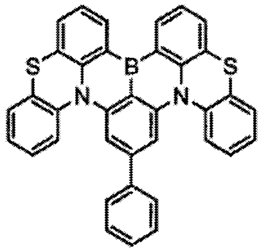
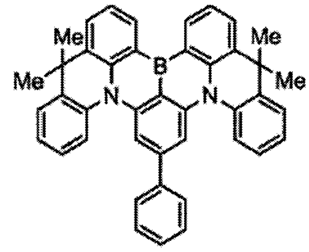
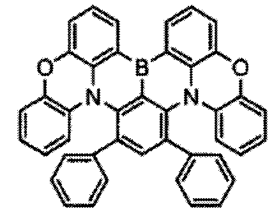
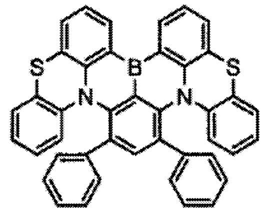
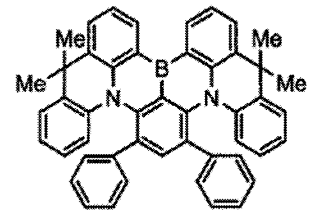
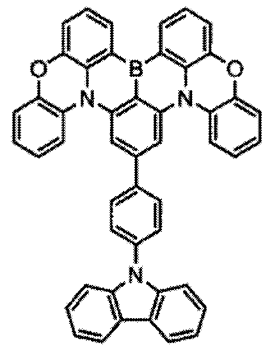
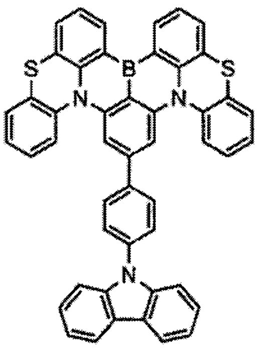
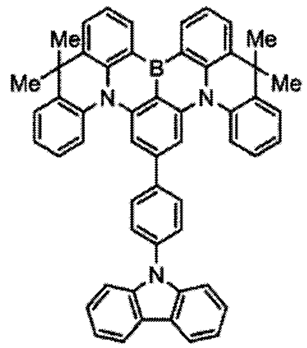
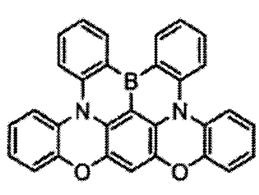
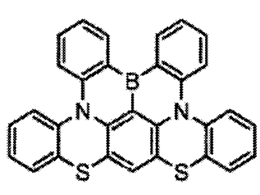
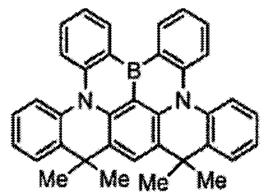
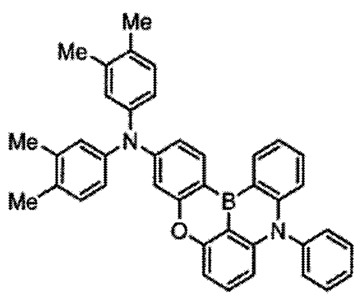
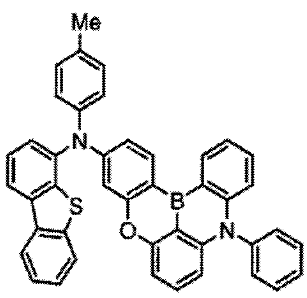
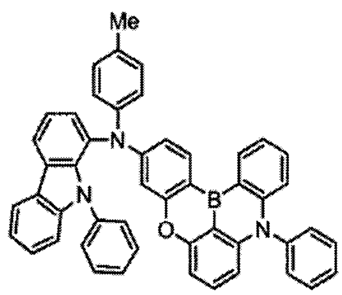

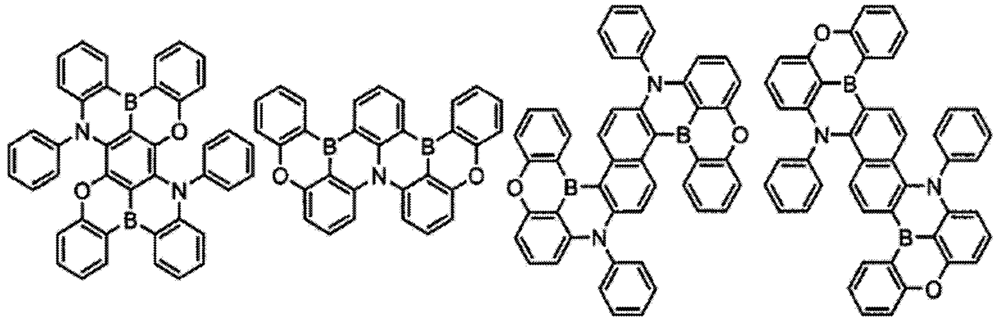

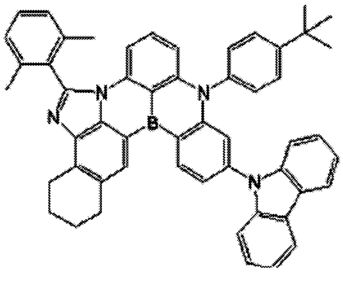

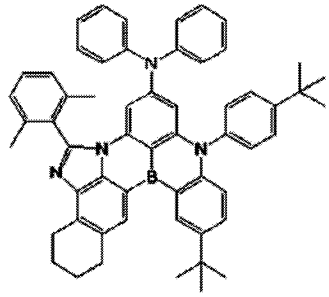

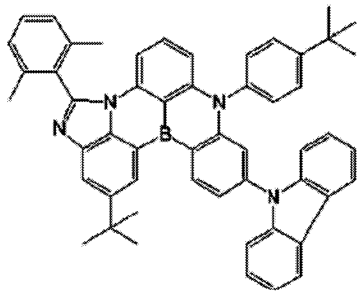

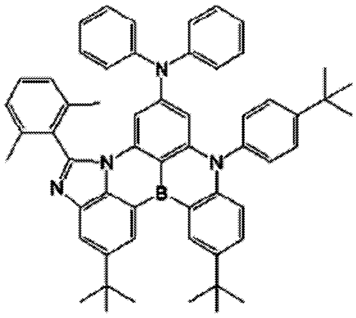

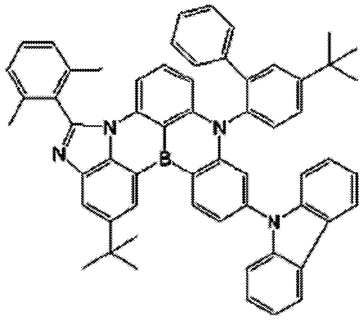

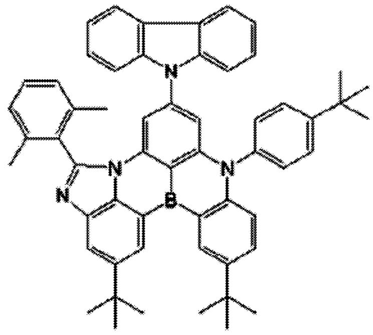

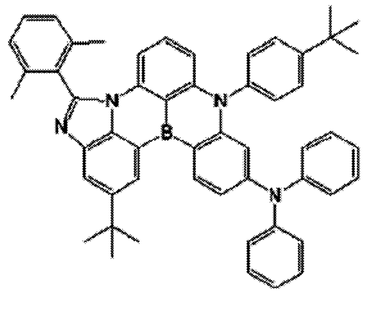

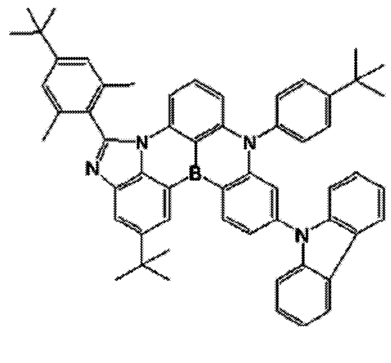

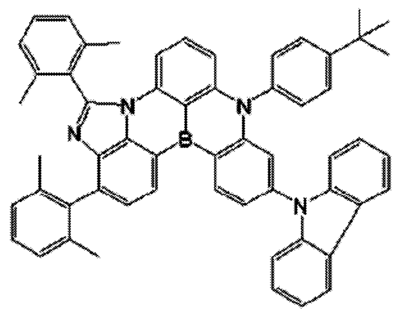

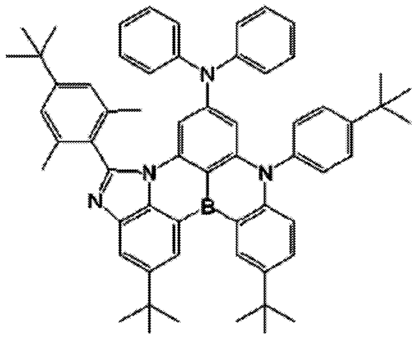

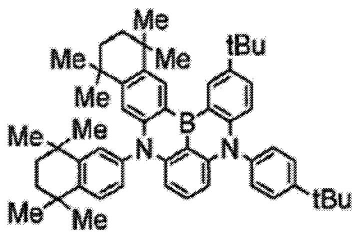
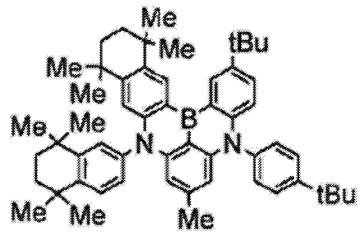
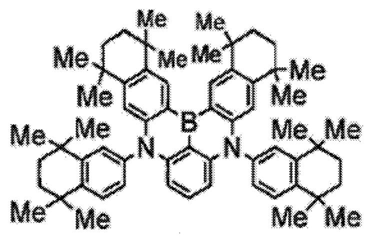

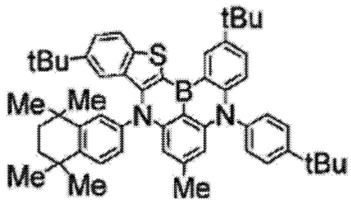
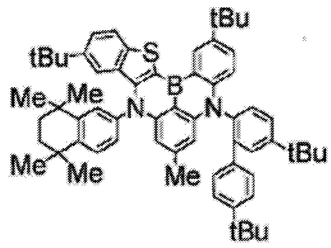
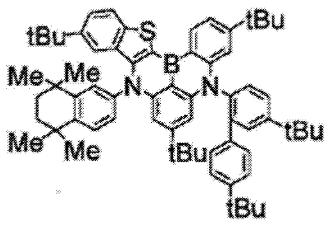

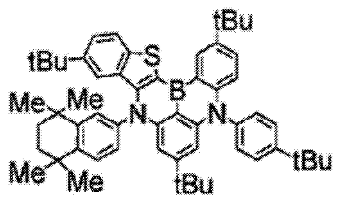
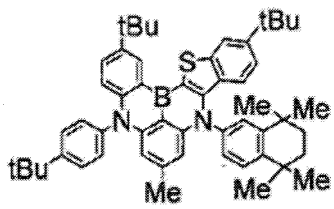
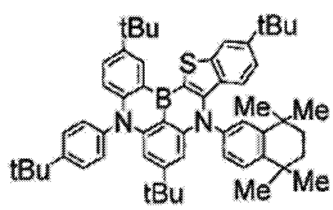

A group of emitters that may be used as small FWHM emitters $S^B$ in the context of the present invention are emitters comprising or consisting of a structure according to the following formula BNE-1:

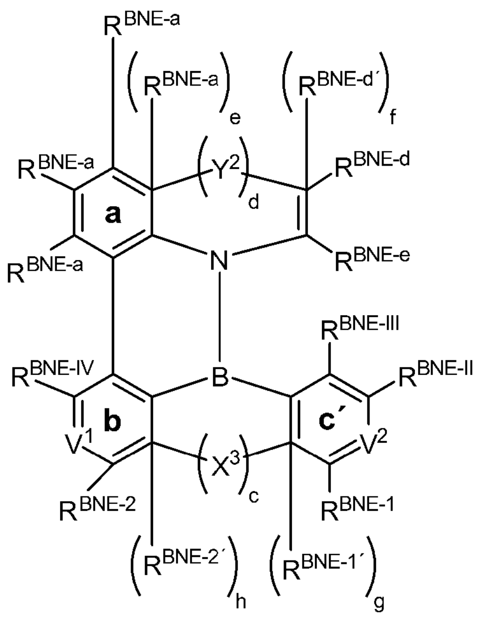

Formula BNE-1,

wherein,

c and d are both integers and independently of each other selected from 0 and 1;
e and f are both integers and selected from 0 and 1, wherein e and f are (always) identical (i.e. both 0 or both 1);
g and h are both integers and selected from 0 and 1, wherein g and h are (always) identical (i.e. both 0 or both 1);
if d is 0, e and f are both 1, and if d is 1, e and f are both 0;
if c is 0, g and h are both 1, and if c is 1, g and h are both 0;

$V^1$ is selected from nitrogen (N) and $CR^{BNE-V}$;
$V^2$ is selected from nitrogen (N) and $CR^{BNE-I}$;
$X^3$ is selected from the group consisting of a direct bond, $CR^{BNE-3}R^{BNE-4}$, $C=CR^{BNE-3}R^{BNE-4}$, C=O, $C=NR^{BNE-3}$, $NR^{BNE-3}$, O, $SiR^{BNE-3}R^{BNE-4}$, S, S(O) and $S(O)_2$;
$Y^2$ is selected from the group consisting of a direct bond, $CR^{BNE-3'}R^{BNE-4'}$, $C=CR^{BNE-3'}R^{BNE-4'}$, C=O, $C=NR^{BNE-3'}$, $NR^{BNE-3'}$, O, $SiR^{BNE-3'}R^{BNE-4'}$, S, S(O) and $S(O)_2$;
$R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$, $R^{BNE-IV}$, and $R^{BNE-V}$ are each independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,
$C_1$-$C_{40}$-alkyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-alkoxy,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-thioalkoxy,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkenyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkynyl,
which is optionally substituted with one or more substituents $R^{BNE-5}$ and wherein one or more non-adjacent $CH_2$-groups are optionally substituted by $R^{BNE-5}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{60}$-aryl,
which is optionally substituted with one or more substituents $R^{BNE-5}$; and
$C_2$-$C_{57}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,
$C_1$-$C_{40}$-alkyl,
which is optionally substituted with one or more substituents $R^{BNE-a}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-alkoxy,
which is optionally substituted with one or more substituents $R^{BNE-a}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-thioalkoxy,
which is optionally substituted with one or more substituents $R^{BNE-a}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkenyl,
which is optionally substituted with one or more substituents $R^{BNE-a}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkynyl,
which is optionally substituted with one or more substituents $R^{BNE-a}$ and wherein one or more non-adjacent $CH_2$-groups are optionally substituted by $R^{BNE}$-$C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{60}$-aryl,
which is optionally substituted with one or more substituents $R^{BNE-a}$; and
$C_2$-$C_{57}$-heteroaryl,

which is optionally substituted with one or more substituents $R^{BNE-a}$;
$R^{BNE-a}$ is at each occurrence independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,
$C_1$-$C_{40}$-alkyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-alkoxy,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-thioalkoxy,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkenyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkynyl,
which is optionally substituted with one or more substituents $R^{BNE-5}$ and wherein one or more non-adjacent $CH_2$-groups are optionally substituted by $R^{BNE-}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{60}$-aryl,
which is optionally substituted with one or more substituents $R^{BNE-5}$; and
$C_2$-$C_{57}$-heteroaryl,
which is optionally substituted with one or more substituents $R^{BNE-5}$;
$R^{BNE-5}$ is at each occurrence independently of each other selected from the group consisting of: hydrogen, deuterium, $N(R^{BNE-6})_2$, $OR^{BNE-6}$, $Si(R^{BNE-6})_3$, $B(OR^{BNE-6})_2$, $B(R^{BNE-6})_2$, $OSO_2R^{BNE-6}$, $CF_3$, CN, F, Cl, Br, I,
$C_1$-$C_{40}$-alkyl,
which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_1$-$C_{40}$-alkoxy,
which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_1$-$C_{40}$-thioalkoxy,
which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-5})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_2$-$C_{40}$-alkenyl,
which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_2$-$C_{40}$-alkynyl, which is optionally substituted with one or more substituents $R^{BNE-6}$ and wherein one or more non-adjacent $CH_2$-groups are optionally substituted by $R^{BNE-6}C=CR^{BNE-6}$, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_6$-$C_{60}$-aryl,
which is optionally substituted with one or more substituents $R^{BNE-6}$; and
$C_2$-$C_{57}$-heteroaryl,
which is optionally substituted with one or more substituents $R^{BNE-6}$;
$R^{BNE-6}$ is at each occurrence independently from another selected from the group consisting of: hydrogen, deuterium, OPh, $CF_3$, CN, F,
$C_1$-$C_5$-alkyl,
wherein one or more hydrogen atoms are optionally, independently of each other substituted by deuterium, CN, $CF_3$, Ph or F;
$C_1$-$C_5$-alkoxy,

wherein one or more hydrogen atoms are optionally, independently of each other substituted by deuterium, CN, $CF_3$, or F;
$C_1$-$C_5$-thioalkoxy,
wherein one or more hydrogen atoms are optionally, independently of each other substituted by deuterium, CN, $CF_3$, or F;
$C_2$-$C_5$-alkenyl,
wherein one or more hydrogen atoms are optionally, independently of each other substituted by deuterium, CN, $CF_3$, or F;
$C_2$-$C_5$-alkynyl,
wherein one or more hydrogen atoms are optionally, independently of each other substituted by deuterium, CN, $CF_3$, or F;
$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents;
$N(C_6$-$C_{18}$-aryl$)_2$;
$N(C_2$-$C_{17}$-heteroaryl$)_2$, and
$N(C_2$-$C_{17}$-heteroaryl$)(C_6$-$C_{18}$-aryl$)$;
wherein $R^{BNE-III}$ and $R^{BNE-e}$ optionally combine to form a direct single bond; and
wherein two or more of substituents $R^{BNE-A}$, $R^{BNE-d}$, $R^{BNE-d'}$, $R^{BNE-e}$, $R^{BNE-3'}$, $R^{BNE-4'}$, $R^{BNE-5}$ optionally form a mono- or polycyclic, aliphatic or aromatic or heteroaromatic, carbo- or heterocyclic ring system with each other;
wherein two or more of the substituents $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-1}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$ , $R^{BNE-IV}$, $R^{BNE-V}$, $R^{BNE-A}$, $R^{BNE-e}$, $R^{BNE-d}$, and $R^{BNE-d'}$, or any aromatic or heteroaromatic ring formed by two or more substituents as stated above, wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$ $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$ $R^{BNE-IV}$, $R^{BNE-V}$, $R^{BNE-A}$, $R^{BNE-e}$, $R^{BNE-d}$, or $R^{BNE-d'}$ is replaced by a bond to a further chemical entity of formula BNE-1.

In one embodiment of the invention, in at least one, preferably each, light-emitting layer B, at least one of the one or more small FWHM emitters $S^B$ comprises a structure according to formula BNE-1.

In one embodiment of the invention, in at least one, preferably each, light-emitting layer B, each small FWHM emitter $S^B$ comprises a structure according to formula BNE-1.

In one embodiment of the invention, in at least one, preferably each, light-emitting layer B, at least one of the one or more small FWHM emitters $S^B$ consists of a structure according to formula BNE-1.

In one embodiment of the invention, in at least one, preferably each, light-emitting layer B, each small FWHM emitter $S^B$ consists of a structure according to formula BNE-1.

In one embodiment of the invention, in which in at least one, preferably each, light-emitting layer B, at least one, preferably each, of the one or more small FWHM emitters $S^B$ comprises or consists of a structure according to formula BNE-1, $V^1$ is $CR^{BNE-V}$ and $V^2$ is $CR^{BNE-I}$.

In one embodiment of the invention, in which in at least one, preferably each, light-emitting layer B, at least one, preferably each, of the one or more small FWHM emitters $S^B$ comprises or consists of a structure according to formula BNE-1, $V^1$ and $V^2$ are both nitrogen (N).

In one embodiment of the invention, in which in at least one, preferably each, light-emitting layer B, at least one, preferably each, of the one or more small FWHM emitters $S^B$ comprises or consists of a structure according to formula BNE-1, $V^1$ is nitrogen (N) and $V^2$ is $CR^{BNE-I}$.

In one embodiment of the invention, in which in at least one, preferably each, light-emitting layer B, at least one, preferably each, of the one or more small FWHM emitters $S^B$ comprises or consists of a structure according to formula BNE-1, $V^1$ is $CR^{BNE-V}$ and $V^2$ is nitrogen (N).

In one embodiment of the invention, in which in at least one, preferably each, light-emitting layer B, at least one, preferably each, of the one or more small FWHM emitters $S^B$ comprises or consists of a structure according to formula BNE-1, c and d are both 0.

In one embodiment of the invention, in which in at least one, preferably each, light-emitting layer B, at least one, preferably each, of the one or more small FWHM emitters $S^B$ comprises or consists of a structure according to formula BNE-1, c is 0 and d is 1.

In one embodiment of the invention, in which in at least one, preferably each, light-emitting layer B, at least one, preferably each, of the one or more small FWHM emitters $S^B$ comprises or consists of a structure according to formula BNE-1, c is 1 and d is 0.

In a preferred embodiment of the invention, in which in at least one, preferably each, light-emitting layer B, at least one, preferably each, of the one or more small FWHM emitters $S^B$ comprises or consists of a structure according to formula BNE-1, c and d are both 1.

In one embodiment of the invention, in which in at least one, preferably each, light-emitting layer B, at least one, preferably each, of the one or more small FWHM emitters $S^B$ comprises or consists of a structure according to formula BNE-1,

$X^3$ is selected from the group consisting of a direct bond, $CR^{BNE-3}R^{BNE-4}$, C=O, $NR^{BNE-3}$, O, S, $SiR^{BNE-3}R^{BNE-4}$; and
$Y^2$ is selected from the group consisting of a direct bond, $CR^{BNE-3'}R^{BNE-4'}$, C=O, $NR^{BNE-3'}$, O, S, $SiR^{BNE-3'}R^{BNE-4'}$.

In one embodiment of the invention, in which in at least one, preferably each, light-emitting layer B, at least one, preferably each, of the one or more small FWHM emitters $S^B$ comprises or consists of a structure according to formula BNE-1,

$X^3$ is selected from the group consisting of a direct bond, $CR^{BNE-3}R^{BNE-4}$, $NR^{BNE-3}$, O, S, $SiR^{BNE-3}R^{BNE-4}$; and
$Y^2$ is selected from the group consisting of a direct bond, $CR^{BNE-3'}R^{BNE-4'}$, $NR^{BNE-3'}$, O, S, $SiR^{BNE-3'}R^{BNE-4'}$.

In one embodiment of the invention, in which in at least one, preferably each, light-emitting layer B, at least one, preferably each, of the one or more small FWHM emitters $S^B$ comprises or consists of a structure according to formula BNE-1,

$X^3$ is selected from the group consisting of a direct bond, $CR^{BNE-3}R^{BNE-4}$, $NR^{BNE-3}$, O, S, $SiR^{BNE-3}R^{BNE-4}$; and
$Y^2$ is a direct bond.

In one embodiment of the invention, in which in at least one, preferably each, light-emitting layer B, at least one, preferably each, of the one or more small FWHM emitters $S^B$ comprises or consists of a structure according to formula BNE-1,

$X^3$ is a direct bond or $NR^{BNE-3}$; and
$Y^2$ is a direct bond.

In one embodiment of the invention, in which in at least one, preferably each, light-emitting layer B, at least one, preferably each, of the one or more small FWHM emitters $S^B$ comprises or consists of a structure according to formula BNE-1,

$X^3$ is $NR^{BNE-3}$; and
$Y^2$ is a direct bond.

In one embodiment of the invention, in which in at least one, preferably each, light-emitting layer B, at least one, preferably each, of the one or more small FWHM emitters $S^B$ comprises or consists of a structure according to formula BNE-1, $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$ $R^{BNE-IV}$, and $R^{BNE-V}$ are each independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,

$C_1$-$C_{40}$-alkyl,
which is optionally substituted with one or more substituents $R^{BNE-5}$ and wherein one or more non-adjacent $CH_2$-

groups are optionally substituted by $R^{BNE-5}C=CR^{BNE-5}$, C≡C, $Si(R^{BNE-5})_2$, $Ge(R^{BNE-5})_2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-alkoxy,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-thioalkoxy,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkenyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkynyl,
which is optionally substituted with one or more substituents $R^{BNE-5}$ and wherein one or more non-adjacent $CH_2$-groups are optionally substituted by $R^{BNE-5}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{60}$-aryl,
which is optionally substituted with one or more substituents $R^{BNE-5}$; and
$C_2$-$C_{57}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium, $CF_3$, CN, F, Cl, Br, I,
$C_1$-$C_{40}$-alkyl,
which is optionally substituted with one or more substituents $R^{BNE-a}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{60}$-aryl,
which is optionally substituted with one or more substituents $R^{BNE-a}$; and
$C_2$-$C_{57}$-heteroaryl,
which is optionally substituted with one or more substituents $R^{BNE-a}$;
$R^{BNE-a}$ is at each occurrence independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,
$C_1$-$C_{40}$-alkyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-alkoxy,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-thioalkoxy, which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkenyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkynyl,
which is optionally substituted with one or more substituents $R^{BNE-5}$ and wherein one or more non-adjacent $CH_2$-groups are optionally substituted by $R^{BNE-}C=CR^{BNE_-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{60}$-aryl,
which is optionally substituted with one or more substituents $R^{BNE-5}$; and
$C_2$-$C_{57}$-heteroaryl,
which is optionally substituted with one or more substituents $R^{BNE-5}$;
$R^{BNE-5}$ is at each occurrence independently of each other selected from the group consisting of: hydrogen, deuterium,

$N(R^{BNE-6})_2$, $OR^{BNE-6}$, $Si(R^{BNE-6})_3$, $B(OR^{BNE-6})_2$, $B(R^{BNE-6})_2$, $OSO_2R^{BNE-6}$, $CF_3$, CN, F, Cl, Br, I,
$C_1$-$C_{40}$-alkyl,
which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_1$-$C_{40}$-alkoxy,
which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_1$-$C_{40}$-thioalkoxy,
which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_2$-$C_{40}$-alkenyl, which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_2$-$C_{40}$-alkynyl,
which is optionally substituted with one or more substituents $R^{BNE-6}$ and wherein one or more non-adjacent $CH_2$-groups are optionally substituted by $R^{BNE-6}C=CR^{BNE-6}$, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;
$C_6$-$C_{60}$-aryl,
which is optionally substituted with one or more substituents $R^{BNE-6}$; and
$C_2$-$C_{57}$-heteroaryl,
which is optionally substituted with one or more substituents $R^{BNE-6}$;
$R^{BNE-6}$ is at each occurrence independently from another selected from the group consisting of: hydrogen, deuterium, OPh, $CF_3$, CN, F,
$C_1$-$C_5$-alkyl,
wherein one or more hydrogen atoms are optionally, independently from each other substituted by deuterium, CN, $CF_3$, Ph or F;
$C_1$-$C_5$-alkoxy,
wherein one or more hydrogen atoms are optionally, independently from each other substituted by deuterium, CN, $CF_3$, or F;
$C_1$-$C_5$-thioalkoxy,
wherein one or more hydrogen atoms are optionally, independently from each other substituted by deuterium, CN, $CF_3$, or F;
$C_2$-$C_5$-alkenyl,
wherein one or more hydrogen atoms are optionally, independently from each other substituted by deuterium, CN, $CF_3$, or F;
$C_2$-$C_5$-alkynyl,
wherein one or more hydrogen atoms are optionally, independently from each other substituted by deuterium, CN, $CF_3$, or F;
$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents; $N(C_6$-$C_{18}$-aryl$)_2$;
$N(C_2$-$C_{17}$-heteroaryl$)_2$, and
$N(C_2$-$C_{17}$-heteroaryl$)(C_6$-$C_{18}$-aryl$)$;
wherein $R^{BNE-III}$ and $R^{BNE-e}$ optionally combine to form a direct single bond; and
wherein two or more of substituents $R^{BNE-A}$, $R^{BNE-d}$, $R^{BNE-d'}$, $R^{BNE-e}$, $R^{BNE-3'}$, $R^{BNE-4'}$, $R^{BNE-5}$ optionally form a mono- or polycyclic, aliphatic or aromatic or heteroaromatic, carbo- or heterocyclic ring system with each other;
wherein two or more of the substituents $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-1}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or

heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$ , $R^{BNE-IV}$, $R^{BNE-V}$, $R^{BNE-A}$, $R^{BNE-e}$, $R^{BNE-d}$, and $R^{BNE-d'}$, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$ $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$ $R^{BNE-IV}$, $R^{BNE-V}$, $R^{BNE-A}$, $R^{BNE-e}$, $R^{BNE-d}$, or $R^{BNE-d'}$ is replaced by a bond to a further chemical entity of formula BNE-1.

In one embodiment of the invention, in which in at least one, preferably each, light-emitting layer B, at least one, preferably each, of the one or more small FWHM emitters $S^B$ comprises or consists of a structure according to formula BNE-1, $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$, $R^{BNE-IV}$, and $R^{BNE-V}$ are each independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F, Cl, Br, I,

$C_1$-$C_{18}$-alkyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{30}$-aryl,
which is optionally substituted with one or more substituents $R^{BNE-5}$; and
$C_2$-$C_{29}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium, $CF_3$, CN, F, Cl, Br, I,
$C_1$-$C_{18}$-alkyl,
which is optionally substituted with one or more substituents $R^{BNE-a}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{30}$-aryl,
which is optionally substituted with one or more substituents $R^{BNE-a}$; and
$C_2$-$C_{29}$-heteroaryl,
which is optionally substituted with one or more substituents $R^{BNE-a}$;
$R^{BNE-a}$ is at each occurrence independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F, Cl, Br, I,
$C_1$-$C_{18}$-alkyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{30}$-aryl,
which is optionally substituted with one or more substituents $R^{BNE-5}$; and
$C_2$-$C_{29}$-heteroaryl,
which is optionally substituted with one or more substituents $R^{BNE-5}$;
$R^{BNE-5}$ is at each occurrence independently from another selected from the group consisting of: hydrogen, deuterium, OPh, $CF_3$, CN, F,
$C_1$-$C_5$-alkyl,
wherein one or more hydrogen atoms are optionally, independently from each other substituted by deuterium, CN, $CF_3$, or F;
$C_1$-$C_5$-alkoxy,
wherein one or more hydrogen atoms are optionally, independently from each other substituted by deuterium, CN, $CF_3$, or F;
$C_1$-$C_5$-thioalkoxy,
wherein one or more hydrogen atoms are optionally, independently from each other substituted by deuterium, CN, $CF_3$, or F;
$C_2$-$C_5$-alkenyl,

wherein one or more hydrogen atoms are optionally, independently from each other substituted by deuterium, CN, $CF_3$, or F;
$C_2$-$C_5$-alkynyl, wherein one or more hydrogen atoms are optionally, independently from each other substituted by deuterium, CN, $CF_3$, or F;
$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents;
$N(C_6$-$C_{18}$-aryl$)_2$;
$N(C_2$-$C_{17}$-heteroaryl$)_2$, and
$N(C_2$-$C_{17}$-heteroaryl$)(C_6$-$C_{18}$-aryl);
wherein $R^{BNE-III}$ and $R^{BNE-e}$ optionally combine to form a direct single bond; and
wherein two or more of substituents $R^{BNE-a}$, $R^{BNE-d}$, $R^{BNE-d'}$, $R^{BNE-e}$, $R^{BNE-3'}$, $R^{BNE-4'}$, $R^{BNE-5}$ optionally form a mono- or polycyclic, aliphatic or aromatic or heteroaromatic, carbo- or heterocyclic ring system with each other;
wherein two or more of the substituents $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-I}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$ , $R^{BNE-IV}$, $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$ $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$ $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

In one embodiment of the invention, in which in at least one, preferably each, light-emitting layer B, at least one, preferably each, of the one or more small FWHM emitters $S^B$ comprises or consists of a structure according to formula BNE-1, $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$, $R^{BNE-IV}$, and $R^{BNE-V}$ are each independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F,

$C_1$-$C_5$-alkyl,
which is optionally substituted with one or more substituents $R^{BNE-5}$;
$C_6$-$C_{18}$-aryl,
which is optionally substituted with one or more substituents $R^{BNE-5}$; and
$C_2$-$C_{17}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium, $CF_3$, CN, F,
$C_1$-$C_5$-alkyl,
which is optionally substituted with one or more substituents $R^{BNE-a}$;
$C_6$-$C_{18}$-aryl,
which is optionally substituted with one or more substituents $R^{BNE-a}$; and
$C_2$-$C_{17}$-heteroaryl,
which is optionally substituted with one or more substituents $R^{BNE-a}$;
$R^{BNE-a}$ is at each occurrence independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F,
$C_1$-$C_5$-alkyl,
which is optionally substituted with one or more substituents $R^{BNE-5}$;

$C_6$-$C_{18}$-aryl,
which is optionally substituted with one or more substituents $R^{BNE-5}$; and
$C_2$-$C_{17}$-heteroaryl,
which is optionally substituted with one or more substituents $R^{BNE-5}$;
$R^{BNE-5}$ is at each occurrence independently from another selected from the group consisting of: hydrogen, deuterium, OPh, $CF_3$, CN, F,
$C_1$-$C_5$-alkyl,
wherein one or more hydrogen atoms are optionally, independently from each other substituted by deuterium, CN, $CF_3$, or F;
$C_1$-$C_5$-alkoxy,
wherein one or more hydrogen atoms are optionally, independently from each other substituted by deuterium, CN, $CF_3$, or F;
$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents;
$N(C_6$-$C_{18}$-aryl$)_2$;
$N(C_2$-$C_{17}$-heteroaryl$)_2$, and
$N(C_2$-$C_{17}$-heteroaryl$)(C_6$-$C_{18}$-aryl$)$;
wherein $R^{BNE-III}$ and $R^{BNE-e}$ optionally combine to form a direct single bond; and
wherein two or more of substituents $R^{BNE-a}$, $R^{BNE-d}$, $R^{BNE-d'}$, $R^{BNE-e}$, $R^{BNE-3'}$, $R^{BNE-4'}$, $R^{BNE-5}$ optionally form a mono- or polycyclic, aliphatic or aromatic or heteroaromatic, carbo- or heterocyclic ring system with each other;
wherein two or more of the substituents $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-1}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$ , $R^{BNE-IV}$, $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$ $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

In one embodiment of the invention, in which in at least one, preferably each, light-emitting layer B, at least one, preferably each, of the one or more small FWHM emitters $S^B$ comprises or consists of a structure according to formula BNE-1, $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$, $R^{BNE-IV}$, and $R^{BNE-V}$ are each independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F,

$C_1$-$C_5$-alkyl,
which is optionally substituted with one or more substituents $R^{BNE-5}$;
$C_6$-$C_{18}$-aryl,
which is optionally substituted with one or more substituents $R^{BNE-5}$; and
$C_2$-$C_{17}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium,
$C_1$-$C_5$-alkyl,
which is optionally substituted with one or more substituents $R^{BNE-a}$;

$C_6$-$C_{18}$-aryl,
which is optionally substituted with one or more substituents $R^{BNE-a}$; and
$C_2$-$C_{17}$-heteroaryl,
which is optionally substituted with one or more substituents $R^{BNE-a}$;
$R^{BNE-a}$ is at each occurrence independently of each other selected from the group consisting of: hydrogen, deuterium, $N(R^{BNE-5})_2$, $OR^{BNE-5}$, $Si(R^{BNE-5})_3$, $B(R^{BNE-5})_2$, $CF_3$, CN, F,
$C_1$-$C_5$-alkyl,
which is optionally substituted with one or more substituents $R^{BNE-5}$;
$C_6$-$C_{18}$-aryl,
which is optionally substituted with one or more substituents $R^{BNE-5}$; and
$C_2$-$C_{17}$-heteroaryl,
which is optionally substituted with one or more substituents $R^{BNE-5}$;
$R^{BNE-5}$ is at each occurrence independently from another selected from the group consisting of: hydrogen, deuterium, OPh, $CF_3$, CN, F,
$C_1$-$C_5$-alkyl,
wherein one or more hydrogen atoms are optionally, independently from each other substituted by deuterium, CN, $CF_3$, or F;
$C_6$-$C_{18}$-aryl,
which is optionally substituted with one or more $C_1$-$C_5$-alkyl substituents;
$C_2$-$C_{17}$-heteroaryl,
which is optionally substituted with one or more $C_1$-$C_5$-alkyl substituents;
$N(C_6$-$C_{18}$-aryl$)_2$;
$N(C_2$-$C_{17}$-heteroaryl$)_2$, and
$N(C_2$-$C_{17}$-heteroaryl$)(C_6$-$C_{18}$-aryl$)$;
wherein $R^{BNE-III}$ and $R^{BNE-e}$ optionally combine to form a direct single bond; and
wherein two or more of substituents $R^{BNE-a}$, $R^{BNE-d}$, $R^{BNE-d'}$, $R^{BNE-e}$, $R^{BNE-3'}$, $R^{BNE-4'}$, $R^{BNE-5}$ optionally form a mono- or polycyclic, aliphatic or aromatic or heteroaromatic, carbo- or heterocyclic ring system with each other;
wherein two or more of the substituents $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-1}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;
wherein optionally two or more, preferably two, structures of formula BNE-1 are conjugated with each other, preferably fused to each other by sharing at least one, more preferably exactly one, bond;
wherein optionally two or more, preferably two, structures of formula BNE-1 are present in the emitter and share at least one, preferably exactly one, aromatic or heteroaromatic ring (i.e. this ring may be part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$ , $R^{BNE-IV}$, $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter); and
wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

In one embodiment of the invention, in which in at least one, preferably each, light-emitting layer B, at least one, preferably each, of the one or more small FWHM emitters $S^B$ comprises or consists of a structure according to formula BNE-1, $R^{BNE-III}$ and $R^{BNE-e}$ combine to form a direct single bond.

In one embodiment of the invention, in which in at least one, preferably each, light-emitting layer B, at least one, preferably each, of the one or more small FWHM emitters $S^B$ comprises or consists of a structure according to formula BNE-1, $R^{BNE-III}$ and $R^{BNE-e}$ do not combine to form a direct single bond.

In one embodiment, fluorescent emitters suitable as small FWHM emitters $S^B$ in the context of the present invention may optionally also be multimers (e.g. dimers) of the aforementioned formula BNE-1, which means that their structure comprises more than one subunits, each of which has a structure according to formula BNE-1. In this case, the skilled artisan will understand that the two or more subunits according to formula BNE-1 may for example be conjugated, preferably fused to each other (i.e. sharing at least one bond, wherein the respective substituents attached to the atoms

forming that bond may no longer be present). The two or more subunits may also share at least one, preferably exactly one, aromatic or heteroaromatic ring. This means that, for example, a small FWHM emitter $S^B$ may comprise two or more subunits each having a structure of formula BNE-1, wherein these two subunits share one aromatic or heteroaromatic ring (i.e. the respective ring is part of both subunits). As a result, the respective multimeric (e.g., dimeric) emitter $S^B$ may not contain two whole subunits according to formula BNE-1 as the shared ring is only present once. Nevertheless, the skilled artisan will understand that herein, such an emitter is still considered a multimer (for example a dimer if two subunits having a structure of formula BNE-1 are comprised) of formula BNE-1. The same holds true for multimers sharing more than one ring. It is preferred that the multimers are dimers comprising two subunits, each having a structure of formula BNE-1.

In one embodiment of the invention, in at least one, preferably each, light-emitting layer B, at least one small FWHM emitter $S^B$, preferably each small FWHM emitter $S^B$, is a dimer of formula BNE-1 as described above, which means that the emitter comprises two subunits, each having a structure according to formula BNE-1.

In one embodiment of the invention, in at least one, preferably each, light-emitting layer B, at least one, preferably each, of the one or more small FWHM emitters $S^B$ comprises or consists of two or more, preferably of exactly two, structures according to formula BNE-1 (i.e. subunits),
wherein these two subunits are conjugated, preferably fused to each other by sharing at least one, more preferably exactly one, bond.

In one embodiment of the invention, in at least one, preferably each, light-emitting layer B, at least one, preferably each, of the one or more small FWHM emitters $S^B$ comprises or consists of two or more, preferably of exactly two, structures according to formula BNE-1 (i.e. subunits),
wherein these subunits share at least one, preferably exactly one, aromatic or heteroaromatic ring (i.e. this ring is part of both structures of formula BNE-1) which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$ , $R^{BNE-IV}$, $R^{BNE-V}$, $R^{BNE-a}$, $R^{BNE-e}$, $R^{BNE-d}$, and $R^{BNE-d'}$, or any aromatic or heteroaromatic ring formed by two or more substituents as stated above; wherein the shared ring may constitute the same or different moieties of the two or more structures of formula BNE-1 that share the ring (i.e. the shared ring may for example be ring c' of both structures of formula BNE-1 optionally comprised in the emitter or the shared ring may for example be ring b of one and ring c' of the other structure of formula BNE-1 optionally comprised in the emitter).

In one embodiment of the invention, in at least one, preferably each, light-emitting layer B, at least one, preferably each, of the one or more small FWHM emitters $S^B$ comprises or consists of a structure according to formula BNE-1 (i.e. subunits), wherein at least one of $R^{BNE-I}$, $R^{BNE-2}$ , $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-}3$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

Non-limiting examples of fluorescent emitters comprising or consisting of a structure according to the aforementioned formula BNE-1 that may be used as small FWHM emitters in the context of the present invention are shown below:
invention are shown below:

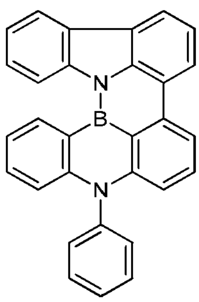
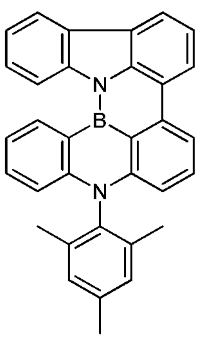
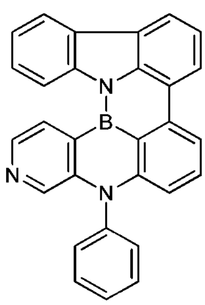
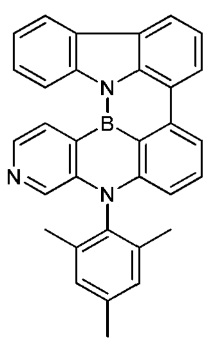
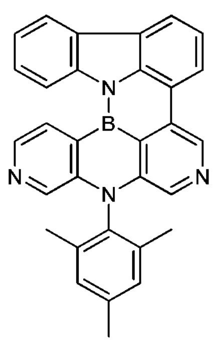

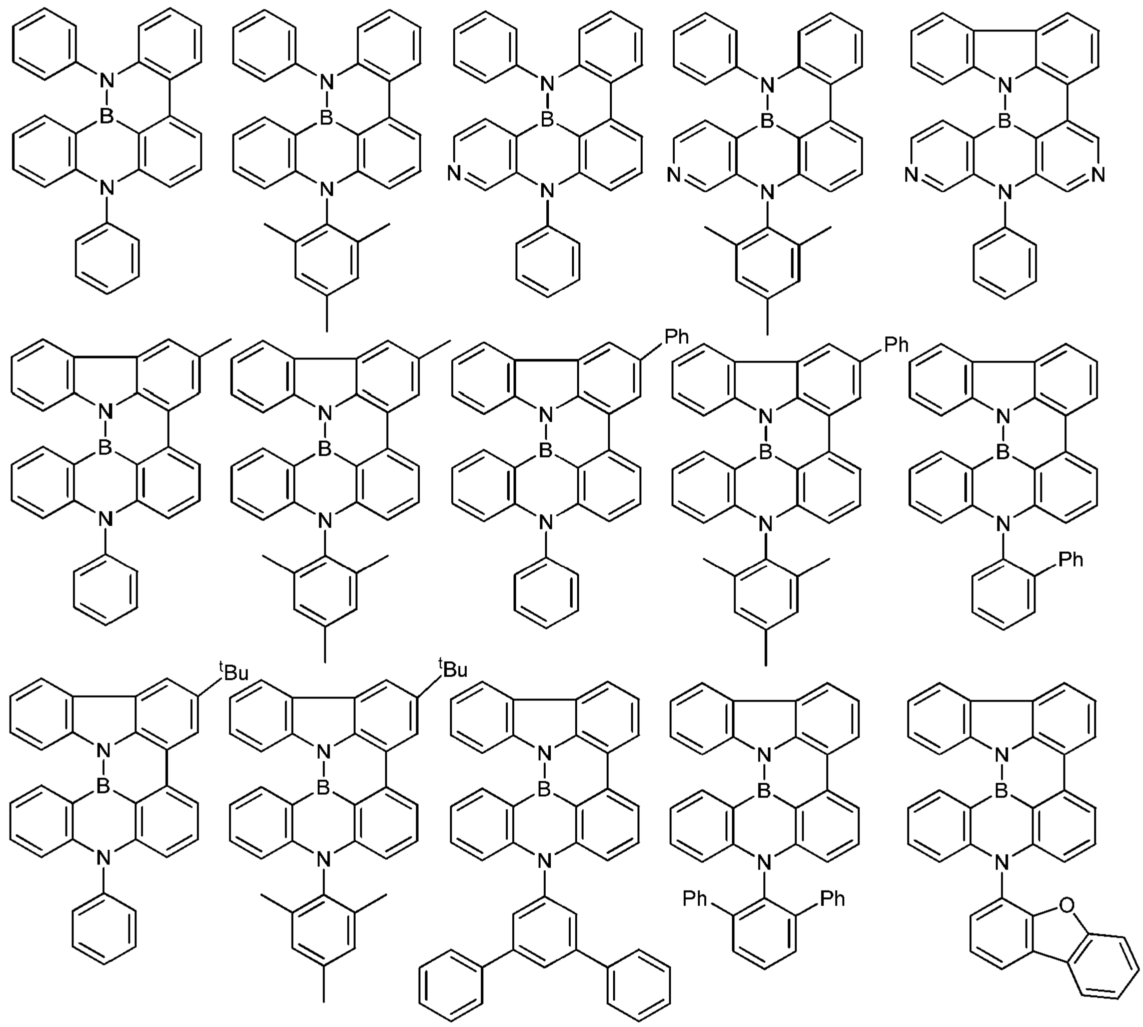

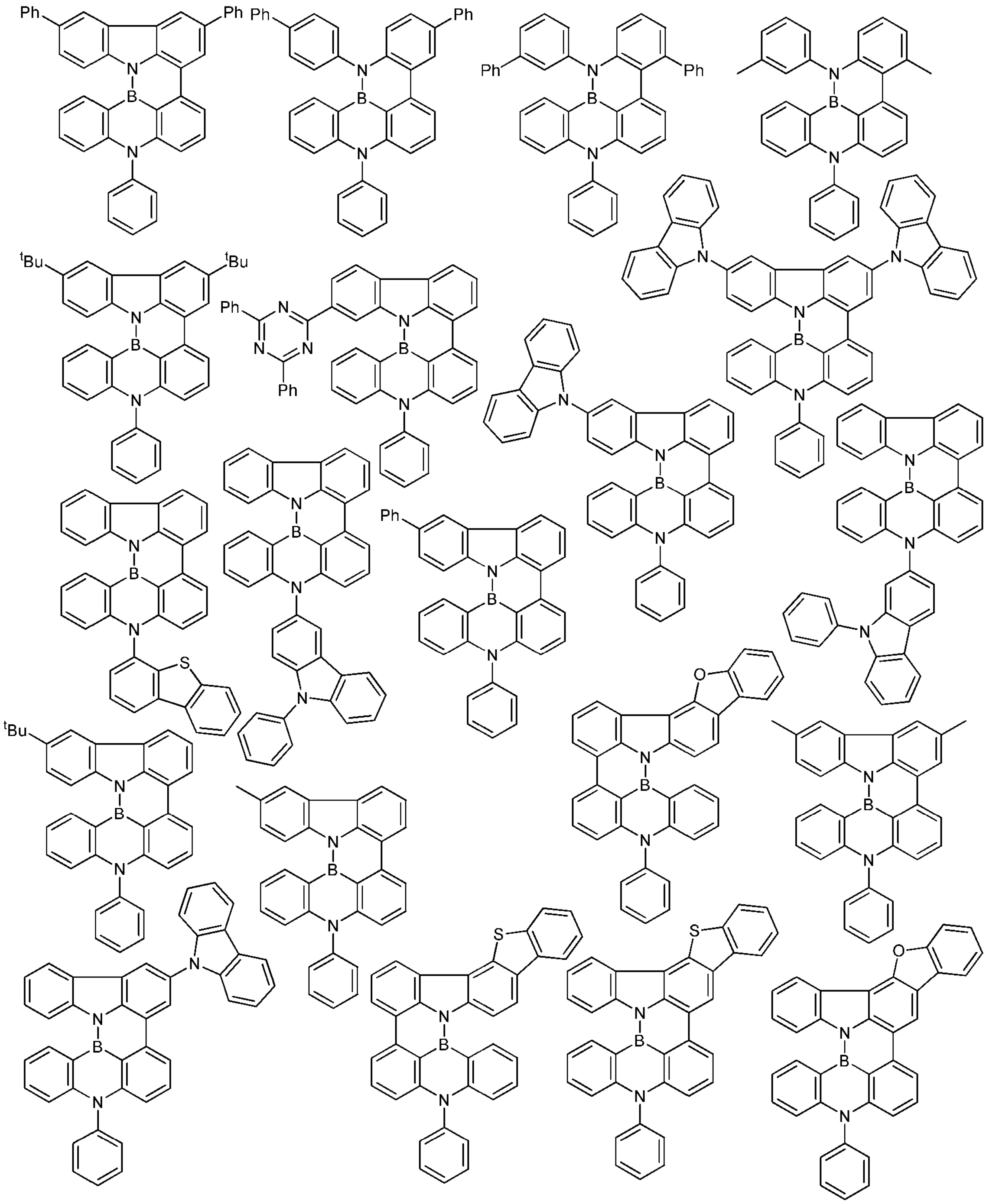

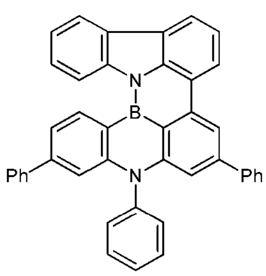

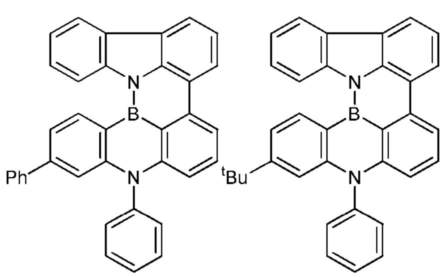

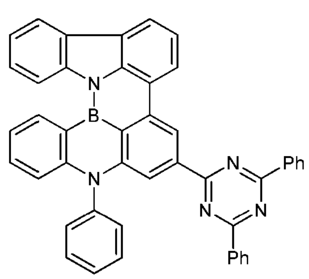

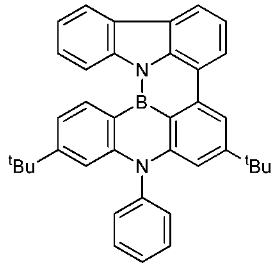

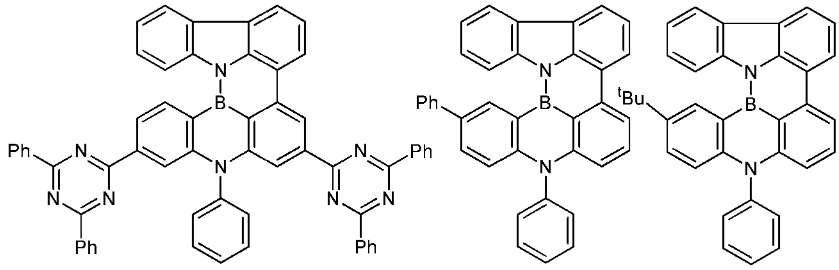

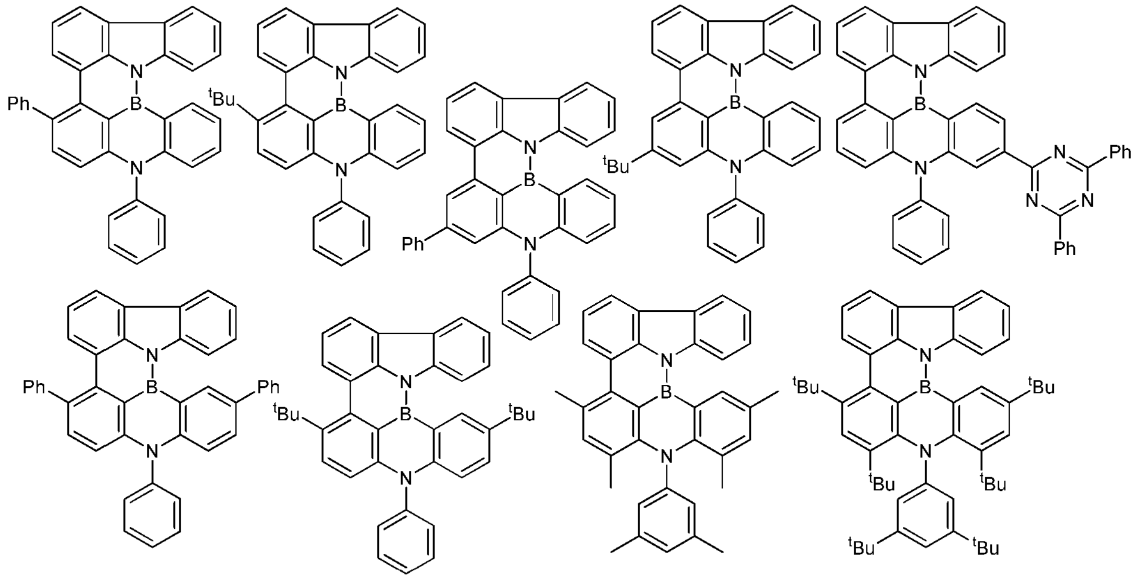

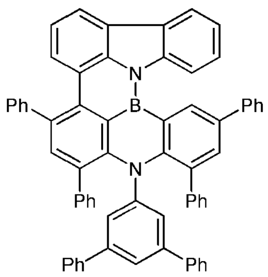

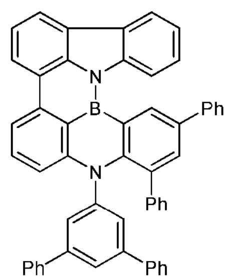

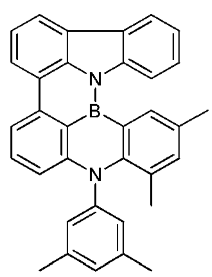

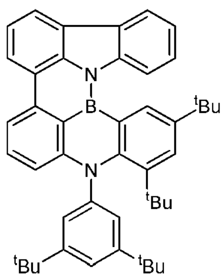

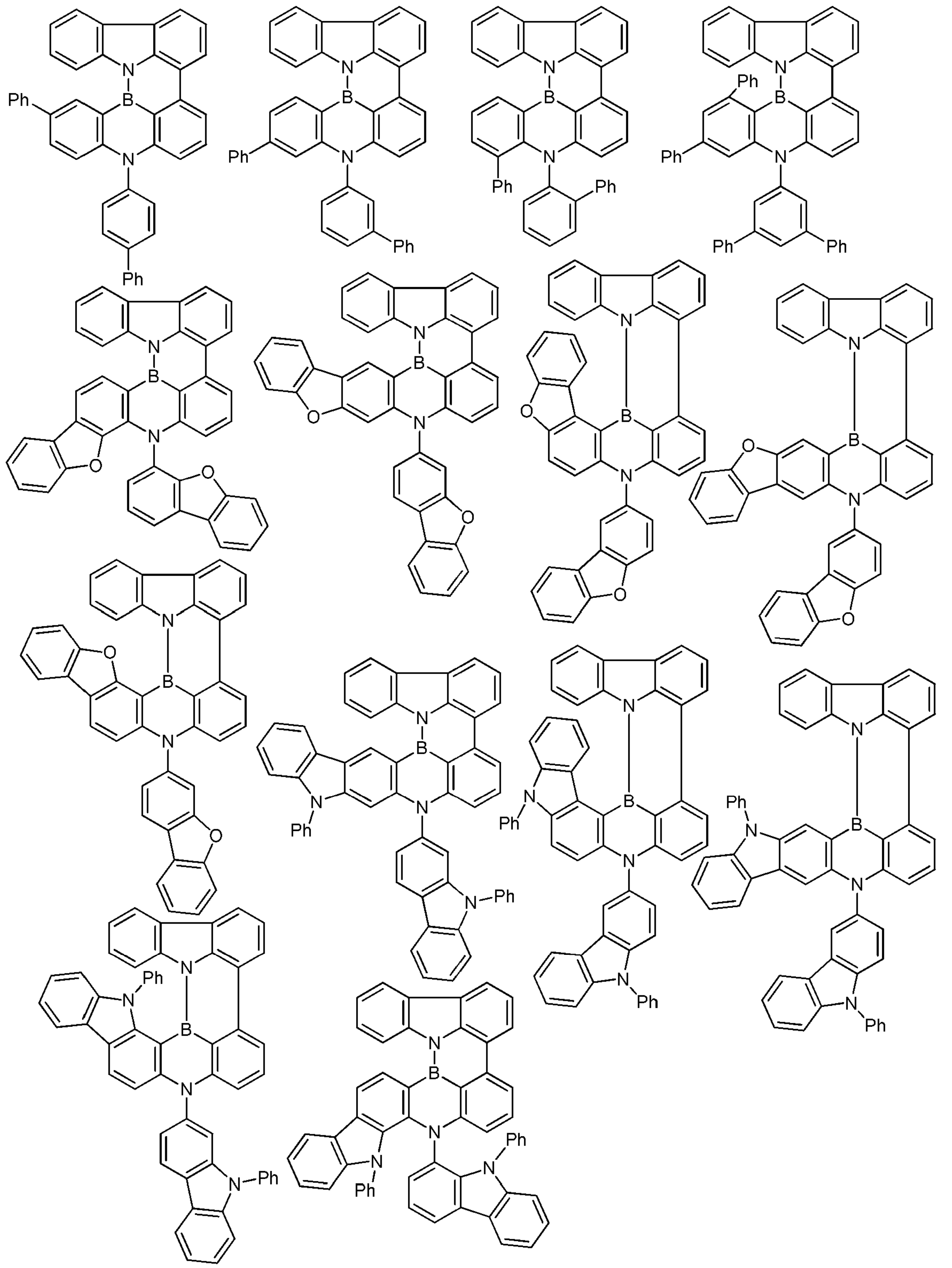

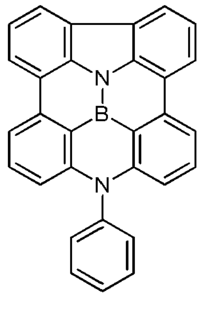
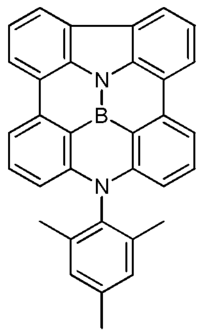
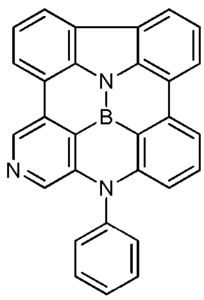
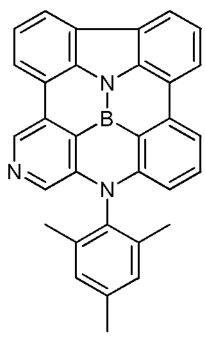
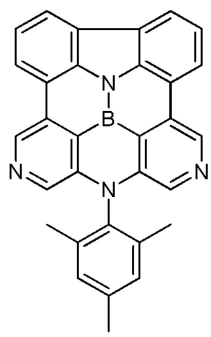
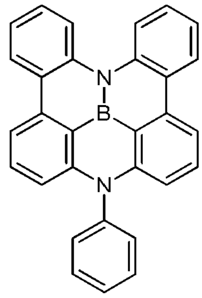
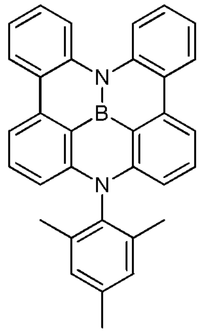
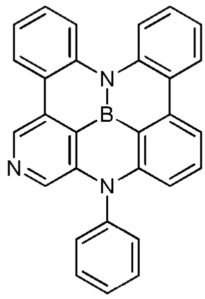
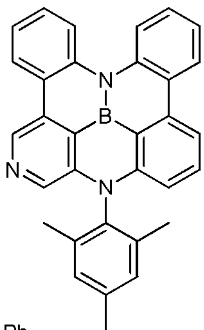
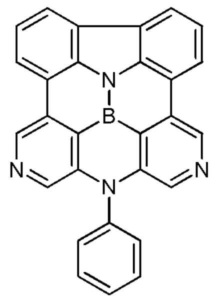
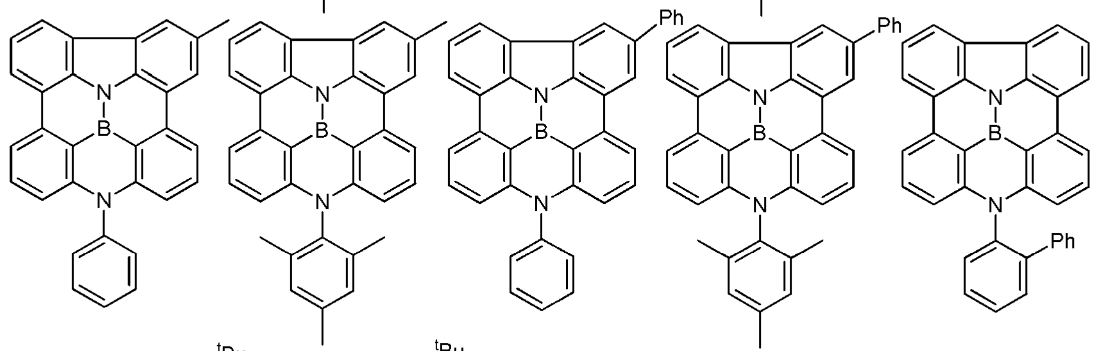
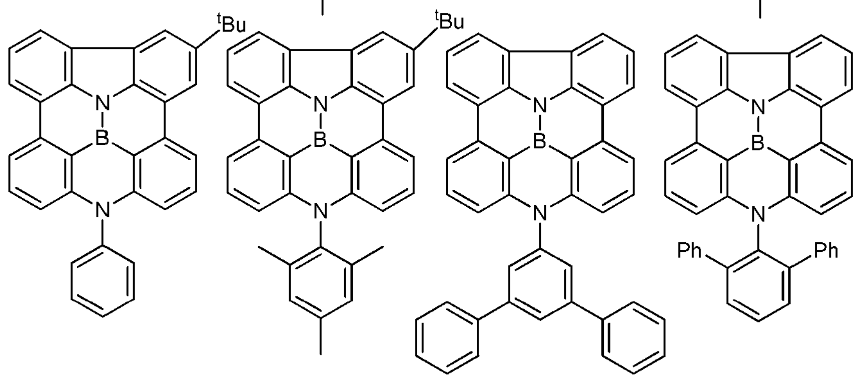
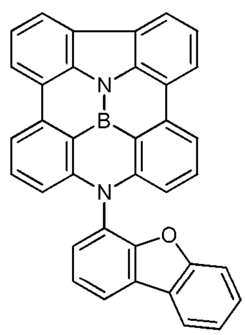
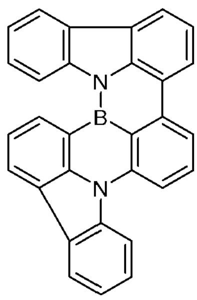
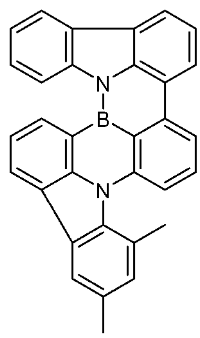
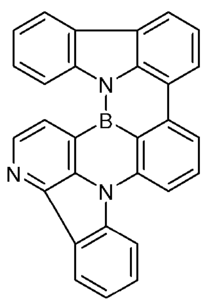
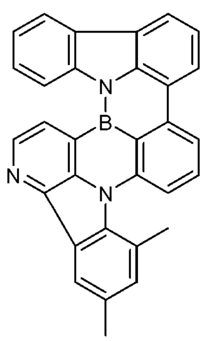
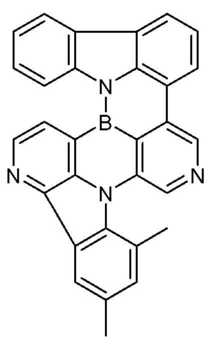

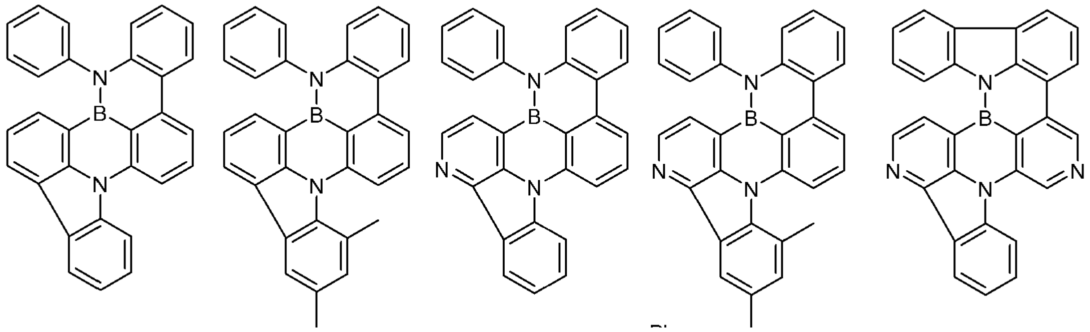

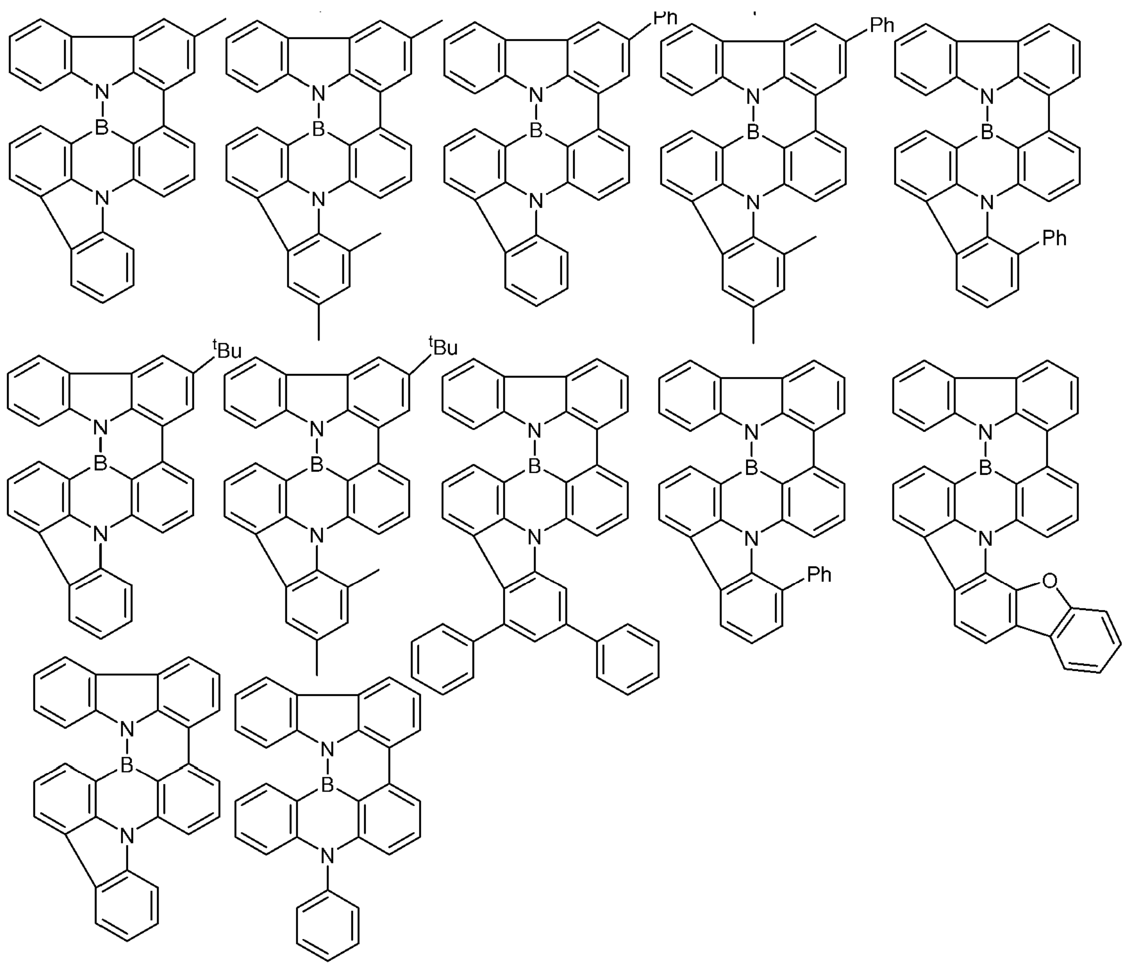

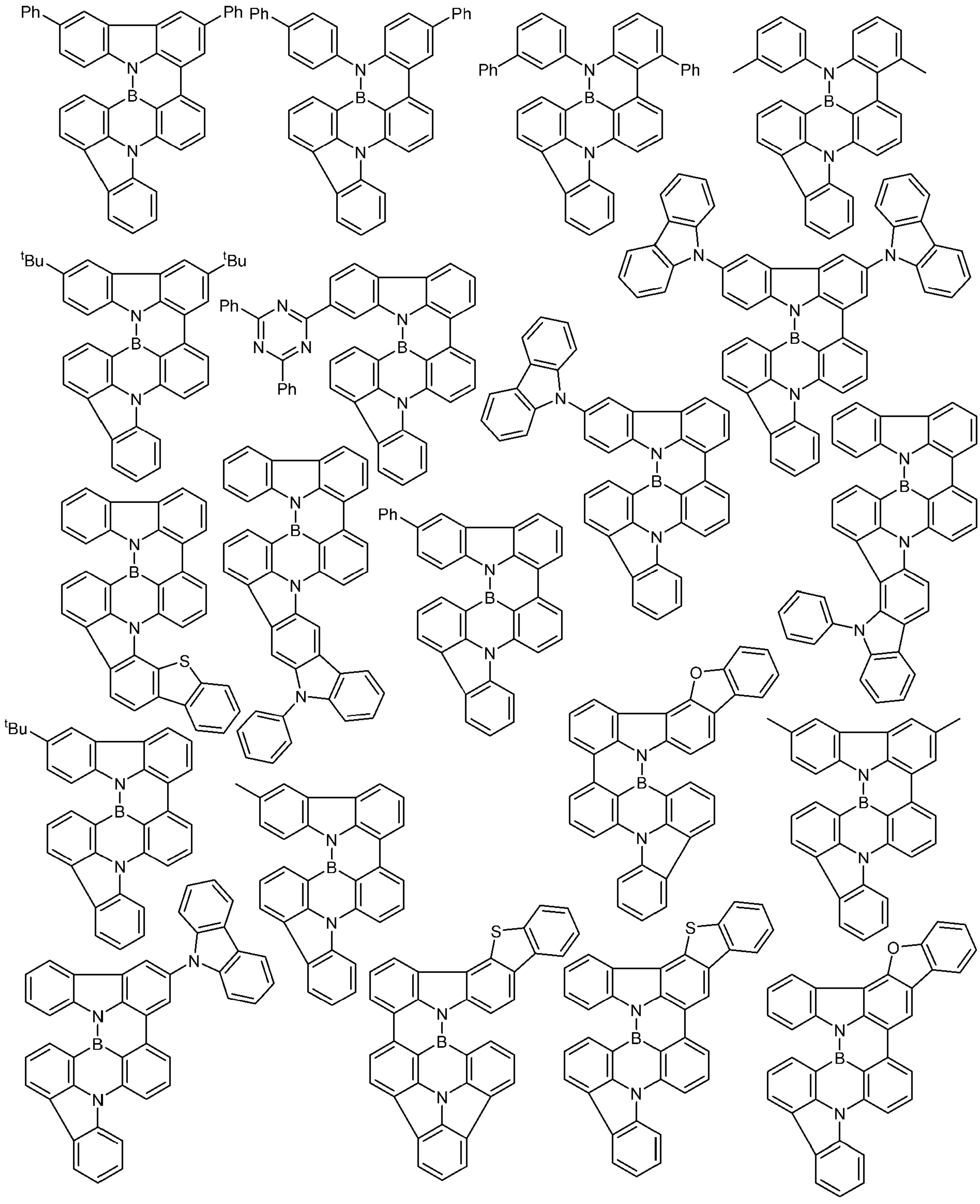

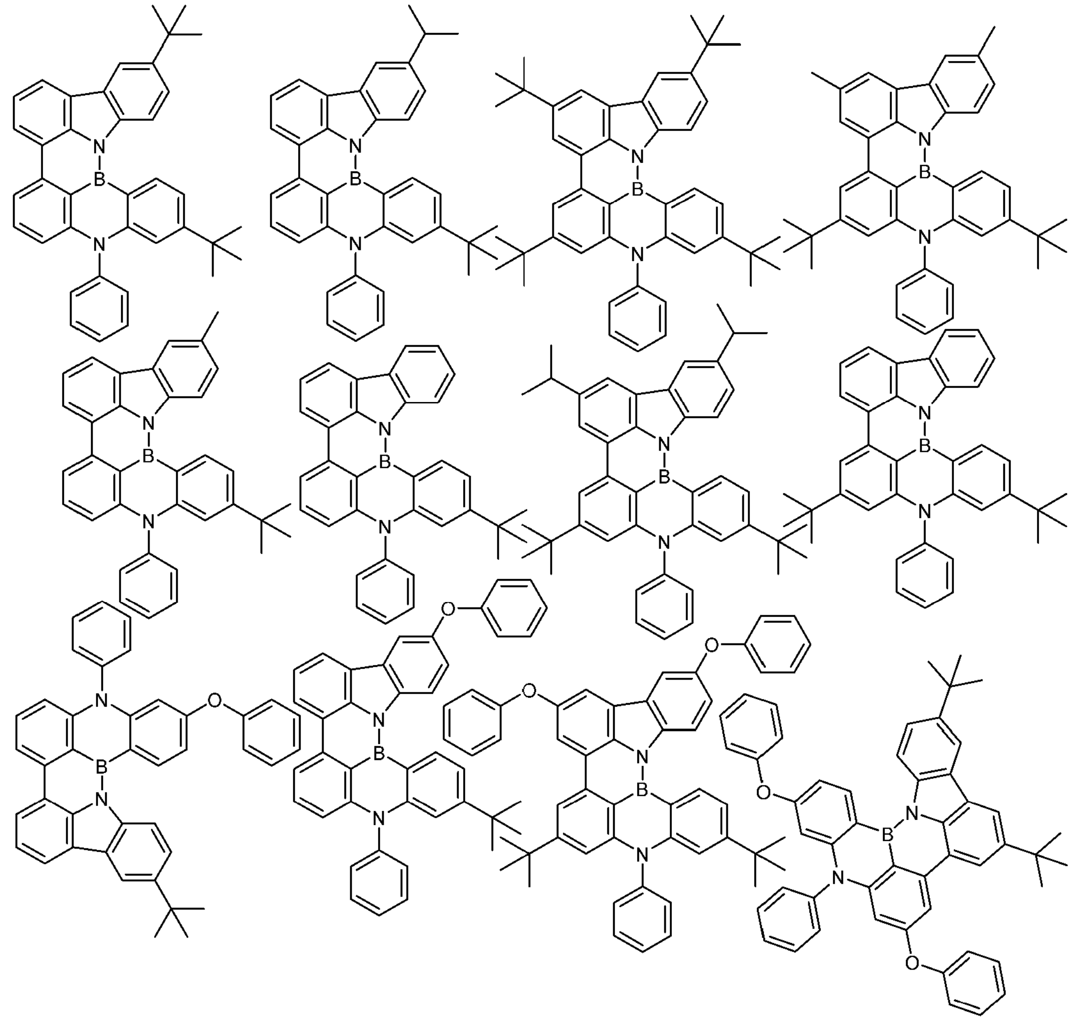

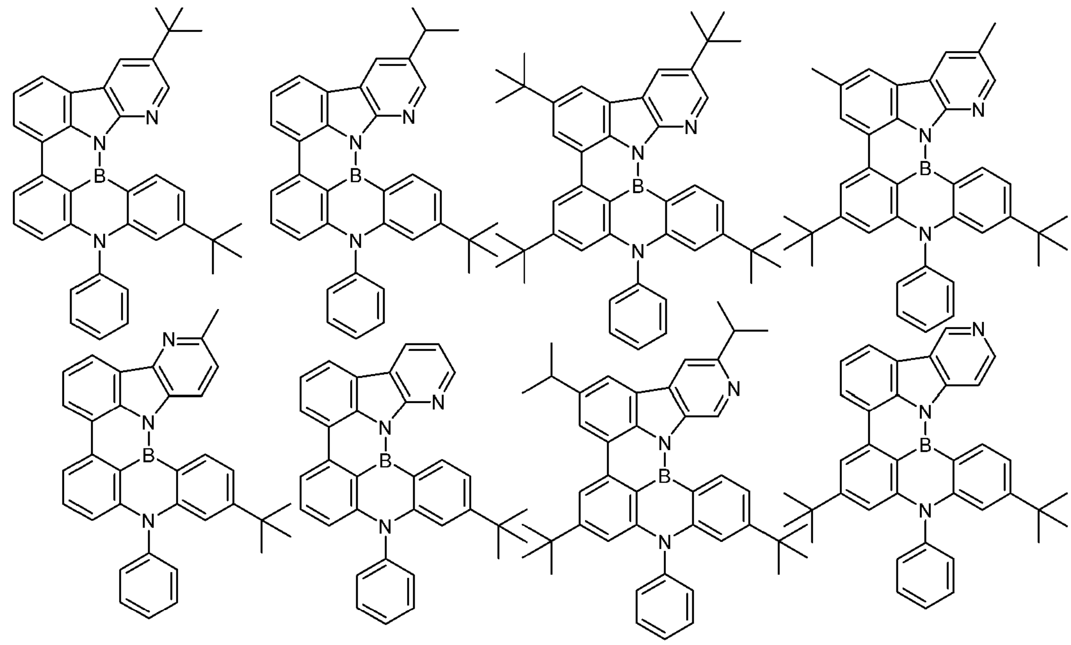

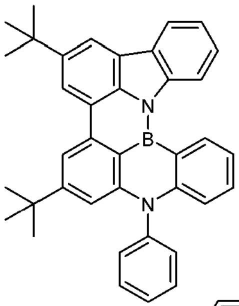
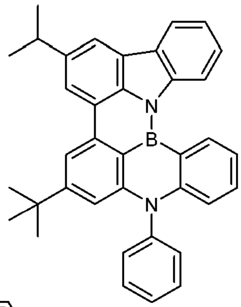
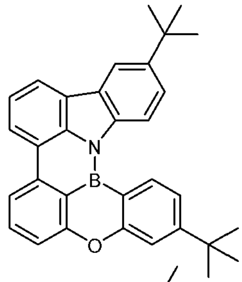
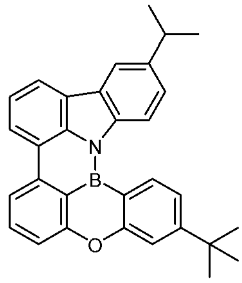
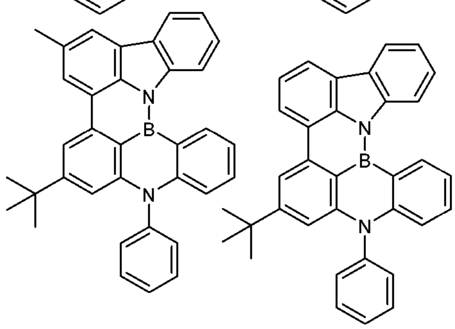
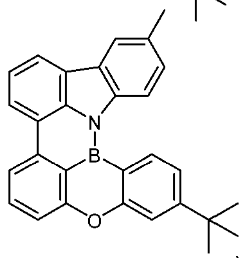
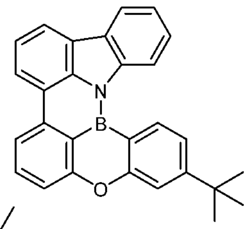
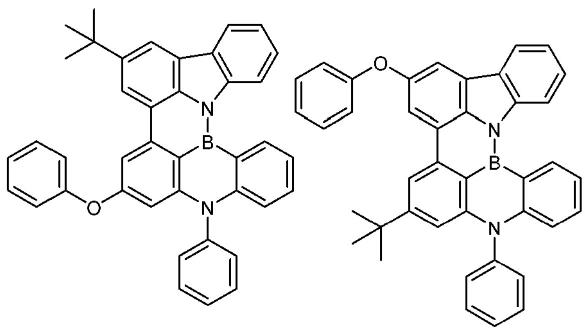
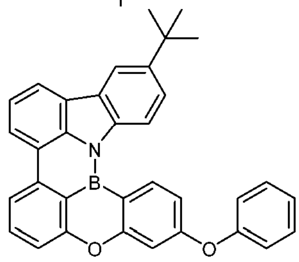
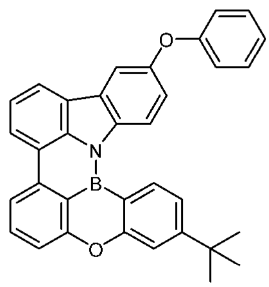
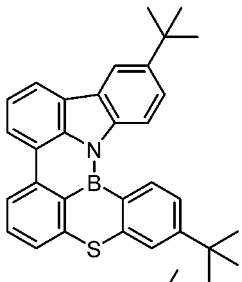
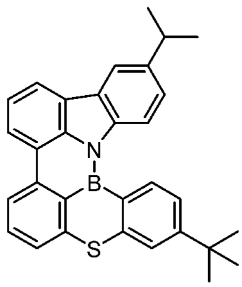
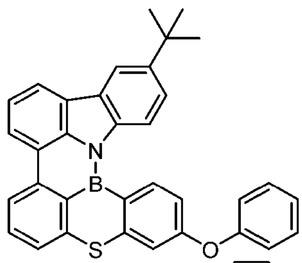
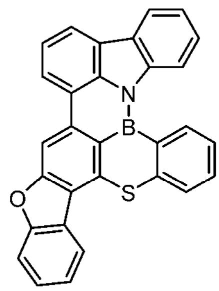
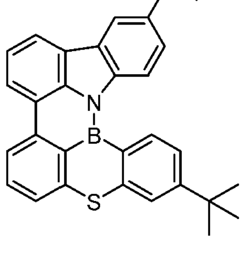
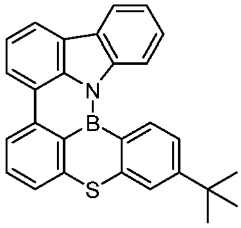
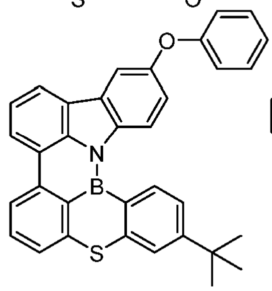
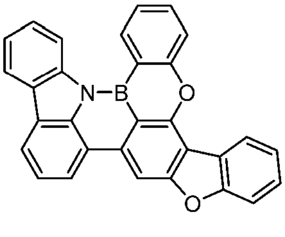

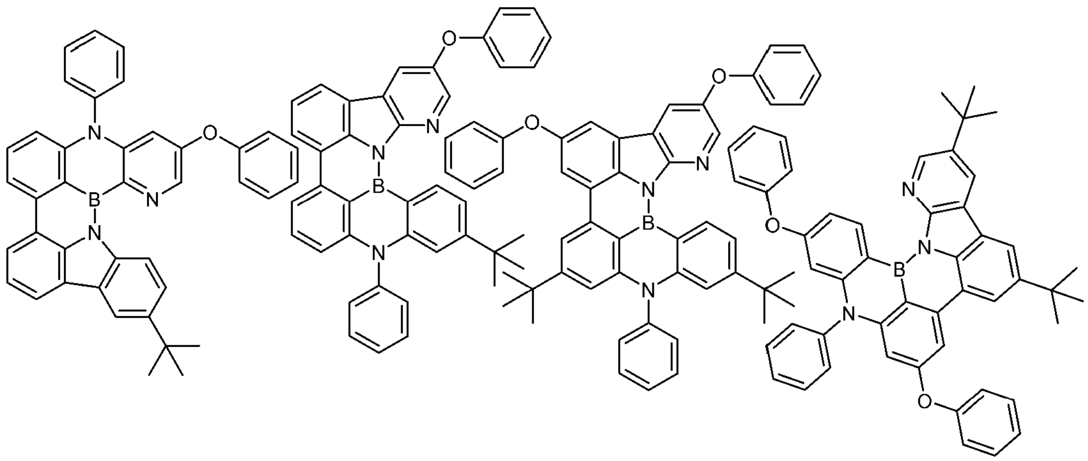

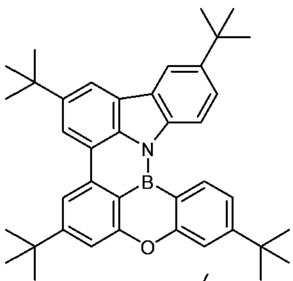

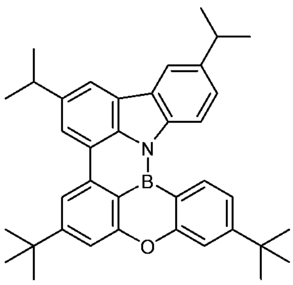

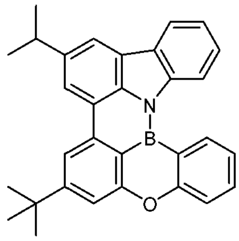

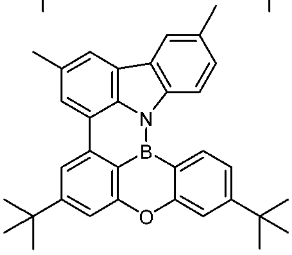

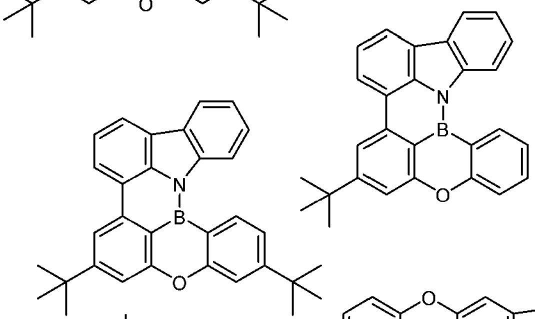

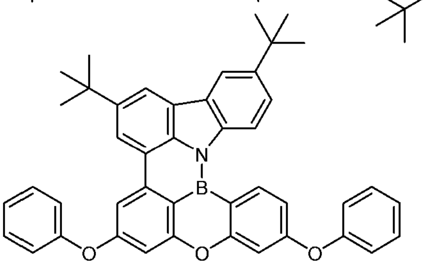

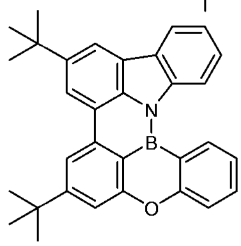

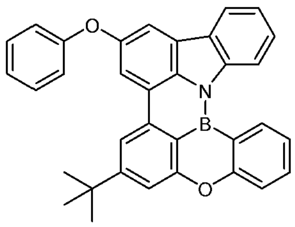

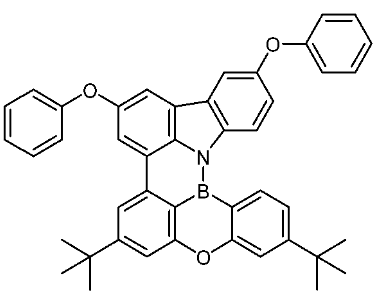

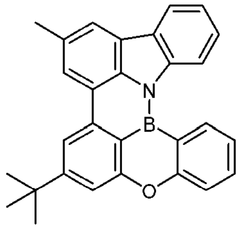

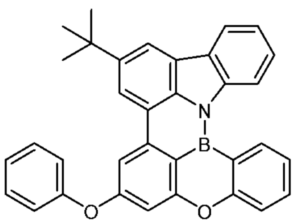

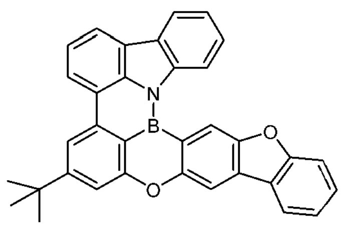

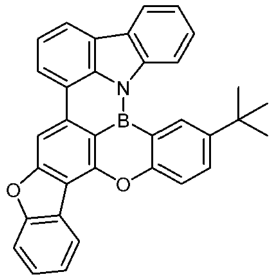

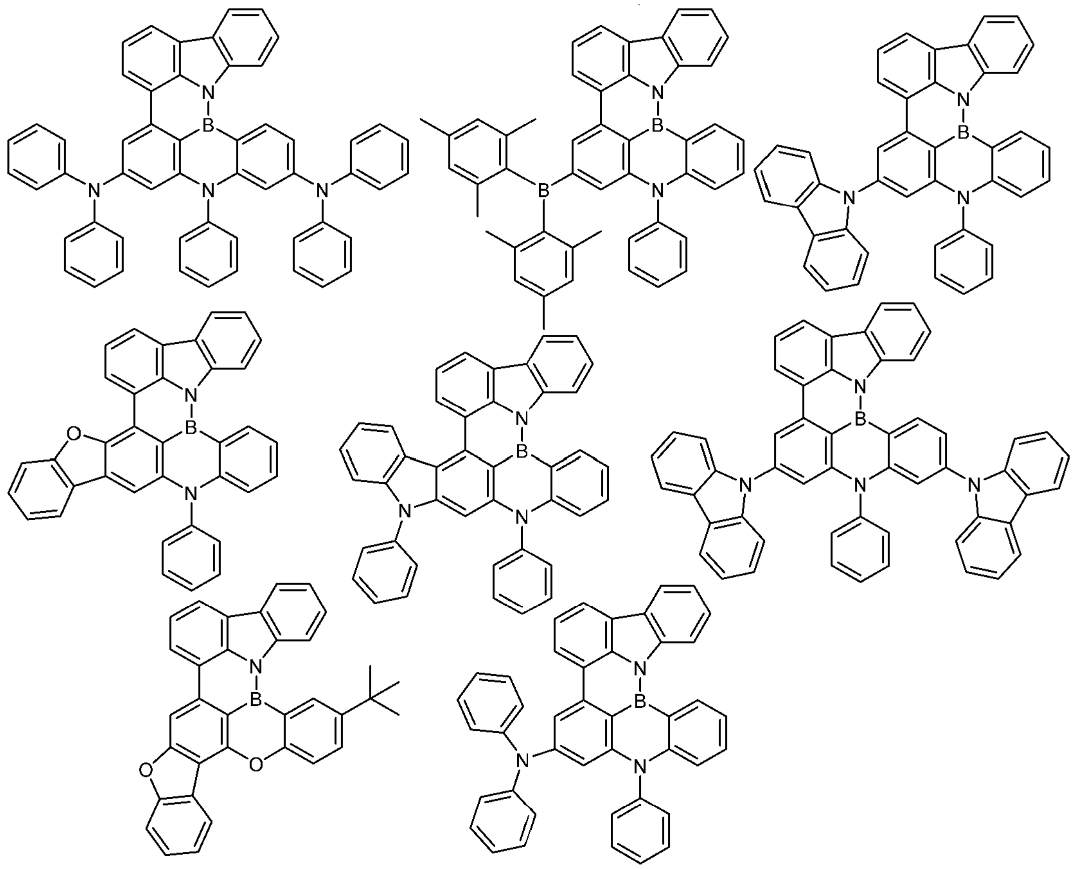

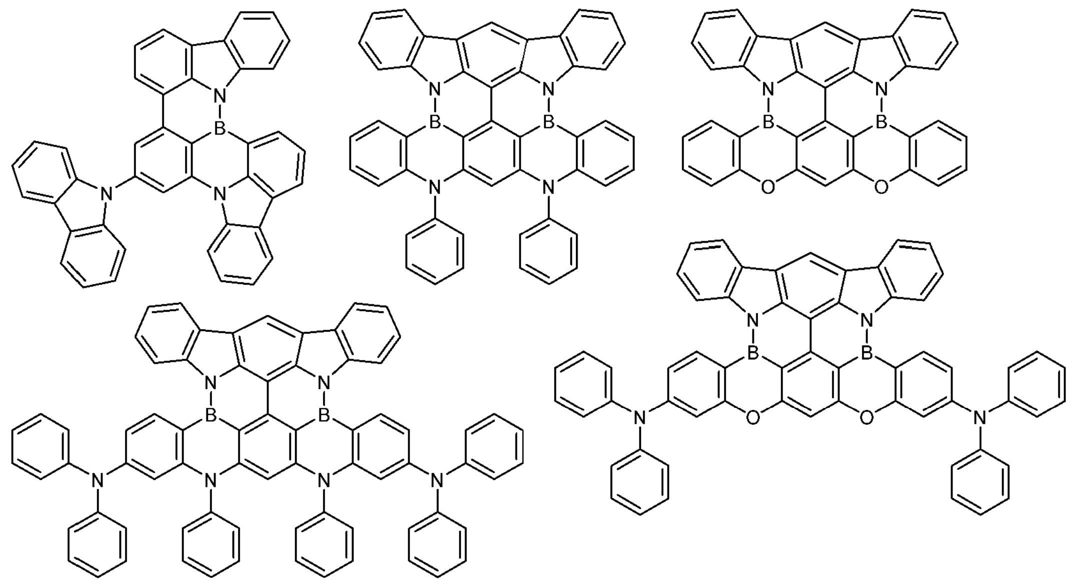

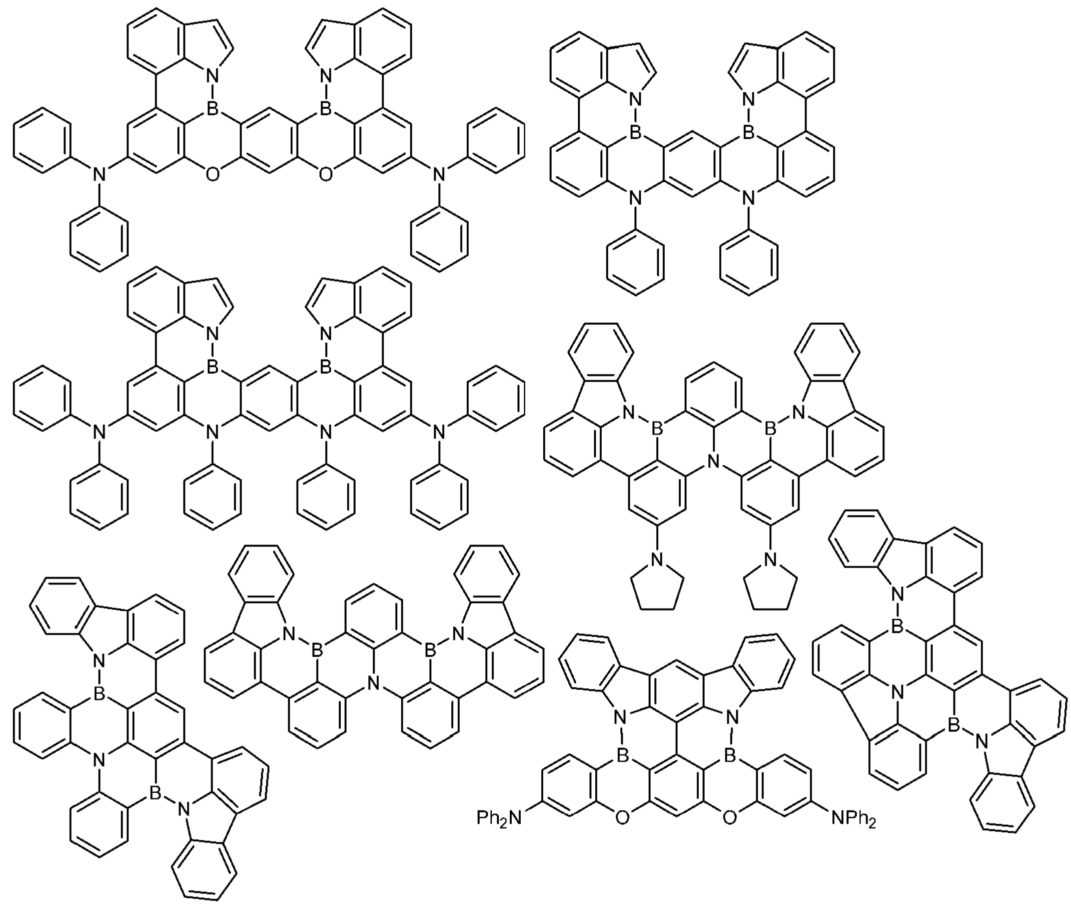

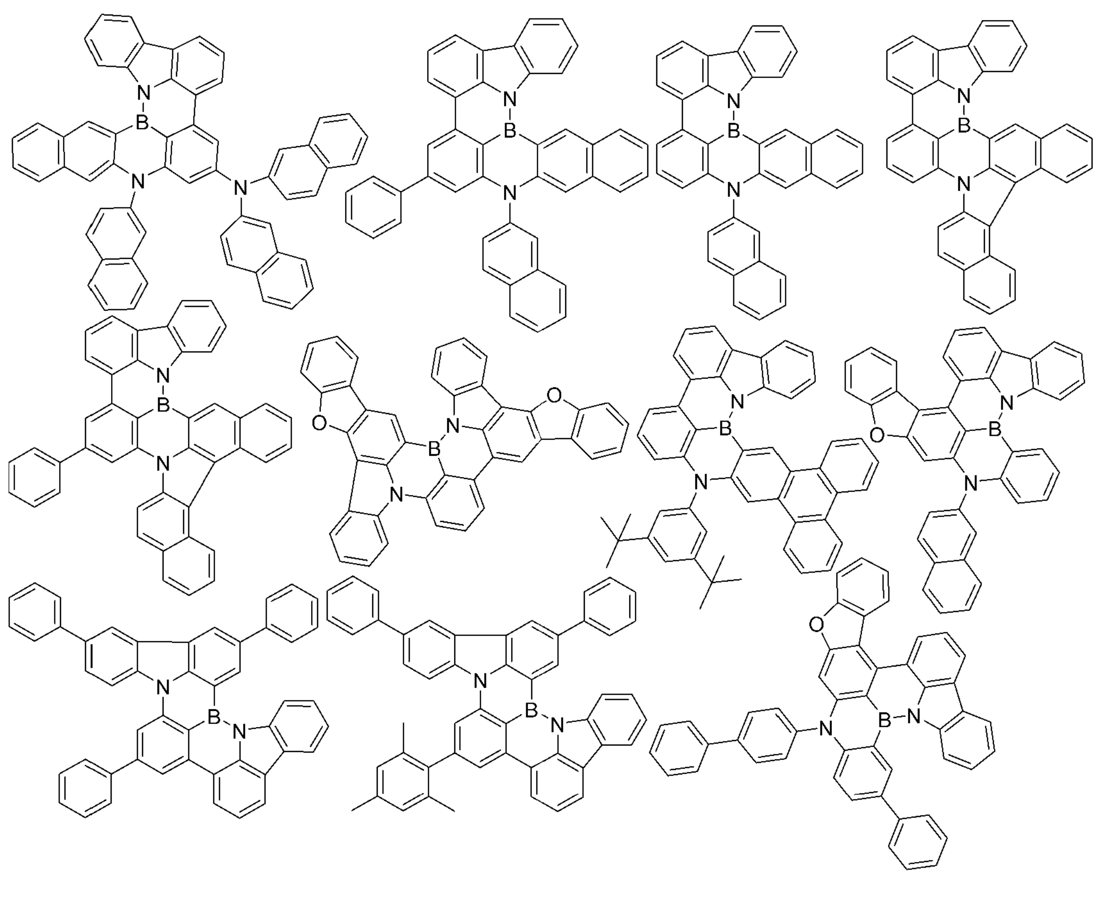

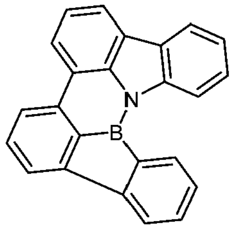
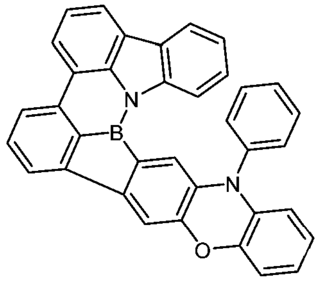
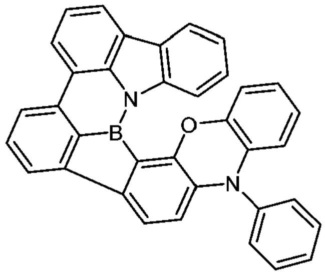

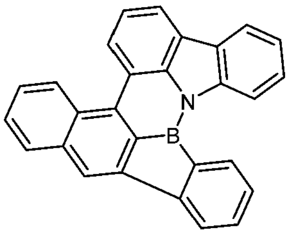
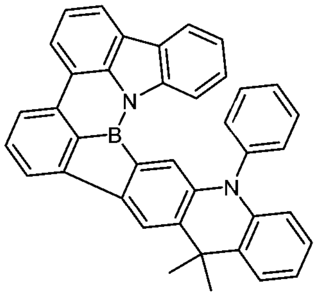
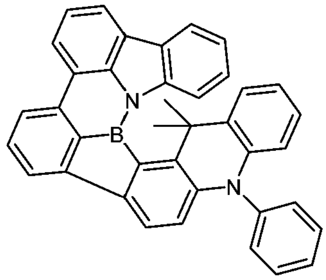

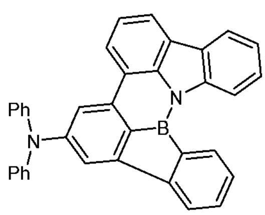
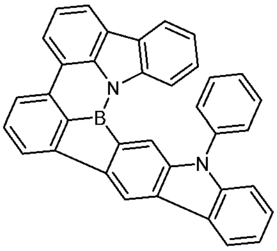
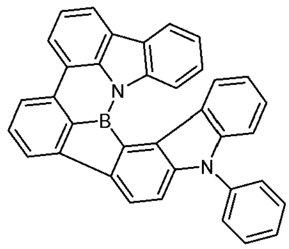

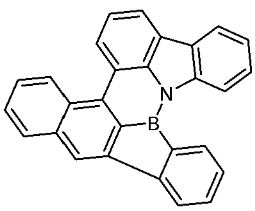
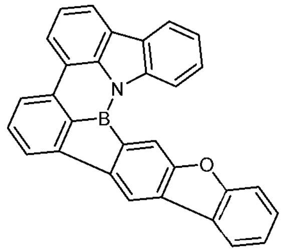
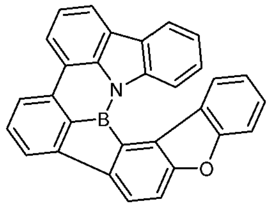

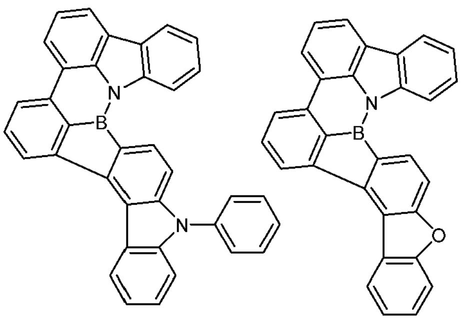
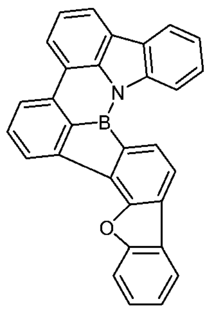
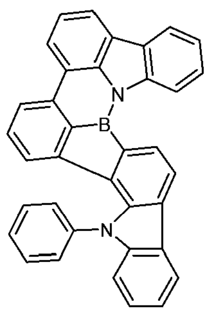

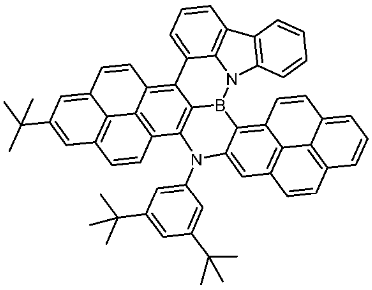
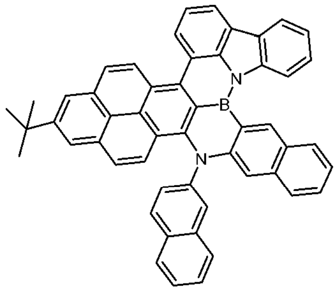
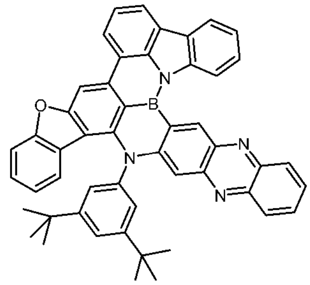
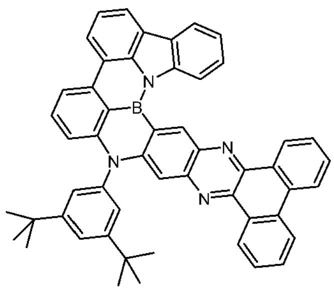
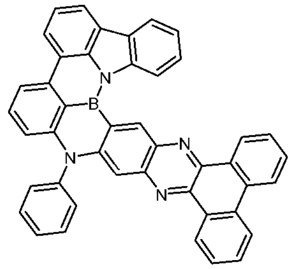
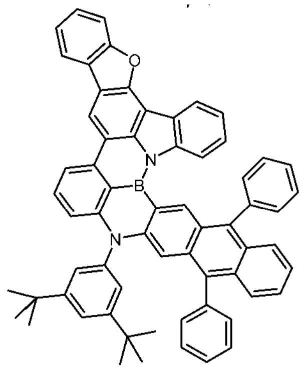
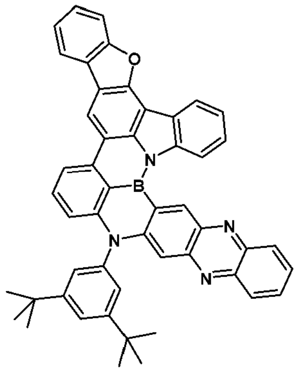
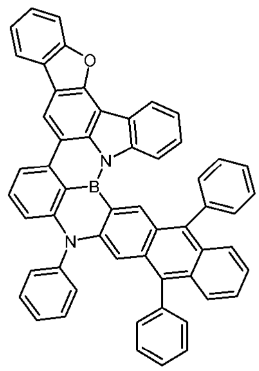
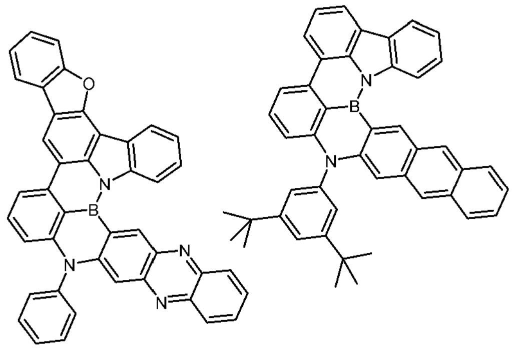
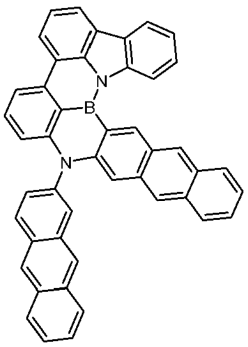
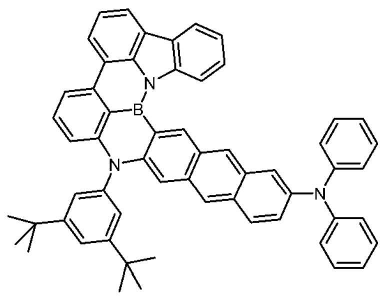
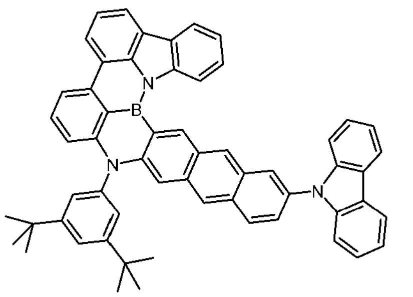

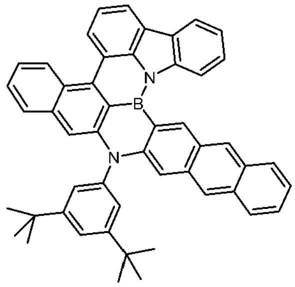 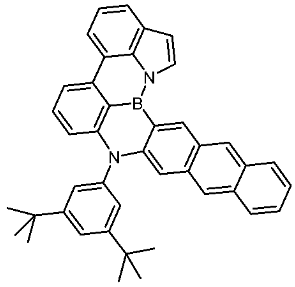

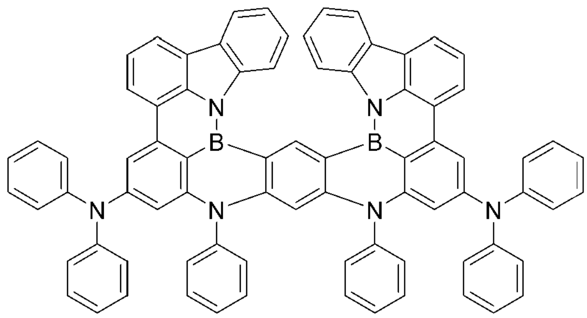

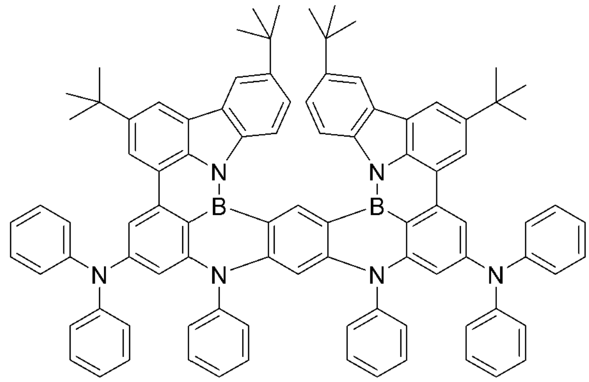

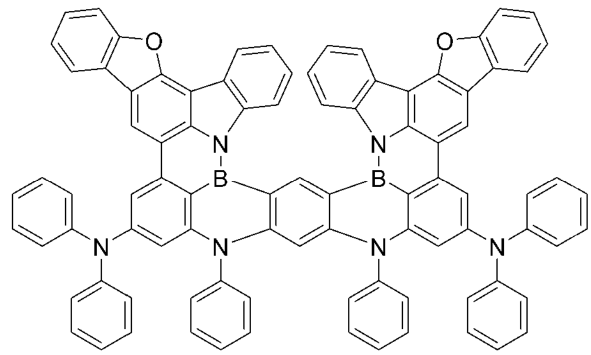

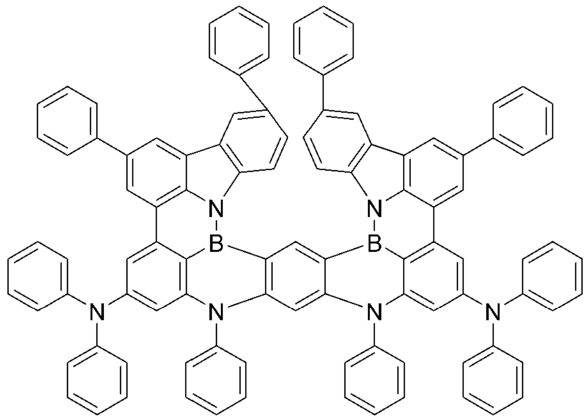

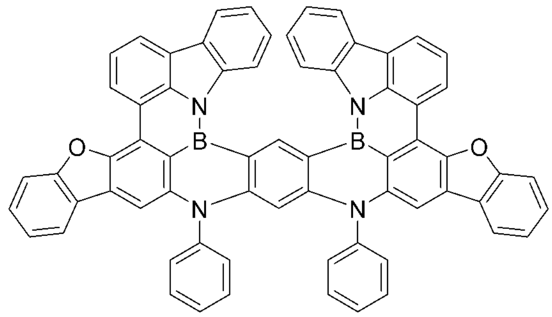

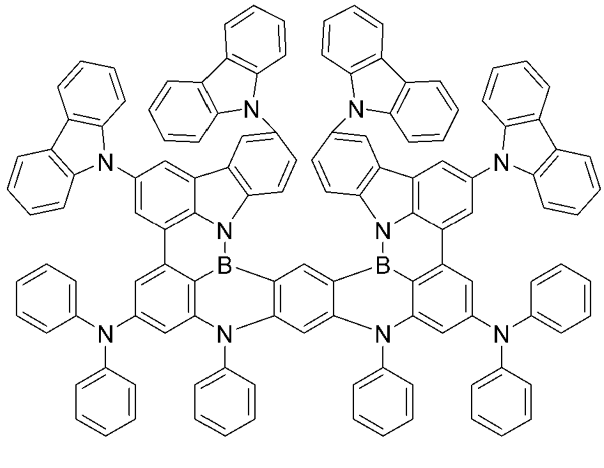

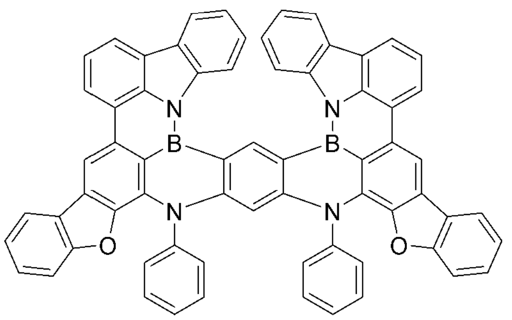

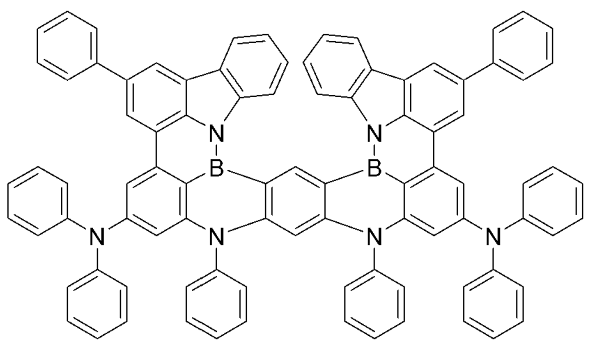

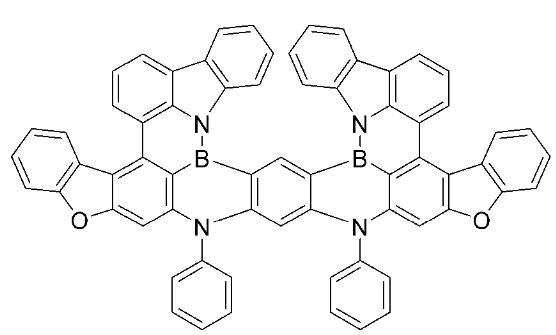

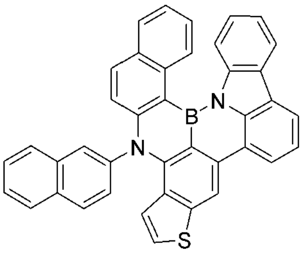 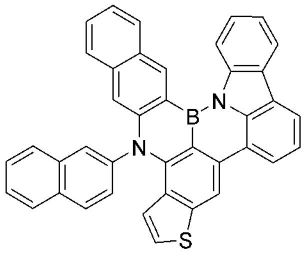 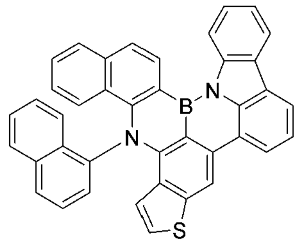

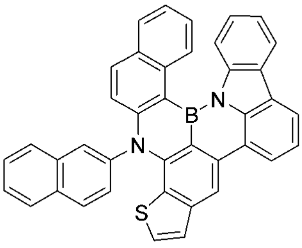 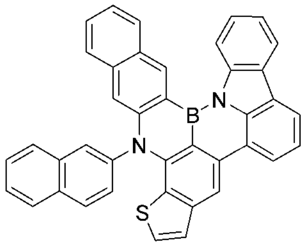 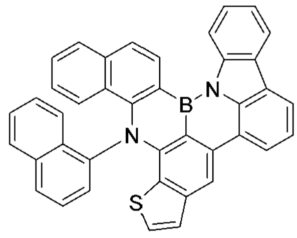

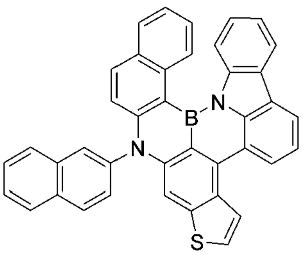 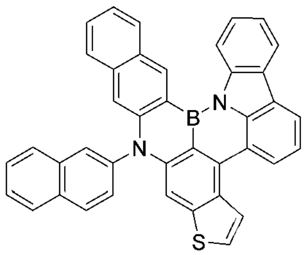 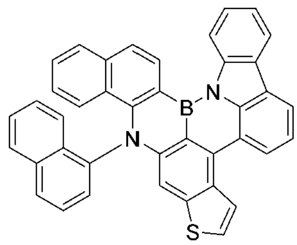

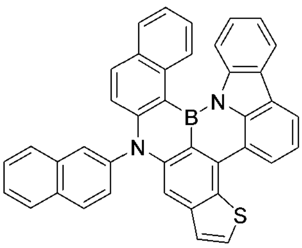 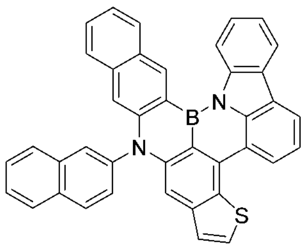 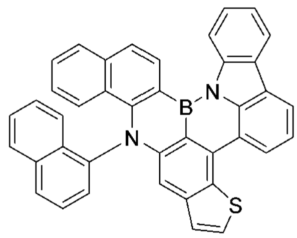

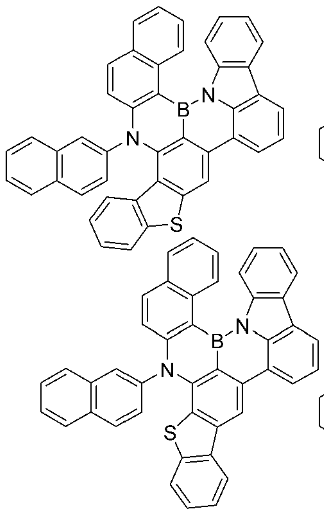 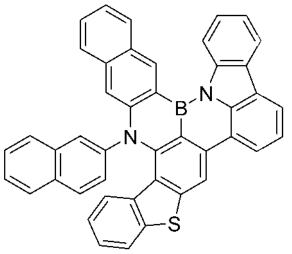 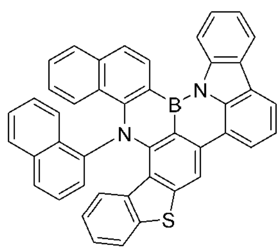

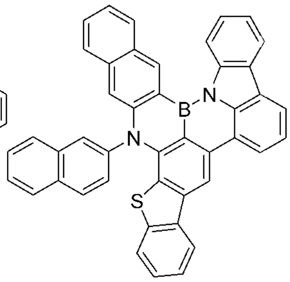 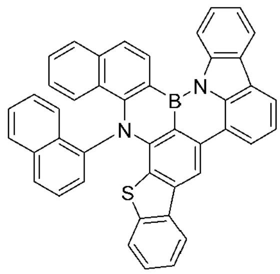

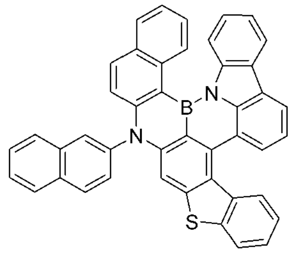
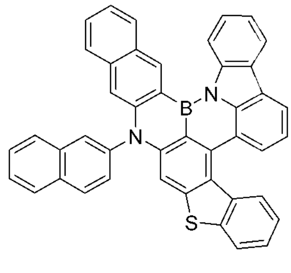
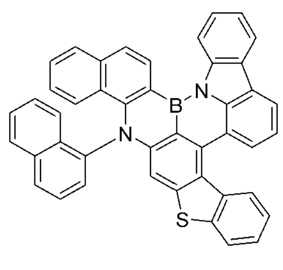

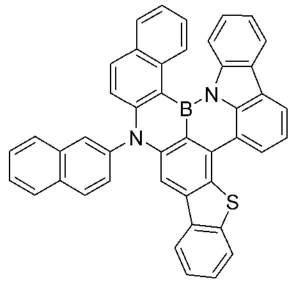
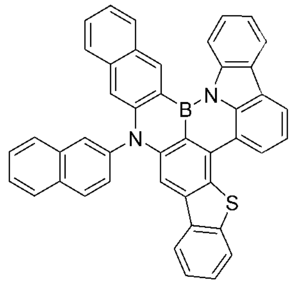
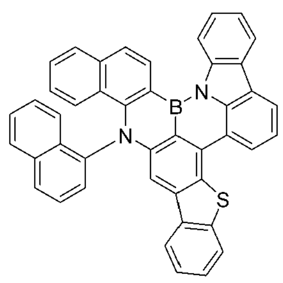

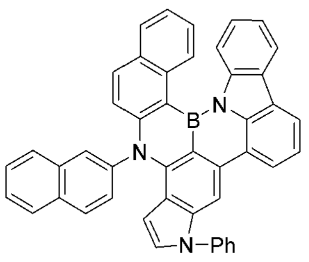
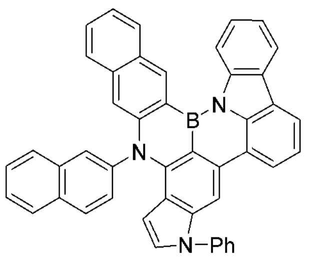
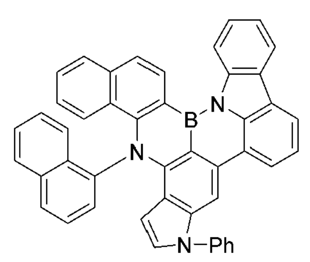

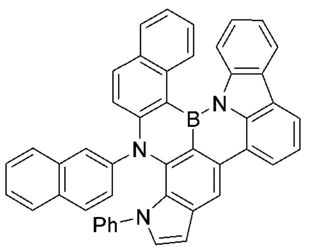
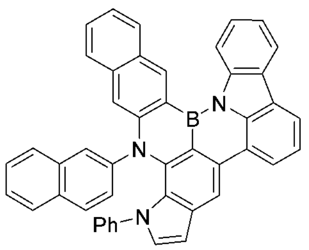
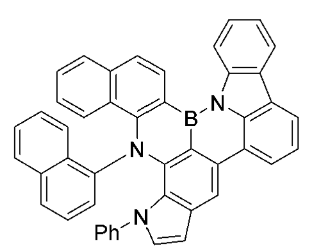

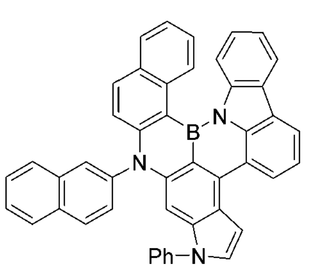
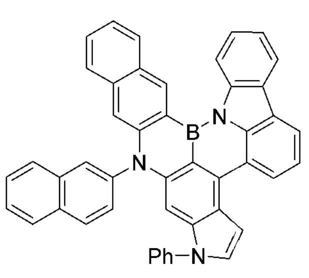
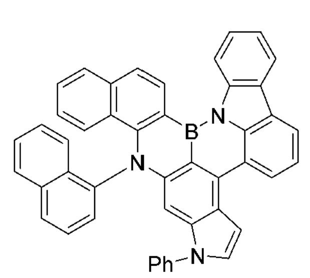

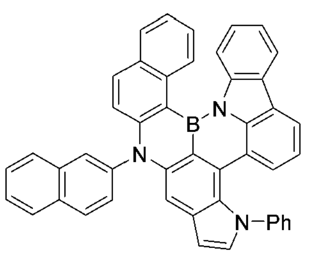
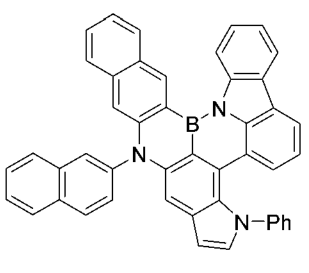
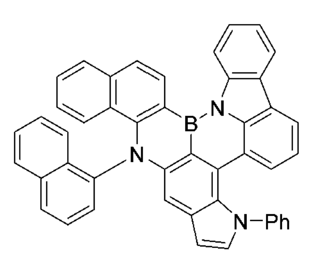

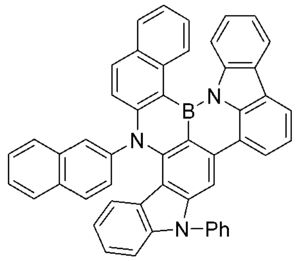
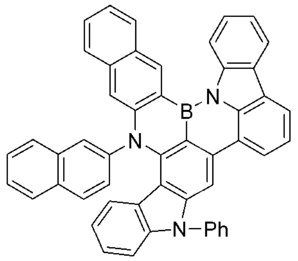
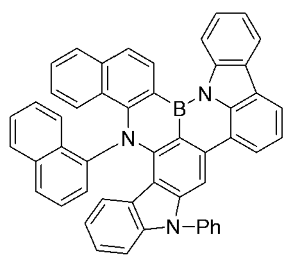

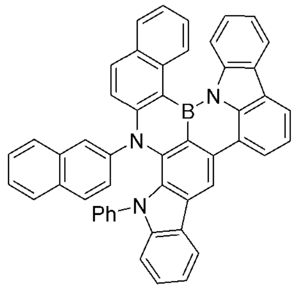
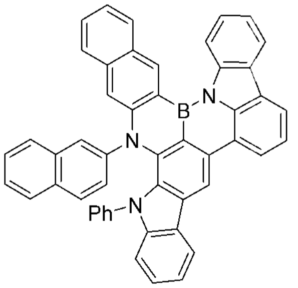
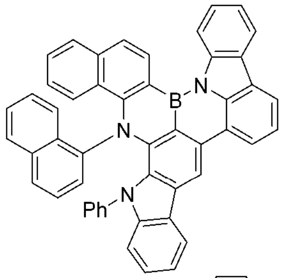

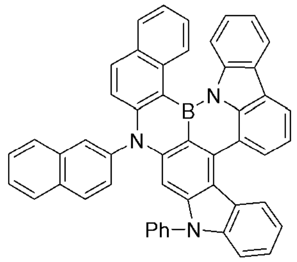
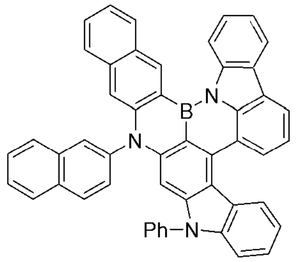
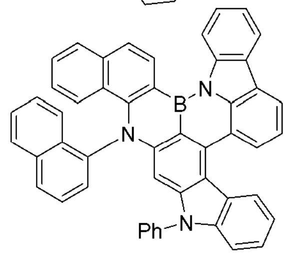

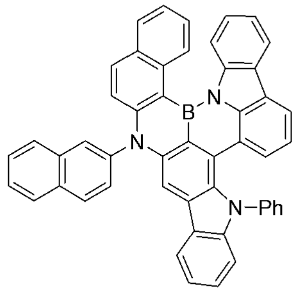
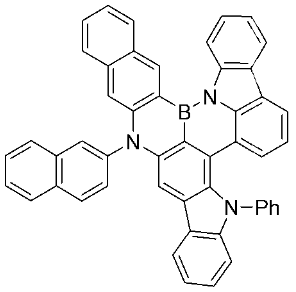
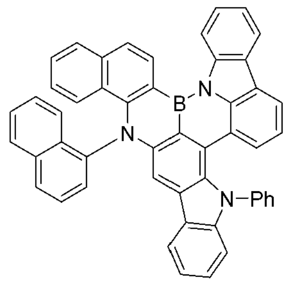

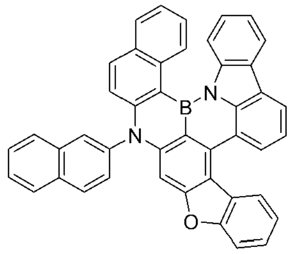
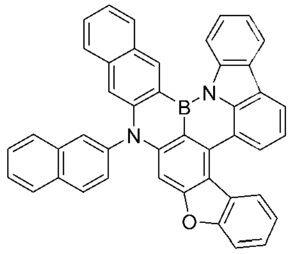
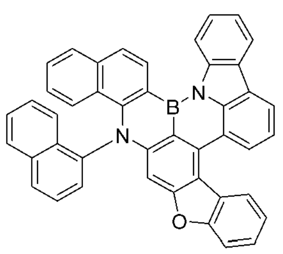

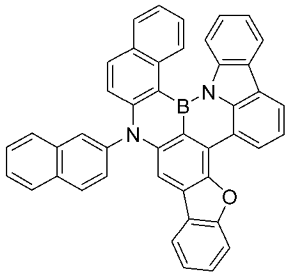
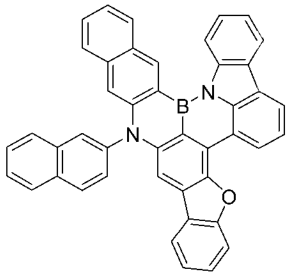
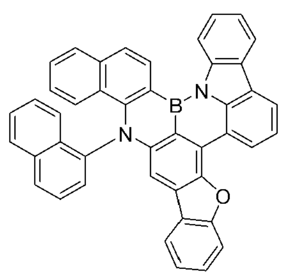

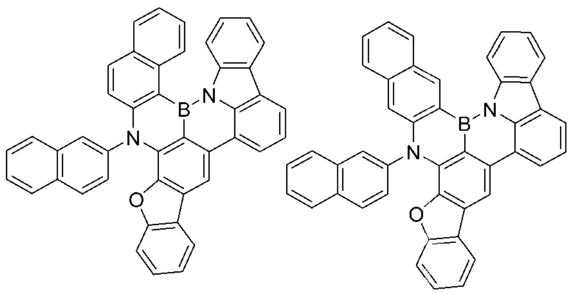
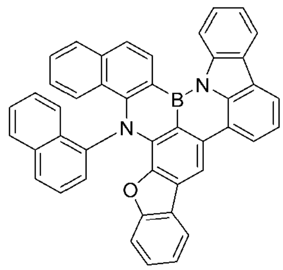

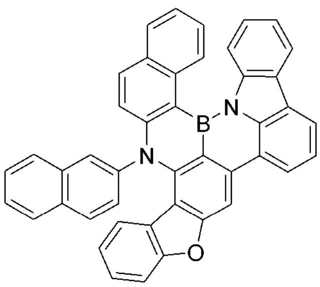
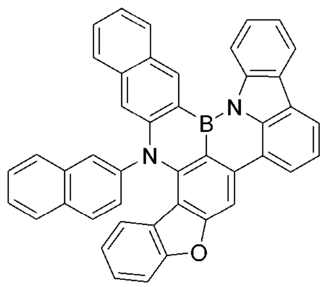
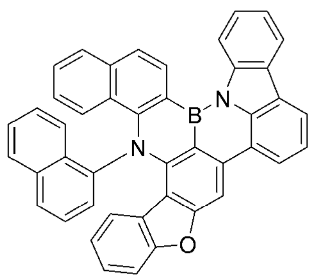

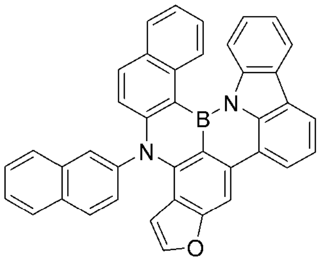
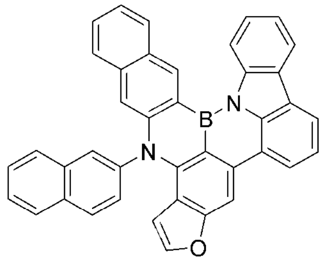
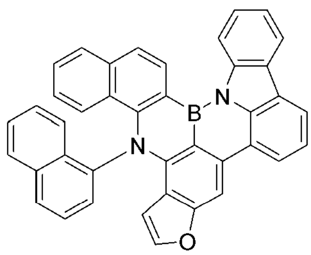

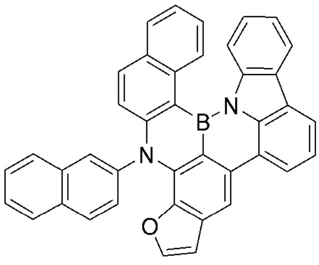
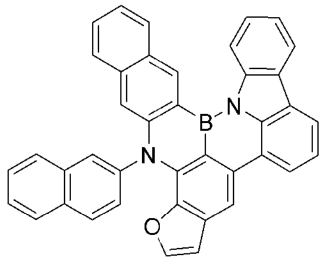
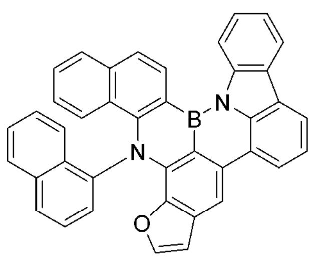

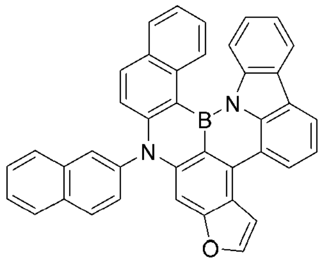
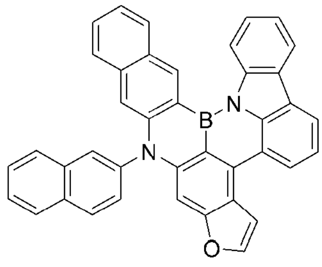
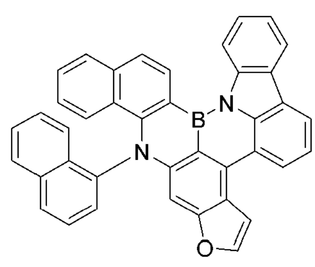
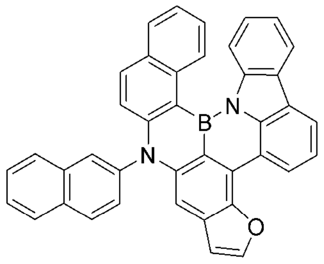
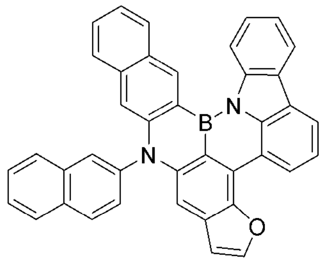
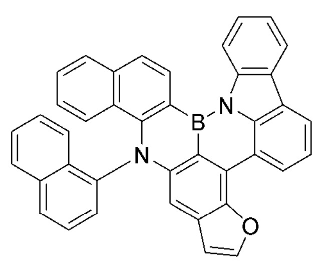
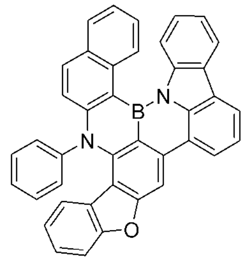
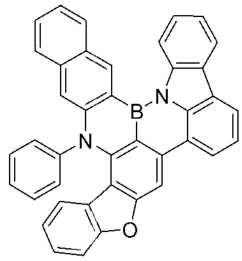
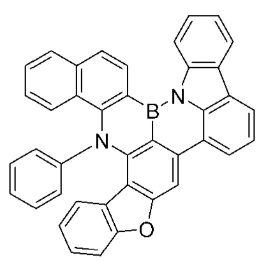
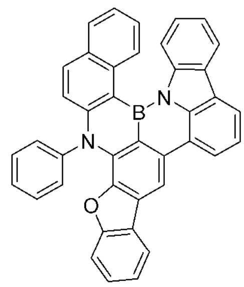
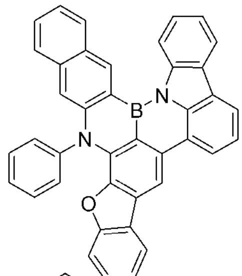
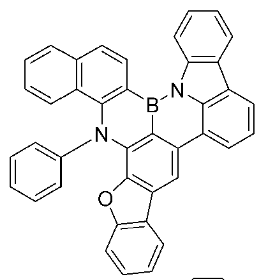
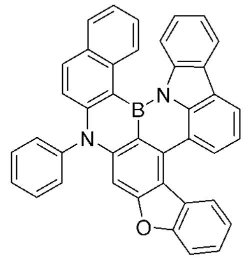
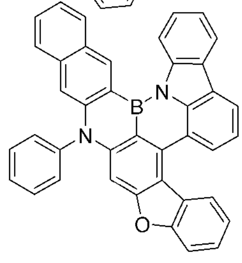
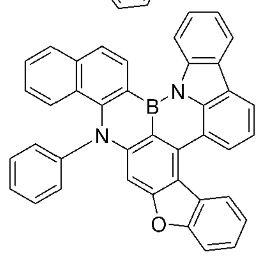
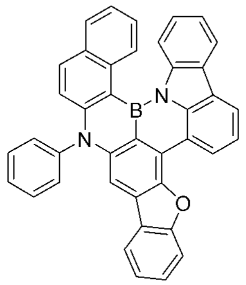
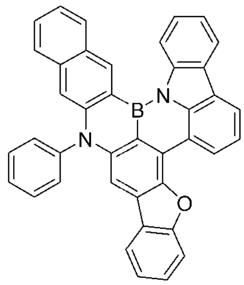
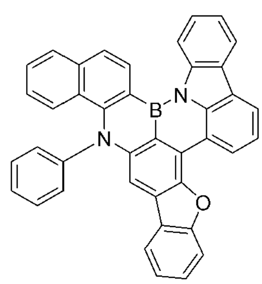

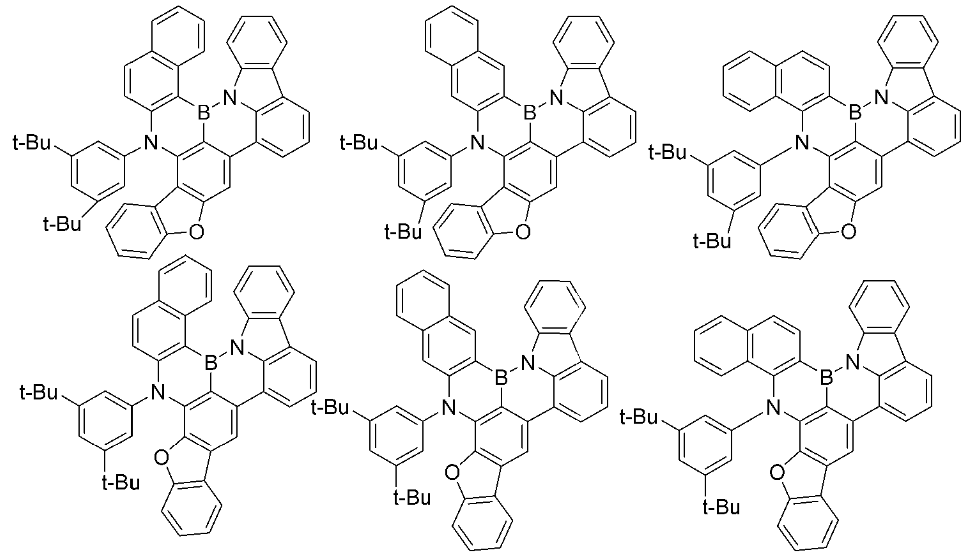

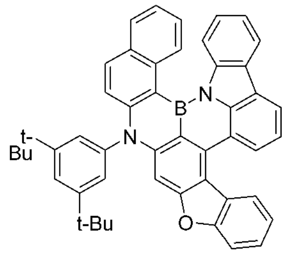
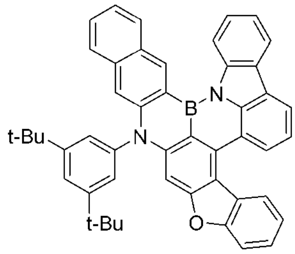
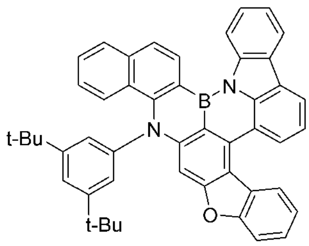

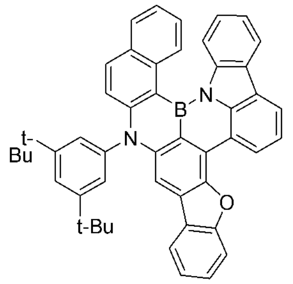
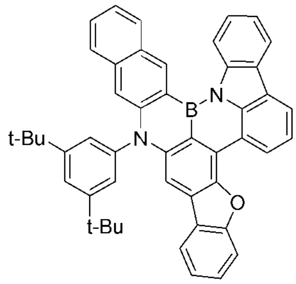
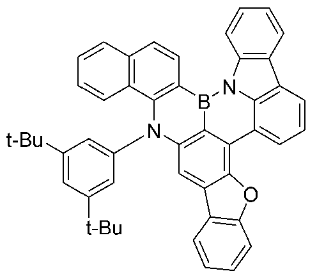

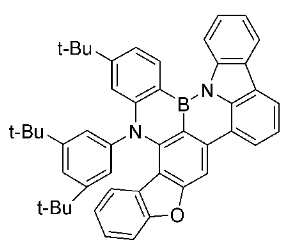
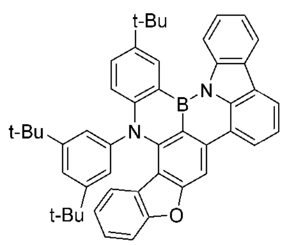
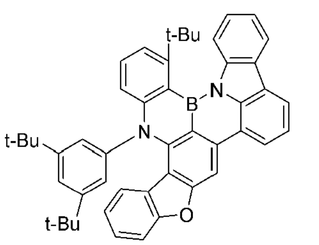
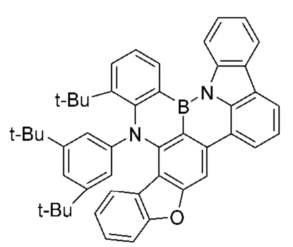

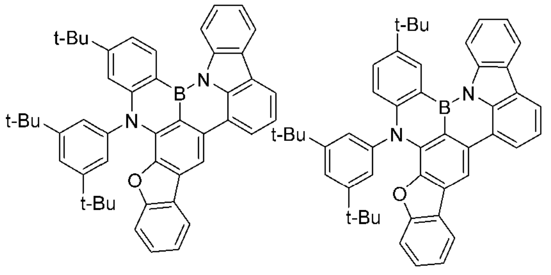
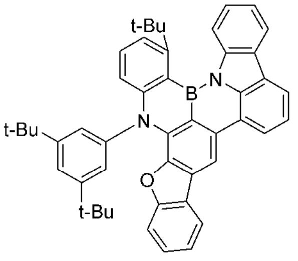
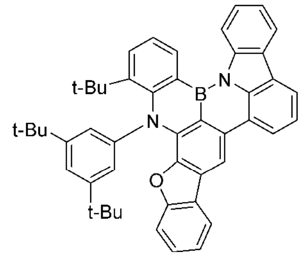

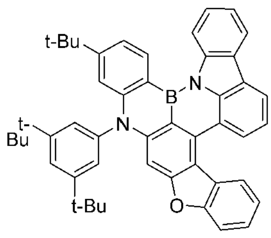
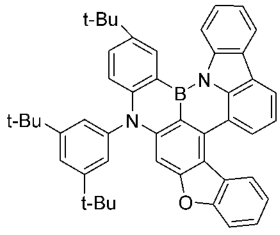
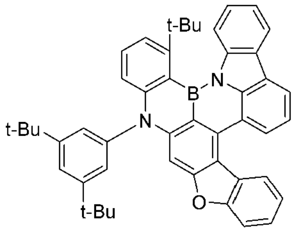
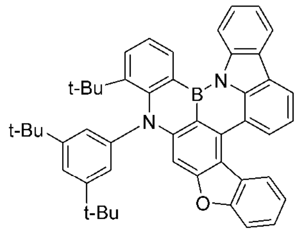

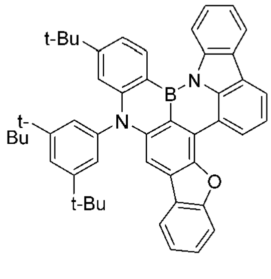
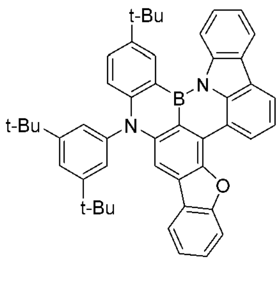
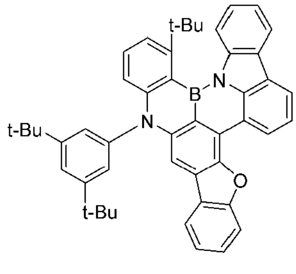
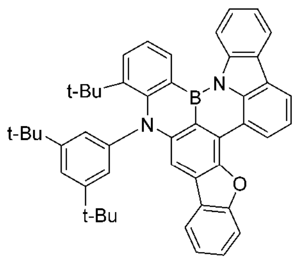

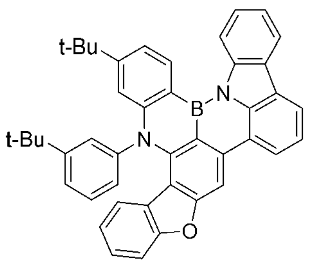
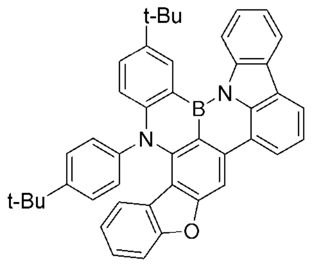
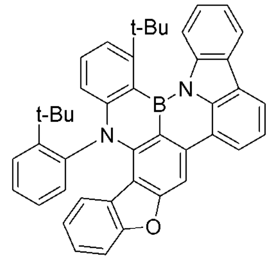

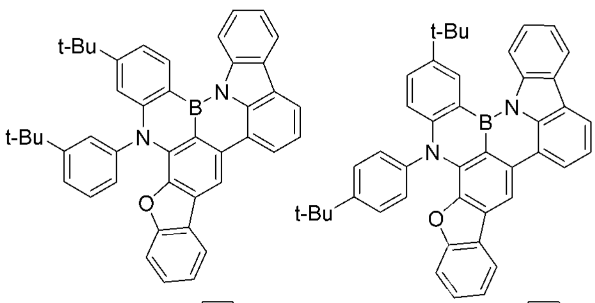
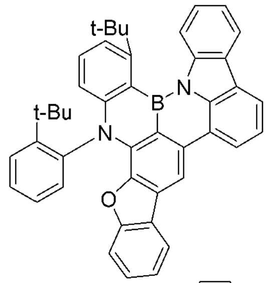

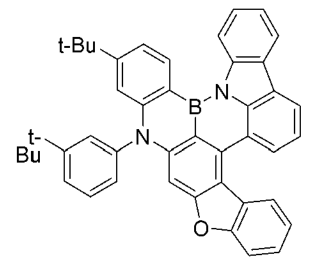
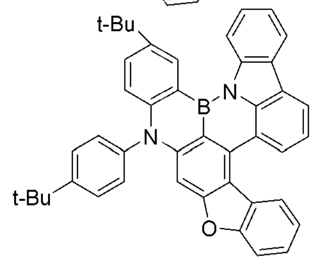
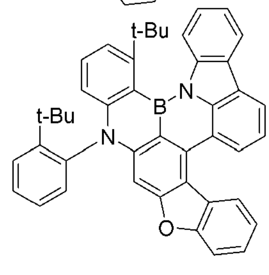

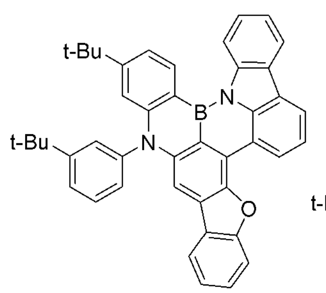
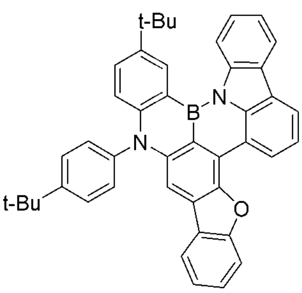
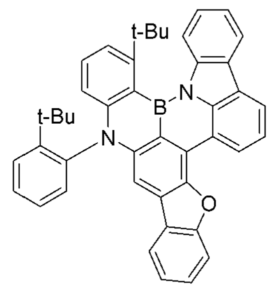

Mes=
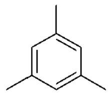

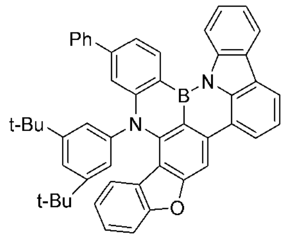
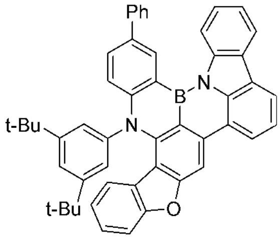
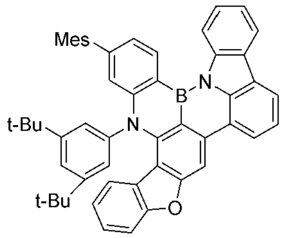
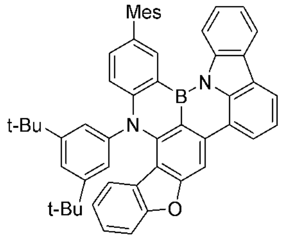

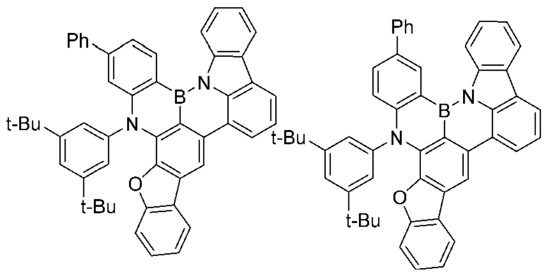
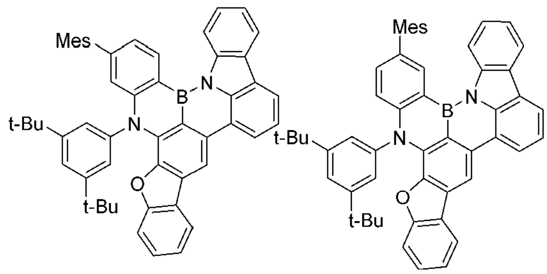

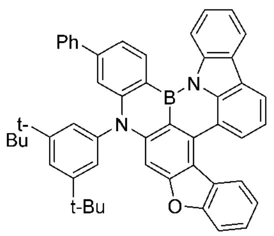
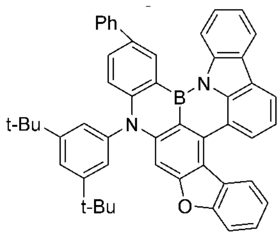
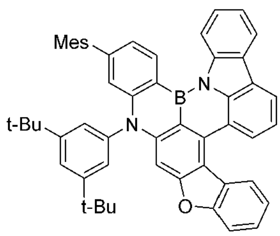
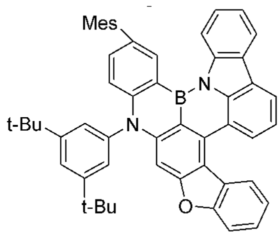

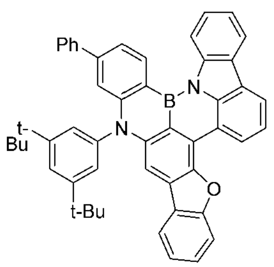
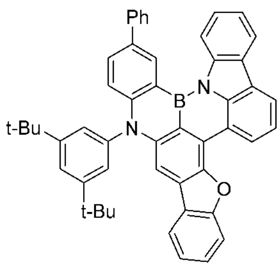
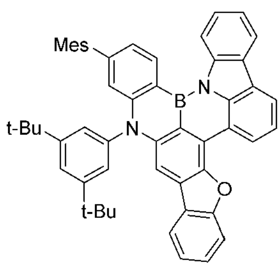
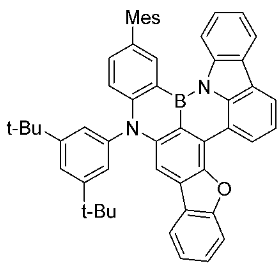

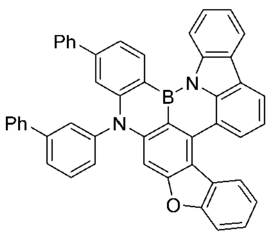
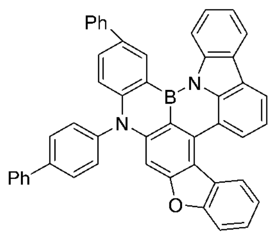
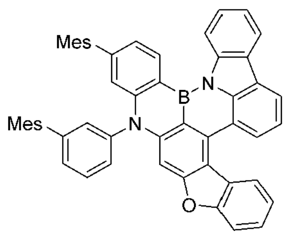
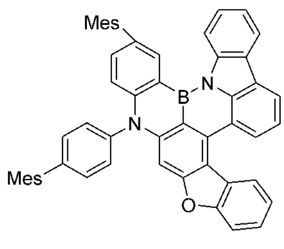

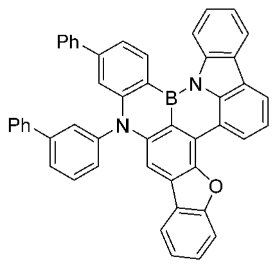 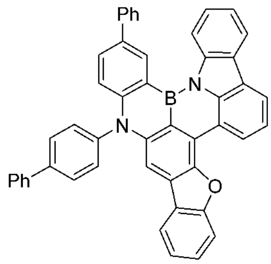 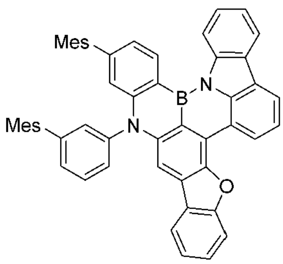 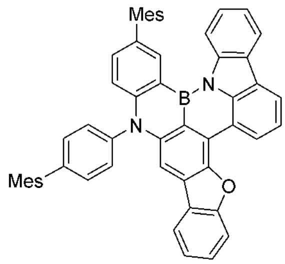

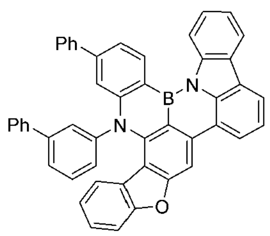 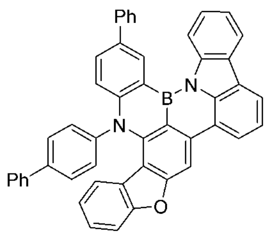 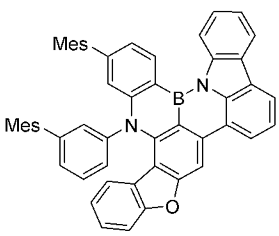 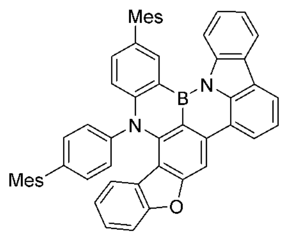

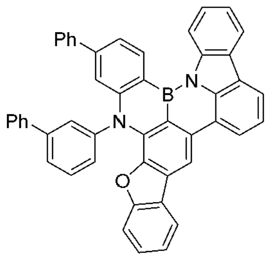 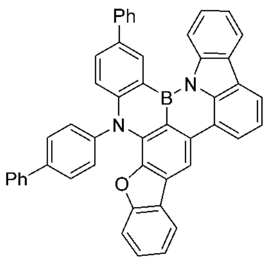 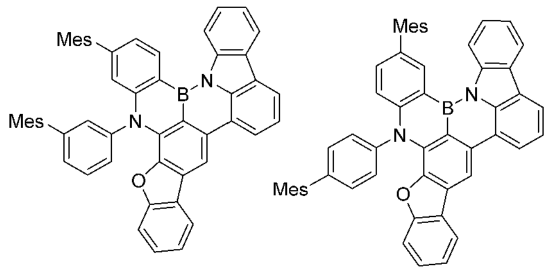

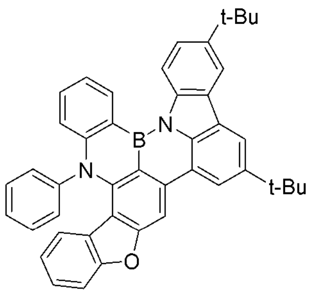 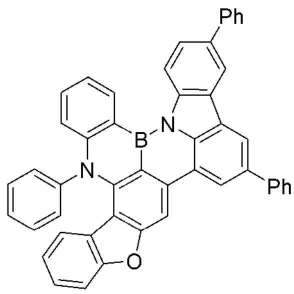 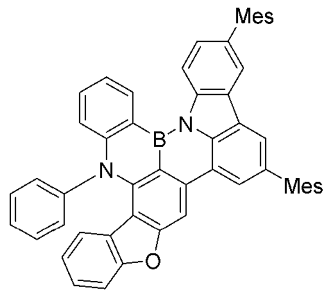

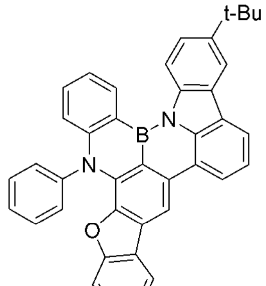 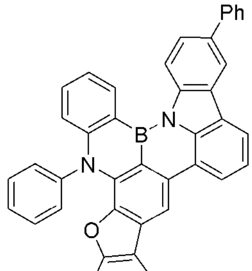 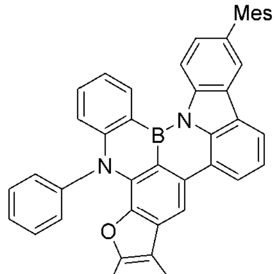

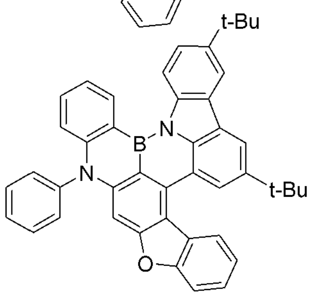 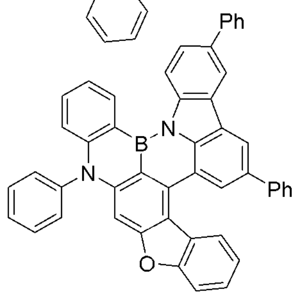 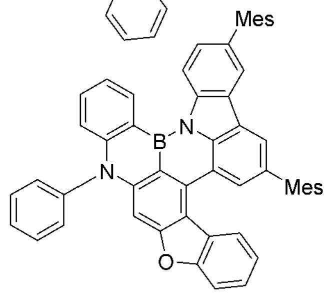

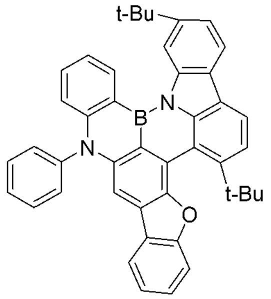
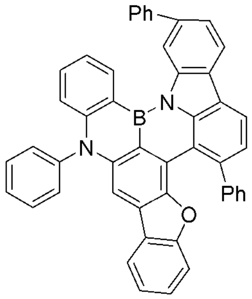
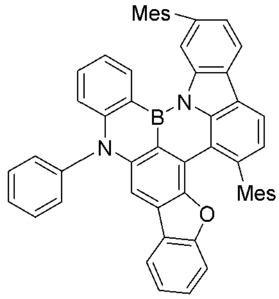

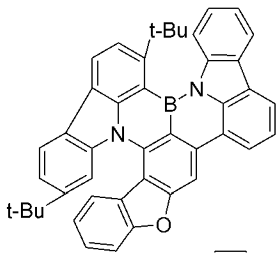
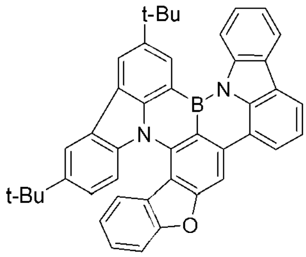
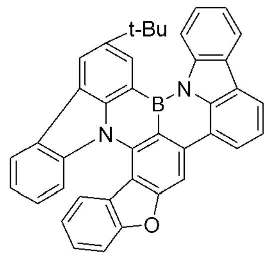

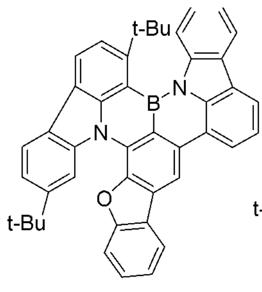
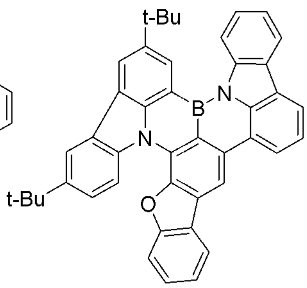
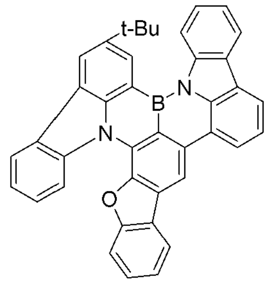

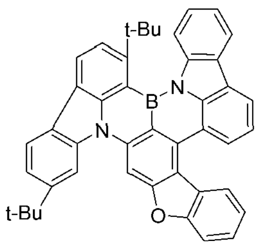
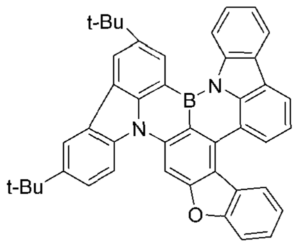
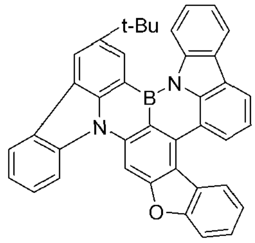

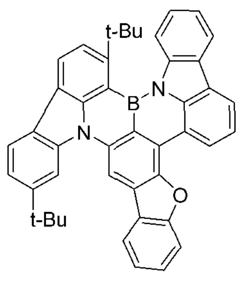
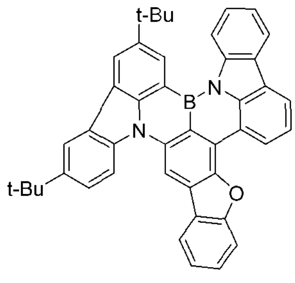
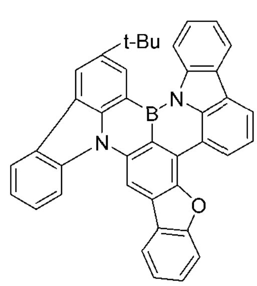

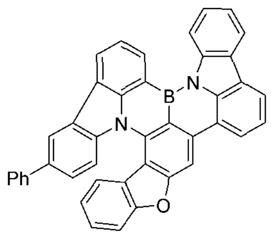 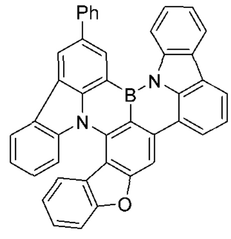 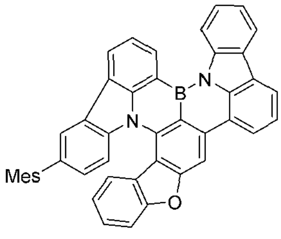 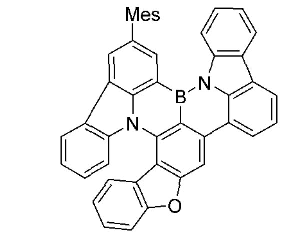

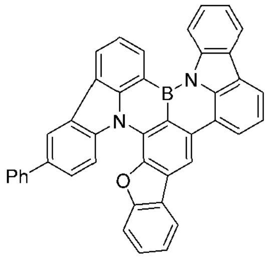 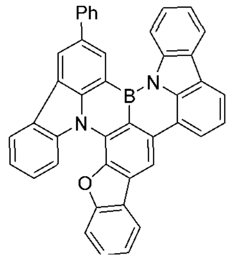 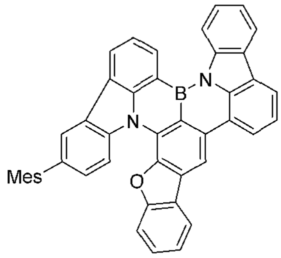 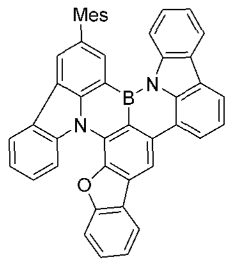

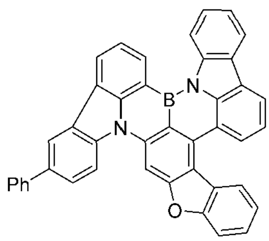 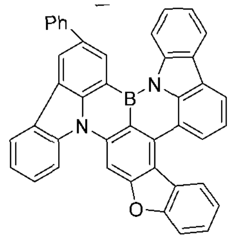 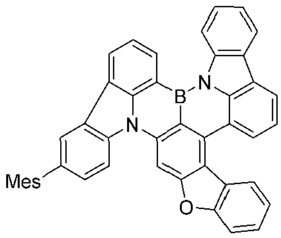 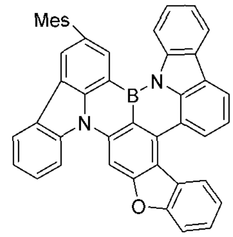

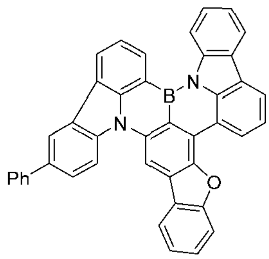 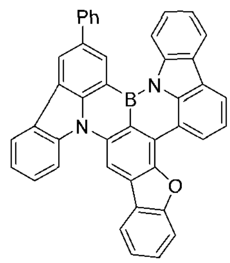 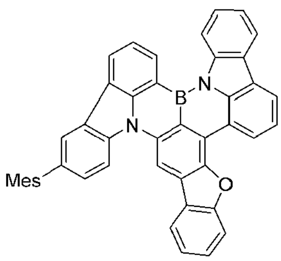 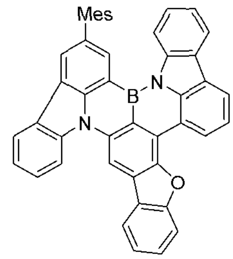

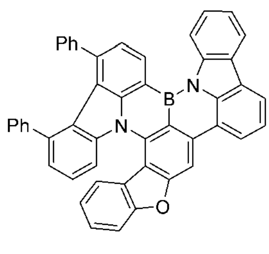 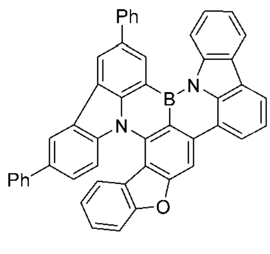 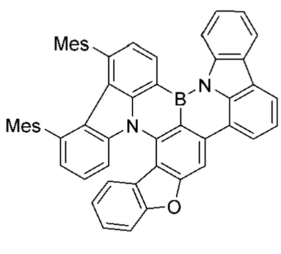 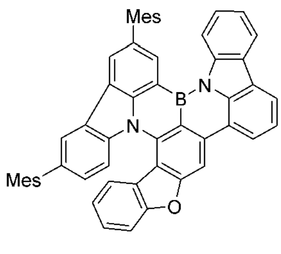

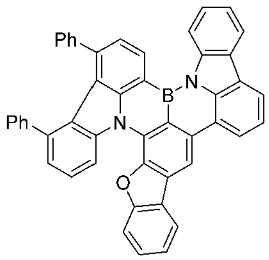 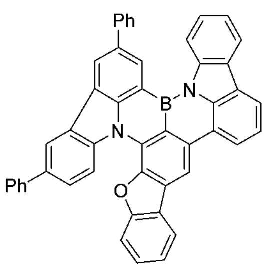 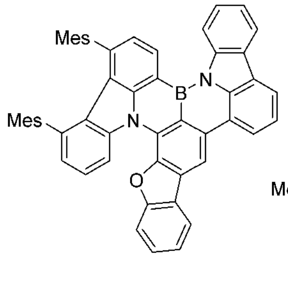 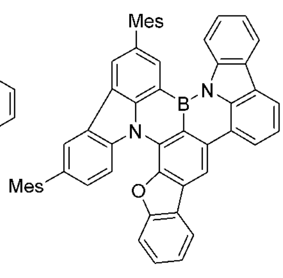

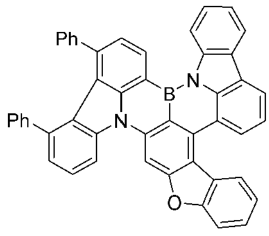
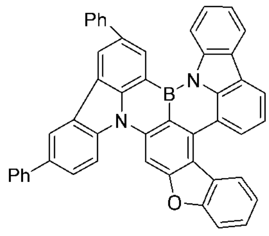
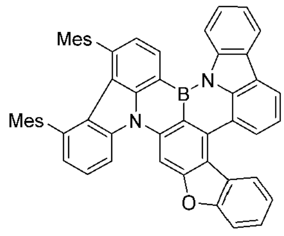
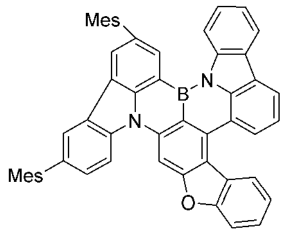

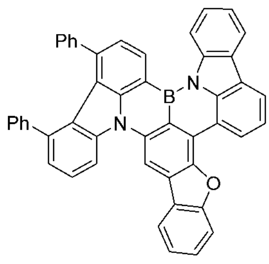
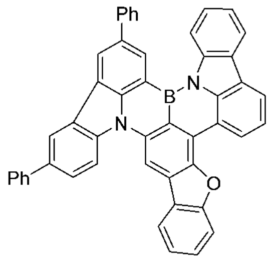
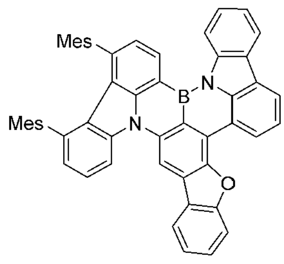
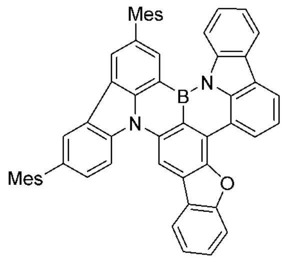

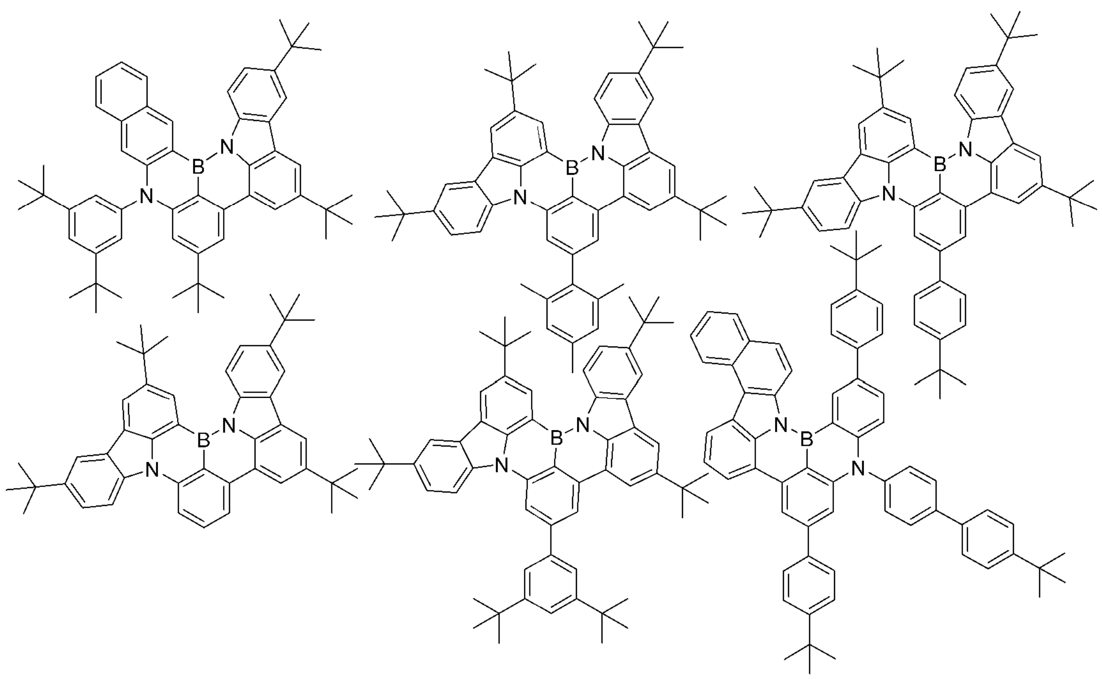

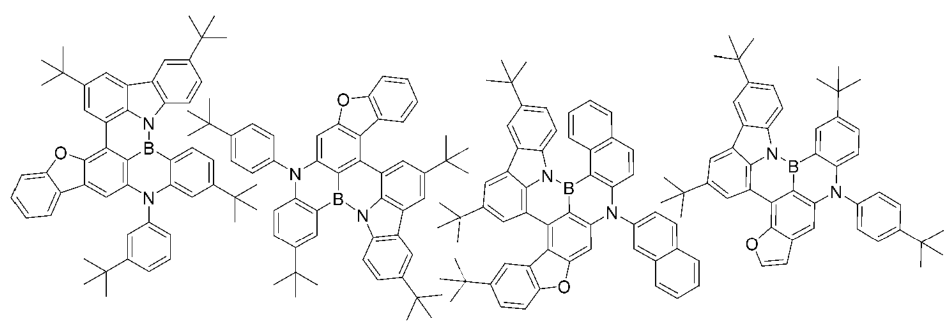

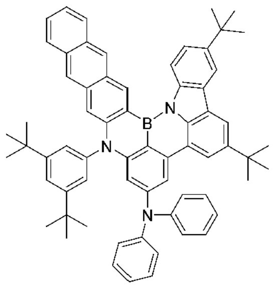
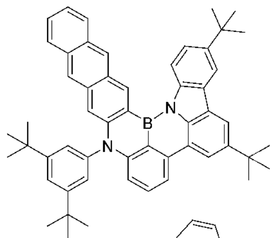
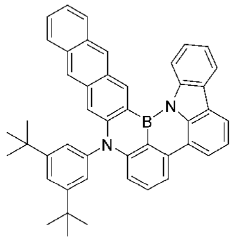
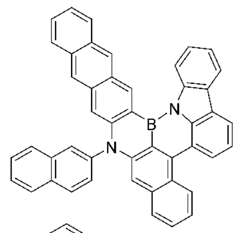
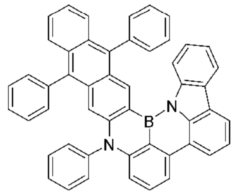
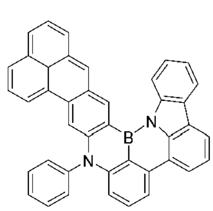
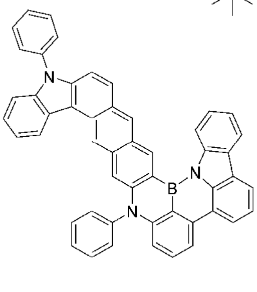
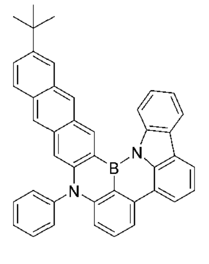
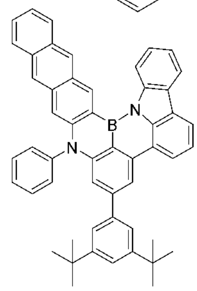
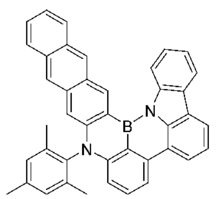
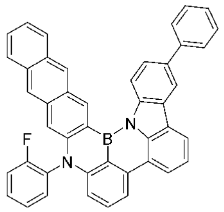
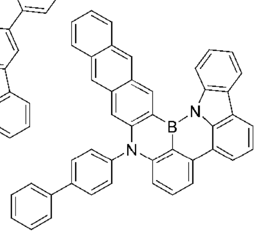
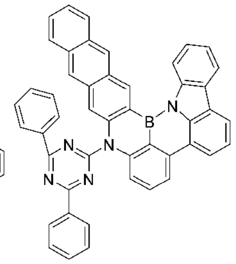
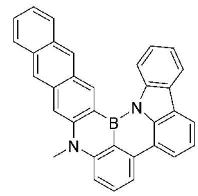
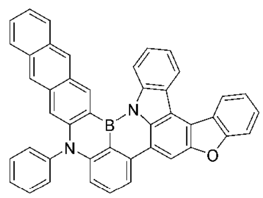
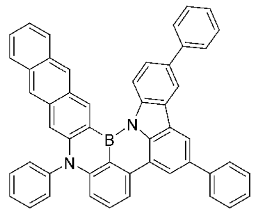
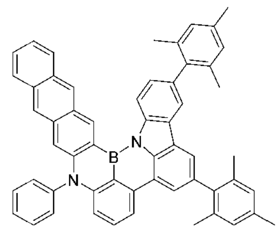
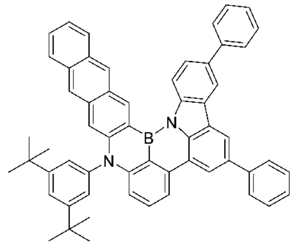
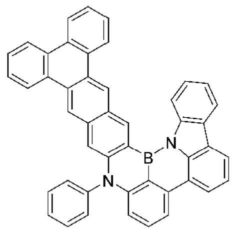
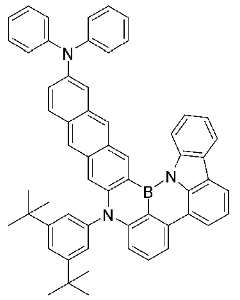
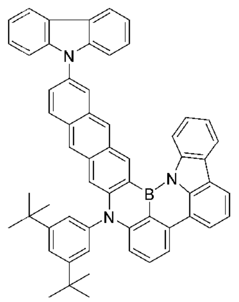
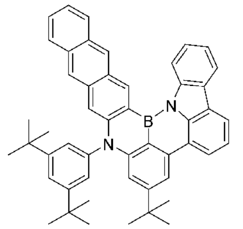
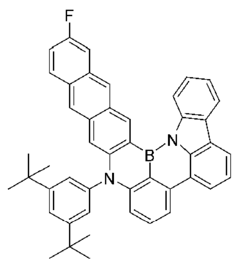
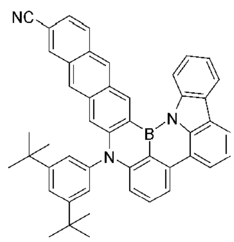
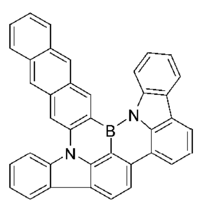
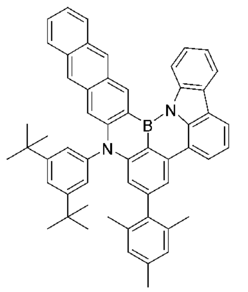

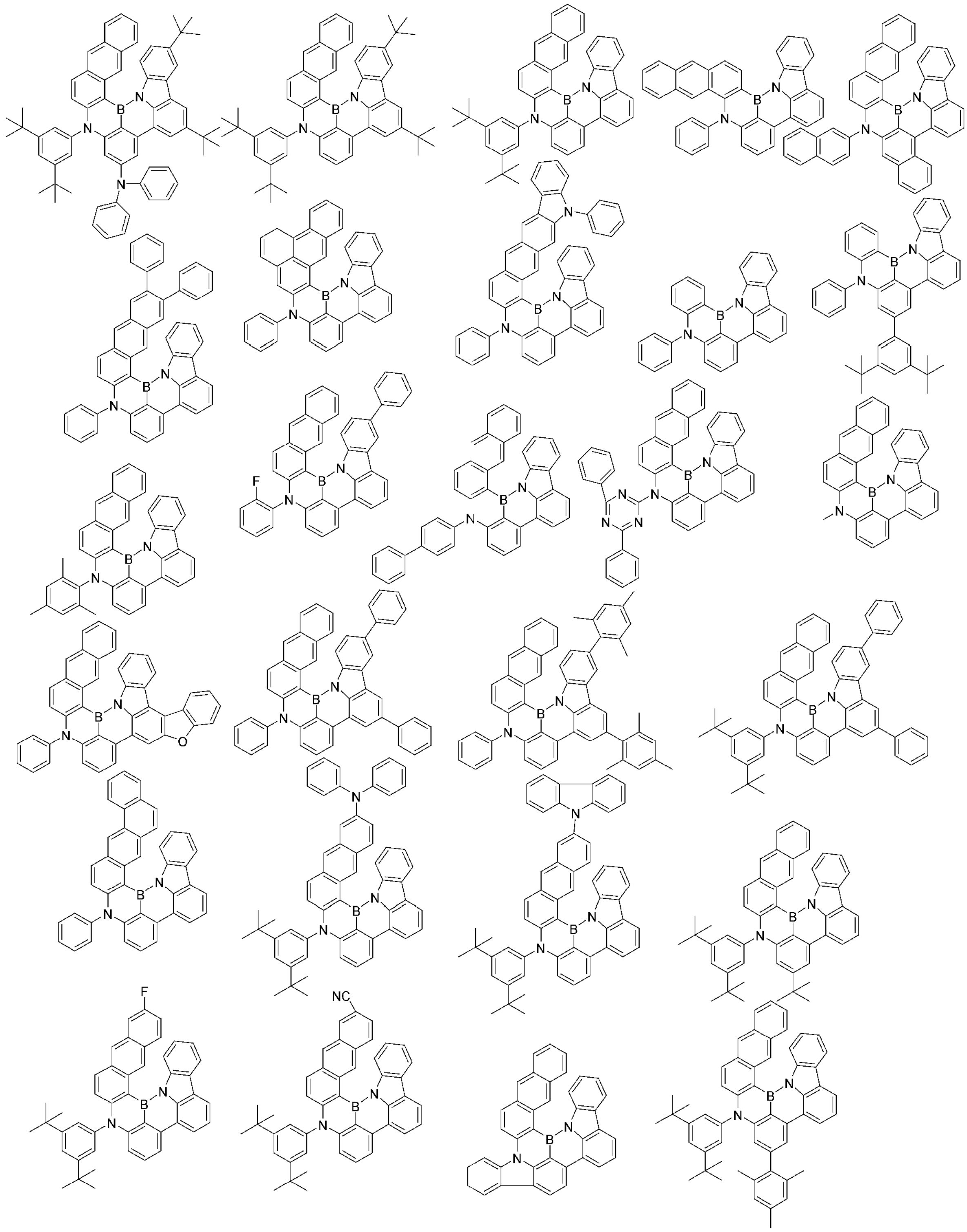

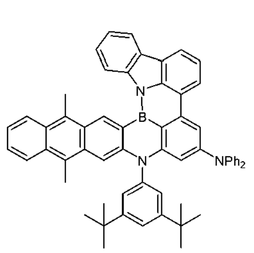

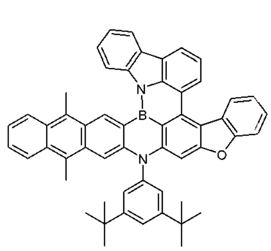

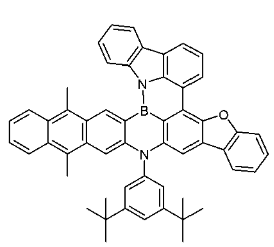

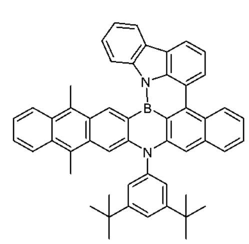

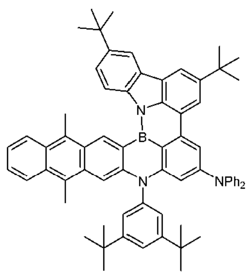 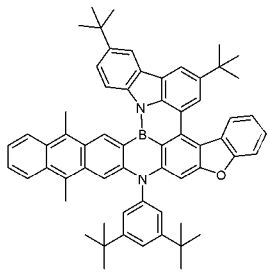 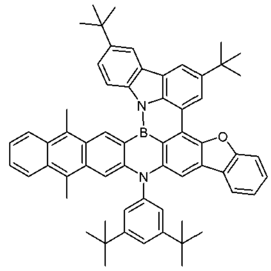 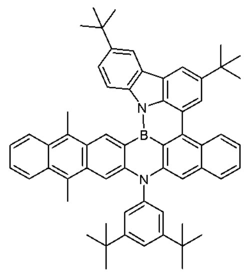

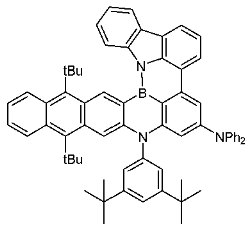 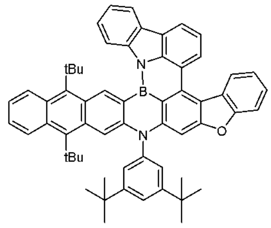 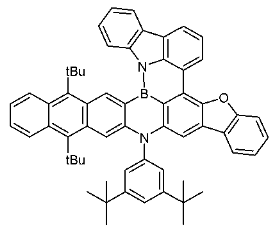 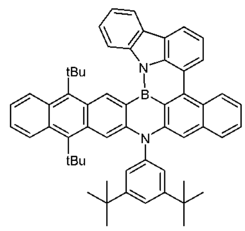

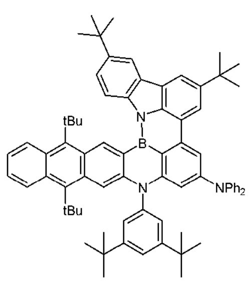 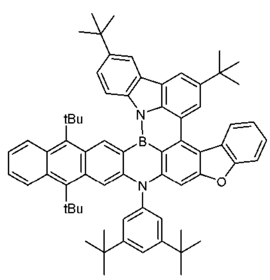 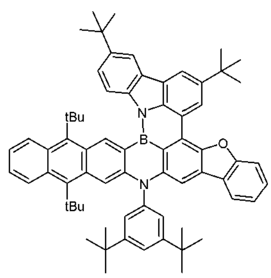 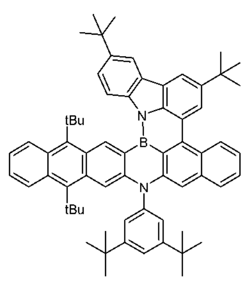

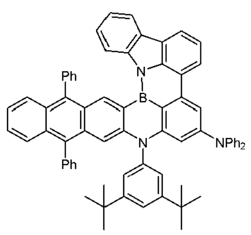 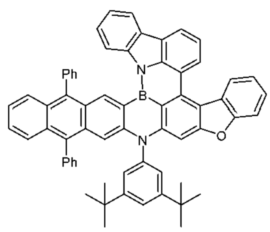 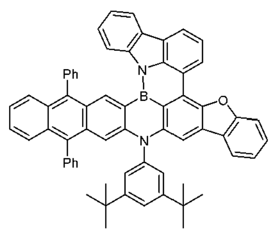 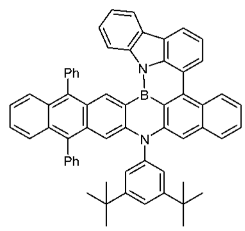

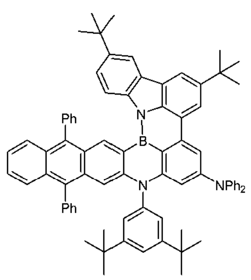 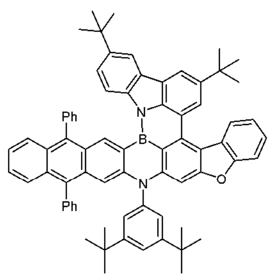 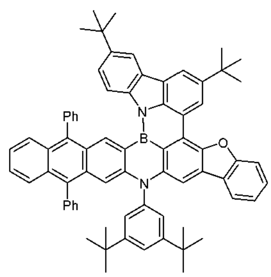 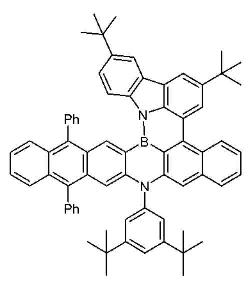

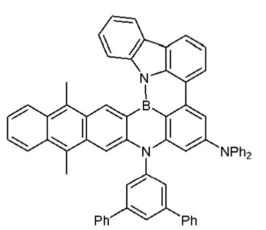 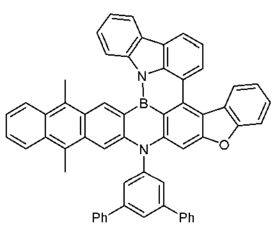 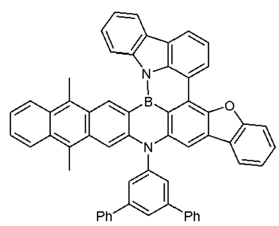 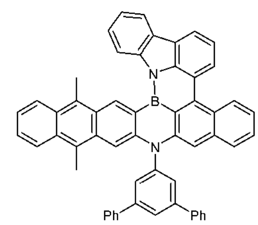

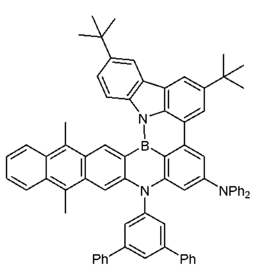
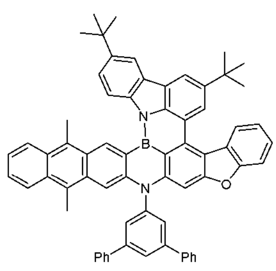
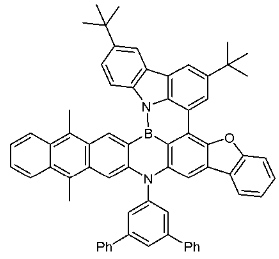
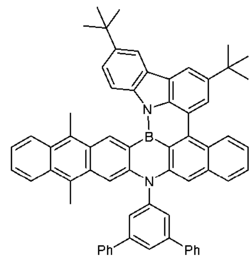

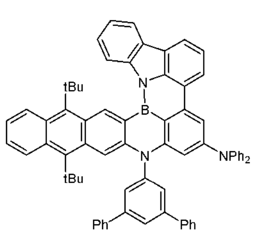
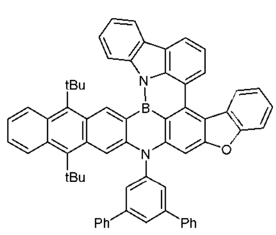
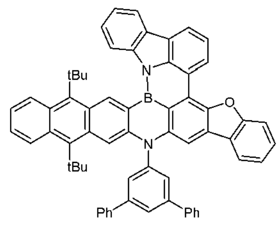
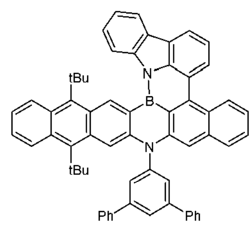

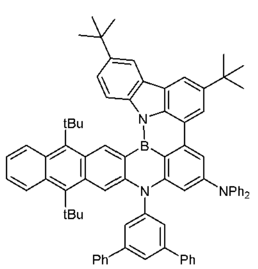
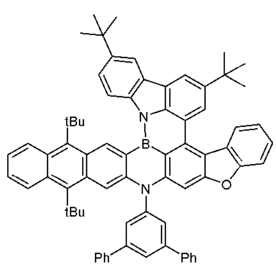
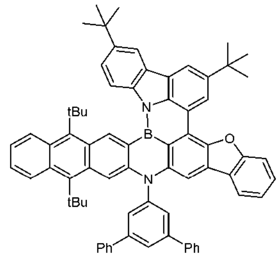
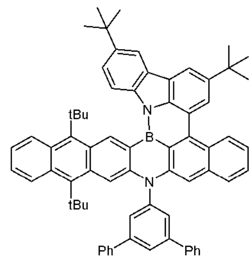

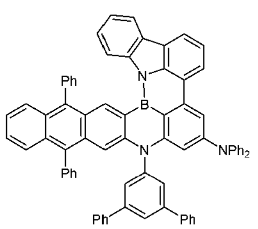
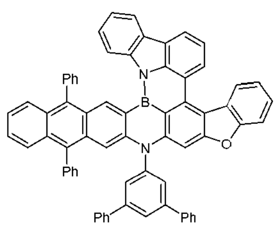
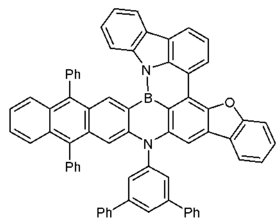
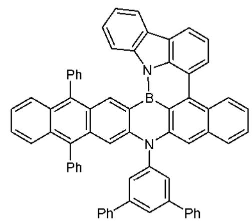

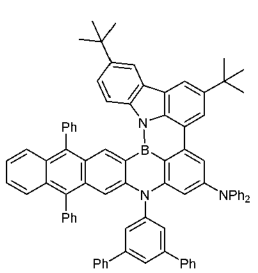
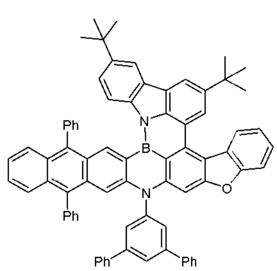
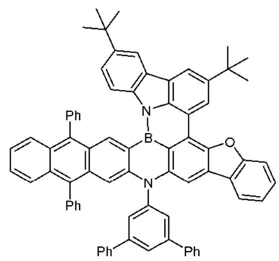
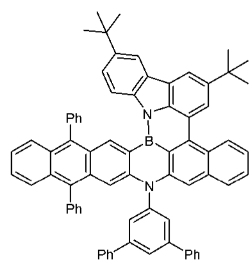

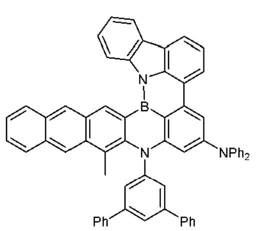
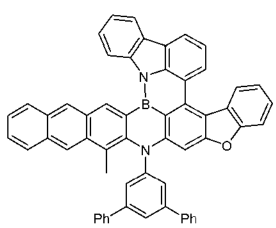
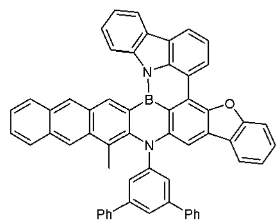
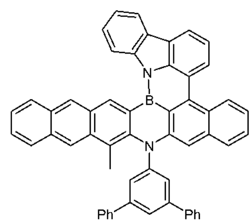

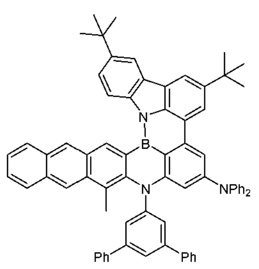
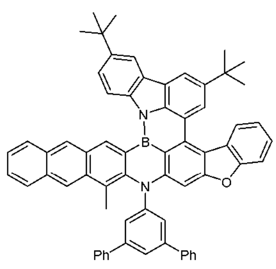
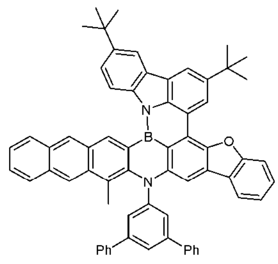
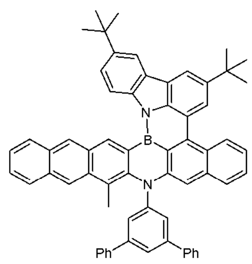
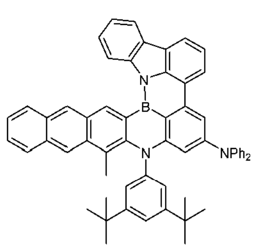
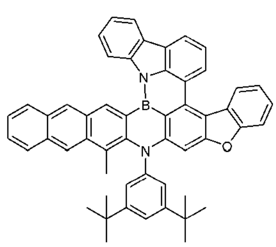
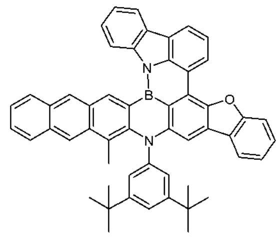
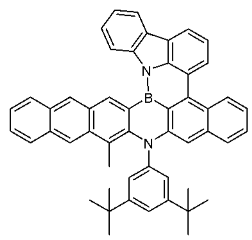
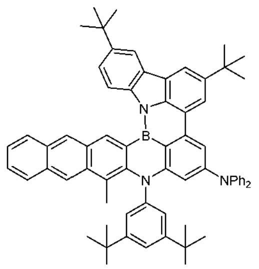
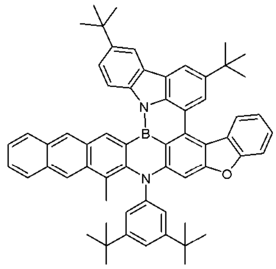
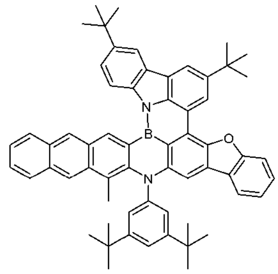
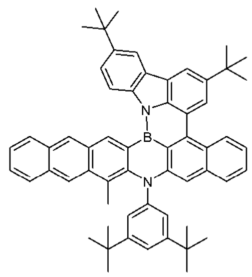
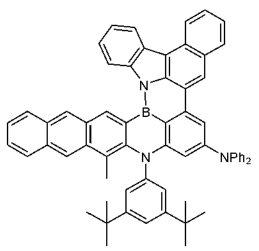
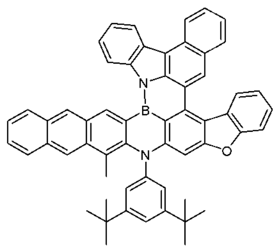
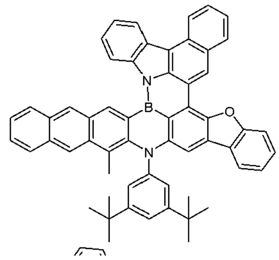
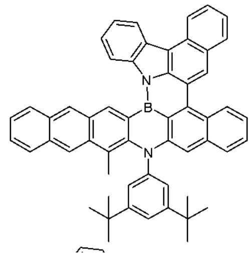
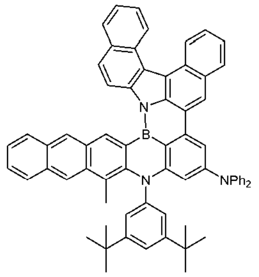
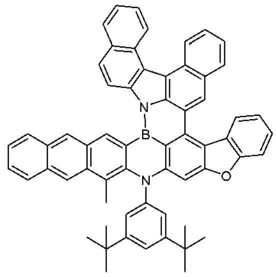
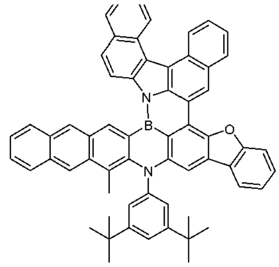
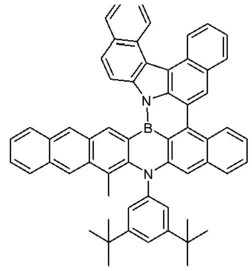
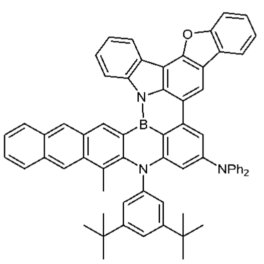
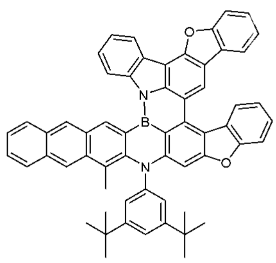
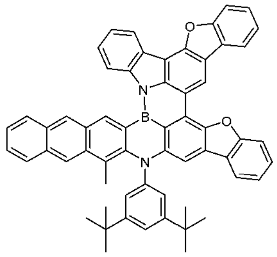
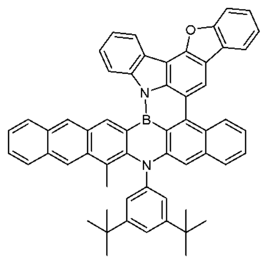

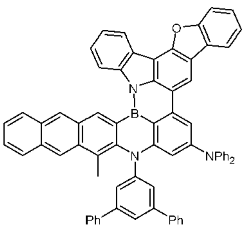
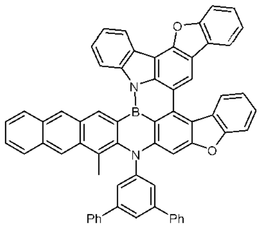
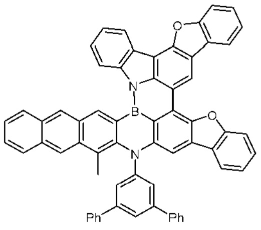
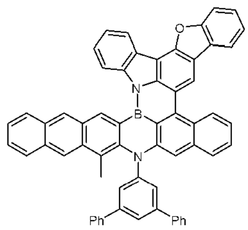

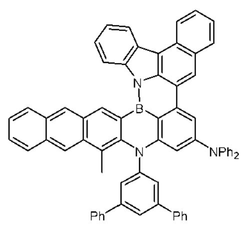
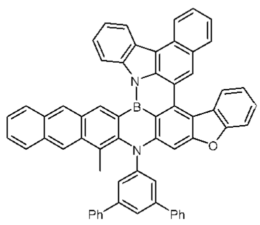
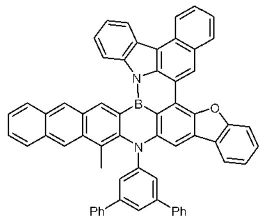
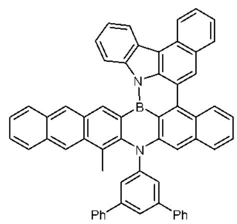

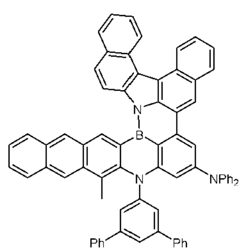
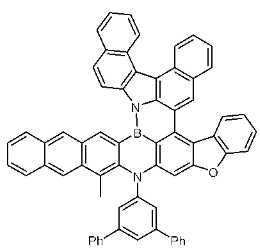
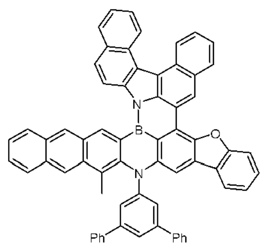
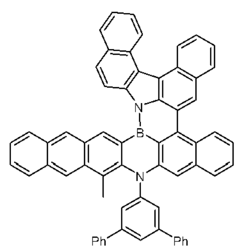

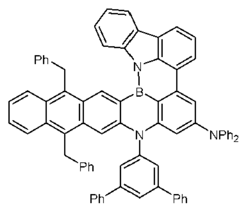
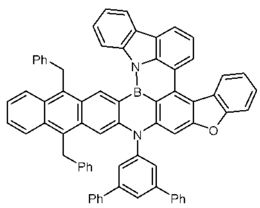
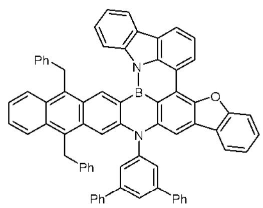
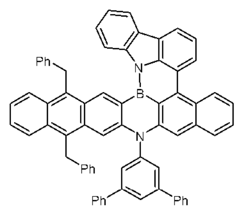

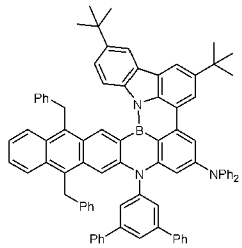
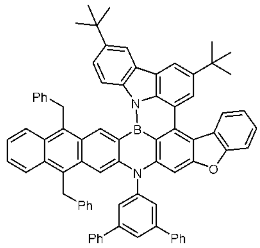
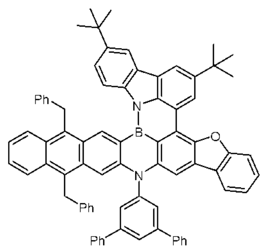
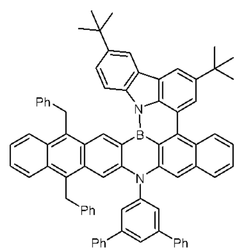

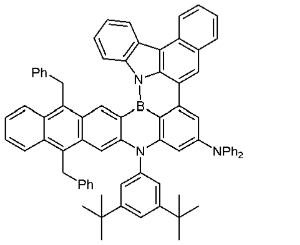
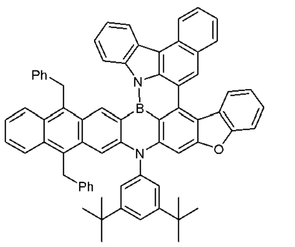
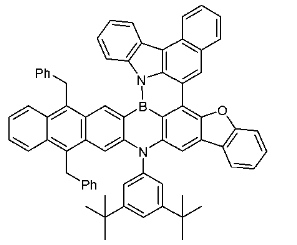
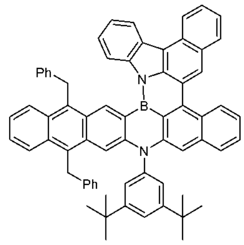
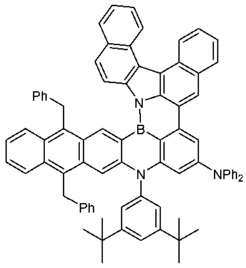
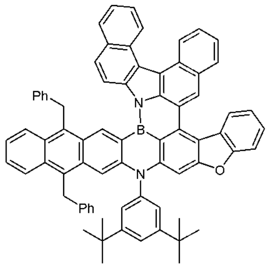
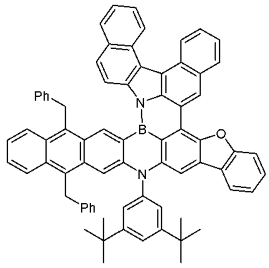
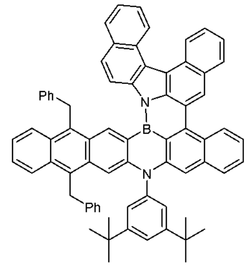
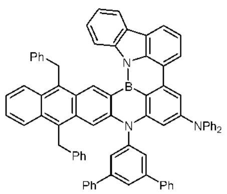
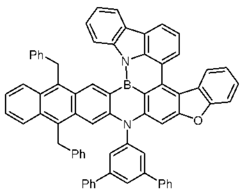
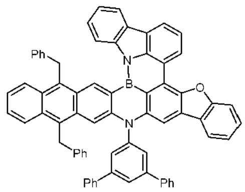
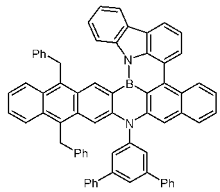
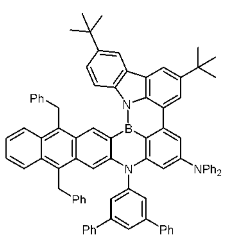
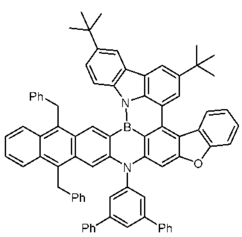
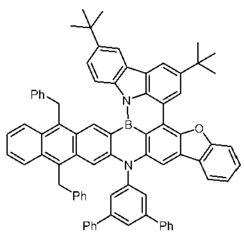
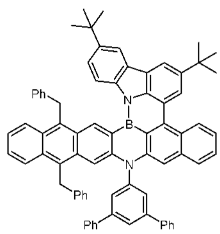
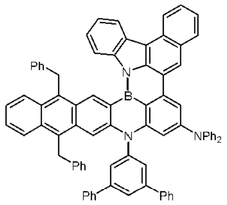
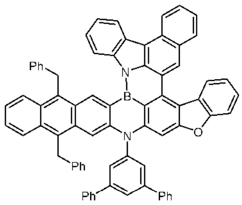
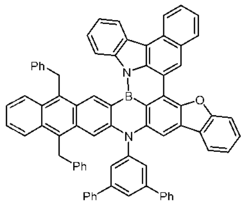
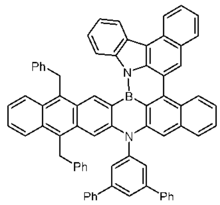
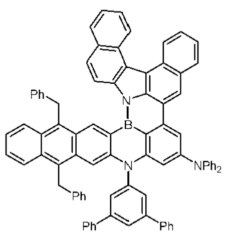
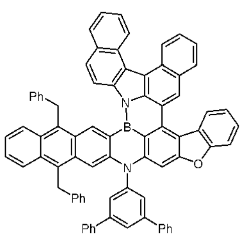
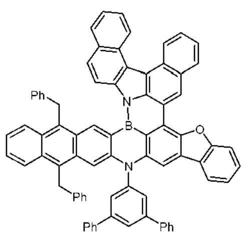
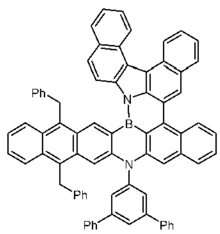

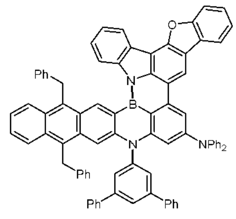
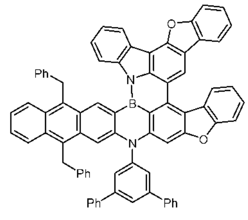
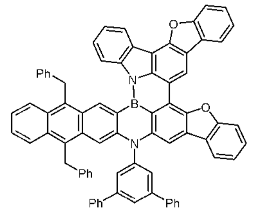
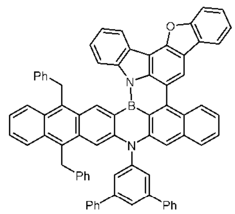

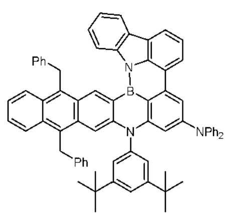
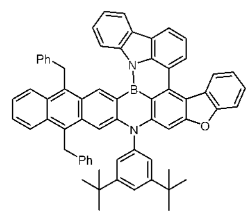
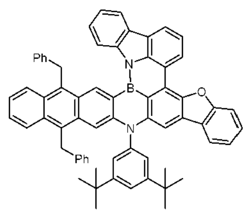
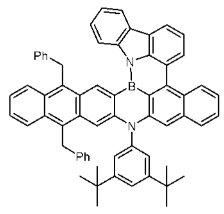

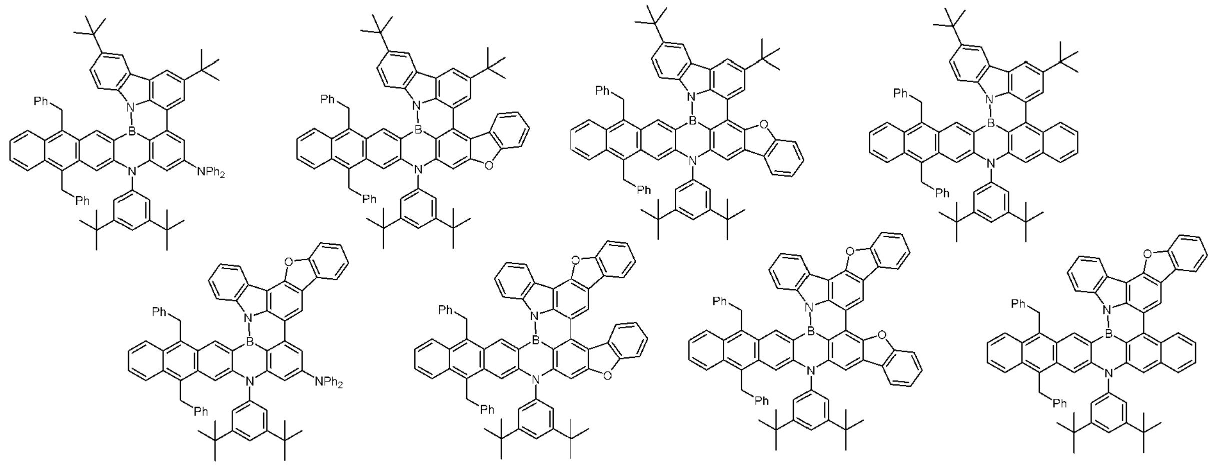

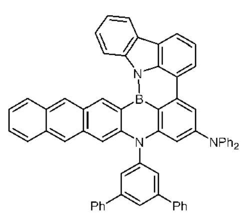
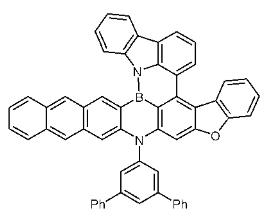
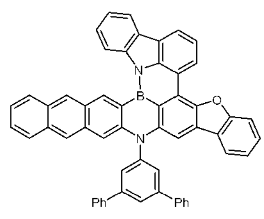
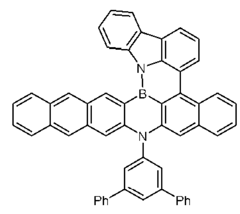

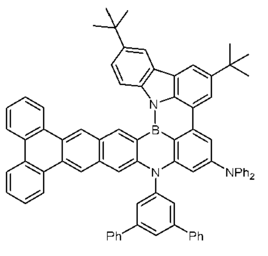
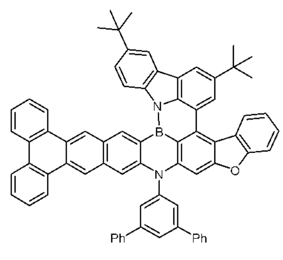
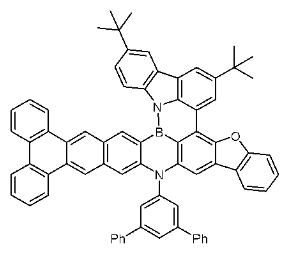
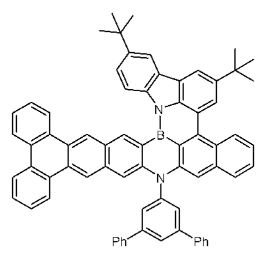

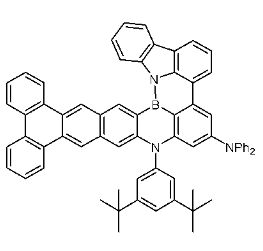
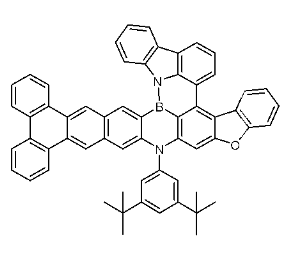
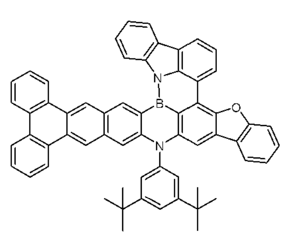
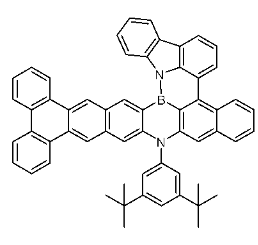

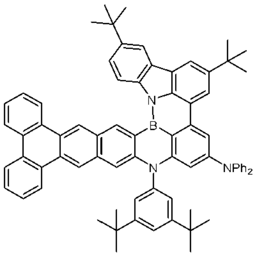 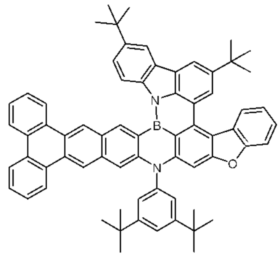 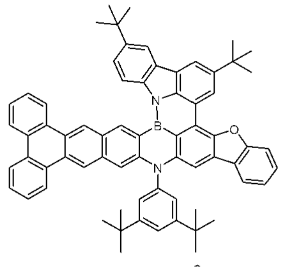 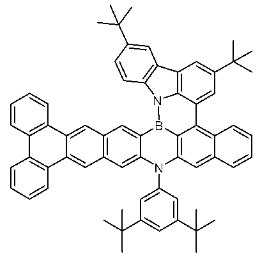

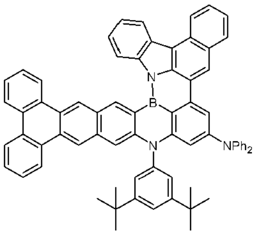 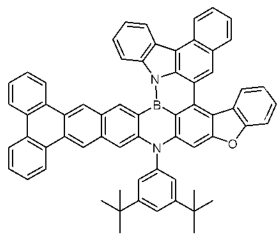 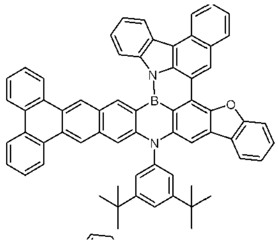 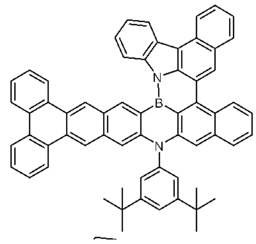

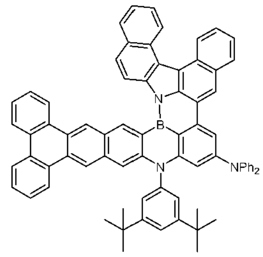 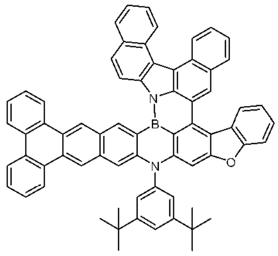 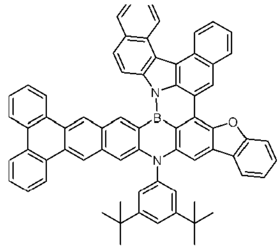 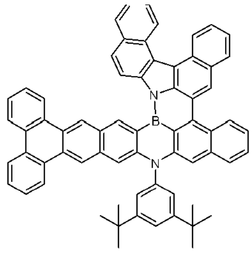

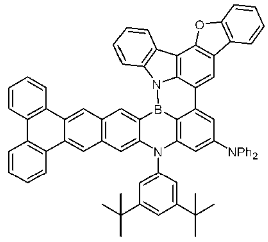 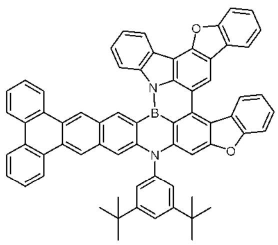 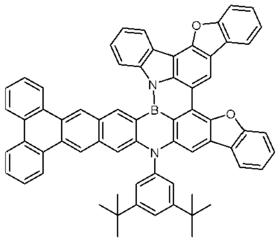 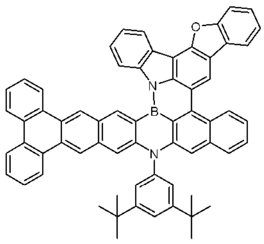

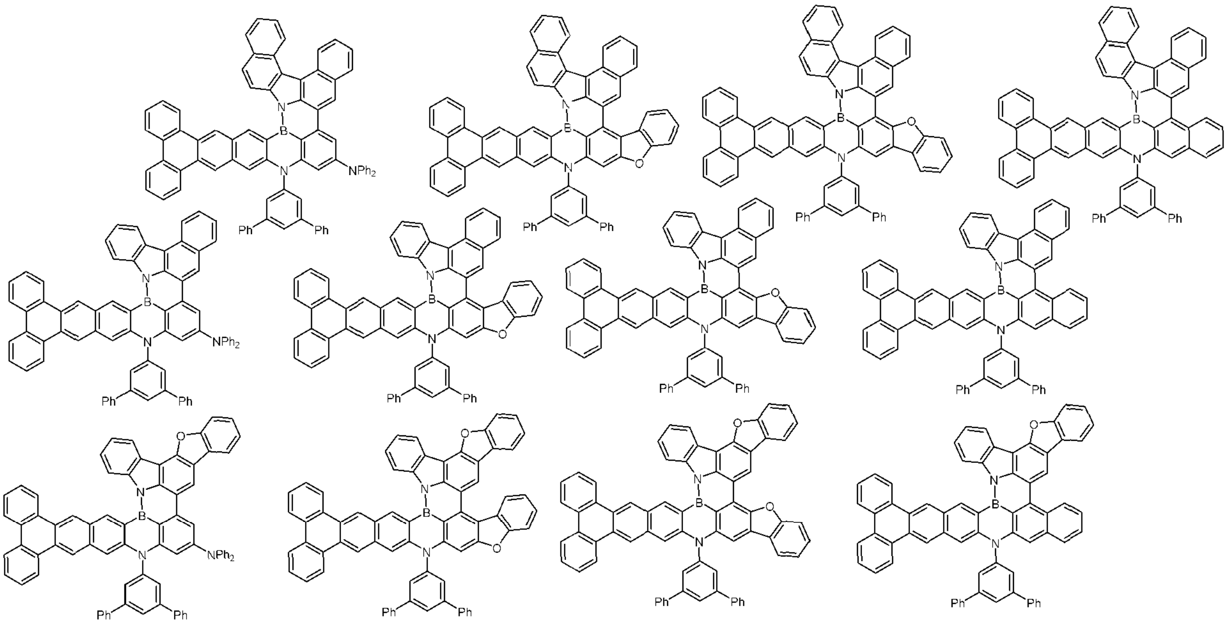

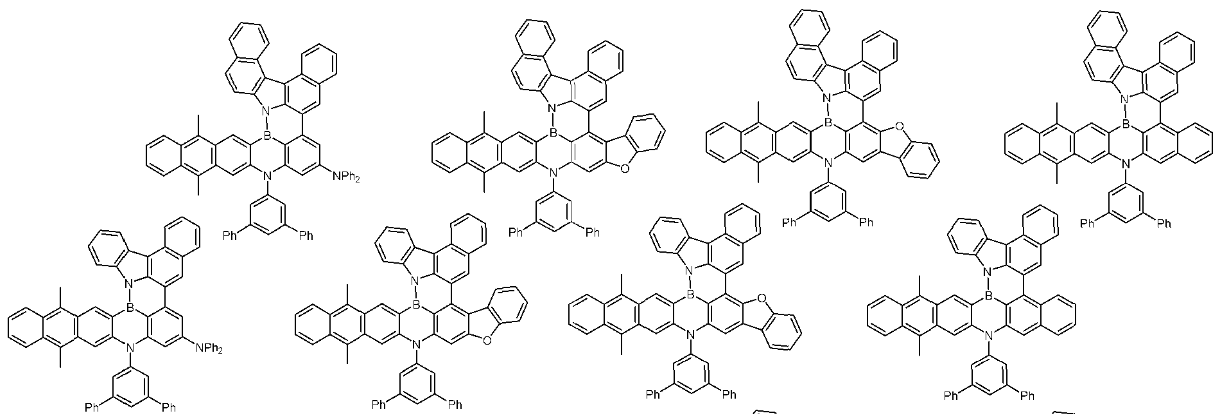

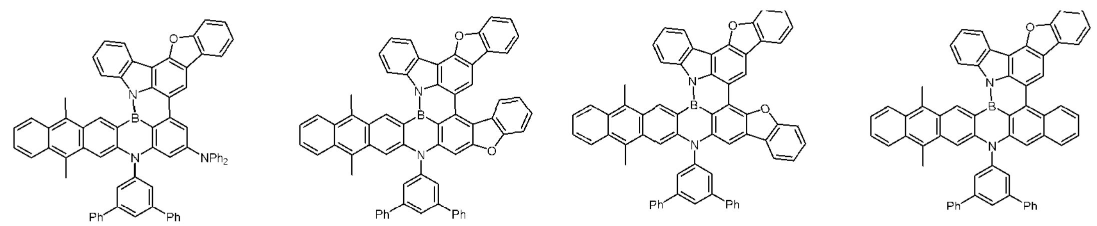

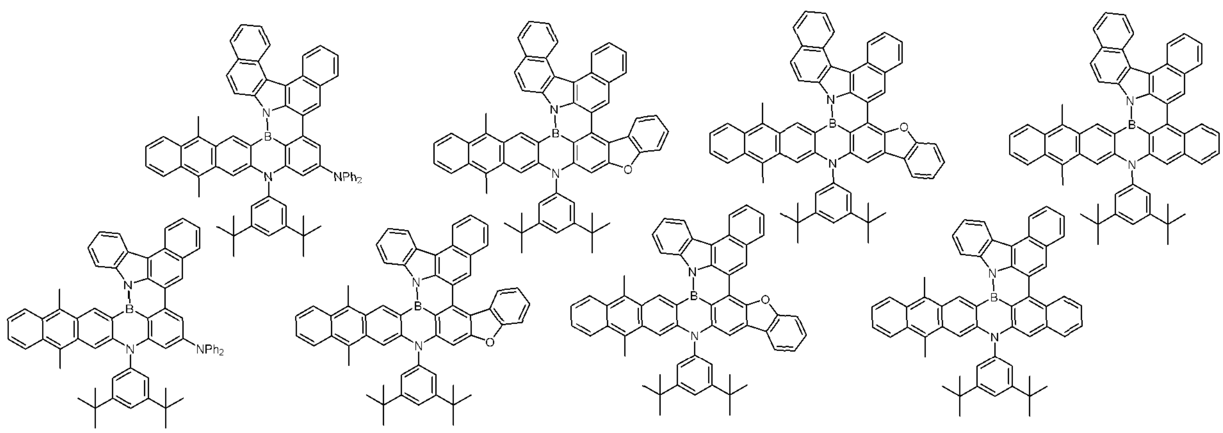

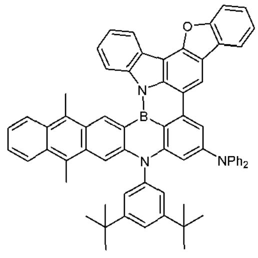 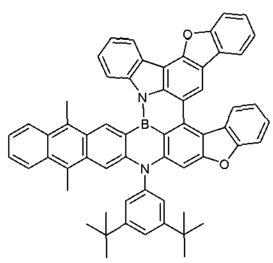 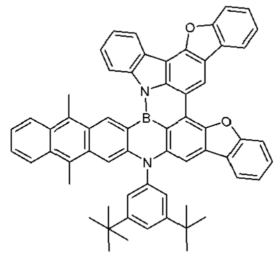 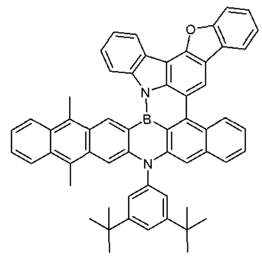

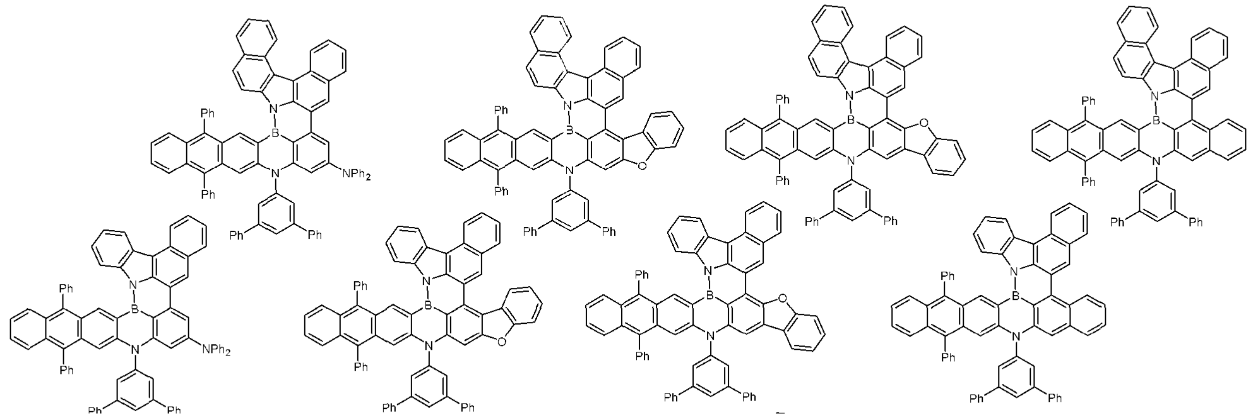

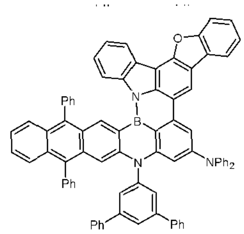 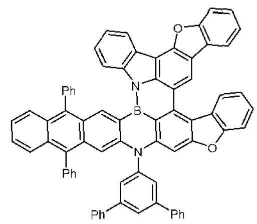 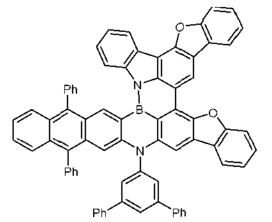 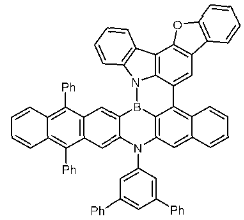

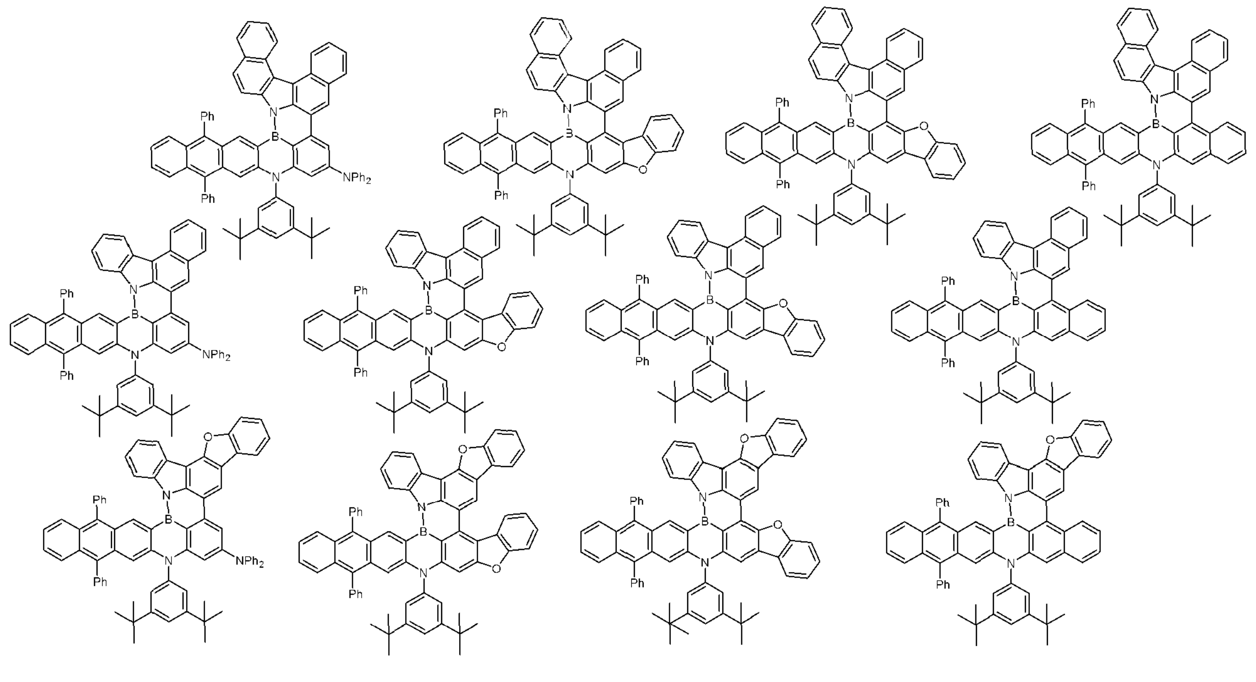

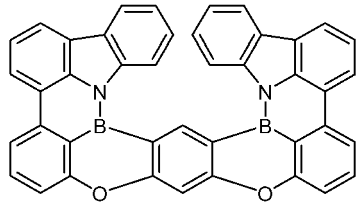

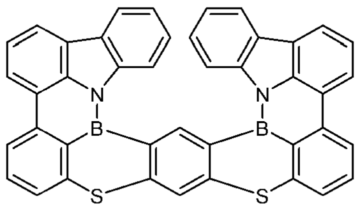

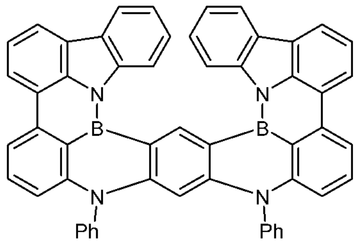

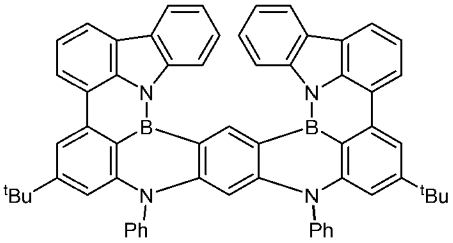

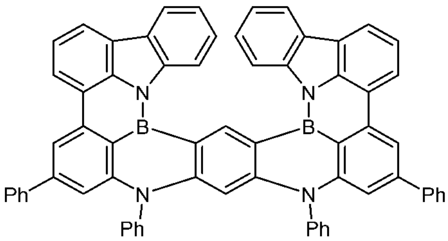

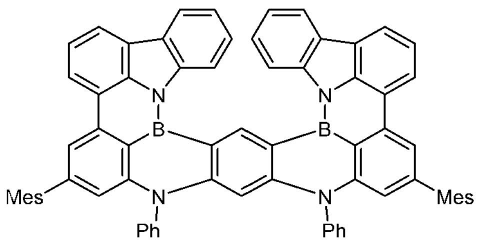

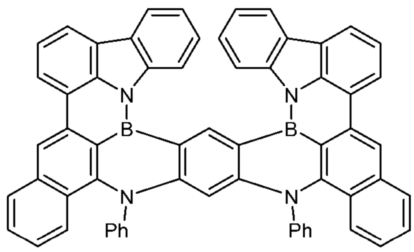

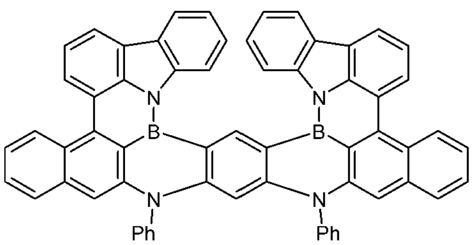

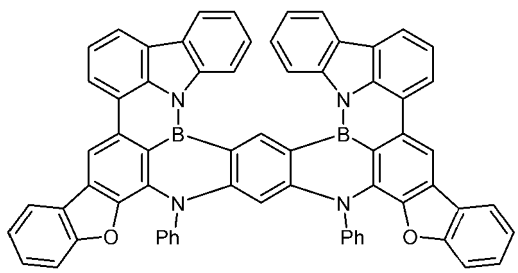

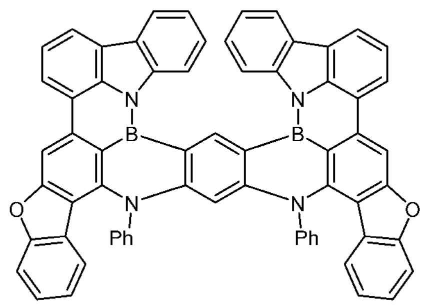

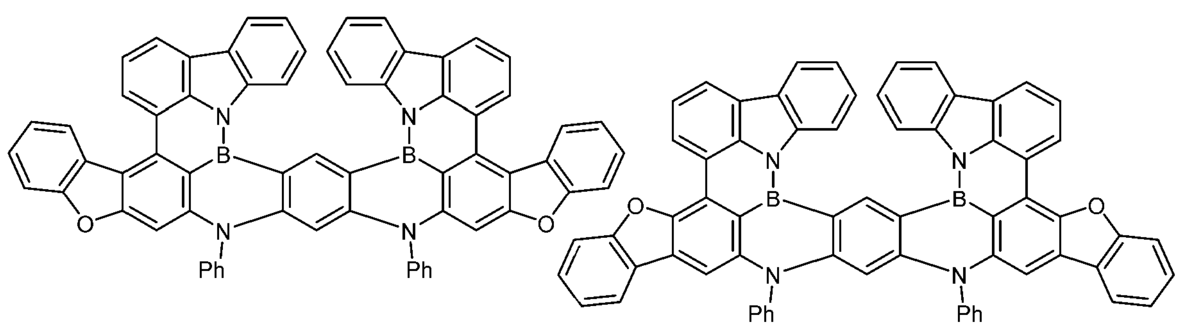

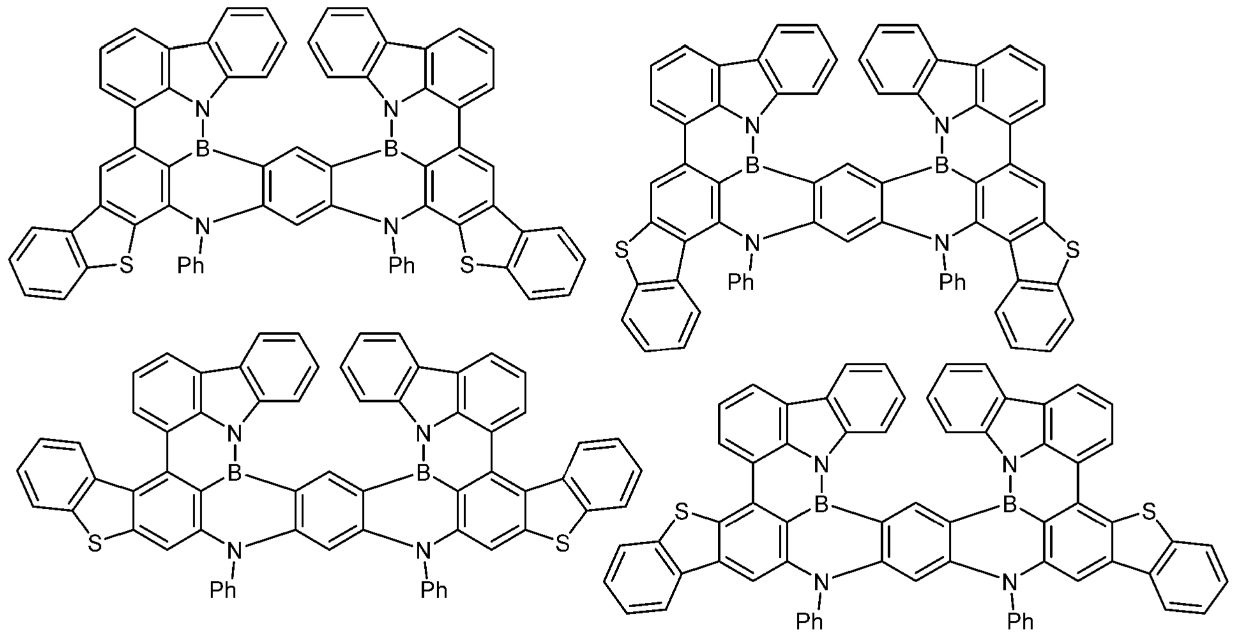

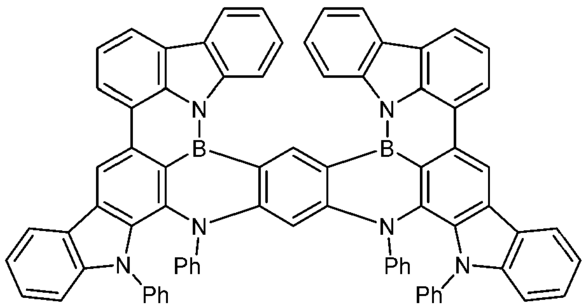

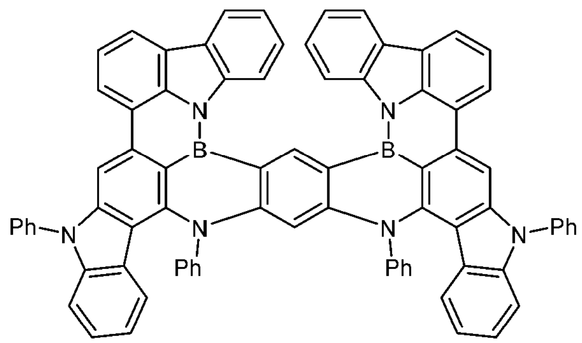

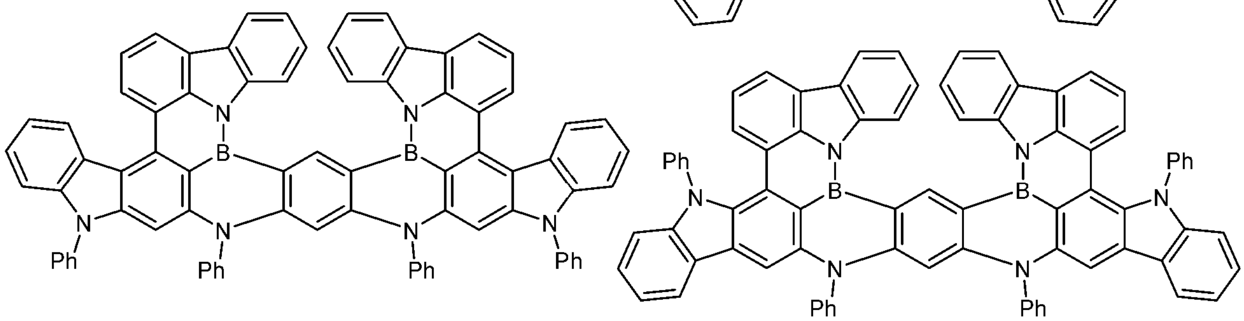

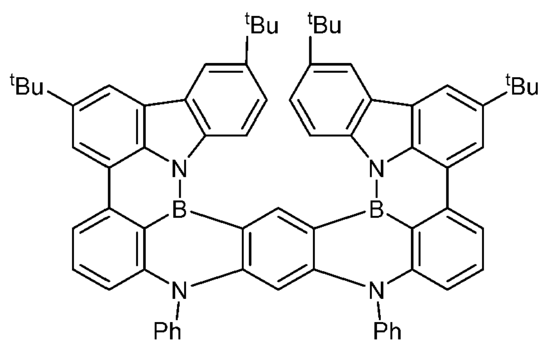

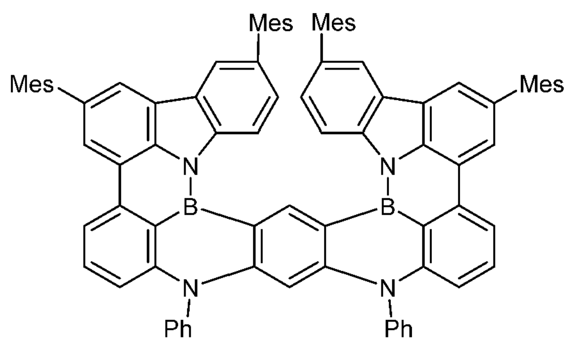

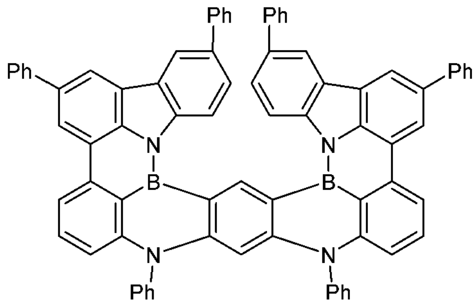

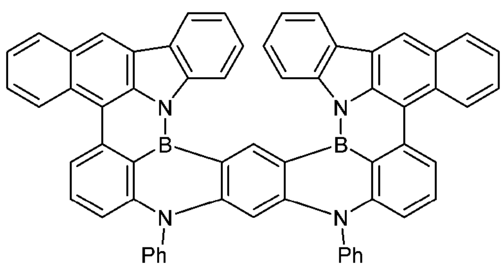

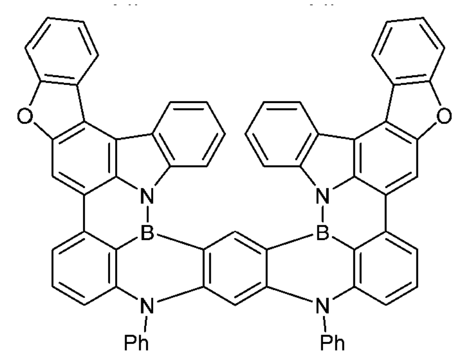

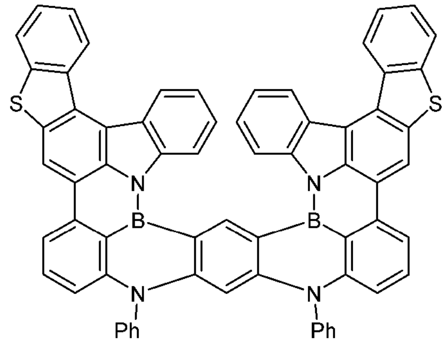

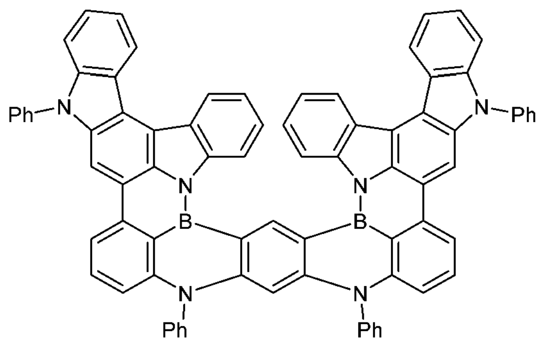

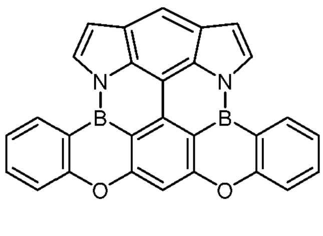

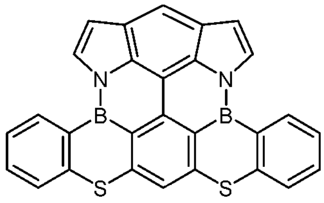

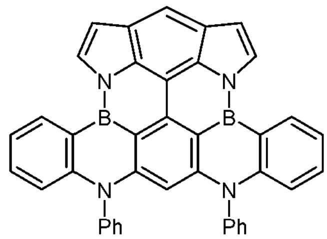

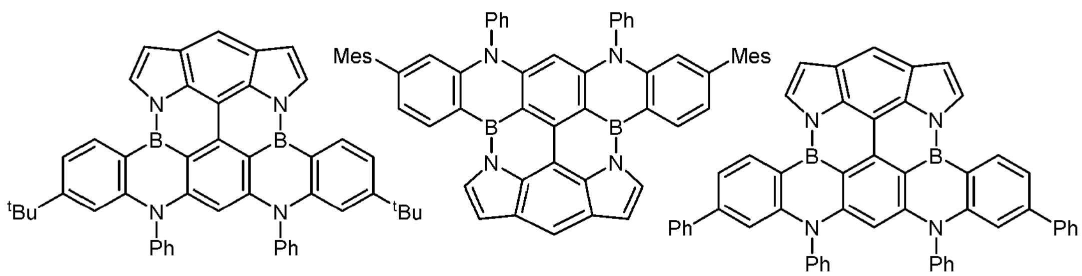

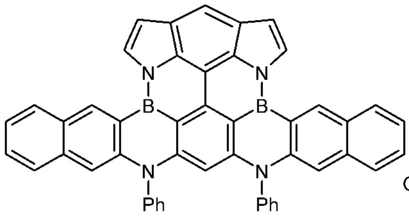
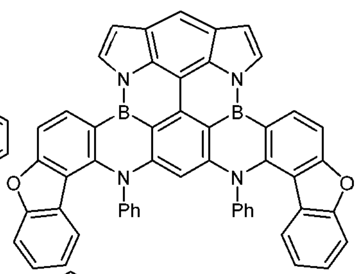
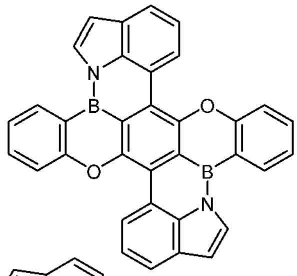

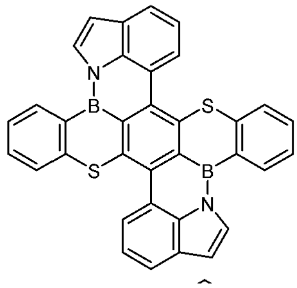
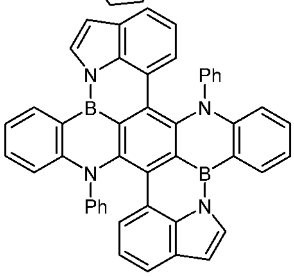
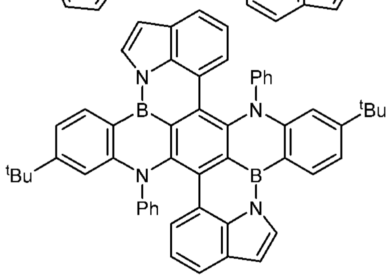

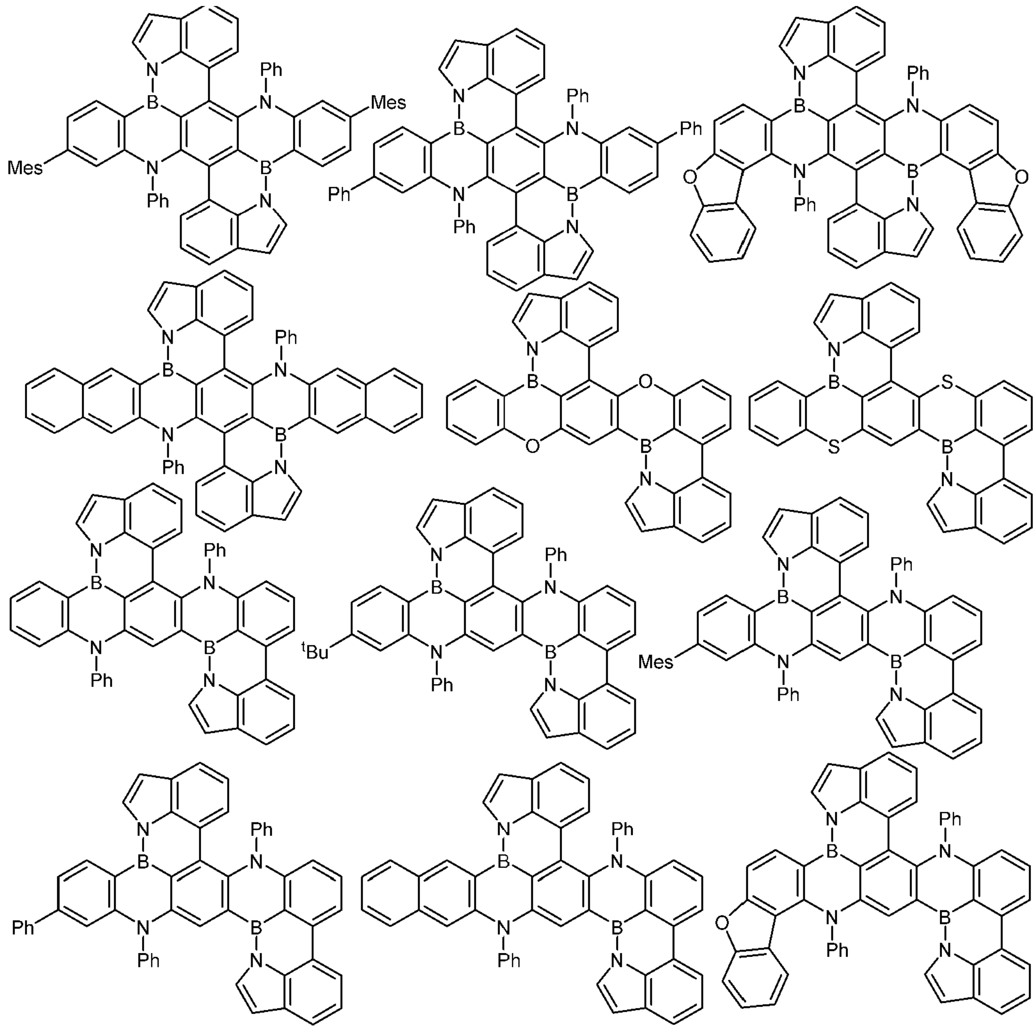

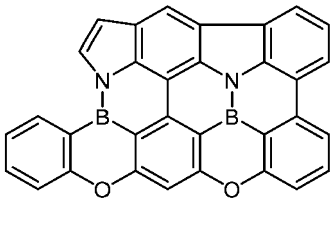

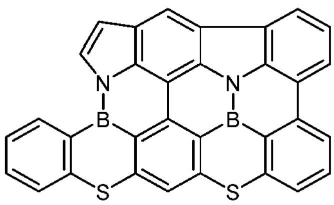

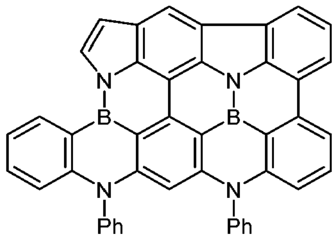

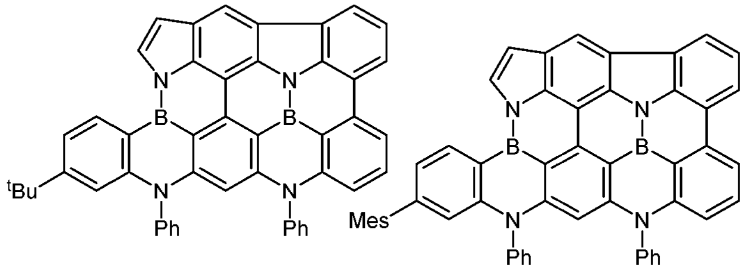

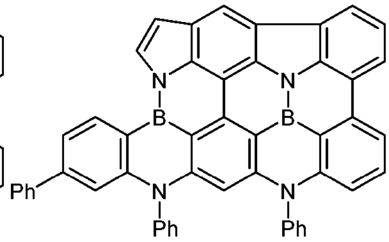

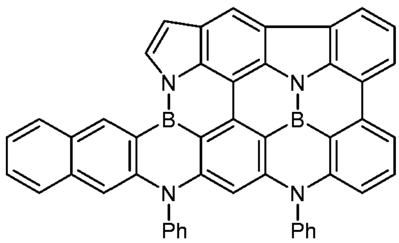

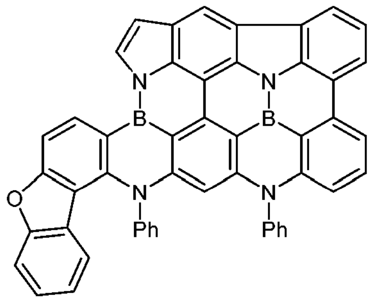

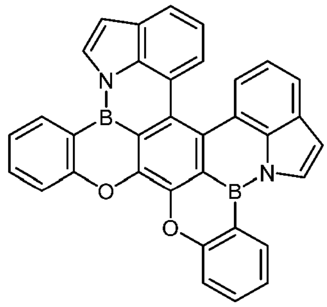

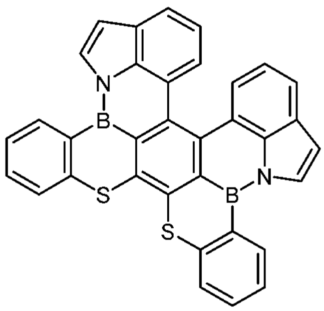

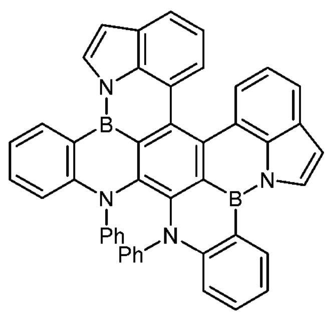

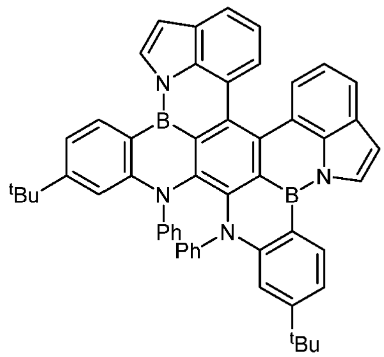

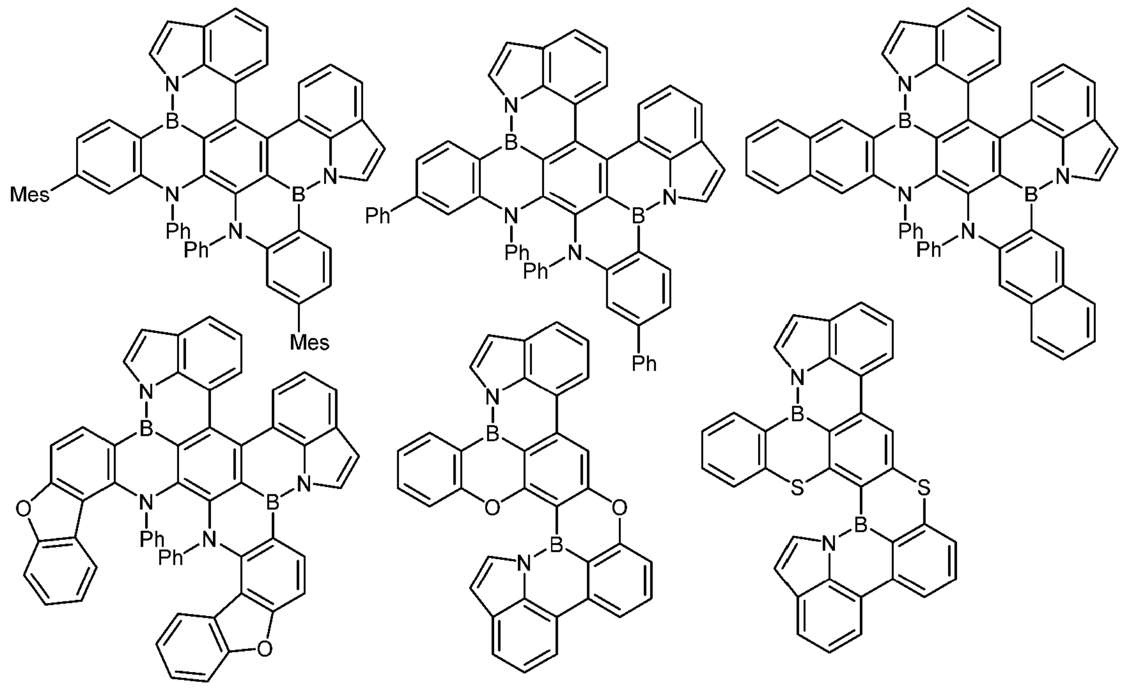

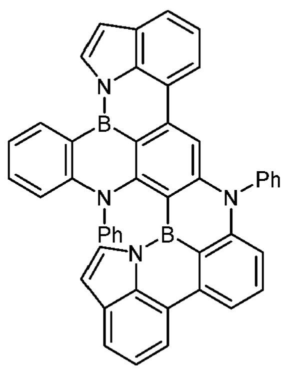

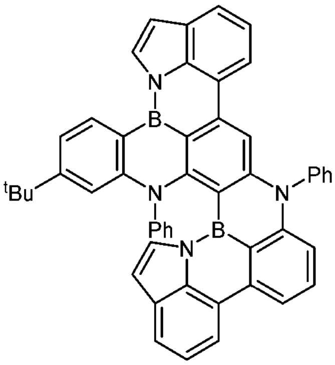

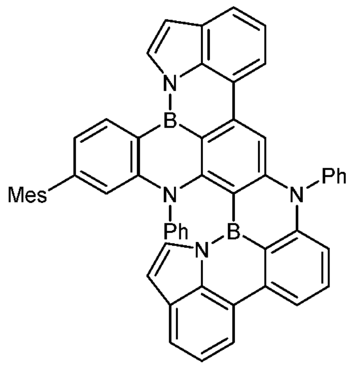

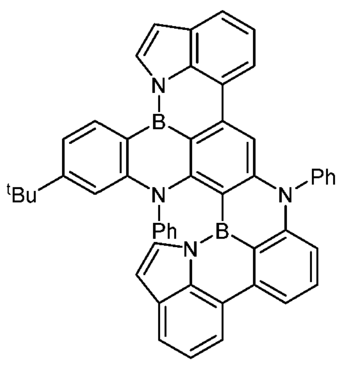

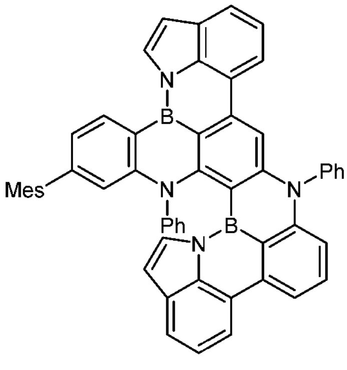

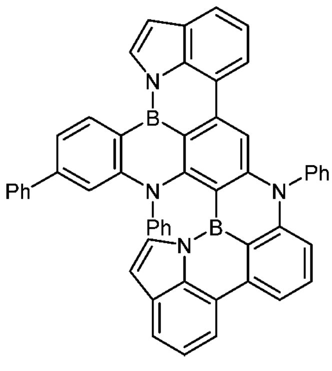

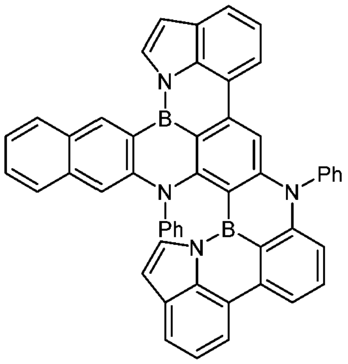
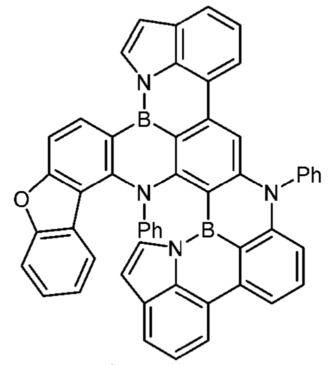
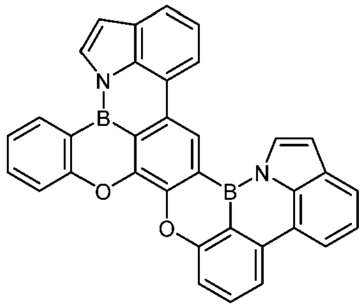

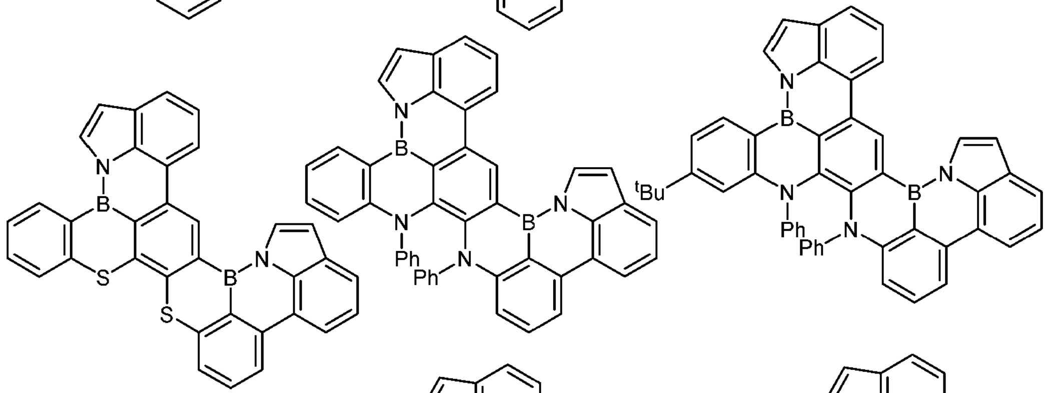

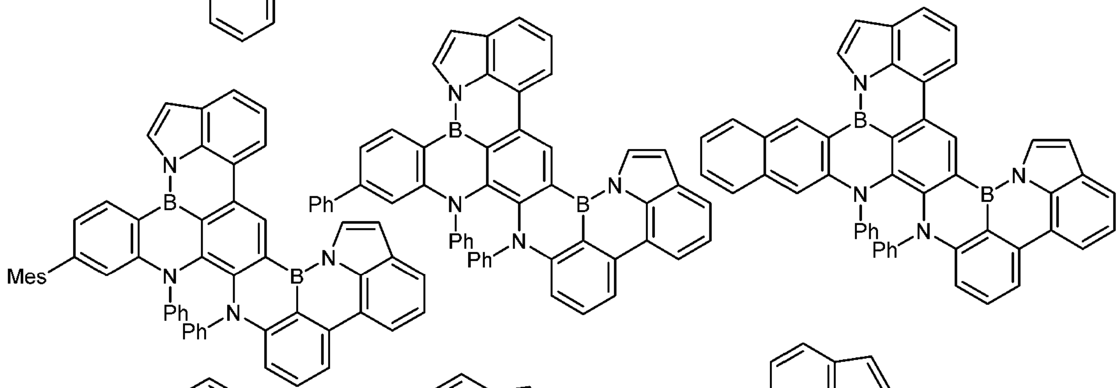

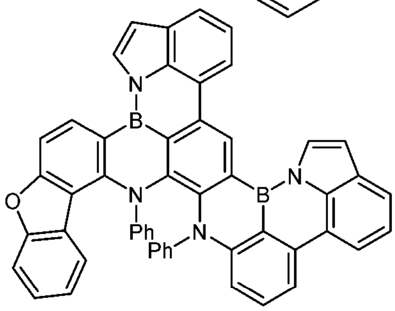
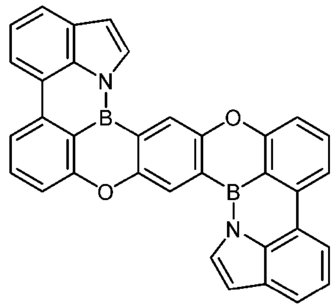
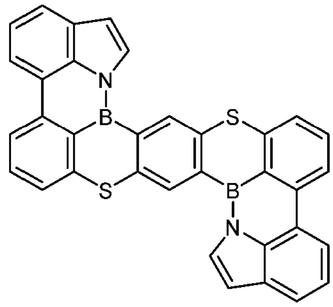

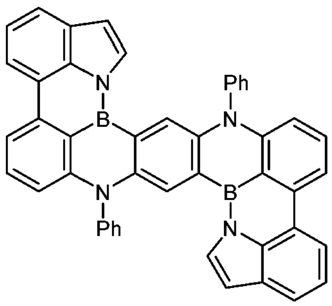
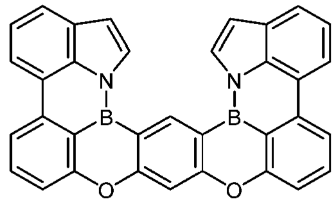
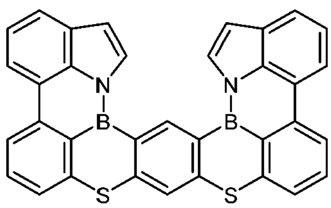

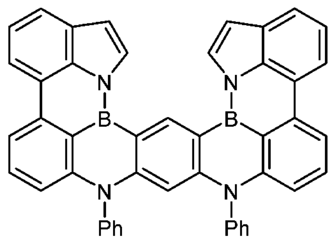
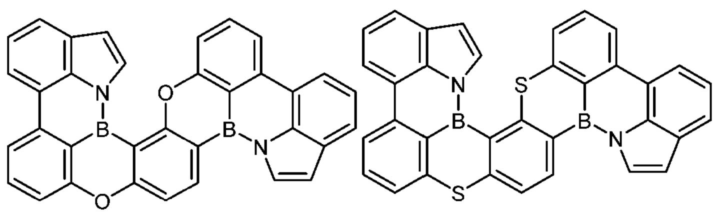

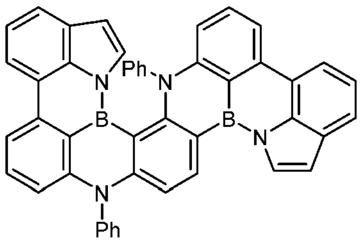
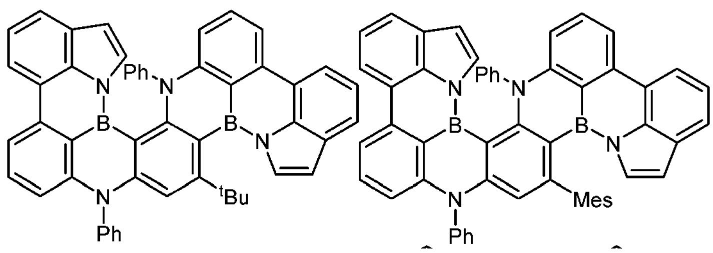

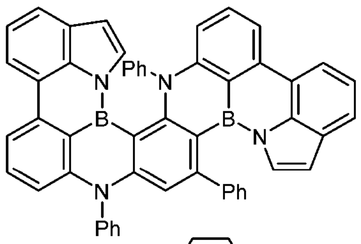
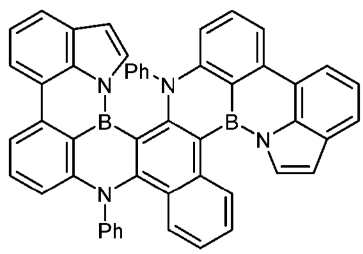
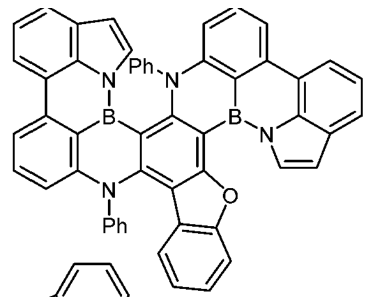

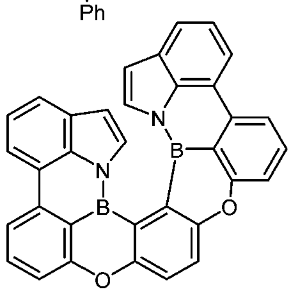
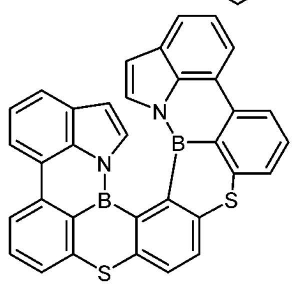
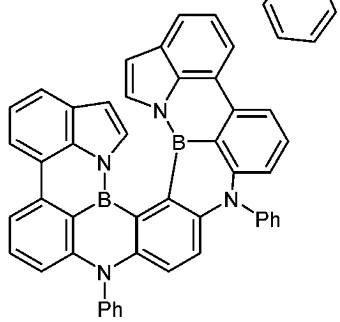

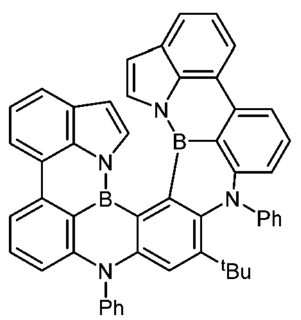
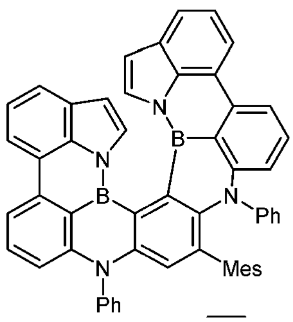
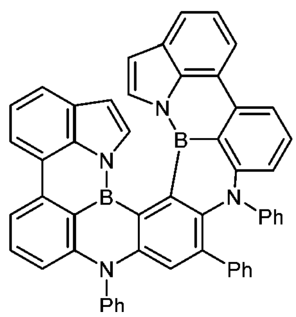

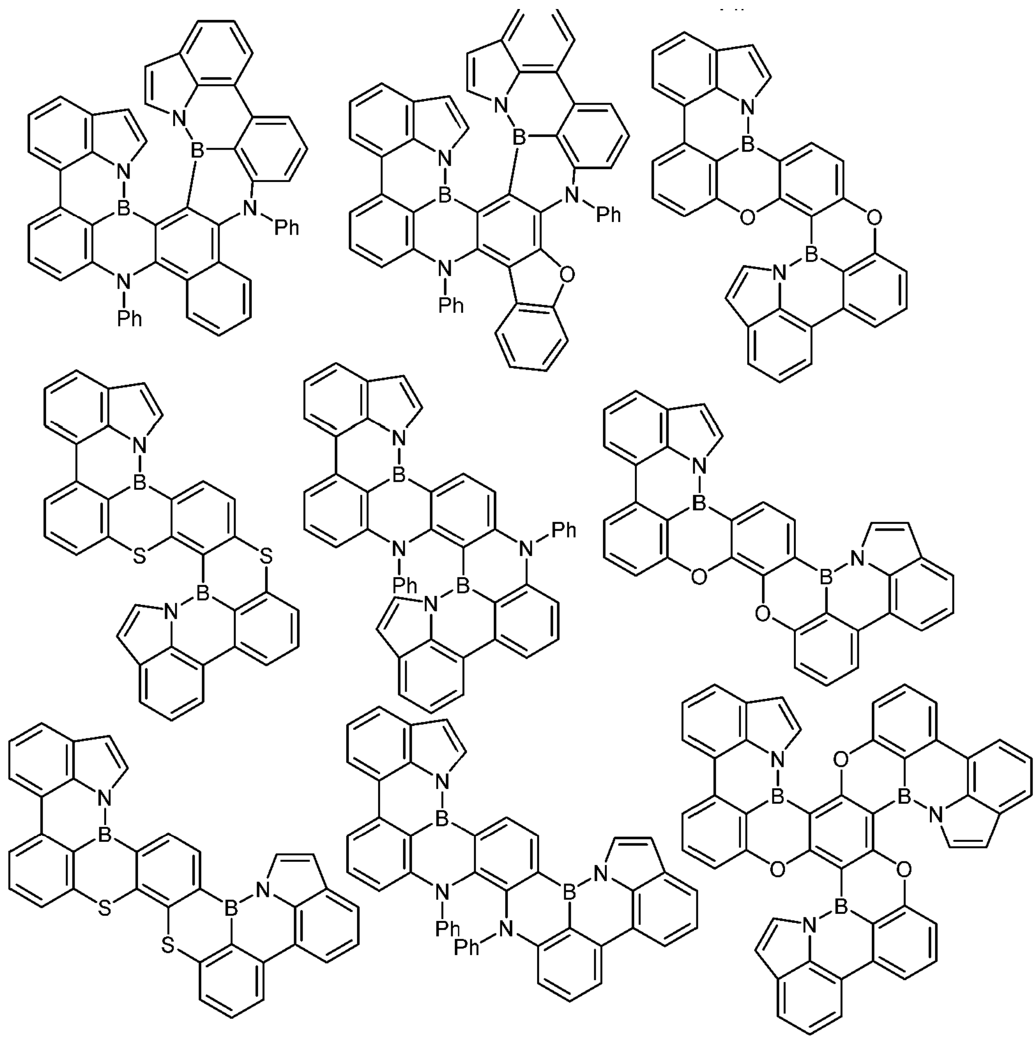

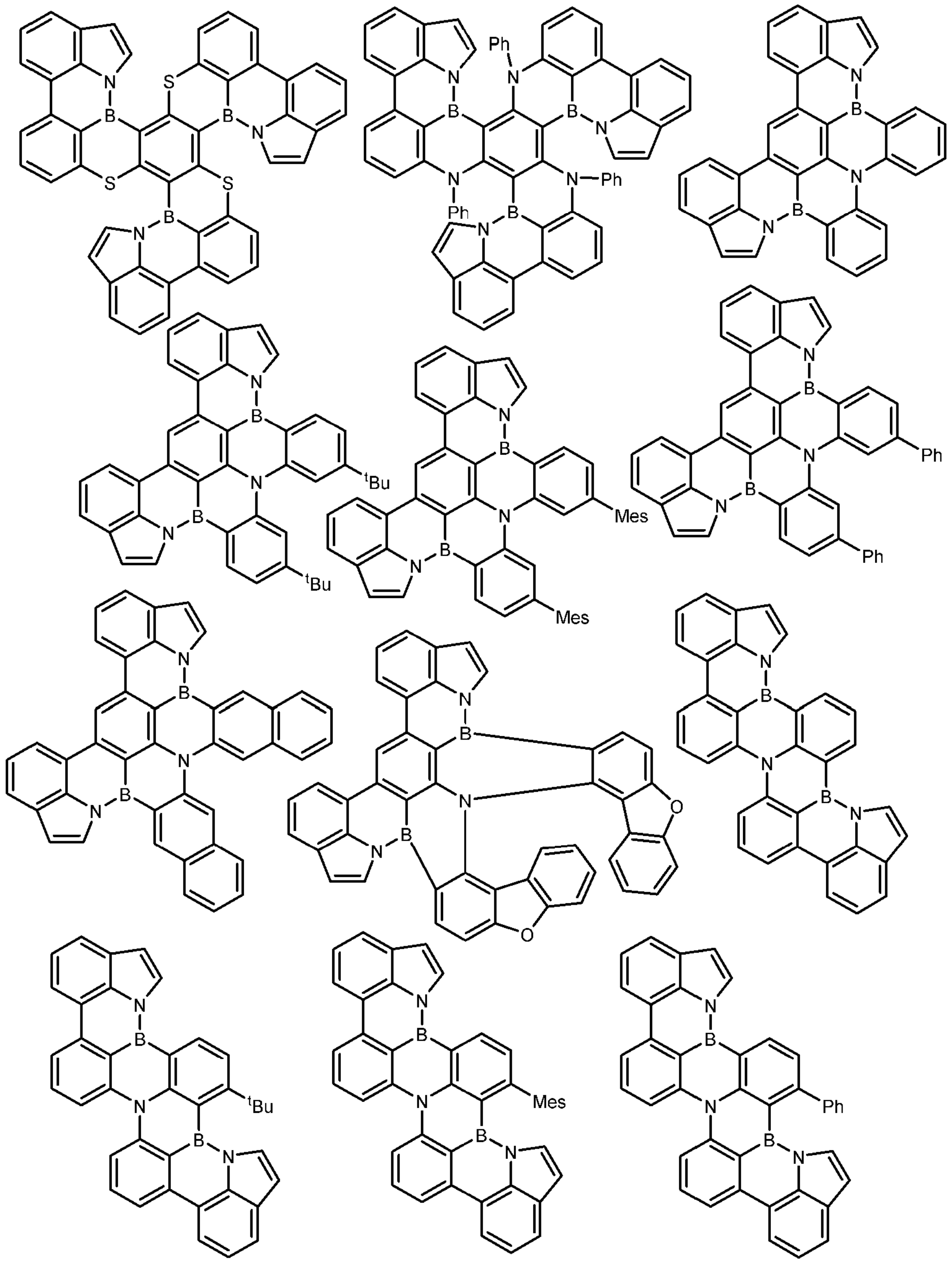

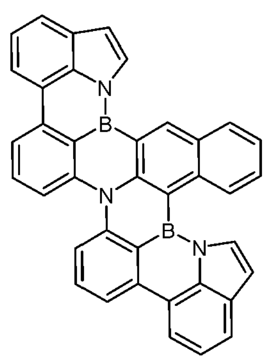

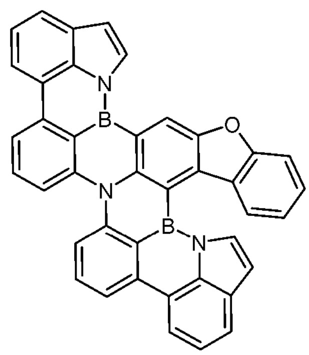

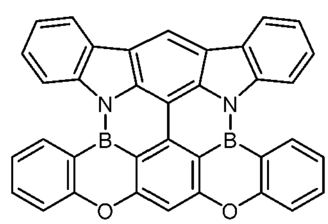

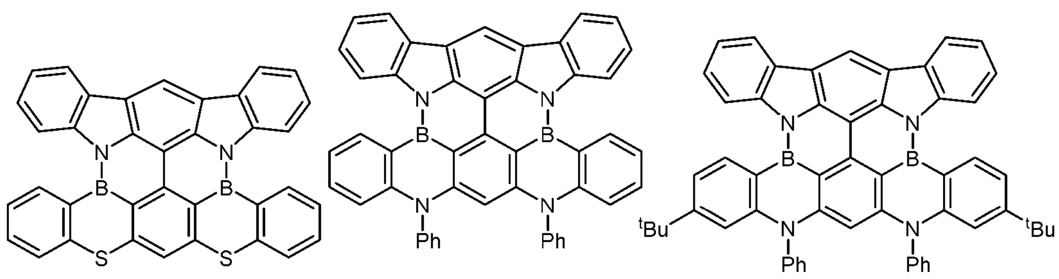

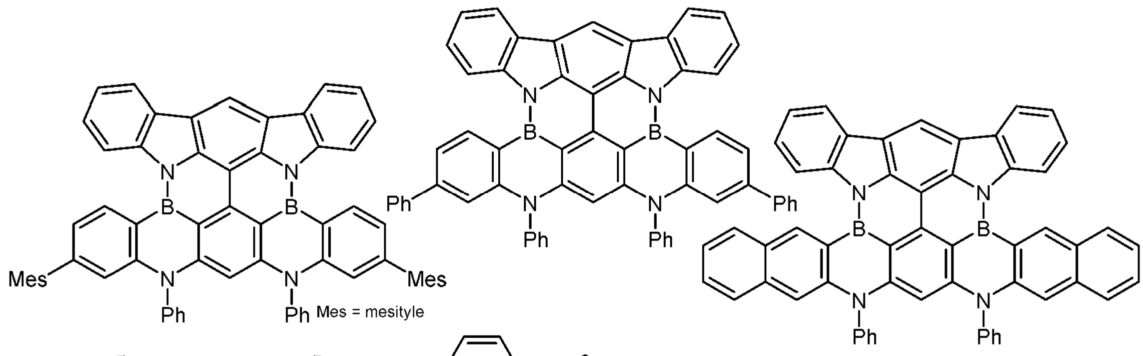

Mes = mesityle

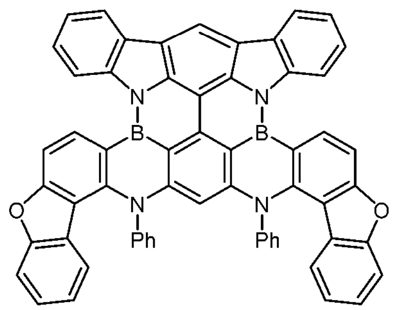

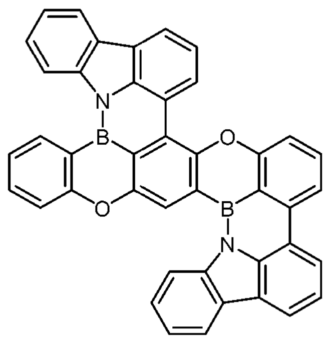

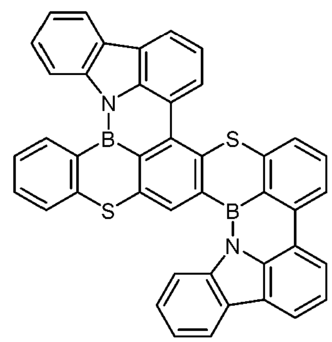

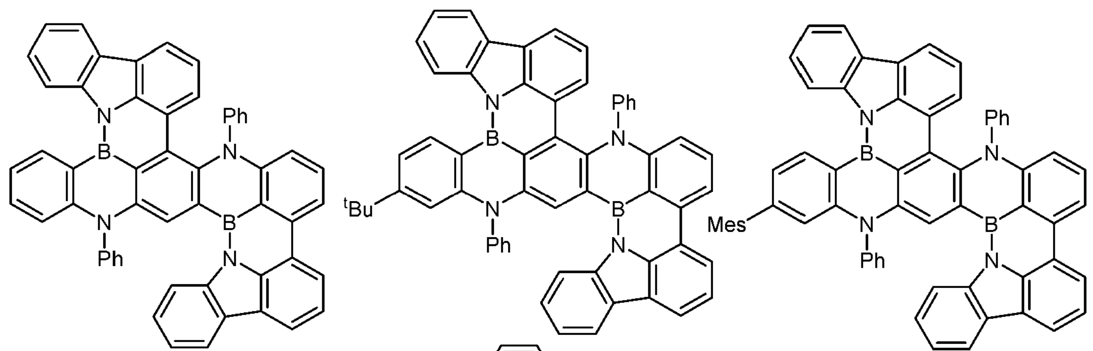

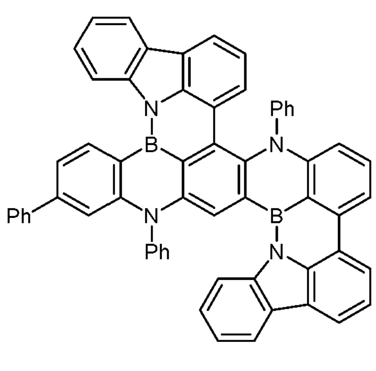

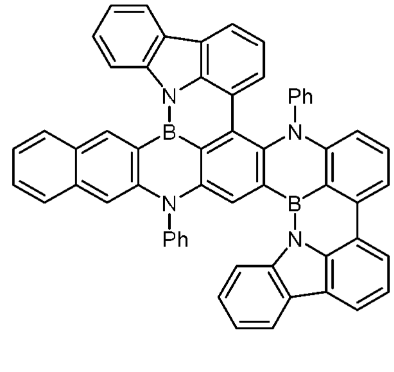

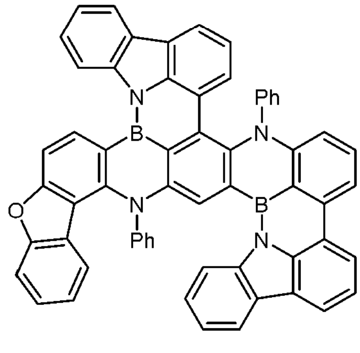

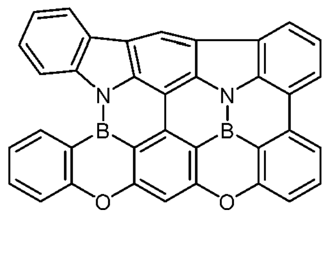
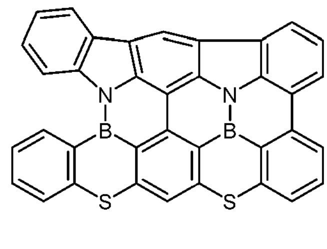
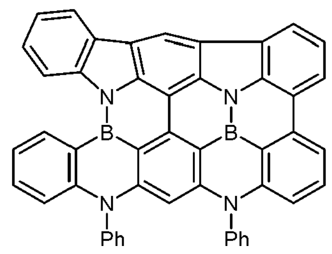

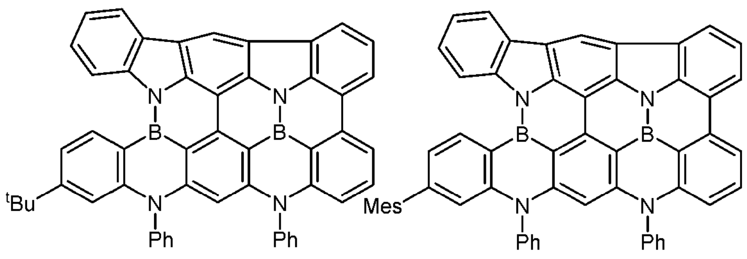
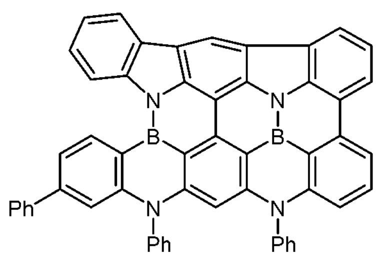

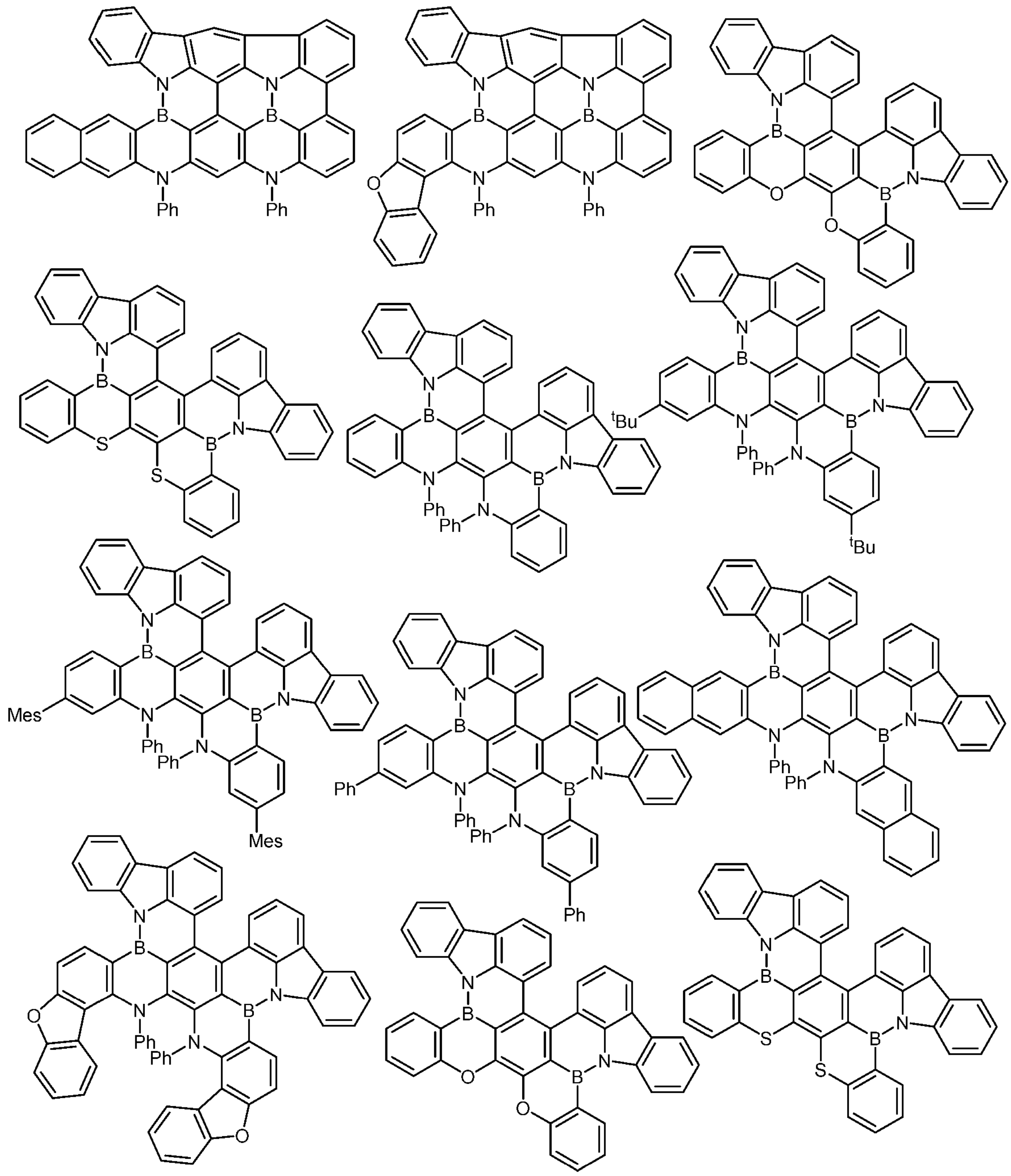

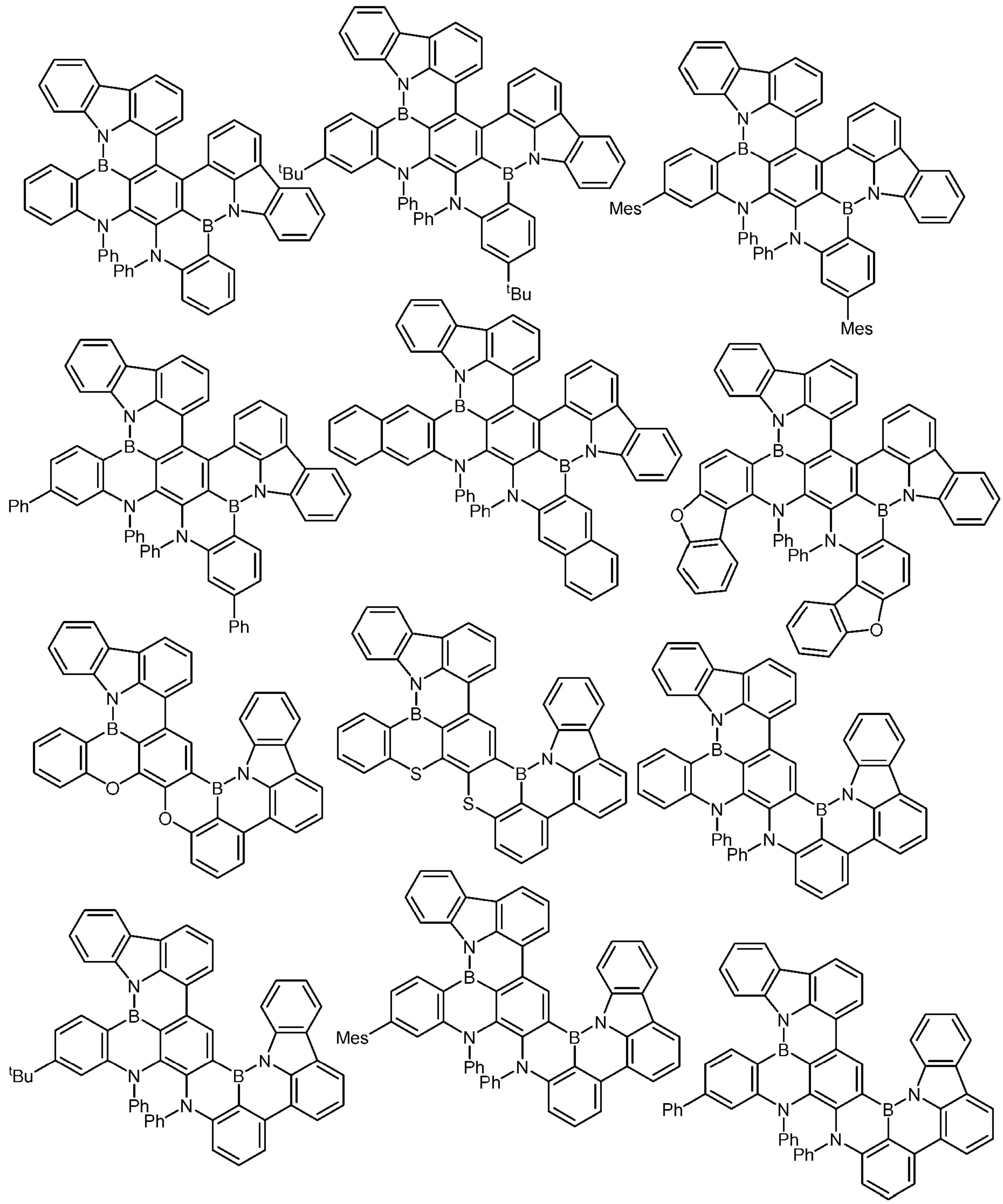

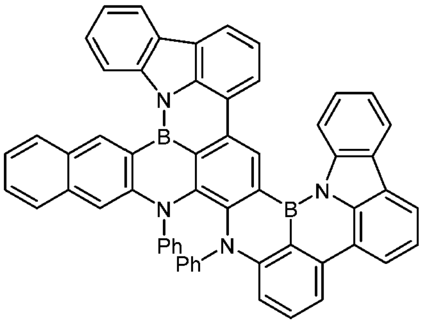

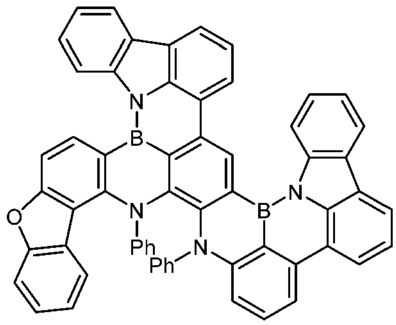

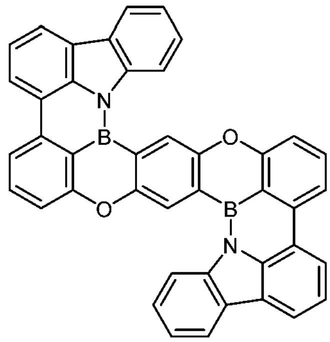

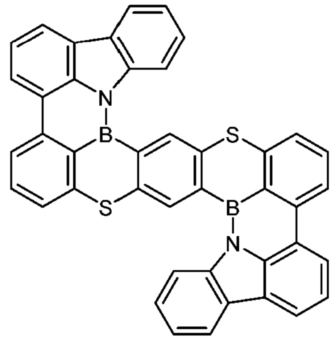

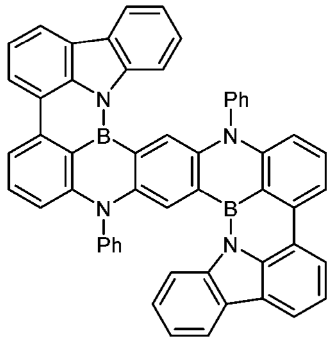

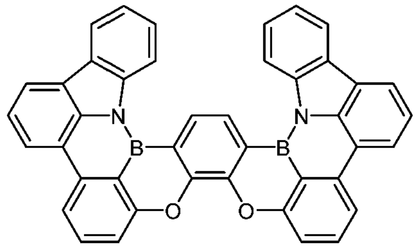

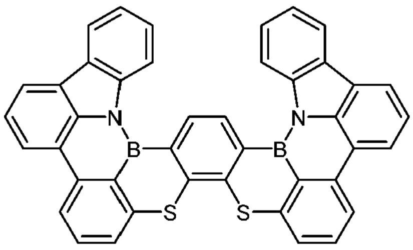

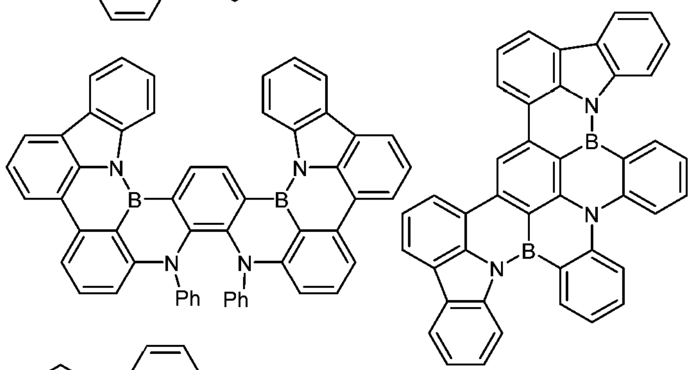

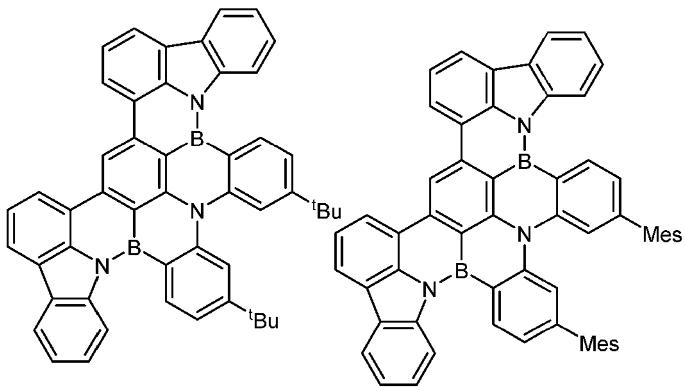

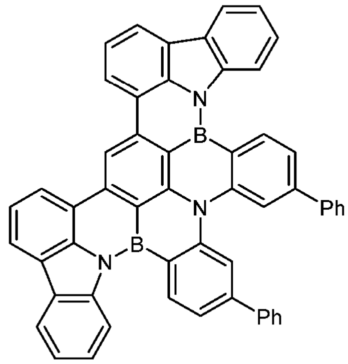

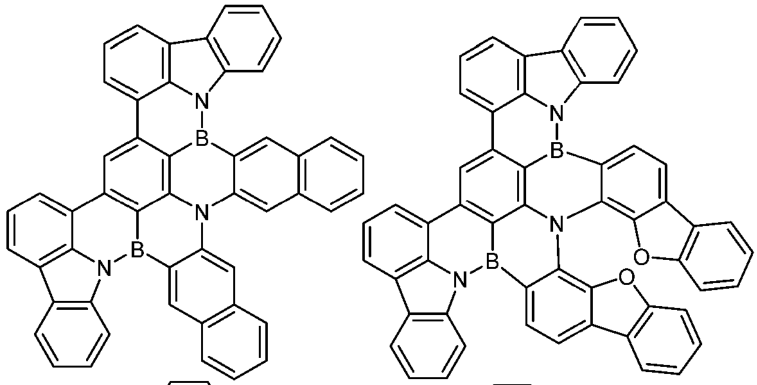

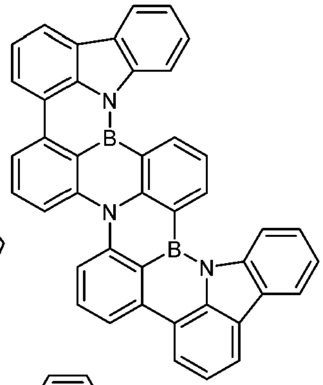

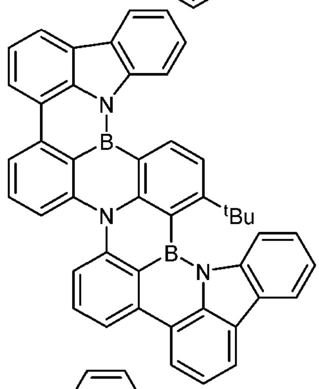

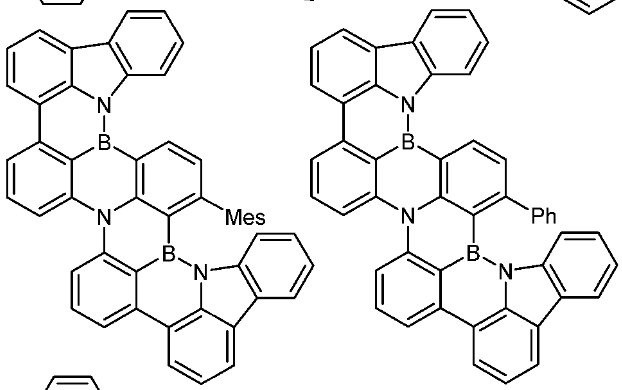

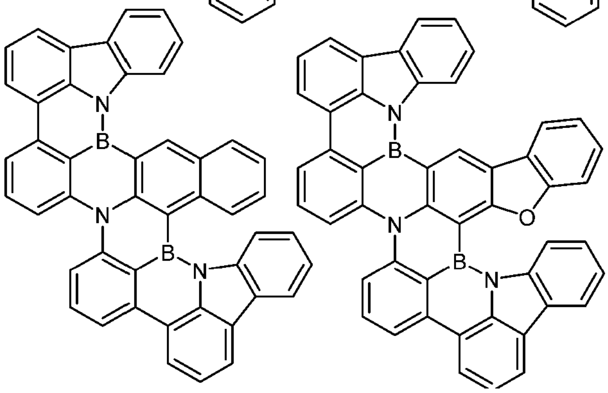

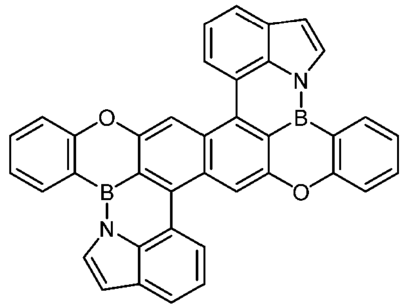

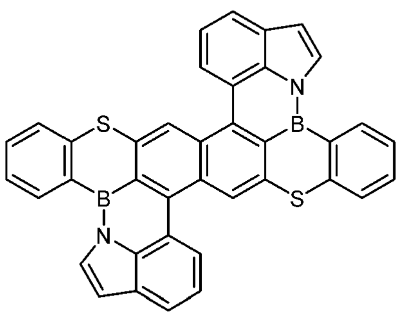

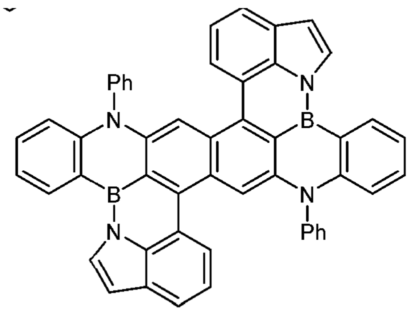

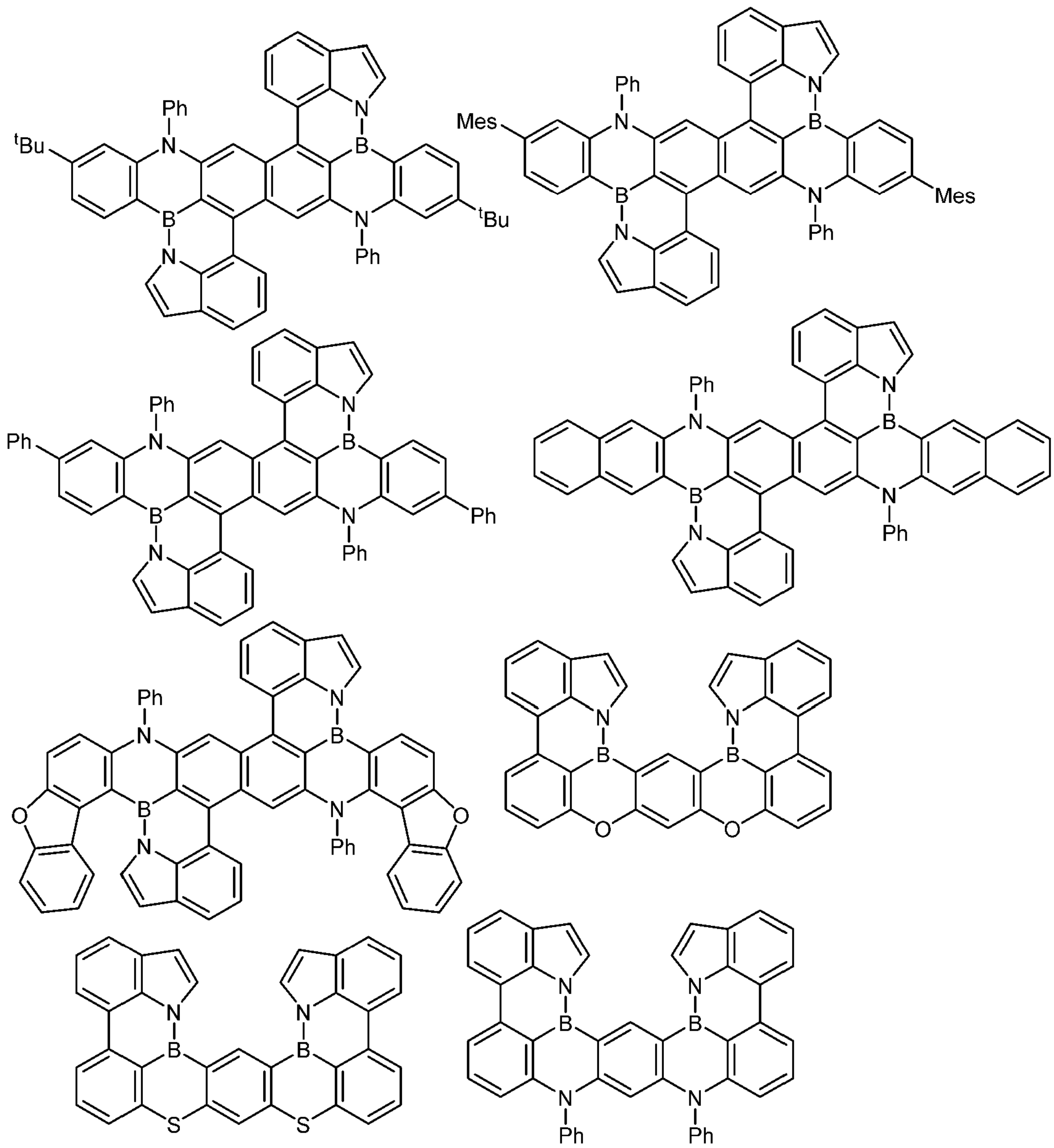

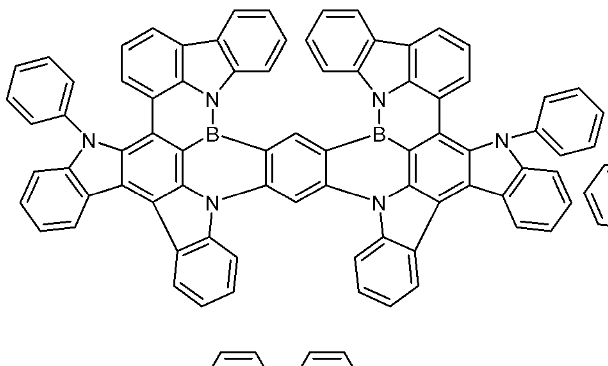

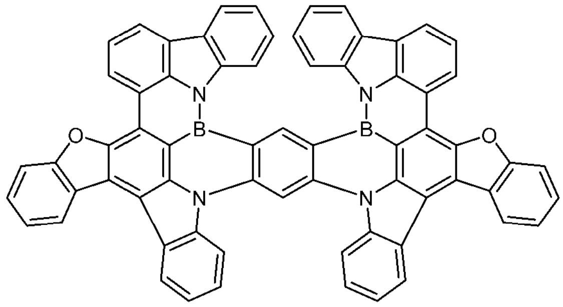

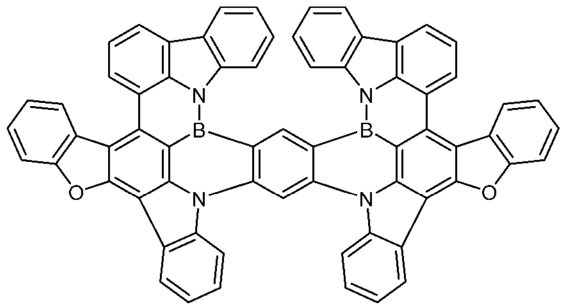

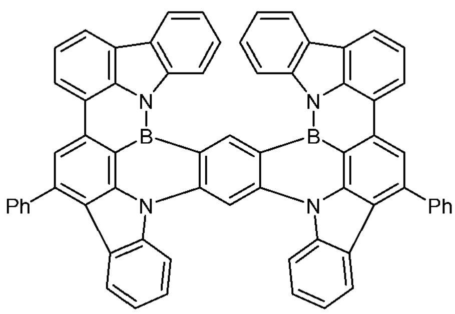

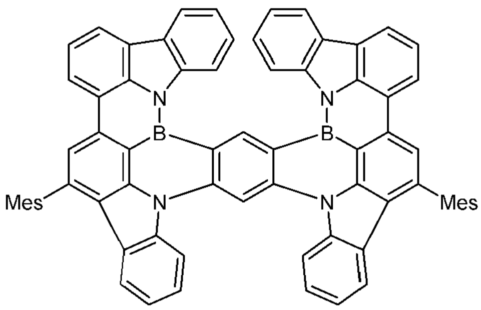

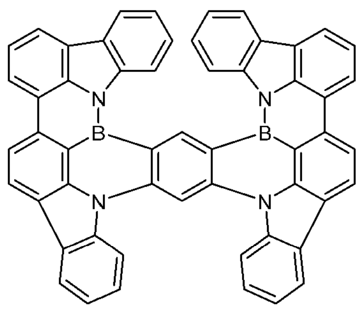

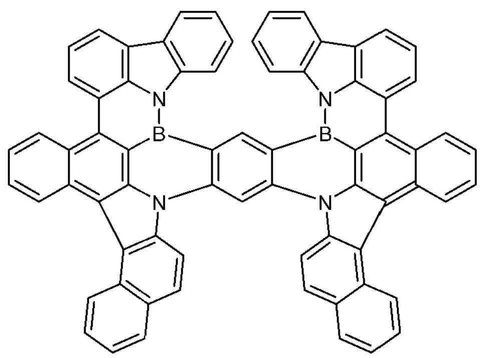

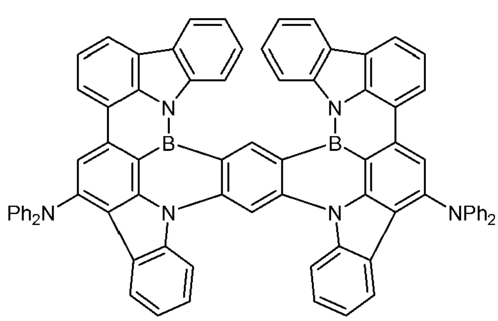

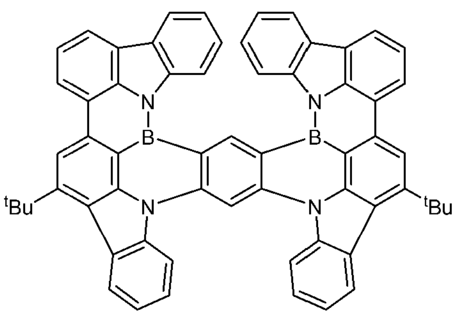

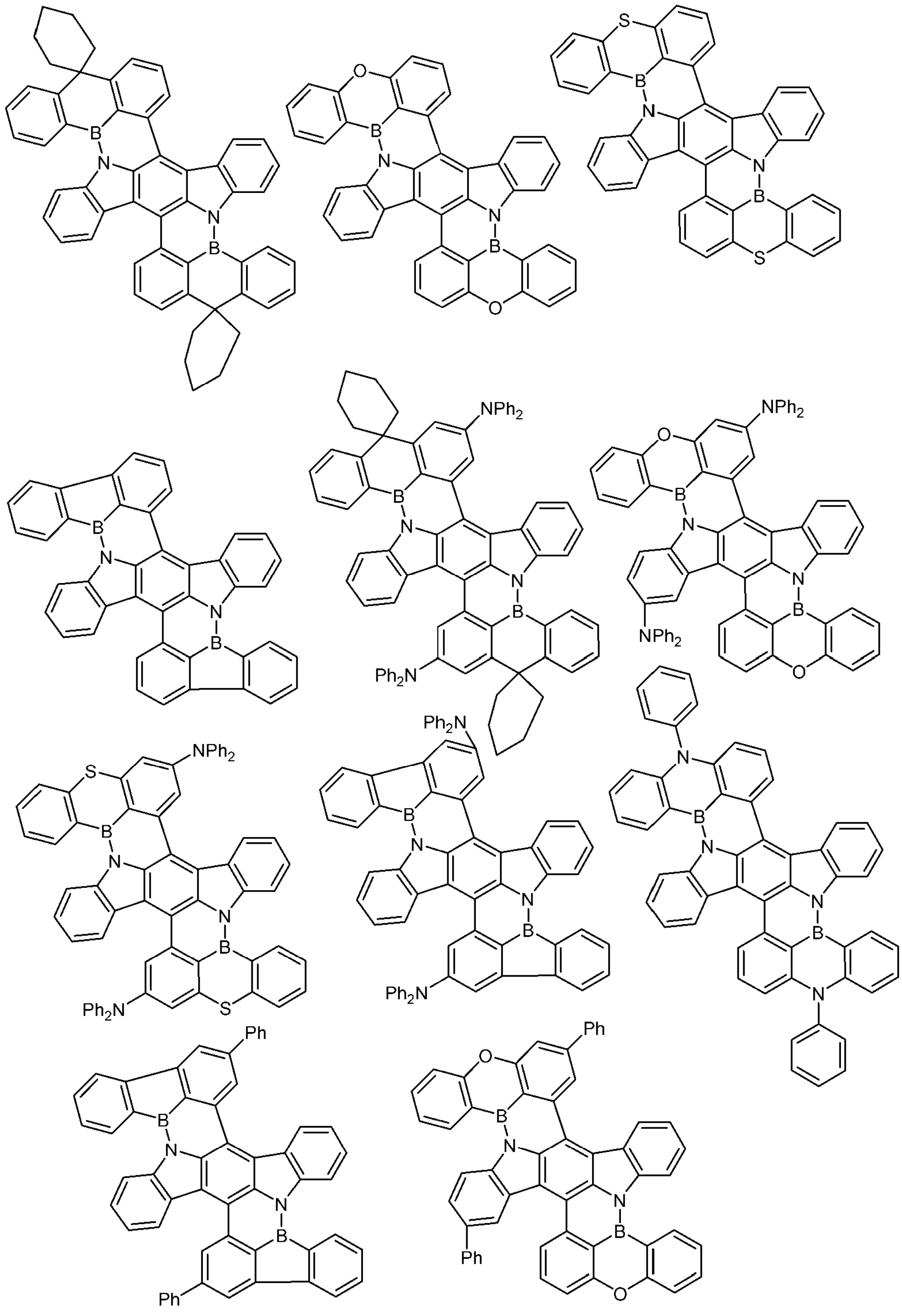

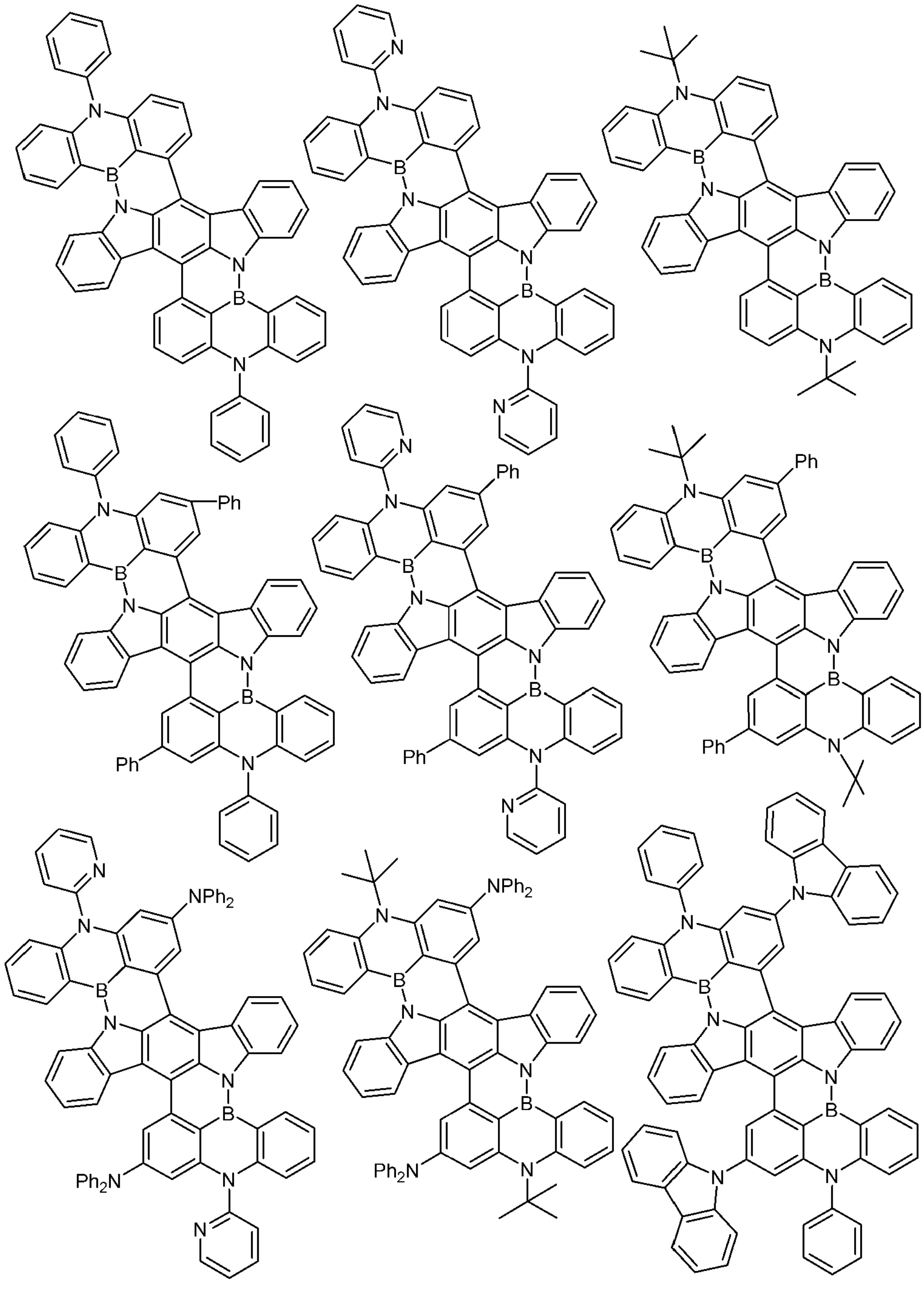

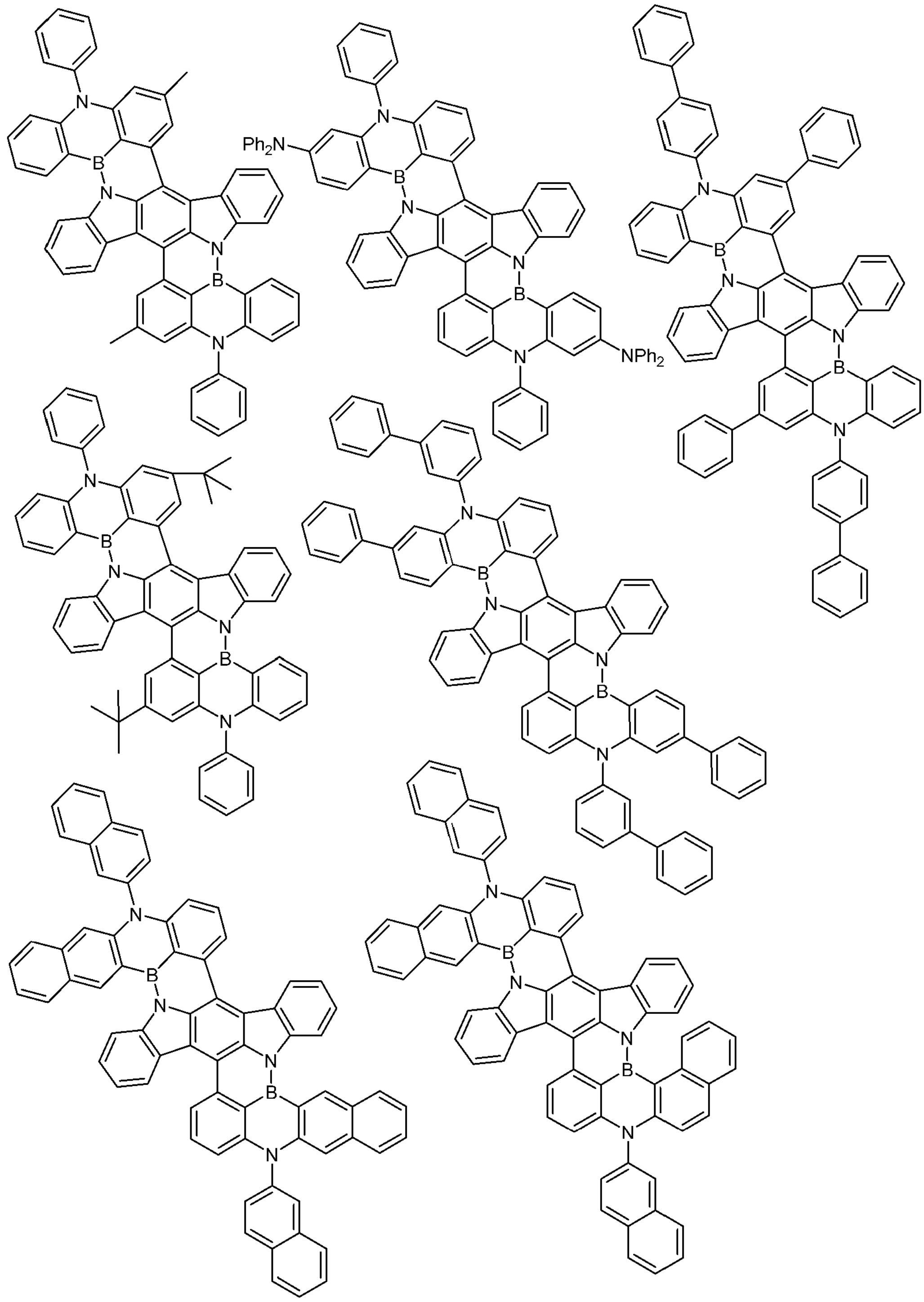

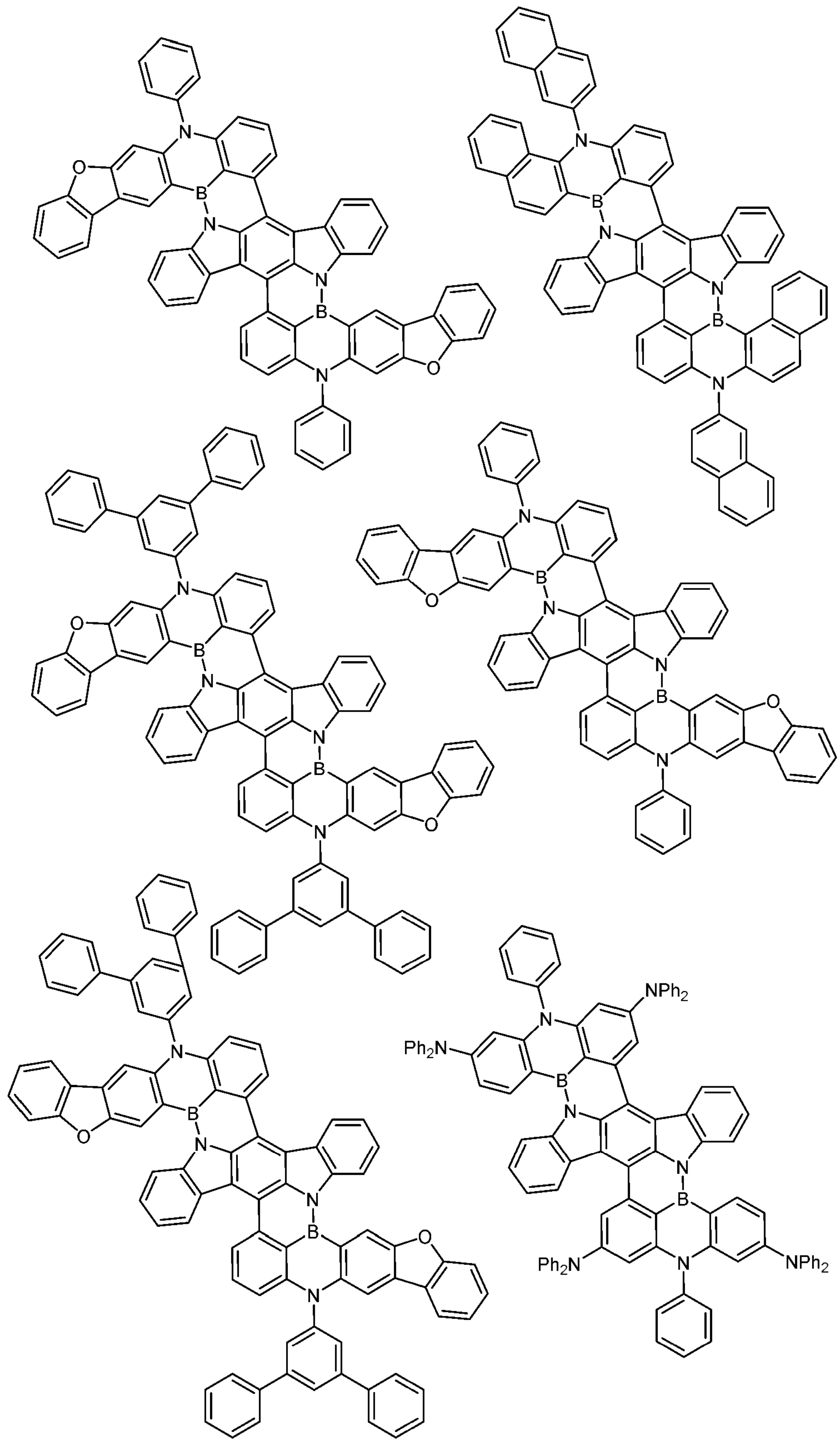

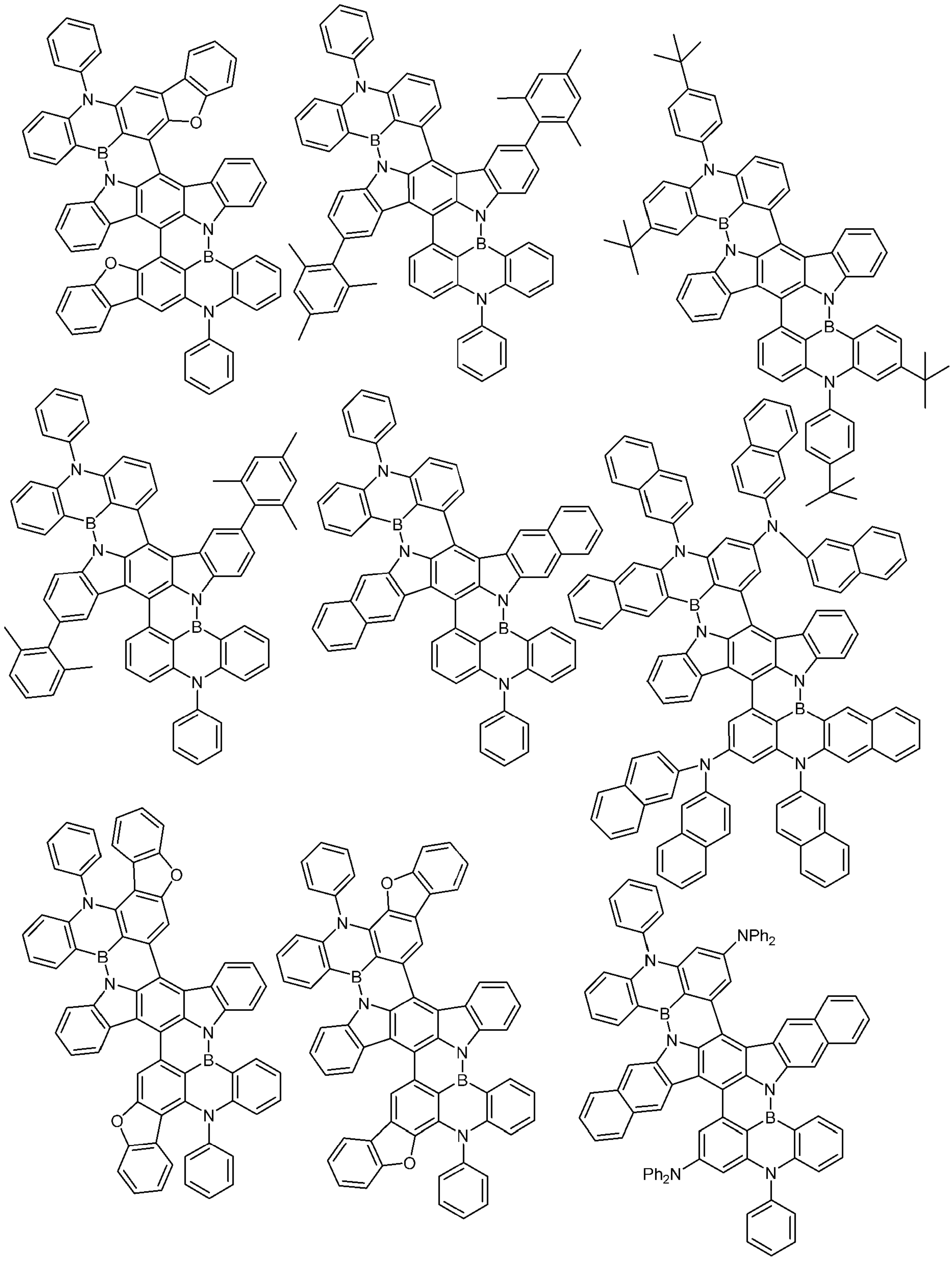

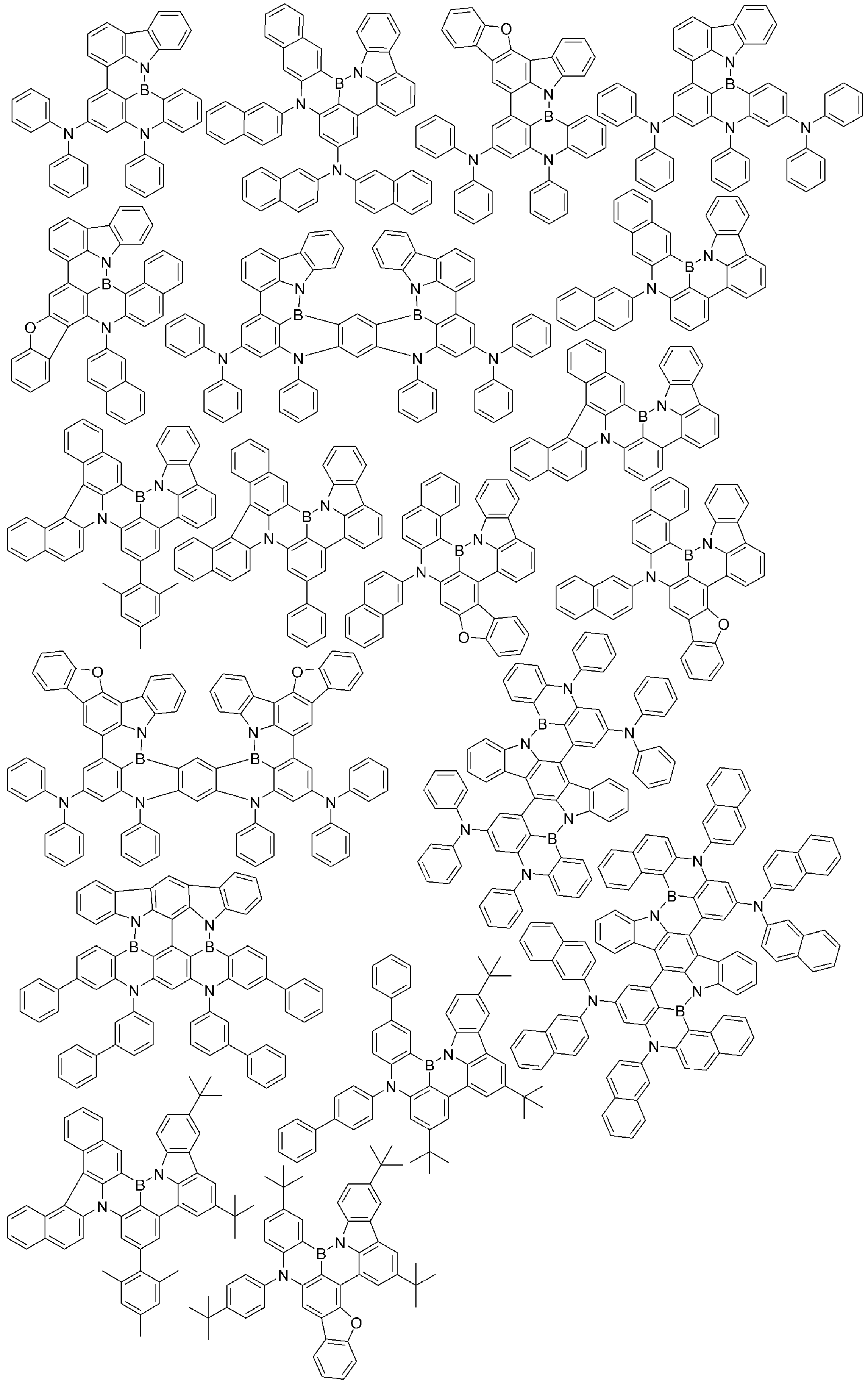

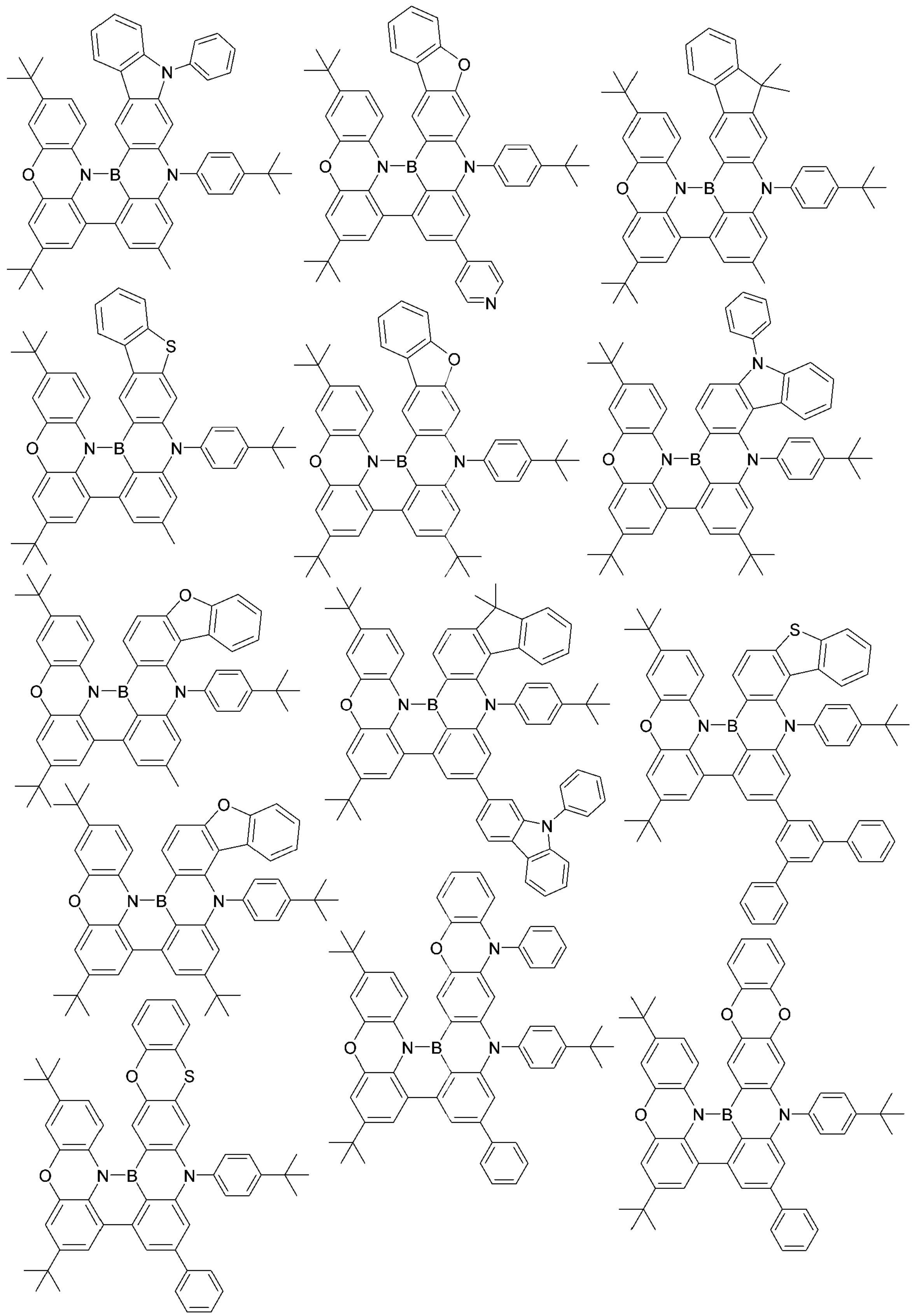

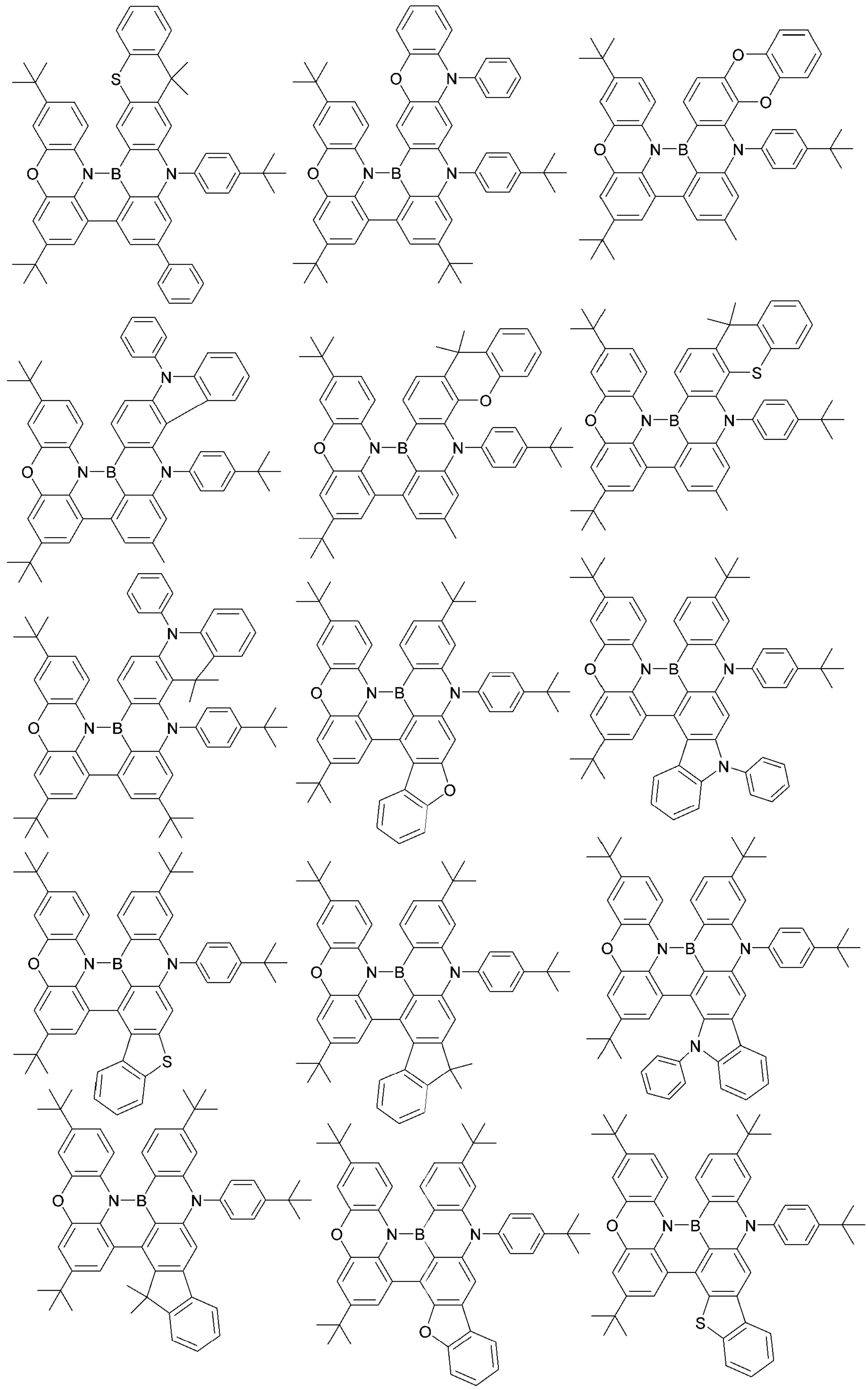

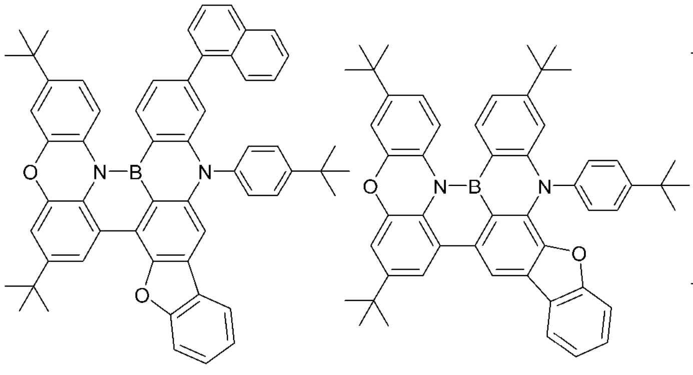

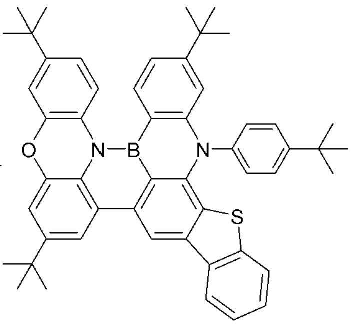

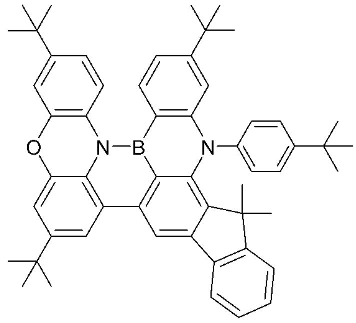

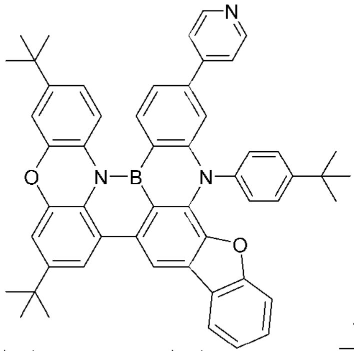

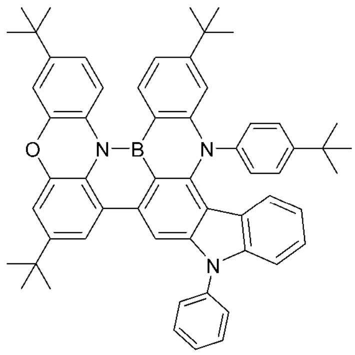

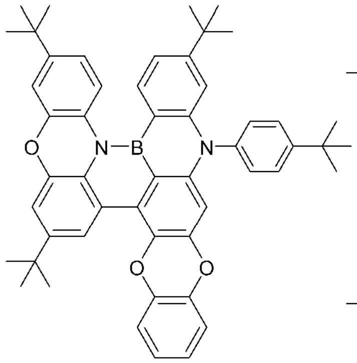

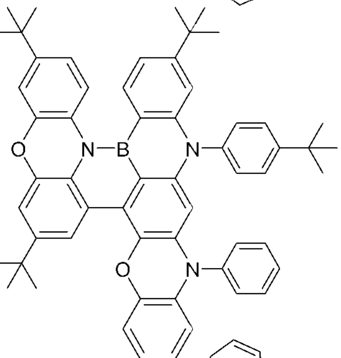

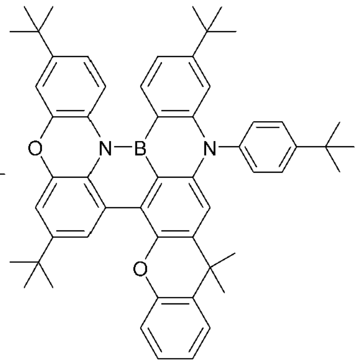

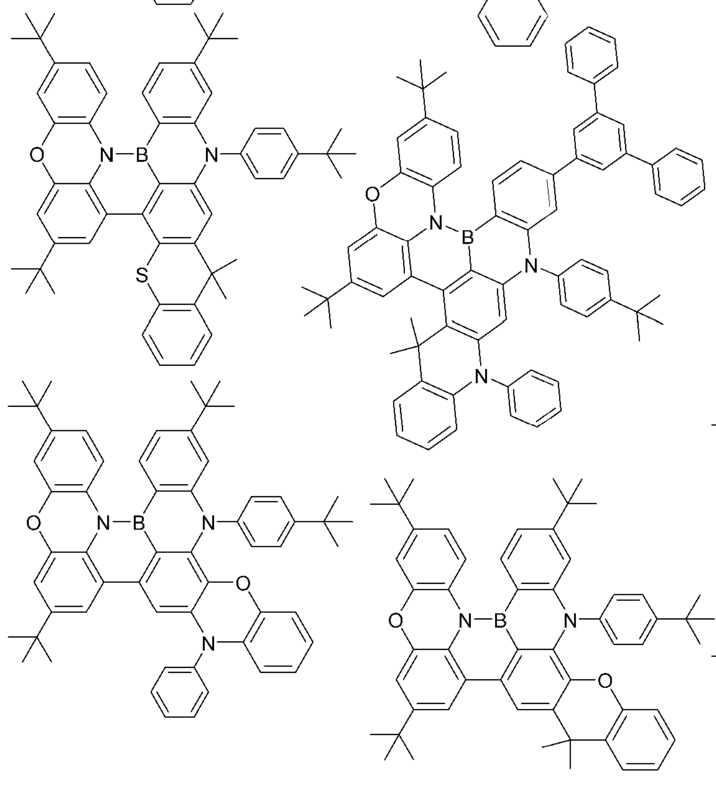

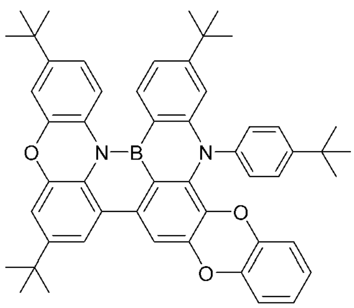

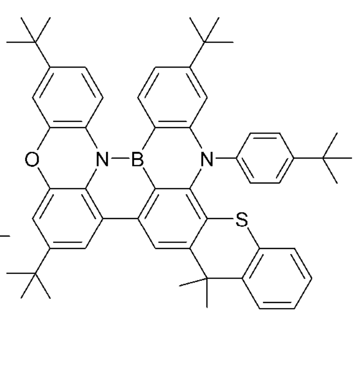

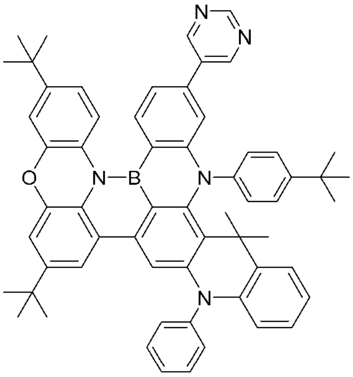
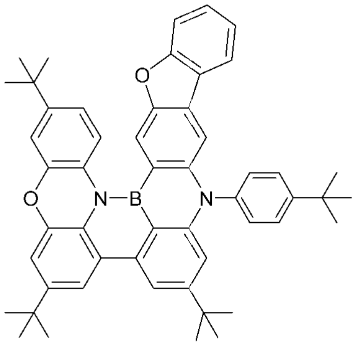
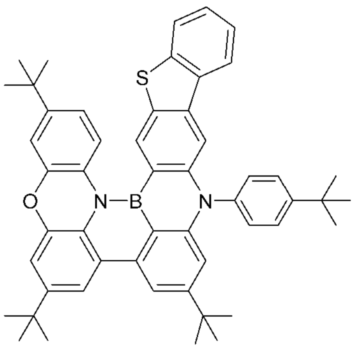
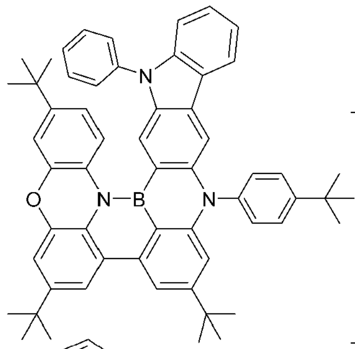
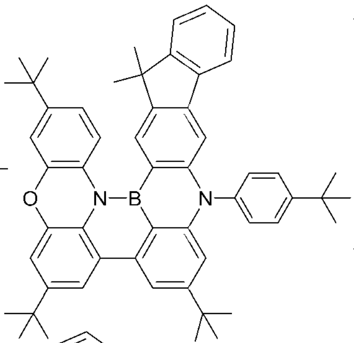
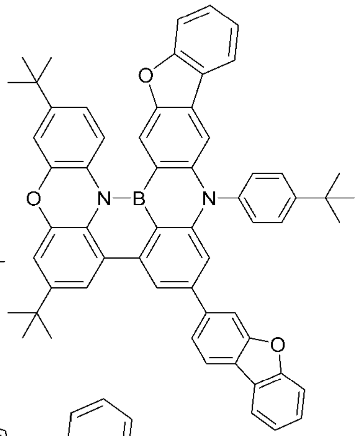
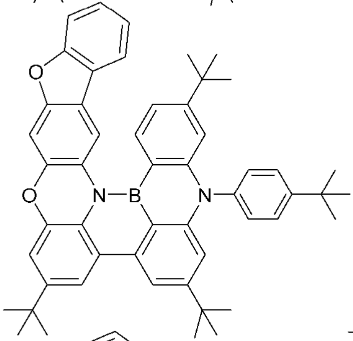
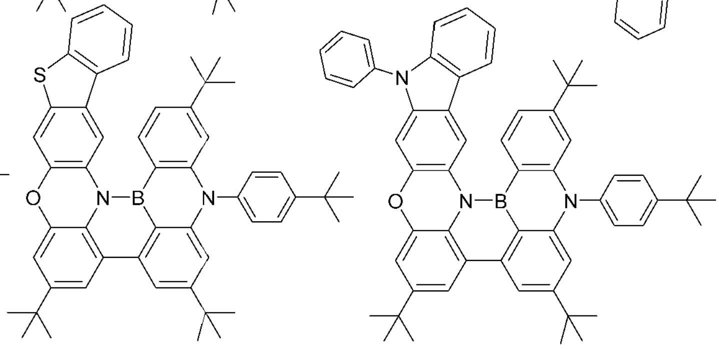
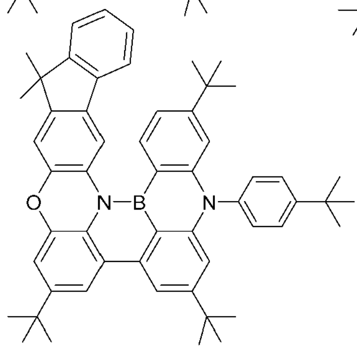
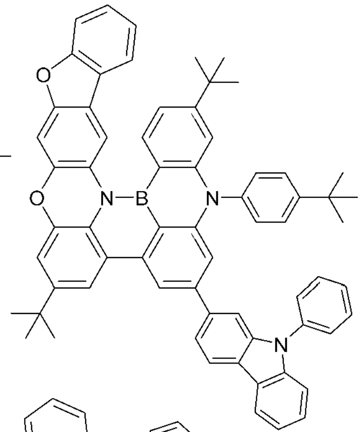
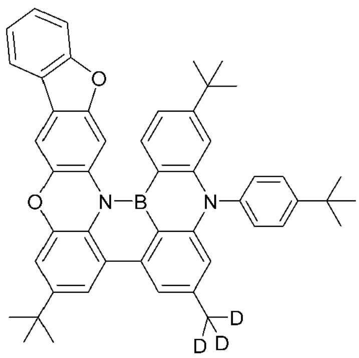
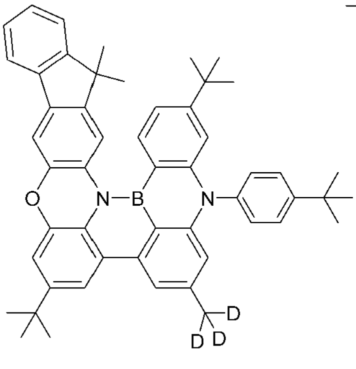
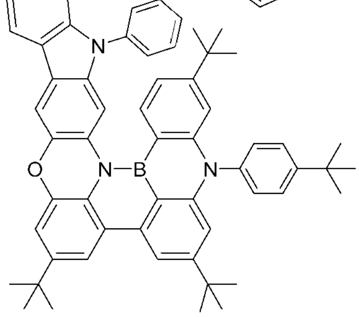
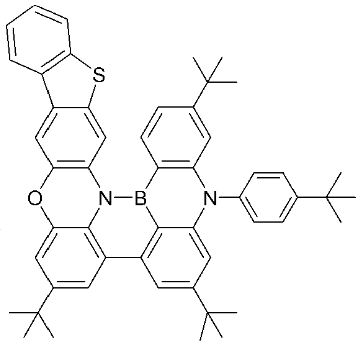

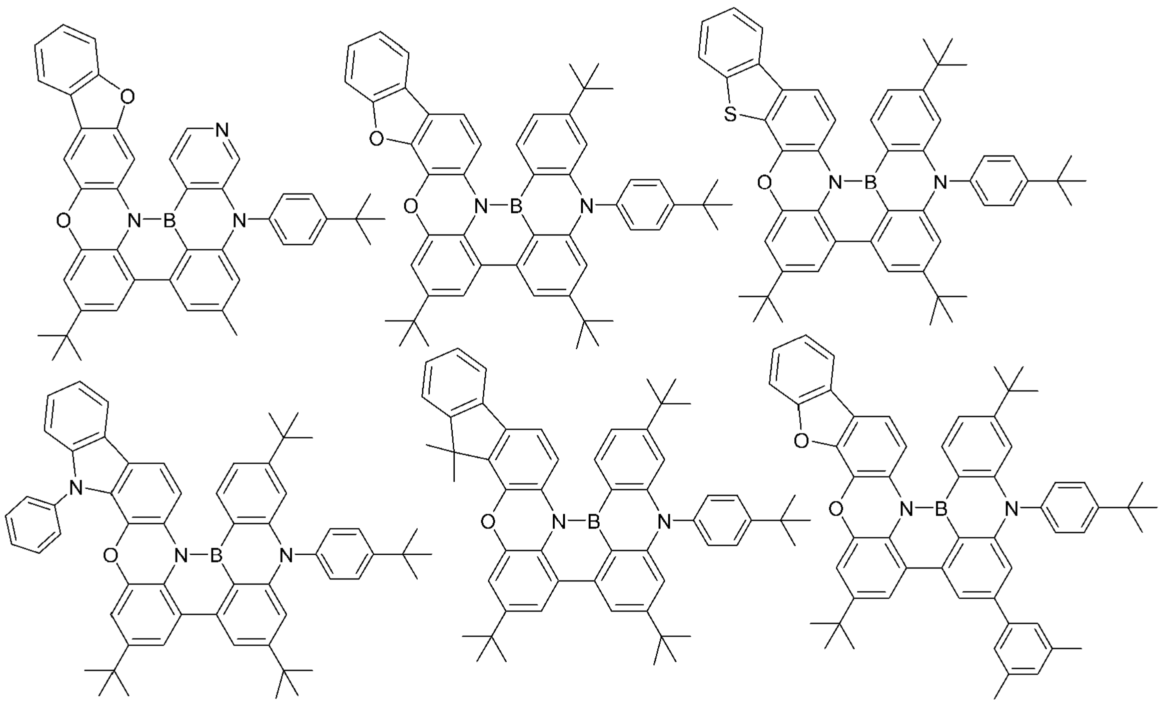

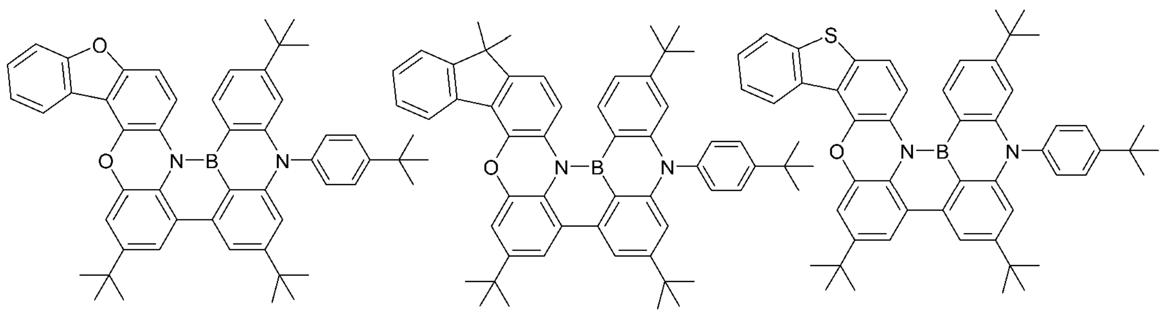

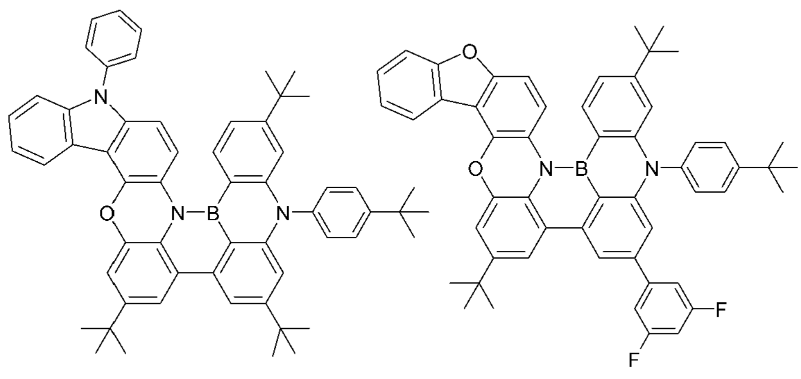

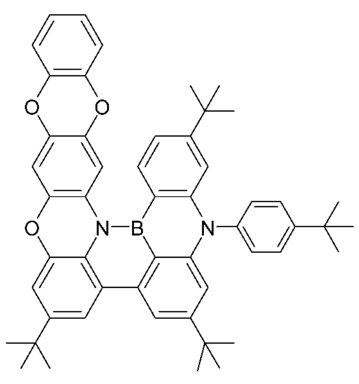

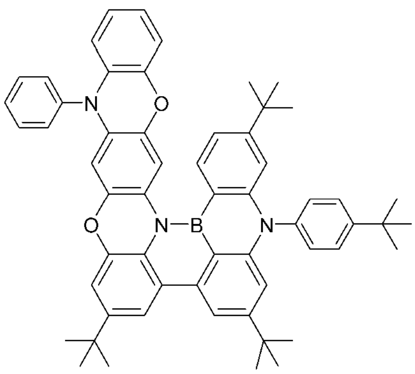

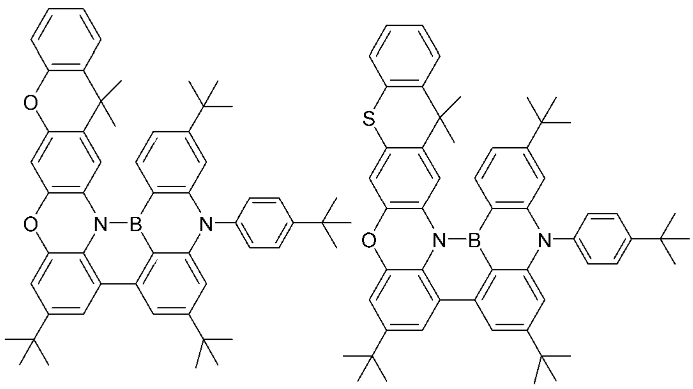

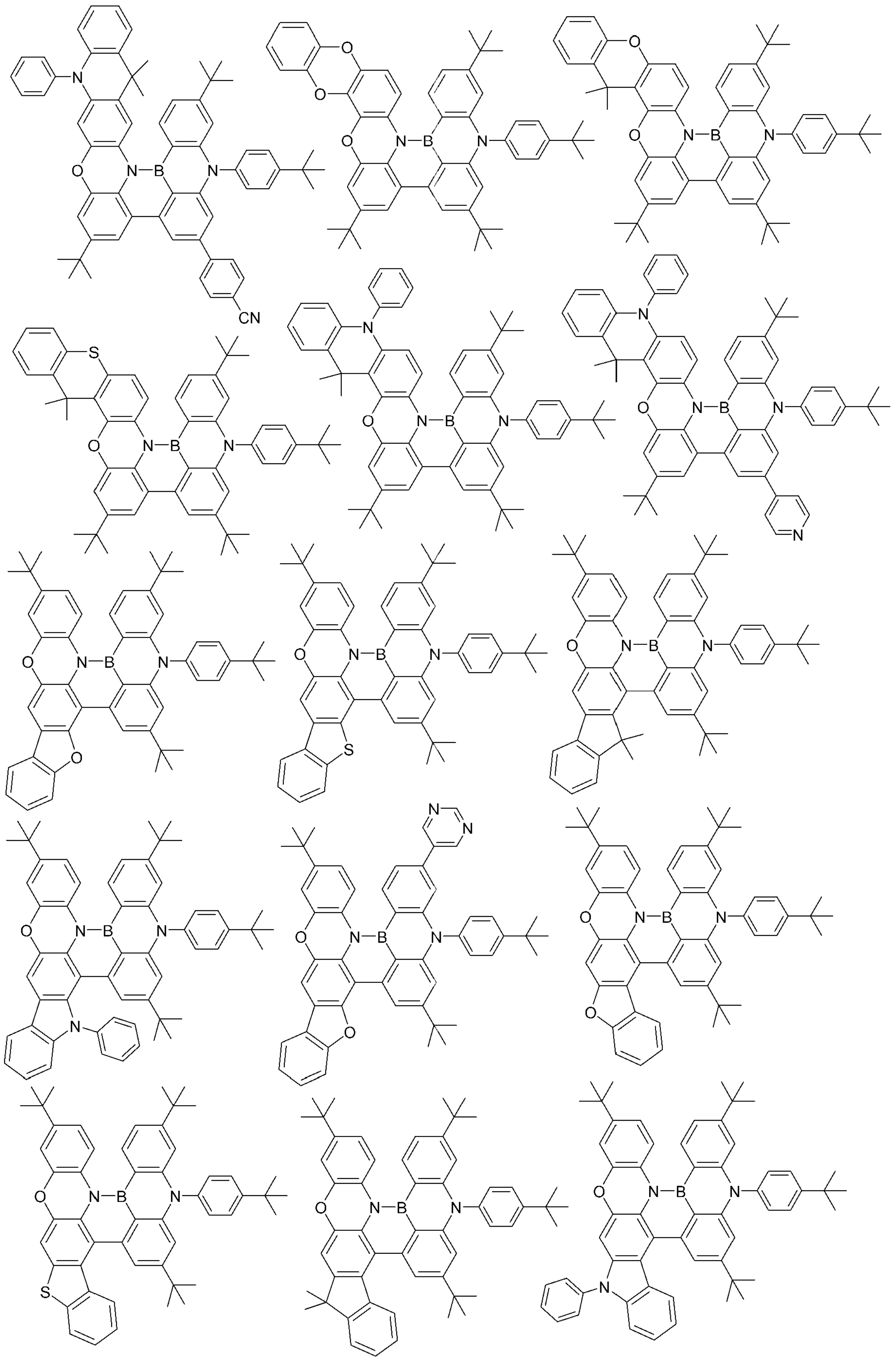

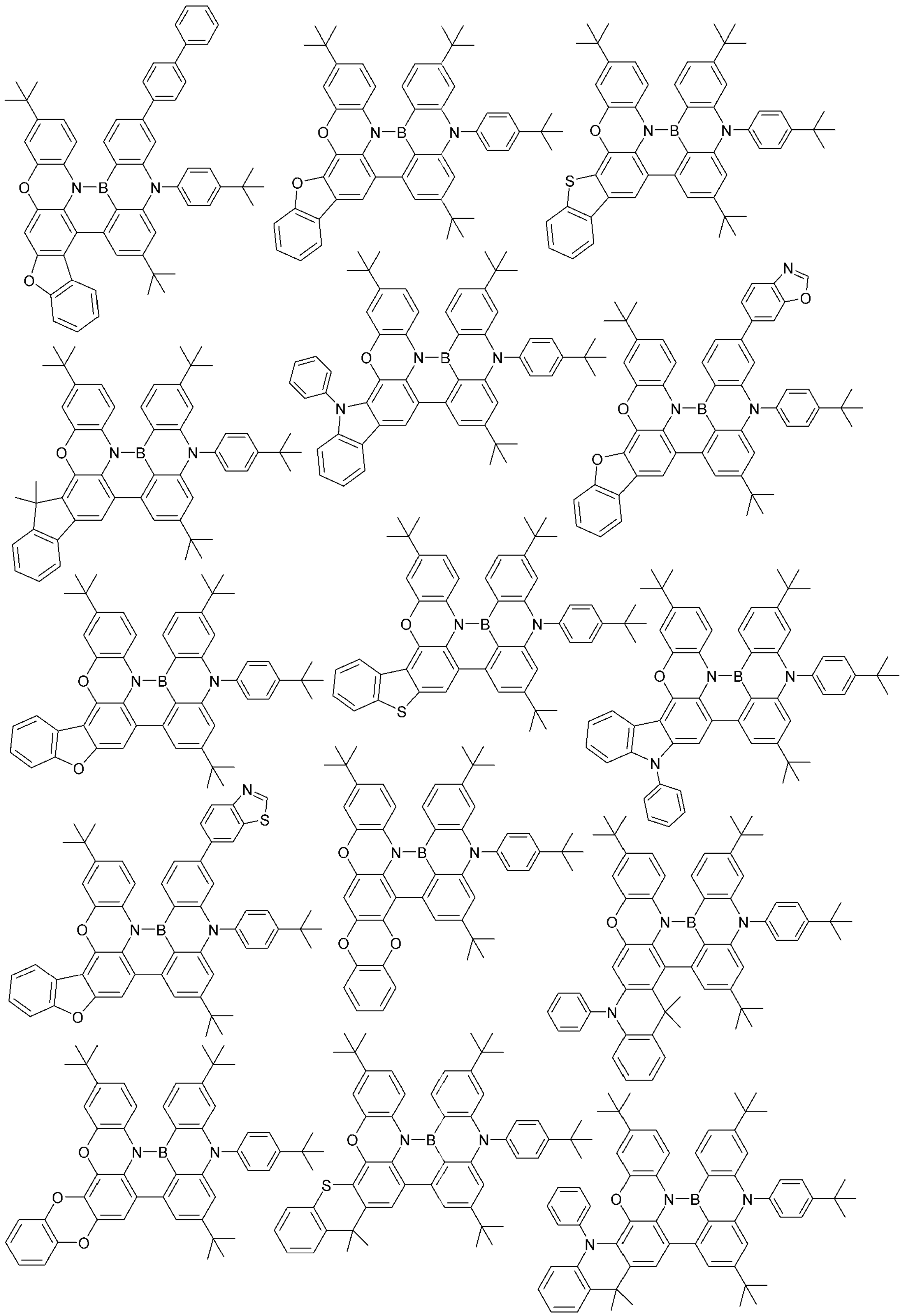

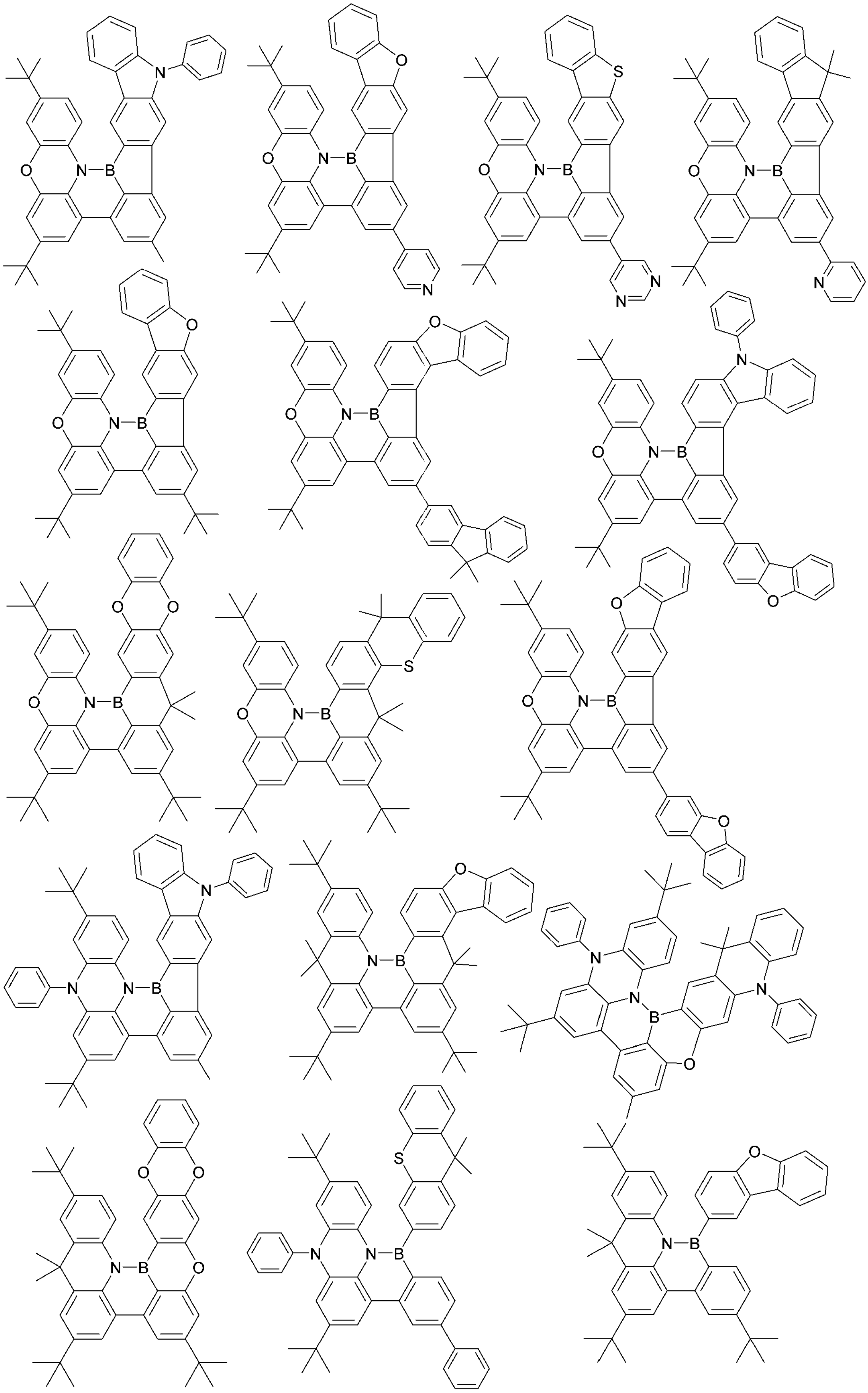

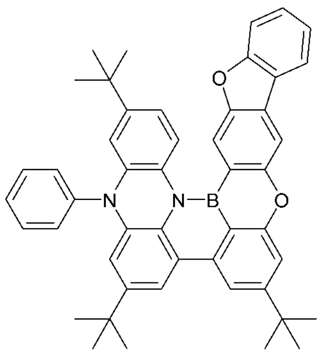 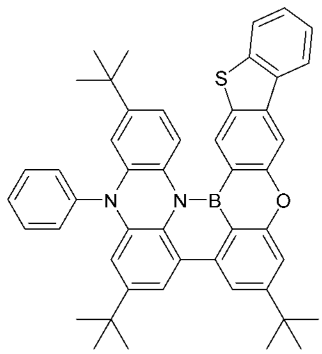 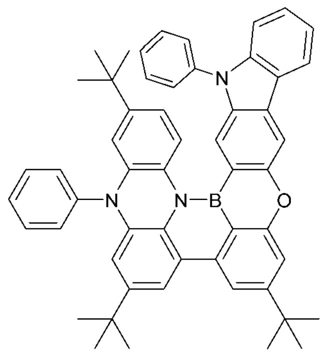

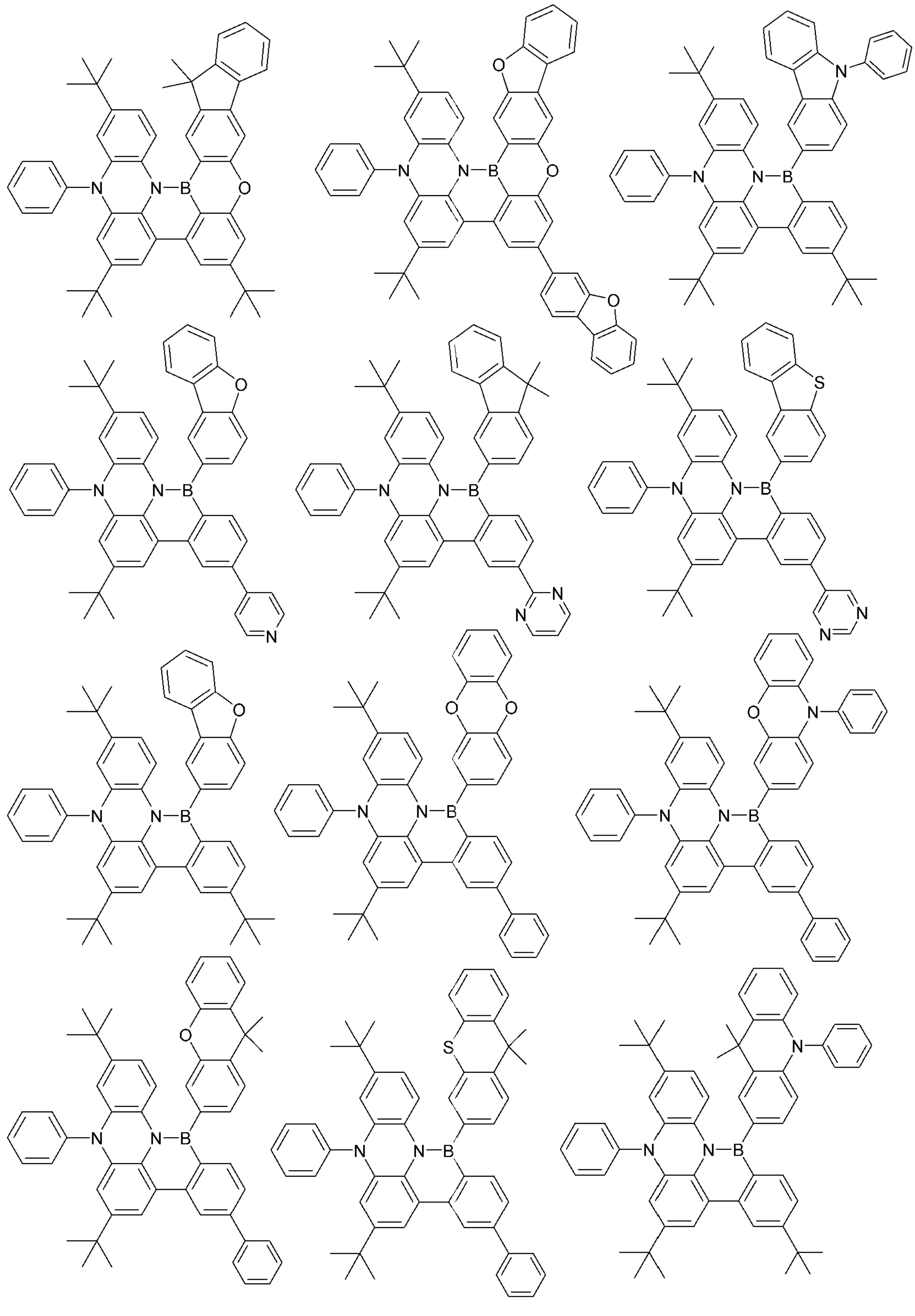

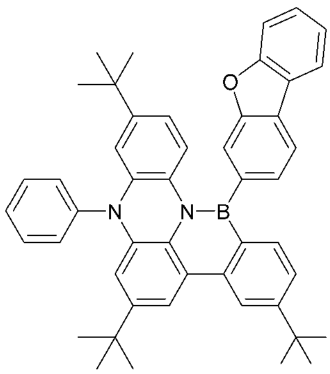

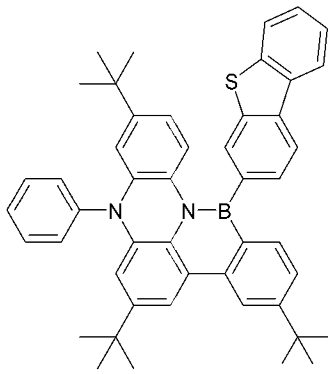

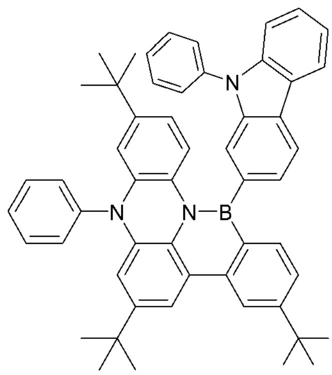

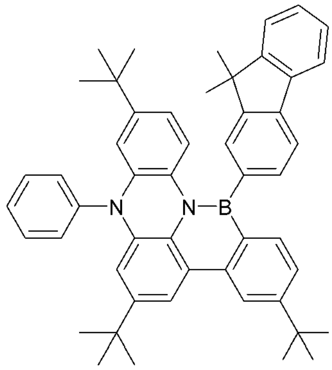

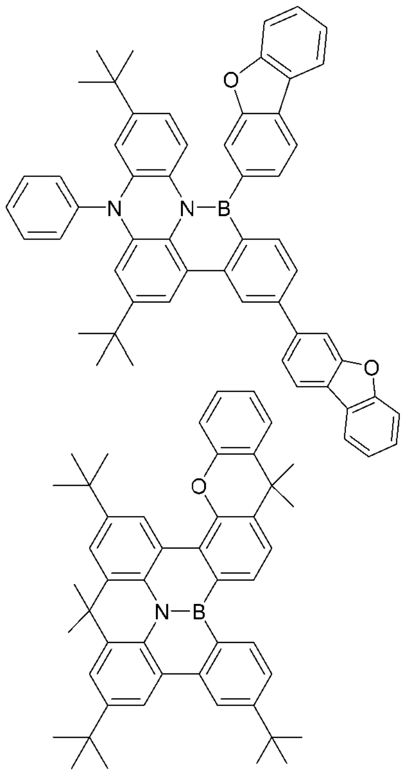

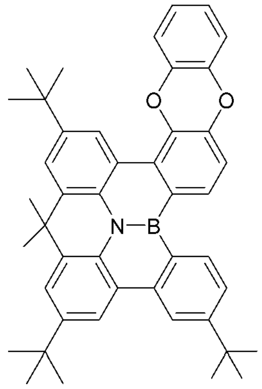

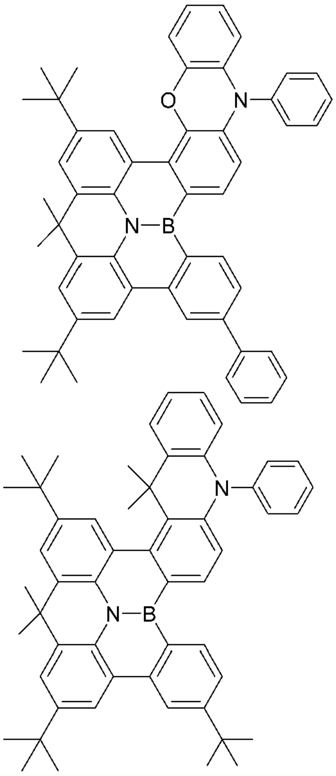

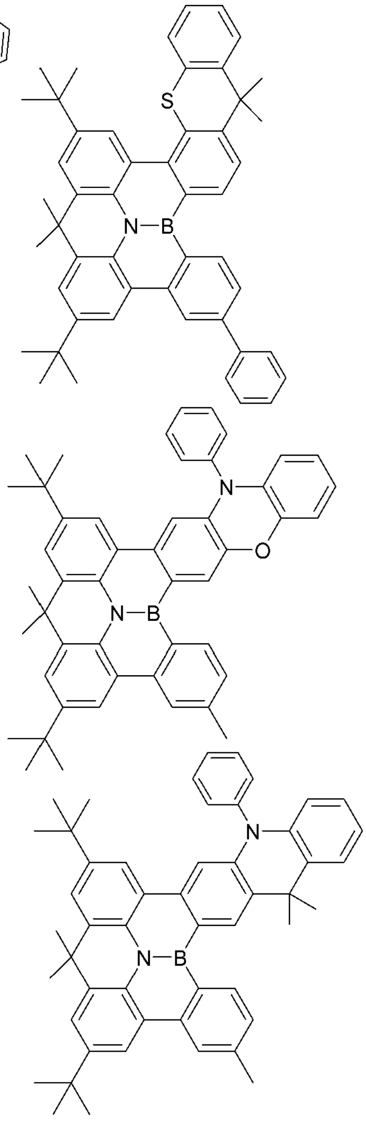

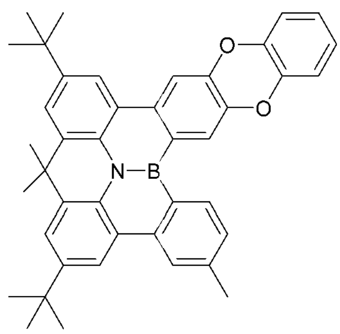

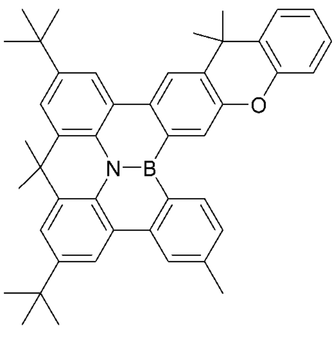

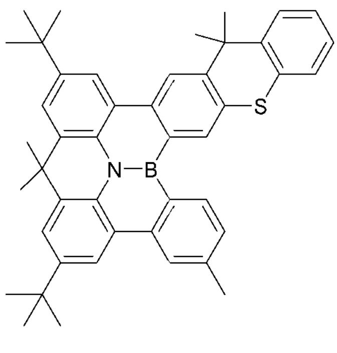

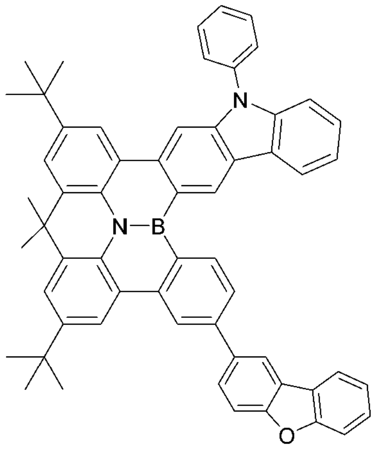
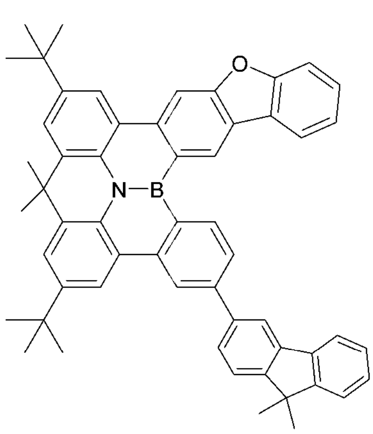
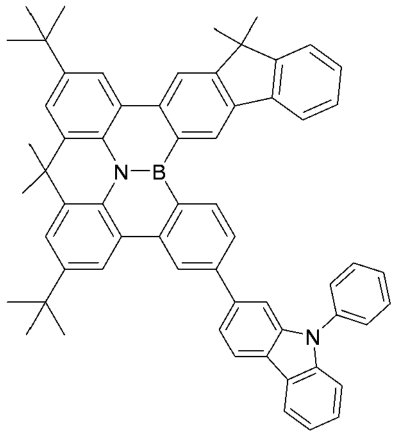

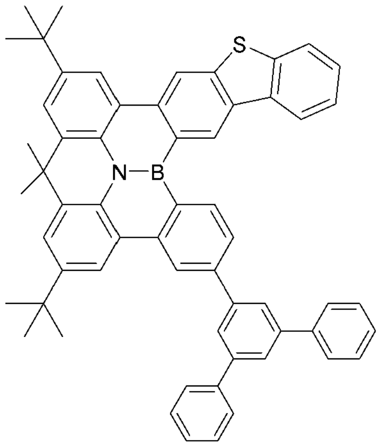
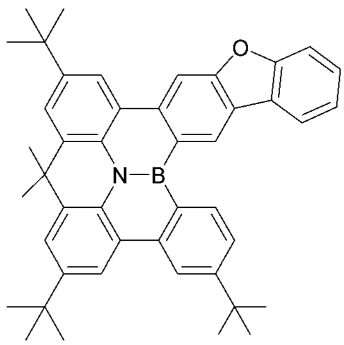

The synthesis of small FWHM emitters $S^B$ comprising or consisting of a structure according to formula BNE-1 can be accomplished via standard reactions and reaction conditions known to the skilled artisan.

Typically, the synthesis comprises transition-metal catalyzed cross coupling reactions and a borylation reaction, all of which are known to the skilled artisan.

For example, WO2020135953 (A1) teaches how to synthesize small FWHM emitters $S^B$ comprising or consisting of a structure according to formula BNE-1. Furthermore, US2018047912 (A1) teaches how to synthesize small FWHM emitters $S^B$ comprising or consisting of a structure according to formula BNE-1, in particular with c and d being 0.

It is understood that the emitters disclosed in US2018047912 (A1) and WO2020135953 (A1) may also be used as small FWHM emitters $S^B$ in the context of the present invention.

In one embodiment of the invention, in at least one, preferably each, light-emitting layer B, at least one, preferably each, small FWHM emitter $S^B$ comprises or consists of a structure according to either formula DABNA-I or formula BNE-1. The person skilled in the art understands this to mean that if more than one small FWHM emitters $S^B$ are present in a light-emitting layer B, they may all comprise or consist of a structure according to formula DABNA-I or all comprise or consist of a structure according to formula BNE-1 or some may comprise or consist of a structure according to formula DABNA-I, while others comprise or consist of a structure according to formula BNE-1.

One approach to design fluorescent emitters relies on the use of fluorescent polycyclic aromatic or heteroaromatic core structures. The latter are, in the context of the present invention, any structures comprising more than one aromatic or heteroaromatic ring, preferably more than two such rings, which are, even more preferably, fused to each other or linked via more than one direct bond or linking atom. In other words, the fluorescent core structures comprise at least one, preferably only one, rigid conjugated $\pi$-system.

The skilled artisan knows how to select a core structure for a fluorescent emitter, for example from US2017077418 (A1). Examples of common core structures of fluorescent emitters are listed below, wherein this does not imply that only these cores may provide small FWHM emitters $S^B$ suitable for the use according to the present invention:

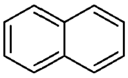 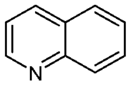 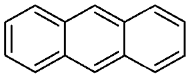 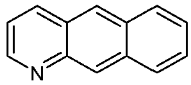 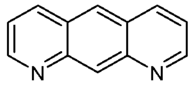

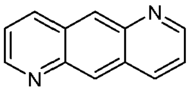 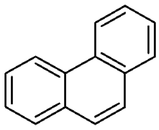 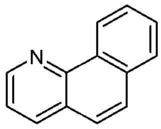 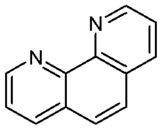 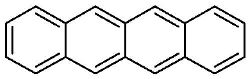

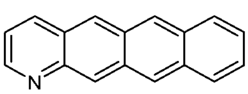 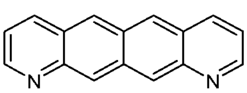 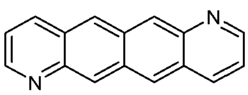 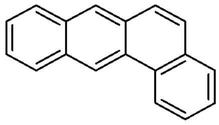

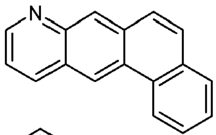 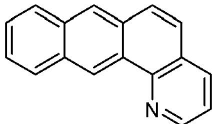 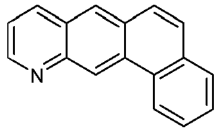 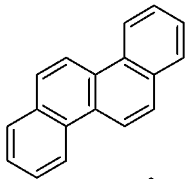

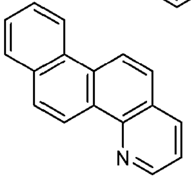 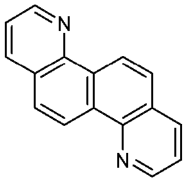 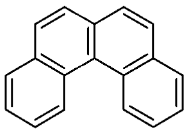 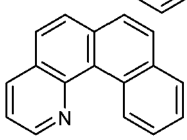 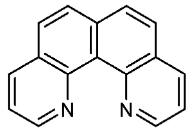

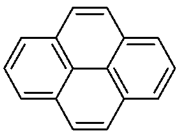 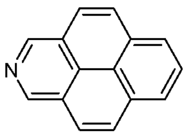 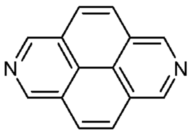 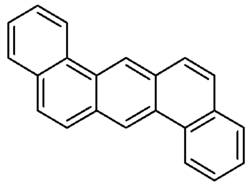

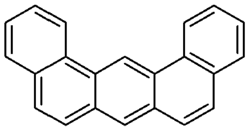 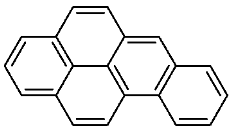 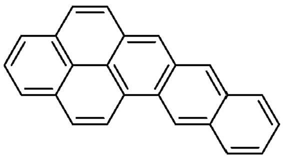 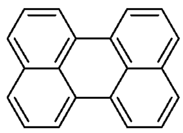

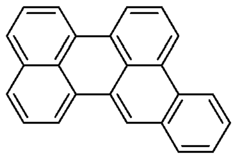 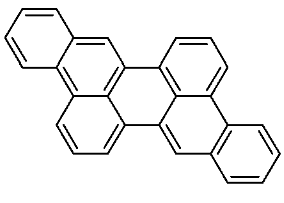 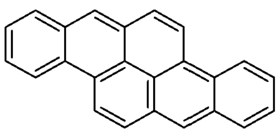 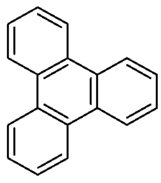

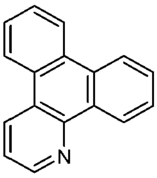 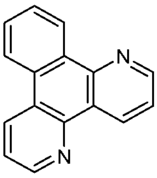 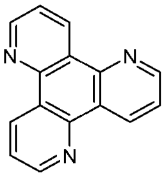 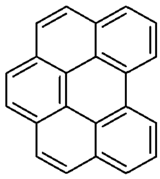 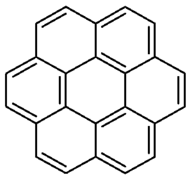

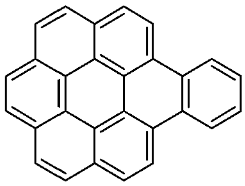 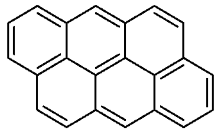 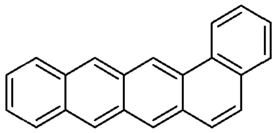 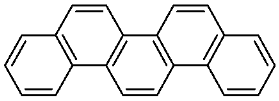

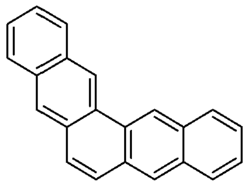 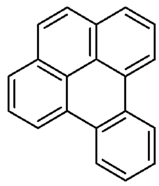 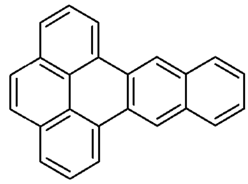 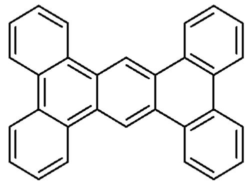

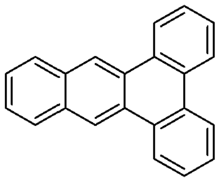 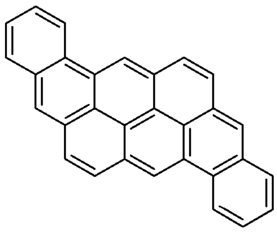 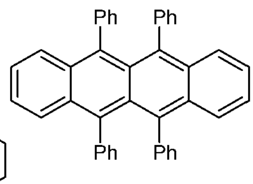 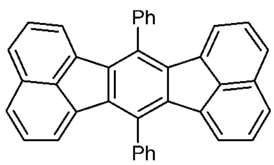

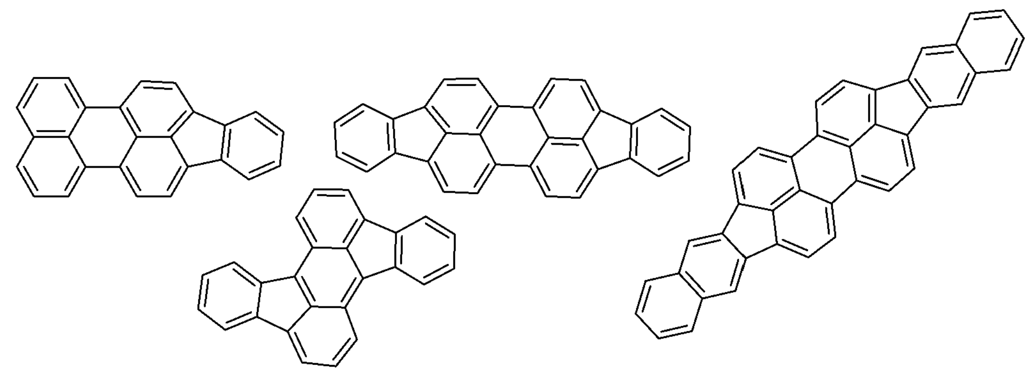

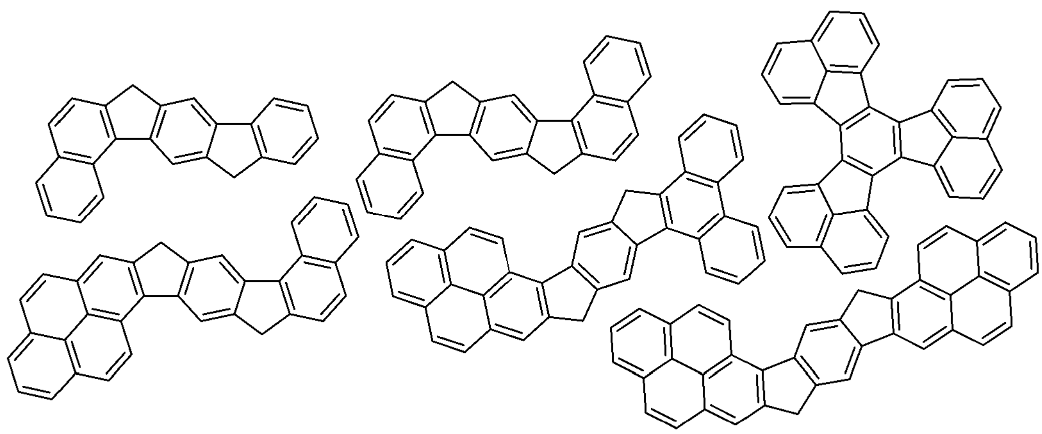

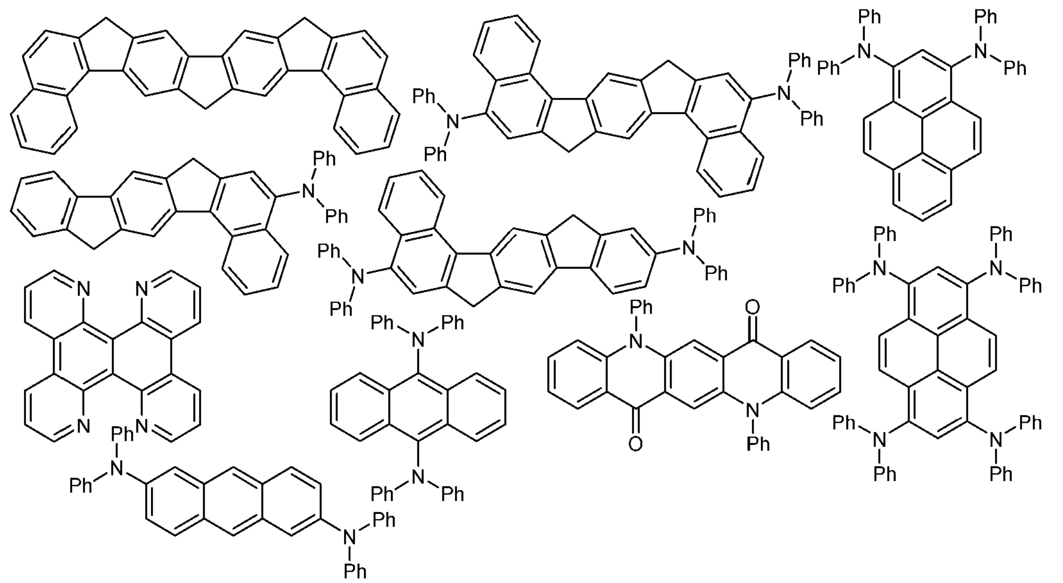

The term fluorescent core structure in this context indicates that any molecule comprising the core may potentially be used as fluorescent emitter. The person skilled in the art knows that the core structure of such a fluorescent emitter may be optionally substituted and which substituents are suitable in this regard, for example from: US2017077418 (A1), M. Zhu. C. Yang, Chemical Society Reviews 2013, 42, 4963, DOI: 10.1039/c3cs35440g; S. Kima, B. Kimb, J. Leea, H. Shina,Y.-Il Parkb, J. Park, Materials Science and Engineering R: Reports 2016, 99, 1, DOI: 10.1016/j.mser.2015.11.001; K.R.J. Thomas, N. Kapoor, M.N.K.P. Bolisetty, J.-H. Jou, Y.-L. Chen, Y.-C. Jou, The Journal of Organic Chemistry 2012, 77(8), 3921, DOI: 10.1021/jo300285v; M. Vanga, R.A. Lalancette, F. Jäkle, Chemistry - A European Journal 2019, 25(43), 10133, DOI: 10.1002/chem.201901231.

Small FWHM emitters $S^B$ for use according to the present invention may be obtained from the aforementioned fluorescent core structures, for example, by attaching sterically demanding substituents to the core that hinder the contact between the fluorescent core and adjacent molecules in the respective layer of an organic electroluminescent device.

In the context of the present invention, a compound, for example a fluorescent emitter is considered to be sterically shielded, when a subsequently defined shielding parameter is equal to or below a certain limit which is also defined in a later subchapter of this text.

It is preferred that the substituents used to sterically shield a fluorescent emitter are not just bulky (i.e. sterically demanding), but also electronically inert, which in the context of the present invention means, that these substituents do not comprise an active atom as defined in a later subchapter of this text. It is understood that this does not imply that only electronically inert (in other words: not active) substituents may be attached to a fluorescent core structure such as the ones shown above. Active substituents may also be attached to the core structure and may be introduced on purpose to tune the photophysical properties of a fluorescent core structure. In this case, it is preferred, that the active atoms introduced via one or more substituents are again shielded by electronically inert (i.e. not active) substituents.

Based on the aforementioned information and common knowledge from the state of the art, the skilled artisan understands how to choose substituents for a fluorescent core structure that may induce steric shielding of the latter and that are electronically inert as stated above. In particular, US2017077418 (A1) discloses substituents suitable as electronically inert (in other words: not active) shielding substituents. Examples of such substituents include linear, branched or cyclic alkyl groups with 3 to 40 carbon atoms, preferably 3 to 20 carbon atoms, more preferably with 4 to 10 carbon atoms, wherein one or more hydrogen atoms may be replaced by a substituent, preferably by deuterium or fluorine. Other examples include alkoxy groups with 3 to 40 carbon atoms, preferably 3 to 20 carbon atoms, more preferably with 4 to 10 carbon atoms, wherein one or more hydrogen atoms may be replaced by a substituent, preferably by deuterium or fluorine. It is understood that these alkyl and alkoxy substituents may be substituted by substituents other than deuterium and fluorine, for example by aryl groups. In this case, it is preferred that the aryl group as substituent comprises 6 to 30 aromatic ring atoms, more preferably 6 to 18 aromatic ring atoms, most preferably 6 aromatic ring atoms, and is preferably not a fused aromatic system such as anthracene, pyrene and the like. Other examples include aryl groups with 6 to 30 aromatic ring atoms, more preferably with 6 to 24 aromatic ring atoms. One or more hydrogen atom in these aryl substituents may be substituted and preferred substituents are for example aryl groups with 6 to 30 carbon atoms and linear, branched or cyclic alkyl groups with 1 to 20 carbon atoms. All substituents may be further substituted. It is understood that all sterically demanding and preferably also electronically inert (in other words: not active) substituents disclosed in US2017077418 (A1) may serve to sterically shield a fluorescent core (such as those described above) to

afford sterically shielded fluorescent emitters suitable as small FWHM emitters $S^B$ for use according to the present invention.

Below, non-limiting examples of substituents are shown that may be used as sterically demanding (i.e. shielding) and electronically inert (i.e. not active) substituents in the context of the present invention (disclosed in US2017077418 (A1)):

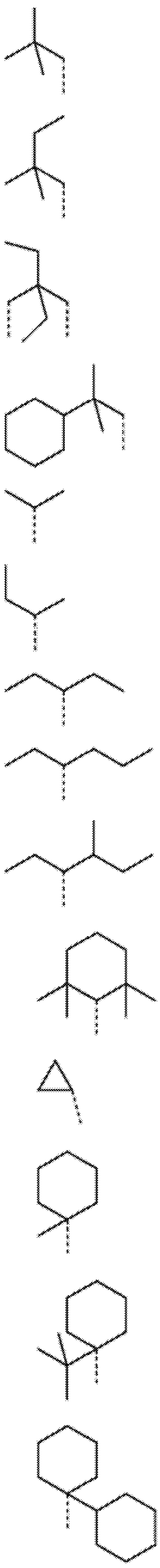
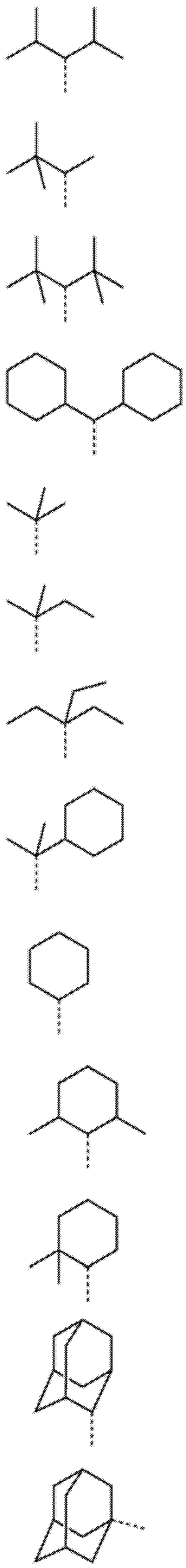
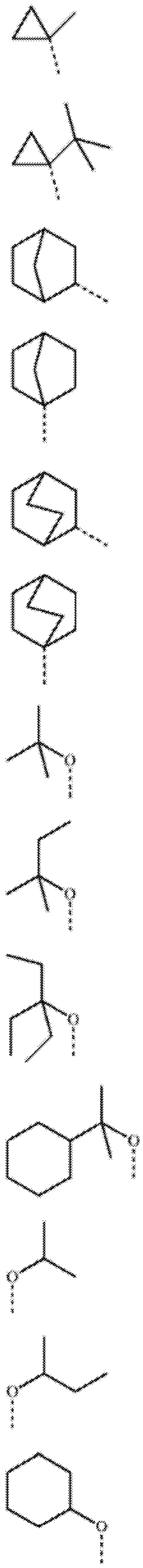
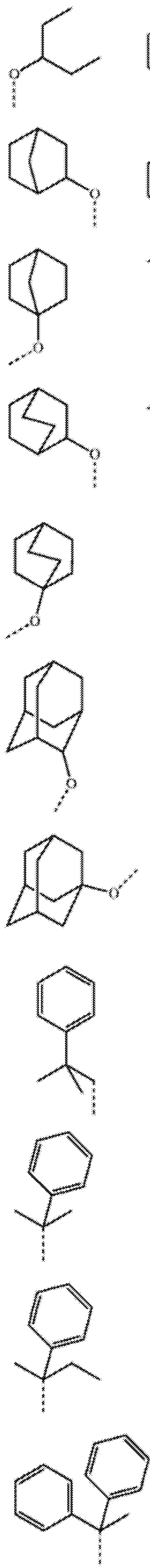
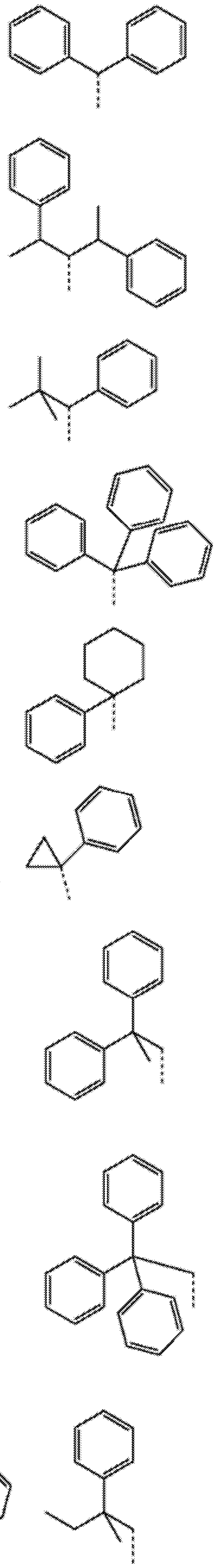

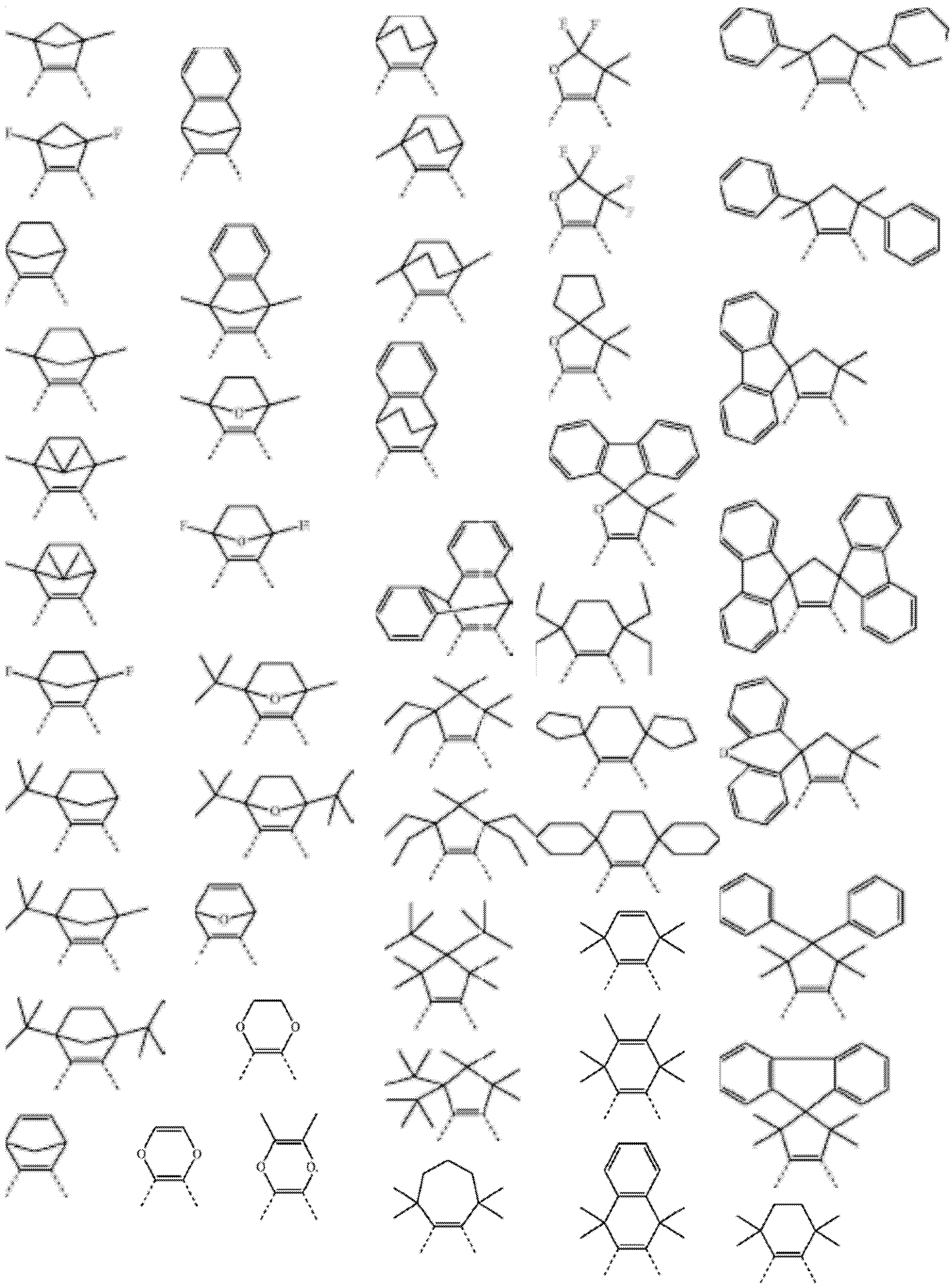

, wherein each dashed line represents a single bond connecting the respective substituent to a core structure, preferably to a fluorescent core structure. As known to the skilled artisan, trialkylsilyl groups are also suitable for use as sterically demanding and electronically inert substituents.

It is also understood that a fluorescent core may not just bear such sterically shielding substituents, but may also be substituted by further, non-shielding substituents that may or may not be active groups in the context of the present invention (see below for a definition).

Below, examples of sterically shielded fluorescent emitters are shown that may be used as small FWHM emitters $S^B$ in the context of the present invention. This does not imply that the present invention is limited to organic electroluminescent devices comprising the shown emitters.

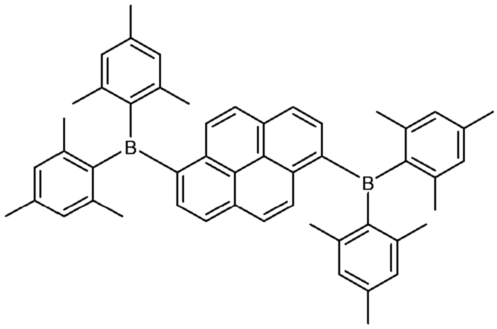 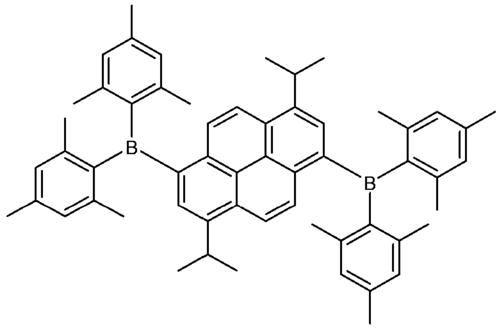

It is understood that sterically shielding substituents (that may or may not be electronically inert as stated above) may be attached to any fluorescent molecules, for example to the aforementioned polycyclic aromatic or heteroaromatic fluorescent cores, the BODIPY-derived structures and the NRCT emitters shown herein and to emitters comprising a structure of formula BNE-1. This may result in sterically shielded fluorescent emitters that may be suitable as small FWHM emitters $S^B$ according to the invention.

In one embodiment of the invention, within at least one, preferably each, light-emitting layer B, at least one, preferably each, small FWHM emitter $S^B$ fulfills at least one of the following requirements:

(i) it is a boron (B)-containing emitter, which means that at least one atom within each small FWHM emitter $S^B$ is boron (B); and/or
(ii) it comprises a polycyclic aromatic or heteroaromatic core structure, wherein at least two aromatic rings are fused together (e.g. anthracene, pyrene or aza-derivatives thereof).

In one embodiment of the invention, within at least one, preferably each, light-emitting layer B, at least one, preferably each small FWHM emitter $S^B$ fulfills at least one of the following requirements

(i) it is a boron (B)-containing emitter, which means that at least one atom within the (respective) small FWHM emitter $S^B$ is boron (B); and/or
(ii) it comprises a polycyclic aromatic or heteroaromatic core structure, wherein at least two aromatic rings are fused together (e.g. anthracene, pyrene or aza-derivatives thereof).

In one embodiment of the invention, each small FWHM emitter $S^B$ is a boron (B)-containing emitter, which means that at least one atom within each small FWHM emitter $S^B$ is boron (B).

In one embodiment of the invention, each small FWHM emitter $S^B$ comprises a polycyclic aromatic or heteroaromatic core structure, wherein at least two aromatic rings are fused together (e.g. anthracene, pyrene or aza-derivatives thereof).

In one embodiment of the invention, within at least one, preferably each, light-emitting layer B, at least one, preferably each, small FWHM emitter $S^B$ fulfills at least one (or both) of the following requirements:

(i) it is a boron (B)-containing emitter, which means that at least one atom within each small FWHM emitter $S^B$ is boron (B); and/or
(ii) it comprises a pyrene core structure.

In one embodiment of the invention, within at least one, preferably each, light-emitting layer B, at least one, preferably each small FWHM emitter $S^B$ fulfills at least one (or both) of the following requirements:

(i) it is a boron (B)-containing emitter, which means that at least one atom within the (respective) small FWHM emitter $S^B$ is boron (B);
(ii) it comprises a pyrene core structure.

In one embodiment of the invention, each small FWHM emitter $S^B$ comprises a pyrene core structure.

In a preferred embodiment of the invention, in at least one, preferably each, light-emitting layer B, at least one, preferably each, small FWHM emitter $S^B$ is a boron (B)- and nitrogen (N)-containing emitter, which means that at least one atom within each small FWHM emitter $S^B$ is boron (B) and at least one atom within each small FWHM emitter $S^B$ is nitrogen

(N).

In a preferred embodiment of the invention, in at least one, preferably each, light-emitting layer B, at least one, preferably each, small FWHM emitter $S^B$ comprises at least one boron atom (B)- that is (directly) covalently bonded to at least one nitrogen atom (N).

In a preferred embodiment of the invention, in at least one, preferably each, light-emitting layer B, at least one, preferably each, small FWHM emitter $S^B$ comprises a boron atom (B) that is trivalent, i.e. bonded via three single bonds.

*Steric Shielding*

Determination of the shielding parameter A

The shielding parameter A of a molecule can be determined as exemplarily described in the following for (fluorescent) emitters, such as those mentioned above. It will be understood that the shielding parameter A typically refers to the unit Angstrom (Å$^2$). This does not imply that only such compounds may be sterically shielded in the context of the present invention, nor that a shielding parameter can only be determined for such compounds.

1. Determination of the energy levels of the molecular orbitals

The energy levels of the molecular orbitals may be determined via quantum chemical calculations. For this purpose, in the present case, the Turbomole software package (Turbomole GmbH), version 7.2, may be used. First, a geometry optimization of the ground state of the molecule may be performed using density functional theory (DFT), employing the def2-SV(P) basis set and the BP-86 functional. Subsequently, on the basis of the optimized geometry, a single-point energy calculation for the electronic ground state may be performed employing the B3-LYP functional. From the energy calculation, the highest occupied molecular orbital (HOMO), for example, may be obtained as the highest-energy orbital occupied by two electrons, and the lowest unoccupied molecular orbital (LUMO) as the lowest-energy unoccupied orbital. The energy levels may be obtained in an analogous manner for the other molecular orbitals such as HOMO-1, HOMO-2, ... LUMO+1, LUMO+2 etc.

The method described herein is independent of the software package used. Examples of other frequently utilized programs for this purpose may be "Gaussian09" (Gaussian Inc.) and Q-Chem 4.1 (Q-Chem, Inc.).

2. Charge-exchanging molecular orbitals of the (fluorescent) compound

Charge-exchanging molecular orbitals of the (fluorescent) compound may be considered to be the HOMO and LUMO, and all molecular orbitals that may be separated in energy by 75 meV or less from the HOMO or LUMO.

3. Determination of the active atoms of a molecular orbital

For each charge-exchanging molecular orbital, a determination of which atoms may be active may be conducted. In other words, a generally different set of active atoms may be found for each molecular orbital. There follows a description of how the active atoms of the HOMO may be determined. For all other charge-exchanging molecular orbitals (e.g. HOMO-1, LUMO, LUMO+1, etc.), the active atoms may be determined analogously.

The HOMO may be calculated as described above. To determine the active atoms, the surface on which the orbital has an absolute value of 0.035 ("isosurface with cutoff 0.035") is inspected. For this purpose, in the present case, the Jmol software (http://jmol.sourceforge.net/), version 14.6.4, is used. Atoms around which orbital lobes with values equal to or larger than the cutoff value may be localized may be considered active. Atoms around which no orbital lobes with values equal to or larger than the cutoff value may be localized may be considered inactive.

(4) Determination of the active atoms in the (fluorescent) compound

If one atom is active in at least one charge-exchanging molecular orbital, it may be considered to be active in respect of the (fluorescent) compound. Only atoms that may be inactive (non-active) in all charge-exchanging molecular orbitals may be inactive in respect of the (fluorescent) compound.

(5) Determination of the shielding parameter A

In a first step, the solvent accessible surface area SASA may be determined for all active atoms according to the method described in B. Lee, F.M. Richards, Journal of Molecular Biology 1971, 55(3), 379, DOI: 10.1016/0022-2836(71)90324-X. For this purpose, the van-der-Waals surface of the atoms of a molecule may be considered to be impenetrable.

The SASA of the entire molecule may be then defined as the area of the surface which may be traced by the center of a hard sphere (also called probe) with radius r (the so-called probe radius) while it may be rolled over all accessible points in space at which its surface may be in direct contact with the van-der-Waals surface of the molecule. The SASA value can also be determined for a subset of the atoms of a molecule. In that case, only the surface traced by the center of the probe at points where the surface of the probe may be in contact with the van-der-Waals surface of the atoms that may be part of the subset may be considered. The Lee-Richards algorithm used to determine the SASA for the present purpose may be part of the program package Free SASA (S. Mitternacht, Free SASA: An open source C library for solvent accessible surface area calculations. F1000Res. 2016; 5:189. Published 2016 Feb 18. doi:10.12688/f1000research.7931.1). The van-der-Waals radii $r_{VDW}$ of the relevant elements may be compiled in the following reference: M. Mantina, A.C. Chamberlin, R. Valero, C.J. Cramer, D.G. Truhlar, The Journal of Physical Chemistry A 2009, 113(19), 5806, DOI: 10.1021/jp8111556. The probe radius r may be set to be 4 Å (r = 4 Å) for all SASA determinations for the present purpose.

In the context of the present invention, the shielding parameter A may be obtained by dividing the solvent accessible surface area of the subset of active atoms (labeled S to distinguish from the SASA of the entire molecule) by the number n of active atoms:

$$A = S/n$$

In the context of the present invention, a compound may be defined as sterically well-shielded if the shielding parameter A has a value below 2 Å$^2$ (A < 2.0 Å$^2$).

In the context of the present invention, a compound may be defined as sterically shielded if the shielding parameter A has a value of 1.0 to 5.0 Å$^2$ (1.0 Å$^2$ ≤ A ≤ 5.0 Å$^2$), preferably 2.0 Å$^2$ to 5.0 Å$^2$ (2.0 Å$^2$ ≤ A ≤ 5.0 Å$^2$).

Below, exemplary (fluorescent) emitters are shown, alongside their shielding parameters A, which were determined as stated above. It will be understood that this does not imply that the present invention is limited to organic electroluminescent devices comprising one of the shown emitters. The depicted emitter compounds are merely non-limiting examples that represent optional embodiments of the invention.

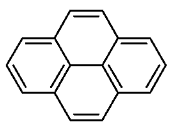

shielding parameter A = 15.5 Å$^2$

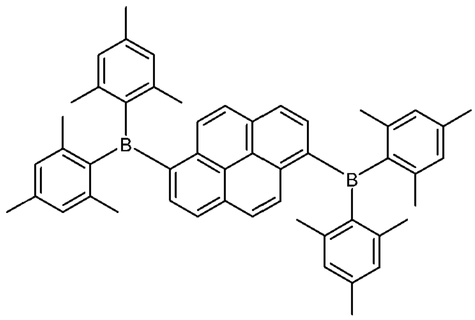

shielding parameter A = 2.3 Å$^2$

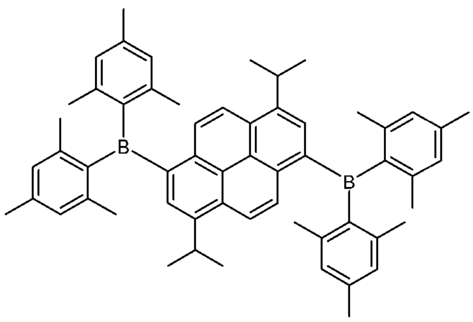

shielding parameter A = 1.7 Å$^2$

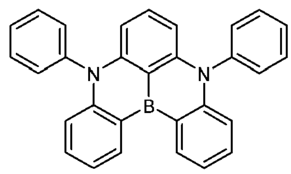

shielding parameter A = 9.3 Å$^2$

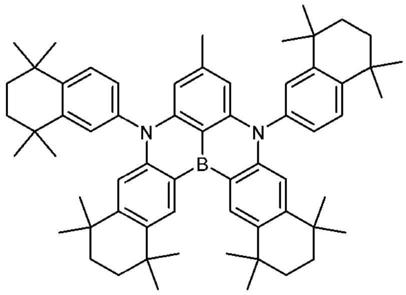

shielding parameter A = 0.1 Å$^2$

In one embodiment of the invention, each small FWHM emitter $S^B$ comprised in an organic electroluminescent device according to the invention exhibits a shielding parameter A equal to or smaller than 5.0 Å$^2$.

In one embodiment, in at least one, preferably each, light-emitting layer B of the organic electroluminescent device according to the present invention, at least one, preferably each, small FWHM emitter $S^B$ exhibits a shielding parameter A equal to or smaller than 5.0 Å$^2$.

In a preferred embodiment of the invention, each small FWHM emitter $S^B$ comprised in an organic electroluminescent device according to the invention exhibits a shielding parameter A equal to or smaller than 2.0 Å$^2$.

In one embodiment, in at least one, preferably each, light-emitting layer B of the organic electroluminescent device according to the present invention, at least one, preferably each, small FWHM emitter $S^B$ exhibits a shielding parameter A equal to or smaller than 2.0 Å$^2$.

The person skilled in the art understands that not only a fluorescent emitter such as a small FWHM emitter $S^B$ according to the present invention may be sterically shielded by attaching shielding substituents. It is understood that for example also a TADF material $E^B$ in the context of the present invention and also a phosphorescence material $P^B$ in the context of the present invention may be shielded.

*Host material(s) $H^B$*

According to the invention, any of the one or more host materials $H^B$ comprised in any of the one or more light-emitting layers B may be a p-host $H^P$ exhibiting high hole mobility, an n-host $H^N$ exhibiting high electron mobility, or a bipolar host material $H^{BP}$ exhibiting both, high hole mobility and high electron mobility.

An n-host $H^N$ exhibiting high electron mobility in the context of the present invention preferably has a LUMO energy $E^{LUMO}(H^N)$ equal to or smaller than -2.50 eV ($E^{LUMO}(H^N) \leq -2.50$ eV), preferably $E^{LUMO}(H^N) \leq -2.60$ eV, more preferably $E^{LUMO}(H^N) \leq -2.65$ eV, and even more preferably $E^{LUMO}(H^N) \leq -2.70$ eV. The LUMO is the lowest unoccupied molecular orbital. The energy of the LUMO is determined as described in a later subchapter of this text.

A p-host $H^P$ exhibiting high hole mobility in the context of the present invention preferably has a HOMO energy $E^{HOMO}(H^P)$ equal to or higher than -6.30 eV ($E^{HOMO}(H^P) \geq -6.30$ eV), preferably $E^{HOMO}(H^P) \geq -5.90$ eV, more preferably $E^{HOMO}(H^P) \geq -5.70$ eV, even more preferably $E^{HOMO}(H^P) \geq -5.40$ eV. The HOMO is the highest occupied molecular orbital. The energy of the HOMO is determined as described in a later subchapter of this text.

In a preferred embodiment of the invention, in each light-emitting layer B of an organic electroluminescent device according to the present invention, at least one, preferably each, host material $H^B$ is a p-host $H^P$ which has a HOMO energy $E^{HOMO}(H^P)$ equal to or higher than -6.30 eV ($E^{HOMO}(H^P) \geq -6.30$ eV), preferably $E^{HOMO}(H^P) \geq -5.90$ eV, more preferably $E^{HOMO}(H^P) \geq -5.70$ eV, and even more preferably $E^{HOMO}(H^P) \geq -5.40$ eV. The HOMO is the highest occupied molecular orbital.

In one embodiment of the invention, within each light-emitting layer B, at least one, preferably each p-host $H^P$ comprised in a light-emitting layer B has a HOMO energy $E^{HOMO}(H^P)$ smaller than -5.60 eV.

A bipolar host $H^{BP}$ exhibiting high electron mobility in the context of the present invention preferably has a LUMO energy $E^{LUMO}(H^{BP})$ equal to or smaller than - 2.50 eV ($E^{LUMO}(H^{BP}) \leq -2.50$ eV), preferably $E^{LUMO}(H^{BP}) \leq -2.60$ eV, more preferably $E^{LUMO}(H^{BP}) \leq -2.65$ eV, and even more preferably $E^{LUMO}(H^{BP}) \leq -2.70$ eV. The LUMO is the lowest unoccupied molecular orbital. The energy of the LUMO is determined as described in a later subchapter of this text.

A bipolar host $H^{BP}$ exhibiting high hole mobility in the context of the present invention preferably has a HOMO energy $E^{HOMO}(H^{BP})$ equal to or higher than -6.30 eV ($E^{HOMO}(H^{BP}) \geq -6.30$ eV), preferably $E^{HOMO}(H^{BP}) \geq -5.90$ eV, more preferably $E^{HOMO}(H^{BP}) \geq -5.70$ eV and still even more preferably $E^{HOMO}(H^{BP}) \geq -5.40$ eV. The HOMO is the highest occupied molecular orbital. The energy of the HOMO is determined as described in a later subchapter of this text.

In one embodiment of the invention, a bipolar host material $H^{BP}$, preferably each bipolar host material $H^{BP}$, fulfills both of the following requirements:

(i) it has a LUMO energy $E^{LUMO}(H^{BP})$ equal to or smaller than -2.50 eV ($E^{LUMO}(H^{BP}) \leq -2.50$ eV), preferably $E^{LUMO}(H^{BP}) \leq -2.60$ eV, more preferably $E^{LUMO}(H^{BP}) \leq$ - 2.65 eV, and even more preferably $E^{LUMO}(H^{BP}) \leq -2.70$ eV; and
(ii) it has a HOMO energy $E^{HOMO}(H^{BP})$ equal to or higher than -6.30 eV ($E^{HOMO}(H^{BP}) \geq -6.30$ eV), preferably $E^{HOMO}(H^{BP}) \geq -5.90$ eV, more preferably $E^{HOMO}(H^{BP}) \geq$ _ 5.70 eV, and still even more preferably $E^{HOMO}(H^{BP}) \geq -5.40$ eV.

The person skilled in the art knows which materials are suitable host materials for use in organic electroluminescent devices such as those of the present invention. See for example: Y. Tao, C. Yang, J. Quin, Chemical Society Reviews 2011, 40, 2943, DOI: 10.1039/C0CS00160K; K.S. Yook, J.Y. Lee, The Chemical Record 2015, 16(1), 159, DOI: 10.1002/tcr.201500221; T. Chatterjee, K.-T. Wong, Advanced Optical Materials 2018, 7(1), 1800565, DOI: 10.1002/adom.201800565; Q. Wang, Q.-S. Tian, Y.-L. Zhang, X. Tang, L.-S. Liao, Journal of Materials Chemistry C 2019, 7, 11329, DOI: 10.1039/C9TC03092A.

Furthermore, for example, US2006006365 (A1), US2006208221 (A1), US2005069729 (A1), EP1205527 (A1), US2009302752 (A1), US20090134784 (A1), US2009302742 (A1), US2010187977 (A1), US2010187977 (A1), US2012068170 (A1), US2012097899 (A1), US2006121308 (A1), US2006121308 (A1), US2009167166 (A1), US2007176147 (A1), US2015322091 (A1), US2011105778 (A1), US2011201778 (A1), US2011121274 (A1), US2009302742 (A1), US2010187977 (A1), US2010244009 (A1), US2009136779 (A1), EP2182040 (A2), US2012202997 (A1), US2019393424 (A1), US2019393425 (A1), US2020168819 (A1), US2020079762 (A1), and US2012292576 (A1) disclose host materials that may be used in organic electroluminescent devices according to the present invention. It is understood that this does not imply that the present invention only refers to organic electroluminescent devices comprising host materials disclosed in the cited references. It is also understood that any host materials used in the state of the art may also be suitable host materials $H^B$ in the context of the present invention.

In a preferred embodiment of the invention, each light-emitting layer B of the organic electroluminescent device according to the invention comprises one or more p-hosts $H^P$. In one embodiment of the invention, each light-emitting layer B of the organic electroluminescent device according to the invention comprises only a single host material $H^B$ and this host material is a p-host $H^P$.

In one embodiment of the invention, each light-emitting layer B of the organic electroluminescent device according to the invention comprises one or more n-hosts $H^N$. In another embodiment of the invention, each light-emitting layer B of the organic electroluminescent device according to the invention comprises only a single host material $H^B$ and this host material is an n-host $H^N$.

In one embodiment of the invention, each light-emitting layer B of the organic electroluminescent device according to the invention comprises one or more bipolar hosts $H^{BP}$. In one embodiment of the invention, each light-emitting layer B of the organic electroluminescent device according to the invention comprises only a single host material $H^B$ and this host material is a bipolar host $H^{BP}$.

In another embodiment of the invention, at least one light-emitting layer B of the organic electroluminescent device according to the invention comprises at least two different host materials $H^B$. In this case, the more than one host materials $H^B$ present in the respective light-emitting layer B may either all be p-hosts $H^P$ or all be n-hosts $H^N$, or all be bipolar hosts $H^{BP}$, but may also be a combination thereof.

It is understood that, if an organic electroluminescent device according to the invention comprises more than one light-emitting layers B, any of them may, independently of the one or more other light-emitting layers B, comprise either one host material $H^B$ or more than one host materials $H^B$ for which the above-mentioned definitions apply. It is further understood that different light-emitting layers B comprised in an organic electroluminescent device according to the invention do not necessarily all comprise the same materials or even the same materials in the same concentrations or ratios.

It is understood that, if a light-emitting layer B of the organic electroluminescent device according to the invention is composed of more than one sublayers, any of them may, independently of the one or more other sublayers, comprise either one host material $H^B$ or more than one host materials $H^B$ for which the above-mentioned definitions apply. It is further understood that different sublayers of a light-emitting layer B comprised in an organic electroluminescent device according to the invention do not necessarily all comprise the same materials or even the same materials in the same concentrations or ratios.

If comprised in the same light-emitting layer B of the organic electroluminescent device according to the invention, at least one p-host $H^P$ and at least one n-host $H^N$ may optionally form an exciplex. The person skilled in the art knows how to choose pairs of $H^P$ and $H^N$, which form an exciplex and the selection criteria, including HOMO- and/or LUMO-energy level requirements of $H^P$ and $H^N$. This is to say that, in case exciplex formation may be aspired, the highest occupied molecular orbital (HOMO) of the p-host material $H^P$ may be at least 0.20 eV higher in energy than the HOMO of the n-host material $H^N$ and the lowest unoccupied molecular orbital (LUMO) of the p-host material $H^P$ may be at least 0.20 eV higher in energy than the LUMO of the n-host material $H^N$.

In a preferred embodiment of the invention, at least one host material $H^B$ (e.g., $H^P$, $H^N$, and/or $H^{BP}$) is an organic host material, which, in the context of the invention, means that it does not contain any transition metals. In a preferred

embodiment of the invention, all host materials $H^B$ ($H^P$, $H^N$, and/or $H^{BP}$) in the electroluminescent device of the present invention are organic host materials, which, in the context of the invention, means that they do not contain any transition metals. Preferably, at least one host material $H^B$, more preferably all host materials $H^B$ ($H^P$, $H^N$ and/or $H^{BP}$) predominantly consist of the elements hydrogen (H), carbon (C), and nitrogen (N), but may for example also comprise oxygen (O), boron (B), silicon (Si), fluorine (F), and bromine (Br).

In one embodiment of the invention, each host material $H^B$ is a p-host $H^P$.

In one embodiment of the organic electroluminescent device according to the present invention, in at least one, preferably each, light-emitting layer B, each host material $H^B$ is a p-host $H^P$.

In a preferred embodiment of the invention, a p-host $H^P$, optionally comprised in any of the one or more light-emitting layers B as a whole (consisting of one (sub)layer or comprising more than one sublayers), comprises or consists of:

- one first chemical moiety, comprising or consisting of a structure according to any of the formulas $H^P$-I, $H^P$-II, $H^P$-III, $H^P$-IV, $H^P$-V, $H^P$-VI, $H^P$-VII, $H^P$-VIII, $H^P$-IX, and $H^P$-X:

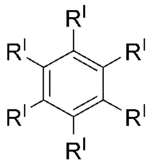

Formula $H^P$-I

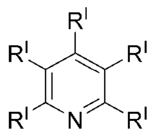

Formula $H^P$-II

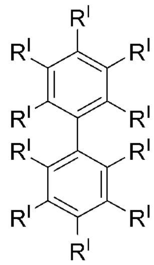

Formula $H^P$-III

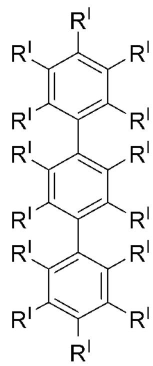

Formula $H^P$-IV

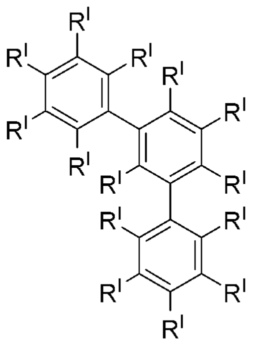

Formula $H^P$-V

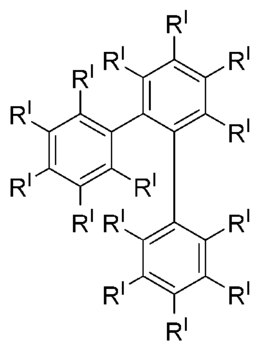

Formula $H^P$-VI

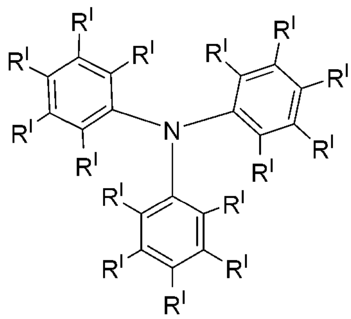

Formula $H^P$-VII

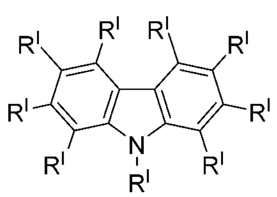

Formula $H^P$-VIII

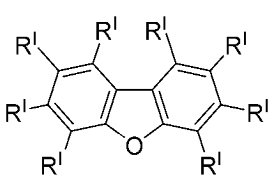

Formula $H^P$-IX

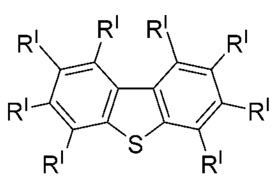

Formula $H^P$-X

and

- one or more second chemical moieties, each comprising or consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX:

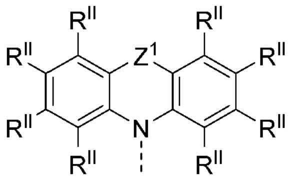

Formula $H^P$-XI

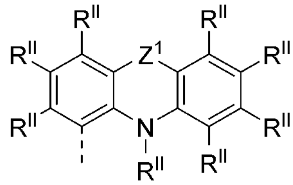

Formula $H^P$-XII

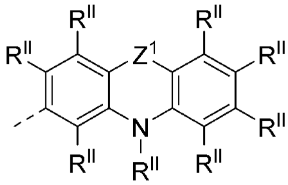

Formula $H^P$-XIII

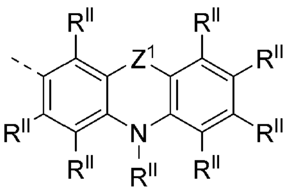

Formula $H^P$-XIV

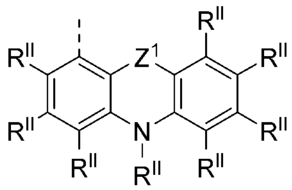

Formula $H^P$-XV

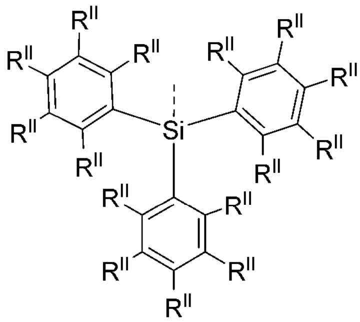

Formula $H^P$-XVI

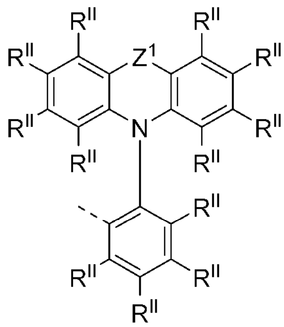

Formula $H^P$-XVII

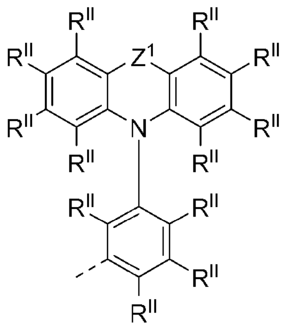

Formula $H^P$-XVIII

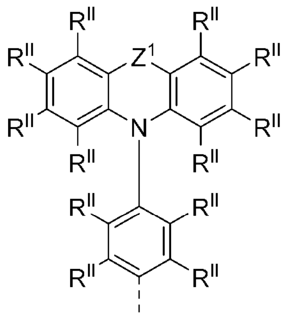

Formula $H^P$-XIX,

wherein each of the one or more second chemical moieties which is present in the p-host material $H^P$ is linked to the first chemical moiety via a single bond which is represented in the formulas above by a dashed line; wherein

$Z^1$ is at each occurrence independently of each other selected from the group consisting of a direct bond, $C(R^{II})_2$, $C=C(R^{II})_2$, C=O, $C=NR^{II}$, $NR^{II}$, O, $Si(R^{II})_2$, S, S(O) and $S(O)_2$;

$R^I$ is at each occurrence independently of each other a binding site of a single bond linking the first chemical moiety to a second chemical moiety or is selected from the group consisting of: hydrogen, deuterium, Me, $^i$Pr, and $^t$Bu, and

Ph, which is optionally substituted with one or more substituents independently of each other selected from the group consisting of: Me, $^i$Pr, $^t$Bu, and Ph;

wherein at least one $R^I$ is a binding site of a single bond linking the first chemical moiety to a second chemical moiety;

$R^{II}$ is at each occurrence independently of each other selected from the group consisting of: hydrogen, deuterium, Me, $^i$Pr, $^t$Bu, and

Ph, which is optionally substituted with one or more substituents independently of each other selected from the group consisting of: Me, $^i$Pr, $^t$Bu, and Ph;

wherein two or more adjacent substituents $R^{II}$ may optionally form a mono- or polycyclic, aliphatic or aromatic or heteroaromatic, carbo- or heterocyclic ring system so that the fused ring system consisting of a structure according to any of formulas $H^P$-XI, $H^P$-XII, $H^P$-XIII, $H^P$-XIV, $H^P$-XV, $H^P$-XVI, $H^P$-XVII, $H^P$-XVIII, and $H^P$-XIX as well as the additional rings optionally formed by adjacent substituents $R^{II}$ comprises in total 8-60 carbon atoms preferably 12-40 carbon atoms, more preferably 14-32 carbon atoms.

In an even more preferred embodiment of the invention, $Z^1$ is at each occurrence a direct bond and adjacent substituents $R^{II}$ do not combine to form an additional ring system.

In a still even more preferred embodiment of the invention, a p-host $H^P$ optionally comprised in the organic electroluminescent device according to the invention is selected from the group consisting of the following structures:

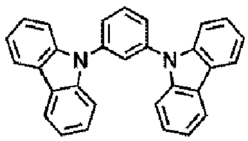
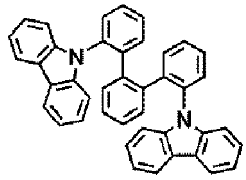
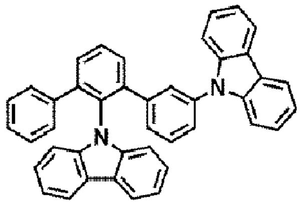
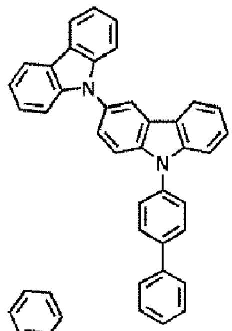
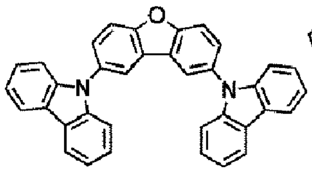
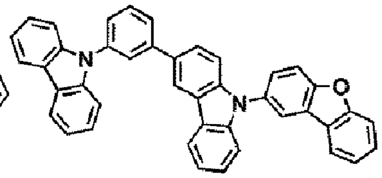
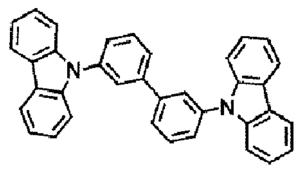
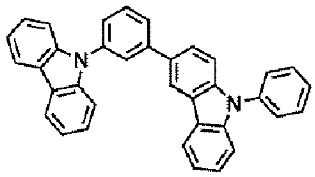
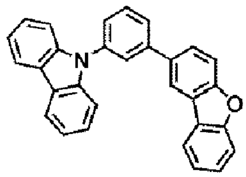
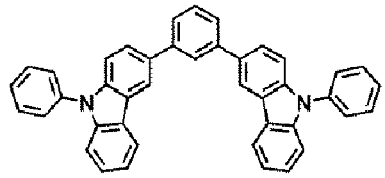
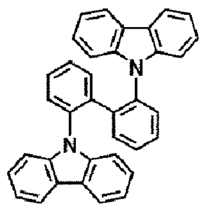
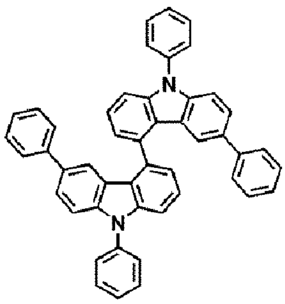
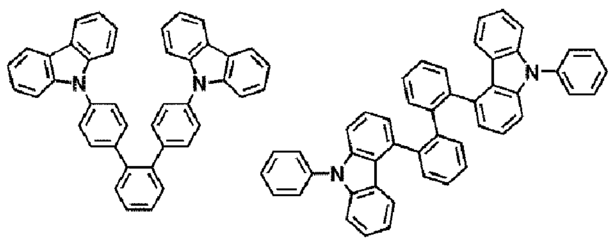
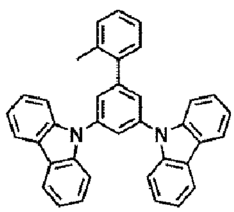
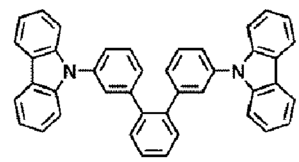
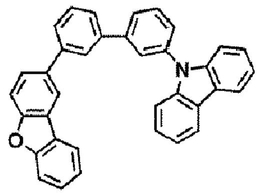
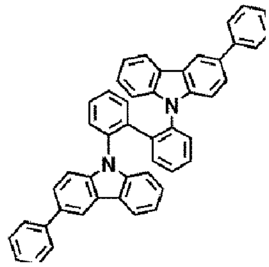
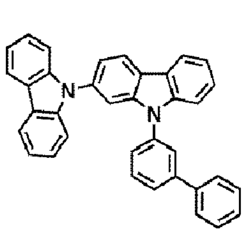
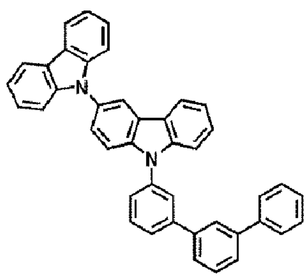
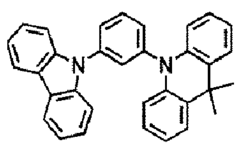
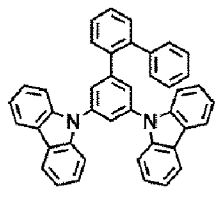

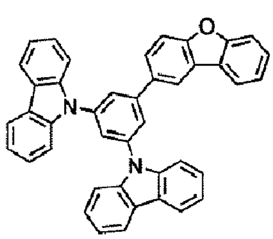
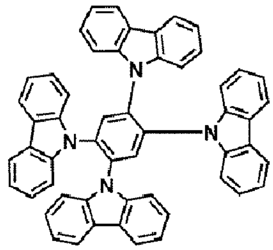
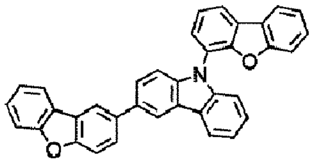
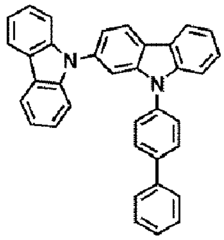

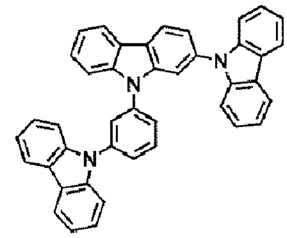
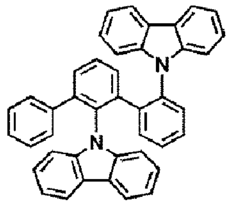
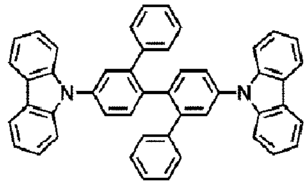
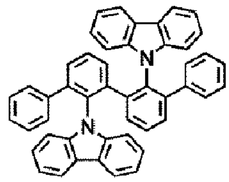

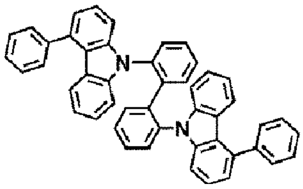
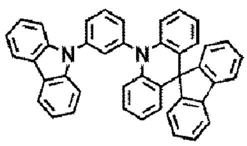
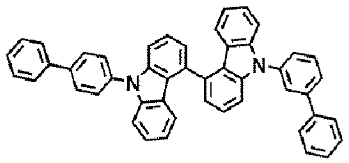

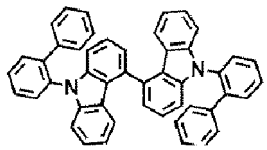
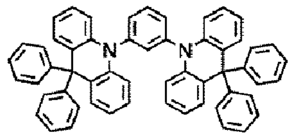
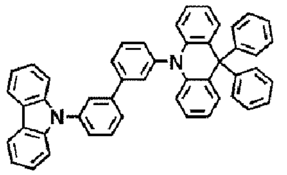

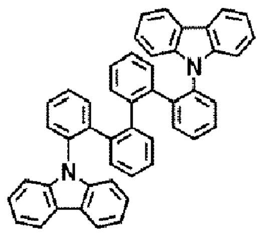
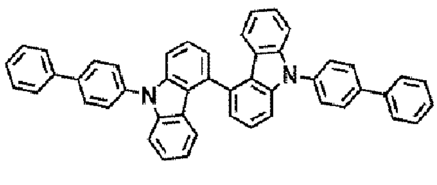
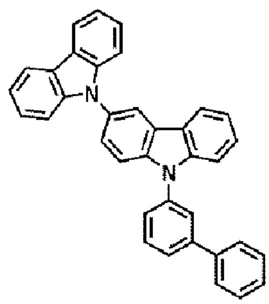

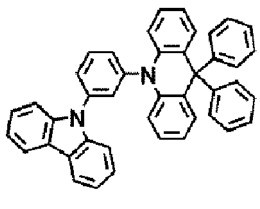
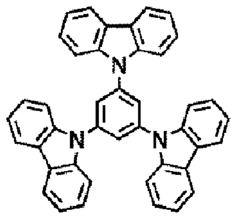
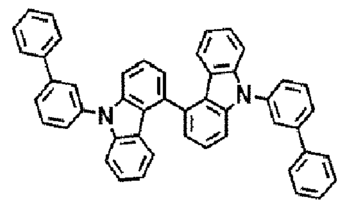

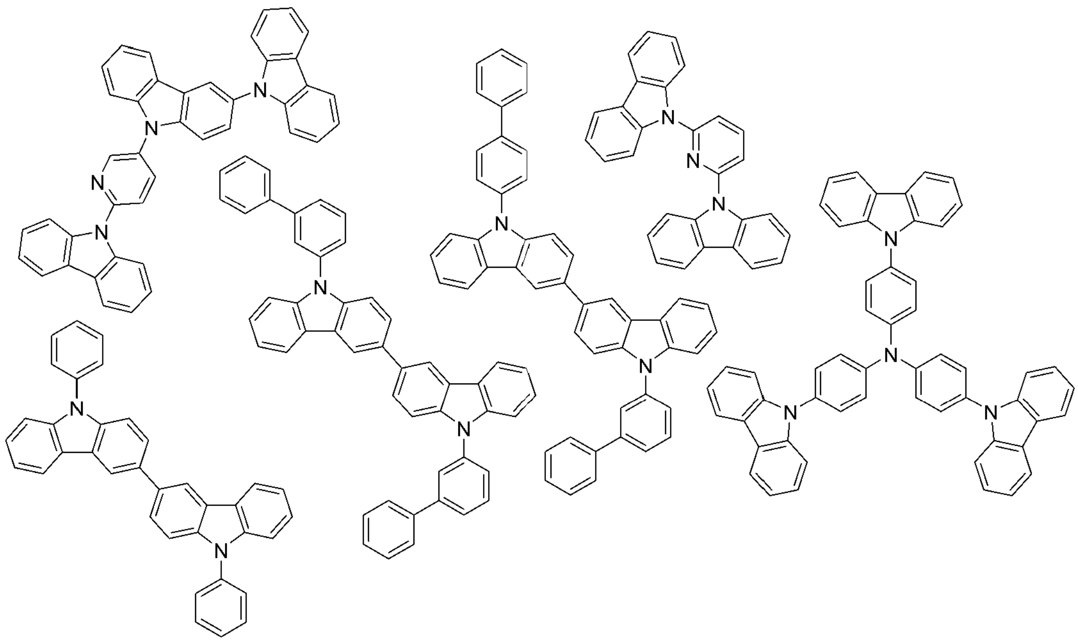

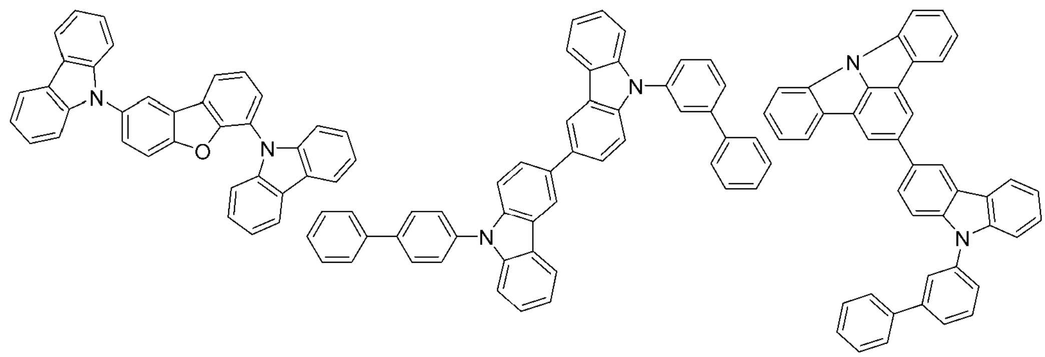

In a preferred embodiment of the invention, an n-host $H^N$ optionally comprised in any of the one or more light-emitting layers B as a whole (consisting of one (sub)layer or comprising more than one sublayers) comprises or consists of a structure according to any of the formulas $H^N$-I, $H^N$-II, and $H^N$-III:

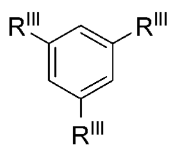

Formula $H^N$-I

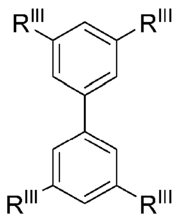

Formula $H^N$-II

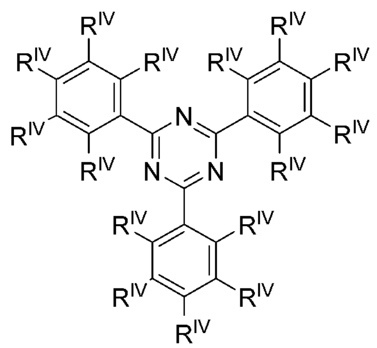

Formula $H^N$-III,

wherein $R^{III}$ and $R^{IV}$ are at each occurrence independently of each other selected from the group consisting of: hydrogen, deuterium, Me, $^i$Pr, $^t$Bu, CN, $CF_3$,

Ph, which is optionally substituted with one or more substituents independently of each other selected from the group consisting of: Me, $^i$Pr, $^t$Bu, and Ph; and

a structure represented by any of the formulas $H^N$-IV, $H^N$-V, $H^N$-VI, $H^N$-VII, $H^N$-VIII, $H^N$-IX, $H^N$-X, $H^N$-XI, $H^N$-XII,

$H^N$-XIII, and $H^N$-XIV:

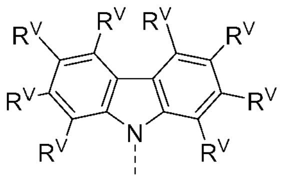
Formula $H^N$-IV

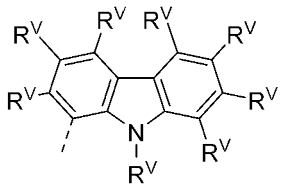
Formula $H^N$-V

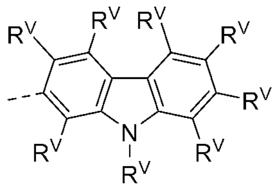
Formula $H^N$-VI

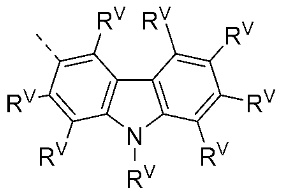
Formula $H^N$-VII

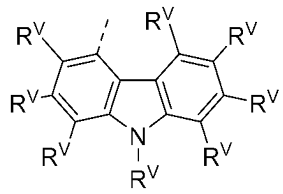
Formula $H^N$-VIII

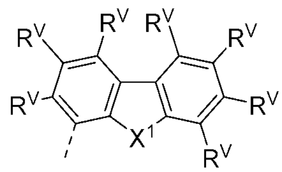
Formula $H^N$-IX

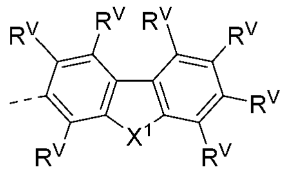
Formula $H^N$-X

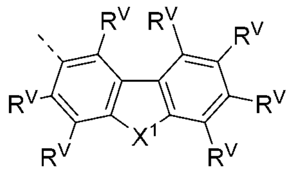
Formula $H^N$-XI

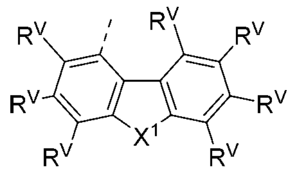
Formula $H^N$-XII

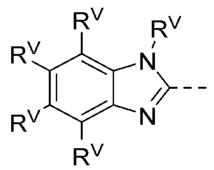
Formula $H^N$-XIII

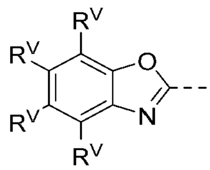
Formula $H^N$-XIV,

wherein
the dashed line indicates the binding site of a single bond connecting the structure according to any of formulas $H^N$-IV, $H^N$-V, $H^N$-VI, $H^N$-VII, $H^N$-VIII, $H^N$-IX, $H^N$-X, $H^N$-XI, $H^N$-XII, $H^N$-XIII, and $H^N$-XIV to a structure according to any of the formulas $H^N$-I, $H^N$-II, and $H^N$-III;
$X^1$ is oxygen (O), sulfur (S) or $C(R^V)_2$;
$R^V$ is at each occurrence independently of each other selected from the group consisting of: hydrogen, deuterium, Me, $^i$Pr, $^t$Bu, and
Ph, which is optionally substituted with one or more substituents independently of each other selected from the group consisting of: Me, $^i$Pr, $^t$Bu, and Ph;
wherein two or more adjacent substituents $R^V$ may optionally form a mono- or polycyclic, aliphatic or aromatic or heteroaromatic, carbo- or heterocyclic ring system so that the fused ring system consisting of a structure according to any of formulas $H^N$-IV, $H^N$-V, $H^N$-VI, $H^N$-VII, $H^N$-VIII, $H^N$-IX, $H^N$-X, $H^N$-XI, $H^N$-XII, $H^N$-XIII, and $H^N$-XIV as well as the additional rings optionally formed by adjacent substituents $R^V$ comprises in total 8-60 carbon atoms, preferably 12-40 carbon atoms, more preferably 14-32 carbon atoms; and
wherein in formulas $H^N$-I and $H^N$-II, at least one substituent $R^{III}$ is CN.

In an even more preferred embodiment of the invention, an n-host $H^N$ optionally comprised in the organic electroluminescent device according to the invention is selected from the group consisting of the following structures:

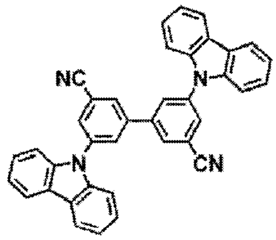
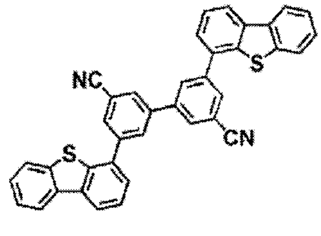
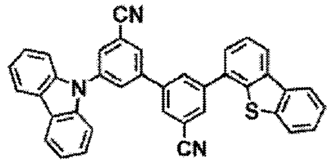

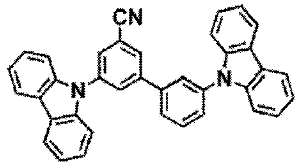
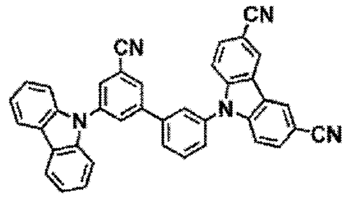
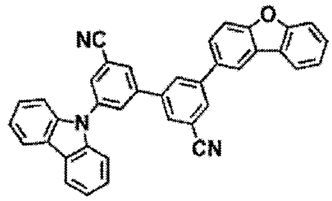

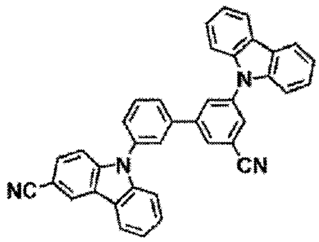
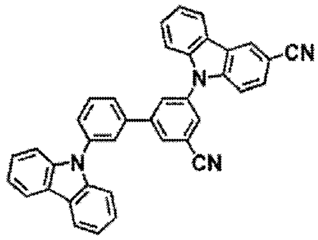

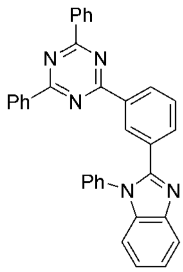
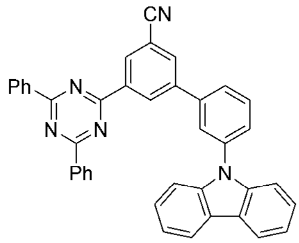
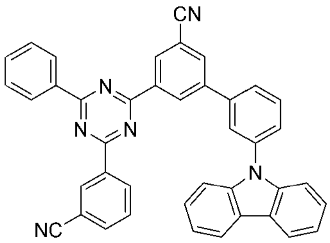
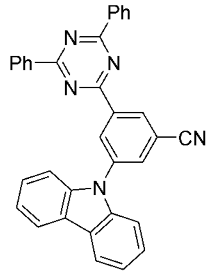
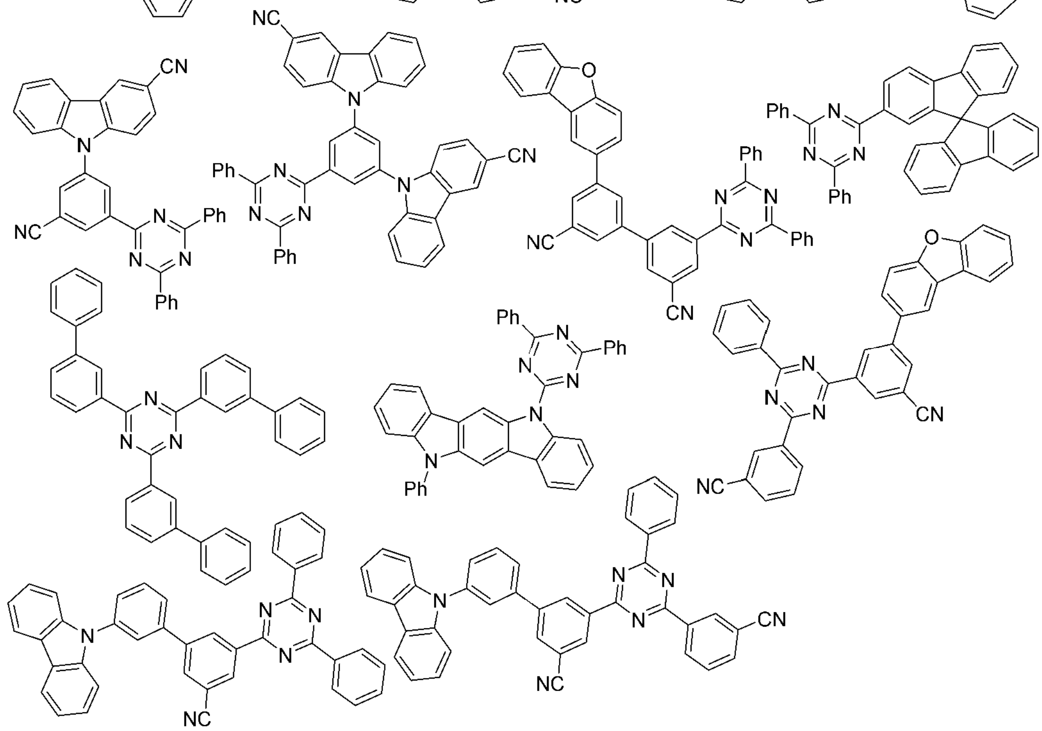
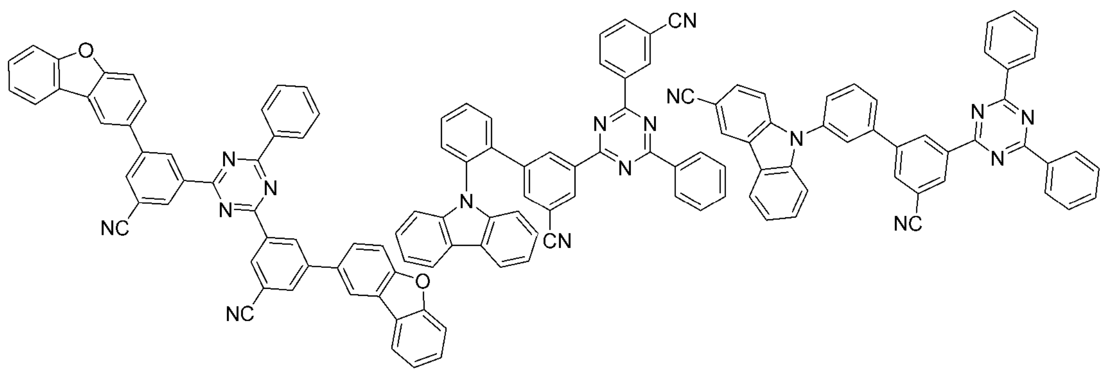

In one embodiment of the invention, no n-host $H^N$ comprised in any light-emitting layer B of the organic electroluminescent device according to the invention contains any phosphine oxide groups and, in particular, no n-host $H^N$ is bis[2-(diphenylphosphino)phenyl] ether oxide (DPEPO).

*HOMO-, LUMO-energy relations*

As stated previously, the present invention relates to an organic electroluminescent device comprising one or more light-emitting layers B , each being composed of one or more sublayers, wherein the one or more sublayers are adjacent to each other and as a whole comprise:

(i) one or more excitation energy transfer components EET-1, each having a highest occupied molecular orbital HOMO(EET-1) with an energy $E^{HOMO}$(EET-1) and a lowest unoccupied molecular orbital LUMO(EET-1) with an energy $E^{LUMO}$(EET-1); and

(ii) one or more hole scavengers $H_{scav}$, each having a highest occupied molecular orbital HOMO($H_{scav}$) with an energy $E^{HOMO}(H_{scav})$ and a lowest unoccupied molecular orbital LUMO($H_{scav}$) with an energy $E^{LUMO}(H_{scav})$; and

(iii) one or more small full width at half maximum (FWHM) emitters $S^B$, each having a highest occupied molecular orbital HOMO($S^B$) with an energy $E^{HOMO}(S^B)$, and a lowest unoccupied molecular orbital LUMO($S^B$) with an energy $E^{LUMO}(S^B)$, wherein each $S^B$ emits light with an FWHM) of less than or equal to 0.25 eV; and optionally

(iv) one or more host materials $H^B$, each having a highest occupied molecular orbital HOMO($H^B$) with an energy $E^{HOMO}(H^B)$, and a lowest unoccupied molecular orbital LUMO($H^B$) with an energy $E^{LUMO}(H^B)$,

wherein the one or more sublayers which are located at the outer surface of each light-emitting layer B contain at least one material selected from the group consisting of EET-1, $H_{scav}$, and small FWHM emitter $S^B$, and wherein the relations expressed by the following formulas (1) to (6), as far as the respective components are comprised in the same light-emitting layer B, apply:

$$E^{LUMO}(EET\text{-}1) < E^{LUMO}(H^B) \qquad (1)$$

$$E^{LUMO}(EET\text{-}1) < E^{LUMO}(H_{scav}) \qquad (2)$$

$$E^{LUMO}(EET\text{-}1) < E^{LUMO}(S^B) \qquad (3)$$

$$E^{HOMO}(H_{scav}) \geq E^{HOMO}(H^B) \qquad (4)$$

$$E^{HOMO}(H_{scav}) \geq E^{HOMO}(EET\text{-}1) \qquad (5)$$

$$E^{HOMO}(H_{scav}) \geq E^{HOMO}(S^B) \qquad (6).$$

In one embodiment, the aforementioned relations expressed by formulas (1) to (6), as far as the respective components are comprised in the same light-emitting layer B, also apply to materials comprised in any of one or more light-emitting layers B of the organic electroluminescent device according to the invention.

In one embodiment of the invention, the highest occupied molecular orbital HOMO($S^B$) of at least one, preferably each, small full width at half maximum (FWHM) emitter $S^B$ having an energy $E^{HOMO}(S^B)$ is higher in energy than the highest occupied molecular orbital HOMO($H^B$) of at least one, preferably each, host material $H^B$ having an energy $E^{HOMO}(H^B)$:

$$E^{HOMO}(S^B) > E^{HOMO}(H^B).$$

In one embodiment of the invention, in at least one of the one or more light-emitting layers B, the highest occupied molecular orbital HOMO($S^B$) of at least one, preferably each, small full width at half maximum (FWHM) emitter $S^B$ having an energy $E^{HOMO}(S^B)$ is higher in energy than the highest occupied molecular orbital HOMO($H^B$) of at least one, preferably each, host material $H^B$ having an energy $E^{HOMO}(H^B)$.

$$E^{HOMO}(S^B) > E^{HOMO}(H^B).$$

In one embodiment of the invention, in each of the one or more light-emitting layers B, the highest occupied molecular orbital HOMO($S^B$) of at least one, preferably each, small full width at half maximum (FWHM) emitter $S^B$ having an energy $E^{HOMO}(S^B)$ is higher in energy than the highest occupied molecular orbital HOMO($H^B$) of at least one, preferably each, host material $H^B$ having an energy $E^{HOMO}(H^B)$:

$$E^{HOMO}(S^B) > E^{HOMO}(H^B).$$

In one embodiment of the invention, the highest occupied molecular orbital HOMO($S^B$) of at least one, preferably each, small full width at half maximum (FWHM) emitter $S^B$ having an energy $E^{HOMO}(S^B)$ is higher in energy than the highest occupied molecular orbital HOMO(EET-1) of at least one, preferably each, excitation energy transfer component EET-1 having an energy $E^{HOMO}(EET\text{-}1)$:

$$E^{HOMO}(S^B) > E^{HOMO}(EET\text{-}1).$$

In one embodiment of the invention, in at least one of the one or more light-emitting layers B, the highest occupied molecular orbital HOMO($S^B$) of at least one, preferably each, small full width at half maximum (FWHM) emitter $S^B$ having an energy $E^{HOMO}(S^B)$ is higher in energy than the highest occupied molecular orbital HOMO(EET-1) of at least one, preferably each, excitation energy transfer component EET-1 having an energy $E^{HOMO}$(EET-1):

$$E^{HOMO}(S^B) > E^{HOMO}(EET\text{-}1).$$

In one embodiment of the invention, in each of the one or more light-emitting layers B, the highest occupied molecular orbital HOMO($S^B$) of at least one, preferably each, small full width at half maximum (FWHM) emitter $S^B$ having an energy $E^{HOMO}(S^B)$ is higher in energy than the highest occupied molecular orbital HOMO(EET-1) of at least one, preferably each, excitation energy transfer component EET-1 having an energy $E^{HOMO}$(EET-1):

$$E^{HOMO}(S^B) > E^{HOMO}(EET\text{-}1).$$

In one embodiment of the invention, the highest occupied molecular orbital HOMO($H_{scav}$) of the at least one, preferably each, hole scavenger $H_{scav}$ having an energy $E^{HOMO}(H_{scav})$ is higher in energy than the highest occupied molecular orbital HOMO(EET-1) of the at least one, preferably each, excitation energy transfer component EET-1 having an energy $E^{HOMO}$(EET-1):

$$E^{HOMO}(H_{scav}) > E^{HOMO}(EET\text{-}1).$$

In one embodiment of the invention, in at least one of the one or more light-emitting layers B, the highest occupied molecular orbital HOMO($H_{scav}$) of at least one, preferably each, hole scavenger $H_{scav}$ having an energy $E^{HOMO}(H_{scav})$ is higher in energy than the highest occupied molecular orbital HOMO(EET-1) of at least one, preferably each, excitation energy transfer component EET-1 having an energy $E^{HOMO}$(EET-1):

$$E^{HOMO}(H_{scav}) > E^{HOMO}(EET\text{-}1).$$

In one embodiment of the invention, in each of the one or more light-emitting layers B, the highest occupied molecular orbital HOMO($H_{scav}$) of at least one, preferably each, hole scavenger $H_{scav}$ having an energy $E^{HOMO}(H_{scav})$ is higher in energy than the highest occupied molecular orbital HOMO(EET-1) of at least one, preferably each, excitation energy transfer component EET-1 having an energy $E^{HOMO}$(EET-1):

$$E^{HOMO}(H_{scav}) > E^{HOMO}(EET\text{-}1).$$

In one embodiment of the invention, the highest occupied molecular orbital HOMO($H_{scav}$) of at least one, preferably each, hole scavenger $H_{scav}$ having an energy $E^{HOMO}(H_{scav})$ is higher in energy than the highest occupied molecular orbital HOMO($H^B$) of at least one, preferably each, host material $H^B$ having an energy $E^{HOMO}(H^B)$:

$$E^{HOMO}(H_{scav}) > E^{HOMO}(H^B).$$

In one embodiment of the invention, in at least one of the one or more light-emitting layers B, the highest occupied molecular orbital HOMO($H_{scav}$) of at least one, preferably each, hole scavenger $H_{scav}$ having an energy $E^{HOMO}(H_{scav})$ is higher in energy than the highest occupied molecular orbital HOMO($H^B$) of at least one, preferably each, host material $H^B$ having an energy $E^{HOMO}(H^B)$:

$$E^{HOMO}(H_{scav}) > E^{HOMO}(H^B).$$

In one embodiment of the invention, in each of the one or more light-emitting layers B, the highest occupied molecular orbital HOMO($H_{scav}$) of at least one, preferably each, hole scavenger $H_{scav}$ having an energy $E^{HOMO}(H_{scav})$ is higher in energy than the highest occupied molecular orbital HOMO($H^B$) of at least one, preferably each, host material $H^B$ having an energy $E^{HOMO}(H^B)$:

$$E^{HOMO}(H_{scav}) > E^{HOMO}(H^B).$$

In one embodiment of the invention, the highest occupied molecular orbital HOMO($H_{scav}$) of at least one, preferably each, hole scavenger $H_{scav}$ having an energy $E^{HOMO}(H_{scav})$ is higher in energy than the highest occupied molecular orbital HOMO($S^B$) of at least one, preferably each, small full width at half maximum (FWHM) emitter $S^B$ having an energy $E^{HOMO}(S^B)$:

$$E^{HOMO}(H_{scav}) > E^{HOMO}(S^B).$$

In one embodiment of the invention, in at least one of the one or more light-emitting layers B, the highest occupied molecular orbital HOMO($H_{scav}$) of at least one, preferably each, hole scavenger $H_{scav}$ having an energy $E^{HOMO}(H_{scav})$ is higher in energy than the highest occupied molecular orbital HOMO($S^B$) of at least one, preferably each, small full width at half maximum (FWHM) emitter $S^B$ having an energy $E^{HOMO}(S^B)$:

$$E^{HOMO}(H_{scav}) > E^{HOMO}(S^B).$$

In one embodiment of the invention, in each of the one or more light-emitting layers B, the highest occupied molecular orbital HOMO($H_{scav}$) of at least one, preferably each, hole scavenger $H_{scav}$ having an energy $E^{HOMO}(H_{scav})$ is higher in energy than the highest occupied molecular orbital HOMO($S^B$) of at least one, preferably each, small full width at half maximum (FWHM) emitter $S^B$ having an energy $E^{HOMO}(S^B)$:

$$E^{HOMO}(H_{scav}) > E^{HOMO}(S^B).$$

In one embodiment of the invention, the highest occupied molecular orbital HOMO(EET-1) of at least one, preferably each, excitation energy transfer component EET-1 is equal in energy to or lower in energy than the highest occupied molecular orbital HOMO($S^B$) of at least one, preferably each, small FWHM emitter $S^B$:

$$E^{HOMO}(EET\text{-}1) \leq E^{HOMO}(S^B).$$

In one embodiment of the invention, in at least one of the one or more light-emitting layers B, the highest occupied molecular orbital HOMO(EET-1) of at least one, preferably each, excitation energy transfer component EET-1 is equal in energy to or lower in energy than the highest occupied molecular orbital HOMO($S^B$) of at least one, preferably each, small FWHM emitter $S^B$:

$$E^{HOMO}(EET\text{-}1) \leq E^{HOMO}(S^B).$$

In one embodiment of the invention, in each of the one or more light-emitting layers B, the highest occupied molecular orbital HOMO(EET-1) of at least one, preferably each, excitation energy transfer component EET-1 is equal in energy to or lower in energy than the highest occupied molecular orbital HOMO($S^B$) of at least one, preferably each, small FWHM emitter $S^B$:

$$E^{HOMO}(EET\text{-}1) \leq E^{HOMO}(S^B).$$

In a preferred embodiment of the invention, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO($S^B$) of at least one, preferably each, small full width at half maximum (FWHM) emitter $S^B$ having an energy $E^{HOMO}(S^B)$ is larger than 0.0 eV and smaller than 0.3 eV:

$$0.0\ eV < E^{HOMO}(H_{scav}) - E^{HOMO}(S^B) < 0.8\ eV.$$

In a preferred embodiment of the invention, in at least one of the one or more light-emitting layers B, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO($S^B$) of at least one, preferably each, small full width at half maximum (FWHM) emitter $S^B$ having an energy $E^{HOMO}(S^B)$ is larger than 0.0 eV and smaller

than 0.3 eV:

$$0.0 \text{ eV} < E^{HOMO}(H_{scav}) - E^{HOMO}(S^B) < 0.8 \text{ eV}.$$

In a preferred embodiment of the invention, in each of the one or more light-emitting layers B, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO($S^B$) of at least one, preferably each, small full width at half maximum (FWHM) emitter $S^B$ having an energy $E^{HOMO}(S^B)$ is larger than 0.0 eV and smaller than 0.3 eV:

$$0.0 \text{ eV} < E^{HOMO}(H_{scav}) - E^{HOMO}(S^B) < 0.8 \text{ eV}.$$

In a preferred embodiment of the invention, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO($S^B$) of at least one, preferably each, small full width at half maximum (FWHM) emitter $S^B$ having an energy $E^{HOMO}(S^B)$ is larger than 0 eV ($E^{HOMO}(H_{scav}) - E^{HOMO}(S^B) > 0$ eV), preferably larger than 0.1 eV ($E^{HOMO}(H_{scav}) - E^{HOMO}(S^B) > 0.1$ eV) , more preferably larger than 0.2 eV ($E^{HOMO}(H_{scav}) - E^{HOMO}(S^B) > 0.2$ eV), or even larger than 0.3 eV ($E^{HOMO}(H_{scav}) - E^{HOMO}(S^B) > 0.3$ eV).

In a preferred embodiment of the invention, in at least one of the one or more light-emitting layers B, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO($S^B$) of at least one, preferably each, small full width at half maximum (FWHM) emitter $S^B$ having an energy $E^{HOMO}(S^B)$ is larger than 0 eV ($E^{HOMO}(H_{scav}) - E^{HOMO}(S^B) > 0$ eV), preferably larger than 0.1 eV ($E^{HOMO}(H_{scav}) - E^{HOMO}(S^B) > 0.1$ eV) , more preferably larger than 0.2 eV ($E^{HOMO}(H_{scav}) - E^{HOMO}(S^B) > 0.2$ eV), or even larger than 0.3 eV ($E^{HOMO}(H_{scav}) - E^{HOMO}(S^B) > 0.3$ eV).

In a preferred embodiment of the invention, in each of the one or more light-emitting layers B, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO($S^B$) of at least one, preferably each, small full width at half maximum (FWHM) emitter $S^B$ having an energy $E^{HOMO}(S^B)$ is larger than 0 eV ($E^{HOMO}(H_{scav}) - E^{HOMO}(S^B) > 0$ eV), preferably larger than 0.1 eV ($E^{HOMO}(H_{scav}) - E^{HOMO}(S^B) > 0.1$ eV) , more preferably larger than 0.2 eV ($E^{HOMO}(H_{scav}) - E^{HOMO}(S^B) > 0.2$ eV), or even larger than 0.3 eV ($E^{HOMO}(H_{scav}) - E^{HOMO}(S^B) > 0.3$ eV).

In a preferred embodiment of the invention, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO(EET-1) of at least one, preferably each, excitation energy transfer component EET-1 having an energy $E^{HOMO}$(EET-1) is larger than 0 eV ($E^{HOMO}(H_{scav}) - E^{HOMO}$(EET-1) > 0 eV), preferably larger than 0.1 eV ($E^{HOMO}(H_{scav}) - E^{HOMO}$(EET-1) > 0.1 eV), more preferably larger than 0.2 eV ($E^{HOMO}(H_{scav}) - E^{HOMO}$(EET-1) > 0.2 eV), more preferably larger than 0.3 eV ($E^{HOMO}(H_{scav}) - E^{HOMO}$(EET-1) > 0.3 eV), even more preferably larger than 0.4 eV ($E^{HOMO}(H_{scav}) - E^{HOMO}$(EET-1) > 0.4 eV), in particular larger than 0.5 eV ($E^{HOMO}(H_{scav}) - E^{HOMO}$(EET-1) > 0.5 eV).

In a preferred embodiment of the invention, in at least one of the one or more light-emitting layers B, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO(EET-1) of at least one, preferably each, excitation energy transfer component EET-1 having an energy $E^{HOMO}$(EET-1) is larger than 0 eV ($E^{HOMO}(H_{scav})$ - $E^{HOMO}$(EET-1) > 0 eV), preferably larger than 0.1 eV ($E^{HOMO}(H_{scav}) - E^{HOMO}$(EET-1) > 0.1 eV), more preferably larger than 0.2 eV ($E^{HOMO}(H_{scav}) - E^{HOMO}$(EET-1) > 0.2 eV), more preferably larger than 0.3 eV ($E^{HOMO}(H_{scav}) - E^{HOMO}$(EET-1) > 0.3 eV), even more preferably larger than 0.4 eV ($E^{HOMO}(H_{scav}) - E^{HOMO}$(EET-1) > 0.4 eV), in particular larger than 0.5 eV ($E^{HOMO}(H_{scav}) - E^{HOMO}$(EET-1) > 0.5 eV).

In a preferred embodiment of the invention, in each of the one or more light-emitting layers B, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO(EET-1) of at least one, preferably each, excitation energy transfer component EET-1 having an energy $E^{HOMO}$(EET-1) is larger than 0 eV ($E^{HOMO}(H_{scav})$ - $E^{HOMO}$(EET-1) > 0 eV), preferably larger than 0.1 eV ($E^{HOMO}(H_{scav}) - E^{HOMO}$(EET-1) > 0.1 eV), more preferably larger than 0.2 eV ($E^{HOMO}(H_{scav}) - E^{HOMO}$(EET-1) > 0.2 eV), more preferably larger than 0.3 eV ($E^{HOMO}(H_{scav}) - E^{HOMO}$(EET-1) > 0.3 eV), even more preferably larger than 0.4 eV ($E^{HOMO}(H_{scav}) - E^{HOMO}$(EET-1) > 0.4 eV), in particular larger than 0.5 eV ($E^{HOMO}(H_{scav}) - E^{HOMO}$(EET-1) > 0.5 eV).

In a preferred embodiment of the invention, the difference in energy between the highest occupied molecular orbital HOMO($H_{scav}$) of at least one, preferably each, hole scavenger $H_{scav}$ having an energy $E^{HOMO}(H_{scav})$ and the highest occupied molecular orbital HOMO($H^B$) of at least one, preferably each, host material $H^B$ having an energy $E^{HOMO}(H^B)$ is larger than 0 eV ($E^{HOMO}(H_{scav}) - E^{HOMO}(H^B) > 0$ eV), preferably larger than 0.1 eV ($E^{HOMO}(H_{scav}) - E^{HOMO}(H^B) > 0.1$

eV), more preferably larger than 0.2 eV ($E^{HOMO}(H_{scav})$ - $E^{HOMO}(H^B)$ > 0.2 eV), more preferably larger than 0.3 eV ($E^{HOMO}(H_{scav})$ - $E^{HOMO}(H^B)$ > 0.3 eV), even more preferably larger than 0.4 eV ($E^{HOMO}(H_{scav})$ - $E^{HOMO}(H^B)$ > 0.4 eV), in particular larger than 0.5 eV ($E^{HOMO}(H_{scav})$ - $E^{HOMO}(H^B)$ > 0.5 eV).

In a preferred embodiment of the invention, in at least one of the one or more light-emitting layers B, the difference in energy between the highest occupied molecular orbital HOMO($H_{scav}$) of at least one, preferably each, hole scevenger $H_{scav}$ having an energy $E^{HOMO}(H_{scav})$ and the highest occupied molecular orbital HOMO($H^B$) of at least one, preferably each, host material $H^B$ having an energy $E^{HOMO}(H^B)$ is larger than 0 eV ($E^{HOMO}(H_{scav})$ - $E^{HOMO}(H^B)$ > 0 eV), preferably larger than 0.1 eV ($E^{HOMO}(H_{scav})$ - $E^{HOMO}(H^B)$ > 0.1 eV), more preferably larger than 0.2 eV ($E^{HOMO}(H_{scav})$ - $E^{HOMO}(H^B)$ > 0.2 eV), more preferably larger than 0.3 eV ($E^{HOMO}(H_{scav})$ - $E^{HOMO}(H^B)$ > 0.3 eV), even more preferably larger than 0.4 eV ($E^{HOMO}(H_{scav})$ - $E^{HOMO}(H^B)$ > 0.4 eV), in particular larger than 0.5 eV ($E^{HOMO}(H_{scav})$ - $E^{HOMO}(H^B)$ > 0.5 eV).

In a preferred embodiment of the invention, in each of the one or more light-emitting layers B, the difference in energy between the highest occupied molecular orbital HOMO($H_{scav}$) of at least one, preferably each, hole scevenger $H_{scav}$ having an energy $E^{HOMO}(H_{scav})$ and the highest occupied molecular orbital HOMO($H^B$) of at least one, preferably each, host material $H^B$ having an energy $E^{HOMO}(H^B)$ is larger than 0 eV ($E^{HOMO}(H_{scav})$ - $E^{HOMO}(H^B)$ > 0 eV), preferably larger than 0.1 eV ($E^{HOMO}(H_{scav})$ - $E^{HOMO}(H^B)$ > 0.1 eV), more preferably larger than 0.2 eV ($E^{HOMO}(H_{scav})$ - $E^{HOMO}(H^B)$ > 0.2 eV), more preferably larger than 0.3 eV ($E^{HOMO}(H_{scav})$ - $E^{HOMO}(H^B)$ > 0.3 eV), even more preferably larger than 0.4 eV ($E^{HOMO}(H_{scav})$ - $E^{HOMO}(H^B)$ > 0.4 eV), in particular larger than 0.5 eV ($E^{HOMO}(H_{scav})$ - $E^{HOMO}(H^B)$ > 0.5 eV).

In one embodiment of the invention, the difference in energy between the lowest unoccupied molecular orbital LUMO($S^B$) of at least one, preferably each, small full width at half maximum (FWHM) emitter $S^B$ having an energy $E^{LUMO}(S^B)$ and the lowest unoccupied molecular orbital LUMO(EET-1) of at least one, preferably each, excitation energy transfer component EET-1 having an energy $E^{LUMO}$(EET-1) is larger than 0.0 eV and smaller than 0.3 eV:

$$0.0\ \text{eV} < E^{LUMO}(S^B) - E^{LUMO}(\text{EET-1}) < 0.3\ \text{eV}.$$

In one embodiment of the invention, in at least one of the one or more light-emitting layers B, the difference in energy between the lowest unoccupied molecular orbital LUMO($S^B$) of at least one, preferably each, small full width at half maximum (FWHM) emitter $S^B$ having an energy $E^{LUMO}(S^B)$ and the lowest unoccupied molecular orbital LUMO(EET-1) of at least one, preferably each, excitation energy transfer component EET-1 having an energy $E^{LUMO}$(EET-1) is larger than 0.0 eV and smaller than 0.3 eV:

$$0.0\ \text{eV} < E^{LUMO}(S^B) - E^{LUMO}(\text{EET-1}) < 0.3\ \text{eV}.$$

In one embodiment of the invention, in each of the one or more light-emitting layers B, the difference in energy between the lowest unoccupied molecular orbital LUMO($S^B$) of at least one, preferably each, small full width at half maximum (FWHM) emitter $S^B$ having an energy $E^{LUMO}(S^B)$ and the lowest unoccupied molecular orbital LUMO(EET-1) of at least one, preferably each, excitation energy transfer component EET-1 having an energy $E^{LUMO}$(EET-1) is larger than 0.0 eV and smaller than 0.3 eV:

$$0.0\ \text{eV} < E^{LUMO}(S^B) - E^{LUMO}(\text{EET-1}) < 0.3\ \text{eV}.$$

In a preferred embodiment of the invention, the difference in energy between the lowest unoccupied molecular orbital LUMO($S^B$) of at least one, preferably each, small FWHM emitter $S^B$ having an energy $E^{LUMO}(S^B)$ and the lowest unoccupied molecular orbital LUMO(EET-1) of at least one, preferably each, excitation energy transfer component EET-1 having an energy $E^{LUMO}$(EET-1) is larger than 0 eV ($E^{LUMO}(S^B)$ - $E^{LUMO}$(EET-1) > 0 eV), preferably larger than 0.1 eV ($E^{LUMO}(S^B)$ - $E^{LUMO}$(EET-1) > 0.1 eV) , more preferably larger than 0.2 eV ($E^{LUMO}(S^B)$ - $E^{LUMO}$(EET-1) > 0.2 eV), particularly preferably larger than 0.3 eV ($E^{LUMO}(S^B)$ - $E^{LUMO}$(EET-1) > 0.3 eV).

In a preferred embodiment of the invention, in at least one of the one or more light-emitting layers B, the difference in energy between the lowest unoccupied molecular orbital LUMO($S^B$) of at least one, preferably each, small FWHM emitter $S^B$ having an energy $E^{LUMO}(S^B)$ and the lowest unoccupied molecular orbital LUMO(EET-1) of at least one, preferably each, excitation energy transfer component EET-1 having an energy $E^{LUMO}$(EET-1) is larger than 0 eV ($E^{LUMO}(S^B)$ - $E^{LUMO}$(EET-1) > 0 eV), preferably larger than 0.1 eV ($E^{LUMO}(S^B)$ - $E^{LUMO}$(EET-1) > 0.1 eV), more preferably larger than 0.2 eV ($E^{LUMO}(S^B)$ - $E^{LUMO}$(EET-1) > 0.2 eV), particularly preferably larger than 0.3 eV ($E^{LUMO}(S^B)$ - $E^{LUMO}$(EET-1) > 0.3 eV).

In a preferred embodiment of the invention, in each of the one or more light-emitting layers B, the difference in energy between the lowest unoccupied molecular orbital LUMO($S^B$) of at least one, preferably each, small FWHM emitter $S^B$ having an energy $E^{LUMO}(S^B)$ and the lowest unoccupied molecular orbital LUMO(EET-1) of at least one, preferably each, excitation energy transfer component EET-1 having an energy $E^{LUMO}$(EET-1) is larger than 0 eV ($E^{LUMO}(S^B)$ -

$E^{LUMO}$(EET-1) > 0 eV), preferably larger than 0.1 eV ($E^{LUMO}(S^B)$ - $E^{LUMO}$(EET-1) > 0.1 eV) , more preferably larger than 0.2 eV ($E^{LUMO}(S^B)$ - $E^{LUMO}$(EET-1) > 0.2 eV), particularly preferably larger than 0.3 eV ($E^{LUMO}(S^B)$ - $E^{LUMO}$(EET-1) > 0.3 eV).

In a preferred embodiment of the invention, the difference in energy between the lowest unoccupied molecular orbital LUMO($H_{scav}$) of at least one, preferably each, hole scavenger $H_{scav}$ having an energy $E^{LUMO}(H_{scav})$ and the lowest unoccupied molecular orbital LUMO(EET-1) of at least one, preferably each, excitation energy transfer component EET-1 having an energy $E^{LUMO}$(EET-1) is larger than 0 eV ($E^{LUMO}(H_{scav})$ - $E^{LUMO}$(EET-1) > 0 eV), preferably larger than 0.1 eV ($E^{LUMO}(H_{scav})$ - $E^{LUMO}$(EET-1) > 0.1 eV), more preferably larger than 0.2 eV ($E^{LUMO}(H_{scav})$ - $E^{LUMO}$(EET-1) > 0.2 eV), more preferably larger than 0.3 eV ($E^{LUMO}(H_{scav})$ - $E^{LUMO}$(EET-1) > 0.3 eV), even more preferably larger than 0.4 eV ($E^{LUMO}(H_{scav})$ - $E^{LUMO}$(EET-1) > 0.4 eV), in particular larger than 0.5 eV ($E^{LUMO}(H_{scav})$ - $E^{LUMO}$(EET-1) > 0.5 eV).

In a preferred embodiment of the invention, in at least one of the one or more light-emitting layers B, the difference in energy between the lowest unoccupied molecular orbital LUMO($H_{scav}$) of at least one, preferably each, hole scavenger $H_{scav}$ having an energy $E^{LUMO}(H_{scav})$ and the lowest unoccupied molecular orbital LUMO(EET-1) of at least one, preferably each, excitation energy transfer component EET-1 having an energy $E^{LUMO}$(EET-1) is larger than 0 eV ($E^{LUMO}(H_{scav})$ - $E^{LUMO}$(EET-1) > 0 eV), preferably larger than 0.1 eV ($E^{LUMO}(H_{scav})$ - $E^{LUMO}$(EET-1) > 0.1 eV), more preferably larger than 0.2 eV ($E^{LUMO}(H_{scav})$ - $E^{LUMO}$(EET-1) > 0.2 eV), more preferably larger than 0.3 eV ($E^{LUMO}(H_{scav})$ - $E^{LUMO}$(EET-1) > 0.3 eV), even more preferably larger than 0.4 eV ($E^{LUMO}(H_{scav})$ - $E^{LUMO}$(EET-1) > 0.4 eV), in particular larger than 0.5 eV ($E^{LUMO}(H_{scav})$ - $E^{LUMO}$(EET-1) > 0.5 eV).

In a preferred embodiment of the invention, in each of the one or more light-emitting layers B, the difference in energy between the lowest unoccupied molecular orbital LUMO($H_{scav}$) of at least one, preferably each, hole scavenger $H_{scav}$ having an energy $E^{LUMO}(H_{scav})$ and the lowest unoccupied molecular orbital LUMO(EET-1) of at least one, preferably each, excitation energy transfer component EET-1 having an energy $E^{LUMO}$(EET-1) is larger than 0 eV ($E^{LUMO}(H_{scav})$ - $E^{LUMO}$(EET-1) > 0 eV), preferably larger than 0.1 eV ($E^{LUMO}(H_{scav})$ - $E^{LUMO}$(EET-1) > 0.1 eV), more preferably larger than 0.2 eV ($E^{LUMO}(H_{scav})$ - $E^{LUMO}$(EET-1) > 0.2 eV), more preferably larger than 0.3 eV ($E^{LUMO}(H_{scav})$ - $E^{LUMO}$(EET-1) > 0.3 eV), even more preferably larger than 0.4 eV ($E^{LUMO}(H_{scav})$ - $E^{LUMO}$(EET-1) > 0.4 eV), in particular larger than 0.5 eV ($E^{LUMO}(H_{scav})$ - $E^{LUMO}$(EET-1) > 0.5 eV).

In a preferred embodiment of the invention, the difference in energy between the lowest unoccupied molecular orbital LUMO($H^B$) of at least one, preferably each, host material $H^B$ having an energy $E^{LUMO}(H^B)$ and the lowest unoccupied molecular orbital LUMO(EET-1) of at least one, preferably each, excitation energy transfer component EET-1 having an energy $E^{LUMO}$(EET-1) is larger than 0 eV ($E^{LUMO}(H^B)$ - $E^{LUMO}$(EET-1) > 0 eV), preferably larger than 0.1 eV ($E^{LUMO}(H^B)$ - $E^{LUMO}$(EET-1) > 0.1 eV), more preferably larger than 0.2 eV ($E^{LUMO}(H^B)$ - $E^{LUMO}$(EET-1) > 0.2 eV), more preferably larger than 0.3 eV ($E^{LUMO}(H^B)$ - $E^{LUMO}$(EET-1) > 0.3 eV), even more preferably larger than 0.4 eV ($E^{LUMO}(H^B)$ - $E^{LUMO}$(EET-1) > 0.4 eV), in particular larger than 0.5 eV ($E^{LUMO}(H^B)$ - $E^{LUMO}$(EET-1) > 0.5 eV).

In a preferred embodiment of the invention, in at least one of the one or more light-emitting layers B, the difference in energy between the lowest unoccupied molecular orbital LUMO($H^B$) of at least one, preferably each, host material $H^B$ having an energy $E^{LUMO}(H^B)$ and the lowest unoccupied molecular orbital LUMO(EET-1) of at least one, preferably each, excitation energy transfer component EET-1 having an energy $E^{LUMO}$(EET-1) is larger than 0 eV ($E^{LUMO}(H^B)$ - $E^{LUMO}$ (EET-1) > 0 eV), preferably larger than 0.1 eV ($E^{LUMO}(H^B)$ - $E^{LUMO}$(EET-1) > 0.1 eV), more preferably larger than 0.2 eV ($E^{LUMO}(H^B)$ - $E^{LUMO}$(EET-1) > 0.2 eV), more preferably larger than 0.3 eV ($E^{LUMO}(H^B)$ - $E^{LUMO}$(EET-1) > 0.3 eV), even more preferably larger than 0.4 eV ($E^{LUMO}(H^B)$ - $E^{LUMO}$(EET-1) > 0.4 eV), in particular larger than 0.5 eV ($E^{LUMO}(H^B)$ - $E^{LUMO}$(EET-1) > 0.5 eV).

In a preferred embodiment of the invention, in each of the one or more light-emitting layers B, the difference in energy between the lowest unoccupied molecular orbital LUMO($H^B$) of at least one, preferably each, host material $H^B$ having an energy $E^{LUMO}(H^B)$ and the lowest unoccupied molecular orbital LUMO(EET-1) of at least one, preferably each, excitation energy transfer component EET-1 having an energy $E^{LUMO}$(EET-1) is larger than 0 eV ($E^{LUMO}(H^B)$ - $E^{LUMO}$ (EET-1) > 0 eV), preferably larger than 0.1 eV ($E^{LUMO}(H^B)$ - $E^{LUMO}$(EET-1) > 0.1 eV), more preferably larger than 0.2 eV ($E^{LUMO}(H^B)$ - $E^{LUMO}$(EET-1) > 0.2 eV), more preferably larger than 0.3 eV ($E^{LUMO}(H^B)$ - $E^{LUMO}$(EET-1) > 0.3 eV), even more preferably larger than 0.4 eV ($E^{LUMO}(H^B)$ - $E^{LUMO}$(EET-1) > 0.4 eV), in particular larger than 0.5 eV ($E^{LUMO}(H^B)$ - $E^{LUMO}$(EET-1) > 0.5 eV).

*S1-T1-energy relations*

In the context of the present invention:

(i) each excitation energy transfer component EET-1 has a lowermost excited singlet state $S1^{EET-1}$ with an energy level E($S1^{EET-1}$) and a lowermost excited triplet state $T1^{EET-1}$ with an energy level E($T1^{EET-1}$); and
(ii) each hole scavenger $H_{scav}$ has a lowermost excited singlet state $S1H_{scav}$ with an energy level E($S1^{Hscav}$) and a lowermost excited triplet state $T1H_{scav}$ with an energy level E($T1^{Hscav}$); and

(iii) each small full width at half maximum (FWHM) emitter $S^B$ has a lowermost excited singlet state $S1^3$ with an energy level $E(S1^S)$ and a lowermost excited triplet state $T1^S$ with an energy level $E(T1^S)$; and

(iv) each (optionally comprised) host material $H^B$ has a lowermost excited singlet state $S1^H$ with an energy level $E(S1^H)$ and a lowermost excited triplet state $T1^H$ with an energy level $E(T1^H)$.

In one embodiment of the invention, the relations expressed by the following formulas (7) to (9)), as far as the respective components are comprised in the same light-emitting layer B, apply:

$$E(S1^H) > E(S1^{EET\text{-}1}) \qquad (7)$$

$$E(S1^H) > E(S1^{Hscav}) \qquad (8)$$

$$E(S1^H) > E(S1^S) \qquad (9).$$

Accordingly, the lowermost excited singlet state $S1^H$ of at least one, preferably each, host material $H^B$ is preferably higher in energy than the lowermost excited singlet state $S1^{EET\text{-}1}$ of at least one, preferably each, excitation energy transfer component EET-1 (formula 7) and higher in energy than the lowermost excited singlet state $S1^{Hscav}$ of at least one, preferably each, hole scavenger $H_{scav}$ (formula 8) and higher in energy than the lowermost excited singlet state $S1^S$ of at least one, preferably each, small FWHM emitter $S^B$ (formula 9).

In one embodiment, the aforementioned relations expressed by formulas (7) to (9), as far as the respective components are comprised in the device, apply to materials comprised in any of the one or more light-emitting layers B of the organic electroluminescent device according to the invention.

In one embodiment of the invention, one or both of the relations expressed by the following formulas (10) and (11) apply to materials comprised in the same light-emitting layer B:

$$E(S1^{EET\text{-}1}) > E(S1^S) \qquad (10)$$

$$E(S1^{Hscav}) > E(S1^S) \qquad (11).$$

Accordingly, the lowermost excited singlet state $S1^{EET\text{-}1}$ of at least one, preferably each, excitation energy transfer component EET-1 (formula 10) and/or the lowermost excited singlet state $S1H_{scav}$ of at least one, preferably each, hole scavenger $H_{scav}$ (formula 11) may preferably be higher in energy than the lowermost excited singlet state $S1^S$ of at least one, preferably each, small FWHM emitter $S^B$.

In one embodiment, one or both of the aforementioned relations expressed by formulas (10) and (11) may apply to materials comprised in any of the one or more light-emitting layers B of the organic electroluminescent device according to the invention.

In a preferred embodiment of the invention, the relations expressed by the following formulas (7) to (11) apply to materials comprised in the same light-emitting layer B:

$$E(S1^H) > E(S1^{EET\text{-}1}) \qquad (7)$$

$$E(S1^H) > E(S1^{Hscav}) \qquad (8)$$

$$E(S1^H) > E(S1^S) \qquad (9)$$

$$E(S1^{EET\text{-}1}) > E(S1^S) \qquad (10)$$

$$E(S1^{Hscav}) > E(S1^S) \qquad (11).$$

In one embodiment, the aforementioned relations expressed by formulas (7) to (11) apply to materials comprised in any of the one or more light-emitting layers B of the organic electroluminescent device according to the invention.

In a preferred embodiment of the invention, the relations expressed by the following formulas (13) and (14) apply to materials comprised in the same light-emitting layer B:

$$E(T1^{H}) > E(T1^{EET\text{-}1}) \qquad (13)$$

$$E(T1^{EET\text{-}1}) \geq E(T1^{Hscav}) \qquad (14);$$

Accordingly, the lowermost excited triplet state $T1^{H}$ of at least one, preferably each, host material $H^{B}$ is preferably higher in energy than the lowermost excited triplet state $T1^{EET\text{-}1}$ of at least one, preferably each, excitation energy transfer component EET-1 (formula 13); Additionally, the lowermost excited triplet state $T1^{EET\text{-}1}$ of at least one, preferably each, excitation energy transfer component EET-1 is preferably equal in energy to or higher in energy than the lowermost excited triplet state $T1H_{scav}$ of at least one, preferably each, hole scavenger $H_{scav}$ (formula 14).

In one embodiment, the aforementioned relations expressed by formulas (13) and (14) apply to materials comprised in any of the at least one light-emitting layers B of the organic electroluminescent device according to the invention.

In a preferred embodiment of the invention, the relations expressed by the following formulas (14) to (16) apply to materials comprised in the same light-emitting layer B:

$$E(T1^{EET\text{-}1}) \geq E(T1^{Hscav}) \qquad (14)$$

$$E(T1^{Hscav}) > E(S1^{S}) \qquad (15)$$

$$E(T1^{Hscav}) > E(T1^{S}) \qquad (16).$$

Accordingly, the lowermost excited triplet state $T1^{EET\text{-}1}$ of at least one, preferably each, excitation energy transfer component EET-1 is preferably equal in energy to or higher in energy than the lowermost excited triplet state $T1^{Hscav}$ of at least one, preferably each, hole scavenger $H_{scav}$ (formula 14); the lowermost excited triplet state $T1^{Hscav}$ of at least one, preferably each, hole scavenger $H_{scav}$ is preferably higher in energy than the lowermost excited singlet state $S1^{S}$ of at least one, preferably each, small FWHM emitter $S^{B}$ (formula 15); the lowermost excited triplet state $T1^{Hscav}$ of at least one, preferably each, hole scavenger $H_{scav}$ is preferably higher in energy than the lowermost excited triplet state $T1^{S}$ of at least one, preferably each, small FWHM emitter $S^{B}$ (formula 16).

In one embodiment, the aforementioned relations expressed by formulas (14) to (16) apply to materials comprised in any of the at least one light-emitting layers B of the organic electroluminescent device according to the invention.

In a preferred embodiment of the invention, the relations expressed by the following formulas (7) to (10) and the following formula (15), as far as the respective components are comprised in the same light-emitting layer B, apply:

$$E(S1^{H}) > E(S1^{EET\text{-}1}) \qquad (7)$$

$$E(S1^{H}) > E(S1^{Hscav}) \qquad (8)$$

$$E(S1^{H}) > E(S1^{S}) \qquad (9)$$

$$E(S1^{EET\text{-}1}) > E(S1^{S}) \qquad (10)$$

$$E(T1^{Hscav}) > E(S1^{S}) \qquad (15).$$

In one embodiment, the aforementioned relations expressed by formulas (7) to (10) and formula (15) apply to materials comprised in any of the at least one light-emitting layers B of the organic electroluminescent device according to the invention.

In an alternative embodiment of the invention, the relations expressed by the following formulas (17) and (10)

apply to materials comprised in the same light-emitting layer B:

$$E(T1^{Hscav}) > E(T1^{EET-1}) \qquad (17)$$

$$E(S1^{EET-1}) > E(S1^{S}) \qquad (10).$$

Accordingly, the lowermost excited triplet state $T1^{Hscav}$ of at least one, preferably each, hole scavenger $H_{scav}$ may be higher in energy than the lowermost excited triplet state $T1^{EET-1}$ of at least one, preferably each, excitation energy transfer component EET-1 (formula 17); and the lowermost excited singlet state $S1^{EET-1}$ of at least one, preferably each, excitation energy transfer component EET-1 may be higher in energy the lowermost excited singlet state $S1^{S}$ of at least one, preferably each, small FWHM emitter $S^{B}$ (formula 10).

In an alternative embodiment, the aforementioned relations expressed by formulas (17) and (10) apply to materials comprised in any of the at least one light-emitting layers B of the organic electroluminescent device according to the invention.

In a preferred embodiment of the invention, the relations expressed by the following formulas (18), (15), (19), and (20) apply to materials comprised in the same light-emitting layer B:

$$E(T1^{H}) > E(T1^{Hscav}) \qquad (18)$$

$$E(T1^{Hscav}) > E(S1^{S}) \qquad (15)$$

$$E(T1^{H}) > E(S1^{EET-1}) \qquad (19)$$

$$E(T1^{EET-1}) > E(T1^{Hscav}) \qquad (20).$$

Accordingly, the lowermost excited triplet state $T1^{H}$ of at least one, preferably each, host material $H^{B}$ is preferably higher in energy than the lowermost excited triplet state $T1^{Hscav}$ of at least one, preferably each, hole scavenger $H_{scav}$ (formula 18); and the lowermost excited triplet state $T1^{Hscav}$ of at least one, preferably each, hole scavenger $H_{scav}$ is preferably higher in energy than the lowermost excited singlet state $S1^{S}$ of at least one, preferably each, small FWHM emitter $S^{B}$ (formula 15); and the lowermost excited triplet state $T1^{H}$ of at least one, preferably each, host material $H^{B}$ is preferably higher in energy than the lowermost excited singlet state $S1^{EET-1}$ of at least one, preferably each, excitation energy transfer component EET-1 (formula 19); and the lowermost excited triplet state $T1^{EET-1}$ of at least one, preferably each, excitation energy transfer component EET-1 is preferably higher in energy than the lowermost excited triplet state $T1^{Hscav}$ of at least one, preferably each, hole scavenger $H_{scav}$ (formula 20).

In one embodiment, the aforementioned relations expressed by formulas (18), (15), (19), and (20) apply to materials comprised in any of the at least one light-emitting layers B of the organic electroluminescent device according to the invention.

In one embodiment of the invention, the difference in energy between the lowermost excited triplet state $T1^{Hscav}$ of at least one, preferably each, hole scavenger $H_{scav}$ and the lowermost excited triplet state $T1^{EET-1}$ of at least one, preferably each, excitation energy transfer component EET-1 is smaller than 0.3 eV: $E(T1^{Hscav}) - E(T1^{EET-1}) < 0.3$ eV and $E(T1^{EET-1}) - E(T1^{Hscav}) < 0.3$ eV, respectively.

In one embodiment of the invention, in at least one of the one or more light-emitting layers B, the difference in energy between the lowermost excited triplet state $T1^{Hscav}$ of at least one, preferably each, hole scavenger $H_{scav}$ and the lowermost excited triplet state $T1^{EET-1}$ of at least one, preferably each, excitation energy transfer component EET-1 is smaller than 0.3 eV: $E(T1^{Hscav}) - E(T1^{EET-1}) < 0.3$ eV and $E(T1^{EET-1}) - E(T1^{Hscav}) < 0.3$ eV, respectively.

In one embodiment of the invention, in each of the one or more light-emitting layers B, the difference in energy between the lowermost excited triplet state T1 $H_{scav}$ of the at least one, preferably each, hole scavenger Hscav and the lowermost excited triplet state $T1^{Hscav}$ of the at least one, preferably each, excitation energy transfer component EET-1 is smaller than 0.3 eV: $E(T1^{Hscav}) - E(T1^{EET-1}) < 0.3$ eV and $E(T1^{EET-1}) - E(T1^{Hscav}) < 0.3$ eV, respectively.

In one embodiment of the invention, the relation expressed by the following formula (20) applies to materials comprised in the same light-emitting layer B:

$$E(T1^{EET1}) > E(T1^{Hscav}) \qquad (20).$$

In one embodiment, the aforementioned relation expressed by formula (20) applies to materials comprised in any of the one or more light-emitting layers B of the organic electroluminescent device according to the invention.

In a preferred embodiment of the invention, the difference in energy between the lowermost excited triplet state $T1^{EET-1}$ of at least one, preferably each, excitation energy transfer component EET-1 and the lowermost excited triplet state $T1^{Hscav}$ of at least one, preferably each, hole scavenger $H_{scav}$ is smaller than 0.2 eV: $E(T1^{EET-1}) - E(T1^{Hscav}) < 0.2$ eV and $E(T1^{Hscav}) - E(T1^{EET-1}) < 0.2$ eV, respectively.

In a preferred embodiment of the invention, in at least one of the one or more light-emitting layers B, the difference in energy between the lowermost excited triplet state $T1^{EET-1}$ of at least one, preferably each, excitation energy transfer component EET-1 and the lowermost excited triplet state $T1^{Hscav}$ of at least one, preferably each, hole scavenger $H_{scav}$ is smaller than 0.2 eV: $E(T1^{EET-1}) - E(T1^{Hscav}) < 0.2$ eV and $E(T1^{Hscav}) - E(T1^{EET-1}) < 0.2$ eV, respectively.

In a preferred embodiment of the invention, in each of the one or more light-emitting layers B, the difference in energy between the lowermost excited triplet state $T1^{EET-1}$ of at least one, preferably each, excitation energy transfer component EET-1 and the lowermost excited triplet state $T1^{Hscav}$ of at least one, preferably each, hole scavenger $H_{scav}$ is smaller than 0.2 eV: E(T1 EET-1) - $E(T1^{Hscav}) < 0.2$ eV and $E(T1^{Hscav}) - E(T1^{EET-1}) < 0.2$ eV, respectively.

In a preferred embodiment of the invention, the difference in energy between the lowermost excited triplet state $T1^{Hscav}$ of at least one, preferably each, hole scavenger $H_{scav}$ and the lowermost excited singlet state $S1^3$ of at least one, preferably each, small full width at half maximum (FWHM) emitter $S^B$ is smaller than 0.3 eV: $E(T1^{Hscav}) - E(S1^S) < 0.3$ eV and $E(S1^S) - E(T1^{Hscav}) < 0.3$ eV, respectively.

In a preferred embodiment of the invention, in at least one of the one or more light-emitting layers B, the difference in energy between the lowermost excited triplet state $T1^{Hscav}$ of at least one, preferably each, hole scavenger $H_{scav}$ and the lowermost excited singlet state $S1^3$ of at least one, preferably each, small full width at half maximum (FWHM) emitter $S^B$ is smaller than 0.3 eV: $E(T1^{Hscav}) - E(S1^S) < 0.3$ eV and $E(S1^S) - E(T1^{Hscav}) < 0.3$ eV, respectively.

In a preferred embodiment of the invention, in each of the one or more light-emitting layers B, the difference in energy between the lowermost excited triplet state $T1^{Hscav}$ of at least one, preferably each hole scavenger $H_{scav}$ and the lowermost excited singlet state $S1^S$ of at least one, preferably each small full width at half maximum (FWHM) emitter $S^B$ is smaller than 0.3 eV: $E(T1^{Hscav}) - E(S1^S) < 0.3$ eV and $E(S1^S) - E(T1^{Hscav}) < 0.3$ eV, respectively.

In a preferred embodiment of the invention, the difference in energy between the lowermost excited triplet state $T1^{Hscav}$ of at least one, preferably each, hole scavenger $H_{scav}$ and the lowermost excited singlet state $S1^S$ of at least one, preferably each, small full width at half maximum (FWHM) emitter $S^B$ is smaller than 0.2 eV: $E(T1^{Hscav}) - E(S1^S) < 0.2$ eV and $E(S1^S) - E(T1^{Hscav}) < 0.2$ eV, respectively.

In a preferred embodiment of the invention, in at least one of the one or more light-emitting layers B, the difference in energy between the lowermost excited triplet state $T1^{Hscav}$ of at least one, preferably each, hole scavenger $H_{scav}$ and lowermost excited singlet state $S1^S$ of at least one, preferably each, small full width at half maximum (FWHM) emitter $S^B$ is smaller than 0.2 eV: $E(T1^{Hscav}) - E(S1^S) < 0.2$ eV and $E(S1^S) - E(T1^{Hscav}) < 0.2$ eV, respectively.

In a preferred embodiment of the invention, in each of the one or more light-emitting layers B, the difference in energy between the lowermost excited triplet state $T1^{Hscav}$ of at least one, preferably each, hole scavenger $H_{scav}$ and the lowermost excited singlet state $S1^S$ of at least one, preferably each, small full width at half maximum (FWHM) emitter $S^B$ is smaller than 0.2 eV: $E(T1^{Hscav}) - E(S1^S) < 0.2$ eV and $E(S1^S) - E(T1^{Hscav}) < 0.2$ eV, respectively.

*Relations of emission maxima*

In one embodiment of the invention, one or both of the relations expressed by formulas (21) and (22) apply to materials comprised in the same light-emitting layer B:

$$|E^{\lambda max}(H^{scav}) - E^{\lambda max}(S^B)| < 0.30 \text{ eV} \qquad (21),$$

$$|E^{\lambda max}(EET\text{-}1) - E^{\lambda max}(S^B)| < 0.30 \text{ eV} \qquad (22),$$

which means: Within each light-emitting layer B, the difference in energy between the energy of the emission maximum $E^{\lambda max}(H^{scav})$ of at least one, preferably each, hole scavenger $H_{scav}$ given in electron volts (eV) and the energy of the emission maximum $E^{\lambda max}(S^B)$ of at least one, preferably each, small FWHM emitter $S^B$ given in electron volts (eV) is smaller than 0.30 eV (formula 21); and/or: The difference in energy between the energy of the emission maximum $E^{\lambda max}$(EET-1) of at least one, preferably each, excitation energy transfer component EET-1 given in electron volts (eV) and the energy of the emission maximum $E^{\lambda max}(S^B)$ of at least one, preferably each, small FWHM emitter $S^B$ given in electron volts (eV) is smaller than 0.30 eV (formula 22).

In one embodiment, one or both of the aforementioned relations expressed by formulas (21) and (22) apply to materials comprised in any of the one or more light-emitting layers B of the organic electroluminescent device according to

the invention.

In a preferred embodiment of the invention, one or both of the relations expressed by formulas (23) and (24) apply to materials comprised in the same light-emitting layer B:

$$|E^{\lambda max}(H^{scav}) - E^{\lambda max}(S^B)| < 0.20\ eV \qquad (23),$$

$$|E^{\lambda max}(EET\text{-}1) - E^{\lambda max}(S^B)| < 0.20\ eV \qquad (24),$$

which means: Within each light-emitting layer B, the difference in energy between the energy of the emission maximum $E^{\lambda max}(H^{scav})$ of at least one, preferably each, hole scavenger $H_{scav}$ given in electron volts (eV) and the energy of the emission maximum $E^{\lambda max}(S^B)$ of at least one, preferably each, small FWHM emitter $S^B$ given in electron volts (eV) is smaller than 0.20 eV (formula 23); and/or: The difference in energy between the energy of the emission maximum $E^{\lambda max}$(EET-1) of at least one, preferably each, excitation energy transfer component EET-1 given in electron volts (eV) and the energy of the emission maximum $E^{\lambda max}(S^B)$ of at least one, preferably each, small FWHM emitter $S^B$ given in electron volts (eV) is smaller than 0.20 eV (formula 24).

In one embodiment, one or both of the aforementioned relations expressed by formulas (23) and (24) apply to materials comprised in any of the one or more light-emitting layers B of the organic electroluminescent device according to the invention.

In an even more preferred embodiment of the invention, one or both of the relations expressed by formulas (25) and (26) apply to materials comprised in the same light-emitting layer B:

$$|E^{\lambda max}(H^{scav}) - E^{\lambda max}(S^B)| < 0.10\ eV \qquad (25),$$

$$|E^{\lambda max}(EET\text{-}1) - E^{\lambda max}(S^B)| < 0.10\ eV \qquad (26),$$

which means: Within each light-emitting layer B, the difference in energy between the energy of the emission maximum $E^{\lambda max}(H^{scav})$ of at least one, preferably each, hole scavenger $H_{scav}$ given in electron volts (eV) and the energy of the emission maximum $E^{\lambda max}(S^B)$ of at least one, preferably each, small FWHM emitter $S^B$ given in electron volts (eV) is smaller than 0.10 eV (formula 25); and/or: The difference in energy between the energy of the emission maximum $E^{\lambda max}$(EET-1) of at least one, preferably each, excitation energy transfer component EET-1 given in electron volts (eV) and the energy of the emission maximum $E^{\lambda max}(S^B)$ of at least one, preferably each, small FWHM emitter $S^B$ given in electron volts (eV) is smaller than 0.10 eV (formula 26).

In one embodiment, one or both the aforementioned relations expressed by formulas (25) and (26) apply to materials comprised in any of the one or more light-emitting layers B of the organic electroluminescent device according to the invention.

In one embodiment of the invention, the relation expressed by formula (27) applies to materials comprised in the same light-emitting layer B:

$$E^{\lambda max}(H^{scav}) > E^{\lambda max}(S^B) \qquad (27),$$

which means that, within each light-emitting layer B, the energy of the emission maximum $E^{\lambda max}(H^{scav})$ of at least one, preferably each, hole scavenger $H_{scav}$ given in electron volts (eV) is larger than the energy of the emission maximum $E^{\lambda max}(S^B)$ of at least one, preferably each, small FWHM emitter $S^B$ given in electron volts (eV).

In one embodiment, the aforementioned relation expressed by formula (27) applies to materials comprised in any of the one or more light-emitting layers B of the organic electroluminescent device according to the invention.

In one embodiment of the invention, the relation expressed by formula (28) applies to materials comprised in the same light-emitting layer B:

$$E^{\lambda max}(EET\text{-}1) > E^{\lambda max}(S^B) \qquad (28),$$

which means that, within each light-emitting layer B, the energy of the emission maximum $E^{\lambda max}$(EET-1) of at least one, preferably each, excitation energy transfer component EET-1 given in electron volts (eV) is larger than the energy of the emission maximum $E^{\lambda max}(S^B)$ of at least one, preferably each, small FWHM emitter $S^B$ given in electron volts (eV).

In one embodiment, the aforementioned relation expressed by formula (28) applies to materials comprised in any of the one or more light-emitting layers B of the organic electroluminescent device according to the invention.

*Device Colors & Performance*

A further embodiment of the present invention relates to an electroluminescent device (e.g., an OLED), which emits light at a distinct color point. According to the present invention, the electroluminescent device (e.g., OLED) emits light with a narrow emission band (small full width at half maximum (FWHM)). In a preferred embodiment, the electroluminescent device (e.g., OLED) according to the invention emits light with a FWHM of the main emission peak of below 0.25 eV, more preferably of below 0.20 eV, even more preferably of below 0.15 eV or even below 0.13 eV.

A further embodiment of the present invention relates to an electroluminescent device (e.g., an OLED), which exhibits an external quantum efficiency at 1000 cd/$m^2$ of more than 10%, more preferably of more than 13%, more preferably of more than 15%, even more preferably of more than 18% or even more than 20% and exhibits an emission maximum between 500 nm and 560 nm.

A further embodiment of the present invention relates to an electroluminescent device (e.g., an OLED), which exhibits an external quantum efficiency at 1000 cd/$m^2$ of more than 10%, more preferably of more than 13%, more preferably of more than 15%, even more preferably of more than 18% or even more than 20% and exhibits an emission maximum between 510 nm and 550 nm.

A further embodiment of the present invention relates to an electroluminescent device (e.g., an OLED) which exhibits an external quantum efficiency at 1000 cd/$m^2$ of more than 10%, more preferably of more than 13%, more preferably of more than 15%, even more preferably of more than 18% or even more than 20% and exhibits an emission maximum between 515 nm and 540 nm.

In a preferred embodiment, the electroluminescent device (e.g., an OLED) exhibits a LT95 value at constant current density $J_0$ = 15 mA/$cm^2$ of more than 100 h, preferably more than 200 h, more preferably more than 300 h, even more preferably more than 400 h, still even more preferably more than 750 h or even more than 1000 h.

A further embodiment of the present invention relates to an electroluminescent device (e.g., an OLED), which emits light at a distinct color point. According to the present invention, the electroluminescent device (e.g., OLED) emits light with a narrow emission band (small full width at half maximum (FWHM)). In a preferred embodiment, the electroluminescent device (e.g., OLED) according to the invention emits light with a FWHM of the main emission peak of below 0.25 eV, more preferably of below 0.20 eV, even more preferably of below 0.15 eV or even below 0.13 eV.A further embodiment of the present invention relates to an electroluminescent device (e.g., an OLED), which emits light with CIEx and CIEy color coordinates close to the CIEx (= 0.170) and CIEy (= 0.797) color coordinates of the primary color green (CIEx = 0.170 and CIEy = 0.797) as defined by ITU-R Recommendation BT.2020 (Rec. 2020) and thus may be suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is typically transparent) devices are used, whereas test devices as used throughout the present application represent bottom-emitting devices (bottom-electrode and substrate are transparent). Accordingly, a further aspect of the present invention relates to an electroluminescent device (e.g., an OLED), whose emission exhibits a CIEx color coordinate of between 0.15 and 0.45 preferably between 0.15 and 0.35, more preferably between 0.15 and 0.30 or even more preferably between 0.15 and 0.25 or even between 0.15 and 0.20 and/ or a CIEy color coordinate of between 0.60 and 0.92, preferably between 0.65 and 0.90, more preferably between 0.70 and 0.88 or even more preferably between 0.75 and 0.86 or even between 0.79 and 0.84.

A further embodiment of the present invention relates to an OLED, which emits light with CIEx and CIEy color coordinates close to the CIEx (= 0.265) and CIEy (= 0.65) color coordinates of the primary color green (CIEx = 0.265 and CIEy = 0.65) as defined by DCIP3. In this context, the term "close to" refers to the ranges of CIEx and CIEy coordinates provided at the end of this paragraph. In commercial applications, typically top-emitting (top-electrode is typically transparent) devices are used, whereas test devices as used throughout the present application represent bottom-emitting devices (bottom-electrode and substrate are transparent). Accordingly, a further aspect of the present invention relates to an OLED, whose bottom emission exhibits a CIEx color coordinate of between 0.2 and 0.45 preferably between 0.2 and 0.35 or more preferably between 0.2 and 0.30 or even more preferably between 0.24 and 0.28 or even between 0.25 and 0.27 and/ or a CIEy color coordinate of between 0.60 and 0.9, preferably between 0.6 and 0.8, more preferably between 0.60 and 0.70 or even more preferably between 0.62 and 0.68 or even between 0.64 and 0.66.

A further embodiment of the present invention relates to an electroluminescent device (e.g., an OLED), which exhibits an external quantum efficiency at 1000 cd/$m^2$ of more than 10%, more preferably of more than 13%, more preferably of more than 15%, even more preferably of more than 18% or even more than 20% and exhibits an emission maximum between 420 nm and 500 nm.

A further embodiment of the present invention relates to an electroluminescent device (e.g., an OLED), which exhibits an external quantum efficiency at 1000 cd/$m^2$ of more than 10%, more preferably of more than 13%, more preferably of more than 15%, even more preferably of more than 18% or even more than 20% and exhibits an emission maximum between 440 nm and 480 nm.

A further embodiment of the present invention relates to an electroluminescent device (e.g., an OLED), which

exhibits an external quantum efficiency at 1000 cd/$m^2$ of more than 10%, more preferably of more than 13%, more preferably of more than 15%, even more preferably of more than 18% or even more than 20% and exhibits an emission maximum between 450 nm and 470 nm.

A further embodiment of the present invention relates to an electroluminescent device (e.g., an OLED), which exhibits an external quantum efficiency at 1000 cd/$m^2$ of more than 10%, more preferably of more than 13%, more preferably of more than 15%, even more preferably of more than 18% or even more than 20% and/or exhibits an emission maximum between 420 nm and 500 nm, preferably between 430 nm and 490 nm, more preferably between 440 nm and 480 nm, even more preferably between 450 nm and 470 nm and/or exhibits a LT80 value at 500 cd/$m^2$ of more than 100 h, preferably more than 200 h, more preferably more than 400 h, even more preferably more than 750 h or even more than 1000 h.

A further embodiment of the present invention relates to an electroluminescent device (e.g., an OLED), which emits light at a distinct color point. According to the present invention, the electroluminescent device (e.g., OLED) emits light with a narrow emission band (small full width at half maximum (FWHM)). In a preferred embodiment, the electroluminescent device (e.g., OLED) according to the invention emits light with a FWHM of the main emission peak of below 0.25 eV, more preferably of below 0.20 eV, even more preferably of below 0.15 eV or even below 0.13 eV.

A further aspect of the present invention relates to an OLED, which emits light with CIEx and CIEy color coordinates close to the CIEx (= 0.131) and CIEy (= 0.046) color coordinates of the primary color blue (CIEx = 0.131 and CIEy = 0.046) as defined by ITU-R Recommendation BT.2020 (Rec. 2020) and thus is suited for the use in Ultra High Definition (UHD) displays, e.g. UHD-TVs. In commercial applications, typically top-emitting (top-electrode is transparent) devices are used, whereas test devices as used throughout the present application represent bottom-emitting devices (bottom-electrode and substrate are transparent). The CIEy color coordinate of a blue device can be reduced by up to a factor of two, when changing from a bottom- to a top-emitting device, while the CIEx remains nearly unchanged (Okinaka et al., Society for Information Display International Symposium Digest of Technical Papers, 2015, 46(1):312-313,DOI:10.1002/sdtp.10480). Accordingly, a further aspect of the present invention relates to an OLED, whose emission exhibits a CIEx color coordinate of between 0.02 and 0.30, preferably between 0.03 and 0.25, more preferably between 0.05 and 0.20 or even more preferably between 0.08 and 0.18 or even between 0.10 and 0.15 and/ or a CIEy color coordinate of between 0.00 and 0.45, preferably between 0.01 and 0.30, more preferably between 0.02 and 0.20 or even more preferably between 0.03 and 0.15 or even between 0.04 and 0.10.

A further aspect of the present invention relates to an electroluminescent device (e.g., an OLED), which exhibits an external quantum efficiency at 1000 cd/$m^2$ of more than 8%, more preferably of more than 10%, more preferably of more than 13%, even more preferably of more than 15% or even more than 20% and/or exhibits an emission maximum between 590 nm and 690 nm, preferably between 610 nm and 665 nm, even more preferably between 620 nm and 640 nm and/or exhibits a LT80 value at 500 cd/$m^2$ of more than 100 h, preferably more than 200 h, more preferably more than 400 h, even more preferably more than 750 h or even more than 1000 h. Accordingly, a further aspect of the present invention relates to an OLED, whose emission exhibits a CIEy color coordinate of more than 0.25, preferably more than 0.27, more preferably more than 0.29 or even more preferably more than 0.30.

A further embodiment of the present invention relates to an electroluminescent device (e.g., an OLED), which emits light with CIEx and CIEy color coordinates close to the CIEx (= 0.708) and CIEy (= 0.292) color coordinates of the primary color red (CIEx = 0.708 and CIEy = 0.292) as defined by ITU-R Recommendation BT.2020 (Rec. 2020) and thus is suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is transparent) devices are used, whereas test devices as used throughout the present application represent bottom-emitting devices (bottom-electrode and substrate are transparent). Accordingly, a further aspect of the present invention relates to an OLED, whose emission exhibits a CIEx color coordinate of between 0.60 and 0.88, preferably between 0.61 and 0.83, more preferably between 0.63 and 0.78 or even more preferably between 0.66 and 0.76 or even between 0.68 and 0.73 and/ or a CIEy color coordinate of between 0.25 and 0.70, preferably between 0.26 and 0.55, more preferably between 0.27 and 0.45 or even more preferably between 0.28 and 0.40 or even between 0.29 and 0.35.

Accordingly, a further aspect of the present invention relates to an electroluminescent device (e.g., an OLED), which exhibits an external quantum efficiency at 14500 cd/$m^2$ of more than 10%, more preferably of more than 13%, more preferably of more than 15%, even more preferably of more than 17% or even more than 20% and/or exhibits an emission maximum between 590 nm and 690 nm, preferably between 610 nm and 665 nm, even more preferably between 620 nm and 640 nm.

One of the purposes of interest of an organic electroluminescent device may be the generation of light. Thus, the present invention further relates to a method for generating light of a desired wavelength range, comprising the step of providing an organic electroluminescent device according to any the present invention.

Accordingly, a further aspect of the present invention relates to a method for generating light of a desired wavelength range, comprising the steps of

(i) providing an organic electroluminescent device according to the present invention; and
(ii) applying an electrical current to said organic electroluminescent device.

A further aspect of the present invention relates to a process of making the organic electroluminescent devices by assembling the elements described above. The present invention also relates to a method for generating green light, in particular by using said organic electroluminescent device.

A further aspect of the invention relates to an organic electroluminescent device, wherein at least one, preferably exactly one, of the relations expressed by the following formulas (29) to (31) applies to materials comprised in the same light-emitting layer B:

$$440\ \text{nm} < \lambda_{max}(S^B) < 470\ \text{nm} \qquad (29)$$

$$510\ \text{nm} < \lambda_{max}(S^B) < 550\ \text{nm} \qquad (30)$$

$$610\ \text{nm} < \lambda_{max}(S^B) < 665\ \text{nm} \qquad (31),$$

wherein $\lambda_{max}(S^B)$ is the emission maximum of the at least one, preferably each, small FWHM emitter $S^B$ and is given in nanometers (nm).

In one embodiment of the invention at least one, preferably exactly one, of the relations expressed by the following formulas (29) to (31) applies to materials comprised in any of the one or more light-emitting layers B of the organic electroluminescent device according to the invention.

A further aspect of the invention relates to a method for generating light, comprising the steps of:

(i) providing an organic electroluminescent device according to the present invention
(ii) applying an electrical current to said organic electroluminescent device.

A further aspect of the invention relates to a method for generating light, comprising the steps of:

(i) providing an organic electroluminescent device according to the present invention
(ii) applying an electrical current to said organic electroluminescent device,

wherein the method is for generating light at a wavelength range selected from one of the following wavelength ranges:

(i) from 510 nm to 550 nm, or
(ii) from 440 nm to 470 nm, or
(iii) from 610 nm to 665 nm.

A further aspect of the invention relates to a method for generating light, comprising the steps of:

(i) providing an organic electroluminescent device according to the present invention
(ii) applying an electrical current to said organic electroluminescent device,

wherein preferably the method is for generating light with the emission maximum of the main emission peak being within the wavelength range selected from one of the following wavelength ranges:

(i) from 510 nm to 550 nm, or
(ii) from 440 nm to 470 nm, or
(iii) from 610 nm to 665 nm.

The skilled artisan understands that, depending on their structure, the one or more excitation energy transfer components EET-1 (vide infra) and the optionally comprised one or more excitation energy transfer components EET-2 (vide infra) may be used as emitters in organic electroluminescent devices. However, preferably, in the organic electroluminescent device according to the present invention, the main function of the one or more excitation energy transfer components EET-1 and the optionally comprised one or more excitation energy transfer components EET-2 is not the emission of light. In a preferred embodiment, upon applying a voltage (and electrical current), the organic electroluminescent device according to the invention emits light, wherein this emission is mainly (i.e. to an extent of more than

50%, preferably of more than 60%, more preferably of more than 70%, even more preferably of more than 80% or even of more than 90%) attributed to fluorescent light emitted by the one or more small FWHM emitters $S^B$. In consequence, the organic electroluminescent device according to the present invention preferably also displays a narrow emission, which is expressed by a small FWHM of the main emission peak of below 0.25 eV, more preferably of below 0.20 eV, even more preferably of below 0.15 eV or even below 0.13 eV.

In a preferred embodiment of the invention, the relation expressed by the following formula (32) applies:

$$\frac{\mathrm{FWHM^D}}{\mathrm{FWHM^{SB}}} \leq 1.50 \qquad (32),$$

wherein

FWHM$^D$ refers to the full width at half maximum (FWHM) in electron volts (eV) of the main emission peak of the organic electroluminescent device according to the present invention; and

FWHM$^{SB}$ represents the FWHM in electron volts (eV) of the photoluminescence spectrum (fluorescence spectrum, measured at room temperature, i.e. (approximately) 20°C) of a spin coated film of the one or more small FWHM emitters $S^B$ in the one or more host materials $H^B$ used in the light-emitting layer (EML) of the organic electroluminescent device with the FWHM of FWHM$^D$. This is to say that the spin-coated film from which FWHM$^{SB}$ is determined preferably comprises the same small FWHM emitter or emitters $S^B$ in the same weight ratios as the light-emitting layer B of the organic electroluminescent device.

If, for example, the light-emitting layer B comprises two small FWHM emitters $S^B$ with a concentration of 1% by weight each, the spin-coated film preferably also comprises 1% by weight of each of the two small FWHM emitters $S^B$. In this exemplary case, the matrix material of the spin-coated film would amount to 98% by weight of the spin-coated film. This matrix material of the spin-coated film may be selected to reflect the weight-ratio of the host materials $H^B$ comprised in the light-emitting layer B of the organic electroluminescent device. If, in the aforementioned example, the light-emitting layer B comprises a single host material $H^B$, this host material would preferably be the sole matrix material of the spin-coated film. If, however, in the aforementioned example, the light-emitting layer B comprises two host materials $H^B$, one with a content of 60% by weight and the other with a content of 20% by weight (i.e. in a ratio of 3:1), the aforementioned matrix material of the spin-coated film (comprising 1% by weight of each of the two small FWHM emitters $S^B$) would preferably be a 3:1-mixture of the two host materials $H^B$ as present in the EML.

If more than one light-emitting layer B is contained in an organic electroluminescent device according to the present invention, the relation expressed by the aforementioned formula (32) preferably applies to all light-emitting layers B comprised in the device.

In one embodiment, for at least one light-emitting layer B of the organic electroluminescent device according to the present invention, the aforementioned ratio FWHM$^D$:FWHM$^{SB}$ is equal to or smaller than 1.50, preferably 1.40, even more preferably 1.30, still even more preferably 1.20, or even 1.10.

In one embodiment, for each light-emitting layer B of the organic electroluminescent device according to the present invention, the aforementioned ratio FWHM$^D$:FWHM$^{SB}$ is equal to or smaller than 1.50, preferably 1.40, even more preferably 1.30, still even more preferably 1.20, or even 1.10.

It should be noted that for the selection of fluorescent emitters for the use as small FWHM emitters $S^B$ in the context of the present invention, the FWHM value may be determined as described in a later subchapter of this text (briefly: preferably from a spin-coated film of the respective emitter in poly(methyl methacrylate) PMMA with a concentration of 1-5% by weight, in particular 2% by weight, or from a solution, vide infra). This is to say that the FWHM values of the exemplary small FWHM emitters $S^B$ listed in Table 1S may not be understood as FWHM$^{SB}$ values in the context of equation (32) and the associated preferred embodiments of the present invention.

The examples and claims further illustrate the invention.

*Excited state lifetimes*

A detailed description on how the excited state lifetimes are measured is provided in a following subchapter of this text.

In one embodiment of the invention, in at least one, preferably each, light-emitting layer B, at least one, preferably each, TADF material $E^B$ in the context of the present invention exhibits a delayed fluorescence lifetime $\bar{\tau}(E^B)$ equal to or shorter than 110 $\mu$s, preferably equal to or shorter than 100 $\mu$s. In one embodiment of the invention, each TADF material $E^B$ in the context of the present invention exhibits a delayed fluorescence lifetime $\bar{\tau}(E^B)$ equal to or shorter than 110 $\mu$s, preferably equal to or shorter than 100 $\mu$s.

In one embodiment of the invention, in at least one, preferably each, light-emitting layer B, at least one, preferably

each, TADF material $E^B$ in the context of the present invention exhibits a delayed fluorescence lifetime $\bar{\tau}(E^B)$ equal to or shorter than 75 $\mu$s. In one embodiment of the invention, each TADF material $E^B$ in the context of the present invention exhibits a delayed fluorescence lifetime $\bar{\tau}(E^B)$ equal to or shorter than 75 $\mu$s.

In one embodiment of the invention, in at least one, preferably each, light-emitting layer B, at least one, preferably each, TADF material $E^B$ in the context of the present invention exhibits a delayed fluorescence lifetime $\bar{\tau}(E^B)$ equal to or shorter than 50 $\mu$s. In one embodiment of the invention, each TADF material $E^B$ exhibits a delayed fluorescence lifetime $\bar{\tau}$ $(E^B)$ equal to or shorter than 50 $\mu$s.

In a preferred embodiment of the invention, in at least one, preferably each, light-emitting layer B, at least one, preferably each, TADF material $E^B$ in the context of the present invention exhibits an a delayed fluorescence lifetime $\bar{\tau}(E^B)$ equal to or shorter than 10 $\mu$s. In one embodiment of the invention, each TADF material $E^B$ exhibits a delayed fluorescence lifetime $\bar{\tau}(E^B)$ equal to or shorter than 10 $\mu$s.

In an even more preferred embodiment of the invention, in at least one, preferably each, light-emitting layer B, at least one, preferably each, TADF material $E^B$ in the context of the present invention exhibits a delayed fluorescence lifetime $\bar{\tau}(E^B)$ equal to or shorter than 5 $\mu$s. In one embodiment of the invention, each TADF material $E^B$ exhibits a delayed fluorescence lifetime $\bar{\tau}(E^B)$ equal to or shorter than 5 $\mu$s.

In one embodiment of the invention, in at least one, preferably each, light-emitting layer B, at least one, preferably each, phosphorescence material $P^B$ in the context of the present invention exhibits an excited state lifetime $\bar{\tau}(P^B)$ equal to or shorter than 50 $\mu$s. In one embodiment of the invention, each phosphorescence material $P^B$ exhibits an excited state lifetime $\bar{\tau}(P^B)$ equal to or shorter than 50 $\mu$s.

In a preferred embodiment of the invention, in at least one, preferably each, light-emitting layer B, at least one, preferably each, phosphorescence material $P^B$ in the context of the present invention exhibits an excited state lifetime $\bar{\tau}$ $(P^B)$ equal to or shorter than 10 $\mu$s. In one embodiment of the invention, each phosphorescence material $P^B$ exhibits an excited state lifetime $\bar{\tau}(P^B)$ equal to or shorter than 10 $\mu$s.

In an even more preferred embodiment of the invention, in at least one, preferably each, light-emitting layer B, at least one, preferably each, phosphorescence material $P^B$ in the context of the present invention exhibits an excited state lifetime $\bar{\tau}(P^B)$ equal to or shorter than 5 $\mu$s. In one embodiment of the invention, each phosphorescence material $P^B$ exhibits an excited state lifetime $\bar{\tau}(P^B)$ equal to or shorter than 5 $\mu$s.

In one embodiment of the invention, in an organic electroluminescent device according to the invention, the addition of one or more TADF materials $E^B$ into one or more sublayers of a light-emitting layers B comprising one or more phosphorescence materials $P^B$, one or more small FWHM emitters $S^B$ and optionally one or more host materials $H^B$, results in a decreased excited state lifetime of the organic electroluminescent device. In a preferred embodiment of the invention the aforementioned addition of a TADF material $E^B$ according to the invention decreases the excited state lifetime of the organic electroluminescent device by at least 50%.

*Recombination zone*

In the context of the present invention, the emission zone (EZ) in organic electroluminescent devices (in particular in organic light-emitting diodes, OLEDs) such as those described herein represents the zone (i.e. the region) over which the optical stress due to excitons is distributed in the light-emitting layer (EML, for example a light-emitting layer B according to the present invention).

It is known to those skilled in the art that the shape and size of the emission zone (EZ) has an impact on the lifetime of the respective organic electroluminescent device since it reflects the exciton stress per molecule comprised in the emission zone (EZ). The skilled artisan understands that reduced exciton stress per molecule likely results in a prolonged device lifetime.

In the context of the present invention, the recombination zone (RZ) in organic electroluminescent devices (in particular in organic light-emitting diodes, OLEDs) such as those described herein represents the zone (i.e. the region) in which excitons are generated by electron-hole-recombination.

Herein, in a slightly simplified approach (assuming a sufficiently short exciton diffusion length), it is assumed that the recombination zone (RZ) is (almost) identical to the emission zone (EZ). The recombination zone (RZ, and in our slightly simplified approach also the emission zone, EZ) is correlated to the charge balance between electrons and holes within the light-emitting layer of the respective organic electroluminescent device. Additionally, the recombination zone (RZ, and in our simplified approach also the emission zone, EZ) is influenced by the (electrical) current stress per molecule.

As stated previously, the inventors have surprisingly found that that an organic electroluminescent device's light-emitting layer consisting of one or more (sub)layer(s) as a whole comprising one or more excitation energy transfer components EET-1, one or more hole scavengers $H_{scav}$, one or more small full width at half maximum (FWHM) emitters $S^B$ emitting light with a full width at half maximum (FWHM) of less than or equal to 0.25 eV, and optionally one or more host materials $H^B$, provides an organic electroluminescent device having a long lifetime, a high quantum yield and exhibiting narrow emission, ideally suitable to achieve the BT-2020 and DCPI3 color gamut.

Furthermore, the inventors have found that this beneficial effect is particularly achieved, if the aforementioned materials comprised in a light-emitting layer B fulfill the criteria given in the aforementioned formulas (1) to (6), as far as the respective components are comprised in the same light-emitting layer B. It is assumed that fulfilling the requirements regarding the HOMO- and LUMO-energies of the one or more excitation energy transfer components EET-1, the one or more hole scavengers $H_{scav}$, the one or more small FWHM emitters $S^B$ and the optional one or more host materials $H^B$, comprised in a light-emitting layer B according to the present invention may provide the beneficial effect on the device performance partly due to an impact on the recombination zone (RZ).

In light-emitting layers B in the context of the present invention, the recombination zone (RZ) may be distributed more evenly than for example in the absence of EET-1 or $H_{scav}$, in particular in the absence of EET-1, in the light-emitting layer.

Herein, to assess the spatial distribution of the recombination zone (RZ) over the respective light-emitting layer B, said light-emitting layer B is imaginarily divided in half by a boundary surface $S^{EML}$, wherein $S^{EML}$ is parallel to the electron blocking layer (EBL) and to the hole blocking layer (HBL) and located exactly in the middle of the respective light-emitting layer B so that exactly half of the light-emitting layer's volume is located between the HBL and $S^{EML}$ and exactly half of the light-emitting layer's volume is located between the EBL and $S^{EML}$. This is also shown in Figure 1 (vide infra).

As known to those skilled in the art, organic electroluminescent devices (in particular an OLEDs) such as those of the present invention do not necessarily comprise an HBL and/or an EBL. It is understood that, in case the organic electroluminescent device according to the present invention do not have an HBL, the respective light-emitting layer B may be directly adjacent to an electron transport layer (ETL). Along the same lines, in case the organic electroluminescent device according to the present invention should not have an EBL, the respective light-emitting layer B may be directly adjacent to a hole transport layer (HTL). In the exemplary case that neither an EBL nor an HBL is present, the imaginary boundary surface $S^{EML}$ will be parallel to the electron blocking layer (EBL) and to the hole blocking layer (HBL) and located exactly in the middle of the respective light-emitting layer B so that exactly half of the light-emitting layer's volume is located between the ETL and $S^{EML}$ and exactly half of the light-emitting layer's volume is located between the HTL and $S^{EML}$. This is to say that regardless of the precise device architecture, $S^{EML}$ divides the EML into halves of equal volume.

To assess the volume fraction of the recombination zone lying within one or the other half of the light-emitting layer B, the recombination zone profile (RZ profile) may be determined. The RZ (in a simplified approach also emission zone, EZ) profile may be determined by fitting an optical model of the device, based on a transfer-matrix theory approach for multi-layer systems in combination with a dipole emission model, to angular dependent measurements of the device emission spectra. The measurements may be conducted using a gonio-spectrometer for angular-dependence EL and PL measurements setup (Phelos) by Fluxim AG. The fit and the calculation of the emission zone profile may be done using SETFOS by Fluxim AG. Details of the fit algorithm may be described in B. Perucco, N. Reinke, D. Rezzonico, M. Moos, and B. Ruhstaller, "Analysis of the emission profile in organic light-emitting devices," Opt. Express 18, A246-A260 (2010).

For this purpose, the first step may be to measure the angular electroluminescence distribution. This allows the determination of the emission modes coming from the OLED. These may be dependent on 1) the refractive index of the materials used in the organic stack; 2) the horizontal orientation of the emitter(s) $S^B$ emitting light with a full width at half maximum (FWHM) of less than or equal to 0.25 eV in the light-emitting layer B and 3) the RZ distribution which results in different spectral emissions from the emitter when at different positions of the EML. At known refractive index and horizontal dipole orientations, the RZ can therefore be fitted using the appropriate fitting software.

The Gonio-Spectrometer may be used to determine the angular-dependence of the electroluminescence (EL) spectra. In a bottom emission device, light may be emitted through the glass side of the OLED. This will result in light modes being trapped at the organic stack-glass interface. Therefore, the OLED must be placed onto a macro extractor lens that outcouple all the emission modes. The device may be put under a bias to have it emitting at specific characteristics (e.g. constant current or constant voltage) resulting in the desired luminance. Then, the substrate rotates from an angle A to an angle B with a desired step size and the emission may be collected through a spectrophotometer, being dependent of the angle. The spectrometer that collects the EL spectra contains a polarizer that filters the total light output to a 90° or 0° polarization, allowing the determination of the s- (perpendicular to the substrate plane) and p- (parallel to the substrate plane) polarization modes, respectively. These -s and -p polarizations distributions may be used as a target to fit the RZ profile.

In the fitting software (SETFOS by Fluxim AG), the entire stack (substrate and all layers such as anode, hole injection la, hole transportlayer, ... cathode) may be introduced with the corresponding optical constants. With regard to the EML, the emission properties of the $S^B$ may be introduced (orientation, PLQY, emission maximum) and the RZ fitted with the targeted data, i.e. the RZ may be fitted to reproduce the measured angular dependence.

Details of the exemplary fit algorithm are described in B. Perucco, N. Reinke, D. Rezzonico, M. Moos, and B. Ruhstaller, "Analysis of the emission profile in organic light-emitting devices," Opt. Express 18, A246-A260 (2010).

The volume fraction VF of the recombination zone lying within one or the other half of the light-emitting layer B may be calculated according to:

$$\mathrm{VF} = \frac{\int_0^{d/2} RZ\ profile\ dx}{\int_0^{d} RZ\ profile\ dx} \cdot 100\%\ ,$$

wherein d is the thickness of the respective EML (e.g. 50 nm) and x is the distance from the boundary surface $S^B$ between the respective EML and the layer adjacent to the respective half of the EML (an EBL for the left half in the example above).

It is preferred that the recombination zone is not solely located in one half of the respective light-emitting layer B, but to some extent distributed over both halves of the respective light-emitting layer B (vide infra).

In one embodiment, for at least one, preferably each, light-emitting layer B of the organic electroluminescent device according to the present invention, the recombination zone (i.e. the region within the respective light-emitting layer(s) B, where electron-hole-recombination occurs upon applying an electrical current to the device) fulfills both of the following criteria:

(i) 10-90% of its volume is located between the electron blocking layer (EBL) and an imaginary boundary surface $S^{EML}$, wherein $S^{EML}$ **is** parallel to the EBL and located exactly in the middle of the respective light-emitting layer B (i.e. the volume fraction VF of the recombination zone is 10-90%); and
(ii) 10-90% of its volume is located between the hole blocking layer (HBL) and an imaginary boundary surface $S^{EML}$ wherein $S^{EML}$ is parallel to the HBL and located exactly in the middle of the respective light-emitting layer B (i.e. the volume fraction VF of the recombination zone is 10-90%);

wherein both the EBL and the HBL are adjacent to the light-emitting layer B with the EBL being closer to the anode and the HBL being closer to the cathode; and wherein the total volume of the recombination zone adds up to 100% (e.g. 50% on the EBL-side (i) and 50% on the HBL-side (ii) of the light-emitting layer B being imaginarily divided evenly (in half) by the boundary interface $S^{EML}$).

In one embodiment, for at least one, preferably each, light-emitting layer B of the organic electroluminescent device according to the present invention, the recombination zone (i.e. the region within the respective light-emitting layer(s) B, where electron-hole-recombination occurs upon applying an electrical current to the device) fulfills both of the following criteria:

(i) 20-80% of its volume is located between the electron blocking layer (EBL) and an imaginary boundary surface $S^{EML}$, wherein $S^{EML}$ is parallel to the EBL and located exactly in the middle of the respective light-emitting layer B (i.e. the volume fraction VF of the recombination zone is 20-80%); and
(ii) 20-80% of its volume is located between the hole blocking layer (HBL) and an imaginary boundary surface $S^{EML}$, wherein $S^{EML}$ is parallel to the HBL and located exactly in the middle of the respective light-emitting layer B (i.e. the volume fraction VF of the recombination zone is 20-80%);

wherein both the EBL and the HBL are adjacent to the light-emitting layer B with the EBL being closer to the anode and the HBL being closer to the cathode; and wherein the total volume of the recombination zone adds up to 100% (e.g. 50% on the EBL-side (i) and 50% on the HBL-side (ii) of the light-emitting layer B being imaginarily divided evenly (in half) by the boundary interface $S^{EML}$).

In one embodiment, for at least one, preferably each, light-emitting layer B of the organic electroluminescent device according to the present invention, the recombination zone (i.e. the region within the respective light-emitting layer(s) B, where electron-hole-recombination occurs upon applying an electrical current to the device) fulfills both of the following criteria:

(i) 30-70% of its volume is located between the electron blocking layer (EBL) and an imaginary boundary surface $S^{EML}$, wherein $S^{EML}$ is parallel to the EBL and located exactly in the middle of the respective light-emitting layer B (i.e. the volume fraction VF of the recombination zone is 30-70%); and
(ii) 30-70% of its volume is located between the hole blocking layer (HBL) and an imaginary boundary surface $S^{EML}$, wherein $S^{EML}$ is parallel to the HBL and located exactly in the middle of the respective light-emitting layer B (i.e. the volume fraction VF of the recombination zone is 30-70%);

wherein both the EBL and the HBL are adjacent to the light-emitting layer B with the EBL being closer to the anode and the HBL being closer to the cathode; and wherein the total volume of the recombination zone adds up to 100% (e.g. 50% on the EBL-side (i) and 50% on the HBL-side (ii) of the light-emitting layer B being imaginarily divided evenly (in half) by the boundary interface $S^{EML}$).

In one embodiment, for at least one, preferably each, light-emitting layer B of the organic electroluminescent device according to the present invention, the recombination zone (i.e. the region within the respective light-emitting

layer(s) B, where electron-hole-recombination occurs upon applying an electrical current to the device) fulfills both of the following criteria:

(i) 40-60% of its volume is located between the electron blocking layer (EBL) and an imaginary boundary surface $S^{EML}$, wherein $S^{EML}$ is parallel to the EBL and located exactly in the middle of the respective light-emitting layer B (i.e. the volume fraction VF of the recombination zone is 40-60%); and
(ii) 40-60% of its volume is located between the hole blocking layer (HBL) and an imaginary boundary surface $S^{EML}$, wherein $S^{EML}$ is parallel to the HBL and located exactly in the middle of the respective light-emitting layer B (i.e. the volume fraction VF of the recombination zone is 40-60%);

wherein both the EBL and the HBL are adjacent to the light-emitting layer B with the EBL being closer to the anode and the HBL being closer to the cathode; and wherein the total volume of the recombination zone adds up to 100% (e.g. 50% on the EBL-side (i) and 50% on the HBL-side (ii) of the light-emitting layer B being imaginarily divided evenly (in half) by the boundary interface $S^{EML}$).

*Device architecture*

The person skilled in the art will notice that the at least one light-emitting layer B will typically be incorporated in an organic electroluminescent device of the present invention. Preferably, such an organic electroluminescent device comprises at least the following layers: at least one light-emitting layer B, at least one anode layer A and at least one cathode layer C.
Preferably, at least one light-emitting layer B is located between an anode layer A and a cathode layer C. Accordingly, the general set-up is preferably A - B - C. This does of course not exclude the presence of one or more optional further layers. These can be present at each side of A, of B and/or of C.
Preferably, an anode layer A is located on the surface of a substrate. The substrate may be formed by any material or composition of materials. Most frequently, glass slides are used as substrates. Alternatively, thin metal layers (e.g., copper, gold, silver or aluminum films) or plastic films or slides may be used. This may allow a higher degree of flexibility. At least one of both electrodes should be (essentially) transparent in order to allow light emission from the electroluminescent device (e.g., OLED). Usually, an anode layer A is mostly composed of materials allowing to obtain an (essentially) transparent film. Preferably, the anode layer A comprises a large content or even consists of transparent conductive oxides (TCOs).
Such an anode layer A may exemplarily comprise indium tin oxide, aluminum zinc oxide, fluorine tin oxide, indium zinc oxide, PbO, SnO, zirconium oxide, molybdenum oxide, vanadium oxide, wolfram oxide, graphite, doped Si, doped Ge, doped GaAs, doped polyaniline, doped polypyrrol and/or doped polythiophene and mixtures of two or more thereof.
Particularly preferably, an anode layer A (essentially) consists of indium tin oxide (ITO) (e.g., $(InO_3)_{0.9}(SnO_2)_{0.1}$). The roughness of an anode layer A caused by the transparent conductive oxides (TCOs) may be compensated by using a hole injection layer (HIL). Further, a HIL may facilitate the injection of quasi charge carriers (i.e., holes) in that the transport of the quasi charge carriers from the TCO to a hole transport layer (HTL) is facilitated. A hole injection layer (HIL) may comprise poly-3,4-ethylendioxy thiophene (PEDOT), polystyrene sulfonate (PSS), $MoO_2$, $V_2O_5$, CuPC or CuI, in particular a mixture of PEDOT and PSS. A hole injection layer (HIL) may also prevent the diffusion of metals from an anode layer A into a hole transport layer (HTL). A HIL may exemplarily comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl) bis(N1-phenyl-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)-benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).
Adjacent to an anode layer A or a hole injection layer (HIL), typically a hole transport layer (HTL) is located. Herein, any hole transport compound may be used. Exemplarily, electron-rich heteroaromatic compounds such as triarylamines and/or carbazoles may be used as hole transport compound. A HTL may decrease the energy barrier between an anode layer A and a light-emitting layer B (serving as emitting layer (EML)). A hole transport layer (HTL) may also be an electron blocking layer (EBL). Preferably, hole transport compounds bear comparably high energy levels of their triplet states T1. Exemplarily a hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)-amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, a HTL may comprise a p-doped layer, which may be composed of an inorganic or organic dopant in an organic hole-transporting matrix. Transition metal

oxides such as vanadium oxide, molybdenum oxide or tungsten oxide may exemplarily be used as inorganic dopant. Tetrafluorotetracyanoquinodimethane (F4-TCNQ), copper-pentafluorobenzoate (Cu(I)pFBz) or transition metal complexes may exemplarily be used as organic dopant.

An electron blocking layer (EBL) may exemplarily comprise mCP (1,3-bis(carbazol-9-yl)benzene), TCTA, 2-TNATA, mCBP (3,3-di(9H-carbazol-9-yl)biphenyl), 9-[3-(dibenzofuran-2-yl)phenyl]-9*H*-carbazole, 9-[3-(dibenzofuran-2-yl)phenyl]-9*H*-carbazole, 9-[3-(dibenzothiophen-2-yl)phenyl]-9*H*-carbazole, 9-[3,5-bis(2-dibenzofuranyl)phenyl]-9*H*-carbazole, 9-[3,5-bis(2-dibenzothiophenyl)phenyl]-9*H*-carbazole, tris-Pcz, CzSi (9-(4-tert-butylphenyl)-3,6-bis(triphenylsilyl)-9H-carbazole), and/or DCB (N,N'-dicarbazolyl-1,4-dimethylbenzene).

The composition of the one or more light-emitting layers B has been described above. Any of the one or more light-emitting layers B according to the invention preferably bears a thickness of not more than 1 mm, more preferably of not more than 0.1 mm, even more preferably of not more than 10 μm, even more preferably of not more than 1 μm, and particularly preferably of not more than 0.1 μm.

In an electron transport layer (ETL), any electron transporter may be used. Exemplarily, compounds poor of electrons such as, e.g., benzimidazoles, pyridines, triazoles, oxadiazoles (e.g., 1,3,4-oxadiazole), phosphinoxides and sulfone, may be used. Exemplarily, an electron transporter ETM (i.e. an electron transport material) may also be a star-shaped heterocycle such as 1,3,5-tri(1-phenyl-1H-benzo[d]imidazol-2-yl)phenyl (TPBi). An ETM may exemplarily be NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the electron transport layer may be doped with materials such as Liq (8-hydroxyquinolinolatolithium). Optionally, a second electron transport layer may be located between electron transport layer and cathode layer C. An electron transport layer (ETL) may also block holes or a hole-blocking layer (HBL) is introduced.

An HBL may, for example, comprise HBM1:

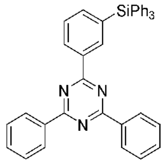,

BCP (2,9-dimethyl-4,7-diphenyl-1,10-phenanthroline = Bathocuproine), BAlq (bis(8-hydroxy-2-methylquinoline)-(4-phenylphenoxy)aluminum), NBphen (2,9-bis(naphthalen-2-yl)-4,7-diphenyl-1,10-phenanthroline), Alq3 (Aluminum-tris(8-hydroxyquinoline)), TSPO1 (diphenyl-4-triphenylsilylphenyl-phosphinoxide), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine), DTST (2,4-diphenyl-6-(3'-triphenylsilylphenyl)-1,3,5-triazine), DTDBF (2,8-bis(4,6-diphenyl-1,3,5-triazinyl)dibenzofurane) and/or TCB/TCP (1,3,5-tris(N-carbazolyl)benzol/ 1,3,5-tris(carbazol)-9-yl) benzene).

Adjacent to an electron transport layer (ETL), a cathode layer C may be located. Exemplarily, a cathode layer C may comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, a cathode layer C may also consist of (essentially) intransparent (non-transparent) metals such as Mg, Ca or Al. Alternatively or additionally, a cathode layer C may also comprise graphite and or carbon nanotubes (CNTs). Alternatively, a cathode layer C may also consist of nanoscale silver wires.

In a preferred embodiment, the organic electroluminescent device comprises at least the following layers:

A) an anode layer A containing at least one component selected from the group consisting of indium tin oxide, indium zinc oxide, PbO, SnO, graphite, doped silicium, doped germanium, doped GaAs, doped polyaniline, doped polypyrrole, doped polythiophene, and mixtures of two or more thereof;

B) a light-emitting layer B according to present invention as described herein; and

C) a cathode layer C containing at least one component selected from the group consisting of Al, Au, Ag, Pt, Cu, Zn, Ni, Fe, Pb, In, W, Pd, LiF, Ca, Ba, Mg, and mixtures or alloys of two or more thereof,

wherein the light-emitting layer B is located between the anode layer A and the a cathode layer C.

In one embodiment, when the organic electroluminescent device is an OLED, it may optionally comprise the following layer structure:

A) an anode layer A, exemplarily comprising indium tin oxide (ITO);

HTL) a hole transport layer HTL;

B) a light-emitting layer B according to present invention as described herein; ETL) an electron transport layer ETL; and

C) a cathode layer, exemplarily comprising Al, Ca and/or Mg.

Preferably, the order of the layers herein is A - HTL - B - ETL - C.

Furthermore, the organic electroluminescent device may optionally comprise one or more protective layers protecting the device from damaging exposure to harmful species in the environment including, exemplarily moisture, vapor and/or gases.

An electroluminescent device (e.g., an OLED) may further, optionally, comprise a protection layer between an electron transport layer (ETL) D and a cathode layer C (which may be designated as electron injection layer (EIL)). This layer may comprise lithium fluoride, caesium fluoride, silver, Liq (8-hydroxyquinolinolatolithium), $Li_2O$, $BaF_2$, MgO and/or NaF.

Unless otherwise specified, any of the layers, including any of the sublayers, of the various embodiments may be deposited by any suitable method. The layers in the context of the present invention, including at least one light-emitting layer B (which may consist of a single (sub)layer or may comprise more than one sublayers) and/or one or more sublayers thereof, may optionally be prepared by means of liquid processing (also designated as "film processing", "fluid processing", "solution processing" or "solvent processing"). This means that the components comprised in the respective layer are applied to the surface of a part of a device in liquid state. Preferably, the layers in the context of the present invention, including the at least one light-emitting layer B and/or one or more sublayers thereof, may be prepared by means of spin-coating. This method well-known to those skilled in the art allows obtaining thin and (essentially) homogeneous layers and/or sublayers.

Alternatively, the layers in the context of the present invention, including the at least one light-emitting layer B and/or one or more sublayers thereof, may be prepared by other methods based on liquid processing such as, e.g., casting (e.g., drop-casting) and rolling methods, and printing methods (e.g., inkjet printing, gravure printing, blade coating). This may optionally be carried out in an inert atmosphere (e.g., in a nitrogen atmosphere).

In another preferred embodiment, the layers in the context of the present invention, including the at least one light-emitting layer B and/or one or more sublayers thereof, may be prepared by any other method known in the art, including but not limited to vacuum processing methods well-known to those skilled in the art such as, e.g., thermal (co-) evaporation, organic vapor phase deposition (OVPD), and deposition by organic vapor jet printing (OVJP).

When preparing layers, optionally including one or more sublayers thereof, by means of liquid processing, the solutions including the components of the (sub)layers (i.e., with respect to the light-emitting layer B of the present invention one or more excitation energy transfer components EET-1, one or more hole scavengers $H_{scav}$, one or more small FWHM emitters $S^B$, and optionally one or more host materials $H^B$,) may further comprise a volatile organic solvent. Such volatile organic solvent may optionally be one selected from the group consisting of tetrahydrofuran, dioxane, chlorobenzene, diethylene glycol diethyl ether, 2-(2-ethoxyethoxy)ethanol, gamma-butyrolactone, N-methyl pyrrolidinon, ethoxyethanol, xylene, toluene, anisole, phenetol, acetonitrile, tetrahydrothiophene, benzonitrile, pyridine, trihydrofuran, triarylamine, cyclohexanone, acetone, propylene carbonate, ethyl acetate, benzene and PGMEA (propylen glycol monoethyl ether acetate). Also a combination of two or more solvents may be used. After applied in liquid state, the layer may subsequently be dried and/or hardened by any means of the art, exemplarily at ambient conditions, at increased temperature (e.g., about 50°C or about 60°C) or at diminished pressure.

The organic electroluminescent device as a whole may also form a thin layer of a thickness of not more than 5 mm, not more than 2 mm, not more than 1 mm, not more than 0.5 mm, not more than 0.25 mm, not more than 100 μm, or not more than 10 μm.

An organic electroluminescent device (e.g., an OLED) may be small-sized (e.g., having a surface not larger than 5 $mm^2$, or even not larger than 1 $mm^2$), medium-sized (e.g., having a surface in the range of 0.5 to 20 $cm^2$), or a large-sized (e.g., having a surface larger than 20 $cm^2$). An organic electroluminescent device (e.g., an OLED) according to the present invention may optionally be used for generating screens, as large-area illuminating device, as luminescent wallpaper, luminescent window frame or glass, luminescent label, luminescent poser or flexible screen or display. Next to the common uses, an organic electroluminescent device (e.g., an OLED) may exemplarily also be used as luminescent films, "smart packaging" labels, or innovative design elements. Further they are usable for cell detection and examination (e.g., as bio labelling).

*Further definitions and information*

As used throughout, the term "layer" in the context of the present invention preferably refers to a body that bears an extensively planar geometry. It is understood that the same is true for all "sublayers" which a layer may compose.

As used herein, the terms organic electroluminescent device and optoelectronic device and organic light-emitting device may be understood in the broadest sense as any device comprising one or more light-emitting layers B,

each as a whole comprising one or more excitation energy transfer components EET-1, one or more hole scavengers $H_{scav}$, one or more small FWHM emitters $S^B$, and optionally one or more host materials $H^B$, for all of which the above-mentioned definitions and preferred embodiments may apply.

The organic electroluminescent device may be understood in the broadest sense as any device based on organic materials that is suitable for emitting light in the visible or nearest ultraviolet (UV) range, i.e., in the wavelength range from 380 to 800 nm. Preferably, an organic electroluminescent device may be able to emit light in the visible range, i.e., from 400 to 800 nm.

Preferably, an organic electroluminescent device has a main emission peak in the visible range, i.e., from 380 to 800 nm, more preferably from 400 to 800 nm.

In one embodiment of the invention, the organic electroluminescent device emits green light from 500 to 560 nm. In one embodiment of the invention, the organic electroluminescent device has a main emission peak in the range of from 500 to 560 nm. In one embodiment of the invention, the organic electroluminescent device has an emission maximum of the main emission peak in the range of from 500 to 560 nm.

In a preferred embodiment of the invention, the organic electroluminescent device emits green light from 510 to 550 nm. In a preferred embodiment of the invention, the organic electroluminescent device has a main emission peak in the range of from 510 to 550 nm. In a preferred embodiment of the invention, the organic electroluminescent device has an emission maximum of the main emission peak in the range of from 510 to 550 nm.

In a particularly preferred embodiment of the invention, the organic electroluminescent device emits green light from 515 to 540 nm. In another particularly preferred embodiment of the invention, the organic electroluminescent device has a main emission peak in the range of from 515 to 540 nm. In a particularly preferred embodiment of the invention, the organic electroluminescent device has an emission maximum of the main emission peak in the range of from 515 to 540 nm.

In one embodiment of the invention, the organic electroluminescent device emits blue light from 420 to 500 nm. In one embodiment of the invention, the organic electroluminescent device has a main emission peak in the range of from 420 to 500 nm. In one embodiment of the invention, the organic electroluminescent device has an emission maximum of the main emission peak in the range of from 420 to 500 nm.

In a preferred embodiment of the invention, the organic electroluminescent device emits blue light from 440 to 480 nm. In a preferred embodiment of the invention, the organic electroluminescent device has a main emission peak in the range of from 440 to 480 nm. In a preferred embodiment of the invention, the organic electroluminescent device has an emission maximum of the main emission peak in the range of from 440 to 480 nm.

In a particularly preferred embodiment of the invention, the organic electroluminescent device emits blue light from 450 to 470 nm. In a particularly preferred embodiment of the invention, the organic electroluminescent device has a main emission peak in the range of from 450 to 470 nm. In a particularly preferred embodiment of the invention, the organic electroluminescent device has an emission maximum of the main emission peak in the range of from 450 to 470 nm.

In one embodiment of the invention, the organic electroluminescent device emits red or orange light from 590 to 690 nm. In one embodiment of the invention, the organic electroluminescent device has a main emission peak in the range of from 590 to 690 nm. In one embodiment of the invention, the organic electroluminescent device has an emission maximum of the main emission peak in the range of from 590 to 690 nm.

In a preferred embodiment of the invention, the organic electroluminescent device emits red or orange light from 610 to 665 nm. In a preferred embodiment of the invention, the organic electroluminescent device has a main emission peak in the range of from 610 to 665 nm. In a preferred embodiment of the invention, the organic electroluminescent device has an emission maximum of the main emission peak in the range of from 610 to 665 nm.

In a particularly preferred embodiment of the invention, the organic electroluminescent device emits red light from 620 to 640 nm. In one embodiment of the invention, the organic electroluminescent device has a main emission peak in the range of from 620 to 640 nm. In a particularly preferred embodiment of the invention, the organic electroluminescent device has an emission maximum of the main emission peak in the range of from 620 to 640 nm.

In a preferred embodiment of the invention, the organic electroluminescent device is a device selected from the group consisting of an organic light-emitting diode (OLED), a light-emitting electrochemical cell (LEC), and a light-emitting transistor.

Particularly preferably, the organic electroluminescent device is an organic light-emitting diode (OLED). Optionally, the organic electroluminescent device as a whole may be intransparent (non-transparent), semi-transparent or (essentially) transparent.

As used throughout the present application, the term "cyclic group" may be understood in the broadest sense as any mono-, bi- or polycyclic moieties.

As used throughout the present application, the terms "ring" and "ring system" may be understood in the broadest sense as any mono-, bi- or polycyclic moieties.

The term "ring atom" refers to any atom which is part of the cyclic core of a ring or a ring structure, and not part of a substituent optionally attached to it.

As used throughout the present application, the term "carbocycle" may be understood in the broadest sense as any cyclic group in which the cyclic core structure comprises only carbon atoms that may of course be substituted with hydrogen or any other substituents defined in the specific embodiments of the invention. It is understood that the term "carbocyclic" as adjective refers to cyclic groups in which the cyclic core structure comprises only carbon atoms that may of course be substituted with hydrogen or any other substituents defined in the specific embodiments of the invention. It is understood that the term "carbocycle" or a "carbocyclic ring system" may refer to both, an aliphatic and an aromatic cyclic group or ring system.

As used throughout the present application, the term "heterocycle" may be understood in the broadest sense as any cyclic group in which the cyclic core structure comprises not just carbon atoms, but also at least one heteroatom. It is understood that the term "heterocyclic" as adjective refers to cyclic groups in which the cyclic core structure comprises not just carbon atoms, but also at least one heteroatom. The heteroatoms may, unless stated otherwise in specific embodiments, at each occurrence be the same or different and be individually selected from the group consisting of N, O, S, and Se. All carbon atoms or heteroatoms comprised in a heterocycle in the context of the invention may of course be substituted with hydrogen or any other substituents defined in the specific embodiments of the invention. It is understood that the term "heterocycle" or a "heterocyclic ring system" may refer to both, an aliphatic and a heteroaromatic cyclic group or ring system.

As used throughout the present application, the term "aromatic ring system" may be understood in the broadest sense as any bi- or polycyclic aromatic moiety.

As used throughout the present application, the term "heteroaromatic ring system" may be understood in the broadest sense as any bi- or polycyclic heteroaromatic moiety.

As used throughout the present application, the term "fused" when referring to aromatic or heteroaromatic ring systems means that the aromatic or hetroaromatic rings that are "fused" share at least one bond that is part of both ring systems. For example naphthalene (or naphthyl when referred to as substituent) or benzothiophene (or benzothiophenyl when referred to as substituent) are considered fused aromatic ring systems in the context of the present invention, in which two benzene rings (for naphthalene) or a thiophene and a benzene (for benzothiophene) share one bond. It is also understood that sharing a bond in this context includes sharing the two atoms that build up the respective bond and that fused aromatic or heteroaromatic ring systems can be understood as one aromatic or heteroaromatic system. Additionally, it is understood, that more than one bond may be shared by the aromatic or heteroaromatic rings building up a fused aromatic or heteroaromatic ring system (e.g. in pyrene). Furthermore, it will be understood that aliphatic ring systems may also be fused and that this has the same meaning as for aromatic or heteroaromatic ring systems, with the exception of course, that fused aliphatic ring systems are not aromatic.

As used throughout the present application, the terms "aryl" and "aromatic" may be understood in the broadest sense as any mono-, bi- or polycyclic aromatic moieties. Herein, unless indicated differently in specific embodiments, an aryl group preferably contains 6 to 60 aromatic ring atoms, and a heteroaryl group preferably contains 5 to 60 aromatic ring atoms, of which at least one is a heteroatom. Notwithstanding, throughout the application the number of aromatic ring atoms (in particular of aromatic ring atoms that are carbon atoms) may be given as subscripted number in the definition of certain substituents. In particular, the heteroaromatic ring includes one to three heteroatoms. Again, the terms "heteroaryl" and "heteroaromatic" may be understood in the broadest sense as any mono-, bi- or polycyclic hetero-aromatic moieties that include at least one heteroatom. The heteroatoms may at each occurrence be the same or different and be individually selected from the group consisting of N, O, S, and Se. Accordingly, the term "arylene" refers to a divalent substituent that bears two binding sites to other molecular structures and thereby serving as a linker structure. In case, a group in the exemplary embodiments is defined differently from the definitions given here, for example, the number of aromatic ring atoms or number of heteroatoms differs from the given definition, the definition in the exemplary embodiments is to be applied. According to the invention, a condensed (annulated) aromatic or heteroaromatic polycycle is built of two or more single aromatic or heteroaromatic cycles, which formed the polycycle via a condensation reaction.

In particular, as used throughout the present application the term "aryl group" or "heteroaryl group" comprises groups which can be bound via any position of the aromatic or heteroaromatic group, derived from benzene, naphthalene, anthracene, phenanthrene, pyrene, dihydropyrene, chrysene, perylene, fluoranthene, benzanthracene, benzphenanthrene, tetracene, pentacene, benzpyrene, furan, benzofuran, isobenzofuran, dibenzofuran, thiophene, benzothiophene, isobenzothiophene, dibenzothiophene; selenophene, benzoselenophene, isobenzoselenophene, dibenzoselenophene; pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthoimidazole, phenanthroimidazole, pyridoimidazole, pyrazinoimidazole, quinoxalinoimidazole, oxazole, benzoxazole, napthooxazole, anthroxazol, phenanthroxazol, isoxazole, 1,2-thiazole, 1,3-thiazole, benzothiazole, pyridazine, benzopyridazine, pyrimidine, benzopyrimidine, 1,3,5-triazine, quinoxaline, pyrazine, phenazine, naphthyridine, carboline, benzocarboline, phenanthroline, 1,2,3-triazole, 1,2,4-triazole, benzotriazole, 1,2,3-oxadiazole, 1,2,4-oxadiazole, 1,2,5-oxadiazole, 1,2,3,4-tetrazine, purine, pteridine, indolizine and benzothiadiazole or combinations of the abovementioned groups.

In certain embodiments of the invention, adjacent substituents bonded to an aromatic or heteroaromatic ring may together form an additional mono- or polycyclic aliphatic or aromatic or heteroaromatic, carbocyclic or heterocyclic ring system which is fused to the aromatic or heteroaromatic ring to which the substituents are bonded. It is understood that the optionally so formed fused ring system will be larger (meaning it comprises more ring atoms) than the aromatic or heteroaromatic ring to which the adjacent substituents are bonded. In these cases, the "total" amount of ring atoms comprised in the fused ring system is to be understood as the sum of ring atoms comprised in the aromatic or heteroaromatic ring to which the adjacent substituents are bonded and the ring atoms of the additional ring system formed by the adjacent substituents, wherein, however, the carbon atoms that are shared by the ring systems which are fused are counted once and not twice. For example, a benzene ring may have two adjacent substituents that form another benzene ring so that a naphthalene core is built. This naphthalene core then comprises 10 ring atoms as two carbon atoms are shared by the two benzene rings and thus only counted once and not twice. The term "adjacent substituents" in this context refers to substituents attached to the same or to neighboring ring atoms (e.g., of a ring system).

As used throughout the present application, the term "aliphatic" when referring to ring systems may be understood in the broadest sense and means that none of the rings that build up the ring system is an aromatic or heteroaromatic ring. It is understood that such an aliphatic ring system may be fused to one or more aromatic or heteroaromatic rings so that some (but not all) carbon- or heteroatoms comprised in the core structure of the aliphatic ring system are part of an attached aromatic or heteroaromatic ring.

As used above and herein, the term "alkyl group" may be understood in the broadest sense as any linear, branched, or cyclic alkyl substituent. In particular, the term alkyl comprises the substituents methyl (Me), ethyl (Et), n-propyl ($^n$Pr), i-propyl ($^i$Pr), cyclopropyl, n-butyl ($^n$Bu), i-butyl ($^i$Bu), s-butyl ($^s$Bu), t-butyl ($^t$Bu), cyclobutyl, 2-methylbutyl, n-pentyl, s-pentyl, t-pentyl, 2-pentyl, neo-pentyl, cyclopentyl, n-hexyl, s-hexyl, t-hexyl, 2-hexyl, 3-hexyl, neo-hexyl, cyclohexyl, 1-methylcyclopentyl, 2-methylpentyl, n-heptyl, 2-heptyl, 3-heptyl, 4-heptyl, cycloheptyl, 1-methylcyclohexyl, n-octyl, 2-ethylhexyl, cyclooctyl, 1-bicyclo[2,2,2]octyl, 2-bicyclo[2,2,2]-octyl, 2-(2,6-dimethyl)octyl, 3-(3,7-dimethyl)octyl, adamantyl, 2,2,2-trifluorethyl, 1,1-dimethyl-n-hex-1-yl, 1,1-dimethyl-n-hept-1-yl, 1,1-dimethyl-n-oct-1-yl, 1,1-dimethyl-n-dec-1-yl, 1,1-dimethyl-n-dodec-1-yl, 1,1-dimethyl-n-tetradec-1-yl, 1,1-dimethyl-n-hexadec-1-yl, 1,1-dimethyl-n-octadec-1-yl, 1,1-diethyl-n-hex-1-yl, 1,1-diethyl-n-hept-1-yl, 1,1-diethyl-n-oct-1-yl, 1,1-diethyl-n-dec-1-yl, 1,1-diethyl-n-dodec-1-yl, 1,1-diethyl-n-tetradec-1-yl, 1,1-diethyln-n-hexadec-1-yl, 1,1-diethyl-n-octadec-1-yl, 1-(n-propyl)-cyclohex-1-yl, 1-(n-butyl)-cyclohex-1-yl, 1-(n-hexyl)-cyclohex-1-yl, 1-(n-octyl)-cyclohex-1-yl and 1-(n-decyl)-cyclohex-1-yl.

As used above and herein, the term "alkenyl" comprises linear, branched, and cyclic alkenyl substituents. The term alkenyl group exemplarily comprises the substituents ethenyl, propenyl, butenyl, pentenyl, cyclopentenyl, hexenyl, cyclohexenyl, heptenyl, cycloheptenyl, octenyl, cyclooctenyl or cyclooctadienyl.

As used above and herein, the term "alkynyl" comprises linear, branched, and cyclic alkynyl substituents. The term alkynyl group exemplarily comprises ethynyl, propynyl, butynyl, pentynyl, hexynyl, heptynyl or octynyl.

As used above and herein, the term "alkoxy" comprises linear, branched, and cyclic alkoxy substituents. The term alkoxy group exemplarily comprises methoxy, ethoxy, n-propoxy, i-propoxy, n-butoxy, i-butoxy, s-butoxy, t-butoxy and 2-methylbutoxy.

As used above and herein, the term "thioalkoxy" comprises linear, branched, and cyclic thioalkoxy substituents, in which the O of the exemplarily alkoxy groups is replaced by S.

As used above and herein, the terms "halogen" and "halo" may be understood in the broadest sense as being preferably fluorine, chlorine, bromine or iodine.

All hydrogen atoms (H) comprised in any structure referred to herein may at each occurrence independently of each other, and without this being indicated specifically, be replaced by deuterium (D). The replacement of hydrogen by deuterium is common practice and obvious for the person skilled in the art who also knows how to achieve this synthetically.

It is understood that when a molecular fragment is described as being a substituent or otherwise attached to another moiety, its name may be written as if it were a fragment (e.g. naphthyl, dibenzofuryl) or as if it were the whole molecule (e.g. naphthalene, dibenzofuran). As used herein, these different ways of designating a substituent or attached fragment are considered to be equivalent.

When referring to concentrations or compositions and unless stated otherwise, percentages refer to weight percentages, which has the same meaning as percent by weight or% by weight ((weight/weight), (w/w), wt.%).

Orbital and excited state energies can be determined either by means of experimental methods or by calculations employing quantum-chemical methods, in particular density functional theory calculations. Herein, the energy of the highest occupied molecular orbital $E^{HOMO}$ is determined by methods known to the person skilled in the art from cyclic voltammetry measurements with an accuracy of 0.1 eV.

The energy of the lowest unoccupied molecular orbital $E^{LUMO}$ may be determined by methods known to the person skilled in the art from cyclic voltammetry measurements with an accuracy of 0.1 eV. If $E^{LUMO}$ may be determined by cyclic voltammetry measurements, it will herein be denoted as $E_{CV}^{LUMO}$. Alternatively, and herein preferably, $E^{LUMO}$ is

calculated as $E^{HOMO}$ + $E^{gap}$, wherein the energy of the first excited singlet state S1 (vide infra) is used as $E^{gap}$, unless stated otherwise, for host materials $H^B$, TADF materials $E^B$, and small FWHM emitters $S^B$. This is to say that for host materials $H^B$, TADF materials $E^B$, and small FWHM emitters $S^B$, $E^{gap}$ is determined from the onset of the emission spectrum at room temperature (i.e. approx. 20°C) (steady-state spectrum; for TADF materials $E^B$ a spin-coated film of 10% by weight of $E^B$ in poly(methyl methacrylate), PMMA, is typically used; for small FWHM emitters $S^B$ a spin-coated film of 1-5%, preferably 2% by weight of $S^B$ in PMMA is typically used; for host materials $H^B$ a spin-coated neat film of the respective host material $H^B$ is typically used). For phosphorescence materials $P^B$, $E^{gap}$ is also determined from the onset of the emission spectrum at room temperature (i.e. approx. 20°C) (typically measured from a spin-coated film of 10% by weight of $P^B$ in PMMA).

Absorption spectra are recorded at room temperature (i.e. approximately 20°C). For TADF materials $E^B$, absorption spectra are typically measured from a spin-coated film of 10% by weight of $E^B$ in poly(methyl methacrylate) (PMMA). For small FWHM emitters $S^B$ absorption spectra are typically measured from a spin-coated film of 1-5%, preferably 2% by weight of $S^B$ in PMMA. For host materials $H^B$ absorption spectra are typically measured from a spin-coated neat film of the host material $H^B$. For phosphorescence materials $P^B$, absorption spectra are typically measured from a spin-coated film of 10% by weight of $P^B$ in PMMA. Alternatively, absorption spectra may also be recorded from solutions of the respective molecules, for example in dichloromethane or toluene, wherein the concentration of the solution is typically chosen so that the maximum absorbance preferably is in a range of 0.1 to 0.5.

The onset of an absorption spectrum is determined by computing the intersection of the tangent to the absorption spectrum with the x-axis. The tangent to the absorption spectrum is set at the low-energy side of the absorption band and at the point at half maximum of the maximum intensity of the absorption spectrum.

Unless stated otherwise, the energy of the first (i.e. the lowermost) excited triplet state T1 is determined from the onset the phosphorescence spectrum at 77K (for TADF materials $E^B$ a spin-coated film of 10% by weight of $E^B$ in PMMA is typically used; for small FWHM emitters $S^B$ a spin-coated film of 1-5%, preferably 2% by weight of $S^B$ in PMMA is typically used; for host materials $H^B$, a spin-coated neat film of the respective host material $H^B$ is typically used; for phosphorescence materials $P^B$ a spin-coated film of 10% by weight of $P^B$ in PMMA is typically used and the measurement is typically performed at room temperature (i.e. approximately 20°C). As laid out for instance in EP2690681A1, it is acknowledged that for TADF materials $E^B$ with small $\Delta E_{ST}$ values, intersystem crossing and reverse intersystem crossing may both occur even at low temperatures. In consequence, the emission spectrum at 77K may include emission from both, the S1 and the T1 state. However, as also described in EP2690681A1, the contribution / value of the triplet energy is typically considered dominant.

Unless stated otherwise, the energy of the first (i.e. the lowermost) excited singlet state S1 is determined from the onset the fluorescence spectrum at room temperature (i.e. approx. 20°C) (steady-state spectrum; for TADF materials $E^B$ a spin-coated film of 10% by weight of $E^B$ in PMMA is typically used; for small FWHM emitters $S^B$ a spin-coated film of 1-5%, preferably 2% by weight of $S^B$ in PMMA is typically used; for host materials $H^B$, a spin-coated neat film of the respective host material $H^B$ is typically used; for phosphorescence materials $P^B$ a spin-coated film of 10% by weight of $P^B$ in PMMA is typically used). For phosphorescence materials $P^B$ displaying efficient intersystem crossing however, room temperature emission may be (mostly) phosphorescence and not fluorescence. In this case, the onset of the emission spectrum at room temperature (i.e. approx. 20°C) is used to determine the energy of the first (i.e. the lowermost) excited triplet state T1 as stated above.

The onset of an emission spectrum is determined by computing the intersection of the tangent to the emission spectrum with the x-axis. The tangent to the emission spectrum is set at the high-energy side of the emission band and at the point at half maximum of the maximum intensity of the emission spectrum.

The $\Delta E_{ST}$ value, which corresponds to the energy difference between the first (i.e. the lowermost) excited singlet state (S1) and the first (i.e. the lowermost) excited triplet state (T1), is determined based on the first (i.e. the lowermost) excited singlet state energy and the first (i.e. the lowermost) excited triplet state energy, which were determined as stated above.

As known to the skilled artisan, the full width at half maximum (FWHM) of an emitter (for example a small FWHM emitter $S^B$) is readily determined from the respective emission spectrum (fluorescence spectrum for fluorescent emitters and phosphorescence spectrum for phosphorescent emitters). For small FWHM emitters $S^B$, the fluorescence spectrum is typically used. All reported, FWHM values typically refer to the main emission peak (i.e. the peak with the highest intensity). The means of determining the FWHM (herein preferably reported in electron volts, eV) are part of the common knowledge of those skilled in the art. Given for example that the main emission peak of an emission spectrum reaches its half maximum emission (i.e. 50% of the maximum emission intensity) at the two wavelengths $\lambda_1$ and $\lambda_2$, both obtained in nanometers (nm) from the emission spectrum, the FWHM in electron volts (eV) is commonly (and herein) determined using the following equation:

$$\text{FWHM [eV]} = \left| \frac{1239.84\ [eV \cdot nm]}{\lambda_2\ [nm]} - \frac{1239.84[eV \cdot nm]}{\lambda_1\ [nm]} \right| .$$

As used herein, if not defined more specifically in a particular context, the designation of the colors of emitted and/or absorbed light is as follows:

| | |
|---|---|
| violet: | wavelength range of >380-420 nm; |
| deep blue: | wavelength range of >420-475 nm; |
| sky blue: | wavelength range of >475-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

The invention is illustrated by the following examples and the claims.

*Description of Figures*

**Figure 1** gives a schematic layer structure of exemplary organic electroluminescent devices (in accordance with the setup 1 given in table 2, vide infra) as well as a close up view on the light-emitting layer (EML). Herein, the layers have the following meaning: S: glass substrate, 1: anode (layer), 2: hole injection layer (HIL), 3: hole transport layer 1 (HTL-1), 4: hole transport layer 2 (HTL-2), 5: electron blocking layer (EBL), 6: light-emitting layer (EML), which is optionally divided in sublayers, 7: hole blocking layer (HBL), 8: electron transport layer (ETL), 9: electron injection layer (EIL), and 10: cathode (layer). A light-emitting layer (EML) may comprise an imaginary boundary surface $S^{EML}$ dividing the EML in halves of equal volume. It is shown how the EML may be imaginarily divides in halves of equal volume by an imaginary boundary surface $S^{EML}$ to assess the distribution of the recombination zone over the imaginarily so-formed halves of the EML (see above).

## Examples

*Cyclic voltammetry*

Cyclic voltammograms of solutions having concentration of $10^{-3}$ mol/l of the organic molecules in dichloromethane or a suitable solvent and a suitable supporting electrolyte (e.g. 0.1 mol/l of tetrabutylammonium hexafluorophosphate) are measured. The measurements are conducted at room temperature (i.e. (approximately) 20 °C) and under nitrogen atmosphere with a three-electrode assembly (working and counter electrodes: Pt wire, reference electrode: Pt wire) and calibrated using $FeCp_2/FeCp_2^+$ as internal standard. HOMO and LUMO data was corrected using ferrocene as internal standard against SCE.

*Density functional theory calculation*

Molecular structures are optimized employing the BP86 functional and the resolution of identity approach (RI). Excitation energies are calculated using the (BP86) optimized structures employing Time-Dependent DFT (TD-DFT) methods. Orbital and excited state energies are calculated with the B3LYP functional. Def2-SVP basis sets and a m4-grid for numerical integration were used. The Turbomole program package was used for all calculations. However, herein, orbital and excited state energies are preferably determined experimentally as stated above. All orbital and excited state energies reported herein (see experimental results) have been determined experimentally.

*Photophysical measurements*

*Sample pretreatment: vacuum-evaporation*

As stated before, photophysical measurements of individual compounds (for example organic molecules or transition metal complexes) that may be comprised in a light-emitting layer B of the organic electroluminescent device according to the present invention (e.g. host materials $H^B$, host materials $host^{scav}$, TADF materials $E^B$, phosphorescence materials $P^B$, small FWHM emitters $S^B$ or fluorescence emitters F) were typically performed using either spin-coated neat films (in case of host materials $H^B$ or $host^{scav}$) or spin-coated films of the respective material in poly(methyl methacrylate)

(PMMA) (e.g. for TADF materials $E^B$, phosphorescence materials $P^B$, small FWHM emitters $S^B$, and fluorescence emitters F). These films were typically spin-coated films and, unless stated differently for specific measurements, the concentration of the materials in the PMMA-films was 10% by weight for TADF materials $E^B$ and for phosphorescent materials $P^B$ or 1-5%, preferably 2% by weight for small FWHM emitters $S^B$ and flurescence emitters F. Alternatively, and as stated previously, some photophysical measurements may also be performed from solutions of the respective molecules, for example in dichloromethane or toluene, wherein the concentration of the solution is typically chosen so that the maximum absorbance preferably is in a range of 0.1 to 0.5.

Apparatus: Spin150, SPS euro.
The sample concentration was 1.0 mg/ml, typically dissolved in Toluene/DCM as suitable solvent.
Program: 7- 30 sec. at 2000 U/min. After coating, the films were dried at 70 °C for 1 min.

For the purpose of further studying compositions of certain materials as present in the EML of organic electroluminescent devices (according to the present invention or comparative), the samples for photophysical measurements were produced from the same materials used for device fabrication by vacuum deposition of 50 nm of the respective light-emitting layer B on quartz substrates. Photophysical characterization of the samples are conducted under nitrogen atmosphere.

*Absorption measurements*

A Thermo Scientific Evolution 201 UV-Visible Spectrophotometer is used to determine the wavelength of the absorption maximum of the sample in the wavelength region above 270 nm. This wavelength is used as excitation wavelength for photoluminescence spectral and quantum yield measurements.

*Photoluminescence spectra*

Steady-state emission spectra are recorded using a Horiba Scientific, Modell FluoroMax-4 equipped with a 150 W Xenon-Arc lamp, excitation- and emissions monochromators. The samples are placed in a cuvette and flushed with nitrogen during the measurements.

*Photoluminescence quantum yield measurements*

For photoluminescence quantum yield (PLQY) measurements an integrating sphere, the *Absolute PL Quantum Yield Measurement C9920-03G* system *(Hamamatsu Photonics)* is used. The samples are kept under nitrogen atmosphere throughout the measurement. Quantum yields are determined using the software U6039-05 and given in%. The yield is calculated using the equation:

$$\Phi_{PL} = \frac{n_{photon}, emited}{n_{photon}, absorbed} = \frac{\int \frac{\lambda}{hc}\left[Int_{emitted}^{sample}(\lambda) - Int_{absorbed}^{sample}(\lambda)\right]d\lambda}{\int \frac{\lambda}{hc}\left[Int_{emitted}^{reference}(\lambda) - Int_{absorbed}^{reference}(\lambda)\right]d\lambda}$$

wherein $n_{photon}$ denotes the photon count and Int. is the intensity. For quality assurance, anthracene in ethanol (known concentration) is used as reference.

*TCSPC (Time-correlated single-photon counting)*

Unless stated otherwise in the context of certain embodiments or analyses, excited state population dynamics are determined employing Edinburgh Instruments FS5 Spectrofluoremeters, equipped with an emission monochromator, a temperature stabilized photomultiplier as detector unit and a pulsed LED (310 nm central wavelength, 910 ps pulse width) as excitation source. The samples are placed in a cuvette and flushed with nitrogen during the measurements.

To determine the average decay time $\bar{\tau}$ of a measured transient photoluminescence signal, the data is fitted with a sum of n exponential functions:

$$\sum_{i=1}^{n} A_i \exp\left(-\frac{t}{t_i}\right)$$

wherein n is an integer between 1 and 3. By weighting the specific decay time constants $\tau_i$ with the corresponding amplitudes $A_i$, the excited state lifetime $\bar{\tau}$ is determined:

$$\bar{\tau} = \frac{\sum_{i=1}^{n} A_i \tau_i}{\sum_{i=1}^{n} A_i}$$

The method may be applied for fluorescence and phosphorescence materials to determine the excited state lifetimes. For TADF materials, the full decay dynamics as described below need to be gathered.

*Full decay dynamics*

The full excited state population decay dynamics over several orders of magnitude in time and signal intensity is achieved by carrying out TCSPC measurements in 4 time windows: 200 ns, 1 μs, and 20 μs, and a longer measurement spanning > 80 μs. The measured time curves are then processed in the following way:

- A background correction is applied by determining the average signal level before excitation and subtracting.
- The time axes are aligned by taking the initial rise of the main signal as reference.
- The curves are scaled onto each other using overlapping measurement time regions.
- The processed curves are merged to one curve.

Data analysis is done using mono-exponential or bi-exponential fitting of prompt fluorescence (PF) and delayed fluorescence (DF) decays separately. By weighting the specific decay time constants $\tau_i$ from the fits with the corresponding amplitudes $A_i$, the average lifetime $\bar{\tau}$ for the prompt (i.e. the prompt fluorescence lifetime) and the delayed-fluorescence (i.e. the delayed fluorescence lifetime), respectively, may be determined as follows:

$$\bar{\tau} = \frac{\sum_{i=1}^{n} A_i \tau_i}{\sum_{i=1}^{n} A_i}$$

wherein n is either 1 or 2.

The ratio of delayed and prompt fluorescence (n- value) is calculated by the integration of respective photoluminescence decays in time.

$$\frac{\int I_{DF}(t)dt}{\int I_{PF}(t)dt} = n$$

*Transient photoluminescence measurements with spectral resolution*

In transient photoluminescence (PL) measurements with spectral resolution, PL spectra at defined delay times after pulsed optical excitation are recorded.

An exemplary device for measureing transient PL spectra comprises:

- a pulsed laser (eMOPA, CryLas) with a central wavelength of 355 nm and a pulse width of 1 ns to excite the sample.
- a sample chamber configured to house a sample that can be either evacuated or flushed with nitrogen.
- a spectrograph (SpectraPro HRS) to disperse light emitted from the sample.
- a CCD camera (Princeton Instruments PI-MAX4) for wavelength resolved detection of the dispersed emitted light, with integrated timing generator for synchronization with the pulsed laser.
- a personal computer configured to analyze the signal fom the CCD camera imported therinto.

In the course of the measurement, the sample is placed in the sample chamber and irradiated with the pulsed laser. Emitted light from the sample is taken in a 90 degree direction with respect to the irradiation direction of the laser pulses. It is dispersed by the spectrograph and directed onto the detector (the CCD camera in the exemplary device), thus obtaining a wavelength resolved emission spectrum. The time delay between laser irradiation and detection, and the duration (i.e. the gate time) of detection are controlled by the timing generator.

It should be noted, that transient photolumminescence may be measuered by a device different from the one described in the exemplary device.

*Production and characterization of organic electroluminescence devices*

Via vacuum-deposition methods OLED devices comprising organic molecules according to the invention can be produced. If a layer contains more than one compound, the weight-percentage of one or more compounds is given in%. The total weight-percentage values amount to 100%, thus if a value is not given, the fraction of this compound equals to the difference between the given values and 100%.

The not fully optimized OLEDs are characterized using standard methods and measuring electroluminescence spectra, the external quantum efficiency (in%) in dependency on the intensity, calculated using the light detected by the photodiode, and the current. The FWHM of the devices is determined from the electroluminescence spectra as stated previously for photoluminescence spectra (fluorescence or phosphorescence). The reported FWHM refers to the main emission peak (i.e. the peak with the highest emission intensity). The OLED device lifetime is extracted from the change of the luminance during operation at constant current density. The LT50 value corresponds to the time, where the measured luminance decreased to 50% of the initial luminance, analogously LT80 corresponds to the time point, at which the measured luminance decreased to 80% of the initial luminance, LT97 to the time point, at which the measured luminance decreased to 97% of the initial luminance etc.

Accelerated lifetime measurements are performed (e.g. applying increased current densities). Exemplarily LT80 values at 500 cd/m$^2$ are determined using the following equation:

$$\mathrm{LT80}\left(500\,\frac{cd^2}{m^2}\right) = \mathrm{LT80}(L_0)\left(\frac{L_0}{500\,\frac{cd^2}{m^2}}\right)^{1.6}$$

wherein $L_0$ denotes the initial luminance at the applied current density. The values correspond to the average of several pixels (typically two to eight).

*Experimental results*

Stack materials

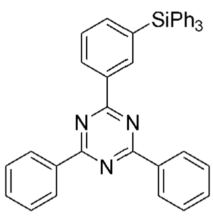

HBM1 (hole-blocking material)

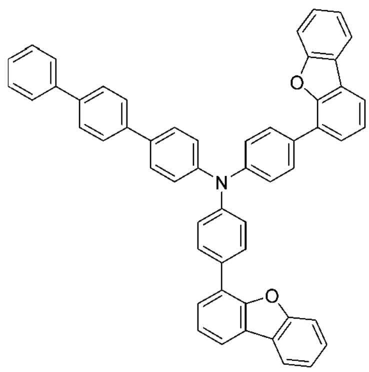

EBM1 (electron-blocking material)

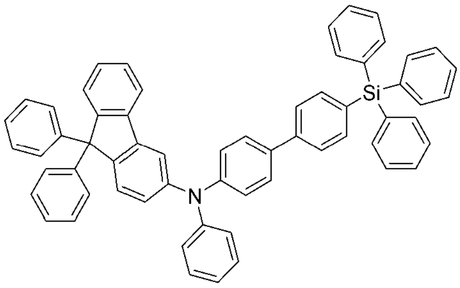

HTL1 (Hole-transport material)

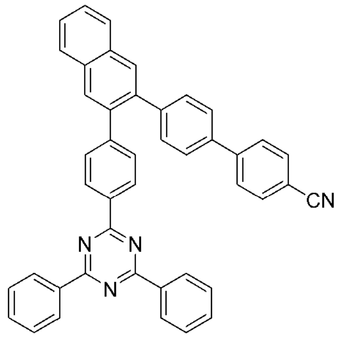

ETL1 (electron-transport material)

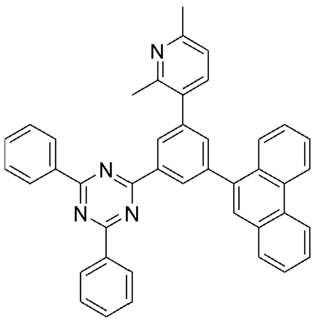

ETL2 (electron-transport material)

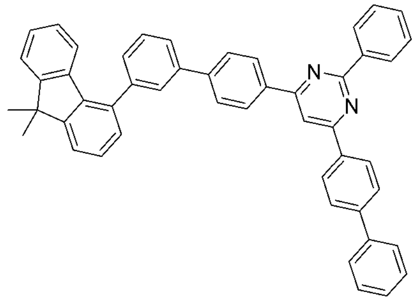

ETL3 (electron-transport material)

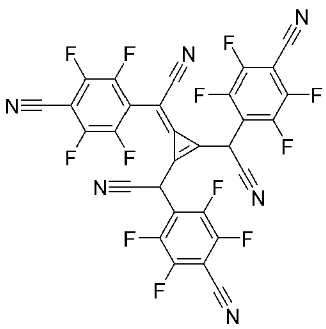

NDP-9 (hole-injection material)

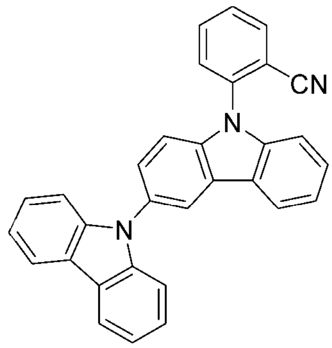

EBM2 (electron-blocking material)

Host materials $H^B$

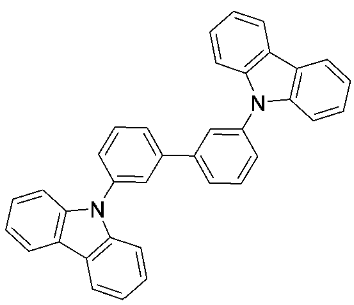

**mCBP = $H^B$-1**

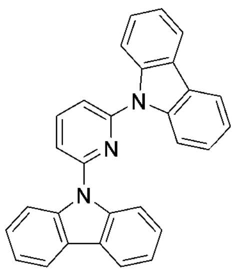

**PYD2 = $H^B$-2**

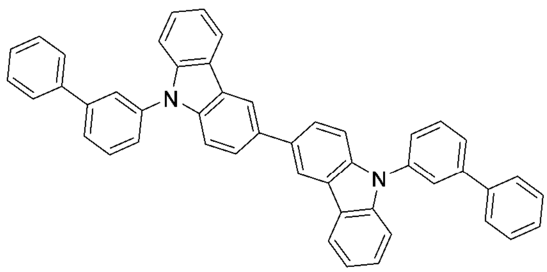

**$H^B$-3**

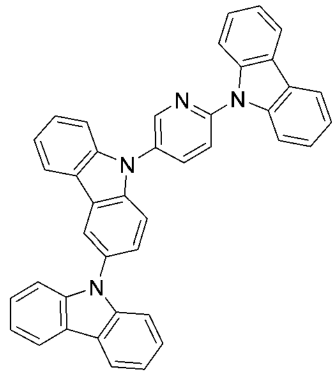

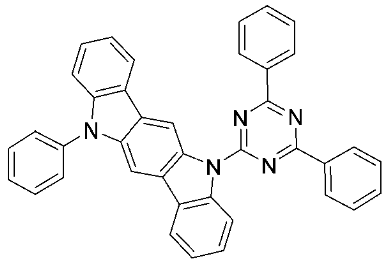

$H^B$-4 $H^B$-5

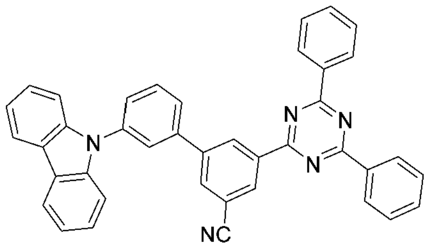

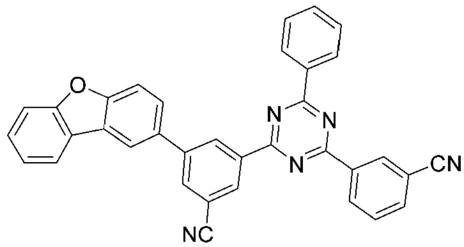

$H^B$-6 $H^B$-7

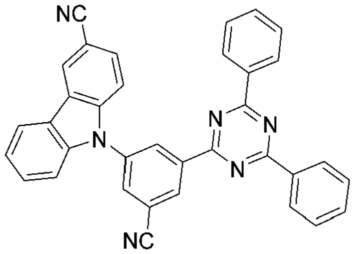

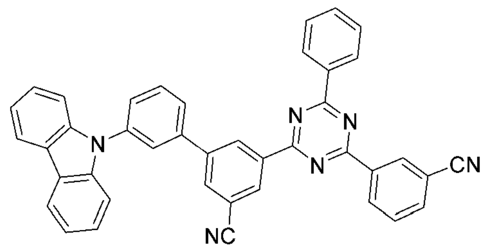

$H^B$-8 $H^B$-9

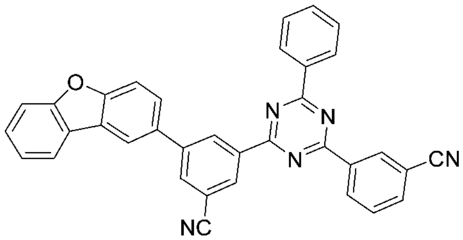

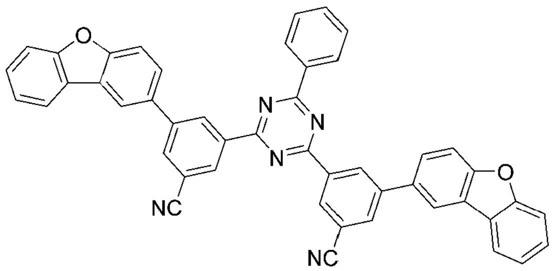

$H^B$-10 $H^B$-11

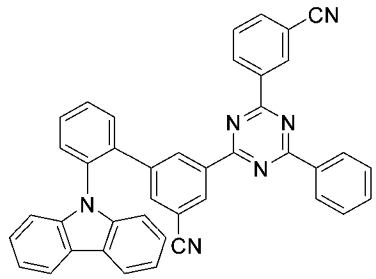

HB-12

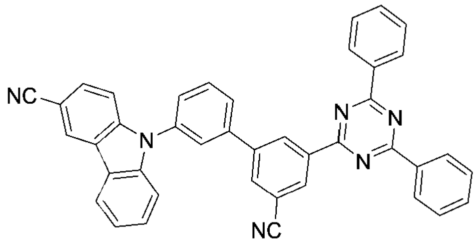

HB-13

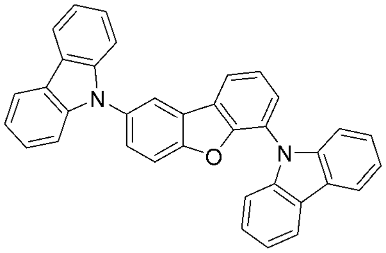

HB-14

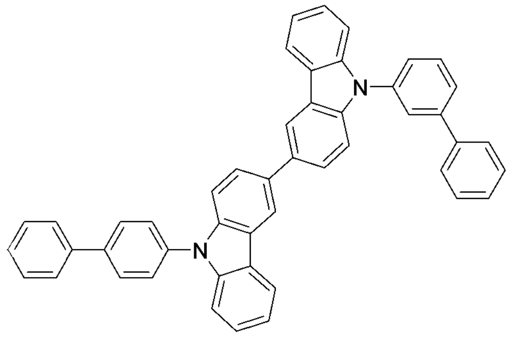

HB-15

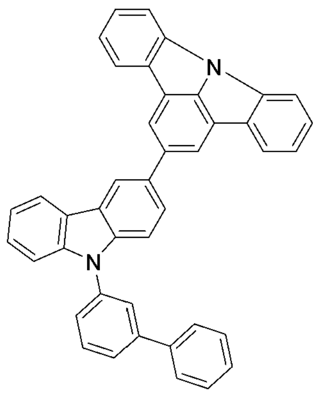

HB-16

**Table 1H.** Properties of the host materials.

| | Example compound | $E^{HOMO}$ [eV] | $E^{LUMO}$ [eV] | E(S1) [eV] | E(T1) [eV] |
|---|---|---|---|---|---|
| $H^B$ | HBM1 | | -2.91 | | 2.94 |
| | EBM1 | -5.54 | -2.46 | 3.08 | 2.36 |
| | mCBP | -6.02 | -2.42 | 3.6 | 2.82 |
| | PYD2 | -6.08 | -2.55 | 3.53 | 2.81 |
| | $H^B$-3 | -5.66 | -2.35 | 3.31 | 2.71 |
| | $H^B$-4 | -5.85 | -2.43 | 3.42 | 2.84 |
| | $H^B$-5 | -5.91 | -2.89 | 2.79 | |
| | $H^B$-6 | -5.94 | -2.93 | 3.01 | 2.78 |
| | $H^B$-7 | | | 3.27 | 2.71 |
| | $H^B$-8 | | | 2.94 | 2.70 |
| | $H^B$-9 | -5.97 | -3.10 | 2.88 | 2.77 |
| | $H^B$-10 | | | 3.15 | 2.75 |
| | $H^B$-11 | -6.04 | -3.10 | 2.94 | 2.86 |
| | $H^B$-12 | -6.23 | -3.02 | 3.21 | 2.76 |
| | $H^B$-13 | -6.23 | -3.12 | 3.21 | 2.76 |
| | $H^B$-14 | -5.99 | -2.48 | 3.51 | 2.97 |
| | $H^B$-15 | -5.64 | -2.36 | 3.28 | 2.70 |
| | $H^B$-16 | -5.68 | -2.55 | 3.13 | 2.81 |

**TADF materials $E^B$ that may be selected as excitation energy transfer component EET-1 or hole scavenger $H_{scav}$ (when $H_{scav}$ is EET-2)**

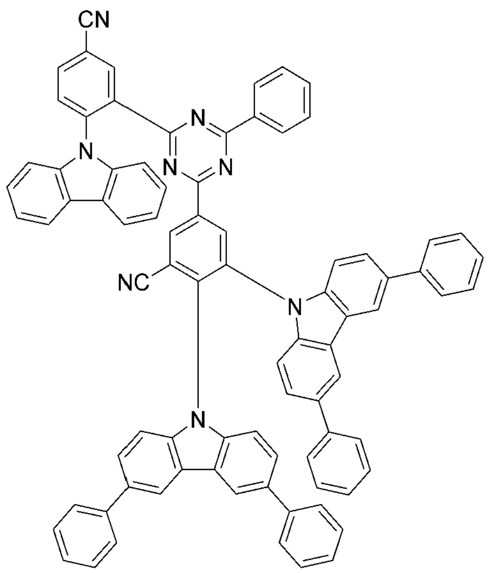

**$E^B$-1**

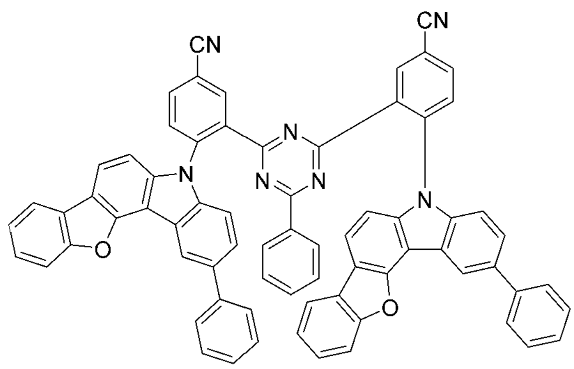

**$E^B$-2**

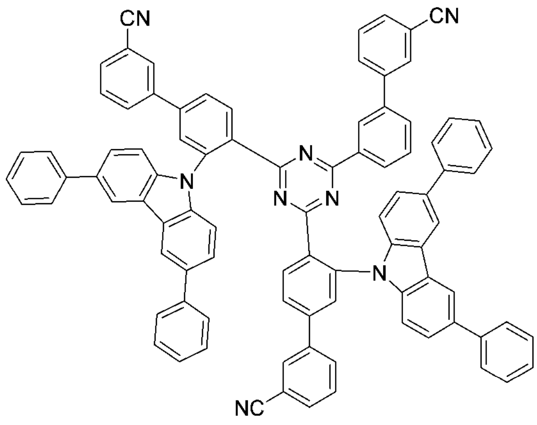

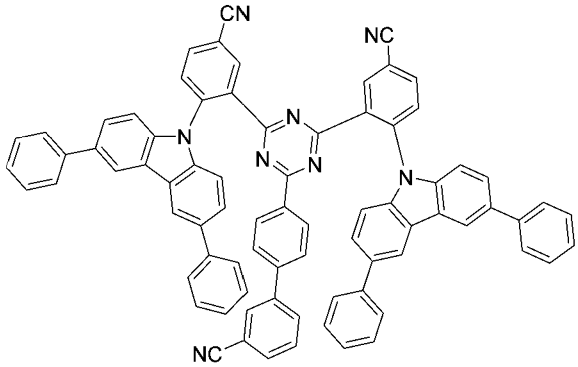

**E^B-3** **E^B-4**

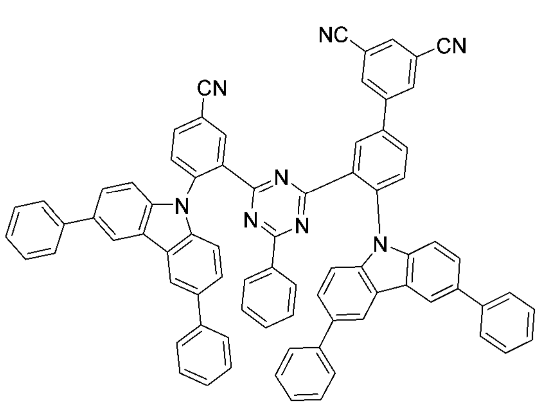

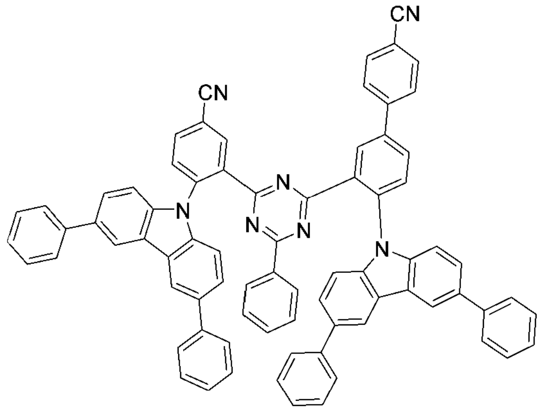

**E^B-5** **E^B-6**

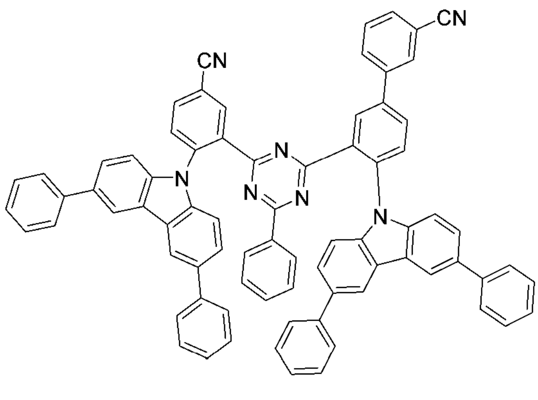

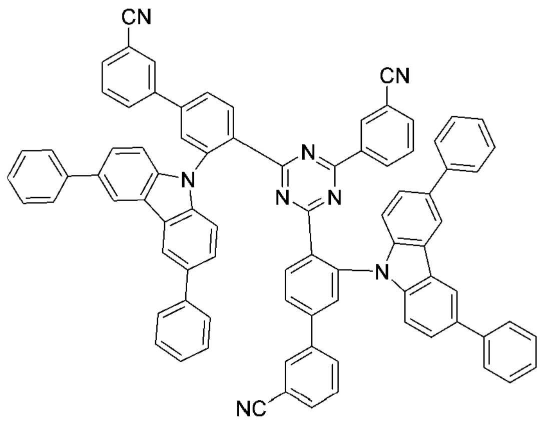

**E^B-7** **E^B-8**

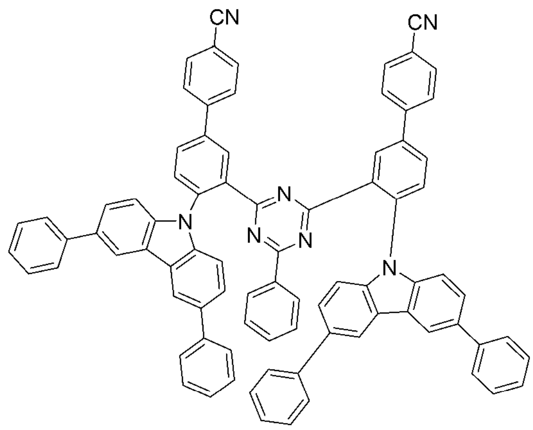

E^B-9

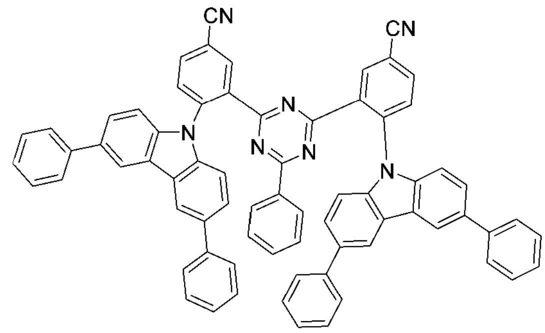

E^B-10

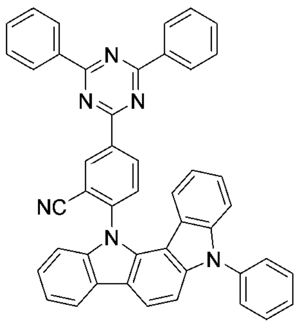

E^B-11

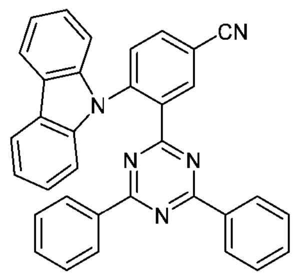

E^B-12

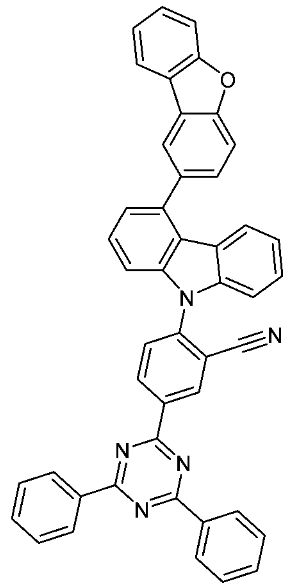

E^B-13

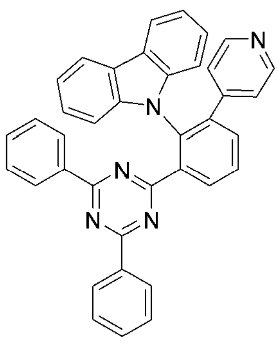

E^B-14

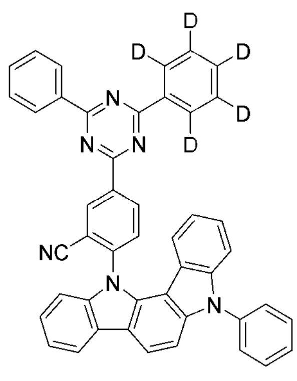

E^B-15

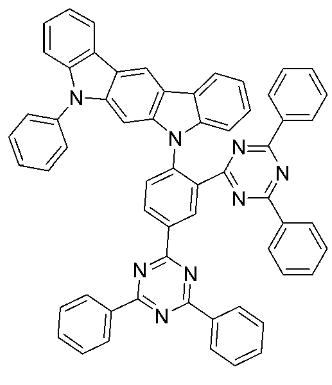

E^B-16

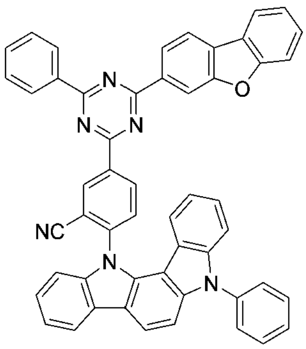

$E^B$-17

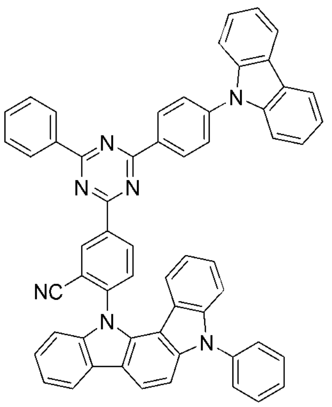

$E^B$-18

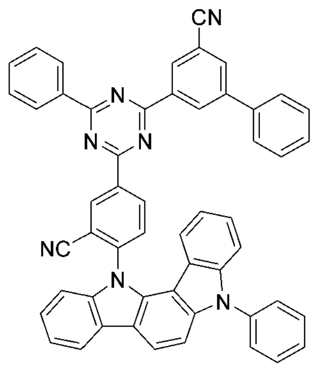

$E^B$-19

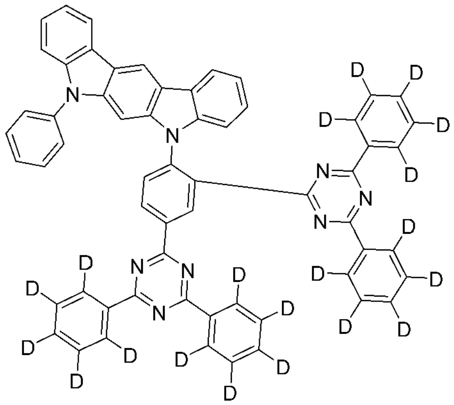

$E^B$-20

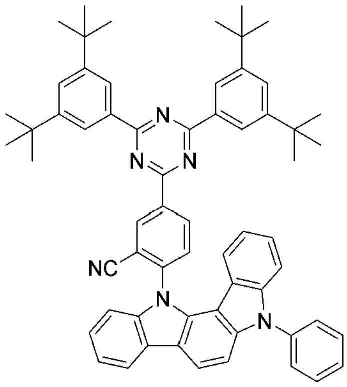

$E^B$-21

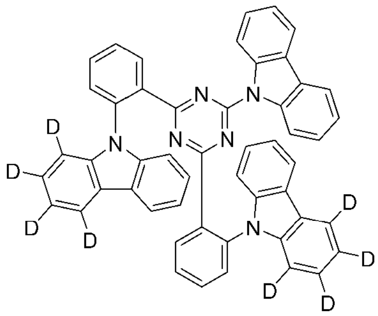

$E^B$-22

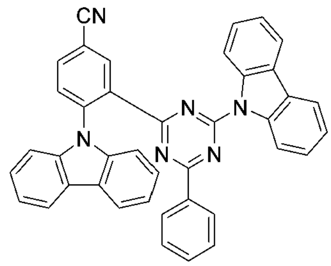

$E^B$-23

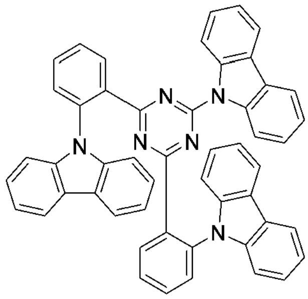

$E^B$-24

**Table 1E.** Properties of the TADF materials $E^B$.

| | Example compound | $E^{HOMO}$ [eV] | $E^{LUMO}$ [eV] | E(S1) [eV] | E(T1) [eV] | $\lambda_{max}^{PMMA}$ [nm] | FWHM [eV] | PLQY [%] |
|---|---|---|---|---|---|---|---|---|
| $E^B$ | **$E^B$-1** | -5.97 | -3.28 | 2.69 | 2.63 | 518 | 0.43 | 61 |
| | **$E^B$-2** | -5.97 | -3.31 | 2.66 | 2.72 | 526 | 0.43 | 43 |
| | **$E^B$-3** | -5.92 | -3.25 | 2.67 | 2.65 | 517 | 0.40 | 73 |
| | **$E^B$-4** | -6.00 | -3.37 | 2.63 | 2.65 | 525 | 0.40 | 54 |
| | **$E^B$-5** | -5.95 | -3.27 | 2.68 | 2.64 | 508 | 0.41 | 72 |
| | **$E^B$-6** | -5.94 | -3.24 | 2.70 | 2.64 | 509 | 0.41 | 74 |
| | **$E^B$-7** | -5.94 | -3.24 | 2.70 | 2.66 | 509 | 0.41 | 71 |
| | **$E^B$-8** | -5.93 | -3.33 | 2.60 | 2.59 | 525 | 0.39 | 71 |
| | **$E^B$-9** | -5.89 | -3.15 | 2.74 | 2.64 | 498 | 0.40 | 81 |
| | **$E^B$-10** | -5.99 | -3.34 | 2.65 | 2.65 | 520 | 0.42 | 54 |
| | **$E^B$-11** | -5.79 | -3.15 | 2.77 | 2.81 | 514 | 0.50 | 63 |
| | **$E^B$-12** | -6.07 | -3.19 | 2.88 | 2.80 | 477 | 0.42 | 83 |
| | **$E^B$-13** | -6.15 | -3.13 | 3.02 | 2.79 | 454 | 0.44 | 72 |
| | **$E^B$-14** | -6.03 | -3.01 | 3.02 | 2.97 | 459 | 0.45 | 72 |
| | **$E^B$-15** | -5.79 | -3.02 | 2.77 | 2.82 | 511 | 0.49 | 64 |
| | **$E^B$-16** | -5.71 | -3.07 | 2.64 | 2.59 | 517 | 0.38 | 68 |
| | **$E^B$-17** | -5.79 | -3.02 | 2.77 | 2.77 | 523 | 0.51 | 49 |
| | **$E^B$-18** | -5.80 | -3.04 | 2.76 | | 522 | 0.52 | 52 |
| | **$E^B$-19** | -5.80 | -3.14 | 2.67 | | 540 | 0.50 | 38 |
| | **$E^B$-20** | -5.71 | -3.06 | 2.65 | 2.60 | 510 | 0.37 | 69 |
| | **$E^B$-21** | -5.79 | -2.96 | 2.84 | 2.88 | 502 | 0.51 | 66 |
| | **$E^B$-22** | -5.97 | -2.94 | 2.92 | 2.87 | 473 | 0.44 | 79 |
| | **$E^B$-23** | -6.05 | -3.17 | 2.88 | 2.81 | 478 | 0.43 | 79 |
| | **$E^B$-24** | -5.92 | -3.00 | 2.92 | 2.87 | 475 | 0.44 | 79 |

**Phosphorescence materials $P^B$ that may be selected as excitation energy transfer component EET-1 or hole scavenger $H_{scav}$ (when $H_{scav}$ is EET-2)**

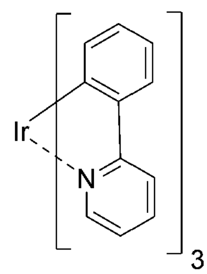

**Ir(ppy)3**

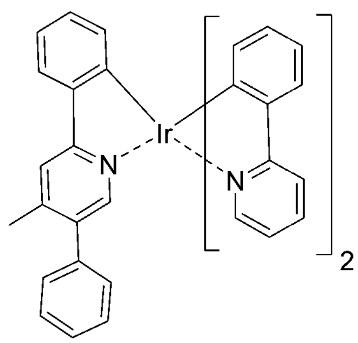

**$P^B$-2**

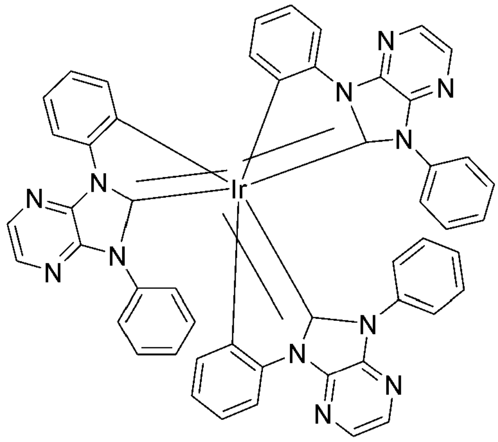

$P^B$-3

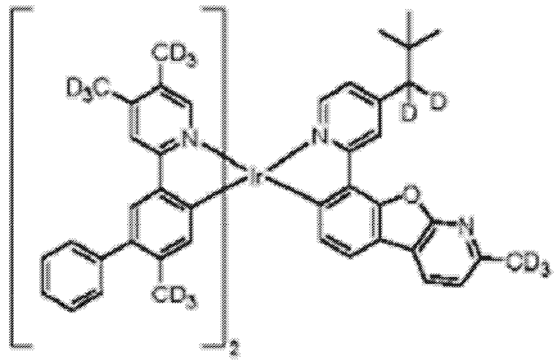

$P^B$-4

**Table 1P.** Properties of the materials.

| | Example compound | $E^{HOMO}$ [eV] | $E_{CV}^{LUMO}$ [eV] | $E^{LUMO}$ [eV] | E(S1) [eV] | E(T1) [eV] | $\lambda_{max}^{PMMA}$ [nm] | FWHM [eV] |
|---|---|---|---|---|---|---|---|---|
| $P^B$ | **Ir(ppy)$_3$** | -5.36 | | | | 2.56a | 509 | 0.38 |
| | **$P^B$-2** | -5.33 | -2.32 | | | 2.57[b] | 522 | 0.34 |
| | **$P^B$-3** | -5.80 | -2.67 | | | 2.88[c] | 482 | 0.40 |
| | **$P^B$-4** | -5.24 | | | | | | |

wherein $E_{CV}^{LUMO}$ is the energy of the lowest unoccupied molecular orbital, which is determined by cyclic voltammetry. [a]The emission spectrum was recorded from a solution of Ir(ppy)$_3$ in chloroform. The emission spectrum was recorded from a 0.001 mg/mL solution of $P^B$-2 in dichloromethane. [c]The emission spectrum was recorded from a 0.001 mg/mL solution of $P^B$-3 in toluene.

**Small FWHM emitters $S^B$ (may also be used as fluorescence emitters F and/or may be used as hole scavengers $H_{scav}$)**

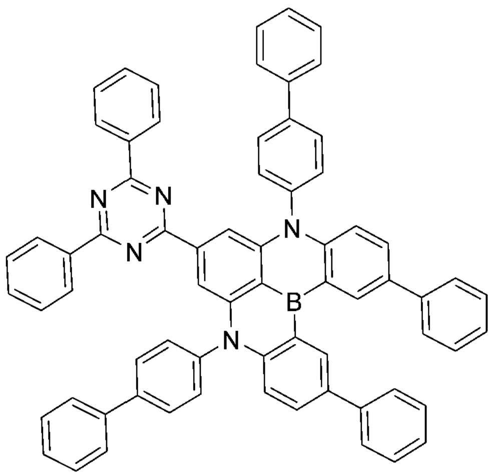

$S^B$-1

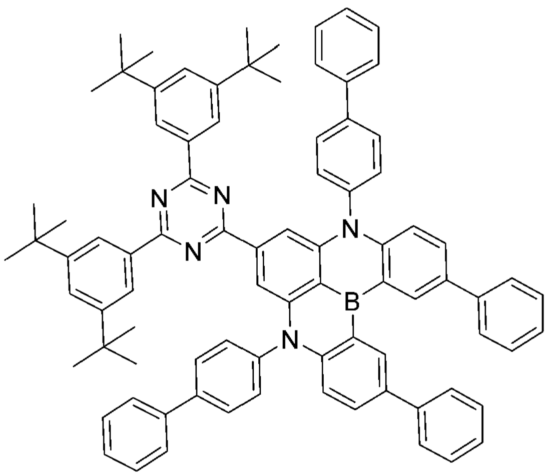

$S^B$-2

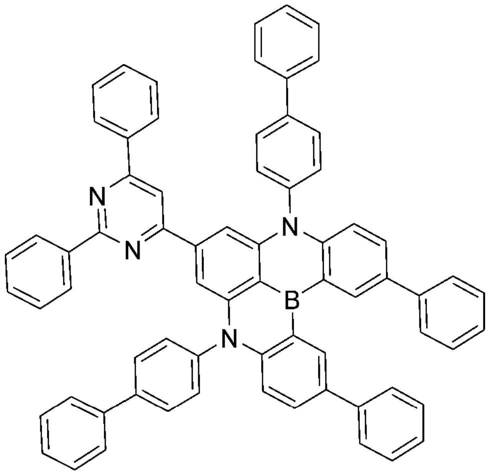

**S^B-3**

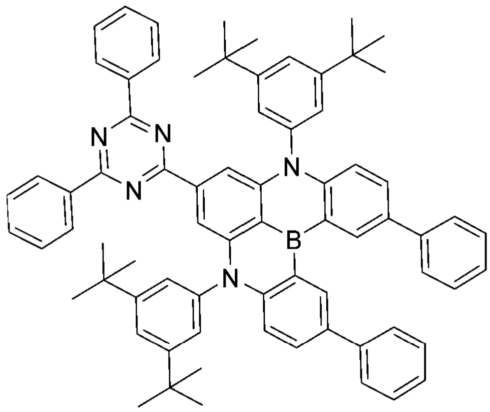

**S^B-4**

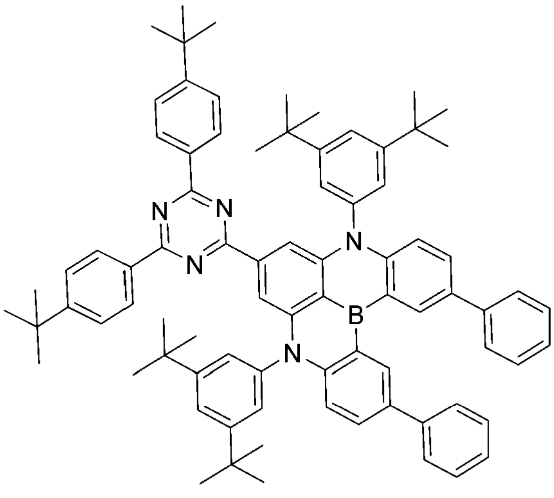

**S^B-5**

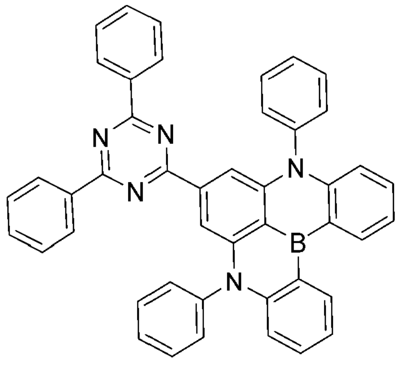

**S^B-6**

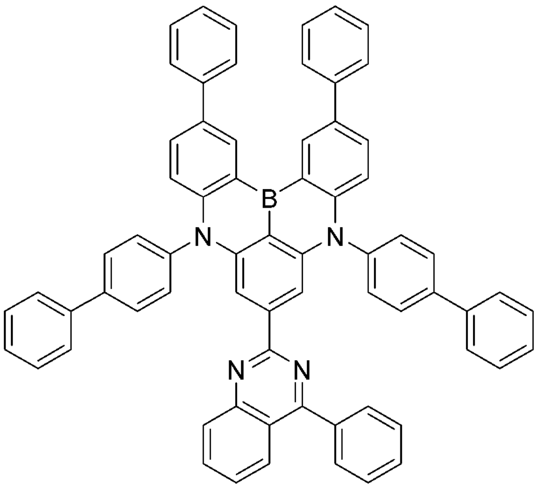

**S^B-7**

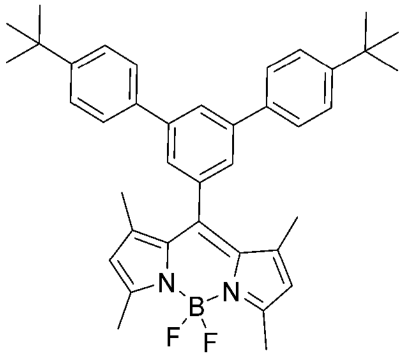

**S^B-8**

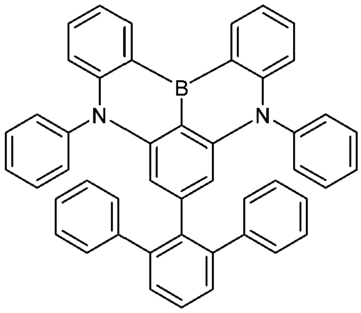

$S^B$-9

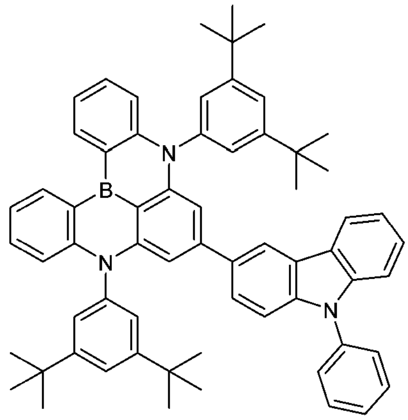

$S^B$-10

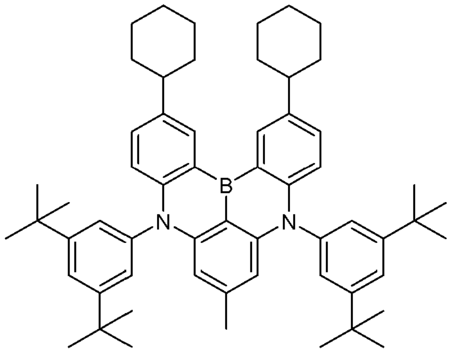

$S^B$-11

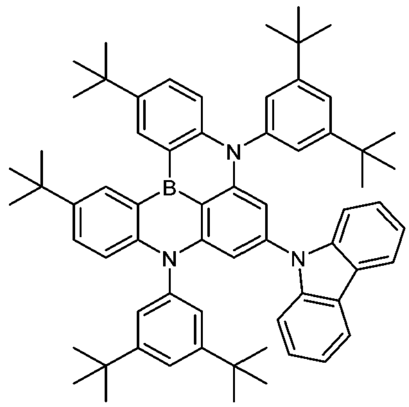

$S^B$-12

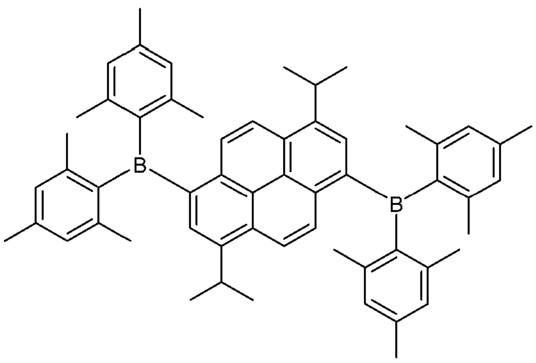

$S^B$-13

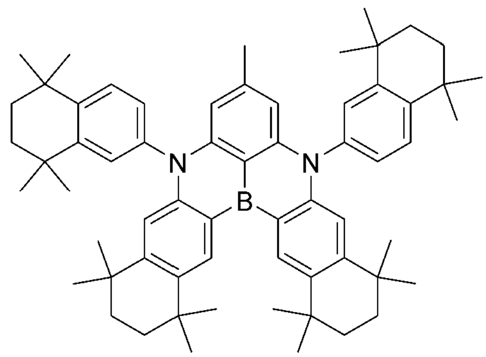

$S^B$-14

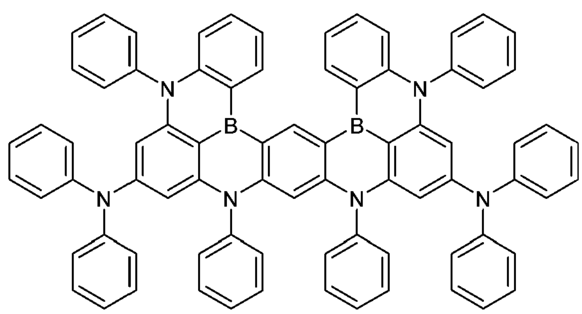

$S^B$-15

**Table 1S.** Properties of the Small FWHM emitters $S^B$.

| | Example compound | $E^{HOMO}$ [eV] | $E^{LUMO}$ [eV] | E(S1) [eV] | E(T1) [eV] | $\lambda_{max}^{PMMA}$ [nm] | FWHM [eV] |
|---|---|---|---|---|---|---|---|
| $S^B$ | **$S^B$-1** | -5.54 | -3.10 | 2.44 | 2.12 | 538 | 0.21 |
| | **$S^B$-2** | -5.53 | -3.04 | 2.49 | 2.26 | 525 | 0.18 |
| | **$S^B$-3** | -5.55 | -3.05 | 2.50 | 2.22 | 520 | 0.18 |
| | **$S^B$-4** | -5.48 | -3.05 | 2.43 | 2.25 | 537 | 0.17 |
| | **$S^B$-5** | -5.47 | -3.01 | 2.46 | 2.58 | 527 | 0.15 |
| | **$S^B$-6** | -5.56 | -3.03 | 2.53 | 2.19 | 518 | 0.22 |
| | **$S^B$-7** | -5.48 | -2.97 | 2.53 | 2.23 | 521 | 0.25 |
| | **$S^B$-8*** | -5.86 | -3.40 | 2.46 | | 517 | 0.10 |
| | **$S^B$-9** | -5.47 | -.2.66 | 2.81 | | 460 | 0.14 |
| | **$S^B$-10** | -5.46 | -2.65 | 2.81 | | 459 | 0.15 |
| | **$S^B$-11** | -5.33 | -2.51 | 2.82 | | 458 | 0.16 |
| | **$S^B$-12** | -5.49 | -2.63 | 2.86 | | 451 | 0.14 |
| | **$S^B$-13** | | | 2.79 | | 464 | 0.24 |
| | **$S^B$** | -5.31 | -2.50 | 2.81 | 2.61 | 459 | 0.16 |
| | **$S^B$-15** | -5.40 | -2.66 | 2.74 | | 468 | 0.12 |
| * measured in DCM (0.01 mg/mL; such a solution was used for photophysical measurements). | | | | | | | |

**Table 2.** Setup 1 of exemplary organic electroluminescent devices (OLEDs).

| **Layer** | **Thickness** | **Material** |
|---|---|---|
| **10** | 100 nm | Al |
| **9** | 2 nm | Liq |
| **8** | 20 nm | NBPhen |
| **7** | 10 nm | HBM1 |
| **6** | 50 nm | $H^B$ :<br>EET-1:<br>$H_{scav}$ :<br>$S^B$ |
| **5** | 10 nm | $H^P$ |
| **4** | 10 nm | TCTA |
| **3** | 50 nm | NPB |
| **2** | 5 nm | HAT-CN |
| **1** | 50 nm | ITO |
| **substrate** | | glass |

In order to evaluate the results of the invention, comparison experiments were performed, wherein solely the composition of the emission layer **(6)** was varied. Additionally, the ratio of EET-1 and $S^B$ was kept constant in the comparison experiments.

**Results I: Variation of the content of the hole scavenger Hscav (here exemplarily a phosphorescence material $P^B$) in the light-emitting layer (emission layer, 6)**

Composition of the light-emitting layer B of devices D1 to D4 (the percentages refer to weight percent):

| Layer | D1 | D2 | D3 | D4 |
|---|---|---|---|---|
| **Emission layer (6)** | $H^B$ (79%):<br>EET-1 (20%):<br>$H_{scav}$ (0%):<br>$S^B$ (1%) | $H^B$ (78%):<br>EET-1 (20%):<br>$H_{scav}$(1%):<br>$S^B$ (1%) | $H^B$ (75%):<br>EET-1 (20%):<br>$H_{scav}$ (4%):<br>$S^B$ (1%) | $H^B$ (69%):<br>EET-1 (20%):<br>$H_{scav}$ (10%):<br>$S^B$ (1%) |

Setup 1 from Table 2 was used, wherein $H^B$-4 was used as host material $H^B$ (p-host $H^P$; also used as material for the electron blocking layer 5), $E^B$-10 was used as excitation energy transfer component EET-1 (here exemplarily a TADF material $E^B$), $Ir(ppy)_3$ was used as hole scavenger $H_{scav}$ (here exemplarily a phosphorescence material $P^B$ as EET-2), and $S^B$-1 was used as the small FWHM emitter $S^B$. A weight percentage of 0% means the absence of the material in the light-emitting layer B.

**Device results I**

| Device | FWHM [eV] | $\lambda_{max}$ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D1** | 0.17 | 530 | 0.31 | 0.64 | 5.53 | 21.0 | 1.00 |
| **D2** | 0.18 | 532 | 0.32 | 0.64 | 6.64 | 21.2 | 2.47 |
| **D3** | 0.20 | 532 | 0.34 | 0.62 | 7.41 | 18.1 | 1.21 |
| **D4** | 0.24 | 532 | 0.37 | 0.60 | 6.96 | 13.1 | 0.99 |

Comparing the device results, D1 and D2, similar optical properties (FWHM, $\lambda_{max}$, CIEx and CIEy) and efficiency (EQE) can be observed, while for D2 an extension of the relative lifetime of 147% compared to D1 (from 1.00 to 2.47) can be observed. For D3 extension of the relative lifetime of 21 % compared to D1 (from 1.00 to 1.21), while the relative lifetime of D4 decreased by 1% compared to D1 (from 1.00 to 0.99).

**Results II: Variation of Composition of Components**

Composition of the light-emitting layer B of devices D5 to D13 (the percentages refer to weight percent):

| Layer | D5 | D6 | D7 | D8 |
|---|---|---|---|---|
| **Emission layer (6)** | $H^B$ (79%):<br>$H^N$ (20%):<br>$H_{scav}$ (1%):<br>$S^B$ (0%) | $H^B$ (76%):<br>$H^N$ (20%):<br>$H_{scav}$ (4%):<br>$S^B$ (0%) | $H^B$ (78%):<br>$H^N$ (20%):<br>$H_{scav}$ (1%):<br>$S^B$ (1%) | $H^B$ (75%):<br>$H^N$ (20%):<br>$H_{scav}$ (4%):<br>$S^B$ (1%) |

| Layer | D9 | D10 |
|---|---|---|
| **Emission layer (6)** | $H^B$ (79.5%):<br>EET-1 (20%):<br>$H_{scav}$ (0%):<br>$S^B$ (0.5%) | $H^B$ (78.5%):<br>EET-1 (20%):<br>$H_{scav}$ (1%):<br>$S^B$ (0.5%) |

Setup 1 from Table 2 was used, wherein $H^B$-4 was used as host material $H^B$ (p-host $H^P$; also used as material for the electron blocking layer 5), $H^B$-5 was used as host material $H^N$, $E^B$-11 was used as excitation energy transfer component EET-1 (here exemplarily a TADF material $E^B$), $Ir(ppy)_3$ was used as hole scavenger $H_{scav}$ (here exemplarily a phosphorescence material $P^B$ as EET-2), and $S^B$-1 was used as the small FWHM emitter $S^B$. A weight percentage of 0% means the absence of the material in the light-emitting layer B.

Devices **D5** and **D6** are typical phosphorescence devices, which comprise a mixed-host system, i.e., $H^B$ and $H^N$,

and a phosphorescence emitter.

Device **D7** and **D8** are devices, which comprise a mixed-host system, i.e., $H^B$ and $H^N$, a phosphorescence material and a small FWHM emitter $S^B$.

Device **D9** is a device, which comprises a host $H^B$, a TADF material $E^B$ and a small FWHM emitter $S^B$.

Devices **D10** is a device, which comprises a host $H^B$, an excitation energy transfer component EET-1 (here exemplarily a TADF material $E^B$), a hole scavenger $H_{scav}$ (here exemplarily a phosphorescence material $P^B$ as EET-2), and a small FWHM emitter $S^B$.

**Device results II**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D5** | 0.31 | 512 | 0.30 | 0.62 | 6.11 | 19.5 | 1.00 |
| **D6** | 0.31 | 514 | 0.30 | 0.63 | 5.77 | 21.7 | 1.89 |
| **D7** | 0.17 | 534 | 0.33 | 0.64 | 6.33 | 19.9 | 2.05 |
| **D8** | 0.17 | 534 | 0.33 | 0.64 | 6.19 | 22.9 | 3.50 |
| **D9** | 0.17 | 532 | 0.31 | 0.63 | 5.86 | 20.6 | 1.30 |
| **D10** | 0.18 | 532 | 0.32 | 0.64 | 6.74 | 24.9 | 13.34 |

Comparing the composition of the emission layer of devices **D5** and **D6** to **D7** and **D8, D7** and **D8** contain additionally a small FWHM emitter $S^B$, which is not present in **D5** and **D6.** A longer lifetime, similar efficiency and smaller FWHM of the emission can be observed for **D7** and **D8.**

Device **D10** according to the present invention shows a superior overall performance over D-9 which lacks the hole scavenger $H_{scav}$ (here an excitation energy transfer component EET-2, more specifically a phosphorescence material $P^B$, more specifically $Ir(ppy)_3$).

Composition of the light-emitting layer B of devices D14 to D21 (the percentages refer to weight percent):

| Layer | D14 | D15 | D16 | D17 | D18 |
|---|---|---|---|---|---|
| **Emission layer (6)** | $H^B$ (80%):<br>$H^N$ (0%):<br>EET-1 (20%):<br>$H_{scav}$ (0%):<br>$S^B$ (0%) | $H^B$ (79%):<br>$H^N$ (20%):<br>EET-1 (0%):<br>$H_{scav}$ (1 %):<br>$S^B$ (0%) | $H^B$ (79%):<br>$H^N$ (0%):<br>EET-1 (20%):<br>$H_{scav}$ (0%):<br>$S^B$ (1 %) | $H^B$ (78%):<br>$H^N$ (20%):<br>EET-1 (0%):<br>$H_{scav}$ (1%):<br>$S^B$ (1%) | $H^B$ (79%):<br>$H^N$ (0%):<br>EET-1 (20%):<br>$H_{scav}$ (1%):<br>$S^B$ (0%) |
| | | | | | |
| **Layer** | **D19** | **D20** | **D21** | | |
| **Emission layer (6)** | $H^B$ (78%):<br>$H^N$ (0%):<br>EET-1 (20%):<br>$H_{scav}$ (1%):<br>$S^B$ (1%) | $H^B$ (75%):<br>$H^N$ (0%):<br>EET-1 (20%):<br>$H_{scav}$ (4%):<br>$S^B$ (1%) | $H^B$ (72%):<br>$H^N$ (0%):<br>EET-1 (20%):<br>$H_{scav}$ (7%):<br>$S^B$ (1 %) | | |

Setup 1 from Table 2 was used, wherein $H^B$-4 was used as host material $H^B$ (p-host $H^P$; also used as material for the electron blocking layer 5), $H^B$-5 was used as host material $H^N$, $E^B$-10 was used as excitation energy transfer component EET-1 (here exemplarily a TADF material $E^B$), $P^B$-2 was used as hole scavenger $H_{scav}$ (here exemplarily a phosphorescence material $P^B$ as EET-2), and $S^B$-1 was used as small FWHM emitter $S^B$. A weight percentage of 0% means the absence of the material in the light-emitting layer B.

**Device results III**

| Device | FWHM [eV] | $\lambda_{max}$ [nm] | CIEx | CIEy | Voltage at 10 $mA/cm^2$ [Volt] | EQE at 1000 $cd/m^2$ [%] | Relative lifetime LT95 at 1200 $cd/m^2$ |
|---|---|---|---|---|---|---|---|
| **D14** | 0.35 | 522 | 0.32 | 0.60 | 4.76 | 16.4 | 1.00 |
| **D15** | 0.29 | 516 | 0.30 | 0.63 | 6.49 | 22.7 | 0.29 |
| **D16** | 0.16 | 532 | 0.32 | 0.65 | 5.85 | 20.4 | 2.76 |
| **D17** | 0.17 | 532 | 0.31 | 0.65 | 6.60 | 22.4 | 0.52 |
| **D18** | 0.36 | 525 | 0.36 | 0.59 | 7.02 | 15.7 | 2.17 |
| **D19** | 0.17 | 532 | 0.33 | 0.64 | 7.28 | 20.4 | 4.75 |
| **D20** | 0.20 | 532 | 0.35 | 0.62 | 7.85 | 16.3 | 2.42 |
| **D21** | 0.20 | 534 | 0.36 | 0.61 | 7.26 | 13.6 | 2.57 |

As can be concluded from device results III, the absence of the small FWHM emitter $S^B$ (here exemplarily $S^B$-1) results in an undesirably broad emission reflected by the FWHM values being significantly larger than 0.25 eV in all cases (see devices D14, D15, and D18). For D15, the very high EQE of 22.7% comes along with a significantly reduced lifetime. When using a small FWHM emitter $S^B$ (here exemplarily $S^B$-1) alongside an EET-1 (exemplarily a TADF material $E^B$, specifically $E^B$-10) or a hole scavenger $H_{scav}$ (here exemplarily an EET-2, specifically a phosphorescence material $P^B$ such as $P^B$-2)), a narrow emission can be achieved, which is then reflected by the FWHM values being significantly smaller than 0.25 eV (see devices D16 and D17). At the same time, these devices exhibit high EQE-values of 20.4% and 22.4%, respectively. However, in terms of lifetime, all of these devices are clearly outcompeted by device D19, which was prepared according to the present invention. D19 also exhibits a very good efficiency (EQE of 20.4%) and a narrow emission (FWHM of 0.17 eV). In summary, the skilled artisan will acknowledge that D19 (according to the present invention) clearly shows the best overall device performance. The EML of D19 comprises 1% of the hole scavenger $H_{scav}$ (here a phosphorescence material $P^B$). Increasing this value to 4% (in D20) or even to 7% (in D21) results in a somewhat poorer device performance reflected by a slight increase of the FWHM to 0.20 eV, a reduction of the EQE to 16.3% or 13.6%, respectively, and a reduction of the device lifetime. Nevertheless, D20 and D21 still display a good overall performance, in particular with regard to the device lifetime. In the absence of the excitation energy transfer component EET-1 (here exemplarily TADF material $E^B$-10), an n-host (here exemplarily $H^B$-5) was generally used to increase the electron mobility within the EML.

Composition of the light-emitting layer B of devices D22 to D29 (the percentages refer to weiaht percent):

| **Layer** | **D22** | **D23** | **D24** | **D25** | **D26** |
|---|---|---|---|---|---|
| **Emission layer (6)** | $H^B$ (80%):<br>$H^N$ (0%):<br>EET-1 (20%):<br>$H_{scav}$ (0%):<br>$S^B$ (0%) | $H^B$ (79%):<br>$H^N$ (20%):<br>EET-1 (0%):<br>$H_{scav}$ (1%):<br>$S^B$ (0%) | $H^B$ (78%):<br>$H^N$ (20%):<br>EET-1 (0%):<br>$H_{scav}$ (1%):<br>$S^B$ (1 %) | $H^B$ (78%):<br>$H^N$ (0%):<br>EET-1 (20%):<br>$H_{scav}$ (1%):<br>$S^B$ (1%) | $H^B$ (78.5%):<br>$H^N$ (0%):<br>EET-1 (20%):<br>$H_{scav}$ (1%):<br>$S^B$ (0.5%) |
| | | | | | |
| **Layer** | **D27** | **D28** | **D29** | | |
| **Emission layer (6)** | $H^B$ (79.5%):<br>$H^N$ (0%):<br>EET-1 (20%):<br>$H_{scav}$ (0%):<br>$S^B$ (0.5%) | $H^B$ (75%):<br>$H^N$ (0%):<br>EET-1 (20%):<br>$H_{scav}$ (4%):<br>$S^B$ (1%) | $H^B$ (75.5%):<br>$H^N$ (0%):<br>EET-1 (20%):<br>$H_{scav}$ (4%):<br>$S^B$ (0.5%) | | |

Setup 1 from Table 2 was used, wherein $H^B$-4 was used as host material $H^B$ (p-host $H^P$; also used as material for the electron blocking layer 5), $H^B$-5 was used as host material $H^N$, $E^B$-11 was used as excitation energy transfer component EET-1 (here exemplarily a TADF material $E^B$), $Ir(ppy)_3$ was used as hole scavenger $H_{scav}$ (here exemplarily a phosphorescence material $P^B$ as EET-2), and $S^B$-1 was used as small FWHM emitter $S^B$. A weight percentage of 0% means the absence of the material in the light-emitting layer B.

**Device results IV**

| Device | FWHM [eV] | $\lambda_{max}$ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D22** | 0.41 | 518 | 0.29 | 0.55 | 4.93 | 22.5 | 1.00 |
| **D23** | 0.31 | 512 | 0.30 | 0.62 | 6.11 | 19.5 | 1.10 |
| **D24** | 0.17 | 534 | 0.33 | 0.64 | 6.33 | 19.9 | 2.26 |
| **D25** | 0.17 | 534 | 0.32 | 0.64 | 6.30 | 22.5 | 11.89 |
| **D26** | 0.18 | 532 | 0.32 | 0.64 | 6.74 | 24.9 | 14.72 |
| **D27** | 0.17 | 532 | 0.31 | 0.63 | 5.86 | 20.6 | 1.44 |
| **D28** | 0.16 | 534 | 0.33 | 0.64 | 5.94 | 21.6 | 8.95 |
| **D29** | 0.18 | 532 | 0.32 | 0.64 | 6.75 | 22.6 | 11.40 |

As can be concluded from device results IV, using the TADF material $E^B$ (here exemplarily $E^B$-11) or the phosphorescence material $P^B$ (here exemplarily $Ir(ppy)_3$) as the main emitter in the absence of a small FWHM emitter $S^B$ results in a relatively broad emission of the organic electroluminescent device, which is reflected by FWHM values of the main emission peak of clearly more than 0.25 eV (here 0.41 and 0.31 eV, respectively, see D22 and D23). Both, D22 and D23, exhibit high efficiencies (EQE of 22.5% and 19.5%, respectively). The addition of a small FWHM emitter $S^B$ (here exemplarily $S^B$-1) to for example the phosphorescent OLED D23 results in a significantly reduced FWHM of the main emission peak (then 0.17 eV) while slightly improving the EQE and the lifetime (see D24). However, device D24 as well as the OLEDs D22 and D23 are strongly outperformed by device D25, which was prepared according to the present invention. As compared to D22, D23, and D24, device D25 exhibits a dramatically prolonged lifetime, while still displaying an equally high efficiency and a narrow FWHM. The skilled artisan will acknowledge that the overall performance of device D25 according to the present invention is clearly superior to the performance of D22, D23, and D24. The overall device performance could be improved even further by reducing the content of the small FWHM emitter $S^B$ (here exemplarily $S^B$-1) from 1% (in the EML of D25) to 0.5% (in the EML of D26). Again, a comparative example D27, not fulfilling the conditions of the present invention (exemplarily lacking the hole scavenger $H_{scav}$, in this case EET-2, here a phosphorescence material $P^B$) showed a drastically reduced lifetime and a somewhat reduced efficiency (EQE). Increasing the content of the hole scavenger $H_{scav}$ (here exemplarily a phosphorescence material $P^B$, $Ir(ppy)_3$) from 1% in the devices D25 and D26 according to the present invention to 4% (in devices D28 and D29 according to the present invention) led to a reduction of the device lifetime and the efficiency. However, these devices (D28 and D29) still clearly outperform the aforementioned comparative devices which were manufactured according to the state of the art and not according to the present invention. In the absence of the excitation energy transfer component EET-1 (here exemplarily the TADF material $E^B$-11), an n-host (here exemplarily $H^B$-5) was generally used to increase the electron mobility within the EML.

**Table 3.** Setup 2 of exemplary organic electroluminescent devices (OLEDs).

| Layer | Thickness | Material |
|---|---|---|
| **10** | 100 nm | Al |
| **9** | 2 nm | Liq |
| **8** | 20 nm | NBPhen |
| **7** | 10 nm | HBM1 |
| **6** | 50 nm | $H^B$ :<br>EET-1 :<br>$H_{scav}$ :<br>$S^B$ |

(continued)

| Layer | Thickness | Material |
|---|---|---|
| **5** | 10 nm | $H^P$ |
| **4** | 10 nm | TCTA |
| **3** | 40 nm | NPB |
| **2** | 5 nm | HAT-CN |
| **1** | 50 nm | ITO |
| **substrate** | | glass |

Composition of the light-emitting layer B of devices D30 to D32 (the percentages refer to weight percent):

| Layer | D30 | D31 | D32 |
|---|---|---|---|
| **Emission layer (6)** | $H^B$ (79%):<br>EET-1 (20%):<br>$H_{scav}$ (0%):<br>$S^B$ (1%) | $H^B$ (76%):<br>EET-1 (20%):<br>$H_{scav}$ (4%):<br>$S^B$ (0%) | $H^B$ (75%):<br>EET-1 (20%):<br>$H_{scav}$ (4%):<br>$S^B$ (1%) |

Setup 2 from Table 3 was used, wherein $H^B$-1 (mCBP) was used as host material $H^B$ (p-host $H^P$; also used as material for the electron blocking layer 5), $E^B$-14 was used as excitation energy transfer component EET-1 (here exemplarily a TADF material $E^B$), $P^B$-3 was used as hole scavenger $H_{scav}$ (here exemplarily a phosphorescence material $P^B$ as EET-2), and $S^B$-14 was used as small FWHM emitter $S^B$.

**Device results V**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D30** | 0.17 | 462 | 0,14 | 0.15 | 6.07 | 15.8 | 1.00 |
| **D31** | 0.33 | 474 | 0,14 | 0.23 | 5.61 | 16.8 | 2.50 |
| **D32** | 0.19 | 462 | 0,14 | 0.16 | 6.03 | 19.4 | 1.75 |

Among the organic electroluminescent devices D30-D32, D32 according to the present invention shows the best overall performance when taking the narrow emission (small FWHM), the high EQE, and the relative lifetime into account.

Composition of the light-emitting layer B of devices D33 to D35 (the percentages refer to weight percent):

| Layer | D33 | D34 | D35 |
|---|---|---|---|
| **Emission layer (6)** | $H^P$ (79%):<br>EET-1 (20%):<br>$H_{scav}$ (0%):<br>$S^B$ (1%) | $H^P$ (79%):<br>EET-1 (20%):<br>$H_{scav}$ (1%):<br>$S^B$ (0%) | $H^P$ (78%):<br>EET-1 (20%):<br>$H_{scav}$ (1%):<br>$S^B$ (1%) |

Setup 2 from Table 3 was used, wherein $H^B$-14 was used as host material $H^B$ (p-host $H^P$; also used as material for the electron blocking layer 5), $E^B$-14 was used as excitation energy transfer component EET-1 (here exemplarily a TADF material $E^B$), $P^B$-3 was used as hole scavenger $H_{scav}$ (here exemplarily a phosphorescence material $P^B$ as EET-2), and $S^B$-14 was used as small FWHM emitter $S^B$.

**Device results VI**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D33** | 0.17 | 462 | 0.14 | 0.15 | 5.26 | 17.2 | 1.00 |
| **D34** | 0.35 | 474 | 0.15 | 0.25 | 6.07 | 13.5 | 0.75 |
| **D35** | 0.18 | 462 | 0.14 | 0.15 | 5.89 | 18.1 | 1.50 |

Among the organic electroluminescent devices D33-D35, D35 according to the present invention clearly shows the best overall performance when taking the narrow emission (small FWHM), the high EQE, and the relative lifetime into account. As stated before, each light-emitting layer B according to the present invention may be a single layer or may be composed of two or more sublayers. Exemplary organic electroluminescent devices with a light-emitting layer B comprising two or more sublayers are shown below (see device results VII and VIII).

**Table 4.** Setup 3 of exemplary organic electroluminescent devices (OLEDs).

| **Layer** | **Thickness** | **Sublayers** | **Material** |
|---|---|---|---|
| **10** | 100 nm | single layer | Al |
| **9** | 2 nm | single layer | Liq |
| **8** | 20 nm | single layer | NBPhen |
| **7** | 10 nm | single layer | HBM1 |
| **6** | 2 nm | sublayer 11 | $H^B$ : EET-1 : $H_{scav}$ : $S^B$ |
| | 8 nm | sublayer 10 | |
| | 2 nm | sublayer 9 | |
| | 8 nm | sublayer 8 | |
| | 2 nm | sublayer 7 | |
| | 8 nm | sublayer 6 | |
| | 2 nm | sublayer 5 | |
| | 8 nm | sublayer 4 | |
| | 2 nm | sublayer 3 | |
| | 8 nm | sublayer 2 | |
| | 2 nm | sublayer 1 | |
| **5** | 10 nm | single layer | $H^P$ |
| **4** | 10 nm | single layer | TCTA |
| **3** | 50 nm | single layer | NPB |
| **2** | 5 nm | single layer | HAT-CN |
| **1** | 50 nm | single layer | ITO |
| **substrate** | | | glass |

Composition of the light-emitting layer B of devices D36 to D38 (the percentages refer to weight percent):

| Layer | Sublayer | D36 | D37 | D38 |
|---|---|---|---|---|
| Emission layer (6) | 11 | $H^B$ (79%): $H^N$ (20%): $S^B$ (1%) | $H^B$ (79%): $H^N$ (20%): $S^B$ (1 %) | $H^B$ (79%): $H^N$ (20%): $S^B$ (1 %) |
| | 10 | $H^B$ (79%): $H^N$ (20%): $H_{scav}$ (1%) | $H^B$ (80%): EET-1 (20%): | $H^B$ (79%): EET-1 (20%): $H_{scav}$ (1 %) |
| | 9 | $H^B$ (79%): $H^N$ (20%): $S^B$ (1 %) | $H^B$ (79%): $H^N$ (20%): $S^B$ (1 %) | $H^B$ (79%): $H^N$ (20%): $S^B$ (1 %) |
| | 8 | $H^B$ (79%): $H^N$ (20%): $H_{scav}$ (1 %) | $H^B$ (80%): EET-1 (20%): | $H^B$ (79%): EET-1 (20%): $H_{scav}$ (1 %) |
| | 7 | $H^B$ (79%): $H^N$ (20%): $S^B$ (1%) | $H^B$ (79%): $H^N$ (20%): $S^B$ (1%) | $H^B$ (79%): $H^N$ (20%): $S^B$ (1%) |
| | 6 | $H^B$ (79%): $H^N$ (20%): $H_{scav}$ (1%) | $H^B$ (80%): EET-1 (20%): | $H^B$ (79%): EET-1 (20%): $H_{scav}$ (1%) |
| | 5 | $H^B$ (79%): $H^N$ (20%): $S^B$ (1%) | $H^B$ (79%): $H^N$ (20%): $S^B$ (1%) | $H^B$ (79%): $H^N$ (20%): $S^B$ (1%) |
| | 4 | $H^B$ (79%): $H^N$ (20%): $H_{scav}$ (1%) | $H^B$ (80%): EET-1 (20%): | $H^B$ (79%): EET-1 (20%): $H_{scav}$ (1%) |
| | 3 | $H^B$ (79%): $H^N$ (20%): $S^B$ (1%) | $H^B$ (79%): $H^N$ (20%): $S^B$ (1%) | $H^B$ (79%): $H^N$ (20%): $S^B$ (1%) |
| | 2 | $H^B$ (79%): $H^N$ (20%): $H_{scav}$ (1%) | $H^B$ (80%): EET-1 (20%): | $H^B$ (79%): EET-1 (20%): $H_{scav}$ (1 %) |
| | 1 | $H^B$ (79%): $H^N$ (20%): $S^B$ (1 %) | $H^B$ (79%): $H^N$ (20%): $S^B$ (1 %) | $H^B$ (79%): $H^N$ (20%): $S^B$ (1%) |

Setup 3 from Table 4 was used, wherein $H^B$-4 was used as host material $H^B$ (p-host $H^P$; also used as material for the electron blocking layer 5), $H^B$-5 was used as host material $H^N$, $E^B$-10 was used as excitation energy transfer component EET-1 (here exemplarily a TADF material $E^B$), $Ir(ppy)_3$ was used as hole scavenger $H_{scav}$ (here exemplarily a phosphorescence material $P^B$ as EET-2), and $S^B$-1 was used as small FWHM emitter $S^B$.

**Device results VII**

| Device | FWHM [eV] | $\lambda_{max}$ [nm] | CIEx | CIEy | Voltage at 10 $mA/cm^2$ [Volt] | EQE at 1000 $cd/m^2$ [%] | Relative lifetime LT95 at 1200 $cd/m^2$ |
|---|---|---|---|---|---|---|---|
| **D36** | 0.24 | 528 | 0.29 | 0.64 | 5.08 | 23.8 | 1.00 |
| **D37** | 0.21 | 530 | 0.31 | 0.63 | 5.80 | 18.0 | 3.87 |

(continued)

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D38** | 0.23 | 530 | 0.33 | 0.62 | 7.71 | 16.3 | 9.01 |

As can be concluded from device results VII, D38 according to the present invention shows a significantly prolonged lifetime as compared to D36 and D37. This comes along with a somewhat reduced, but still high efficiency (EQE). All three devices display a narrow emission which is expressed by FWHM values below 0.25 eV in all cases. D38 displays the best overall device performance, when taking the narrow emission, the still high EQE and the very long lifetime into account.

**Table 5.** Setup 4 of exemplary organic electroluminescent devices (OLEDs).

| **Layer** | **Thickness** | **Sublayers** | **Material** |
|---|---|---|---|
| **10** | 100 nm | single layer | Al |
| **9** | 2 nm | single layer | Liq |
| **8** | 20 nm | single layer | NBPhen |
| **7** | 10 nm | single layer | HBM1 |
| **6** | 5 nm | sublayer 13 | $H^B$ : EET-1 : $H_{scav}$ : $S^B$ |
| | 2 nm | sublayer 12 | |
| | 5 nm | sublayer 11 | |
| | 2 nm | sublayer 10 | |
| | 5 nm | sublayer 9 | |
| | 2 nm | sublayer 8 | |
| | 5 nm | sublayer 7 | |
| | 2 nm | sublayer 6 | |
| | 5 nm | sublayer 5 | |
| | 2 nm | sublayer 4 | |
| | 5 nm | sublayer 3 | |
| | 2 nm | sublayer 2 | |
| | 5 nm | sublayer 1 | |
| 5 | 10 nm | single layer | $H^P$ |
| 4 | 10 nm | single layer | TCTA |
| 3 | 50 nm | single layer | NPB |
| 2 | 5 nm | single layer | HAT-CN |
| 1 | 50 nm | single layer | ITO |
| substrate | | | glass |

Composition of the light-emitting layer B of device D39 (the percentages refer to weight percent):

| Layer | Sublayer | D39 |
|---|---|---|
| Emission layer (6) | 13 | $H^B$ (79%): EET-1 (20%): $H_{scav}$ (1%) |
| | 12 | $H^B$ (79%): $H^N$ (20%): $S^B$(1%) |
| | 11 | $H^B$ (79%): EET-1 (20%): $H_{scav}$ (1%) |
| | 10 | $H^B$ (79%): $H^N$ (20%): $S^B$ (1%) |
| | 9 | $H^B$ (79%): EET-1 (20%): $H_{scav}$ (1%) |
| | 8 | $H^B$ (79%): $H^N$ (20%): $S^B$ (1%) |
| | 7 | $H^B$ (79%): EET-1 (20%): $H_{scav}$ (1%) |
| | 6 | $H^B$ (79%): $H^N$ (20%): $S^B$ (1%) |
| | 5 | $H^B$ (79%): EET-1 (20%): $H_{scav}$ (1%) |
| | 4 | $H^B$ (79%): $H^N$ (20%): $S^B$ (1%) |
| | 3 | $H^B$ (79%): EET-1 (20%): $H_{scav}$ (1%) |
| | 2 | $H^B$ (79%): $H^N$ (20%): $S^B$ (1%) |
| | 1 | $H^B$ (79%): EET-1 (20%): $H_{scav}$ (1%) |

Setup 4 from Table 5 was used, wherein $H^B$-4 was used as host material $H^B$ (p-host $H^P$; also used as material for the electron blocking layer 5), $H^B$-5 was used as host material $H^N$, $E^B$-10 was used as excitation energy transfer component EET-1 (here exemplarily a TADF material $E^B$), $Ir(ppy)_3$ was used as hole scavenger $H_{scav}$ (here exemplarily a phosphorescence material $P^B$ as EET-2), and $S^B$-1 was used as small FWHM emitter $S^B$.

**Device results VIII**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D39** | 0.23 | 528 | 0.33 | 0.62 | 6.21 | 15.3 | 0.73* |
| *The lifetime is given relative to D38. | | | | | | | |

As can be concluded from device results VIII, reducing the thickness of the $H^B$:$E^B$:$H_{scav}$-sublayers from 8 nm (D38) to 5 nm (D39) while using a largely analogue stack architecture, did not result in an improved device performance. Nevertheless, D39 still displays a narrow emission, high EQE and good lifetime.

Composition of the light-emitting layer B of devices D40 and D41 (the percentages refer to weight percent):

| Layer | D40 | D41 |
|---|---|---|
| **Emission layer (6)** | $H^B$ (79%):<br>$E^B$ (20%):<br>$H_{scav}$ (0%):<br>$S^B$ (1%) | $H^B$ (75%):<br>$E^B$ (20%):<br>$H_{scav}$ (4%):<br>$S^B$ (1%) |

Setup 1 from Table 2 was used, wherein $H^B$-15 was used as host material $H^B$ (p-host $H^P$; also used as material for the electron blocking layer 5), $E^B$-10 was used as excitation energy transfer component EET-1 (here a TADF material $E^B$), $Ir(ppy)_3$ was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results IX**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D40** | 0.16 | 534 | 0.33 | 0.64 | 3.93 | 13.1 | 1.00 |
| **D41** | 0.18 | 534 | 0.35 | 0.63 | 5.09 | 12.9 | 3.02 |

As can be concluded from device results IX, device D41 according to the present invention shows a superior overall performance as compared to device D40 which lacks the excitation energy transfer component EET-1 (here a TADF material $E^B$, more specifically $E^B$-10) when taking the narrow emission (FWHM), the efficiency (EQE), and the device lifetime (LT95) into account.

**Table 6.** Setup 5 of exemplary organic electroluminescent devices (OLEDs).

| Layer | Thickness | Material |
|---|---|---|
| **10** | 100 nm | Al |
| **9** | 2 nm | Liq |
| **8** | 20 nm | NBPhen |
| **7** | 10 nm | HBM1 |

(continued)

| Layer | Thickness | Material |
|---|---|---|
| **6** | 50 nm | $H^B$ :<br>EET-1 :<br>$H_{scav}$ :<br>$S^B$ |
| **5** | 10 nm | EBM1 |
| **4** | 10 nm | TCTA |
| **3** | 60 nm | NPB |
| **2** | 5 nm | HAT-CN |
| **1** | 50 nm | ITO |
| **substrate** | | glass |

Composition of the light-emitting layer B of devices D42 to D44 (the percentages refer to weight percent):

| Layer | D42 | D43 | D44 |
|---|---|---|---|
| **Emission layer (6)** | $H^B$ (79%):<br>$H^N$ (0%):<br>EET-1 (20%):<br>$H_{scav}$ (0%):<br>$S^B$ (1%) | $H^B$ (78%):<br>$H^N$ (20%):<br>EET-1 (0%):<br>$H_{scav}$ (1%):<br>$S^B$ (1%) | $H^B$ (78%):<br>$H^N$ (0%):<br>EET-1 (20%):<br>$H_{scav}$ (1%):<br>$S^B$ (1%) |

Setup 5 from Table 6 was used, wherein $H^B$-15 was used as host material $H^B$ (p-host $H^P$), $H^B$-5 was used as host material $H^N$, $E^B$-10 was used as excitation energy transfer component EET-1 (here a TADF material $E^B$), $P^B$-2 was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results X**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D42** | 0.18 | 532 | 0.33 | 0.64 | 3.81 | 14.4 | 1.00 |
| **D43** | 0.18 | 532 | 0.32 | 0.65 | 4.00 | 14.9 | 0.17 |
| **D44** | 0.18 | 534 | 0.33 | 0.64 | 4.31 | 14.8 | 1.77 |

As can be concluded from device results X, device D44 according to the present invention shows a superior overall performance as compared to device D43 which lacks the excitation energy transfer component EET-1 (here a TADF material $E^B$, more specifically $E^B$-10) and device D42 which lacks the hole scavenger $H_{scav}$ (here an excitation energy transfer component EET-2, more specifically a phosphorescence material $P^B$, more specifically $P^B$-2) when taking the narrow emission (FWHM), the efficiency (EQE), and the device lifetime (LT95) into account. In the absence of the TADF material $E^B$-10, an n-host (here exemplarily $H^B$-5) was used to increase the electron mobility within the EML.

Composition of the light-emitting layer B of devices D45 to D49 (the percentages refer to weight percent):

| Layer | D45 | D46 | D47 | D48 | D49 |
|---|---|---|---|---|---|
| **Emission layer (6)** | $H^B$ (80%): $H^N$ (0%): EET-1 (20%): Hscav (0%): $S^B$ (0%) | $H^B$ (79%): $H^N$ (20%): EET-1 (0%): $H_{scav}$ (1%): $S^B$ (0%) | $H^B$ (79%): $H^N$ (0%): EET-1 (20%): $H_{scav}$ (0%): $S^B$ (1%) | $H^B$ (78%): $H^N$ (20%): EET-1 (0%): $H_{scav}$ (1%): $S^B$ (1%) | $H^B$ (78%): $H^N$ (0%): EET-1 (20%): $H_{scav}$ (1%): $S^B$ (1%) |

Setup 1 from Table 2 was used, wherein $H^B$-4 was used as host material $H^B$ (p-host $H^P$; also used as material for the electron blocking layer 5), $H^B$-5 was used as host material $H^N$, $E^B$-10 was used as excitation energy transfer component EET-1 (here a TADF material $E^B$), $P^B$-4 was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XI**

| Device | FWHM [eV] | $\lambda_{max}$ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D45** | 0.34 | 521 | 0.31 | 0.60 | 5.04 | 17.5 | 1.00 |
| **D46** | 0.25 | 522 | 0.32 | 0.63 | 5.91 | 27.0 | 0.72 |
| **D47** | 0.16 | 532 | 0.31 | 0.65 | 6.02 | 20.0 | 2.27 |
| **D48** | 0.17 | 531 | 0.32 | 0.65 | 6.56 | 22.5 | 0.64 |
| **D49** | 0.17 | 532 | 0.33 | 0.64 | 7.70 | 19.2 | 4.39 |

As can be concluded from device results XI, device D49 according to the present invention shows a superior overall performance as compared to device D48 which lacks the excitation energy transfer component EET-1 (here a TADF material $E^B$, more specifically $E^B$-10) and device D47 which lacks the hole scavenger $H_{scav}$ (here an excitation energy transfer component EET-2, more specifically a phosphorescence material $P^B$, more specifically $P^B$-4) and device D46 which employs $P^B$-4 as the emitter material in spite of $S^B$-1 and device D45 which employs $E^B$-10 as the emitter material in spite of $S^B$-1, when taking the narrow emission (FWHM), the efficiency (EQE), and the device lifetime (LT95) into account. In the absence of the TADF material $E^B$-10, an n-host (here exemplarily $H^B$-5) was used to increase the electron mobility within the EML.

Composition of the light-emitting layer B of devices D50 to D64 (the percentages refer to weight percent):

| Layer | D50 | D51 | D52 | D53 | D54 |
|---|---|---|---|---|---|
| **Emission layer (6)** | $H^B$ (80%): $H^N$ (0%): EET-1 (20%): $H_{scav}$ (0%): $S^B$ (0%) | $H^B$ (79%): $H^N$ (20%): EET-1 (0%): Hscav (1%): $S^B$ (0%) | $H^B$ (79%): $H^N$ (0%): EET-1 (20%): $H_{scav}$ (0%): $S^B$ (1%) | $H^B$ (78%): $H^N$ (20%): EET-1 (0%): Hscav (1%): $S^B$ (1%) | $H^B$ (78%): $H^N$ (0%): EET-1 (20%): Hscav (1%): $S^B$ (1%) |
| | | | | | |
| **Layer** | **D55** | **D56** | **D57** | **D58** | **D59** |
| **Emission layer (6)** | $H^B$ (75%): $H^N$ (0%): EET-1 (20%): $H_{scav}$ (4%): $S^B$ (1%) | $H^B$ (75.5%): $H^N$ (0%): EET-1 (20%): $H_{scav}$ (4%): $S^B$ (0.5%) | $H^B$ (72%): $H^N$ (0%): EET-1 (20%): $H_{scav}$ (7%): $S^B$ (1%) | $H^B$ (72.5%): $H^N$ (0%): EET-1 (20%): $H_{scav}$ (7%): $S^B$ (0.5%) | $H^B$ (65.5%): $H^N$ (0%): EET-1 (30%): $H_{scav}$ (4%): $S^B$ (0.5%) |
| | | | | | |

(continued)

| | D60 | D61 | | | |
|---|---|---|---|---|---|
| **Emission layer (6)** | $H^B$ (55.5%):<br>$H^N$ (0%):<br>EET-1 (40%):<br>Hscav (4%):<br>$S^B$ (0.5%) | $H^B$ (67.5%):<br>$H^N$ (0%):<br>EET-1 (30%):<br>$H_{scav}$ (3%):<br>$S^B$ (0.5%) | | | |

Setup 5 from Table 6 was used, wherein $H^B$-15 was used as host material $H^B$ (p-host $H^P$), $H^B$-5 was used as host material $H^N$, $E^B$-11 was used as excitation energy transfer component EET-1 (here a TADF material $E^B$), $Ir(ppy)_3$ was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XII**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D50** | 0.35 | 530 | 0.34 | 0.57 | 3.51 | 11.0 | 1.00 |
| **D51** | 0.28 | 508 | 0.27 | 0.63 | 3.85 | 18.7 | 0.47 |
| **D52** | 0.17 | 534 | 0.32 | 0.64 | 3.67 | 12.7 | 0.90 |
| **D53** | 0.16 | 532 | 0.31 | 0.65 | 3.83 | 14.5 | 0.84 |
| **D54** | 0.19 | 532 | 0.32 | 0.65 | 4.29 | 17.5 | 1.91 |
| **D55** | 0.16 | 534 | 0.33 | 0.64 | 4.71 | 20.2 | 6.72 |
| **D56** | 0.17 | 532 | 0.32 | 0.65 | 4.75 | 19.0 | 10.71 |
| **D57** | 0.17 | 534 | 0.33 | 0.64 | 4.70 | 18.3 | 6.18 |
| **D58** | 0.18 | 532 | 0.32 | 0.64 | 4.69 | 16.9 | 7.21 |
| **D59** | 0.19 | 532 | 0.33 | 0.64 | 4.54 | 18.7 | 14.51 |
| **D60** | 0.20 | 532 | 0.34 | 0.63 | 4.22 | 16.9 | 14.27 |
| **D61** | 0.21 | 532 | 0.34 | 0.63 | 4.54 | 18.0 | 17.15 |

As can be concluded from device results XII, device D54 according to the present invention shows a superior overall performance as compared to device D53 which lacks the excitation energy transfer component EET-1 (here a TADF material $E^B$, more specifically $E^B$-11) and device D52 which lacks the hole scavenger $H_{scav}$ (here an excitation energy transfer component EET-2, more specifically a phosphorescence material $P^B$, more specifically $Ir(ppy)_3$) and device D51 which employs $Ir(ppy)_3$ as the emitter material in spite of $S^B$-1 and device D50 which employs $E^B$-11 as the emitter material in spite of $S^B$-1, when taking the narrow emission (FWHM), the efficiency (EQE), and the device lifetime (LT95) into account. When comparing the performance of devices D55 to D58, it can be concluded that the reduction of the concentration of the small FWHM emitter (here exemplarily $S^B$-1) in the EML from 1% to 0.5% may result in a prolonged device lifetime. Devices D59 to D61 were also prepared according to the present invention and, especially in comparison with D55 according to the present invention, indicate that increasing the concentration of the excitation energy transfer component EET-1 (here a TADF material $E^B$, more specifically $E^B$-11) from 20% to 30% or even to 40% may result in an improved overall device performance. The comparison between the devices D55 to D58 and between D60 and D61 indicates that in contrast, a low concentration of the hole scavenger $H_{scav}$ (here an excitation energy transfer component EET-2, more specifically a phosphorescence material $P^B$, more specifically $Ir(ppy)_3$) is beneficial for the device performance. In the absence of the TADF material $E^B$-11, an n-host (here exemplarily $H^B$-5) was used to increase the electron mobility within the EML.

Composition of the light-emitting layer B of devices D62 to D71 (the percentages refer to weight percent):

| Layer | D62 | D63 | D64 | D65 | D66 |
|---|---|---|---|---|---|
| Emission layer (6) | $H^B$ (80%):<br>$H^N$ (0%):<br>EET-1 (20%):<br>$H_{scav}$ (0%):<br>$S^B$ (0%) | $H^B$ (79%):<br>$H^N$ (20%):<br>EET-1 (0%):<br>$H_{scav}$ (1%):<br>$S^B$ (0%) | $H^B$ (79%):<br>$H^N$ (0%):<br>EET-1 (20%):<br>$H_{scav}$ (0%):<br>$S^B$ (1%) | $H^B$ (78%):<br>$H^N$ (20%):<br>EET-1 (0%):<br>$H_{scav}$ (1%):<br>$S^B$ (1%) | $H^B$ (79%):<br>$H^N$ (0%):<br>EET-1 (20%):<br>$H_{scav}$ (1%):<br>$S^B$ (0%) |
| | | | | | |
| **Layer** | **D67** | **D68** | **D69** | **D70** | **D71** |
| Emission layer (6) | $H^B$ (78%):<br>$H^N$ (0%):<br>EET-1 (20%):<br>$H_{scav}$ (1%):<br>$S^B$ (1%) | $H^B$ (75%):<br>$H^N$ (0%):<br>EET-1 (20%):<br>$H_{scav}$ (4%):<br>$S^B$ (1%) | $H^B$ (67%):<br>$H^N$ (0%):<br>EET-1 (30%):<br>$H_{scav}$ (2.5%):<br>$S^B$ (0.5%) | $H^B$ (57%):<br>$H^N$ (0%):<br>EET-1 (40%):<br>$H_{scav}$ (2.5%):<br>$S^B$ (0.5%) | $H^B$ (47%):<br>$H^N$ (0%):<br>EET-1 (50%):<br>$H_{scav}$ (2.5%):<br>$S^B$ (0.5%) |

Setup 5 from Table 6 was used, wherein $H^B$-15 was used as host material $H^B$ (p-host $H^P$), $H^B$-5 was used as host material $H^N$, $E^B$-11 was used as excitation energy transfer component EET-1 (here a TADF material $E^B$), $P^B$-2 was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XIII**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D62** | 0.35 | 530 | 0.34 | 0.57 | 3.51 | 10.98 | 1.00 |
| **D63** | 0.28 | 516 | 0.30 | 0.63 | 3.94 | 21.33 | 2.47 |
| **D64** | 0.17 | 534 | 0.32 | 0.64 | 3.64 | 13.74 | 1.81 |
| **D65** | 0.17 | 534 | 0.32 | 0.65 | 3.96 | 19.87 | 3.76 |
| **D66** | 0.16 | 520 | 0.33 | 0.61 | 4.30 | 15.09 | 5.17 |
| **D67** | 0.17 | 534 | 0.33 | 0.64 | 4.35 | 20.89 | 9.59 |
| **D68** | 0.17 | 534 | 0.34 | 0.64 | 4.65 | 21.9 | 19.51 |
| **D69** | 0.20 | 532 | 0.34 | 0.63 | 4.56 | 19.3 | 23.18 |
| **D70** | 0.22 | 532 | 0.35 | 0.62 | 4.24 | 17.2 | 17.96 |
| **D71** | 0.24 | 532 | 0.36 | 0.61 | 3.96 | 14.6 | 8.61 |

As can be concluded from device results XIII, device D67 according to the present invention shows a superior overall performance as compared to device D66 which lacks the small FWHM emitter $S^B$ (here exemplarily $S^B$-1) and device D65 which lacks the excitation energy transfer component EET-1 (here a TADF material $E^B$, more specifically $E^B$-11) and device D64 which lacks the hole scavenger $H_{scav}$ (here an excitation energy transfer component EET-2, more specifically a phosphorescence material $P^B$, more specifically $P^B$-2) and device D63 which employs $P^B$-2 as the emitter material in spite of $S^B$-1 and device D62 which employs $E^B$-11 as the emitter material in spite of $S^B$-1, when taking the narrow emission (FWHM), the efficiency (EQE), and the device lifetime (LT95) into account. When comparing the performance of devices D67 to D71, it can be concluded that for the given set of materials, a concentration of 30% of EET-1 (here $E^B$-11) and 2.5% of $H_{scav}$ (here EET-2, more specificaly $P^B$-2) and of 0.5% of $S^B$-1 afforded the best performing device (D69).

Composition of the light-emitting layer B of devices D72 to D79 (the percentages refer to weight percent):

| Layer | D72 | D73 | D74 | D75 | D76 |
|---|---|---|---|---|---|
| **Emission layer (6)** | $H^B$ (80%):<br>$H^N$ (0%):<br>EET-1 (20%):<br>$H_{scav}$ (0%):<br>$S^B$ (0%) | $H^B$ (79%):<br>$H^N$ (20%):<br>EET-1 (0%):<br>$H_{scav}$ (1%):<br>$S^B$ (0%) | $H^B$ (79%):<br>$H^N$ (0%):<br>EET-1 (20%):<br>$H_{scav}$ (0%):<br>$S^B$ (1%) | $H^B$ (78%):<br>$H^N$ (20%):<br>EET-1 (0%):<br>$H_{scav}$ (1%):<br>$S^B$ (1%) | $H^B$ (78%):<br>$H^N$ (0%):<br>EET-1 (20%):<br>$H_{scav}$ (1%):<br>$S^B$ (1%) |
| **Layer** | **D77** | **D78** | **D79** | | |
| **Emission layer (6)** | $H^B$ (78.5%):<br>$H^N$ (0%):<br>EET-1 (20%):<br>$H_{scav}$ (1%):<br>$S^B$ (0.5%) | $H^B$ (75%):<br>$H^N$ (0%):<br>EET-1 (20%):<br>$H_{scav}$ (4%):<br>$S^B$ (1%) | $H^B$ (75.5%):<br>$H^N$ (0%):<br>EET-1 (20%):<br>$H_{scav}$ (4%):<br>$S^B$ (0.5%) | | |

Setup 5 from Table 6 was used, wherein $H^B$-15 was used as host material $H^B$ (p-host $H^P$), $H^B$-5 was used as host material $H^N$, $E^B$-11 was used as excitation energy transfer component EET-1 (here a TADF material $E^B$), $P^B$-4 was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XIV**

| Device | FWHM [eV] | $\lambda_{max}$ [nm] | CIEx | CIEy | Voltage at 10 mA/cm² [Volt] | EQE at 1000 cd/m² [%] | Relative lifetime LT95 at 1200 cd/m² |
|---|---|---|---|---|---|---|---|
| **D72** | 0.26 | 528 | 0.34 | 0.57 | 3.67 | 10.6 | 1.00 |
| **D73** | 0.24 | 520 | 0.30 | 0.64 | 4.36 | 25.0 | 0.54 |
| **D74** | 0.17 | 534 | 0.32 | 0.64 | 3.78 | 14.0 | 1.18 |
| **D75** | 0.16 | 532 | 0.32 | 0.65 | 4.39 | 13.2 | 0.57 |
| **D76** | 0.17 | 534 | 0.33 | 0.64 | 4.72 | 19.6 | 3.65 |
| **D77** | 0.18 | 530 | 0.32 | 0.64 | 4.66 | 19.8 | 7.29 |
| **D78** | 0.17 | 534 | 0.34 | 0.64 | 5.71 | 23.5 | 19.39 |
| **D79** | 0.19 | 530 | 0.33 | 0.64 | 5.57 | 22.6 | 35.59 |

As can be concluded from device results XIV, device D76 according to the present invention shows a superior overall performance as compared to device D75 which lacks the excitation energy transfer component EET-1 (here a TADF material $E^B$ , more specifically $E^B$-11) and device D74 which lacks the hole scavenger $H_{scav}$ (here an excitation energy transfer component EET-2, more specifically a phosphorescence material $P^B$, more specifically $P^B$-4) and device D73 which employs $P^B$-4 as the emitter material in spite of $S^B$-1 and device D72 which employs $E^B$-11 as the emitter material in spite of $S^B$-1, when taking the narrow emission (FWHM), the efficiency (EQE), and the device lifetime (LT95) into account. When comparing the performance of devices D76 to D79, it can be concluded that the reduction of the concentration of the small FWHM emitter $S^B$ (here exemplarily $S^B$-1) from 1% to 0.5% may improve the overall device performance.

Composition of the light-emitting layer B of devices D80 to D85 (the percentages refer to weight percent):

| Layer | D80 | D81 | D82 | D83 | D84 |
|---|---|---|---|---|---|
| **Emission layer (6)** | $H^B$ (70%):<br>EET-1 (30%):<br>$H_{scav}$ (0%): | $H^B$ (79.5%):<br>EET-1 (20%):<br>$H_{scav}$ (0%): | $H^B$ (69.5%):<br>EET-1 (30%):<br>$H_{scav}$ (0%): | $H^B$ (66%):<br>EET-1 (30%):<br>$H_{scav}$ (4%): | $H^B$ (75.5%):<br>EET-1 (20%):<br>$H_{scav}$ (4%): |

(continued)

| Layer | D80 | D81 | D82 | D83 | D84 |
|---|---|---|---|---|---|
| | $S^B$ (0%) | $S^B$ (0.5%) | $S^B$ (0.5%) | $S^B$ (0%) | $S^B$ (0.5%) |
| | | | | | |
| **Layer** | **D85** | | | | |
| **Emission layer (6)** | $H^B$ (65.5%):<br>EET-1 (30%):<br>$H_{scav}$ (4%):<br>$S^B$ (0.5%) | | | | |

Setup 5 from Table 6 was used, wherein $H^B$-15 was used as host material $H^B$ (p-host $H^P$), $E^B$-15 was used as excitation energy transfer component EET-1 (here a TADF material $E^B$), $Ir(ppy)_3$ was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XV**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D80** | 0.41 | 532 | 0.35 | 0.57 | 3.43 | 10.2 | 1.00 |
| **D81** | 0.19 | 530 | 0.32 | 0.63 | 3.45 | 12.8 | 0.88 |
| **D82** | 0.19 | 530 | 0.32 | 0.63 | 3.44 | 12.3 | 1.50 |
| **D83** | 0.38 | 518 | 0.36 | 0.59 | 4.50 | 13.2 | 4.50 |
| **D84** | 0.19 | 532 | 0.32 | 0.64 | 4.81 | 18.3 | 5.12 |
| **D85** | 0.19 | 532 | 0.33 | 0.63 | 4.54 | 17.7 | 9.23 |

As can be concluded from device results XV, device D84 according to the present invention shows a superior overall performance as compared to device D81 which lacks the hole scavenger $H_{scav}$ (here an excitation energy transfer component EET-2, more specifically a phosphorescence material $P^B$, more specifically $Ir(ppy)_3$). Furthermore, D85 according to the present invention shows a superior overall performance as compared to device D83 which lacks the small FWHM emitter $S^B$ (here exemplarily $S^B$-1) and device D80 which employs $E^B$-15 as the emitter material in spite of $S^B$-1, when taking the narrow emission (FWHM), the efficiency (EQE), and the device lifetime (LT95) into account.

Composition of the light-emitting layer B of devices D86 to D90 (the percentages refer to weight percent):

| Layer | D86 | D87 | D88 | D89 | D90 |
|---|---|---|---|---|---|
| **Emission layer (6)** | $H^B$ (70%):<br>EET-1 (30%):<br>$H_{scav}$ (0%):<br>$S^B$ (0%) | $H^B$ (79.5%):<br>EET-1 (20%):<br>$H_{scav}$ (0%):<br>$S^B$ (0.5%) | $H^B$ (69.5%):<br>EET-1 (30%):<br>$H_{scav}$ (0%):<br>$S^B$ (0.5%) | $H^B$ (75.5%):<br>EET-1 (20%):<br>$H_{scav}$ (4%):<br>$S^B$ (0.5%) | $H^B$ (65.5%):<br>EET-1 (30%):<br>$H_{scav}$ (4%):<br>$S^B$ (0.5%) |

Setup 5 from Table 6 was used, wherein $H^B$-15 was used as host material $H^B$ (p-host $H^P$), $E^B$-15 was used as excitation energy transfer component EET-1 (here a TADF material $E^B$), $P^B$-2 was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XVI**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D86** | 0.41 | 532 | 0.35 | 0.57 | 3.43 | 10.2 | 1.00 |
| **D87** | 0.19 | 530 | 0.32 | 0.63 | 3.45 | 12.8 | 0.55 |
| **D88** | 0.19 | 532 | 0.32 | 0.63 | 3.44 | 12.3 | 0.96 |
| **D89** | 0.19 | 532 | 0.32 | 0.64 | 5.14 | 19.0 | 1.98 |
| **D90** | 0.20 | 532 | 0.34 | 0.63 | 4.64 | 19.3 | 3.44 |

As can be concluded from device results XVI, devices D89 and D90 according to the present invention show a superior overall performance as compared to device D87 and D88 which lack the hole scavenger $H_{scav}$ (here an excitation energy transfer component EET-2, more specifically a phosphorescence material $P^B$, more specifically $P^B$-2) and device D86 which employs $E^B$-15 as the emitter material in spite of $S^B$-1, when taking the narrow emission (FWHM), the efficiency (EQE), and the device lifetime (LT95) into account.

Composition of the light-emitting layer B of devices D91 to D94 (the percentages refer to weight percent):

| **Layer** | **D91** | **D92** | **D93** | **D94** |
|---|---|---|---|---|
| **Emission layer (6)** | $H^B$ (70%):<br>EET-1 (30%):<br>$H_{scav}$ (0%):<br>$S^B$ (0%) | $H^B$ (69.5%):<br>EET-1 (30%):<br>$H_{scav}$ (0%):<br>$S^B$ (0.5%) | $H^B$ (66%):<br>EET-1 (30%):<br>$H_{scav}$ (4%):<br>$S^B$ (0%) | $H^B$ (65.5%):<br>EET-1 (30%):<br>$H_{scav}$ (4%):<br>$S^B$ (0.5%) |

Setup 5 from Table 6 was used, wherein $H^B$-15 was used as host material $H^B$ (p-host $H^P$), $E^B$-16 was used as excitation energy transfer component EET-1 (here a TADF material $E^B$), $Ir(ppy)_3$ was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XVII**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D91** | 0.33 | 518 | 0.30 | 0.61 | 3.08 | 19.4 | 1.00 |
| **D92** | 0.18 | 532 | 0.31 | 0.64 | 3.25 | 18.7 | 1.72 |
| **D93** | 0.33 | 520 | 0.33 | 0.61 | 3.61 | 20.6 | 7.61 |
| **D94** | 0.18 | 534 | 0.33 | 0.64 | 3.83 | 24.7 | 18.21 |

As can be concluded from device results XVII, device D94 according to the present invention shows a superior overall performance as compared to device D93 which lacks the small FWHM emitter $S^B$ (here exemplarily $S^B$-1) and device D92 which lacks the hole scavenger $H_{scav}$ (here an excitation energy transfer component EET-2, more specifically a phosphorescence material $P^B$, more specifically $Ir(ppy)_3$) and device D91 which employs $E^B$-16 as the emitter material in spite of $S^B$-1, when taking the narrow emission (FWHM), the efficiency (EQE), and the device lifetime (LT95) into account.

Composition of the light-emitting layer B of devices D91 to D94 (the percentages refer to weight percent):

| **Layer** | **D95** | **D96** | **D97** |
|---|---|---|---|
| **Emission layer (6)** | $H^B$ (69.5%):<br>EET-1 (30%):<br>$H_{scav}$ (0%):<br>$S^B$ (0.5%) | $H^B$ (66%):<br>EET-1 (30%):<br>$H_{scav}$ (4%):<br>$S^B$ (0%) | $H^B$ (65.5%):<br>EET-1 (30%):<br>$H_{scav}$ (4%):<br>$S^B$ (0.5%) |

Setup 5 from Table 6 was used, wherein $H^B$-15 was used as host material $H^B$ (p-host $H^P$), $E^B$-17 was used as excitation energy transfer component EET-1 (here a TADF material $E^B$), $Ir(ppy)_3$ was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XVIII**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D95** | 0.20 | 532 | 0.33 | 0.63 | 3.64 | 11.3 | 1.00 |
| **D96** | 0.44 | 550 | 0.40 | 0.56 | 4.27 | 8.4 | 3.77 |
| **D97** | 0.24 | 534 | 0.37 | 0.61 | 4.42 | 13.5 | 4.49 |

As can be concluded from device results XVIII, device D97 according to the present invention shows a superior overall performance as compared to device D96 which lacks the small FWHM emitter $S^B$ (here exemplarily $S^B$-1) and device D95 which lacks the hole scavenger $H_{scav}$ (here an excitation energy transfer component EET-2, more specifically a phosphorescence material $P^B$, more specifically $Ir(ppy)_3$), when taking the narrow emission (FWHM), the efficiency (EQE), and the device lifetime (LT95) into account.

Composition of the light-emitting layer B of devices D98 to D101 (the percentages refer to weight percent):

| **Layer** | **D98** | **D99** | **D100** | **D101** |
|---|---|---|---|---|
| **Emission layer (6)** | $H^B$ (70%):<br>EET-1 (30%):<br>$H_{scav}$ (0%):<br>$S^B$ (0%) | $H^B$ (69.5%):<br>EET-1 (30%):<br>$H_{scav}$ (0%):<br>$S^B$ (0.5%) | $H^B$ (66%):<br>EET-1 (30%):<br>$H_{scav}$ (4%):<br>$S^B$ (0%) | $H^B$ (65.5%):<br>EET-1 (30%):<br>$H_{scav}$ (4%):<br>$S^B$ (0.5%) |

Setup 5 from Table 6 was used, wherein $H^B$-15 was used as host material $H^B$ (p-host $H^P$), $E^B$-18 was used as excitation energy transfer component EET-1 (here a TADF material $E^B$), $Ir(ppy)_3$ was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XIX**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D98** | 0.40 | 535 | 0.37 | 0.57 | 3.68 | 8.7 | 1.00 |
| **D99** | 0.20 | 531 | 0.34 | 0.62 | 3.87 | 8.7 | 1.22 |
| **D100** | 0.43 | 546 | 0.39 | 0.57 | 4.52 | 9.8 | 5.85 |
| **D101** | 0.22 | 532 | 0.36 | 0.61 | 4.80 | 11.4 | 8.24 |

As can be concluded from device results XIX, device D101 according to the present invention shows a superior overall performance as compared to device D100 which lacks the small FWHM emitter $S^B$ (here exemplarily $S^B$-1) and device D99 which lacks the hole scavenger $H_{scav}$ (here an excitation energy transfer component EET-2, more specifically a phosphorescence material $P^B$ , more specifically $Ir(ppy)_3$) and device D98 which employs $E^B$-18 as the emitter material in spite of $S^B$-1, when taking the narrow emission (FWHM), the efficiency (EQE), and the device lifetime (LT95) into account.

Composition of the light-emitting layer B of devices D102 to D105 (the percentages refer to weight percent):

| Layer | D102 | D103 | D104 | D105 |
|---|---|---|---|---|
| **Emission layer (6)** | $H^B$ (70%):<br>EET-1 (30%):<br>$H_{scav}$ (0%):<br>$S^B$ (0%) | $H^B$ (69.5%):<br>EET-1 (30%):<br>$H_{scav}$ (0%):<br>$S^B$ (0.5%) | $H^B$ (66%):<br>EET-1 (30%):<br>$H_{scav}$ (4%):<br>$S^B$ (0%) | $H^B$ (65.5%):<br>EET-1 (30%):<br>$H_{scav}$ (4%):<br>$S^B$ (0.5%) |

Setup 5 from Table 6 was used, wherein $H^B$-15 was used as host material $H^B$ (p-host $H^P$), $E^B$-19 was used as excitation energy transfer component EET-1 (here a TADF material $E^B$), $Ir(ppy)_3$ was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XX**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D102** | 0.41 | 532 | 0.353 | 0.573 | 3.56 | 9.25 | 1.00 |
| **D103** | 0.19 | 531 | 0.324 | 0.631 | 3.64 | 12.31 | 1.70 |
| **D104** | 0.41 | 535 | 0.373 | 0.582 | 4.31 | 11.68 | 4.07 |
| **D105** | 0.20 | 532 | 0.339 | 0.628 | 4.51 | 16.97 | 8.31 |

As can be concluded from device results XX, device D105 according to the present invention shows a superior overall performance as compared to device D104 which lacks the small FWHM emitter $S^B$ (here exemplarily $S^B$-1) and device D103 which lacks the hole scavenger $H_{scav}$ (here an excitation energy transfer component EET-2, more specifically a phosphorescence material $P^B$, more specifically $Ir(ppy)_3$) and device D102 which employs $E^B$-19 as the emitter material in spite of $S^B$-1, when taking the narrow emission (FWHM), the efficiency (EQE), and the device lifetime (LT95) into account.

Composition of the light-emitting layer B of devices D106 to D108 (the percentages refer to weight percent):

| Layer | D106 | D107 | D108 |
|---|---|---|---|
| **Emission layer (6)** | $H^B$ (70%):<br>EET-1 (30%):<br>$H_{scav}$ (0%):<br>$S^B$ (0%) | $H^B$ (69.5%):<br>EET-1 (30%):<br>$H_{scav}$ (0%):<br>$S^B$ (0.5%) | $H^B$ (65.5%):<br>EET-1 (30%):<br>$H_{scav}$ (4%):<br>$S^B$ (0.5%) |

Setup 5 from Table 6 was used, wherein $H^B$-15 was used as host material $H^B$ (p-host $H^P$), $E^B$-21 was used as excitation energy transfer component EET-1 (here a TADF material $E^B$), $Ir(ppy)_3$ was used as hole scavenger $H_{scav}$ (here an excitation energy transfer component EET-2, more specifically a phosphorescence material $P^B$), and $S^B$-1 was used as small FWHM emitter $S^B$. A weight percentage of 0% means the absence of the material in the light-emitting layer B.

**Device results XXI**

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D106** | 0.41 | 520 | 0.30 | 0.56 | 3.65 | 11.2 | 1.00 |
| **D107** | 0.18 | 528 | 0.29 | 0.63 | 3.61 | 12.4 | 1.69 |

(continued)

| Device | FWHM [eV] | $\lambda_{max}$ [nm] | CIEx | CIEy | Voltage at 10 mA/cm$^2$ [Volt] | EQE at 1000 cd/m$^2$ [%] | Relative lifetime LT95 at 1200 cd/m$^2$ |
|---|---|---|---|---|---|---|---|
| **D108** | 0.18 | 530 | 0.31 | 0.65 | 5.10 | 19.4 | 15.88 |

As can be concluded from device results XXI, device D108 according to the present invention shows a superior overall performance as compared to device D107 which lacks the hole scavenger $H_{scav}$ (here an excitation energy transfer component EET-2, more specifically a phosphorescence material $P^B$, more specifically $Ir(ppy)_3$) and device D106 which employs $E^B$-21 as the emitter material in spite of $S^B$-1, when taking the narrow emission (FWHM), the efficiency (EQE), and the device lifetime (LT95) into account.

## Claims

**1.** An organic electroluminescent device comprising one or more light-emitting layers B, each being composed of one or more sublayers, wherein the one or more sublayers are adjacent to each other and as a whole comprise:

(i) one or more excitation energy transfer components EET-1, each having a highest occupied molecular orbital HOMO(EET-1) with an energy $E^{HOMO}$(EET-1) and a lowest unoccupied molecular orbital LUMO(EET-1) with an energy $E^{LUMO}$(EET-1); and
(ii) one or more hole scavengers $H_{scav}$, each having a highest occupied molecular orbital HOMO($H_{scav}$) with an energy $E^{HOMO}$($H_{scav}$) and a lowest unoccupied molecular orbital LUMO($H_{scav}$) with an energy $E^{LUMO}$($H_{scav}$); and
(iii) one or more small full width at half maximum (FWHM) emitters $S^B$, each having a highest occupied molecular orbital HOMO($S^B$) with an energy $EH^{OMO}$($S^B$), and a lowest unoccupied molecular orbital LUMO($S^B$) with an energy $E^{LUMO}$ ($S^B$); and optionally
(iv) one or more host materials $H^B$, each having a highest occupied molecular orbital HOMO($H^B$) with an energy $E^{HOMO}$($H^B$), and a lowest unoccupied molecular orbital LUMO($H^B$) with an energy $E^{LUMO}$($H^B$),

wherein the one or more sublayers which are located at the outer surface of each light-emitting layer B contain at least one material selected from the group consisting of EET-1, $H_{scav}$, and small FWHM emitter $S^B$, and wherein the relations expressed by the following formulas (1) to (6), as far as the respective components are comprised in the same light-emitting layer B, apply:

$$E^{LUMO}(EET\text{-}1) < E^{LUMO}(H^B) \qquad (1)$$

$$E^{LUMO}(EET\text{-}1) < E^{LUMO}(H_{scav}) \qquad (2)$$

$$E^{LUMO}(EET\text{-}1) < E^{LUMO}(S^B) \qquad (3)$$

$$E^{HOMO}(H_{scav}) \geq E^{HOMO}(H^B) \qquad (4)$$

$$E^{HOMO}(H_{scav}) \geq E^{HOMO}(EET\text{-}1) \qquad (5)$$

$$E^{HOMO}(H_{scav}) \geq E^{HOMO}(S^B) \qquad (6),$$

**characterized in that** $S^B$ emits light with a full width at half maximum (FWHM) of less than or equal to 0.25 eV as determinable at approximately 20 °C measured from a film of 2% by weight of the small FWHM emitter in poly(methyl methacrylate) (PMMA)."

**2.** The organic electroluminescent device according to claim 1, wherein within at least one, preferably each, light-emitting layer B, the lowest unoccupied molecular orbital LUMO(EET-1) of at least one, preferably each, excitation energy transfer component EET-1 has an energy $E^{LUMO}$(EET-1) of less than -2.3 eV, wherein the energy E $^{LUMO}$ is

determined via density functional theory calculations using the Turbomole software package, or via cyclic voltammetry of solutions having concentration of $10^{-3}$ mol/l of the organic molecules in dichloromethane, wherein the measurements are conducted at room temperature and under nitrogen atmosphere with a three-electrode assembly (working and counter electrodes: Pt wire, reference electrode: Pt wire) and calibrated using FeCp2/FeCp2$^+$ as internal standard, wherein the LUMO data was corrected using ferrocene as internal standard against SCE.

**3.** The organic electroluminescent device according to one or both of claims 1 and 2, wherein at least one, preferably each, light-emitting layer B comprises less than or equal to 5% by weight, referred to the total weight of the light-emitting layer B, of one or more small FWHM emitters $S^B$.

**4.** The organic electroluminescent device according to one or more of claims 1 to 3, wherein at least one, preferably each, light-emitting layer B comprises 15-50% by weight, referred to the total weight of the light-emitting layer B, of one or more excitation energy transfer components EET-1.

**5.** The organic electroluminescent device according to one or more of claims 1 to 4, wherein at least one, preferably each, light-emitting layer B comprises less than or equal to 5% by weight, referred to the total weight of the light-emitting layer B, of one or more hole scavengers $H_{scav}$.

**6.** The organic electroluminescent device according to one or more of claims 1 to 5, wherein:

(i) each excitation energy transfer component EET-1 has a lowermost excited singlet state $S1^{EET-1}$ with an energy level $E(S1^{EET-1})$ and a lowermost excited triplet state $T1^{EET-1}$ with an energy level $E(T1^{EET-1})$; and
(ii) each hole scavenger $H_{scav}$ has a lowermost excited singlet state $S1^{Hscav}$ with an energy level E(S1Hscav) and a lowermost excited triplet state $T1^{Hscav}$ with an energy level $E(T1^{Hscav})$; and
(iii) each small full width at half maximum (FWHM) emitter $S^B$ has a lowermost excited singlet state $S1^3$ with an energy level $E(S1^S)$ and a lowermost excited triplet state $T1^S$ with an energy level $E(T1^S)$; and
(iv) each optionally comprised host material $H^B$ has a lowermost excited singlet state $S1^H$ with an energy level $E(S1^H)$ and a lowermost excited triplet state $T1^H$ with an energy level $E(T1^H)$;

wherein the relations expressed by the following formulas (7) to (9), as far as the respective components are comprised in the same light-emitting layer B, apply:

$$E(S1^H) > E(S1^{EET-1}) \quad (7)$$

$$E(S1^H) > E(S1^{Hscav}) \quad (8)$$

$$E(S1^H) > E(S1^S) \quad (9).$$

**7.** The organic electroluminescent device according to one or more of claims 1 to 6, wherein the device emits light with an FWHM of the main emission peak of below 0.25 eV, more preferably of below 0.20 eV, even more preferably of below 0.15 eV or even below 0.13 eV.

**8.** The organic electroluminescent device according to one or more of claims 1 to 7, wherein each light-emitting layer B comprised in the electroluminescent device according to the invention consists of exactly one (sub)layer.

**9.** The organic electroluminescent device according to one or more of claims 1 to 8, wherein within each light-emitting layer B, at least one, preferably each, excitation energy transfer component EET-1 and, if comprised in the respective light-emitting layer(s) B, at least one, preferably each, excitation energy transfer component EET-2 fulfill at least one, preferably exactly one, of the following two conditions:

(i) it exhibits a $\Delta E_{ST}$ value, which corresponds to the energy difference between $E(S1^{EET-1})$ and $E(T1^{EET-1})$ and/or to the energy difference between $E(S1^{EET-2})$ and $E(T1^{EET-2})$ of less than 0.4 eV, preferably of less than 0.3 eV, more preferably of less than 0.2 eV, even more preferably of less than 0.1 eV, or even of less than 0.05 eV; and/or
(ii) it comprises at least one, preferably exactly one, transition metal with a standard atomic weight of more than 40.

**10.** The organic electroluminescent device according to one or more of claims 1 to 9, wherein within at least one, preferably each, light-emitting layer B, at least one, preferably each, hole scavenger $H_{scav}$ is an excitation energy transfer component EET-2, wherein within at least one, preferably each, light-emitting layer B that comprises an excitation energy transfer component EET-2, at least one, preferably each excitation energy transfer component EET-2 comprises iridium (Ir) or platinum (Pt).

**11.** The organic electroluminescent device according to one or more of claims 1 to 10, wherein within at least one, preferably each, light-emitting layer B, at least one, preferably each small FWHM emitter $S^B$ fulfills at least one or both of the following requirements:

(i) it is a boron (B)-containing emitter, which means that at least one atom within the (respective) small FWHM emitter $S^B$ is boron (B);
(ii) it comprises a pyrene core structure.

**12.** The organic electroluminescent device according to one or more of claims 1 to 11, wherein in at least one, preferably each, light-emitting layer B, at least one, preferably each, small FWHM emitter $S^B$ comprises or consists of a structure according to either the following formula DABNA-I or the following formula BNE-1:

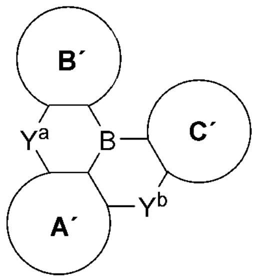

DABNA-I,

wherein

each of ring A', ring B', and ring C' independently of each other represents an aromatic or heteroaromatic ring, each comprising 5 to 24 ring atoms, out of which, in case of a heteroaromatic ring, 1 to 3 ring atoms are heteroatoms independently of each other selected from N, O, S, and Se, wherein
one or more hydrogen atoms in each of the aromatic or heteroaromatic rings A', B', and C' are optionally and independently of each other substituted by a substituent $R^{DABNA-1}$, which is at each occurrence independently of each other selected from the group consisting of: deuterium, $N(R^{DABNA-2})2$, $OR^{DABNA-2}$, $SR^{DABNA-2}$, $Si(R^{DABNA-2})_3$, $B(OR^{DABNA-2})_2$, $OSO_2R^{DABNA-2}$, $CF_3$, CN, halogen,
$C_1$-$C_{40}$-alkyl,
which is optionally substituted with one or more substituents $R^{DABNA-2}$ and wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA_2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;
$C_1$-$C_{40}$-alkoxy,
which is optionally substituted with one or more substituents $R^{DABNA-2}$ and wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;
$C_1$-$C_{40}$-thioalkoxy,
which is optionally substituted with one or more substituents $R^{DABNA-2}$ and wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;
$C_2$-$C_{40}$-alkenyl,
which is optionally substituted with one or more substituents $R^{DABNA-2}$ and wherein one or more non-adjacent $CH_2$-groups are optionally substituted by $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;
$C_2$-$C_{40}$-alkynyl,
which is optionally substituted with one or more substituents $R^{DABNA-2}$ and wherein one or more non-adjacent

$CH_2$-groups are optionally substituted by $R^{DABNA-2}C=CR^{DABNA-2}$, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S or $CONR^{DABNA-2}$;

$C_6$-$C_{60}$-aryl,

which is optionally substituted with one or more substituents $R^{DABNA-2}$;

$C_3$-$C_{57}$-heteroaryl,

which is optionally substituted with one or more substituents $R^{DABNA-2}$; and aliphatic, cyclic amines comprising 4 to 18 carbon atoms and 1 to 3 nitrogen atoms;

$R^{DABNA-2}$ is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $B(OR^{DABNA-6})_2$, $OSO_2R^{DABNA-6}$, $CF_3$, CN, halogen,

$C_1$-$C_5$-alkyl,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-2})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_1$-$C_5$-alkoxy,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_1$-$C_5$-thioalkoxy,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkenyl,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkynyl,

which is optionally substituted with one or more substituents $R^{DABNA-6}$ and wherein one or more non-adjacent $CH_2$-groups are optionally substituted by $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_6$-$C_{18}$-aryl,

which is optionally substituted with one or more substituents $R^{DABNA-6}$;

$C_3$-$C_{17}$-heteroaryl,

which is optionally substituted with one or more substituents $R^{DABNA-6}$; and aliphatic, cyclic amines comprising 4 to 18 carbon atoms and 1 to 3 nitrogen atoms;

wherein two or more adjacent substituents selected from $R^{DABNA-1}$ and $R^{DABNA-2}$ optionally form a mono- or polycyclic, aliphatic or aromatic or heteroaromatic, carbocyclic or heterocyclic ring system which is fused to the adjacent ring A', B' or C', wherein the optionally so formed fused ring system comprises in total 8 to 30 ring atoms;

$Y^a$ and $Y^b$ are independently of each other selected from a direct single bond, $NR^{DABNA-3}$, O, S, $C(R^{DABNA-3})_2$, $Si(R^{DABNA-3})_2$, $BR^{DABNA-3}$, and Se;

$R^{DABNA-3}$ is at each occurrence independently of each other selected from the group consisting of: hydrogen, deuterium, $N(R^{DABNA-4})_2$, $OR^{DABNA-4}$, $SR^{DABNA-4}$, $Si(R^{DABNA-4})_3$, $B(OR^{DABNA-4})_2$, $OSO_2R^{DABNA-4}$, CF3, CN, halogen,

$C_1$-$C_{40}$-alkyl,

which is optionally substituted with one or more substituents $R^{DABNA-4}$ and wherein one or more non-adjacent $CH_2$-groups are optionally substituted by $R^{DABNA-4}C=CR^{DABNA-4}$, C≡C, $S(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_1$-$C_{40}$-alkoxy,

which is optionally substituted with one or more substituents $R^{DABNA-4}$ and wherein one or more non-adjacent $CH_2$-groups are optionally substituted by $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_1$-$C_{40}$-thioalkoxy,

which is optionally substituted with one or more substituents $R^{DABNA-4}$ and wherein one or more non-adjacent $CH_2$-groups are optionally substituted by $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_2$-$C_{40}$-alkenyl,

which is optionally substituted with one or more substituents $R^{DABNA-4}$ and wherein one or more non-adjacent $CH_2$-groups are optionally substituted by $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_2$-$C_{40}$-alkynyl,

which is optionally substituted with one or more substituents $R^{DABNA-4}$ and wherein one or more non-adjacent $CH_2$-groups are optionally substituted by $R^{DABNA-4}C=CR^{DABNA-4}$, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S or $CONR^{DABNA-4}$;

$C_6$-$C_{60}$-aryl,

which is optionally substituted with one or more substituents $R^{DABNA-4}$;

$C_3$-$C_{57}$-heteroaryl,

which is optionally substituted with one or more substituents $R^{DABNA-4}$;

and aliphatic, cyclic amines comprising 4 to 18 carbon atoms and 1 to 3 nitrogen atoms;

$R^{DABNA-4}$ is at each occurrence independently of each other selected from the group consisting of: hydrogen, deuterium, $N(R^{DABNA-5})_2$, $OR^{DABNA-5}$, $SR^{DABNA-5}$, $Si(R^{DABNA-5})_3$, $B(OR^{DABNA-5})_2$, $OSO_2R^{DABNA-5}$, $CF_3$, CN, halogen,

$C_1$-$C_{40}$-alkyl,

which is optionally substituted with one or more substituents $R^{DABNA-5}$ and wherein one or more non-adjacent $CH_2$-groups are optionally substituted by $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S or $CONR^{DABNA-5}$;

$C_1$-$C_{40}$-alkoxy,

which is optionally substituted with one or more substituents $R^{DABNA-5}$ and wherein one or more non-adjacent $CH_2$-groups are optionally substituted by $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S or $CONR^{DABNA-5}$;

$C_1$-$C_{40}$-thioalkoxy,

which is optionally substituted with one or more substituents $R^{DABNA-5}$ and wherein one or more non-adjacent $CH_2$-groups are optionally substituted by $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S or $CONR^{DABNA-5}$;

$C_2$-$C_{40}$-alkenyl,

which is optionally substituted with one or more substituents $R^{DABNA-5}$ and wherein one or more non-adjacent $CH_2$-groups are optionally substituted by $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S or $CONR^{DABNA-5}$;

$C_2$-$C_{40}$-alkynyl,

which is optionally substituted with one or more substituents $R^{DABNA-5}$ and wherein one or more non-adjacent $CH_2$-groups are optionally substituted by $R^{DABNA-5}C=CR^{DABNA-5}$, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S or $CONR^{DABNA-5}$;

$C_6$-$C_{60}$-aryl,

which is optionally substituted with one or more substituents $R^{DABNA-5}$;

$C_3$-$C_{57}$-heteroaryl,

which is optionally substituted with one or more substituents $R^{DABNA-5}$; and aliphatic, cyclic amines comprising 4 to 18 carbon atoms and 1 to 3 nitrogen atoms;

$R^{DABNA-5}$ is at each occurrence independently of each other selected from the group consisting of: hydrogen, deuterium, $N(R^{DABNA-6})_2$, $OR^{DABNA-6}$, $SR^{DABNA-6}$, $Si(R^{DABNA-6})_3$, $B(OR^{DABNA-6})_2$, $OSO_2R^{DABNA-6}$, $CF_3$, CN, halogen,

$C_1$-$C_5$-alkyl,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_1$-$C_5$-alkoxy,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_1$-$C_5$-thioalkoxy,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkenyl,

which is optionally substituted with one or more substituents $R^{DABNA-6}$ and wherein one or more non-adjacent $CH_2$-groups are optionally substituted by $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_2$-$C_5$-alkynyl,

which is optionally substituted with one or more substituents $R^{DABNA-6}$ and wherein one or more non-adjacent $CH_2$-groups are optionally substituted by $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S or $CONR^{DABNA-6}$;

$C_6$-$C_{18}$-aryl,

which is optionally substituted with one or more substituents $R^{DABNA-6}$;

$C_3$-$C_{17}$-heteroaryl,

which is optionally substituted with one or more substituents $R^{DABNA-6}$; and aliphatic, cyclic amines comprising 4 to 18 carbon atoms and 1 to 3 nitrogen atoms;

wherein two or more adjacent substituents selected from $R^{DABNA-3}$, $R^{DABNA-4}$, and $R^{DABNA-5}$ optionally form a mono- or polycyclic, aliphatic or aromatic or heteroaromatic, carbocyclic or heterocyclic ring system with each other, wherein the optionally so formed ring system comprises in total 8 to 30 ring atoms;

$R^{DABNA-6}$ is at each occurrence independently of each other selected from the group consisting of: hydrogen, deuterium, OPh (Ph = phenyl), SPh, $CF_3$, CN, F, $Si(C_1$-$C_5$-$alkyl)_3$, $Si(Ph)_3$,

$C_1$-$C_5$-alkyl,

wherein optionally one or more hydrogen atoms are independently substituted by deuterium, Ph, CN, $CF_3$, or F;

$C_1$-$C_5$-alkoxy,

wherein optionally one or more hydrogen atoms are independently substituted by deuterium, CN, $CF_3$, or F;

$C_1$-$C_5$-thioalkoxy,

wherein optionally one or more hydrogen atoms are independently substituted by deuterium, CN, $CF_3$, or F;

$C_2$-$C_5$-alkenyl,

wherein optionally one or more hydrogen atoms are independently substituted by deuterium, CN, $CF_3$, or F;

$C_2$-$C_5$-alkynyl,

wherein optionally one or more hydrogen atoms are independently substituted by deuterium, CN, $CF_3$, or F;

$C_6$-$C_{18}$-aryl,

wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;

$C_3$-$C_{17}$-heteroaryl,

wherein optionally one or more hydrogen atoms are independently substituted by deuterium, CN, $CF_3$, F, $C_1$-$C_5$-alkyl, $SiMe_3$, $SiPh_3$ or $C_6$-$C_{18}$-aryl substituents;

$N(C_6$-$C_{18}$-$aryl)_2$,

$N(C_3$-$C_{17}$-$heteroaryl)_2$; and

$N(C_3$-$C_{17}$-heteroaryl)$(C_6$-$C_{18}$-aryl);

wherein in case, one of $Y^a$ and $Y^b$ is or both of $Y^a$ and $Y^b$ are $NR^{DABNA-3}$, $C(R^{DABNA-3})_2$, $Si(R^{DABNA-3})_2$, or $BR^{DABNA-3}$ the one or the two substituents $R^{DABNA-3}$ may optionally and independently of each other bond to one or both of the adjacent rings A' and B', for $Y^a$ = $NR^{DABNA-3}$, $C(R^{DABNA-3})_2$, $Si(R^{DABNA-3})_2$, or $BR^{DABNA-3}$, or A' and C', for $Y^b$ = $NR^{DABNA-3}$, $C(R^{DABNA-3})_2$, $Si(R^{DABNA-3})_2$, or $BR^{DABNA-3}$, via a direct single bond or via a connecting atom or atom group being in each case independently selected from $NR^{DABNA-1}$, O, S, $C(R^{DABNA-1})_2$, $Si(R^{DABNA-1})_2$, $BR^{DABNA-1}$, and Se;

and wherein optionally, two or more, preferably two, structures of formula DABNA-I are conjugated with each other, preferably fused to each other by sharing at least one, more preferably exactly one, bond;

wherein optionally two or more, preferably two, structures of formula DABNA-I are present in the emitter and share at least one, preferably exactly one, aromatic or heteroaromatic ring which preferably is any of the rings A', B', and C' of formula DABNA-I, but may also be any aromatic or heteroaromatic substituent selected from $R^{DABNA-1}$, $R^{DABNA-2}$, $R^{DABNA-3}$, $R^{DABNA-4}$, $R^{DABNA-5}$, and $R^{DABNA-6}$, in particular $R^{DABNA-3}$, or any aromatic or heteroaromatic ring formed by two or more adjacent substituents as stated above, wherein the shared ring may constitute the same or different moieties of the two or more structures of formula DABNA-I that share the ring; and

wherein optionally at least one of $R^{DABNA-1}$, $R^{DABNA-2}$, $R^{DABNA-3}$, $R^{DABNA-4}$, $R^{DABNA-5}$, and $R^{DABNA-6}$ is replaced by a bond to a further chemical entity of formula DABNA-I and/or wherein optionally at least one hydrogen atom of any of $R^{DABNA-1}$, $R^{DABNA-2}$, $R^{DABNA-3}$, $R^{DABNA-4}$, $R^{DABNA-5}$, and $R^{DABNA-6}$ is replaced by a bond to a further chemical entity of formula DABNA-I;

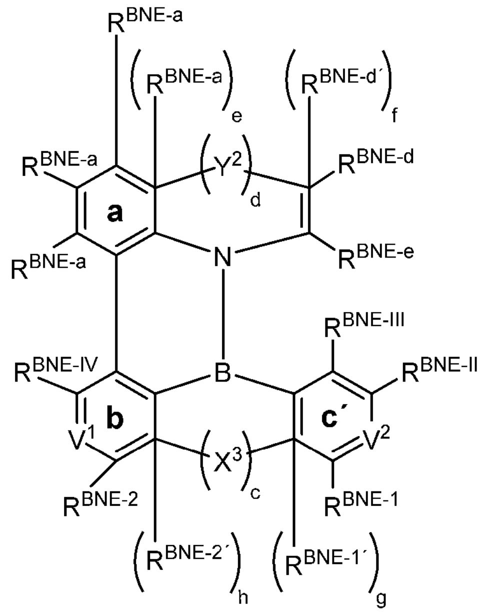

Formula BNE-1,

wherein,

c and d are both integers and independently of each other selected from 0 and 1;

e and f are both integers and selected from 0 and 1, wherein e and f are identical;

g and h are both integers and selected from 0 and 1, wherein g and h are identical;

if d is 0, e and f are both 1, and if d is 1, e and f are both 0;

if c is 0, g and h are both 1, and if c is 1, g and h are both 0;

$V^1$ is selected from nitrogen (N) and $CR^{BNE-V}$;

$V^2$ is selected from nitrogen (N) and $CR^{BNE-I}$;

$X^3$ is selected from the group consisting of a direct bond, $CR^{BNE-3}R^{BNE-4}$, $C=CR^{BNE-3}R^{BNE-4}$, C=O, $C=NR^{BNE-3}$, $NR^{BNE-3}$, O, $SiR^{BNE-3}R^{BNE-4}$, S, S(O) and $S(O)_2$;

$Y^2$ is selected from the group consisting of a direct bond, $CR^{BNE-3'}R^{BNE-4'}$, $C=CR^{BNE-3'}R^{BNE-4'}$, C=O, $C=NR^{BNE-3'}$, $NR^{BNE-3'}$, O, $SiR^{BNE-3'}R^{BNE-4'}$, S, S(O) and $S(O)_2$;

$R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$, $R^{BNE-IV}$, and $R^{BNE-V}$ are each independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,

$C_1$-$C_{40}$-alkyl,

which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-alkoxy,

which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_1$-$C_{40}$-thioalkoxy,

which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkenyl,

which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_2$-$C_{40}$-alkynyl,

which is optionally substituted with one or more substituents $R^{BNE-5}$ and wherein one or more non-adjacent $CH_2$-groups are optionally substituted by $R^{BNE-5}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;

$C_6$-$C_{60}$-aryl,

which is optionally substituted with one or more substituents $R^{BNE-5}$; and
$C_2$-$C_{57}$-heteroaryl,
which is optionally substituted with one or more substituents $R^{BNE-5}$;
$R^{BNE-d}$, $R^{BNE-d'}$, and $R^{BNE-e}$ are independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,
$C_1$-$C_{40}$-alkyl,
which is optionally substituted with one or more substituents $R^{BNE-a}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-alkoxy,
which is optionally substituted with one or more substituents $R^{BNE-a}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-thioalkoxy,
which is optionally substituted with one or more substituents $R^{BNE-a}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkenyl,
which is optionally substituted with one or more substituents $R^{BNE-a}$ and wherein one or more non-adjacent $CH_2$-groups are optionally substituted by $R^{BNE-5}C=CR^{BNE-5}$, $C≡CSi(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkynyl,
which is optionally substituted with one or more substituents $R^{BNE-a}$ and wherein one or more non-adjacent $CH_2$-groups are optionally substituted by $R^{BNE}$-$C=CR^{BNE-5}$, $Si(R^{BNE-5})_2$, $Ge(R^{BNE-5})_2$, $Sn(R^{BNE-5})_2$, C=O, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{60}$-aryl,
which is optionally substituted with one or more substituents $R^{BNE-a}$; and
$C_2$-$C_{57}$-heteroaryl,
which is optionally substituted with one or more substituents $R^{BNE-a}$;
$R^{BNE-a}$ is at each occurrence independently of each other selected from the group consisting of: hydrogen, deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,
$C_1$-$C_{40}$-alkyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-alkoxy,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_1$-$C_{40}$-thioalkoxy,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkenyl,
which is optionally substituted with one or more substituents $R^{BNE-5}$ and wherein one or more non-adjacent $CH_2$-groups are optionally substituted by $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S or $CONR^{BNE-5}$;
$C_2$-$C_{40}$-alkynyl,
which is optionally substituted with one or more substituents $R^{BNE-5}$ and wherein one or more non-adjacent $CH_2$-groups are optionally substituted by $R^{BNE}$-$C=CR^{BNE-5}$, $Si(R^{BNE-5})_2$, $Ge(R^{BNE-5})_2$, $Sn(R^{BNE-5})_2$, C=O, C=Se, $C=NR^{BNE-5}$, $P(=O)(R^{BNE-5})$, SO, $SO_2$, $NR^{BNE-5}$, O, S or $CONR^{BNE-5}$;
$C_6$-$C_{60}$-aryl,
which is optionally substituted with one or more substituents $R^{BNE-5}$; and
$C_2$-$C_{57}$-heteroaryl,
which is optionally substituted with one or more substituents $R^{BNE-5}$;
$R^{BNE-5}$ is at each occurrence independently of each other selected from the group consisting of: hydrogen, deuterium, $N(R^{BNE-6})_2$, $OR^{BNE-6}$, $Si(R^{BNE-6})_3$, $B(OR^{BNE-6})_2$, $B(R^{BNE-6})_2$, $OSO_2R^{BNE-6}$, $CF_3$, CN, F, Cl, Br, I,
$C_1$-$C_{40}$-alkyl,

which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;

$C_1$-$C_{40}$-alkoxy,

which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;

$C_1$-$C_{40}$-thioalkoxy,

which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;

$C_2$-$C_{40}$-alkenyl,

which is optionally substituted with one or more substituents $R^{BNE-6}$ and wherein one or more non-adjacent $CH_2$-groups are optionally substituted by $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;

$C_2$-$C_{40}$-alkynyl,

which is optionally substituted with one or more substituents $R^{BNE-6}$ and wherein one or more non-adjacent $CH_2$-groups are optionally substituted by $R^{BNE-6}C=CR^{BNE-6}$, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S or $CONR^{BNE-6}$;

$C_6$-$C_{60}$-aryl,

which is optionally substituted with one or more substituents $R^{BNE-6}$; and

$C_2$-$C_{57}$-heteroaryl,

which is optionally substituted with one or more substituents $R^{BNE-6}$;

$R^{BNE-6}$ is at each occurrence independently from another selected from the group consisting of: hydrogen, deuterium, OPh, $CF_3$, CN, F,

$C_1$-$C_5$-alkyl,

wherein one or more hydrogen atoms are optionally, independently of each other substituted by deuterium, CN, $CF_3$, Ph or F;

$C_1$-$C_5$-alkoxy, wherein one or more hydrogen atoms are optionally, independently of each other substituted by deuterium, CN, $CF_3$, or F;

$C_1$-$C_5$-thioalkoxy,

wherein one or more hydrogen atoms are optionally, independently of each other substituted by deuterium, CN, $CF_3$, or F;

$C_2$-$C_5$-alkenyl,

wherein one or more hydrogen atoms are optionally, independently of each other substituted by deuterium, CN, $CF_3$, or F;

$C_2$-$C_5$-alkynyl,

wherein one or more hydrogen atoms are optionally, independently of each other substituted by deuterium, CN, $CF_3$, or F;

$C_6$-$C_{18}$-aryl,

which is optionally substituted with one or more $C_1$-$C_5$-alkyl substituents;

$C_2$-$C_{17}$-heteroaryl,

which is optionally substituted with one or more $C_1$-$C_5$-alkyl substituents;

$N(C_6$-$C_{18}$-aryl$)_2$;

$N(C_2$-$C_{17}$-heteroaryl$)_2$, and

$N(C_2$-$C_{17}$-heteroaryl$)(C_6$-$C_{18}$-aryl$)$;

wherein $R^{BNE-III}$ and $R^{BNE-e}$ optionally combine to form a direct single bond; and wherein two or more of substituents $R^{BNE-a}$, $R^{BNE-d}$, $R^{BNE-d'}$, $R^{BNE-e}$, $R^{BNE-3'}$, $R^{BNE-4'}$, $R^{BNE-5}$ optionally form a mono- or polycyclic, aliphatic or aromatic or heteroaromatic, carbo- or heterocyclic ring system with each other;

wherein two or more of the substituents $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-I}$, $R^{BNE-II}$, $R^{BNE-III}$, $R^{BNE-IV}$, $R^{BNE-V}$ optionally form a mono- or polycyclic, aliphatic or aromatic or heteroaromatic, carbo- or heterocyclic ring system with each other;

wherein optionally two or more, preferably two, structures of formula BNE-1 are conjugated with each other, preferably fused to each other by sharing at least one, more preferably exactly one, bond;

wherein optionally two or more, preferably two, structures of formula BNE-1 are present in the emitter and share at least one, preferably exactly one, aromatic or heteroaromatic ring which preferably is any of the rings a, b, and c' of formula BNE-1, but may also be any aromatic or heteroaromatic substituent selected from $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$, $R^{BNE-IV}$, $R^{BNE-V}$,

$R^{BNE-a}$, $R^{BNE-e}$, $R^{BNE-d}$, and $R^{BNE-d'}$, or any aromatic or heteroaromatic ring formed by two or more substituents as stated above, wherein the shared ring may constitute the same or different moieties of the two or more structures of formula BNE-1 that share the ring; and
wherein optionally at least one of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1 and/or wherein optionally at least one hydrogen atom of any of $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, or $R^{BNE-d'}$ is replaced by a bond to a further chemical entity of formula BNE-1.

**13.** The organic electroluminescent device according to one or more of claims 1 to 12, wherein for at least one, preferably each, light-emitting layer B of the organic electroluminescent device according to the present invention, the recombination zone, where electron-hole-recombination occurs upon applying an electrical current to the device, fulfills both of the following criteria:

(i) 20-80% of its volume is located between the electron blocking layer (EBL) and an imaginary boundary surface $S^{EML}$, wherein $S^{EML}$ is parallel to the EBL and located exactly in the middle of the respective light-emitting layer B; and
(ii) 20-80% of its volume is located between the hole blocking layer (HBL) and an imaginary boundary surface $S^{EML}$, wherein $S^{EML}$ is parallel to the HBL and located exactly in the middle of the respective light-emitting layer B;

wherein both the EBL and the HBL are adjacent to the light-emitting layer B with the EBL being closer to the anode and the HBL being closer to the cathode; and wherein the total volume of the recombination zone adds up to 100%.

**14.** A method for generating light, comprising the steps of:

(i) providing an organic electroluminescent device according to any of claims 1 to 13; and
(ii) applying an electrical current to said organic electroluminescent device.

**15.** The method according to claim 14, wherein the method is for generating light with the emission maximum of the main emission peak being within the wavelength range selected from one of the following wavelength ranges:

(i) from 510 nm to 550 nm, or
(ii) from 440 nm to 470 nm, or
(iii) from 610 nm to 665 nm.

**Patentansprüche**

**1.** Organische elektrolumineszente Vorrichtung umfassend eine oder mehrere lichtemittierende Schichten B, die jeweils aus einer oder mehreren Unterschichten bestehen, wobei die eine oder mehreren Unterschichten einander benachbart sind und als Ganzes umfassen:

(i) eine oder mehrere Anregungsenergieübertragungskomponenten EET-1, die jeweils ein höchstes besetztes Molekülorbital HOMO(EET-1) mit einer Energie $E^{HOMO}$(EET-1) und ein niedrigstes unbesetztes Molekülorbital LUMO(EET-1) mit einer Energie $E^{LUMO}$(EET-1) aufweisen; und
(ii) einen oder mehrere Lochfänger $H_{scav}$, die jeweils ein höchstes besetztes Molekülorbital HOMO($H_{scav}$) mit einer Energie $E^{HOMO}$($H_{scav}$) und ein niedrigstes unbesetztes Molekülorbital LUMO($H_{scav}$) mit einer Energie $E^{LUMO}$($H_{scav}$) aufweisen; und
(iii) einen oder mehrere Emitter $S^B$ mit kleiner Halbwertsbreite (FWHM), die jeweils ein höchstes besetztes Molekülorbital HOMO($S^B$) mit einer Energie $E^{HOMO}$($S^B$) und ein niedrigstes unbesetztes Molekülorbital LUMO($S^B$) mit einer Energie $E^{LUMO}$($S^B$) aufweisen; und optional
(iv) ein oder mehrere Wirtsmaterialien $H^B$, die jeweils ein höchstes besetztes Molekülorbital HOMO($H^B$) mit einer Energie $E^{HOMO}$($H^B$) und ein niedrigstes unbesetztes Molekülorbital LUMO($H^B$) mit einer Energie $E^{LUMO}$($H^B$) aufweisen,

wobei die eine oder die mehreren Unterschichten, die sich an der äußeren Oberfläche jeder lichtemittierenden Schicht B befinden, mindestens ein Material enthalten, das aus der Gruppe ausgewählt ist bestehend aus EET-1, $H_{scav}$ und dem Emitter $S^B$ mit kleiner FWHM, und

wobei die durch die folgenden Formeln (1) bis (6) ausgedrückten Beziehungen gelten, soweit die jeweiligen Komponenten in derselben lichtemittierenden Schicht B enthalten sind:

$$E^{LUMO}(EET\text{-}1) < E^{LUMO}(H^B) \quad (1)$$

$$E^{LUMO}(EET\text{-}1) < E^{LUMO}(H_{scav}) \quad (2)$$

$$E^{LUMO}(EET\text{-}1) < E^{LUMO}(S^B) \quad (3)$$

$$E^{HOMO}(H_{scav}) \geq E^{HOMO}(H^B) \quad (4)$$

$$E^{HOMO}(H_{scav}) \geq E^{HOMO}(EET\text{-}1) \quad (5)$$

$$E^{HOMO}(H_{scav}) \geq E^{HOMO}(S^B) \quad (6),$$

**dadurch gekennzeichnet, dass** $S^B$ Licht mit einer Halbwertsbreite (FWHM) von weniger als oder gleich 0,25 eV emittiert, wie bei ungefähr 20 °C bestimmbar, gemessen an einem Film von 2 Gew.-% des Emitters mit kleiner FWHM in Poly(methylmethacrylat) (PMMA).

2. Organische elektrolumineszente Vorrichtung nach Anspruch 1, wobei in mindestens einer, vorzugsweise jeder, lichtemittierenden Schicht B das niedrigste unbesetzte Molekülorbital LUMO(EET-1) von mindestens einer, vorzugsweise jeder, Anregungsenergieübertragungskomponente EET-1 eine Energie $E^{LUMO}$(EET-1) von weniger als -2,3 eV aufweist, wobei die Energie $E^{LUMO}$ bestimmt wird durch Dichtefunktionaltheorieberechnungen unter Verwendung des Turbomole Softwarepakets, oder durch zyklische Voltammetrie von Lösungen mit Konzentration von $10^{-3}$ Mol/L der organischen Moleküle in Dichlormethan, wobei die Messungen bei Raumtemperatur und unter Stickstoffatmosphäre durchgeführt werden mit einer Dreielektroden-Anordnung (Arbeits- und Gegenelektroden: Pt-Draht, Referenzelektrode: Pt-Draht) und kalibriert unter Verwendung von $FeCp_2/FeCp_2^+$ als internem Standard, wobei die LUMO Daten unter Verwendung von Ferrocen als internem Standard gegen SCE korrigiert wurden.

3. Organische elektrolumineszente Vorrichtung nach einem oder beiden der Ansprüche 1 und 2, wobei mindestens eine, vorzugsweise jede, lichtemittierende Schicht B weniger als oder gleich 5 Gew.-%, bezogen auf das Gesamtgewicht der lichtemittierenden Schicht B, eines oder mehrerer Emitter $S^B$ mit kleiner FWHM umfasst.

4. Organische elektrolumineszente Vorrichtung nach einem oder mehreren der Ansprüche 1 bis 3, wobei mindestens eine, vorzugsweise jede, lichtemittierende Schicht B 15-50 Gew.-%, bezogen auf das Gesamtgewicht der lichtemittierenden Schicht B, einer oder mehrerer Anregungsenergieübertragungskomponenten EET-1 umfasst.

5. Organische elektrolumineszente Vorrichtung nach einem oder mehreren der Ansprüche 1 bis 4, wobei mindestens eine, vorzugsweise jede, lichtemittierende Schicht B weniger als oder gleich 5 Gew.-%, bezogen auf das Gesamtgewicht der lichtemittierenden Schicht B, eines oder mehrerer Lochfänger $H_{scav}$ umfasst.

6. Organische elektrolumineszente Vorrichtung nach einem oder mehreren der Ansprüche 1 bis 5, wobei:

(i) jede Anregungsenergieübertragungskomponente EET-1 einen untersten angeregten Singulett-Zustand $S1^{EET-1}$ mit einem Energieniveau $E(S1^{EET-1})$ und einen untersten angeregten Triplett-Zustand $T1^{EET-1}$ mit einem Energieniveau $E(T1^{EET-1})$ aufweist; und
(ii) jeder Lochfänger $H_{scav}$ einen untersten angeregten Singulett-Zustand $S1^{Hscav}$ mit einem Energieniveau $E(S1^{Hscav})$ und einen untersten angeregten Triplett-Zustand $T1^{Hscav}$ mit einem Energieniveau $E(T1^{Hscav})$ aufweist; und
(iii) jeder Emitter $S^B$ mit kleiner Halbwertsbreite (FWHM) einen untersten angeregten Singulett-Zustand $S1^S$ mit einem Energieniveau $E(S1^S)$ und einen untersten angeregten Triplett-Zustand $T1^S$ mit einem Energieniveau $E(T1^S)$ aufweist; und
(iv) jedes optional enthaltene Wirtsmaterial $H^B$ einen untersten angeregten Singulett-Zustand $S1^H$ mit einem Energieniveau $E(S1^H)$ und einen untersten angeregten Triplett-Zustand $T1^H$ mit einem Energieniveau $E(T1^H)$

aufweist;

wobei die durch die folgenden Formeln (7) bis (9) ausgedrückten Beziehungen gelten, soweit die jeweiligen Komponenten in der gleichen lichtemittierenden Schicht B enthalten sind:

$$E(S1^{H}) > E(S1^{EET-1}) \quad (7)$$

$$E(S1^{H}) > E(S1^{Hscav}) \quad (8)$$

$$E(S1^{H}) > E(S1^{S}) \quad (9).$$

**7.** Organische elektrolumineszente Vorrichtung nach einem oder mehreren der Ansprüche 1 bis 6, wobei die Vorrichtung Licht mit einer FWHM des Hauptemissionspeaks von unter 0,25 eV, mehr bevorzugt von unter 0,20 eV, noch mehr bevorzugt von unter 0,15 eV oder sogar unter 0,13 eV emittiert.

**8.** Organische elektrolumineszente Vorrichtung nach einem oder mehreren der Ansprüche 1 bis 7, wobei jede lichtemittierende Schicht B, die in der erfindungsgemäßen elektrolumineszenten Vorrichtung enthalten ist, aus genau einer (Unter-)Schicht besteht.

**9.** Organische elektrolumineszente Vorrichtung nach einem oder mehreren der Ansprüche 1 bis 8, wobei in jeder lichtemittierenden Schicht B mindestens eine, vorzugsweise jede, Anregungsenergieübertragungskomponente EET-1 und, falls in der/den jeweiligen lichtemittierenden Schicht(en) B enthalten, mindestens eine, vorzugsweise jede, Anregungsenergieübertragungskomponente EET-2 mindestens eine, vorzugsweise genau eine, der beiden folgenden Bedingungen erfüllen:

(i) sie weist einen $\Delta E_{ST}$-Wert auf, der der Energiedifferenz zwischen $E(S1^{EET-1})$ und $E(T1^{EET-1})$ und/oder der Energiedifferenz zwischen $E(S1^{EET-2})$ und $E(T1^{EET-2})$ von weniger als 0,4 eV, bevorzugt von weniger als 0,3 eV, mehr bevorzugt von weniger als 0,2 eV, noch mehr bevorzugt von weniger als 0,1 eV oder sogar von weniger als 0,05 eV entspricht; und/oder
(ii) sie umfasst mindestens ein, vorzugsweise genau ein, Übergangsmetall mit einem Standardatomgewicht von mehr als 40.

**10.** Organische elektrolumineszente Vorrichtung nach einem oder mehreren der Ansprüche 1 bis 9, wobei in mindestens einer, vorzugsweise jeder, lichtemittierenden Schicht B mindestens ein, vorzugsweise jeder, Lochfänger $H_{scav}$ eine Anregungsenergieübertragungskomponente EET-2 ist, wobei in mindestens einer, vorzugsweise jeder, lichtemittierenden Schicht B, die eine Anregungsenergieübertragungskomponente EET-2 umfasst, mindestens eine, vorzugsweise jede, Anregungsenergieübertragungskomponente EET-2 Iridium (Ir) oder Platin (Pt) umfasst.

**11.** Organische elektrolumineszente Vorrichtung nach einem oder mehreren der Ansprüche 1 bis 10, wobei innerhalb mindestens einer, vorzugsweise jeder, lichtemittierenden Schicht B mindestens ein, vorzugsweise jeder Emitter $S^{B}$ mit kleiner FWHM mindestens eine oder beide der folgenden Anforderungen erfüllt:

(i) er ist ein Bor (B)-haltiger Emitter, was bedeutet, dass mindestens ein Atom innerhalb des (jeweiligen) Emitters $S^{B}$ mit kleiner FWHM Bor (B) ist;
(ii) er umfasst eine Pyren-Kernstruktur.

**12.** Organische elektrolumineszente Vorrichtung nach einem oder mehreren der Ansprüche 1 bis 11, wobei in mindestens einer, vorzugsweise jeder, lichtemittierenden Schicht B mindestens ein, vorzugsweise jeder, Emitter $S^{B}$ mit kleiner FWHM eine Struktur gemäß entweder der folgenden Formel DABNA-I oder der folgenden Formel BNE-1 umfasst oder daraus besteht:

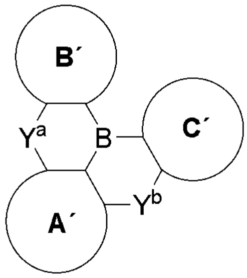

DABNA-I,

wobei

jeder der Ringe A', B' und C' unabhängig voneinander einen aromatischen oder heteroaromatischen Ring darstellt, jeweils umfassend 5 bis 24 Ringatome, von denen im Falle eines heteroaromatischen Rings 1 bis 3 Ringatome unabhängig voneinander Heteroatome sind, ausgewählt aus N, O, S und Se, wobei ein oder mehrere Wasserstoffatome in jedem der aromatischen oder heteroaromatischen Ringe A', B' und C' optional und unabhängig voneinander durch einen Substituenten $R^{DABNA-1}$ ersetzt sind, bei jedem Auftreten unabhängig voneinander ausgewählt aus der Gruppe bestehend aus: Deuterium, $N(R^{DABNA-2})_2$, $OR^{DABNA-2}$, $SR^{DABNA-2}$, $Si(R^{DABNA-2})_3$, $B(OR^{DABNA-2})_2$, $OSO_2R^{DABNA-2}$, $CF_3$, CN, Halogen,
$C_1$-$C_{40}$-Alkyl,

das optional mit einem oder mehreren Substituenten $R^{DABNA-2}$ substituiert ist, und
wobei eine oder mehrere nicht benachbarte $CH_2$-Gruppen optional ersetzt sind durch $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S oder $CONR^{DABNA-2}$;

$C_1$-$C_{40}$-Alkoxy,

das optional mit einem oder mehreren Substituenten $R^{DABNA-2}$ substituiert ist, und
wobei eine oder mehrere nicht benachbarte $CH_2$-Gruppen optional ersetzt sind durch $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S oder $CONR^{DABNA-2}$;

$C_1$-$C_{40}$-Thioalkoxy,

das optional mit einem oder mehreren Substituenten $R^{DABNA-2}$ substituiert ist, und
wobei eine oder mehrere nicht benachbarte $CH_2$-Gruppen optional ersetzt sind durch $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S oder $CONR^{DABNA-2}$;

$C_2$-$C_{40}$-Alkenyl,

das optional mit einem oder mehreren Substituenten $R^{DABNA-2}$ substituiert ist, und
wobei eine oder mehrere nicht benachbarte $CH_2$-Gruppen optional ersetzt sind durch $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S oder $CONR^{DABNA-2}$;

$C_2$-$C_{40}$-Alkinyl,

das optional mit einem oder mehreren Substituenten $R^{DABNA-2}$ substituiert ist, und
wobei eine oder mehrere nicht benachbarte $CH_2$-Gruppen optional ersetzt sind durch $R^{DABNA-2}C=CR^{DABNA-2}$, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S oder $CONR^{DABNA-2}$;

$C_6$-$C_{60}$-Aryl,

das optional mit einem oder mehreren Substituenten $R^{DABNA-2}$ substituiert ist;
$C_3$-$C_{57}$-Heteroaryl,

das optional mit einem oder mehreren Substituenten $R^{DABNA-2}$ substituiert ist;
und aliphatischen, cyclischen Aminen umfassend 4 bis 18 Kohlenstoffatome und 1 bis 3 Stickstoffatome;

$R^{DABNA-2}$ bei jedem Auftreten unabhängig voneinander ausgewählt ist aus der Gruppe bestehend aus: Wasserstoff, Deuterium, $N(R^{DABNA-6})_2$, $OR^{DABNA-6}$, $SR^{DABNA-6}$, $Si(R^{DABNA-6})_3$, $B(OR^{DABNA-6})_2$, $OSO_2R^{DABNA-6}$, $CF_3$, CN, Halogen,
$C_1$-$C_5$-Alkyl,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_1$-$C_5$-Alkoxy,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_1$-$C_5$-Thioalkoxy,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_2$-$C_5$-Alkenyl,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_2$-$C_5$-Alkinyl,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_6$-$C_{18}$-Aryl,
das optional mit einem oder mehreren Substituenten $R^{DABNA-6}$ substituiert ist;
$C_3$-$C_{17}$-Heteroaryl,
das optional mit einem oder mehreren Substituenten $R^{DABNA-6}$ substituiert ist;
und aliphatischen, cyclischen Aminen umfassend 4 bis 18 Kohlenstoffatome
und 1 bis 3 Stickstoffatome;
wobei zwei oder mehrere benachbarte Substituenten ausgewählt aus $R^{DABNA-1}$ und $R^{DABNA-2}$ optional ein mono- oder polycyclisches, aliphatisches oder aromatisches oder heteroaromatisches, carbocyclisches oder heterocyclisches Ringsystem bilden, das mit dem benachbarten Ring A', B' oder C' kondensiert ist, wobei das optional so gebildete kondensierte Ringsystem insgesamt 8 bis 30 Ringatome umfasst;
$Y^a$ und $Y^b$ unabhängig voneinander ausgewählt sind aus einer direkten Einfachbindung, $NR^{DABNA-3}$, O, S, $C(R^{DABNA-3})_2$, $Si(R^{DABNA-3})_2$, $BR^{DABNA-3}$, und Se;

$R^{DABNA-3}$ bei jedem Auftreten unabhängig voneinander ausgewählt ist aus der Gruppe bestehend aus: Wasserstoff, Deuterium, $N(R^{DABNA-4})_2$, $OR^{DABNA-4}$, $SR^{DABNA-4}$, $Si(R^{DABNA-4})_3$, $B(OR^{DABNA-4})_2$, $OSO_2R^{DABNA-4}$, $CF_3$, CN, Halogen,
$C_1$-$C_{40}$-Alkyl,

das optional mit einem oder mehreren Substituenten $R^{DABNA-4}$ substituiert ist, und
wobei eine oder mehrere nicht benachbarte $CH_2$-Gruppen optional ersetzt sind durch $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S oder $CONR^{DABNA-4}$;

$C_1$-$C_{40}$-Alkoxy,

das optional mit einem oder mehreren Substituenten $R^{DABNA-4}$ substituiert ist, und
wobei eine oder mehrere nicht benachbarte $CH_2$-Gruppen optional ersetzt sind durch $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S oder $CONR^{DABNA-4}$;

$C_1$-$C_{40}$-Thioalkoxy,

das optional mit einem oder mehreren Substituenten $R^{DABNA-4}$ substituiert ist, und
wobei eine oder mehrere nicht benachbarte $CH_2$-Gruppen optional ersetzt sind durch $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S oder $CONR^{DABNA-4}$;

$C_2$-$C_{40}$-Alkenyl,

das optional mit einem oder mehreren Substituenten $R^{DABNA-4}$ substituiert ist, und
wobei eine oder mehrere nicht benachbarte $CH_2$-Gruppen optional ersetzt sind durch $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S oder $CONR^{DABNA-4}$;

$C_2$-$C_{40}$-Alkinyl,

das optional mit einem oder mehreren Substituenten $R^{DABNA-4}$ substituiert ist, und
wobei eine oder mehrere nicht benachbarte $CH_2$-Gruppen optional ersetzt sind durch $R^{DABNA-4}C=CR^{DABNA-4}$, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S oder $CONR^{DABNA-4}$;

$C_6$-$C_{60}$-Aryl,
das optional mit einem oder mehreren Substituenten $R^{DABNA-4}$ substituiert ist;
$C_3$-$C_{57}$-Heteroaryl,
das optional mit einem oder mehreren Substituenten $R^{DABNA-4}$ substituiert ist;
und aliphatischen, cyclischen Aminen umfassend 4 bis 18 Kohlenstoffatome und 1 bis 3 Stickstoffatome;
$R^{DABNA-4}$ bei jedem Auftreten unabhängig voneinander ausgewählt ist aus der Gruppe bestehend aus: Wasserstoff, Deuterium, $N(R^{DABNA-5})_2$, $OR^{DABNA-5}$, $SR^{DABNA-5}$, $Si(R^{DABNA-5})_3$, $B(OR^{DABNA-5})_2$, $OSO_2R^{DABNA-5}$, $CF_3$, CN, Halogen,
$C_1$-$C_{40}$-Alkyl,

das optional mit einem oder mehreren Substituenten $R^{DABNA-5}$ substituiert ist, und
wobei eine oder mehrere nicht benachbarte $CH_2$-Gruppen optional ersetzt sind durch $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S oder $CONR^{DABNA-5}$;

$C_1$-$C_{40}$-Alkoxy,

das optional mit einem oder mehreren Substituenten $R^{DABNA-5}$ substituiert ist, und

wobei eine oder mehrere nicht benachbarte $CH_2$-Gruppen optional ersetzt sind durch $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S oder $CONR^{DABNA-5}$;

$C_1$-$C_{40}$-Thioalkoxy,

das optional mit einem oder mehreren Substituenten $R^{DABNA-5}$ substituiert ist, und
wobei eine oder mehrere nicht benachbarte $CH_2$-Gruppen optional ersetzt sind durch $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S oder $CONR^{DABNA-5}$;

$C_2$-$C_{40}$-Alkenyl,

das optional mit einem oder mehreren Substituenten $R^{DABNA-5}$ substituiert ist, und
wobei eine oder mehrere nicht benachbarte $CH_2$-Gruppen optional ersetzt sind durch $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S oder $CONR^{DABNA-5}$;

$C_2$-$C_{40}$-Alkinyl,

das optional mit einem oder mehreren Substituenten $R^{DABNA-5}$ substituiert ist, und
wobei eine oder mehrere nicht benachbarte $CH_2$-Gruppen optional ersetzt sind durch $R^{DABNA-5}C=CR^{DABNA-5}$, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S oder $CONR^{DABNA-5}$;

$C_6$-$C_{60}$-Aryl,
das optional mit einem oder mehreren Substituenten $R^{DABNA-5}$ substituiert ist;
$C_3$-$C_{57}$-Heteroaryl,
das optional mit einem oder mehreren Substituenten $R^{DABNA-5}$ substituiert ist;
und aliphatischen, cyclischen Aminen umfassend 4 bis 18 Kohlenstoffatome und 1 bis 3 Stickstoffatome;
$R^{DABNA-5}$ bei jedem Auftreten unabhängig voneinander ausgewählt aus der Gruppe bestehend aus: Wasserstoff, Deuterium, $N(R^{DABNA-6})_2$, $OR^{DABNA-6}$, $SR^{DABNA-6}$, $Si(R^{DABNA-6})_3$, $B(OR^{DABNA-6})_2$, $OSO_2R^{DABNA-6}$, $CF_3$, CN, Halogen,
$C_1$-$C_5$-Alkyl,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_1$-$C_5$-Alkoxy,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_1$-$C_5$-Thioalkoxy,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_2$-$C_5$-Alkenyl,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_2$-$C_5$-Alkinyl,

das optional mit einem oder mehreren Substituenten $R^{DABNA-6}$ substituiert ist, und
wobei eine oder mehrere nicht benachbarte $CH_2$-Gruppen optional ersetzt sind durch $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S oder $CONR^{DABNA-6}$;

$C_6$-$C_{18}$-Aryl,
das optional mit einem oder mehreren Substituenten $R^{DABNA-6}$ substituiert ist;
$C_3$-$C_{17}$-Heteroaryl,
das optional mit einem oder mehreren Substituenten $R^{DABNA-6}$ substituiert ist;
und aliphatischen, cyclischen Aminen umfassend 4 bis 18 Kohlenstoffatome
und 1 bis 3 Stickstoffatome;
wobei zwei oder mehr benachbarte Substituenten, ausgewählt aus $R^{DABNA-3}$ $R^{DABNA-4}$ und $R^{DABNA-5}$ optional ein mono- oder polycyclisches, aliphatisches oder aromatisches oder heteroaromatisches, carbocyclisches oder heterocyclisches Ringsystem miteinander bilden, wobei das optional so gebildete Ringsystem insgesamt 8 bis 30 Ringatome umfasst;
$R^{DABNA-6}$ bei jedem Auftreten unabhängig voneinander ausgewählt ist aus der Gruppe bestehend aus: Wasserstoff, Deuterium, OPh (Ph = Phenyl), SPh, $CF_3$, CN, F, $Si(C_1$-$C_5$-$Alkyl)_3$, $Si(Ph)_3$,
$C_1$-$C_5$-Alkyl,
wobei optional ein oder mehrere Wasserstoffatome unabhängig voneinander ersetzt sind durch Deuterium, Ph, CN, $CF_3$ oder F;
$C_1$-$C_5$-Alkoxy,
wobei optional ein oder mehrere Wasserstoffatome unabhängig voneinander ersetzt sind durch Deuterium, CN, $CF_3$ oder F;
$C_1$-$C_5$-Thioalkoxy,
wobei optional ein oder mehrere Wasserstoffatome unabhängig voneinander ersetzt sind durch Deuterium, CN, $CF_3$ oder F;
$C_2$-$C_5$-Alkenyl,
wobei optional ein oder mehrere Wasserstoffatome unabhängig voneinander ersetzt sind durch Deuterium, CN, $CF_3$ oder F;
$C_2$-$C_5$-Alkinyl,
wobei optional ein oder mehrere Wasserstoffatome unabhängig voneinander ersetzt sind durch Deuterium, CN, $CF_3$ oder F;
$C_6$-$C_{18}$-Aryl,
wobei optional ein oder mehrere Wasserstoffatome unabhängig voneinander ersetzt sind durch Deuterium, CN, $CF_3$, F, $C_1$-$C_5$-Alkyl, $SiMe_3$, $SiPh_3$ oder $C_6$-$C_{18}$-Aryl Substituenten;
$C_3$-$C_{17}$-Heteroaryl,
wobei optional ein oder mehrere Wasserstoffatome unabhängig voneinander ersetzt sind durch Deuterium, CN, $CF_3$, F, $C_1$-$C_5$-Alkyl, $SiMe_3$, $SiPh_3$ oder $C_6$-$C_{18}$-Aryl Substituenten;
$N(C_6$-$C_{18}$-$Aryl)_2$,
$N(C_3$-$C_{17}$-$Heteroaryl)_2$; und
$N(C_3$-$C_{17}$-Heteroaryl)($C_6$-$C_{18}$-Aryl);
wobei in dem Fall, dass einer von $Y^a$ und $Y^b$ oder beide von $Y^a$ und $Y^b$ $NR^{DABNA-3}$, $C(R^{DABNA-3})_2$, $Si(R^{DABNA-3})_2$, oder $BR^{DABNA-3}$ sind, der eine oder die beiden Substituenten $R^{DABNA-3}$ optional und unabhängig voneinander an einen oder beide der benachbarten Ringe A' und B' gebunden sein können, für $Y^a$ = $NR^{DABNA-3}$, $C(R^{DABNA-3})_2$, $Si(R^{DABNA-3})_2$, oder $BR^{DABNA-3}$, oder A' und C', **für** $Y^b$ = $NR^{DABNA-3}$, $C(R^{DABNA-3})_2$, $Si(R^{DABNA-3})_2$, oder $BR^{DABNA-3}$, über eine direkte Einfachbindung oder über ein verbindendes Atom oder eine verbindende Atomgruppe, die in jedem Fall unabhängig voneinander ausgewählt sind aus $NR^{DABNA-1}$, O, S, $C(R^{DABNA-1})_2$, $Si(R^{DABNA-1})_2$, $BR^{DABNA-1}$ und Se;
und wobei optional zwei oder mehr, vorzugsweise zwei, Strukturen der Formel DABNA-I miteinander konjugiert sind, vorzugsweise miteinander kondensiert sind, indem sie mindestens eine, vorzugsweise genau eine,

Bindung teilen;

wobei optional zwei oder mehr, vorzugsweise zwei Strukturen der Formel DABNA-I in dem Emitter vorhanden sind und mindestens einen, vorzugsweise genau einen, aromatischen oder heteroaromatischen Ring teilen, der vorzugsweise einer der Ringe A', B' und C' der Formel DABNA-I ist, aber auch ein beliebiger aromatischer oder heteroaromatischer Substituent sein kann, ausgewählt aus $R^{DABNA-1}$, $R^{DABNA-2}$, $R^{DABNA-3}$, $R^{DABNA-4}$, $R^{DABNA-5}$ und $R^{DABNA-6}$, insbesondere $R^{DABNA-3}$, oder ein beliebiger aromatischer oder heteroaromatischer Ring sein kann, der durch zwei oder mehrere benachbarte Substituenten, wie oben angegeben, gebildet wird, wobei der geteilte Ring die gleichen oder unterschiedliche Einheiten der zwei oder mehreren Strukturen der Formel DABNA-I, die sich den Ring teilen, bilden kann; und

wobei optional mindestens eines von $R^{DABNA-1}$, $R^{DABNA-2}$, $R^{DABNA-3}$, $R^{DABNA-4}$, $R^{DABNA-5}$ und $R^{DABNA-6}$ durch eine Bindung an eine weitere chemische Einheit der Formel DABNA-I ersetzt ist und/oder wobei optional mindestens ein Wasserstoffatom eines der Reste $R^{DABNA-1}$, $R^{DABNA-2}$, $R^{DABNA-3}$, $R^{DABNA-4}$, $R^{DABNA-5}$ und $R^{DABNA-6}$ durch eine Bindung an eine weitere chemische Einheit der Formel DABNA-I ersetzt ist;

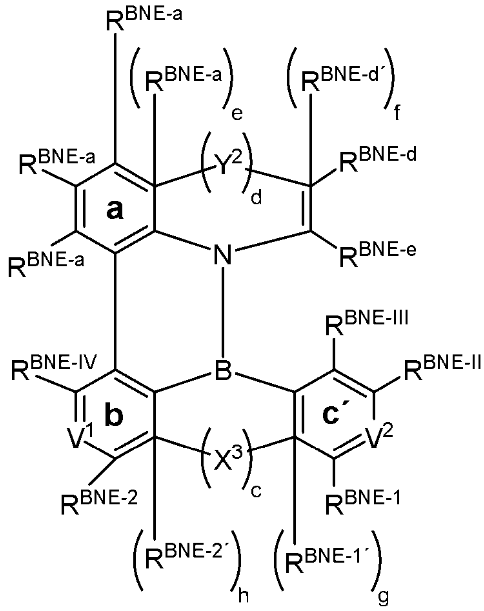

Formel BNE-1,

wobei,

c und d beide ganze Zahlen sind und unabhängig voneinander aus 0 und 1 ausgewählt sind;

e und f beide ganze Zahlen sind und aus 0 und 1 ausgewählt sind, wobei e und f identisch sind;

g und h beide ganze Zahlen sind und aus 0 und 1 ausgewählt sind, wobei g und h identisch sind;

wenn d 0 ist, e und f beide 1 sind, und wenn d 1 ist, e und f beide 0 sind;

wenn c 0 ist, g und h beide 1 sind, und wenn c 1 ist, g und h beide 0 sind;

$V^1$ ausgewählt ist aus Stickstoff (N) und $CR^{BNE-V}$;

$V^2$ ausgewählt ist aus Stickstoff (N) und $CR^{BNE-I}$;

$X^3$ ausgewählt ist aus der Gruppe bestehend aus einer direkten Bindung, $CR^{BNE-3}R^{BNE-4}$, $C{=}CR^{BNE-3}R^{BNE-4}$, C=O, $C{=}NR^{BNE-3}$, $NR^{BNE-3}$, O, $SiR^{BNE-3}R^{BNE-4}$, S, S(O) und $S(O)_2$;

$Y^2$ ausgewählt ist aus der Gruppe bestehend aus einer direkten Bindung, $CR^{BNE-3'}R^{BNE-4'}$, $C{=}CR^{BNE-3'}R^{BNE-4'}$, C=O, $C{=}NR^{BNE-3'}$, $NR^{BNE-3'}$, O, $SiR^{BNE-3'}R^{BNE-4'}$, S, S(O) und $S(O)_2$;

$R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-I}$, $R^{BNE-II}$, $R^{BNE-III}$, $R^{BNE-IV}$, und $R^{BNE-V}$ jeweils unabhängig voneinander ausgewählt sind aus der Gruppe bestehend aus: Wasserstoff, Deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I, $C_1$-$C_{40}$-Alkyl,

das optional mit einem oder mehreren Substituenten $R^{BNE-5}$ substituiert ist, und

wobei eine oder mehrere nicht benachbarte $CH_2$-Gruppen optional ersetzt sind durch $R^{BNE-5}C{=}CR^{BNE-5}$, C≡C, $Si(R^{BNE-5})_2$, $Ge(R^{BNE-5})2$, $Sn(R^{BNE-5})_2$, C=O, C=S, C=Se, $C{=}NR^{BNE-5}$, $P({=}O)(R^{BNE-5})$, SO, $SO_2$, $NR^{BNE-5}$, O, S oder $CONR^{BNE-5}$;

$C_1$-$C_{40}$-Alkoxy,

das optional mit einem oder mehreren Substituenten $R^{BNE-5}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_1$-$C_{40}$-Thioalkoxy,

das optional mit einem oder mehreren Substituenten $R^{BNE-5}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_2$-$C_{40}$-Alkenyl,

das optional mit einem oder mehreren Substituenten $R^{BNE-5}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_2$-$C_{40}$-Alkinyl,

das optional mit einem oder mehreren Substituenten $R^{BNE-5}$ substituiert ist, und
wobei eine oder mehrere nicht benachbarte $CH_2$-Gruppen optional ersetzt sind durch $R^{BNE-5}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_6$-$C_{60}$-Aryl,
das optional mit einem oder mehreren Substituenten $R^{BNE-5}$ substituiert ist; und
$C_2$-$C_{57}$-Heteroaryl,
das optional mit einem oder mehreren Substituenten $R^{BNE-5}$ substituiert ist; und
$R^{BNE-d}$, $R^{BNE-d'}$ und $R^{BNE-e}$ unabhängig voneinander ausgewählt sind aus der Gruppe bestehend aus: Wasserstoff, Deuterium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,
$C_1$-$C_{40}$-Alkyl,

das optional mit einem oder mehreren Substituenten $R^{BNE-a}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_1$-$C_{40}$-Alkoxy,

das optional mit einem oder mehreren Substituenten $R^{BNE-a}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_1$-$C_{40}$-Thioalkoxy,

das optional mit einem oder mehreren Substituenten $R^{BNE-a}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_2$-$C_{40}$-Alkenyl,

das optional mit einem oder mehreren Substituenten $R^{BNE-a}$ substituiert ist, und

wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_2$-$C_{40}$-Alkinyl,

das optional mit einem oder mehreren Substituenten $R^{BNE-a}$ substituiert ist, und
wobei eine oder mehrere nicht benachbarte $CH_2$-Gruppen optional ersetzt sind durch $R^{BNE-5}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_6$-$C_{60}$-Aryl,
das optional mit einem oder mehreren Substituenten $R^{BNE-a}$ substituiert ist; und
$C_2$-$C_{57}$-Heteroaryl,
das optional mit einem oder mehreren Substituenten $R^{BNE-a}$ substituiert ist; und
$R^{BNE-a}$ bei jedem Auftreten unabhängig voneinander ausgewählt ist aus der Gruppe bestehend aus: Wasserstoff, Deuterium, $N(R^{BNE-5})_2$, $OR^{BNE-5}$ $Si(R^{BNE-5})_3$, $B(OR^{BNE-5})_2$, $B(R^{BNE-5})_2$, $OSO_2R^{BNE-5}$, $CF_3$, CN, F, Cl, Br, I,
$C_1$-$C_{40}$-Alkyl,

das optional mit einem oder mehreren Substituenten $R^{BNE-5}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_1$-$C_{40}$-Alkoxy,

das optional mit einem oder mehreren Substituenten $R^{BNE-5}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_1$-$C_{40}$-Thioalkoxy,

das optional mit einem oder mehreren Substituenten $R^{BNE-5}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_2$-$C_{40}$-Alkenyl,

das optional mit einem oder mehreren Substituenten $R^{BNE-5}$ substituiert ist, und
wobei eine oder mehrere nicht benachbarte $CH_2$-Gruppen optional ersetzt sind durch $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_2$-$C_{40}$-Alkinyl,

das optional mit einem oder mehreren Substituenten $R^{BNE-5}$ substituiert ist, und
wobei eine oder mehrere nicht benachbarte $CH_2$-Gruppen optional ersetzt sind durch $R^{BNE-5}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S oder $CONR^{BNE-5}$;

$C_6$-$C_{60}$-Aryl,
das optional mit einem oder mehreren Substituenten $R^{BNE-5}$ substituiert ist; und
$C_2$-$C_{57}$-Heteroaryl,
das optional mit einem oder mehreren Substituenten $R^{BNE-5}$ substituiert ist;
$R^{BNE-5}$ bei jedem Auftreten unabhängig voneinander ausgewählt aus der Gruppe bestehend aus: Wasserstoff, Deuterium, $N(R^{BNE-6})_2$, $OR^{BNE-6}$, $Si(R^{BNE-6})_3$, $B(OR^{BNE-6})_2$, $B(R^{BNE-6})_2$, $OSO_2R^{BNE-6}$, $CF_3$, CN, F, Cl, Br, I,

$C_1$-$C_{40}$-Alkyl,

das optional mit einem oder mehreren Substituenten $R^{BNE-6}$ substituiert ist, und
wobei eine oder mehrere nicht benachbarte $CH_2$-Gruppen optional ersetzt sind durch $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S oder $CONR^{BNE-6}$;

$C_1$-$C_{40}$-Alkoxy,

das optional mit einem oder mehreren Substituenten $R^{BNE-6}$ substituiert ist, und
wobei eine oder mehrere nicht benachbarte $CH_2$-Gruppen optional ersetzt sind durch $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S oder $CONR^{BNE-6}$;

$C_1$-$C_{40}$-Thioalkoxy,

das optional mit einem oder mehreren Substituenten $R^{BNE-6}$ substituiert ist, und
wobei eine oder mehrere nicht benachbarte $CH_2$-Gruppen optional ersetzt sind durch $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S oder $CONR^{BNE-6}$;

$C_2$-$C_{40}$-Alkenyl,

das optional mit einem oder mehreren Substituenten $R^{BNE-6}$ substituiert ist, und
wobei eine oder mehrere nicht benachbarte $CH_2$-Gruppen optional ersetzt sind durch $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S oder $CONR^{BNE-6}$;

$C_2$-$C_{40}$-Alkinyl,

das optional mit einem oder mehreren Substituenten $R^{BNE-6}$ substituiert ist, und
wobei eine oder mehrere nicht benachbarte $CH_2$-Gruppen optional ersetzt sind durch $R^{BNE-6}C=CR^{BNE-6}$, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S oder $CONR^{BNE-6}$;

$C_6$-$C_{60}$-Aryl,
das optional mit einem oder mehreren Substituenten $R^{BNE-6}$ substituiert ist; und
$C_2$-$C_{57}$-Heteroaryl,
das optional mit einem oder mehreren Substituenten $R^{BNE-6}$ substituiert ist;
$R^{BNE-6}$ bei jedem Auftreten unabhängig voneinander ausgewählt ist aus der Gruppe bestehend aus: Wasserstoff, Deuterium, OPh, $CF_3$, CN, F, $C_1$-$C_5$-Alkyl,
wobei ein oder mehrere Wasserstoffatome optional unabhängig voneinander durch Deuterium, CN, $CF_3$, Ph oder F ersetzt sind;
$C_1$-$C_5$-Alkoxy,
wobei ein oder mehrere Wasserstoffatome optional unabhängig voneinander durch Deuterium, CN, $CF_3$, oder F ersetzt sind;
$C_1$-$C_5$-Thioalkoxy,
wobei ein oder mehrere Wasserstoffatome optional unabhängig voneinander durch Deuterium, CN, $CF_3$, oder F ersetzt sind;
$C_2$-$C_5$-Alkenyl,
wobei ein oder mehrere Wasserstoffatome optional unabhängig voneinander durch Deuterium, CN, $CF_3$, oder F ersetzt sind;
$C_2$-$C_5$-Alkinyl,
wobei ein oder mehrere Wasserstoffatome optional unabhängig voneinander durch Deuterium, CN, $CF_3$, oder F ersetzt sind;
$C_6$-$C_{18}$-Aryl,
das optional mit einem oder mehreren $C_1$-$C_5$-Alkylsubstituenten substituiert ist;
$C_2$-$C_{17}$-Heteroaryl,

das optional mit einem oder mehreren $C_1$-$C_5$-Alkylsubstituenten substituiert ist;
$N(C_6$-$C_{18}$-Aryl$)_2$;
$N(C_2$-$C_{17}$-Heteroaryl$)_2$, und
$N(C_2$-$C_{17}$-Heteroaryl$)(C_6$-$C_{18}$-Aryl);
wobei $R^{BNE-III}$ und $R^{BNE-e}$ optional unter Bildung einer direkten Einfachbindung kombiniert sind; und
wobei zwei oder mehr der Substituenten $R^{BNE-a}$, $R^{BNE-d}$, $R^{BNE-d'}$, $R^{BNE-e}$, $R^{BNE-3'}$, $R^{BNE-4'}$, $R^{BNE-5}$ optional ein mono- oder polycyclisches, aliphatisches oder aromatisches oder heteroaromatisches, carbo- oder heterocyclisches Ringsystem miteinander bilden;
wobei zwei oder mehr der Substituenten $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-I}$, $R^{BNE-II}$, $R^{BNE-III}$, $R^{BNE-IV}$, $R^{BNE-V}$ optional ein mono- oder polycyclisches, aliphatisches oder aromatisches oder heteroaromatisches, carbo- oder heterocyclisches Ringsystem miteinander bilden;
wobei optional zwei oder mehr, vorzugsweise zwei Strukturen der Formel BNE-1 miteinander konjugiert sind, vorzugsweise miteinander kondensiert sind, indem sie mindestens eine, vorzugsweise genau eine, Bindung teilen;
wobei optional zwei oder mehr, vorzugsweise zwei Strukturen der Formel BNE-1 in dem Emitter vorhanden sind und mindestens einen, vorzugsweise genau einen, aromatischen oder heteroaromatischen Ring teilen, der vorzugsweise einer der Ringe a, b und c' der Formel BNE-1 ist, aber auch ein beliebiger aromatischer oder heteroaromatischer Substituent sein kann, der aus $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, und $R^{BNE-d'}$, oder ein beliebiger aromatischer oder heteroaromatischer Ring, der durch zwei oder mehr Substituenten, wie oben angegeben, gebildet wird, wobei der geteilte Ring die gleichen oder unterschiedliche Einheiten der zwei oder mehr Strukturen der Formel BNE-1, die sich den Ring teilen, bilden kann; und
wobei optional mindestens eines von $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$ oder $R^{BNE-d'}$ durch eine Bindung an eine weitere chemische Einheit der Formel BNE-1 ersetzt ist und/oder wobei optional mindestens ein Wasserstoffatom von $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$, oder $R^{BNE-d'}$ durch eine Bindung zu einer weiteren chemischen Einheit der Formel BNE-1 ersetzt ist.

**13.** Organische elektrolumineszente Vorrichtung nach einem oder mehreren der Ansprüche 1 bis 12, wobei für mindestens eine, vorzugsweise jede, lichtemittierende Schicht B der organischen elektrolumineszenten Vorrichtung gemäß der vorliegenden Erfindung die Rekombinationszone, in der bei Anlegen eines elektrischen Stroms an die Vorrichtung eine Elektron-Loch-Rekombination stattfindet, beide der folgenden Kriterien erfüllt:

(i) 20-80% ihres Volumens befinden sich zwischen der Elektronensperrschicht (EBL) und einer imaginären Grenzfläche $S^{EML}$, wobei $S^{EML}$ parallel zur EBL ist und genau in der Mitte der jeweiligen lichtemittierenden Schicht B angeordnet ist; und
(ii) 20-80% ihres Volumens befinden sich zwischen der Lochsperrschicht (HBL) und einer imaginären Grenzfläche $S^{EML}$, wobei $S^{EML}$ parallel zur HBL ist und genau in der Mitte der jeweiligen lichtemittierenden Schicht B liegt;

wobei sowohl die EBL als auch die HBL an die lichtemittierende Schicht B angrenzen, wobei die EBL näher an der Anode und die HBL näher an der Kathode liegt; und wobei sich das Gesamtvolumen der Rekombinationszone auf 100% summiert.

**14.** Verfahren zum Erzeugen von Licht, umfassend die Schritte:

(i) Bereitstellen einer organischen elektrolumineszenten Vorrichtung nach einem der Ansprüche 1 bis 13; und
(ii) Anlegen eines elektrischen Stroms an die organische elektrolumineszente Vorrichtung.

**15.** Verfahren nach Anspruch 14, wobei das Verfahren für die Erzeugung von Licht ist, bei dem das Emissionsmaximum des Hauptemissionspeaks innerhalb des Wellenlängenbereichs liegt, der aus einem der folgenden Wellenlängenbereiche ausgewählt ist:

(i) von 510 nm bis 550 nm, oder
(ii) von 440 nm bis 470 nm, oder
(iii) von 610 nm bis 665 nm.

## Revendications

1. Dispositif électroluminescent organique comprenant une ou plusieurs couches émettrices de lumière B, chacune étant composée d'une ou plusieurs sous-couches, la ou les sous-couches étant adjacentes les unes aux autres et comprenant dans leur ensemble :

   (i) un ou plusieurs composants de transfert d'énergie d'excitation EET-1, chacun ayant une orbitale moléculaire occupée la plus haute HOMO(EET-1) avec une énergie $E^{HOMO}$(EET-1) et une orbitale moléculaire inoccupée la plus basse LUMO(EET-1) avec une énergie $E^{LUMO}$(EET-1) ; et
   (ii) un ou plusieurs pièges à trous $H_{scav}$, chacun ayant une orbitale moléculaire occupée la plus haute HOMO($H_{scav}$) avec une énergie $E^{HOMO}(H_{scav})$ et une orbitale moléculaire inoccupée la plus basse LUMO($H_{scav}$) avec une énergie $E^{LUMO}(H_{scav})$ ; et
   (iii) un ou plusieurs émetteurs à faible largeur à mi-hauteur (FWHM) $S^B$, chacun ayant une orbitale moléculaire occupée la plus haute HOMO($S^B$) avec une énergie $E^{HOMO}(S^B)$ et une orbite moléculaire inoccupée la plus basse LUMO($S^B$) avec une énergie $E^{LUMO}(S^B)$ ;
   et éventuellement
   (iv) un ou plusieurs matériaux hôtes $H^B$, chacun ayant une orbite moléculaire occupée la plus haute HOMO($H^B$) avec une énergie $E^{HOMO}(H^B)$ et une orbite moléculaire inoccupée la plus basse LUMO($H^B$) avec une énergie $E^{LUMO}(H^B)$,

   dans lequel la ou les sous-couches qui sont situées au niveau de la surface externe de chaque couche émettrice de lumière B contiennent au moins un matériau choisi dans le groupe constitué par EET-1, $H_{scav}$ et un émetteur à faible FWHM $S^B$, et
   dans lequel les relations exprimées par les formules (1) à (6) suivantes, pour autant que les composants respectifs soient compris dans la même couche émettrice de lumière B, s'appliquent :

$$E^{LUMO}(\text{EET-1}) < E^{LUMO}(H^B) \quad (1)$$

$$E^{LUMO}(\text{EET-1}) < E^{LUMO}(H_{scav}) \quad (2)$$

$$E^{LUMO}(\text{EET-1}) < E^{LUMO}(S^B) \quad (3)$$

$$E^{HOMO}(H_{scav}) \geq E^{HOMO}(H^B) \quad (4)$$

$$E^{HOMO}(H_{scav}) \geq E^{HOMO}(\text{EET-1}) \quad (5)$$

$$E^{HOMO}(H_{scav}) \geq E^{HOMO}(S^B) \quad (6),$$

   **caractérisé en ce que** $S^B$ émet de la lumière avec une largeur à mi-hauteur (FWHM) inférieure ou égale à 0,25 eV telle qu'elle peut être déterminée à environ 20 °C, mesurée à partir d'un film de 2 % en poids de l'émetteur à faible FWHM dans du poly(méthacrylate de méthyle) (PMMA).

2. Dispositif électroluminescent organique selon la revendication 1 dans lequel, à l'intérieur d'au moins une, de préférence de chaque couche émettrice de lumière B, l'orbitale moléculaire inoccupée la plus basse LUMO(EET-1) d'au moins un, de préférence de chaque composant de transfert d'énergie d'excitation EET-1 a une énergie $E^{LUMO}$(EET-1) inférieure à -2,3 eV, l'énergie $E^{LUMO}$ étant déterminée par des calculs de la théorie de la fonctionnelle de la densité au moyen du progiciel Turbomole, ou par voltamétrie cyclique de solutions ayant une concentration de $10^{-3}$ mol/l des molécules organiques dans du dichlorométhane, les mesures étant réalisées à température ambiante et sous atmosphère d'azote avec un montage à trois électrodes (électrode de travail et contre-électrode : fil de Pt, électrode de référence : fil de Pt) et étalonnées au moyen de $FeCp_2/FeCp_2^+$ utilisé comme étalon interne, les données de LUMO ayant été corrigées au moyen de ferrocène utilisé comme étalon interne par rapport à une ECS.

3. Dispositif électroluminescent organique selon une des revendications 1 et 2 ou les deux, dans lequel au moins une, de préférence chaque couche émettrice de lumière B comprend au maximum 5 % en poids, rapporté au poids total de la

couche émettrice de lumière B, d'un ou plusieurs émetteurs à faible FWHM $S^B$.

**4.** Dispositif électroluminescent organique selon une ou plusieurs des revendications 1 à 3, dans lequel au moins une, de préférence chaque couche émettrice de lumière B comprend 15-50 % en poids, rapporté au poids total de la couche émettrice de lumière B, d'un ou plusieurs composants de transfert d'énergie d'excitation EET-1.

**5.** Dispositif électroluminescent organique selon une ou plusieurs des revendications 1 à 4, dans lequel au moins une, de préférence chaque couche émettrice de lumière B comprend au maximum 5 % en poids, rapporté au poids total de la couche émettrice de lumière B, d'un ou plusieurs pièges à trous $H_{scav}$.

**6.** Dispositif électroluminescent organique selon une ou plusieurs des revendications 1 à 5, dans lequel :

(i) chaque composant de transfert d'énergie d'excitation EET-1 présente un état singulet excité le plus bas $S1^{EET-1}$ avec un niveau d'énergie $E(S1^{EET-1})$ et un état triplet excité le plus bas $T1^{EET-1}$ avec un niveau d'énergie $E(T1^{EET-1})$ ; et
(ii) chaque piège à trous $H_{scav}$ présente un état singulet excité le plus bas $S1^{Hscav}$ avec un niveau d'énergie $E(S1^{Hscav})$ et un état triplet excité le plus bas $T1^{Hscav}$ avec un niveau d'énergie $E(T1^{Hscav})$ ; et
(iii) chaque émetteur à faible largeur à mi-hauteur (FWHM) $S^B$ présente un état singulet excité le plus bas $S1^S$ avec un niveau d'énergie $E(S1^S)$ et un état triplet excité le plus bas $T1^S$ avec un niveau d'énergie $E(T1^S)$ ; et
(iv) chaque matériau hôte éventuellement compris $H^B$ présente un état singulet excité le plus bas $S1^H$ avec un niveau d'énergie $E(S1^H)$ et un état triplet excité le plus bas $T1^H$ avec un niveau d'énergie $E(T1^H)$ ;

dans lequel les relations exprimées par les formules (7) à (9) suivantes, pour autant que les composants respectifs soient compris dans la même couche émettrice de lumière B, s'appliquent :

$$E(S1^H) > E(S1^{EET-1}) \qquad (7)$$

$$E(S1^H) > E(S1^{Hscav}) \qquad (8)$$

$$E(S1^H) > E(S1^S) \qquad (9).$$

**7.** Dispositif électroluminescent organique selon une ou plusieurs des revendications 1 à 6, le dispositif émettant de la lumière avec une FWHM du pic d'émission principal inférieur à 0,25 eV, mieux inférieur à 0,20 eV, mieux encore inférieur à 0,15 eV, ou même inférieur à 0,13 eV.

**8.** Dispositif électroluminescent organique selon une ou plusieurs des revendications 1 à 7, chaque couche émettrice de lumière B comprise dans le dispositif électroluminescent selon l'invention consistant en exactement une (sous-) couche.

**9.** Dispositif électroluminescent organique selon une ou plusieurs des revendications 1 à 8 dans lequel, à l'intérieur de chaque couche émettrice de lumière B, au moins un, de préférence chaque composant de transfert d'énergie d'excitation EET-1 et, s'il est compris dans la/les couche(s) émettrice(s) de lumière B respective(s), au moins un, de préférence chaque composant de transfert d'énergie d'excitation EET-2 remplissent au moins une, de préférence exactement une des deux conditions suivantes :

(i) il présente une valeur de $\Delta E_{ST}$, qui correspond à la différence d'énergie entre $E(S1^{EET-1})$ et $E(T_1^{EET-1})$ et/ou à la différence d'énergie entre $E(S1^{EET-2})$ et $E(T1^{EET-2})$, inférieure à 0,4 eV, de préférence inférieure à 0,3 eV, mieux inférieure à 0,2 eV, mieux encore inférieure à 0,1 eV, ou même inférieure à 0,05 eV ; et/ou
(ii) il comprend au moins un, de préférence exactement un métal de transition avec une masse atomique standard supérieure à 40.

**10.** Dispositif électroluminescent organique selon une ou plusieurs des revendications 1 à 9 dans lequel, à l'intérieur d'au moins une, de préférence de chaque couche émettrice de lumière B, au moins un, de préférence chaque piège à trous $H_{scav}$ est un composant de transfert d'énergie d'excitation EET-2, dans lequel, à l'intérieur d'au moins une, de préférence de chaque couche émettrice de lumière B qui comprend un composant de transfert d'énergie d'excitation EET-2, au moins un, de préférence chaque composant de transfert d'énergie d'excitation EET-2 comprend de

l'iridium (Ir) ou du platine (Pt).

**11.** Dispositif électroluminescent organique selon une ou plusieurs des revendications 1 à 10 dans lequel, à l'intérieur d'au moins une, de préférence de chaque couche émettrice de lumière B, au moins un, de préférence chaque émetteur à faible FWHM $S^B$ remplit au moins une des exigences suivantes ou les deux :

(i) il s'agit d'un émetteur contenant du bore (B), ce qui signifie qu'au moins un atome dans l'émetteur à faible FWHM (respectif) $S^B$ est le bore (B) ;
(ii) il comprend une structure de noyau pyrène.

**12.** Dispositif électroluminescent organique selon une ou plusieurs des revendications 1 à 11 dans lequel, dans au moins une, de préférence dans chaque couche émettrice de lumière B, au moins un, de préférence chaque émetteur à faible FWHM $S^B$ comprend ou consiste en une structure répondant à la formule DABNA-I suivante ou à la formule BNE-1 suivante :

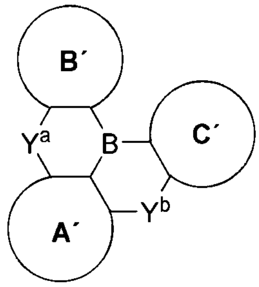

DABNA-I,

dans laquelle
le cycle A', le cycle B' et le cycle C' représentent chacun indépendamment des autres un cycle aromatique ou hétéroaromatique, chacun comprenant 5 à 24 atomes cycliques, dont, dans le cas d'un cycle hétéroaromatique, 1 à 3 atomes cycliques sont des hétéroatomes choisis indépendamment les uns des autres parmi N, O, S et Se, dans lequel
un ou plusieurs atomes d'hydrogène dans chacun des cycles aromatiques ou hétéroaromatiques A', B' et C' sont, éventuellement et indépendamment les uns des autres, substitués par un substituant $R^{DABNA-1}$, qui à chaque occurrence est choisi indépendamment des autres dans le groupe constitué par : le deutérium, $N(R^{DABNA-2})_2$, $OR^{DABNA-2}$, $SR^{DABNA-2}$, $Si(R^{DABNA-2})_3$, $B(OR^{DABNA-2})_2$, $OSO_2R^{DABNA-2}$, $CF_3$, CN, un halogène,
un alkyle en $C_1$-$C_{40}$,
qui est éventuellement substitué par un ou plusieurs substituants $R^{DABNA-2}$ et dans lequel un ou plusieurs groupes $CH_2$ non adjacents sont éventuellement substitués par $R^{DABNA-2}C=CR^{DABNA-2}$, C≡C, $Si(R^{DABNA-2})_2$, $Ge(R^{DABNA-2})_2$, $Sn(R^{DABNA_2})_2$, C=O, C=S, C=Se, $C=NR^{DABNA-2}$, $P(=O)(R^{DABNA-2})$, SO, $SO_2$, $NR^{DABNA-2}$, O, S ou $CONR^{DABNA-2}$ ;
un alcoxy en $C_1$-$C_{40}$,
qui est éventuellement substitué par un ou plusieurs substituants $R^{DABNA-2}$ et dans lequel un ou plusieurs groupes $CH_2$ non adjacents sont éventuellement substitués par $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{PABNA-2})$, SO, $SO_2$, $NR^{DABNA-2}$, O, S ou $CONR^{DABNA-2}$ ;
un thioalcoxy en $C_1$-$C_{40}$,
qui est éventuellement substitué par un ou plusieurs substituants $R^{DABNA-2}$ et dans lequel un ou plusieurs groupes $CH_2$ non adjacents sont éventuellement substitués par $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{PABNA-2})$, SO, $SO_2$, $NR^{DABNA-2}$, O, S ou $CONR^{DABNA-2}$ ;
un alcényle en $C_2$-$C_{40}$,
qui est éventuellement substitué par un ou plusieurs substituants $R^{DABNA-2}$ et dans lequel un ou plusieurs groupes $CH_2$ non adjacents sont éventuellement substitués par $R^{DABNA-2}C=CR^{DABNA-2}$, C≡C, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S ou $CONR^{DABNA-2}$ ;
un alcynyle en $C_2$-$C_{40}$,
qui est éventuellement substitué par un ou plusieurs substituants $R^{DABNA-2}$ et dans lequel un ou plusieurs

groupes $CH_2$ non adjacents sont éventuellement substitués par $R^{DABNA-2}C=CR^{DABNA-2}$, $Si(R^{DABNA-2})_2$, $Ge(R^{DABNA-2})_2$, $Sn(R^{DABNA-2})_2$, C=O, C=S, C=Se, $C=NR^{DABNA-2}$, $P(=O)(R^{DABNA-2})$, SO, $SO_2$, $NR^{DABNA-2}$, O, S ou $CONR^{DABNA-2}$ ;

un aryle en $C_6$-$C_{60}$,

qui est éventuellement substitué par un ou plusieurs substituants $R^{DABNA-2}$ ; un hétéroaryle en $C_3$-$C_{57}$, qui est éventuellement substitué par un ou plusieurs substituants $R^{DABNA-2}$ ; et les amines aliphatiques, cycliques comprenant 4 à 18 atomes de carbone et 1 à 3 atomes d'azote ;

$R^{DABNA-2}$ est à chaque occurrence choisi indépendamment des autres dans le groupe constitué par : l'hydrogène, le deutérium, $N(R^{DABNA-6})_2$, $OR^{DABNA-6}$, $SR^{DABNA-6}$, $Si(R^{DABNA-6})_3$, $B(OR^{DABNA-6})2$, $OSO_2R^{DABNA-6}$, $CF_3$, CN, un halogène,

un alkyle en $C_1$-$C_5$,

qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S ou $CONR^{DABNA-6}$ ;

un alcoxy en $C_1$-$C_5$,

qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S ou $CONR^{DABNA-6}$ ;

un thioalcoxy en $C_1$-$C_5$,

qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S ou $CONR^{DABNA-6}$ ;

un alcényle en $C_2$-$C_5$,

qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S ou $CONR^{DABNA-6}$ ;

un alcynyle en $C_2$-$C_5$,

qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S ou $CONR^{DABNA-6}$ ;

un aryle en $C_6$-$C_{18}$,

qui est éventuellement substitué par un ou plusieurs substituants $R^{DABNA-6}$ ; un hétéroaryle en $C_3$-$C_{17}$, qui est éventuellement substitué par un ou plusieurs substituants $R^{DABNA-6}$ ; et les amines aliphatiques, cycliques comprenant 4 à 18 atomes de carbone et 1 à 3 atomes d'azote ;

dans lequel au moins deux substituants adjacents choisis parmi $R^{DABNA-1}$ et $R^{DABNA-2}$ forment éventuellement un système cyclique mono- ou polycyclique, aliphatique ou aromatique ou hétéroaromatique, carbocyclique ou hétérocyclique qui est condensé au cycle A', B' ou C' adjacent, le système cyclique condensé éventuellement ainsi formé comprenant au total 8 à 30 atomes cycliques ;

$Y^a$ et $Y^b$ sont choisis indépendamment l'un de l'autre parmi une simple liaison directe, $NR^{DABNA-3}$, O, S, $C(R^{DABNA-3})_2$, $Si(R^{DABNA-3})_2$, $BR^{DABNA-3}$ et Se ; $R^{DABNA-3}$ est à chaque occurrence choisi indépendamment des autres dans le groupe constitué par : l'hydrogène, le deutérium, $N(R^{DABNA-4})_2$, $OR^{DABNA-4}$, $SR^{DABNA-4}$, $Si(R^{DABNA-4})_3$, $B(OR^{DABNA-4})_2$, $OSO_2R^{DABNA-4}$, $CF_3$, CN, un halogène,

un alkyle en $C_1$-$C_{40}$,

qui est éventuellement substitué par un ou plusieurs substituants $R^{DABNA-4}$ et dans lequel un ou plusieurs groupes $CH_2$ non adjacents sont éventuellement substitués par $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S ou $CONR^{DABNA-4}$ ;

un alcoxy en $C_1$-$C_{40}$,

qui est éventuellement substitué par un ou plusieurs substituants $R^{DABNA-4}$ et dans lequel un ou plusieurs groupes $CH_2$ non adjacents sont éventuellement substitués par $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S ou $CONR^{DABNA-4}$ ;

un thioalcoxy en $C_1$-$C_{40}$,

qui est éventuellement substitué par un ou plusieurs substituants $R^{DABNA-4}$ et dans lequel un ou plusieurs groupes $CH_2$ non adjacents sont éventuellement substitués par $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S ou $CONR^{DABNA-4}$ ;

un alcényle en $C_2$-$C_{40}$,

qui est éventuellement substitué par un ou plusieurs substituants $R^{DABNA-4}$ et dans lequel un ou plusieurs groupes $CH_2$ non adjacents sont éventuellement substitués par $R^{DABNA-4}C=CR^{DABNA-4}$, C≡C, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S ou $CONR^{DABNA-4}$ ;

un alcynyle en $C_2$-$C_{40}$,

qui est éventuellement substitué par un ou plusieurs substituants $R^{DABNA-4}$ et dans lequel un ou plusieurs groupes $CH_2$ non adjacents sont éventuellement substitués par $R^{DABNA-4}C=CR^{DABNA-4}$, $Si(R^{DABNA-4})_2$, $Ge(R^{DABNA-4})_2$, $Sn(R^{DABNA-4})_2$, C=O, C=S, C=Se, $C=NR^{DABNA-4}$, $P(=O)(R^{DABNA-4})$, SO, $SO_2$, $NR^{DABNA-4}$, O, S ou $CONR^{DABNA-4}$ ;

un aryle en $C_6$-$C_{60}$,

qui est éventuellement substitué par un ou plusieurs substituants $R^{DABNA-4}$ ; un hétéroaryle en $C_3$-$C_{57}$,

qui est éventuellement substitué par un ou plusieurs substituants $R^{DABNA-4}$ ; et les amines aliphatiques, cycliques comprenant 4 à 18 atomes de carbone et 1 à 3 atomes d'azote ;

$R^{DABNA-4}$ est à chaque occurrence choisi indépendamment des autres dans le groupe constitué par : l'hydrogène, le deutérium, $N(R^{DABNA-5})_2$, $OR^{DABNA-5}$, $SR^{DABNA-5}$, $Si(R^{DABNA-5})_3$, $B(OR^{DABNA-5})_2$, $OSO_2R^{DABNA-5}$, $CF_3$, CN, un halogène,

un alkyle en $C_1$-$C_{40}$,

qui est éventuellement substitué par un ou plusieurs substituants $R^{DABNA-5}$ et dans lequel un ou plusieurs groupes $CH_2$ non adjacents sont éventuellement substitués par $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S ou $CONR^{DABNA-5}$ ;

un alcoxy en $C_1$-$C_{40}$,

qui est éventuellement substitué par un ou plusieurs substituants $R^{DABNA-5}$ et dans lequel un ou plusieurs groupes $CH_2$ non adjacents sont éventuellement substitués par $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S ou $CONR^{DABNA-5}$ ;

un thioalcoxy en $C_1$-$C_{40}$,

qui est éventuellement substitué par un ou plusieurs substituants $R^{DABNA-5}$ et dans lequel un ou plusieurs groupes $CH_2$ non adjacents sont éventuellement substitués par $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S ou $CONR^{DABNA-5}$ ;

un alcényle en $C_2$-$C_{40}$,

qui est éventuellement substitué par un ou plusieurs substituants $R^{DABNA-5}$ et dans lequel un ou plusieurs groupes $CH_2$ non adjacents sont éventuellement substitués par $R^{DABNA-5}C=CR^{DABNA-5}$, C≡C, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S ou $CONR^{DABNA-5}$ ;

un alcynyle en $C_2$-$C_{40}$,

qui est éventuellement substitué par un ou plusieurs substituants $R^{DABNA-5}$ et dans lequel un ou plusieurs groupes $CH_2$ non adjacents sont éventuellement substitués par $R^{DABNA-5}C=CR^{DABNA-5}$, $Si(R^{DABNA-5})_2$, $Ge(R^{DABNA-5})_2$, $Sn(R^{DABNA-5})_2$, C=O, C=S, C=Se, $C=NR^{DABNA-5}$, $P(=O)(R^{DABNA-5})$, SO, $SO_2$, $NR^{DABNA-5}$, O, S ou $CONR^{DABNA-5}$ ;

un aryle en $C_6$-$C_{60}$,

qui est éventuellement substitué par un ou plusieurs substituants $R^{DABNA-5}$ ; un hétéroaryle en $C_3$-$C_{57}$,

qui est éventuellement substitué par un ou plusieurs substituants $R^{DABNA-5}$ ; et les amines aliphatiques, cycliques comprenant 4 à 18 atomes de carbone et 1 à 3 atomes d'azote ;

$R^{DABNA-5}$ est à chaque occurrence choisi indépendamment des autres dans le groupe constitué par : l'hydrogène, le deutérium, $N(R^{DABNA-6})_2$, $OR^{DABNA-6}$, $SR^{DABNA-6}$, $Si(R^{DABNA-6})_3$, $B(OR^{DABNA-6})_2$, $OSO_2R^{DABNA-6}$, $CF_3$, CN, un halogène,

un alkyle en $C_1$-$C_5$,

qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(^{RDABNA-6})$, SO, $SO_2$, $NR^{DABNA-6}$, O, S ou $CONR^{DABNA-6}$ ;

un alcoxy en $C_1$-$C_5$,
qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(^{RDABNA-6})$, SO, $SO_2$, $NR^{DABNA-6}$, O, S ou $CONR^{DABNA-6}$ ;
un thioalcoxy en $C_1$-$C_5$,
qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(^{RDABNA-6})$, SO, $SO_2$, $NR^{DABNA-6}$, O, S ou $CONR^{DABNA-6}$ ;
un alcényle en $C_2$-$C_5$,
qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, C≡C, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{DABNA-6})$, SO, $SO_2$, $NR^{DABNA-6}$, O, S ou $CONR^{DABNA-6}$ ;
un alcynyle en $C_2$-$C_5$,
qui est éventuellement substitué par un ou plusieurs substituants $R^{DABNA-6}$ et dans lequel un ou plusieurs groupes $CH_2$ non adjacents sont éventuellement substitués par $R^{DABNA-6}C=CR^{DABNA-6}$, $Si(R^{DABNA-6})_2$, $Ge(R^{DABNA-6})_2$, $Sn(R^{DABNA-6})_2$, C=O, C=S, C=Se, $C=NR^{DABNA-6}$, $P(=O)(R^{PABNA-6})$, SO, $SO_2$, $NR^{DABNA-6}$, O, S ou $CONR^{DABNA-6}$ ;
un aryle en $C_6$-$C_{18}$,
qui est éventuellement substitué par un ou plusieurs substituants $R^{DABNA-6}$ ; un hétéroaryle en $C_3$-$C_{17}$,
qui est éventuellement substitué par un ou plusieurs substituants $R^{DABNA-6}$ ; et les amines aliphatiques, cycliques comprenant 4 à 18 atomes de carbone et 1 à 3 atomes d'azote ;
dans lequel au moins deux substituants adjacents choisis parmi $R^{DABNA-3}$, $R^{DABNA-4}$ et $R^{DABNA-5}$ forment éventuellement l'un avec l'autre un système cyclique mono- ou polycyclique, aliphatique ou aromatique ou hétéroaromatique, carbocyclique ou hétérocyclique, le système cyclique éventuellement ainsi formé comprenant au total 8 à 30 atomes cycliques ; $R^{DABNA-6}$ est à chaque occurrence choisi indépendamment des autres dans le groupe constitué par : l'hydrogène, le deutérium, OPh (Ph = phényle), SPh, $CF_3$, CN, F, un groupe Si(alkyle en $C_1$-$C_5$)$_3$, $Si(Ph)_3$,
un alkyle en $C_1$-$C_5$,
dans lequel, éventuellement, un ou plusieurs atomes d'hydrogène sont substitués indépendamment les uns des autres par le deutérium, Ph, CN, $CF_3$ ou F ;
un alcoxy en $C_1$-$C_5$,
dans lequel, éventuellement, un ou plusieurs atomes d'hydrogène sont substitués indépendamment les uns des autres par le deutérium, CN, $CF_3$ ou F ;
un thioalcoxy en $C_1$-$C_5$,
dans lequel, éventuellement, un ou plusieurs atomes d'hydrogène sont substitués indépendamment les uns des autres par le deutérium, CN, $CF_3$ ou F ;
un alcényle en $C_2$-$C_5$,
dans lequel, éventuellement, un ou plusieurs atomes d'hydrogène sont substitués indépendamment les uns des autres par le deutérium, CN, $CF_3$ ou F ;
un alcynyle en $C_2$-$C_5$,
dans lequel, éventuellement, un ou plusieurs atomes d'hydrogène sont substitués indépendamment les uns des autres par le deutérium, CN, $CF_3$ ou F ;
un aryle en $C_6$-$C_{18}$,
dans lequel, éventuellement, un ou plusieurs atomes d'hydrogène sont indépendamment substitués par les substituants deutérium, CN, $CF_3$, F, alkyle en $C_1$-$C_5$, $SiMe_3$, $SiPh_3$ ou aryle en $C_6$-$C_{18}$ ;
un hétéroaryle en $C_3$-$C_{17}$,
dans lequel, éventuellement, un ou plusieurs atomes d'hydrogène sont indépendamment substitués par les substituants deutérium, CN, $CF_3$, F, alkyle en $C_1$-$C_5$, $SiMe_3$, $SiPh_3$ ou aryle en $C_6$-$C_{18}$ ;
un groupe N(aryle en $C_6$-$C_{18}$)$_2$,
un groupe N(hétéroaryle en $C_3$-$C_{17}$)$_2$ ; et
un groupe N(hétéroaryl en $C_3$-$C_{17}$)(aryle en $C_6$-$C_{18}$) ;
dans lequel, dans le cas où l'un de $Y^a$ et $Y^b$ est, ou $Y^a$ et $Y^b$ sont tous deux $NR^{DABNA-3}$, $C(R^{DABNA-3})_2$, $Si(R^{DABNA-3})_2$ ou $BR^{DABNA-3}$, le substituant $RD^{ABNA-3}$ donné ou les deux substituants $R^{DABNA-3}$ peuvent éventuellement et indépendamment l'un de l'autre se lier à l'un des cycles A' et B' adjacents ou aux deux, pour $Y^a$ = $NR^{DABNA-3}$, $C(R^{DABNA-3})_2$, $Si(R^{DABNA-3})_2$ ou $BR^{DABNA-3}$, ou A' et C', pour $Y^b$ = $NR^{DABNA-3}$, $C(R^{DABNA-3})_2$,

$Si(R^{DABNA-3})_2$ ou $BR^{DABNA-3}$, par une simple liaison directe ou par un atome ou groupe d'atomes de liaison qui dans chaque cas est indépendamment choisi parmi $NR^{DABNA-1}$, O, S, $C(R^{DABNA-1})_2$, $Si(R^{DABNA-1})_2$, $BR^{DABNA-1}$ et Se ;

et dans lequel, éventuellement, au moins deux, de préférence deux structures de formule DABNA-I sont conjuguées entre elles, de préférence condensées entre elles par partage d'au moins une, mieux encore d'exactement une liaison ;

dans lequel, éventuellement, au moins deux, de préférence deux structures de formule DABNA-I sont présentes dans l'émetteur et partagent au moins un, de préférence exactement un cycle aromatique ou hétéroaromatique qui est de préférence l'un quelconque des cycles A', B' et C' de formule DABNA-I, mais peut aussi être n'importe quel substituant aromatique ou hétéroaromatique choisi parmi $R^{DABNA-1}$, $R^{DABNA-2}$, $R^{DABNA-3}$, $R^{DABNA-4}$, $R^{DABNA-5}$ et $R^{DABNA-6}$, en particulier $R^{DABNA-3}$, ou n'importe quel cycle aromatique ou hétéroaromatique formé par au moins deux substituants adjacents tels que mentionnés ci-dessus, le cycle partagé pouvant constituer des groupements identiques ou différents des au moins deux structures de formule DABNA-I qui partagent le cycle ; et dans lequel, éventuellement, l'un au moins de $R^{DABNA-1}$, $R^{DABNA-2}$, $R^{DABNA-3}$, $R^{DABNA-4}$, $R^{DABNA-5}$ et $R^{DABNA-6}$ est remplacé par une liaison à une autre entité chimique de formule DABNA-I et/ou dans lequel, éventuellement, au moins un atome d'hydrogène de l'un quelconque de $R^{DABNA-1}$, $R^{DABNA-2}$, $R^{DABNA-3}$, $R^{DABNA-4}$, $R^{DABNA-5}$ et $R^{DABNA-6}$ est remplacé par une liaison à une autre entité chimique de formule DABNA-I ;

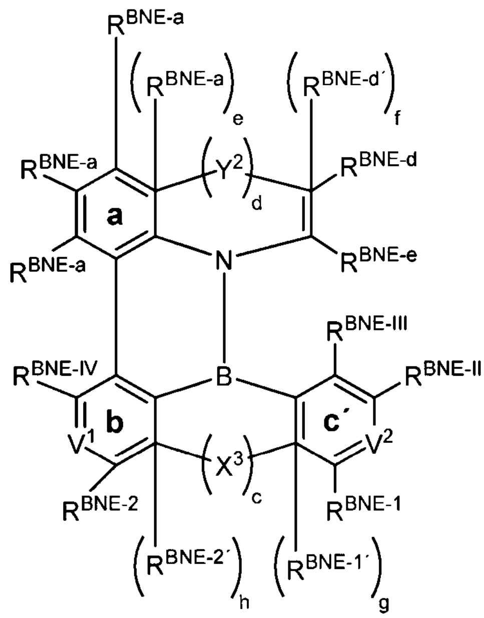

Formule BNE-1,

dans laquelle

c et d sont tous deux des entiers et sont choisis indépendamment l'un de l'autre parmi 0 et 1 ;

e et f sont tous deux des entiers et sont choisis parmi 0 et 1, e et f étant identiques ;

g et h sont tous deux des entiers et sont choisis parmi 0 et 1, g et h étant identiques ;

si d vaut 0, e et f valent tous deux 1, et si d vaut 1, e et f valent tous deux 0 ; si c vaut 0, g et h valent tous deux 1, et si c vaut 1, g et h valent tous deux 0 ;

$V^1$ est choisi parmi l'azote (N) et $CR^{BNE-V}$ ;

$V^2$ est choisi parmi l'azote (N) et $CR^{BNE-I}$ ;

$X^3$ est choisi dans le groupe constitué par une liaison directe, $CR^{BNE-3}R^{BNE-4}$ , $C=CR^{BNE-3}R^{BNE-4}$, C=O, $C=NR^{BNE-3}$, $NR^{BNE-3}$, O, $SiR^{BNE-3}R^{BNE-4}$, S, S(O) et $S(O)_2$ ;

$Y^2$ est choisi dans le groupe constitué par une liaison directe, $CR^{BNE-3'}R^{BNE-4'}$, $C=CR^{BNE-3'}R^{BNE-4'}$, C=O, $C=NR^{BNE-3'}$, $NR^{BNE-3'}$, O, $SiR^{BNE-3'}R^{BNE-4'}$, S, S(O) et $S(O)_2$ ;

$R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-1}$, $R^{BNE-II}$, $R^{BNE-III}$, $R^{BNE-IV}$ et $R^{BNE-V}$ sont chacun choisis indépendamment des autres dans le groupe constitué par : l'hydrogène, le deutérium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$ $CF_3$, CN, F, Cl, Br, I,

un alkyle en $C_1$-$C_{40}$,

qui est éventuellement substitué par un ou plusieurs substituants $R^{BNE-5}$ et dans lequel un ou plusieurs groupes

$CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un alcoxy en $C_1$-$C_{40}$,
qui est éventuellement substitué par un ou plusieurs substituants $R^{BNE-5}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un thioalcoxy en $C_1$-$C_{40}$,
qui est éventuellement substitué par un ou plusieurs substituants $R^{BNE-5}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un alcényle en $C_2$-$C_{40}$,
qui est éventuellement substitué par un ou plusieurs substituants $R^{BNE-5}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un alcynyle en $C_2$-$C_{40}$,
qui est éventuellement substitué par un ou plusieurs substituants $R^{BNE-5}$ et dans lequel un ou plusieurs groupes $CH_2$ non adjacents sont éventuellement substitués par $R^{BNE-5}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un aryle en $C_6$-$C_{60}$,
qui est éventuellement substitué par un ou plusieurs substituants $R^{BNE-5}$ ; et un hétéroaryle en $C_2$-$C_{57}$,
qui est éventuellement substitué par un ou plusieurs substituants $R^{BNE-5}$ ; $R^{BNE-d}$, $R^{BNE-d'}$ et $R^{BNE-e}$ sont choisis indépendamment les uns des autres dans le groupe constitué par : l'hydrogène, le deutérium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$ $CF_3$, CN, F, Cl, Br, I,
un alkyle en $C_1$-$C_{40}$,
qui est éventuellement substitué par un ou plusieurs substituants $R^{BNE-a}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un alcoxy en $C_1$-$C_{40}$,
qui est éventuellement substitué par un ou plusieurs substituants $R^{BNE-a}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un thioalcoxy en $C_1$-$C_{40}$,
qui est éventuellement substitué par un ou plusieurs substituants $R^{BNE-a}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un alcényle en $C_2$-$C_{40}$,
qui est éventuellement substitué par un ou plusieurs substituants $R^{BNE-a}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un alcynyle en $C_2$-$C_{40}$,
qui est éventuellement substitué par un ou plusieurs substituants $R^{BNE-a}$ et dans lequel un ou plusieurs groupes $CH_2$ non adjacents sont éventuellement substitués par $R^{BNE-}C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un aryle en $C_6$-$C_{60}$,
qui est éventuellement substitué par un ou plusieurs substituants $R^{BNE-a}$ ; et un hétéroaryle en $C_2$-$C_{57}$,
qui est éventuellement substitué par un ou plusieurs substituants $R^{BNE-a}$ ; $R^{BNE-a}$ est à chaque occurrence choisi indépendamment des autres dans le groupe constitué par : l'hydrogène, le deutérium, $N(R^{BNE-5})_2$, $OR^{BNE-5}$, $Si(R^{BNE-5})_3$, $B(OR^{BNE-5})_2$, $B(R^{BNE-5})_2$, $OSO_2R^{BNE-5}$, $CF_3$, CN, F, Cl, Br, I,
un alkyle en $C_1$-$C_{40}$,
qui est éventuellement substitué par un ou plusieurs substituants $R^{BNE-5}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un alcoxy en $C_1$-$C_{40}$,
qui est éventuellement substitué par un ou plusieurs substituants $R^{BNE-5}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un thioalcoxy en $C_1$-$C_{40}$,
qui est éventuellement substitué par un ou plusieurs substituants $R^{BNE-5}$ et dans lequel un ou plusieurs groupes

$CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un alcényle en $C_2$-$C_{40}$,
qui est éventuellement substitué par un ou plusieurs substituants $R^{BNE-5}$ et dans lequel un ou plusieurs groupes $CH_2$ non adjacents sont éventuellement substitués par $R^{BNE-5}C=CR^{BNE-5}$, C≡C, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un alcynyle en $C_2$-$C_{40}$,
qui est éventuellement substitué par un ou plusieurs substituants $R^{BNE-5}$ et dans lequel un ou plusieurs groupes $CH_2$ non adjacents sont éventuellement substitués par $R^{BNE}$-$C=CR^{BNE-5}$, $Si(R^{BNE-5})_2$, $Ge(R^{BNE-5})_2$, $Sn(R^{BNE-5})_2$, C=O, C=S, C=Se, $C=NR^{BNE-5}$, $P(=O)(R^{BNE-5})$, SO, $SO_2$, $NR^{BNE-5}$, O, S ou $CONR^{BNE-5}$ ;
un aryle en $C_6$-$C_{60}$,
qui est éventuellement substitué par un ou plusieurs substituants $R^{BNE-5}$ ; et un hétéroaryle en $C_2$-$C_{57}$,
qui est éventuellement substitué par un ou plusieurs substituants $R^{BNE-5}$ ; $R^{BNE-5}$ est à chaque occurrence choisi indépendamment des autres dans le groupe constitué par : l'hydrogène, le deutérium, $N(R^{BNE-6})_2$, $OR^{BNE-6}$, $Si(R^{BNE-6})_3$, $B(OR^{BNE-6})_2$, $B(R^{BNE-6})_2$, $OSO_2R^{BNE-6}$, $CF_3$, CN, F, Cl, Br, I,
un alkyle en $C_1$-$C_{40}$,
qui est éventuellement substitué par un ou plusieurs substituants $R^{BNE-6}$ et dans lequel un ou plusieurs groupes $CH_2$ non adjacents sont éventuellement substitués par $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S ou $CONR^{BNE-6}$ ;
un alcoxy en $C_1$-$C_{40}$,
qui est éventuellement substitué par un ou plusieurs substituants $R^{BNE-6}$ et dans lequel un ou plusieurs groupes $CH_2$ non adjacents sont éventuellement substitués par $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S ou $CONR^{BNE-6}$ ;
un thioalcoxy en $C_1$-$C_{40}$,
qui est éventuellement substitué par un ou plusieurs substituants $R^{BNE-6}$ et dans lequel un ou plusieurs groupes $CH_2$ non adjacents sont éventuellement substitués par $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S ou $CONR^{BNE-6}$ ;
un alcényle en $C_2$-$C_{40}$,
qui est éventuellement substitué par un ou plusieurs substituants $R^{BNE-6}$ et dans lequel un ou plusieurs groupes $CH_2$ non adjacents sont éventuellement substitués par $R^{BNE-6}C=CR^{BNE-6}$, C≡C, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S ou $CONR^{BNE-6}$ ;
un alcynyle en $C_2$-$C_{40}$,
qui est éventuellement substitué par un ou plusieurs substituants $R^{BNE-6}$ et dans lequel un ou plusieurs groupes $CH_2$ non adjacents sont éventuellement substitués par $R^{BNE-6}C=CR^{BNE-6}$, $Si(R^{BNE-6})_2$, $Ge(R^{BNE-6})_2$, $Sn(R^{BNE-6})_2$, C=O, C=S, C=Se, $C=NR^{BNE-6}$, $P(=O)(R^{BNE-6})$, SO, $SO_2$, $NR^{BNE-6}$, O, S ou $CONR^{BNE-6}$ ;
un aryle en $C_6$-$C_{60}$,
qui est éventuellement substitué par un ou plusieurs substituants $R^{BNE-6}$ ; et un hétéroaryle en $C_2$-$C_{57}$,
qui est éventuellement substitué par un ou plusieurs substituants $R^{BNE-6}$ ; $R^{BNE-6}$ est à chaque occurrence choisi indépendamment des autres dans le groupe constitué par : l'hydrogène, le deutérium, OPh, $CF_3$, CN, F,
un alkyle en $C_1$-$C_5$,
dans lequel un ou plusieurs atomes d'hydrogène sont éventuellement substitués indépendamment les uns des autres par le deutérium, CN, $CF_3$, Ph ou F ;
un alcoxy en $C_1$-$C_5$,
dans lequel un ou plusieurs atomes d'hydrogène sont éventuellement substitués indépendamment les uns des autres par le deutérium, CN, $CF_3$ ou F ;
un thioalcoxy en $C_1$-$C_5$,
dans lequel un ou plusieurs atomes d'hydrogène sont éventuellement substitués indépendamment les uns des autres par le deutérium, CN, $CF_3$ ou F ;
un alcényle en $C_2$-$C_5$,
dans lequel un ou plusieurs atomes d'hydrogène sont éventuellement substitués indépendamment les uns des autres par le deutérium, CN, $CF_3$ ou F ;
un alcynyle en $C_2$-$C_5$,
dans lequel un ou plusieurs atomes d'hydrogène sont éventuellement substitués indépendamment les uns des autres par le deutérium, CN, $CF_3$ ou F ;
un aryle en $C_6$-$C_{18}$,
qui est éventuellement substitué par un ou plusieurs substituants alkyle en $C_1$-$C_5$ ;
un hétéroaryle en $C_2$-$C_{17}$,
qui est éventuellement substitué par un ou plusieurs substituants alkyle en $C_1$-$C_5$ ;

un groupe N(aryle en $C_6$-$C_{18}$)$_2$ ;
un groupe N(hétéroaryle en $C_2$-$C_{17}$)$_2$ ; et
un groupe N(hétéroaryl en $C_2$-$C_{17}$)(aryle en $C_6$-$C_{18}$) ;
dans lequel $^{RBNE-III}$ et $R^{BNE-e}$ se combinent éventuellement pour former une simple liaison directe ; et dans lequel au moins deux des substituants $R^{BNE-a}$, $R^{BNE-d}$, $R^{BNE-d'}$, $R^{BNE-e}$, $R^{BNE-3'}$, $R^{BNE-4'}$, $R^{BNE-5}$ forment éventuellement entre eux un système cyclique mono- ou polycyclique, aliphatique ou aromatique ou hétéroaromatique, carbo- ou hétérocyclique ;
dans lequel au moins deux des substituants $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-I}$, $R^{BNE-II}$, $R^{BNE-III}$, $R^{BNE-IV}$, $R^{BNE-V}$ forment éventuellement entre eux un système cyclique mono- ou polycyclique, aliphatique ou aromatique ou hétéroaromatique, carbo- ou hétérocyclique ;
dans lequel, éventuellement, au moins deux, de préférence deux structures de formule BNE-1 sont conjuguées entre elles, de préférence condensées entre elles par partage d'au moins une, de préférence d'exactement une liaison ;
dans lequel, éventuellement, au moins deux, de préférence deux structures de formule BNE-1 sont présentes dans l'émetteur et partagent au moins un, de préférence exactement un cycle aromatique ou hétéroaromatique qui est de préférence l'un quelconque des cycles a, b et c' de formule BNE-1, mais peut aussi être n'importe quel substituant aromatique ou hétéroaromatique choisi parmi $R^{BNE-1}$, $R^{BNE-2}$, $R^{BNE-1'}$, $R^{BNE-2'}$, $R^{BNE-3}$, $R^{BNE-4}$, $R^{BNE-3'}$, $R^{BNE-4'}$, $R^{BNE-5}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$ et $R^{BNE-d'}$, ou n'importe quel cycle aromatique ou hétéroaromatique formé par au moins deux substituants tels que mentionnés ci-dessus, le cycle partagé pouvant constituer des groupements identiques ou différents des au moins deux structures de formule BNE-1 qui partagent le cycle ; et
dans lequel, éventuellement, l'un au moins de $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$ et $R^{BNE-d'}$ est remplacé par une liaison à une autre entité chimique de formule BNE-1 et/ou dans lequel, éventuellement, au moins un atome d'hydrogène de l'un quelconque de $R^{BNE-1}$, $R^{BNE-2}$, $R^{BNE-1'}$, $R^{BNE-2'}$, $R^{BNE-3}$, $R^{BNE-4}$, $R^{BNE-5}$, $R^{BNE-3'}$, $R^{BNE-4'}$, $R^{BNE-6}$, $R^{BNE-I}$, $R^{BNE-II}$, $R^{BNE-III}$, $R^{BNE-IV}$, $R^{BNE-V}$, $R^{BNE-a}$, $R^{BNE-e}$, $R^{BNE-d}$ et $R^{BNE-d'}$ est remplacé par une liaison à une autre entité chimique de formule BNE-1.

**13.** Dispositif électroluminescent organique selon une ou plusieurs des revendications 1 à 12, dans lequel pour au moins une, de préférence pour chaque couche émettrice de lumière B du dispositif électroluminescent organique selon la présente invention, la zone de recombinaison où une recombinaison électron-trou se produit lors de l'application d'un courant électrique au dispositif respecte les deux critères suivants :

(i) 20-80 % de son volume se situe entre la couche de blocage des électrons (EBL) et une surface limite imaginaire $S^{EML}$, $S^{EML}$ étant parallèle à l'EBL et se situant exactement au milieu de la couche émettrice de lumière B respective ; et
(ii) 20-80 % de son volume se situe entre la couche de blocage des trous (HBL) et une surface limite imaginaire $S^{EML}$, $S^{EML}$ étant parallèle à la HBL et se situant exactement au milieu de la couche émettrice de lumière B respective ;

dans lequel l'EBL et la HBL sont adjacentes à la couche émettrice de lumière B, l'EBL étant plus proche de l'anode et la HBL étant plus proche de la cathode ; et dans lequel le volume total de la zone de recombinaison équivaut à 100 %.

**14.** Procédé destiné à générer de la lumière, comprenant les étapes suivantes :

(i) obtention d'un dispositif électroluminescent organique selon l'une quelconque des revendications 1 à 13 ; et
(ii) application d'un courant électrique audit dispositif électroluminescent organique.

**15.** Procédé selon la revendication 14, le procédé étant destiné à générer de la lumière avec un maximum d'émission du pic d'émission principal dans une plage de longueurs d'onde choisie parmi une des plages de longueurs d'onde suivantes :

(i) de 510 nm à 550 nm, ou
(ii) de 440 nm à 470 nm, ou
(iii) de 610 nm à 665 nm.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2020136059 A1
- US 2015105564 A1
- US 2015048338 A1
- US 2015141642 A1
- US 2014336379 A1
- US 2014138670 A1
- US 2012241732 A1
- EP 3315581 A1
- EP 3483156 A1
- US 2018053901 A1
- WO 2017005699 A
- US 2020274081 A1
- US 20010019782 A1
- US 20020034656 A1
- US 20030138657 A1
- US 2005123791 A1
- US 20060065890 A1
- US 20060134462 A1
- US 20070034863 A1
- US 20070111026 A1
- US 2007034863 A1
- US 2007138437 A1
- US 20080020237 A1
- US 20080297033 A1
- US 2008210930 A1
- US 20090115322 A1
- US 2009104472 A1
- US 20100244004 A1
- US 2010105902 A1
- US 20110057559 A1
- US 2011215710 A1
- US 2012292601 A1
- US 2013165653 A1
- US 20140246656 A1
- US 20030068526 A1
- US 20050123788 A1
- US 2005260449 A1
- US 20060127696 A1
- US 20060202194 A1
- US 20070087321 A1
- US 20070190359 A1
- US 2007104979 A1
- US 2007224450 A1
- US 20080233410 A1
- US 200805851 A1
- US 20090039776 A1
- US 20090179555 A1
- US 20100090591 A1
- US 20100295032 A1
- US 20030072964 A1
- US 20050244673 A1
- US 20060008670 A1
- US 20060134459 A1
- US 20060251923 A1
- US 20070103060 A1
- US 20070231600 A1
- US 2007104980 A1
- US 2007278936 A1
- US 20080261076 A1
- US 2008161567 A1
- US 20090108737 A1
- US 2009085476 A1
- US 20100148663 A1
- US 2010102716 A1
- US 2010270916 A1
- US 20110204333 A1
- US 2011285275 A1
- US 2013033172 A1
- US 2013334521 A1
- US 2014103305 A1
- US 2003068536 A1
- US 2003085646 A1
- US 2006228581 A1
- US 2006197077 A1
- US 2011114922 A1
- US 2003054198 A1
- EP 2730583 A1
- US 2003017361 A1
- US 2004262576 A1
- WO 2010027583 A1
- US 2019245153 A1
- US 2013119354 A1
- US 2019233451 A1
- US 2020251663 A1
- EP 3671884 A1
- US 20160230960 A1
- US 20150303378 A1
- US 2012037890 A1
- US 20190288221 A1
- EP 3109253 A1
- US 2014058099 A1
- US 2009295275 A1
- US 2012319052 A1
- EP 2182040 A2
- US 2018069182 A1
- US 2019393419 A1
- US 2020006671 A1
- US 2020098991 A1

- US 2020176684 A1
- US 2020161552 A1
- US 2020227639 A1
- US 2020185635 A1
- EP 3686206 A1
- WO 2020217229 A1
- WO 2020208051 A1
- US 2020328351 A1
- WO 2020135953 A1
- US 2018047912 A1
- US 2017077418 A1
- US 2006006365 A1
- US 2006208221 A1
- US 2005069729 A1
- EP 1205527 A1
- US 2009302752 A1
- US 20090134784 A1
- US 2009302742 A1
- US 2010187977 A1
- US 2012068170 A1
- US 2012097899 A1
- US 2006121308 A1
- US 2009167166 A1
- US 2007176147 A1
- US 2015322091 A1
- US 2011105778 A1
- US 2011201778 A1
- US 2011121274 A1
- US 2010244009 A1
- US 2009136779 A1
- US 2012202997 A1
- US 2019393424 A1
- US 2019393425 A1
- US 2020168819 A1
- US 2020079762 A1
- US 2012292576 A1
- EP 2690681 A1

**Non-patent literature cited in the description**


- **H. TANAKA** ; **K. SHIZU** ; **H. NAKANOTANI** ; **C. ADACHI**. *Chemistry of Materials*, 2013, vol. 25 (18), 3766
- **J. LI** ; **T. NAKAGAWA** ; **J. MACDONALD** ; **Q. ZHANG** ; **H. NOMURA** ; **H. MIYAZAKI** ; **C. ADACHI**. *Advanced Materials*, 2013, vol. 25 (24), 3319
- **K. NASU** ; **T. NAKAGAWA** ; **H. NOMURA** ; **C.-J. LIN** ; **C.-H. CHENG** ; **M.-R. TSENG** ; **T. YASUDAAD** ; **C. ADACHI**. *Chemical Communications*, 2013, vol. 49 (88), 10385
- **Q. ZHANG** ; **B. LI1** ; **S. HUANG** ; **H. NOMURA** ; **H. TANAKA** ; **C. ADACHI**. *Nature Photonics*, 2014, vol. 8 (4), 326
- **B. WEX** ; **B.R. KAAFARANI**. *Journal of Materials Chemistry C*, 2017, vol. 5, 8622
- **Y. IM** ; **M. KIM** ; **Y.J. CHO** ; **J.-A. SEO** ; **K.S. YOOK** ; **J.Y. LEE**. *Chemistry of Materials*, 2017, vol. 29 (5), 1946
- **T.-T. BUI** ; **F. GOUBARD** ; **M. IBRAHIM-OUALI** ; **D. GIGMES** ; **F. DUMUR**. *Beilstein Journal of Organic Chemistry*, 2018, vol. 14, 282
- **X. LIANG** ; **Z.-L. TU** ; **Y.-X. ZHENG**. *Chemistry - A European Journal*, 2019, vol. 25 (22), 5623
- **C.-L. HO** ; **H. LI** ; **W.-Y. WONG**. *Journal of Organometallic Chemistry*, 2014, vol. 751, 261
- **T. FLEETHAM** ; **G. LI** ; **J. LI**. *Advanced Science News*, 2017, vol. 29, 1601861
- **A.R.B.M. YUSOFF** ; **A.J. HUCKABA** ; **M.K. NAZEERUDDIN**. *Topics in Current Chemistry (Z)*, 2017, vol. 375, 39
- **T.-Y. LI** ; **J. WUC** ; **Z.-G. WUA** ; **Y.-X. ZHENG** ; **J.-L. ZUO** ; **Y. PAN**. *Coordination Chemistry Reviews*, 2018, vol. 374, 55
- **J. LIAO** ; **Y. WANG** ; **Y. XU** ; **H. ZHAO** ; **X. XIAO** ; **X. YANG**. *Tetrahedron*, 2015, vol. 71 (31), 5078
- **B.M SQUEO** ; **M. PASINI**. *Supramolecular Chemistry*, 2020, vol. 32 (1), 56-70
- **M. PODDAR** ; **R. MISRA**. *Coordination Chemistry Reviews*, 2020, vol. 421, 213462-213483
- **T. HATAKEYAMA** ; **K. SHIREN** ; **K. NAKAJIMA** ; **S. NOMURA** ; **S. NAKATSUKA** ; **K. KINOSHITA** ; **J. NI** ; **Y. ONO** ; **T. IKUTA**. *Advanced Materials*, 2016, vol. 28 (14), 2777
- **M. ZHU.** ; **C. YANG**. *Chemical Society Reviews*, 2013, vol. 42, 4963
- **S. KIMA** ; **B. KIMB** ; **J. LEEA** ; **H. SHINA** ; **Y.-Il PARKB** ; **J. PARK**. *Materials Science and Engineering R: Reports*, 2016, vol. 99 (1)
- **K.R.J. THOMAS** ; **N. KAPOOR** ; **M.N.K.P. BOLISETTY** ; **J.-H. JOU** ; **Y.-L. CHEN** ; **Y.-C. JOU**. *The Journal of Organic Chemistry*, 2012, vol. 77 (8), 3921
- **M. VANGA** ; **R.A. LALANCETTE** ; **F. JÄKLE**. *Chemistry - A European Journal*, 2019, vol. 25 (43), 10133
- **B. LEE** ; **F.M. RICHARDS**. *Journal of Molecular Biology*, 1971, vol. 55 (3), 379
- **S. MITTERNACHT**. Free SASA: An open source C library for solvent accessible surface area calculations.. *F1000Res.*, 18 February 2016, vol. 5, 189
- **M. MANTINA** ; **A.C. CHAMBERLIN** ; **R. VALERO** ; **C.J. CRAMER** ; **D.G. TRUHLAR**. *The Journal of Physical Chemistry A*, 2009, vol. 113 (19), 5806
- **Y. TAO** ; **C. YANG** ; **J. QUIN**. *Chemical Society Reviews*, 2011, vol. 40, 2943

- **K.S. YOOK** ; **J.Y. LEE**. *The Chemical Record*, 2015, vol. 16 (1), 159
- **T. CHATTERJEE** ; **K.-T. WONG**. *Advanced Optical Materials*, 2018, vol. 7 (1), 1800565
- **Q. WANG** ; **Q.-S. TIAN** ; **Y.-L. ZHANG** ; **X. TANG** ; **L.-S. LIAO**. *Journal of Materials Chemistry C*, 2019, vol. 7, 11329
- **OKINAKA et al.** *Society for Information Display International Symposium Digest of Technical Papers*, 2015, vol. 46 (1), 312-313
- **B. PERUCCO** ; **N. REINKE** ; **D. REZZONICO** ; **M. MOOS** ; **B. RUHSTALLER**. Analysis of the emission profile in organic light-emitting devices. *Opt. Express*, 2010, vol. 18, A246-A260